# EUROPEAN PATENT APPLICATION

(11) **EP 4 312 483 A1**
(43) Date of publication of application: **31.01.2024**
(21) Application number: 23187794.5
(22) Date of filing: 26.07.2023
(51) Int. Cl.: H10K 85/30, H10K 85/60, H10K 101/00, H10K 101/10

(54) **LIGHT-EMITTING DEVICE AND ELECTRONIC APPARATUS INCLUDING THE LIGHT-EMITTING DEVICE**

(30) Priority: 29.07.2022 KR 20220095045
(71) Applicant: Samsung Electronics Co., Ltd., Suwon-si, Gyeonggi-do 16677 (KR)
(72) Inventor: KWAK, Seungyeon, 16678 Suwon-si (KR); KIM, Sungmin, 16678 Suwon-si (KR); LEE, Kum Hee, 16678 Suwon-si (KR); LEE, Banglin, 16678 Suwon-si (KR); LEE, Sunghun, 16678 Suwon-si (KR); ISHIHARA, Shingo, 16678 Suwon-si (KR); CHOI, Byoungki, 16678 Suwon-si (KR); HONG, Youngki, 16678 Suwon-si (KR)
(74) Representative: Elkington and Fife LLP

(57) **Abstract**

A light-emitting device including a first electrode, a second electrode opposing the first electrode, and an interlayer located between the first electrode and the second electrode, wherein the interlayer includes an emission layer, wherein the emission layer includes m1 dopants and m2 hosts, and m1 and m2 are each 1 or greater, when m1 is 2 or greater, then two or more of the dopants are different from each other, when m2 is 2 or greater, then two or more of the hosts are different from each other, and the light-emitting device satisfies Condition 1: $0 debye ⋅ V \leq {DM}_{EML} \times \left({V}_{op}-{V}_{inj}\right) \leq 3.41 debye ⋅ V$ wherein Condition 1 may be understood by referring to the description provided herein.

## Description

### FIELD OF THE INVENTION

The subject matter relates to a light-emitting device and an electronic apparatus including the same.

### BACKGROUND OF THE INVENTION

From among light-emitting devices (OLEDs), organic light-emitting devices are self-emissive devices, which have improved characteristics in terms of viewing angles, response time, luminance, driving voltage, and response speed. In addition, OLEDs can produce full-color images.

In a typical example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. The excitons may transition from an excited state to a ground state, thus generating light.

### SUMMARY OF THE INVENTION

Provided is a light-emitting device with improved turn-on time.

Provided is an electronic apparatus including the light-emitting device.

Additional aspects will be set forth in part in the detailed description that follows and, in part, will be apparent from the detailed description, or may be learned by practice of the presented exemplary embodiments.

According to an aspect, a light-emitting device includes:
a first electrode,
a second electrode opposing the first electrode, and
an interlayer arranged between the first electrode and the second electrode, wherein the interlayer includes an emission layer,
wherein the emission layer includes m1 dopants and m2 hosts,
m1 and m2 are each an integer of 1 or greater,
when m1 is 2 or greater, then two or more of the dopants are different from each other,
when m2 is 2 or greater, then two or more of the hosts are different from each other, and
the light-emitting device satisfies Condition 1: $0 debye ⋅ V \leq {DM}_{EML} \times \left({V}_{op}-{V}_{inj}\right) \leq 3.41 debye ⋅ V$ wherein, in Condition 1,
   DM_{EML} is a sum of ${\sum }_{x = 1}^{m 1} DM \left(Dx\right) ⋅ W \left(Dx\right)$ and ${\sum }_{y = 1}^{m 2} DM \left(Hy\right) ⋅ W \left(Hy\right)$and is in debye,
   x is a variable of 1 to m1,
   y is a variable of 1 to m2,
   DM(Dx) is a dipole moment of a x^{th} dopant, and is in debye,
   DM(Hy) is a dipole moment of a y^{th} host, and is in debye,
   each of DM(Dx) and DM(Hy) is calculated based on a density functional theory (DFT),
   W(Dx) is a weight fraction of the x^{th} dopant with respect to a total weight of the dopant and the host,
   W(Hy) is a weight fraction of the y^{th} host with respect to the total weight of the dopant and the host,
   Vₒₚ is a driving voltage of the light-emitting device at a current density of 1 milliampere per square centimeter (mA/cm²), and is in volt (V), and
   Vᵢₙⱼ is a charge injection voltage of the light-emitting device, and has a smallest value among voltages of coordinates at which a change in the current density increase rate is observed in the voltage-current density graph of the light-emitting device, and is in volt (V).

For example, the interlayer of the light-emitting device may include
m light-emitting units each of which includes at least one emission layer, and
m-1 charge generation layers arranged between two neighboring light-emitting units of the m light-emitting units,
wherein
m may be an integer of 2 or greater, and
the m1 dopants and the m2 hosts may be included in an emission layer included in at least one light-emitting unit of the m light-emitting units.

In one or more embodiments, the light-emitting device may further include
a substrate including a red subpixel, a green subpixel, and a blue subpixel,
wherein the first electrode may be patterned for each of the red subpixel, the green subpixel, and the blue subpixel,
the emission layer may include a red emission layer corresponding to the red subpixel, a green emission layer corresponding to the green subpixel, and a blue emission layer corresponding to the blue subpixel, and
the green emission layer may include the m1 dopants and the m2 hosts.

According to one or more embodiments, an electronic apparatus includes the light-emitting device.

### BRIEF DESCRIPTION OF THE DRAWINGS

The above and other aspects, features, and advantages of certain exemplary embodiments will be more apparent from the following detailed description taken in conjunction with the accompanying drawings, in which:
FIG. 1 is a schematic view of a light-emitting device according to one or more embodiments; and
FIG. 2 is a graph of electroluminescence intensity (arbitrary units, a.u.) versus time (microseconds, µs) for each of the OLEDs R1, B1, 1, and 10 in the Examples.

### DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the detailed descriptions set forth herein. Accordingly, the exemplary embodiments are merely described in further detail below by referring to the figures, to explain certain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, or 5% of the stated value.

A light-emitting device according to an aspect includes a first electrode; a second electrode opposing the first electrode; and an interlayer located between the first electrode and the second electrode, wherein the interlayer includes an emission layer, and wherein the emission layer includes m1 dopants and m2 hosts.

In the emission layer, a total weight of the m2 hosts may be greater than a total weight of the m1 dopants. In other words, a total amount of the m2 hosts in the emission layer may be greater than a total amount of the m1 dopants in the emission layer, based on total weight of the emission layer.

For example, the total weight of the m2 hosts per 100 weight percent (wt%) of the total weight of the m1 dopants and the m2 hosts combined may be about 60 wt% to about 99 wt%, about 70 wt% to about 97 wt%, about 80 wt% to about 96 wt%, or about 85 wt% to about 93 wt%.

Each of m1 and m2 is an integer of 1 or greater. For example, m1 and m2 may each independently be an integer from 1 to 5.

When m1 is 2 or greater, two or more of the dopants are different from each other. That is, the emission layer may include one type of dopant, or may include two or more types of dopants that are different from each other.

When m2 is 2 or greater, two or more of the hosts may be different from each other. That is, the emission layer may include one type of host, or may include two or more types of hosts that are different from each other.

In one or more embodiments, m1 and m2 may each independently be 1 or 2. In one or more embodiments, m1 may be 1 or 2, and m2 may be 2.

The light-emitting device satisfies Condition 1: $0 debye ⋅ V \leq {DM}_{EML} \times \left({V}_{op}-{V}_{inj}\right) \leq 3.41 debye ⋅ V$

In Condition 1, DM_{EML} is a sum of ${\sum }_{x = 1}^{m 1} DM \left(Dx\right) ⋅ W \left(Dx\right)$ and ${\sum }_{y = 1}^{m 2} DM \left(Hy\right) ⋅ W \left(Hy\right)$ and is in debye.

In Condition 1, x is a variable of 1 to m1, and y is a variable of 1 to m2.

In Condition 1, DM(Dx) is a dipole moment of a x^{th} dopant, and is in debye, and DM(Hy) is a dipole moment of a y^{th} host, and is in debye. Each of DM(Dx) and DM(Hy) is calculated based on a density functional theory (DFT).

The calculation based on the density functional theory may be performed using various programs (for example, Gaussian 16 program, or the like).

In one or more embodiments, when the dopant is an organometallic compound, the dopant molecular structure is optimized by using the B3LYP/LanL2DZ function for the metal in the dopant and the B3LYP/6-31G(D,P) function for an organic ligand in the dopant, and then, the density functional theory (DFT) calculation is performed using the Gaussian 16 program to calculate the dipole moment of the dopant (for example, see Table 2).

In one or more embodiments, with respect to the host, each molecular structure is optimized using the B3LYP/6-31G(D,P) function, and then, the density functional theory (DFT) calculation using the Gaussian 16 program is performed to calculate the dipole moment of the host (for example, see Table 2).

In Condition 1, W(Dx) is a weight fraction of the x^{th} dopant with respect to a total weight of the m1 dopants and the m2 hosts, and is calculated by (weight of the x^{th} dopant/total weight of the m1 dopants and the m2 hosts), and W(Hy) is a weight fraction of the y^{th} host with respect to a total weight of the m1 dopants and the m2 hosts, and is calculated by (weight of the y^{th} host/total weight of the m1 dopants and the m2 hosts).

In one or more embodiments, a sum of "W(D1) + W(D2) + ... + W(Dx-1) + W(Dx)" and "W(H1) + W(H2) + ... + W(Hy-1) + W(Hy)" in the emission layer may be 1.

In one or more embodiments, the sum of "W(D1) + W(D2) + ... + W(Dx-1) + W(Dx)" may be from about 0.03 to about 0.20, from about 0.05 to about 0.18, or from about 0.07 to about 0.15.

In one or more embodiments, the sum of "W(H1) + W(H2) + ... + W(Hy-1) + W(Hy)" may be from about 0.80 to about 0.97, from about 0.82 to about 0.95, or from about 0.85 to about 0.93.

For example, when in the emission layer, m1 is 1 and m2 is 2,
the dopant includes only a first dopant,
the host includes a first host and a second host which are different from each other,
${\sum }_{x = 1}^{m 1} DM \left(Dx\right) ⋅ W \left(Dx\right)$ is DM(D1)·W(D1), that is, "dipole moment of first dopant x weight fraction of first dopant", and
${\sum }_{y = 1}^{m 2} DM \left(Hy\right) ⋅ W \left(Hy\right)$ is, DM(H1)·W(H1) + DM(H2) W(H2), that is, "(dipole moment of first host x weight fraction of first host) + (dipole moment of second host x weight fraction of second host)."

In one or more embodiments, when each of m1 and m2 in the emission layer is 2,
the dopant includes a first dopant and a second dopant that are different from each other,
the host includes a first host and a second host that are different from each other,
${\sum }_{x = 1}^{m 1} DM \left(Dx\right) ⋅ W \left(Dx\right)$ is DM(D1)·W(D1) + DM(D2) W(D2), that is, "(dipole moment of first dopant x weight fraction of first dopant) + (dipole moment of second dopant x weight fraction of second dopant)", and
${\sum }_{y = 1}^{m 2} DM \left(Hy\right) ⋅ W \left(Hy\right)$ is DM(H1)·W(H1) + DM(H2) W(H2), that is, "(dipole moment of first host x weight fraction of first host) + (dipole moment of second host x weight fraction of second host)."

The first host may be a hole-transporting compound, and the second host may be an electron-transporting compound. Each of the hole-transporting compound and the electron-transporting compound may be understood by referring to the description provided herein.

In one or more embodiments, the first host may be a hole-transporting compound, the second host may be an electron-transporting compound, and the condition W(H1) > W(H2) may be satisfied.

In one or more embodiments, the first host may be a hole-transporting compound, the second host may be an electron-transporting compound, and W(H1) may be from about 0.5 to about 0.7, for example, from about 0.503 to about 0.651.

In one or more embodiments, the first host may be a hole-transporting compound, the second host may be an electron-transporting compound, and W(H2) may be from about 0.2 to about 0.45, for example, from about 0.225 to about 0.427.

When m1 is 2, that is, the dopant includes a first dopant and a second dopant that are different from each other, W(D1) may be about 0.02 to about 0.09, for example, about 0.02 to about 0.05, or about 0.03 to about 0.09, and W(D2) may be about 0.02 to about 0.05, for example, about 0.02 to about 0.04.

In one or more embodiments, DM_{EML} may be from about 1.11 debye to about 1.99 debye.

In Condition 1, Vₒₚ is the driving voltage of the light-emitting device at a current density of 1 milliamperes per square centimeter (mA/cm²), and is in V. Vᵢₙⱼ is a charge injection voltage of the light-emitting device, and has a smallest value among voltages of coordinates at which a change in the current density increase rate is observed in the voltage-current density graph of the light-emitting device, and is in V.

Vₒₚ and Vᵢₙⱼ may each be evaluated from a voltage (V)-current density (mA/cm²) graph of the light-emitting device. For example, Vₒₚ may be a voltage when the current density is 1 mA/cm² in the voltage (V)-current density (mA/cm²) graph of the light-emitting device, and Vᵢₙⱼ may be the smallest value among voltages corresponding to the coordinates at which the change in the current density increase rate is observed in the voltage (V)-current density (mA/cm²) graph of the light-emitting device. For a specific example of the evaluation method of Vₒₚ and Vᵢₙⱼ, reference is made to Evaluation Example 2 herein.

In one or more embodiments, (Vₒₚ - Vᵢₙⱼ) in Condition 1 may be from about 0.84 volts (V) to about 1.90 V.

In one or more embodiments, [DMεnm x (Vₒₚ - Vᵢₙⱼ)] in Condition 1 may be about 1.29 debye·V or greater. In one or more embodiments, [DMεnm x (Vₒₚ - Vᵢₙⱼ)] in Condition 1 may be about 3.40 debye·V or less. In one or more embodiments, [DMεnm x (Vₒₚ - Vᵢₙⱼ)] in Condition 1 may be about 1.37 debye·V or greater, or about 1.45 debye·V or greater. In one or more embodiments, [DMεnm x (Vₒₚ - Vᵢₙⱼ)] in Condition 1 may be about 3.28 debye V or less, about 3.05 debye·V or less, about 2.99 debye·V or less, about 2.75 debye·V or less, about 2.69 debye·V or less, about 2.62 debye V or less, about 2.57 debye·V or less, about 2.54 debye·V or less, about 2.48 debye V or less, about 2.40 debye·V or less, about 2.34 debye·V or less, about 2.32 debye V or less, about 2.18 debye·V or less, about 1.99 debye·V or less, about 1.94 debye V or less, about 1.80 debye·V or less, about 1.68 debye·V or less, or about 1.57 debye V or less. In one or more embodiments, [DM_{EML} × (Vₒₚ - Vᵢₙⱼ)] in Condition 1 may be in range from about 1.29 debye V to about 3.40 debye V, for example, in range from about 1.37 debye·V to about 1.57 debye V.

In one or more embodiments, at least one (for example, each of the m1 dopants) of m1 dopants in the emission layer may emit a green light.

In one or more embodiments, a maximum emission wavelength in the luminescence spectrum of at least one (for example, each of the m1 dopants) of the m1 dopants in the emission layer may be from about 500 nm to about 580 nm, for example, about 510 nm to about 540 nm.

When the emission layer satisfies Condition 1 as described herein, a turn-on time of a light-emitting device using the emission layer may be reduced. Accordingly, the color drag phenomenon after the current is applied to the light-emitting device using the emission layer may be substantially prevented.

For example, when at least one of the m1 dopants (e.g., each of the m1 dopants) included in the emission layer emits a green light, the light-emitting device using the emission layer may emit a green light while the turn-on time thereof is simultaneously reduced.

Accordingly, by using the light-emitting device using the emission layer, a high-quality electronic apparatus (for example, a display apparatus) can be manufactured.

At least one of the m1 dopants (for example, each of the m1 dopants) may be a transition metal-containing organometallic compound, and each of the m2 hosts may be a compound that may not include a transition metal.

In one or more embodiments, at least one of the m1 dopants (for example, each of the m1 dopants) may be an iridium-containing organometallic compound, and the iridium-containing organometallic compound may include a first ligand, a second ligand, and a third ligand, each bonded to the iridium, and each of the first ligand, the second ligand and the third ligand may be a bidentate ligand bonded to the iridium via N and C. That is, the bidentate ligand is bonded via a nitrogen atom and a carbon atom to the iridium.

For example,
the first ligand, the second ligand, and the third ligand may be identical to each other, or
the first ligand and the second ligand may be identical to each other, and the second ligand and the third ligand may be different from each other, or
the first ligand and the second ligand may be different from each other, and the second ligand and the third ligand may be identical to each other, or
the first ligand, the second ligand, and the third ligand may be different from each other.

In one or more embodiments, the first ligand, the second ligand, and the third ligand may be identical to each other.

In one or more embodiments, at least one of the m1 dopants (e.g., each of the m1 dopants) may be an iridium-containing organometallic compound, and the iridium-containing organometallic compound may include deuterium, a fluoro group, Si, Ge, or a combination thereof. For example, the iridium-containing organometallic compound may include deuterium, a fluoro group, a deuterated C₁-C₂₀ alkyl group, a fluorinated C₁-C₂₀ alkyl group, -Si(Q₃)(Q₄)(Q₅), -Ge(Q₃)(Q₄)(Q₅), or a combination thereof, wherein Q₃ to Qs may each independently be a C₁-C₂₀ alkyl group or a phenyl group.

In one or more embodiments, at least one of the m1 dopants (e.g., each of the m1 dopants) may be an iridium-containing organometallic compound, and the iridium-containing organometallic compound may include a dibenzofuran group, a dibenzothiophene group, a dibenzoselenophene group, a dibenzosilole group, a dibenzogermole group, a naphthobenzofuran group, a naphthobenzothiophene group, a naphthobenzoselenophene group, a naphthobenzosilole group, a naphthobenzogermole group, a phenanthrobenzofuran group, a phenanthrobenzothiophene group, a phenanthrobenzoselenophene group, a phenanthrobenzosilole group, a phenanthrobenzogermole group, an azadibenzofuran group, an azadibenzothiophene group, an azadibenzoselenophene group, an azadibenzosilole group, an azadibenzogermole group, an azanaphthobenzofuran group, an azanaphthobenzothiophene group, an azanaphthobenzoselenophene group, an azanaphthobenzosilole group, an azanaphthobenzogermole group, an azaphenanthrobenzofuran group, an azaphenanthrobenzothiophene group, an azaphenanthrobenzoselenophene group, an azaphenanthrobenzosilole group, an azaphenanthrobenzogermole group, or a combination thereof, each of which may be bonded to the iridium via C.

For example, the iridium-containing organometallic compound may include a dibenzofuran group, a dibenzothiophene group, a naphthobenzofuran group, a naphthobenzothiophene group, a phenanthrobenzofuran group, a phenanthrobenzothiophene group, an azadibenzofuran group, an azadibenzothiophene group, an azanaphthobenzofuran group, an azanaphthobenzothiophene group, an azaphenanthrobenzofuran group, an azaphenanthrobenzothiophene group, or a combination thereof, each of which may be bonded to the iridium via C.

In one or more embodiments, at least one of the m1 dopants (e.g., each of the m1 dopants) may be an iridium-containing organometallic compound, and the iridium-containing organometallic compound may include a benzimidazole group, a benzoxazole group, a benzthiazole group, a naphthoimidazole group, a naphthooxazole group, a naphthothiazole group, a phenanthroimidazole group, a phenanthrooxazole group, a phenanthrothiazole group, a pyridoimidazole group, a pyridooxazole group, a pyridothiazole group, a pyridine group, a pyrimidine group, a pyrazine group, a pyridazine group, a quinoline group, an isoquinoline group, or a combination thereof, each of which may be bonded to the iridium via N.

For example, the iridium-containing organometallic compound may include a benzimidazole group, a naphthoimidazole group, a phenanthroimidazole group, or a combination thereof, each of which may be bonded to the iridium via N.

In one or more embodiments, at least one of the m1 dopants (e.g., each of the m1 dopants) may be an iridium-containing organometallic compound, and the iridium-containing organometallic compound includes ring A₃ which may be bonded to the iridium via N and ring A₄ which may be bonded to the iridium via C, ring A₃ and ring A₄ may be linked to each other through a single bond, ring A₃ may be a benzimidazole group, a benzoxazole group, a benzthiazole group, a naphthoimidazole group, a naphthooxazole group, a naphthothiazole group, a phenanthroimidazole group, a phenanthrooxazole group, a phenanthrothiazole group, a pyridoimidazole group, a pyridooxazole group, a pyridothiazole group, a pyridine group, a pyrimidine group, a pyrazine group, a pyridazine group, a quinoline group, or an isoquinoline group, and ring A₄ may be a dibenzofuran group, a dibenzothiophene group, a naphthobenzofuran group, a naphthobenzothiophene group, a phenanthrobenzofuran group, a phenanthrobenzothiophene group, an azadibenzofuran group, an azadibenzothiophene group, an azanaphthobenzofuran group, an azanaphthobenzothiophene group, an azaphenanthrobenzofuran group, or an azaphenanthrobenzothiophene group.

In one or more embodiments, the thickness of the emission layer may be about 50 Å to about 500 Å, about 50 Å to about 450 Å, about 50 Å to about 400 Å, about 100 Å to about 500 Å, about 100 Å to about 450 Å, about 100 Å to about 400 Å, about 200 Å to about 500 Å, or about 300 Å to about 400 Å. Accordingly, the total amount of charge required up to Vₒₚ of the light-emitting device may be relatively reduced, so that the turn-on time of the light-emitting device may be further reduced.

In one or more embodiments, the emission layer may emit a green light.

For example, a maximum emission wavelength of the electroluminescence spectrum of the light emitted from the emission layer may be about 500 nm to about 580 nm, for example, about 510 nm to about 540 nm.

In one or more embodiments, a delay time, which is a time required for a luminance of the light-emitting device to reach 10% of a maximum luminance after applying a current (e.g., a current of 1 mA/cm²) to the light-emitting device, may be about 200 microseconds (µs) or less, about 192 µs or less, about 184 µs or less, about 180 µs or less, about 178 µs or less, about 176 µs or less, about 170 µs or less, about 168 µs or less, about 160 µs or less, about 152 µs or less, about 100 µs to about 192 µs, or about 140 µs to about 192 µs. Although not intended to be limited by a particular theory, in general, since the delay time is a parameter that significantly affects the turn-on time of the light-emitting device, the turn-on time of the light-emitting device of which delay time is controlled, may be effectively improved.

In one or more embodiments, a turn-on time, which is a time required for a luminance of the light-emitting device to reach 90% of a maximum luminance after applying a current (e.g., a current of 1 mA/cm²) to the light-emitting device, may be about 260 µs or less, about 256 µs or less, about 252 µs or less, about 250 µs or less, about 248 µs or less, about 246 µs or less, about 242 µs or less, about 240 µs or less, about 236 µs or less, about 234 µs or less, about 232 µs or less, about 224 µs or less, about 218 µs or less, about 208 µs or less, about 196 µs or less, about 186 µs or less, about 150 µs to about 260 µs, or about 182 µs to about 260 µs.

With respect to the light-emitting device having these ranges of delay time and turn-on time, the generation of the color drag phenomenon after the current is applied can be substantially prevented.

The term "delay time" as used herein refers to a time required for the luminance of a light-emitting device to reach 10% of a maximum luminance after applying a current to the light-emitting device.

The term "turn-on time" as used herein refers to a time required for a luminance of a light-emitting device to reach 90% of a maximum luminance after applying a current to the light-emitting device.

In one or more embodiments, the interlayer of the light-emitting device may further include a hole transport region arranged between the first electrode and the emission layer, and an electron transport region arranged between the emission layer and the second electrode.

The hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "interlayer" as used herein refers to a single layer and/or a plurality of layers arranged between the first electrode and the second electrode of a light-emitting device. The "interlayer" may include not only organic compounds but also organometallic complexes including a metal.

In one or more embodiments, the interlayer may include:
m light-emitting units each of which includes at least one emission layer; and
m-1 charge generation layers arranged between two neighboring light-emitting units of the m light-emitting units,
m may be an integer of 2 or greater, and
m1 dopants and m2 hosts, as described above, may be included in an emission layer included in at least one light-emitting unit of the m light-emitting units (for example, one emission layer included in one light-emitting unit of the m light-emitting units). That is, the light-emitting device may have a tandem structure in which a plurality of light-emitting units are vertically stacked between a first electrode and a second electrode. The light-emitting device having a tandem structure may satisfy Condition 1 as described herein. For example, m may be 2, 3, 4, 5, 6, 7, 8, 9, or 10. In one or more embodiments, m may be 2, 3, 4, 5, or 6.

Each of the lights emitted from the m light-emitting units may be identical to or different from each other.

In one or more embodiments, the light emitted from each of the m light-emitting units may be a green light.

In one or more embodiments, the light emitted from at least one light-emitting unit of m light-emitting units may be a green light, and the light emitted from at least one light-emitting unit of the remaining light-emitting units may be a blue light.

Meanwhile, the light-emitting device may further include a substrate including a red subpixel, a green subpixel, and a blue subpixel, wherein the first electrode may be patterned for each of the red subpixel, the green subpixel, and the blue subpixel, and the emission layer may include a red emission layer corresponding to the red subpixel, a green emission layer corresponding to the green subpixel, and a blue emission layer corresponding to the blue subpixel, and the green emission layer may include m1 dopants and m2 hosts as described herein. That is, the light-emitting device may be a full-color light-emitting device. The full-color light-emitting device satisfies Condition 1 as described herein.

In one or more embodiments, the area of the green subpixel of the interlayer of the light-emitting device may include:
m light-emitting units, each including at least one emission layer; and
m-1 charge generation layers arranged between two neighboring light-emitting units of the m light-emitting units,
m may be an integer of 2 or greater,
the emission layer included in at least one light-emitting unit of the m light-emitting units may be a green emission layer, and the green emission layer may include m1 dopants and m2 hosts as described herein.

In one or more embodiments, a thickness of the emission layer included in full-color light-emitting device may be about 50 Å to about 500 Å, about 50 Å to about 450 Å, about 50 Å to about 400 Å, about 100 Å to about 500 Å, about 100 Å to about 450 Å, or about 100 Å to about 400 Å. Accordingly, the total amount of charge required to achieve the Vₒₚ of the full-color light-emitting device may be relatively reduced, so that the turn-on time for a green light in the full-color light-emitting device may be further reduced.

In one or more embodiments, at least one of |R_{delay} - G_{delay}| and |B_{delay} - G_{delay}l (for example, all of |R_{delay} - G_{delay}| and |B_{delay} - G_{delay}|) of the light-emitting device may be 100 µs or less. The term "R_{delay}" as used herein refers to a time required for a luminance of a red light emitted from the red emission layer to reach 10% of a maximum luminance of the red light after application of a current to the light-emitting device, G_{delay} is a time required for a luminance of a green light emitted from the green emission layer to reach 10% of a maximum luminance of the green light after application of a current to the light-emitting device, and B_{delay} is a time required for a luminance of a blue light emitted from the blue emission layer to reach 10% of a maximum luminance of the blue light after application of a current to the light-emitting device. Accordingly, a difference between a delay time for red light and a delay time for green light and/or a difference between a delay time for blue light and a delay time for green light in the light-emitting device is substantially reduced, so that the color drag phenomenon after application of the current to the light-emitting device may be substantially prevented.

In one or more embodiments, at least one of IRturn-on - Gₜᵤᵣₙ₋ₒₙ| and |Bₜᵤᵣₙ₋ₒₙ -Gₜᵤᵣₙ₋ₒₙ| (for example, all of |Rₜᵤᵣₙ₋ₒₙ - Gₜᵤᵣₙ₋ₒₙ| and |Bₜᵤᵣₙ₋ₒₙ - Gₜᵤᵣₙ₋ₒₙ|) of the light-emitting device may be about 150 µs or less, for example, about 100 µs or less. In this regard, Rₜᵤᵣₙ₋ₒₙ is a time required for a luminance of a red light emitted from the red emission layer to reach 90% of a maximum luminance of the red light after application of a current to the light-emitting device, Gₜᵤᵣₙ₋ₒₙ is a time required for a luminance of a green light emitted from the green emission layer to reach 90% of a maximum luminance of the green light after application of a current to the light-emitting device, and Bₜᵤᵣₙ₋ₒₙ is a time required for a luminance of a blue light emitted from the blue emission layer to reach 90% of a maximum luminance of the blue light after application of a current to the light-emitting device. Accordingly, a difference between a turn-on time for a red light and a turn-on time for a green light and/or a difference between a turn-on time for a blue light and a turn-on time for a green light in the light-emitting device may be substantially reduced, so that the color drag phenomenon after application of the current to the light-emitting device may be substantially prevented.

Although not intended to be limited by a particular theory, generally, the turn-on time for a green light in a full-color light-emitting device may be relatively large compared to the turn-on time for a red light and a blue light. Therefore, since the luminance of a red light and a blue light may be increased faster than the luminance of a green light after a current is applied to the full-color light-emitting device, instead of the direct change from the black screen to the white screen over time (for example, seconds) after the current is applied, a black screen, a purple screen, and a white screen may be sequentially developed, that is, a purple color drag phenomenon may occur. In this regard, since a green light has a high visibility to the human eye, the control of turn-on time for a green light may have a direct effect on improving the overall image quality of light-emitting devices.

These problems can be solved by using an emission layer that satisfies Condition 1 as described herein.

Although not intended to be limited by a particular theory, in general, the turn-on time for the emission of a red light and a blue light at a current density of about 1 mA/cm² may be about 140 µs to about 200 µs. Therefore, in the case of a full-color light-emitting device that has a green emission layer including m1 dopants and m2 hosts and satisfies Condition 1 described herein, the turn-on time of a green light may be very close to the turn-on time for each of a red light and a blue light, so that the color drag phenomenon, for example, a purple color drag phenomenon after current application to the full-color light-emitting device may be substantially prevented.

Therefore, a full-color light-emitting device using the emission layer described herein may provide a high-quality image without a color drag phenomenon even under various luminance and driving conditions (for example, low luminance, and high scan rate driving conditions such as at 120 hertz (Hz)).

In one or more embodiments, the iridium-containing organometallic compound may be an organometallic compound represented by Formula 2:

Formula 2 M₂(L₁₁)ₙ₁₁(L₁₂)ₙ₁₂(L₁₃)ₙ₁₃.

wherein M₂ in Formula 2 may be iridium (Ir).

In Formula 2, L₁₁ may be a ligand represented by Formula 2-1, L₁₂ may be a ligand represented by Formula 2-2, and L₁₃ may be a ligand represented by Formula 2-1 or 2-2: 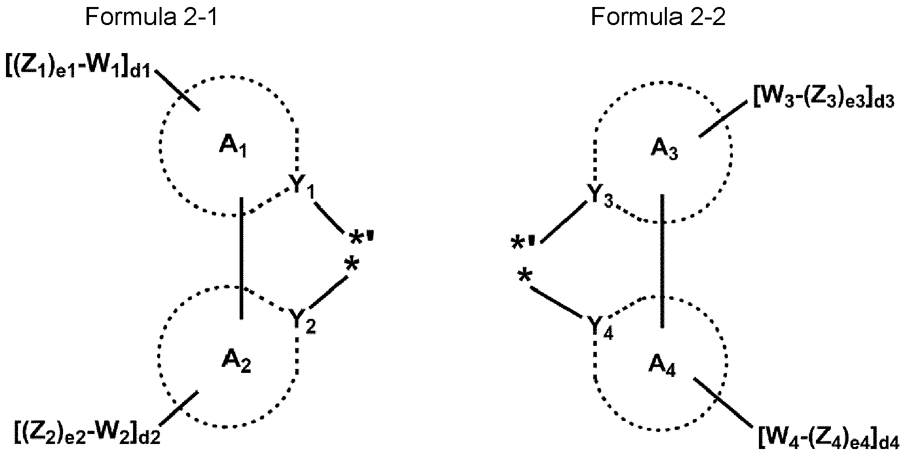 wherein Formulae 2-1 and 2-2 are as described herein. * and *' in Formulae 2-1 and 2-2 each indicate a binding site to M₂ in Formula 2.

In Formula 2, L₁₁ and L₁₂ may be different from each other.

In Formula 2, n11 to n13 may indicate the number of L₁₁(s) to the number of L₁₃(s), respectively, and may each independently be 0, 1, 2, or 3, wherein n11 + n12 + n13 may be 3.

In one or more embodiments, in Formula 2, n11 may be 1, 2, or 3, and n12 and n13 may each independently be 0, 1, or 2.

In one or more embodiments, in Formula 2, n12 may be 1, 2, or 3, and n11 and n13 may each independently be 0, 1, or 2.

In one or more embodiments, n11 may be 1, n12 may be 2, and n13 may be 0.

In one or more embodiments, n11 may be 2, n12 may be 1, and n13 may be 0.

In one or more embodiments, n11 may be 3, and n12 and n13 may each be 0. In one or more embodiments, n12 may be 3, and n11 and n13 may each be 0.

The organometallic compound represented by Formula 2 may be a heteroleptic complex or a homoleptic complex.

In one or more embodiments, the organometallic compound represented by Formula 2 may be a homoleptic complex. That is, each of the three ligands in the organometallic compound represented by Formula 2 may be identical to each other.

Y₁ to Y₄ in Formulae 2-1 and 2-2 may each independently be C or N.

In one or more embodiments, in Formulae 2-1 and 2-2, each of Y₁ and Y₃ may be N, and each of Y₂ and Y₄ may be C.

Ring A₁ to ring A₄ in Formulae 2-1 and 2-2 may each independently be a Cs-C₃₀ carbocyclic group or a C₁-C₃₀ heterocyclic group.

For example, ring A₁ to ring A₄ in Formulae 2-1 and 2-2 may each independently be i) a first ring, ii) a second ring, iii) a condensed ring group in which two or more first rings are condensed with each other, iv) a condensed ring group in which two or more second rings are condensed with each other, or v) condensed ring group in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, ring A₁ to ring A₄ in Formulae 2-1 and 2-2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluoren-9-one group, a dibenzothiophene 5, 5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthropyrrole group, a phenanthropyrazole group, a phenanthroimidazole group, a phenanthrooxazole group, a phenanthroisoxazole group, a phenanthrothiazole group, a phenanthroisothiazole group, a phenanthrooxadiazole group, a phenanthrothiadiazole group, a 5,6,7,8-tetrahydroisoquinoline group, a 5,6,7,8-tetrahydroquinoline group, an adamantane group, a norbornane group, a norbornene group, a benzene group with a cyclohexane group condensed thereto, a benzene group with a norbornane group condensed thereto, a pyridine group with a cyclohexane group condensed thereto, or a pyridine group with a norbornane group condensed thereto.

In Formulae 2-1 and 2-2, ring A₁ and ring A₃ may be identical to or different from each other.

In one or more embodiments, a Y₁-containing monocyclic group in ring A₁, a Y₂-containing monocyclic group in ring A₂, and Y₄-containing monocyclic group in ring A₄ may each be a 6-membered ring.

In one or more embodiments, a Y₃-containing monocyclic group in ring A₃ may be a 6-membered ring.

In one or more embodiments, a Y₃-containing monocyclic group in ring A₃ may be a 5-membered ring.

In one or more embodiments, a Y₁-containing monocyclic group in ring A₁ may be a 6-membered ring, and a Y₃-containing monocyclic group in ring A₃ may be a 5-membered ring.

In one or more embodiments, in Formulae 2-1 and 2-2, ring A₁ and ring A₃ may each independently be i) Group A, ii) a polycyclic group in which two or more Group A are condensed with each other, or iii) a polycyclic group in which at least one Group A and at least one Group B are condensed with each other,
wherein Group A may include a pyridine group, a pyrimidine group, a pyridazine group, a pyrazine group, or a triazine group, and
Group B may include a cyclohexane group, a cyclohexene group, a norbornane group, a benzene group, a furan group, a thiophene group, a selenophene group, a pyrrole group, a cyclopentadiene group, or silole group.

In one or more embodiments, in Formula 2-2, ring A₃ may be i) Group C, ii) a polycyclic group in which two or more Group C are condensed with each other, or iii) a polycyclic group in which at least one Group C and at least one Group D are condensed with each other,
wherein Group C may include a pyrrole group, a pyrazole group, an imidazole group, a triazole group, an oxazole group, an isoxazole group, a thiazole group, or an isothiazole group, and
Group D may include a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group. In one or more embodiments, ring A₁ in Formula 2-1 may be:
   a pyridine group, a pyrimidine group, a pyridazine group, or a pyrazine group; or
   a pyridine group, a pyrimidine group, a pyridazine group, or a pyrazine group, each condensed with a cyclohexane group, a norbornane group, a benzene group, or a combination thereof.

In one or more embodiments, ring A₃ in Formula 2-2 may be:
a pyridine group, a pyrimidine group, a pyridazine group, or a pyrazine group;
a pyridine group, a pyrimidine group, a pyridazine group, or a pyrazine group, each condensed with a cyclohexane group, a norbornane group, a benzene group, or a combination thereof; or
an imidazole group, a benzimidazole group, a naphthoimidazole group, a phenanthroimidazole group, a pyridoimidazole group, an oxazole group, a benzoxazole group, a naphthooxazole group, a phenanthrooxazole group, a pyridooxazole group, a thiazole group, a benzothiazole group, a naphthothiazole group, a phenanthrothiazole group, or a pyridothiazole group.

In one or more embodiments, ring A₂ and ring A₄ in Formulae 2-1 and 2-2 may be different from each other.

In one or more embodiments, in Formulae 2-1 and 2-2, ring A₂ and ring A₄ may each independently be i) Group E, ii) a polycyclic group in which two or more Group E are condensed with each other, or iii) a polycyclic group in which at least one Group E and at least one Group F are condensed with each other,
wherein Group E may include a benzene group, a pyridine group, a pyrimidine group, a pyridazine group, a pyrazine group, or a triazine group, and
Group F may include a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, in Formula 2-1, ring A₂ may be a polycyclic group in which two or more Group E and at least one Group F are condensed with each other.

In one or more embodiments, in Formula 2-2, ring A₄ may be a polycyclic group in which two or more Group E and at least one Group F are condensed with each other.

In one or more embodiments, ring A₂ in Formula 2-1 may be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a norbornane group, a benzene group, or a combination thereof.

In one or more embodiments, ring A₄ in Formula 2-2 may be:
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or an azadibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or an azadibenzosilole group, each condensed with a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

In one or more embodiments, ring A₄ in Formula 2-2 may be a dibenzofuran group, a dibenzothiophene group, a dibenzoselenophene group, a dibenzosilole group, a dibenzogermole group, a naphthobenzofuran group, a naphthobenzothiophene group, a naphthobenzoselenophene group, a naphthobenzosilole group, a naphthobenzogermole group, a phenanthrobenzofuran group, a phenanthrobenzothiophene group, a phenanthrobenzoselenophene group, a phenanthrobenzosilole group, a phenanthrobenzogermole group, an azadibenzofuran group, an azadibenzothiophene group, an azadibenzoselenophene group, an azadibenzosilole group, an azadibenzogermole group, an azanaphthobenzofuran group, an azanaphthobenzothiophene group, an azanaphthobenzoselenophene group, an azanaphthobenzosilole group, an azanaphthobenzogermole group, an azaphenanthrobenzofuran group, an azaphenanthrobenzothiophene group, an azaphenanthrobenzoselenophene group, an azaphenanthrobenzosilole group, or an azaphenanthrobenzogermole group.

W₁ to W₄ in Formulae 2-1 and 2-2 may each independently be a single bond, a C₁-C₂₀ alkylene group that is unsubstituted or substituted with at least one R₁₀ₐ, a Cs-C₃₀ carbocyclic group that is unsubstituted or substituted with at least one R₁₀ₐ, or a C₁-C₃₀ heterocyclic group that is unsubstituted or substituted with at least one R₁₀ₐ.

For example, W₁ to W₄ in Formulae 2-1 and 2-2 may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In one or more embodiments, W₁ to W₄ in Formulae 2-1 and 2-2 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In one or more embodiments, W₁ to W₄ in Formulae 2-1 and 2-2 may each independently be:
a single bond; or
a C₁-C₂₀ alkylene group, a benzene group, a naphthalene group, a dibenzofuran group, or a dibenzothiophene group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

Z₁ to Z₄ in Formulae 2-1 and 2-2 may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₃)(Q₉). Q₁ to Q₉ may each be as described herein.

For example, Z₁ to Z₄ in Formulae 2-1 and 2-2 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with at least one of deuterium, -F, - Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group (or a bicyclo[2.2.1]heptyl group), a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
   wherein Q₁ to Q₉ may each independently be:
   deuterium, -F, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, - CD₂CD₃, -CD₂CD₂H, -CD₂CDH₂, -CF₃, -CF₂H, -CFH₂, -CH₂CF₃, -CH₂CF₂H, - CH₂CFH₂, -CHFCH₃, -CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a C₁-C₁₀ alkyl group, a phenyl group, or a combination thereof.

In one or more embodiments, Z₁ to Z₄ in Formulae 2-1 and 2-2 may each independently be:
hydrogen, deuterium, -F, or a cyano group;
a C₁-C₂₀ alkyl group unsubstituted or substituted with at least one of deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with at least one of deuterium, -F, a cyano group, a C₁-C₂₀ alkyl group, a deuterated C₁-C₂₀ alkyl group, fluorinated C₁-C₂₀ alkyl group, a C₁-C₂₀ alkoxy group, a C₁-C₂₀ alkylthio group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof; or
-Si(Q₃)(Q₄)(Q₅) or -Ge(Q₃)(Q₄)(Q₅).

In one or more embodiments, in Formula 2-1, each of e1 and d1 may not be 0, and at least one of a plurality of Z₁ may be a deuterated C₁-C₂₀ alkyl group, - Si(Q₃)(Q₄)(Q₅), or -Ge(Q₃)(Q₄)(Q₅). Q₃ to Q₅ are as described herein.

For example, Q₃ to Q₅ may each independently be:
a C₁-C₆₀ alkyl group unsubstituted or substituted with at least one of deuterium, a C₁-C₆₀ alkyl group, a C₆-C₆₀ aryl group, or a combination thereof; or
a C₆-C₆₀ aryl group unsubstituted or substituted with at least one of deuterium, a C₁-C₆₀ alkyl group, a C₆-C₆₀ aryl group, or a combination thereof. In one or more embodiments, Q₃ to Q₅ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

In one or more embodiments, Q₃ to Q₅ may be identical to each other.

In one or more embodiments, two or more of Q₃ to Q₅ may be different from each other.

In one or more embodiments, the organometallic compound represented by Formula 2 may satisfy at least one of Condition (1) to Condition (9):
Condition (1)
   each of e1 and d1 in Formula 2-1 is not 0, and
   at least one Z₁ includes deuterium;
Condition (2)
   each of e2 and d2 in Formula 2-1 is not 0, and
   at least one Z₂ includes deuterium;
Condition (3)
   each of e3 and d3 in Formula 2-2 is not 0, and
   at least one Z₃ includes deuterium;
Condition (4)
   each of e4 and d4 in Formula 2-2 is not 0, and
   at least one Z₄ includes deuterium;
Condition (5)
   Each of e1 and d1 in Formula 2-1 is not 0, and
   at least one Z₁ includes a fluoro group;
Condition (6)
   each of e2 and d2 in Formula 2-1 is not 0, and
   at least one Z₂ includes a fluoro group;
Condition (7)
   each of e3 and d3 in Formula 2-2 is not 0, and
   at least one Z₃ includes a fluoro group;
Condition (8)
   Each of e4 and d4 in Formula 2-2 is not 0, and
   at least one Z₄ includes a fluoro group;
Condition (9)
   each of n11 and n13 in Formula 2 is 0,
   n12 in Formula 2 is 3,
   three L₁₂ in Formula 2 are identical to each other,
   Y₃ in Formula 2-2 is nitrogen,
   Y₄ in Formula 2-2 is carbon,
   ring A₃ in Formula 2-2 is a benzimidazole group, a benzoxazole group, a benzthiazole group, a naphthoimidazole group, a naphthooxazole group, a naphthothiazole group, a phenanthroimidazole group, a phenanthrooxazole group, a phenanthrothiazole group, a pyridoimidazole group, a pyridooxazole group, or a pyridothiazole group, and
   ring A₄ in Formula 2-2 is a dibenzofuran group, a dibenzothiophene group, a dibenzoselenophene group, a dibenzosilole group, a dibenzogermole group, a naphthobenzofuran group, a naphthobenzothiophene group, a naphthobenzoselenophene group, a naphthobenzosilole group, a naphthobenzogermole group, a phenanthrobenzofuran group, a phenanthrobenzothiophene group, a phenanthrobenzoselenophene group, a phenanthrobenzosilole group, a phenanthrobenzogermole group, an azadibenzofuran group, an azadibenzothiophene group, an azadibenzoselenophene group, an azadibenzosilole group, an azadibenzogermole group, an azanaphthobenzofuran group, an azanaphthobenzothiophene group, an azanaphthobenzoselenophene group, an azanaphthobenzosilole group, an azanaphthobenzogermole group, an azaphenanthrobenzofuran group, an azaphenanthrobenzothiophene group, an azaphenanthrobenzoselenophene group, an azaphenanthrobenzosilole group, or an azaphenanthrobenzogermole group.

In one or more embodiments, Z₁ to Z₄ in Formulae 2-1 and 2-2 may each independently be hydrogen, deuterium, -F, -CH₃, -CD₃, -CD₂H, -CDH₂, -CF₃, -CF₂H, - CFH₂, a C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (wherein Q₃ to Q₅ are each as described herein):

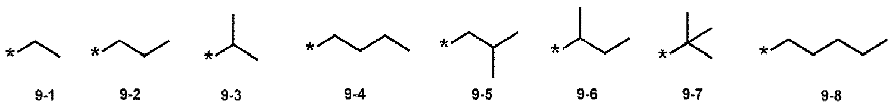

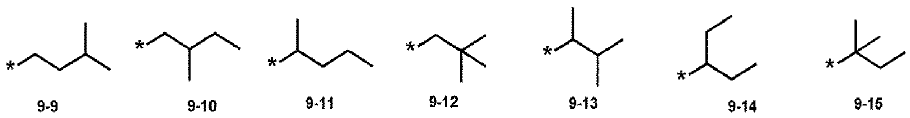

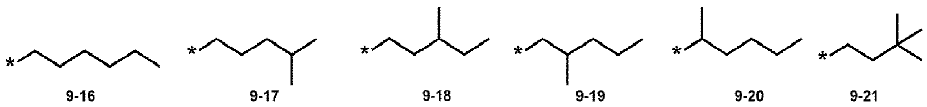

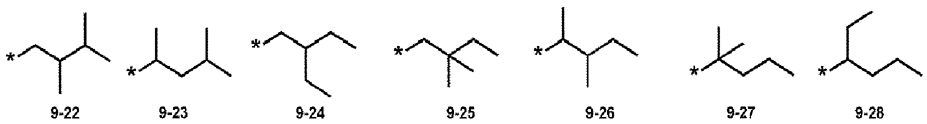

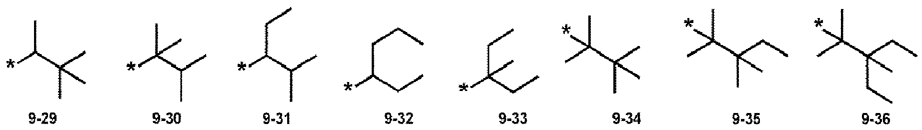

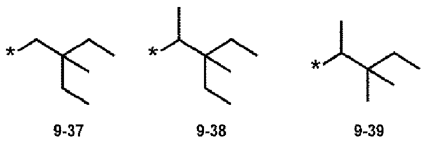

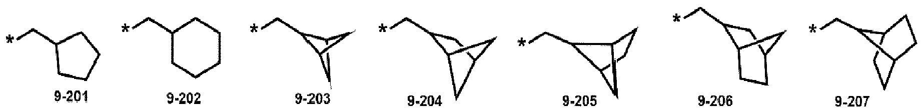

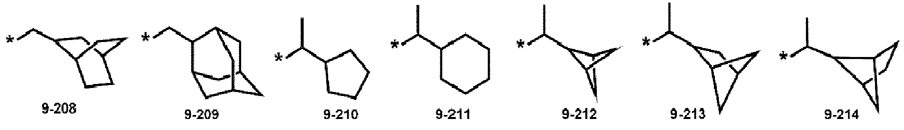

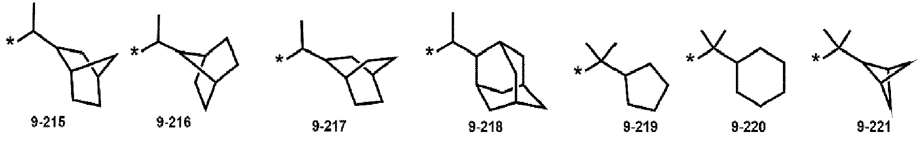

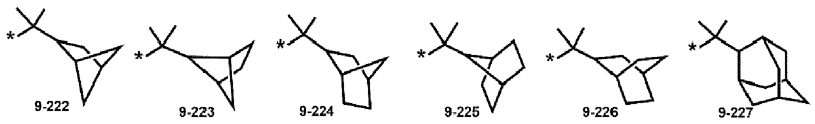

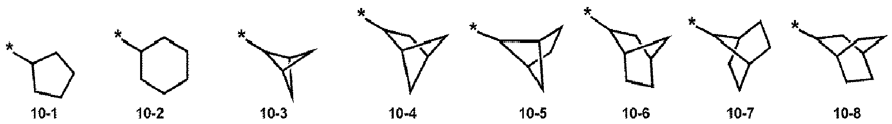

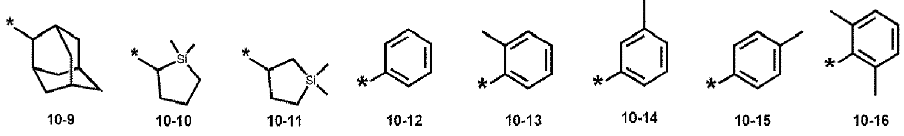

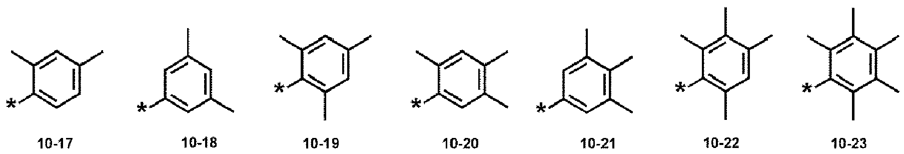

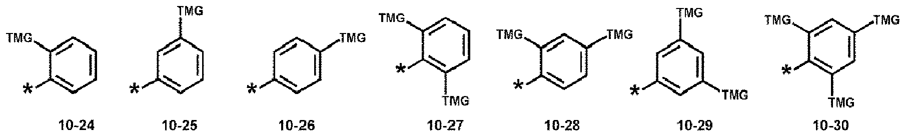

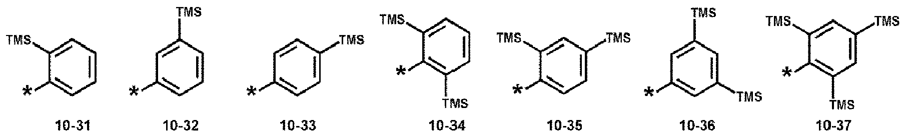

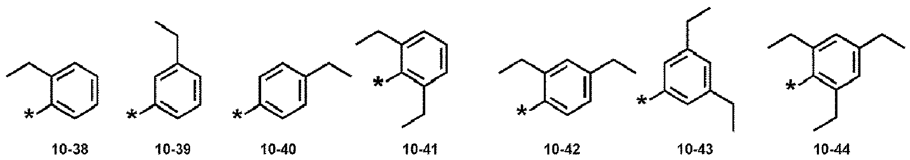

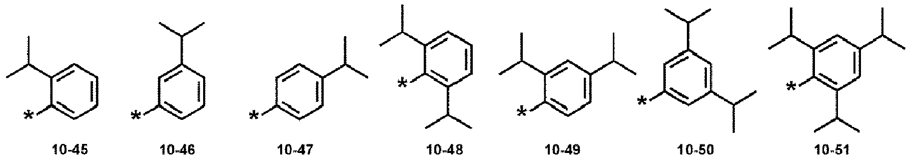

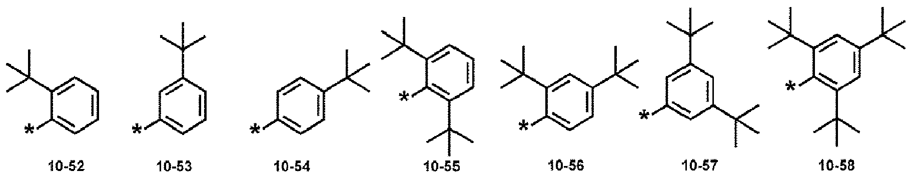

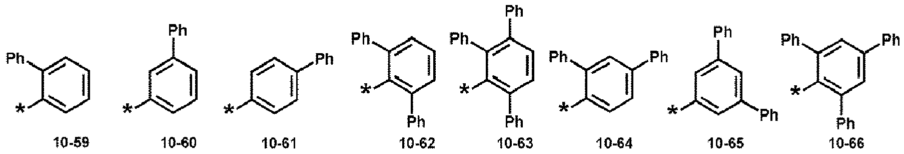

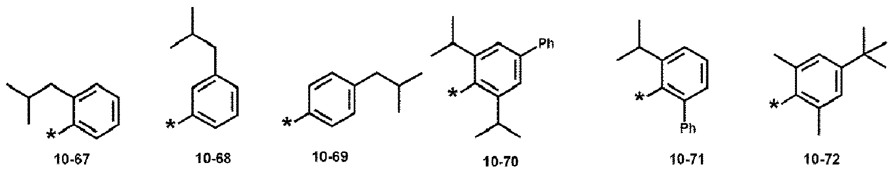

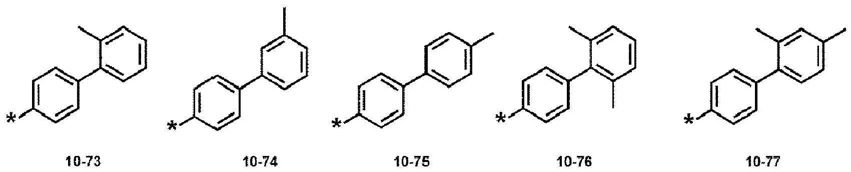

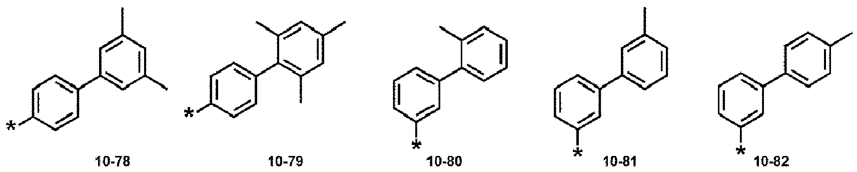

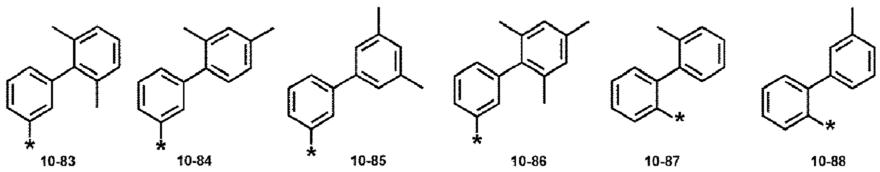

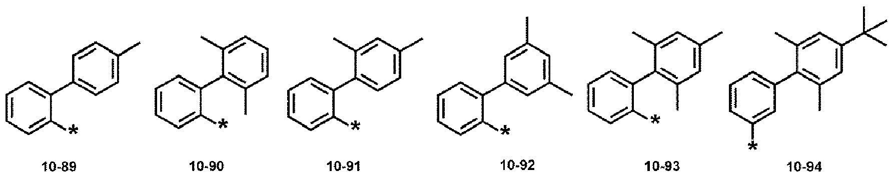

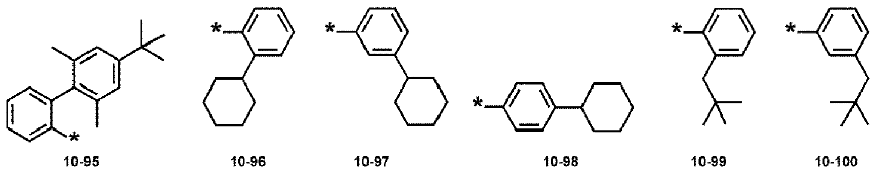

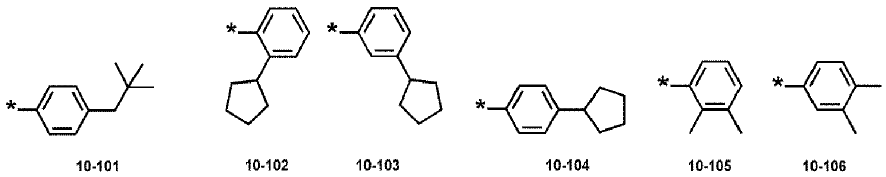

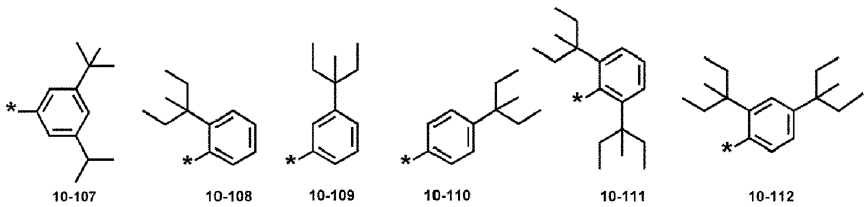

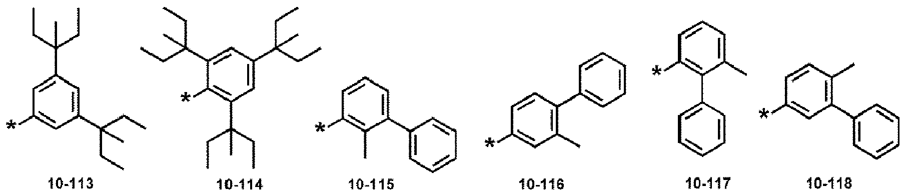

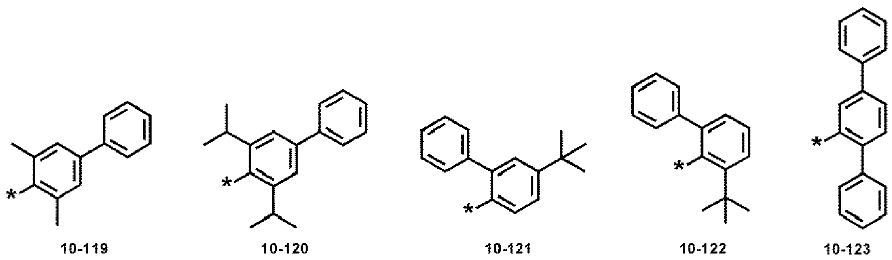

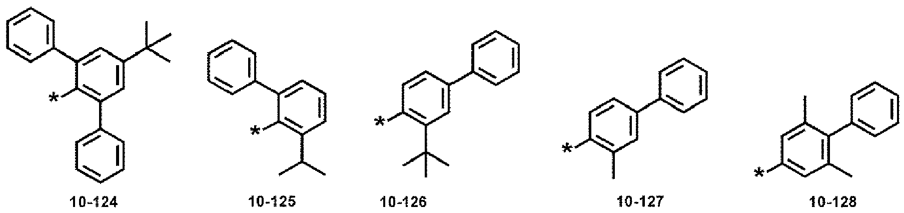

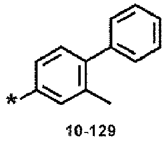

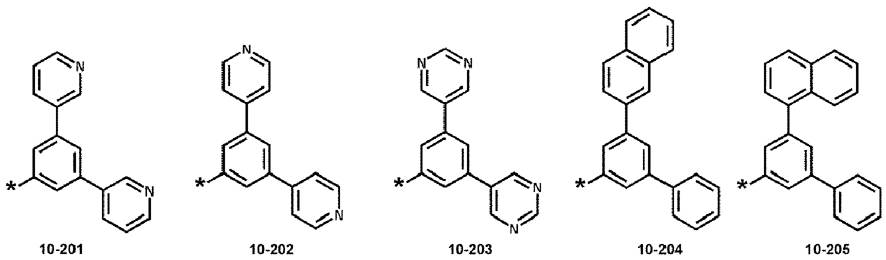

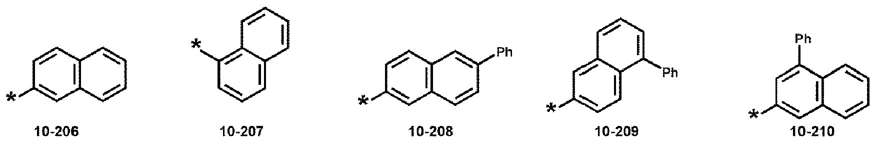

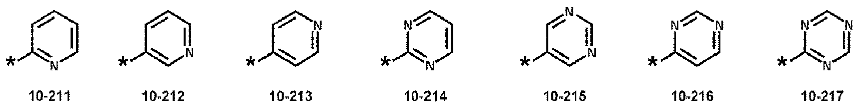

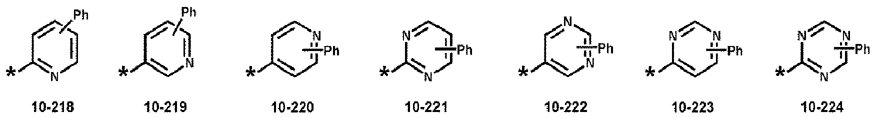

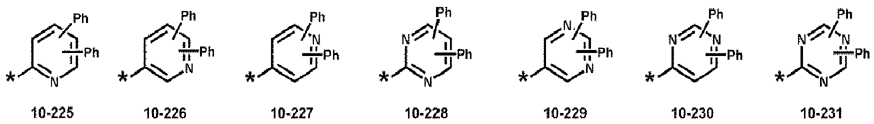

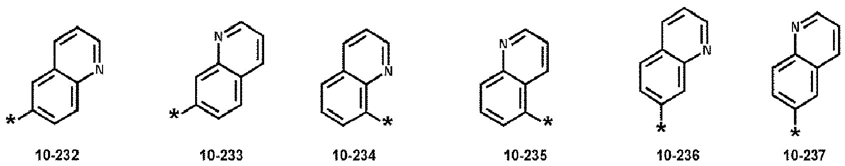

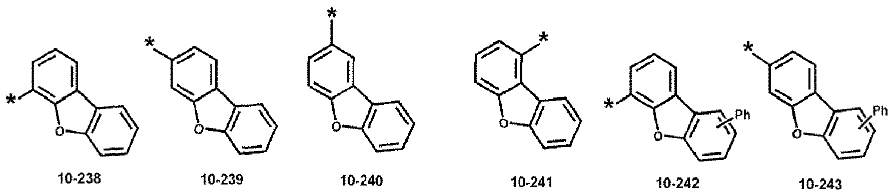

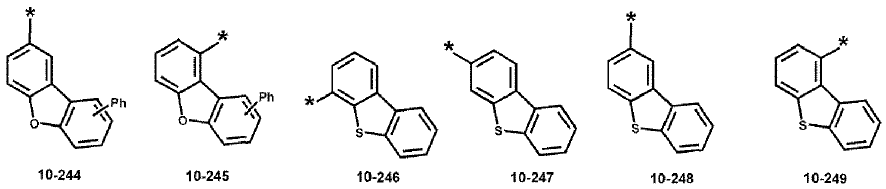

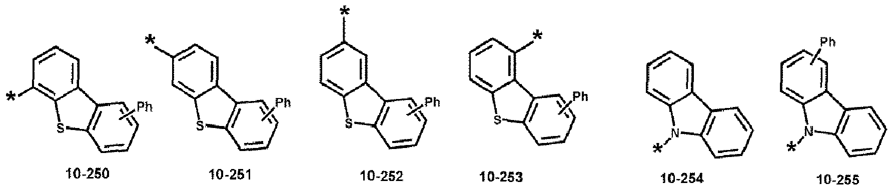

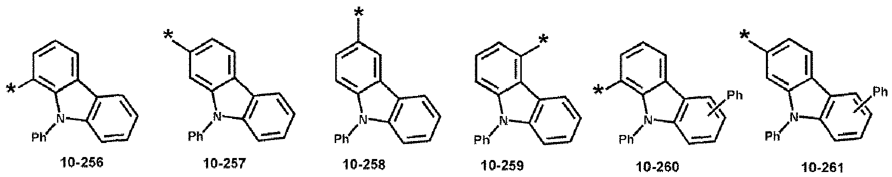

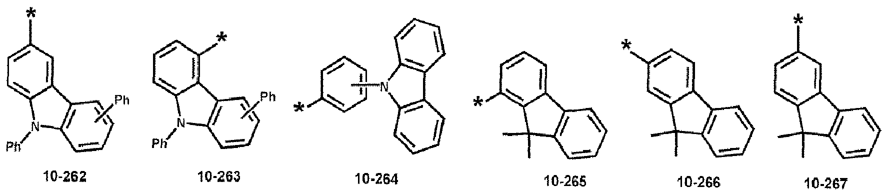

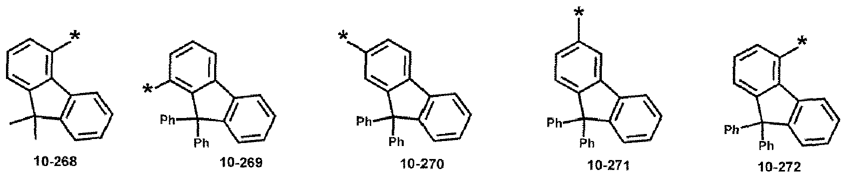

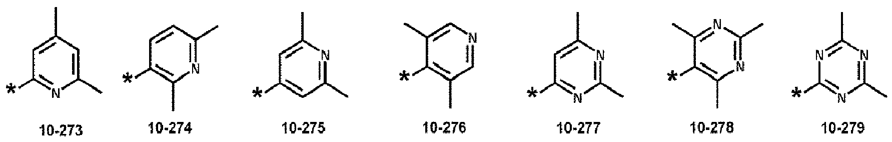

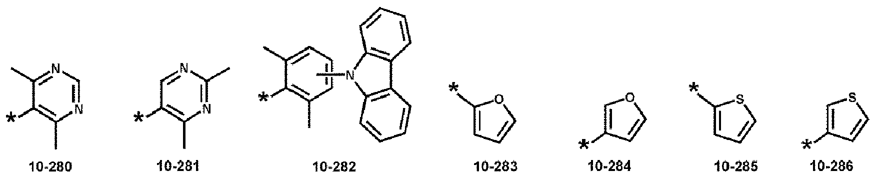

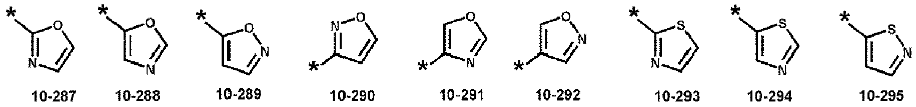

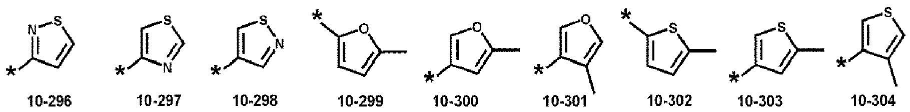

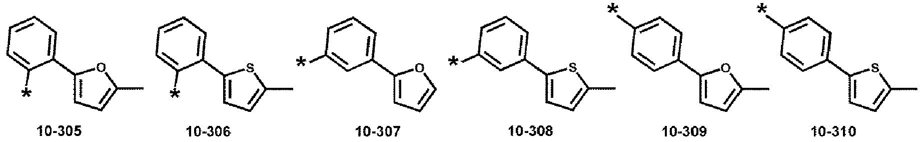

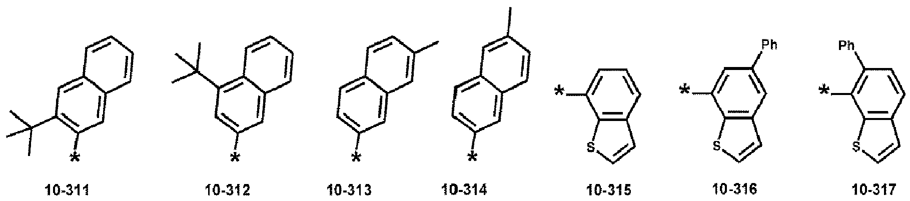

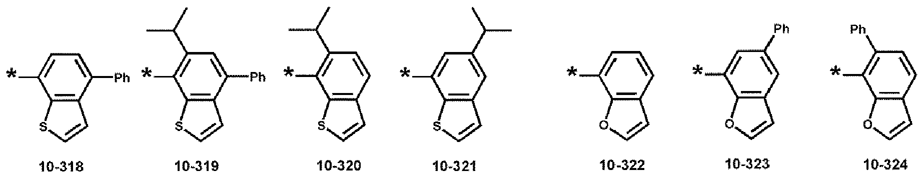

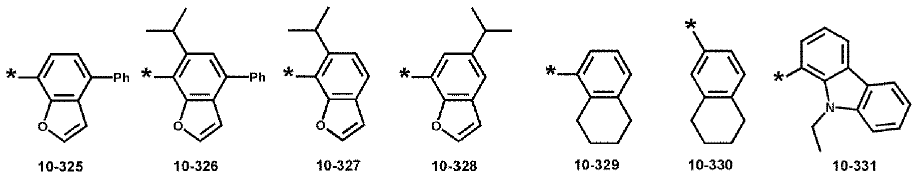

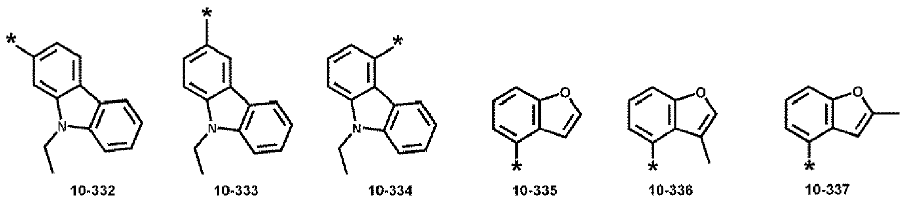

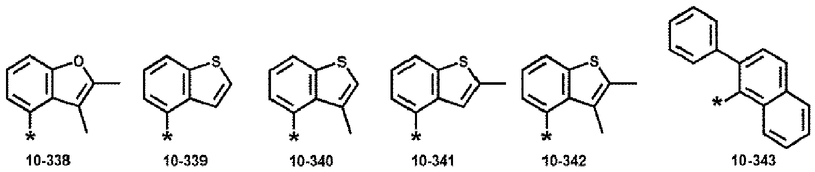

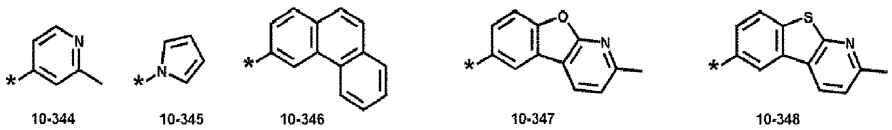

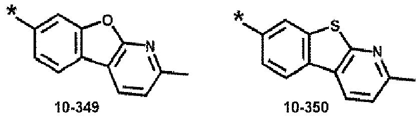

In Formulae 9-1 to 9-39, 9-201 to 9-227, 10-1 to 10-129, and 10-201 to 10-350, * indicates a binding site to a neighboring atom, "Ph" is a phenyl group, "TMS" is a trimethylsilyl group, and "TMG" is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 or 9-601 to 9-636:

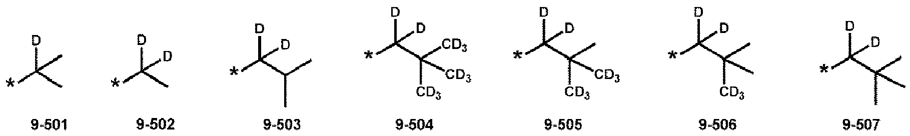

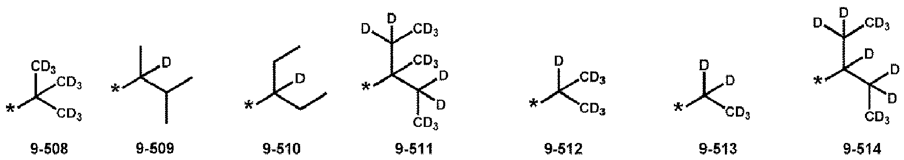

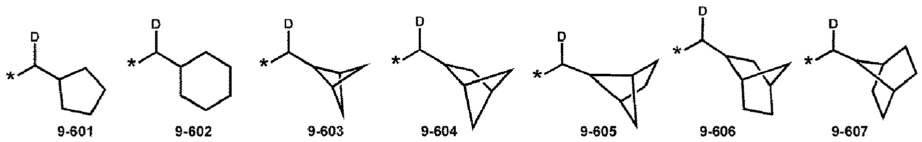

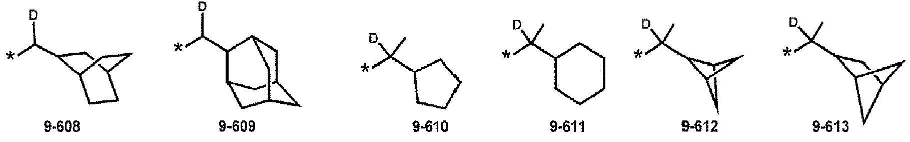

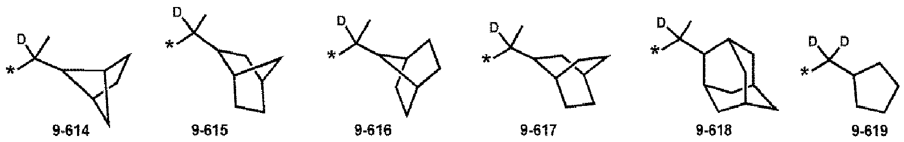

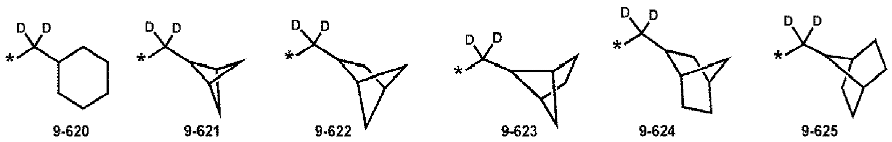

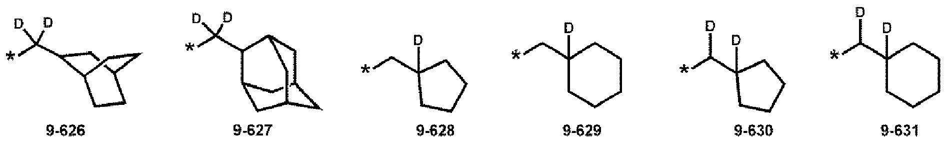

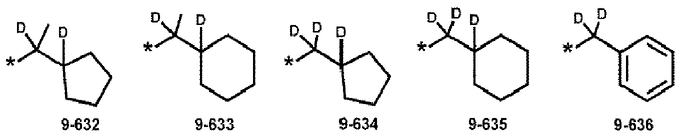

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

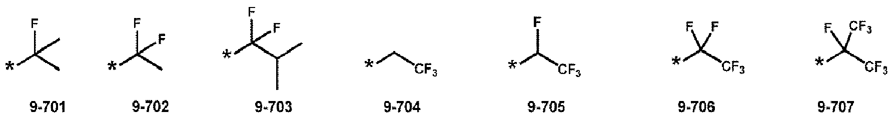

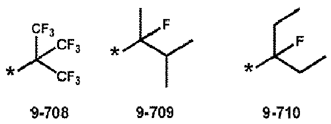

The "group represented by one of Formulae 10-1 to 10-129 in which at least one hydrogen is substituted with deuterium" and "the group represented by one of Formulae 10-201 to 10-350 in which at least one hydrogen is substituted with deuterium" may be, for example, a group represented by one of Formulae 10-501 to 10-553:

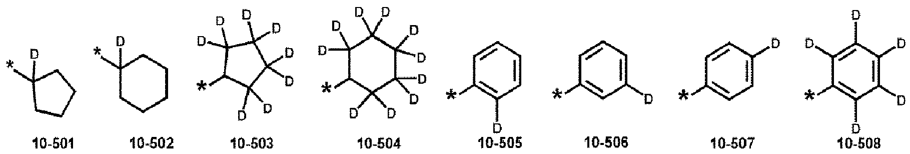

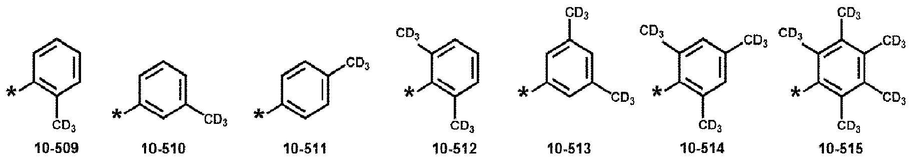

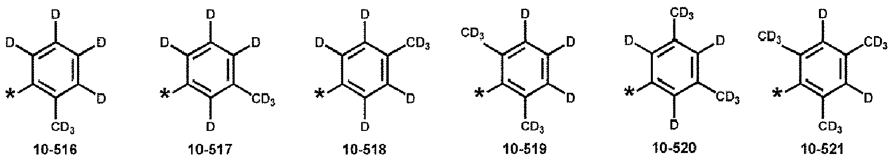

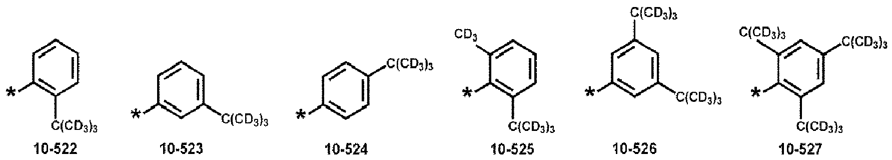

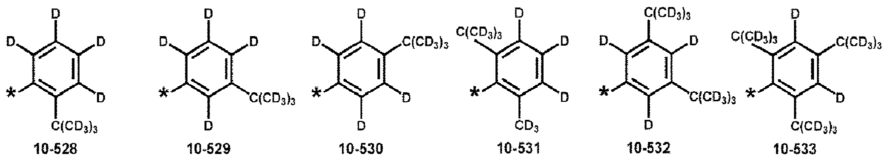

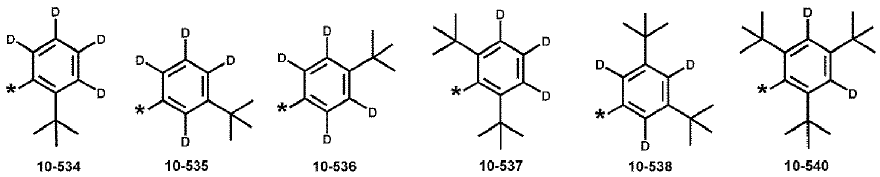

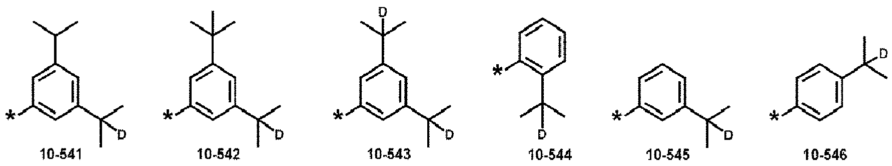

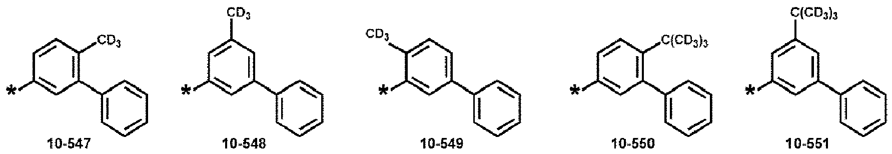

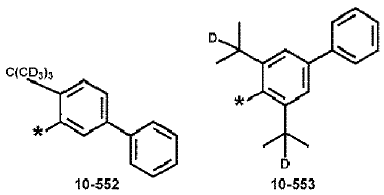

The "group represented by one of Formulae 10-1 to 10-129 in which at least one hydrogen is substituted with -F" and "the group represented by one of Formulae 10-201 to 10-350 in which at least one hydrogen is substituted with -F" may be, for example, a group represented by one of Formulae 10-601 to 10-617:

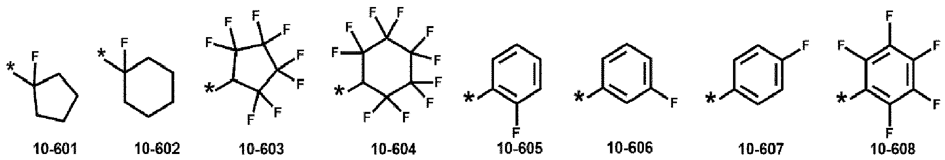

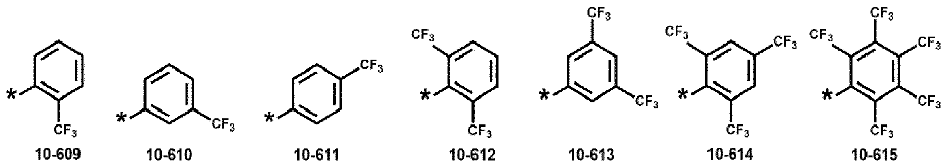

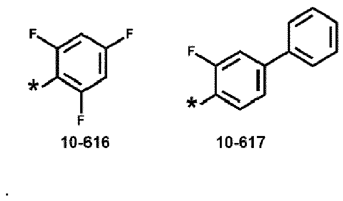

e1 to e4 and d1 to d4 in Formulae 2-1 and 2-2 indicate the numbers of Z₁ to Z₄, a group represented by *-[W₁-(Z₁)ₑ₁], a group represented by *-[W₂-(Z₂)ₑ₂], a group represented by *-[W₃-(Z₃)ₑ₃], and a group represented by *-[W₄-(Z₄)ₑ₄], respectively, and may each independently be an integer from 0 to 20. When e1 is 2 or more, two or more of Z₁ may be identical to or different from each other, when e2 is 2 or more, two or more of Z₂ may be identical to or different from each other, when e3 is 2 or more, two or more of Z₃ may be identical to or different from each other, when e4 is 2 or more, two or more of Z₄ may be identical to or different from each other, when d1 is 2 or more, two or more of groups represented by *-[W₁-(Z₁)ₑ₁] may be identical to or different from each other, when d2 is 2 or more, two or more of groups represented by *-[W₂-(Z₂)ₑ₂] may be identical to or different from each other, when d3 is 2 or more, two or more of groups represented by *-[W₃-(Z₃)ₑ₃] may be identical to or different from each other, and when d4 is 2 or more, two or more of groups represented by *-[W₄-(Z₄)ₑ₄] may be identical to or different from each other. For example, e1 to e4 and d1 to d4 in Formulae 2-1 and 2-2 may each independently be 0, 1, 2, or 3.

Meanwhile, in one or more embodiments, the iridium-containing organometallic compound may not be tris[2-phenylpyridine]iridium.

In one or more embodiments, in Formula 2-1, a case where Y₁ is N, ring A₁ is a pyridine group, Y₂ is C, ring A₂ is a benzene group, and each of d1 and d2 is 0, may be excluded.

In Formulae 2-1 and 2-2, at least one of i) two or more of a plurality of Z₁, ii) two or more of a plurality of Z₂, iii) two or more a plurality of Z₃, iv) two or more of a plurality of Z₄, and v) two or more of Z₁ to Z₄ may optionally be bonded to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

R₁₀ₐ is as described herein in connection with Z₁.

The symbols * and *' as used herein each indicate a binding site to a neighboring atom, unless otherwise stated.

In one or more embodiments,
Y₁ in Formula 2-1 may be N, and
a group represented by 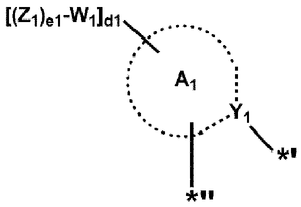
in Formula 2-1 may be a group represented by one of FormulaeA1-1 to A1-3: 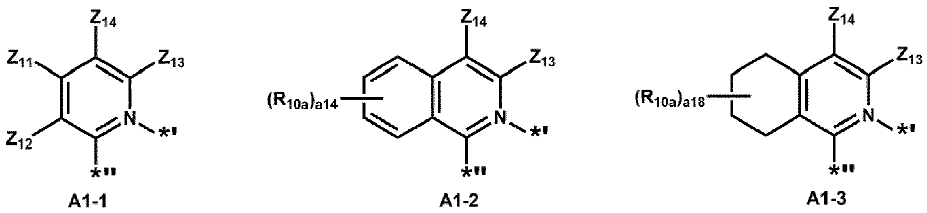 wherein, in Formulae A1-1 to A1-3,
Z₁₁ to Z₁₄ may each be as described in connection with Z₁,
R₁₀ₐ may be understood by referring to the description of R₁₀ₐ provided herein, and
a14 may be an integer from 0 to 4,
a18 may be an integer from 0 to 8,
*' indicates a binding site to M₂ in Formula 2, and
*" indicates a binding site to ring A₂.

For example, at least one of Z₁₁, Z₁₂, and Z₁₄ (for example, Z₁₄) in Formulae A1-1 to A1-3 may be:
a C₁-C₂₀ alkyl group that is unsubstituted or substituted with at least one of deuterium, -F, a phenyl group, or a combination thereof;
-Si(Q₃)(Q₄)(Q₅); or
-Ge(Q₃)(Q₄)(Q₅).

In one or more embodiments,
Y₃ in Formula 2-2 may be N, and
a group represented by 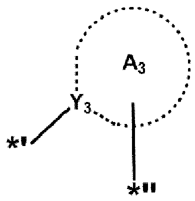
in Formula 2-2 may be a group represented by one of Formulae NR1 to NR48: 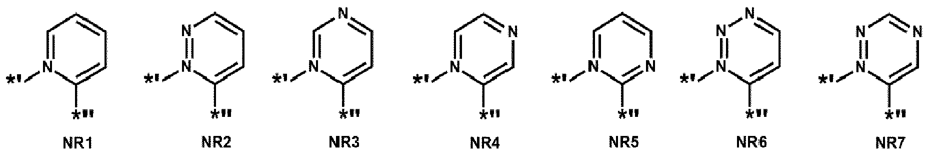 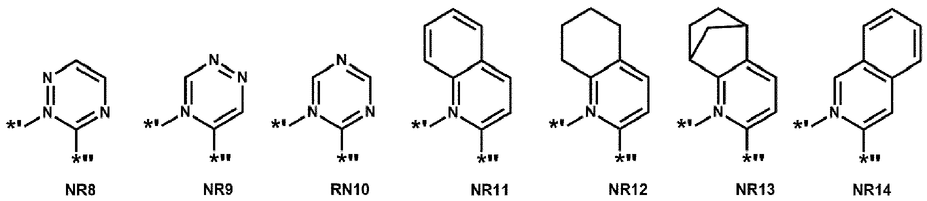 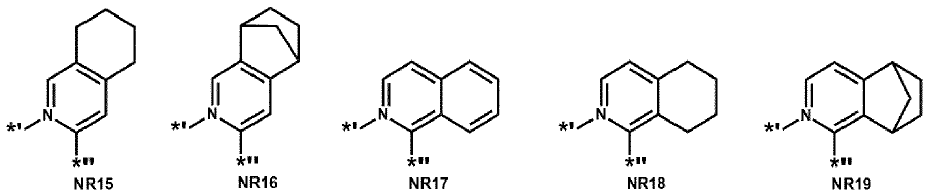 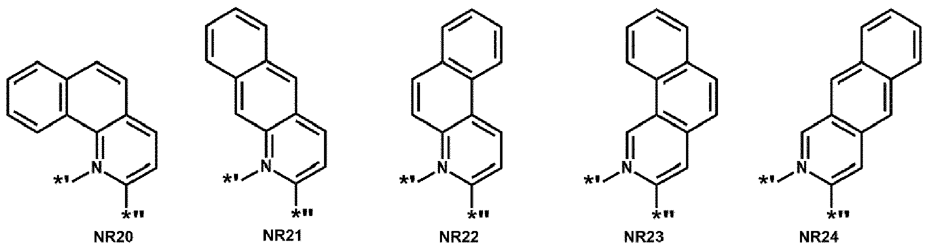 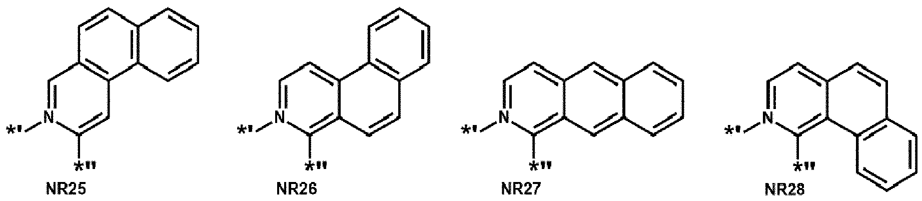 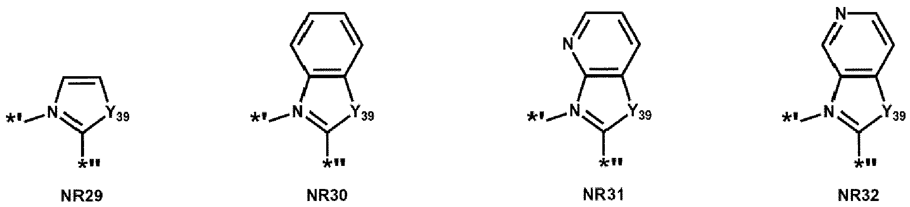 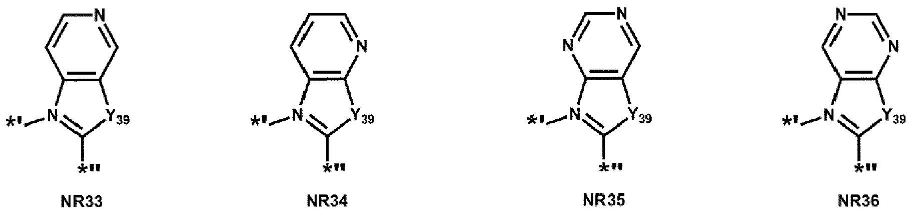 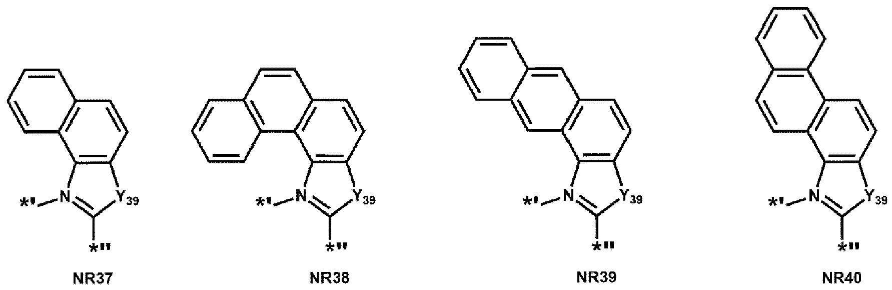 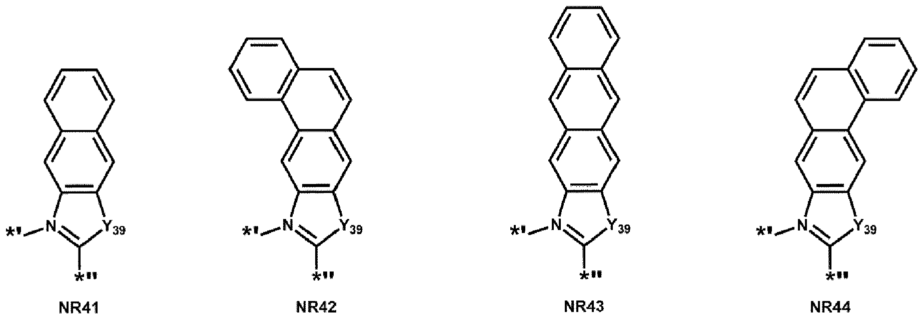 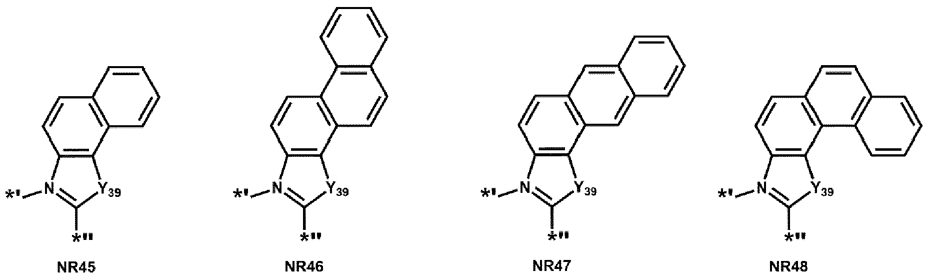 wherein, in Formulae NR1 to NR48,
Y₃₉ may be O, S, Se, N-[W₃-(Z₃)ₑ₃], C(Z₃₉ₐ)(Z_{39b}), or Si(Z₃₉ₐ)(Z_{39b}),
W₃, Z₃, and e3 may each be as described herein, and Z₃₉ₐ and Z_{39b} may each be as described in connection with Z₃,
*' indicates a binding site to M₂ in Formula 2, and
*" indicates a binding site to ring A₄.

In one or more embodiments,
in Formulae 2-1 and 2-2, each of Y₂ and Y₄ may be C, and
a group represented by 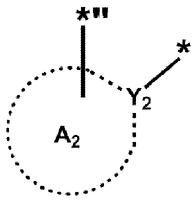
in Formula 2-1 and a group represented by 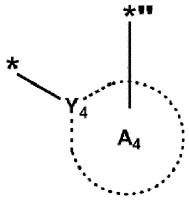 in Formula 2-2 may each independently be a group represented by one of Formulae CR1 to CR29: 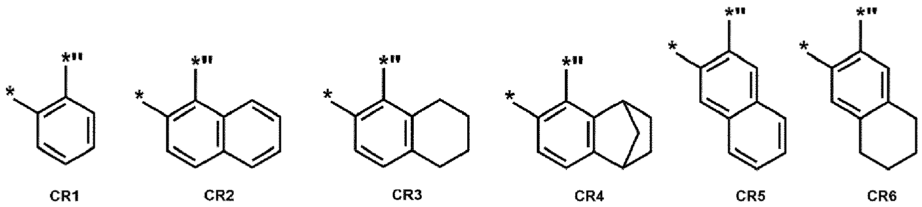 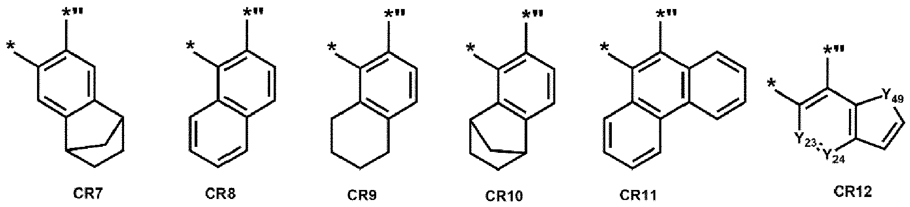 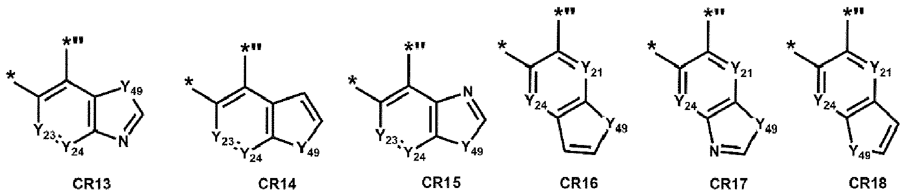 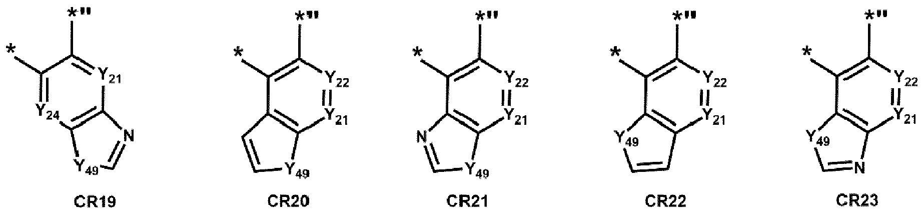 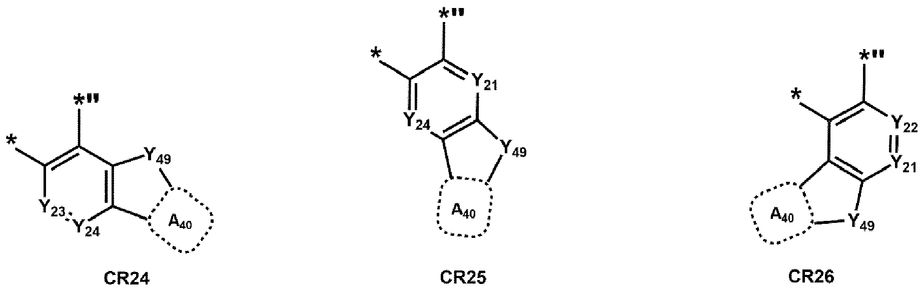 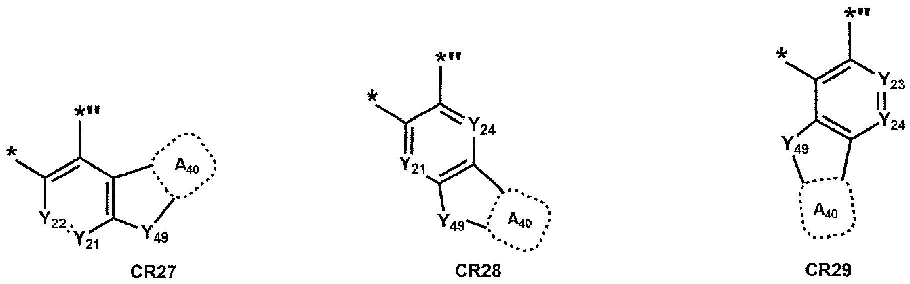 wherein, in Formulae CR1 to CR29,
Y₄₉ may be O, S, Se, N-[W₂-(Z₂)ₑ₂], N-[W₄-(Z₄)ₑ₄], C(Z₂₉ₐ)(Z_{29b}), C(Z49a)(Z49b), Si(Z29a)(Z29b), or Si(Z49a)(Z49b),
W₂, W₄, Z₂, Z₄, e2, and e4 may each be as described herein, Z₂₉ₐ and Z_{29b} may each be as described in connection with Z₂, and Z₄₉ₐ and Z_{49b} may each be as described in connection with Z₄,
Y₂₁ to Y₂₄ may each independently be N or C,
ring A₄₀ may be a C₅-C₃₀ carbocyclic group or a C₁-C₃₀ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, a benzoquinazoline group, or the like),
* indicates a binding site to M₂ in Formula 2, and
*" indicates a binding site to ring A₁ or ring A₃.

In one or more embodiments,
a group represented by 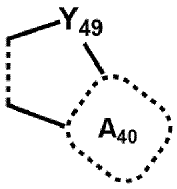 in Formulae CR24 to CR29 may be a group represented by one of Formulae CR(1) to CR(13): 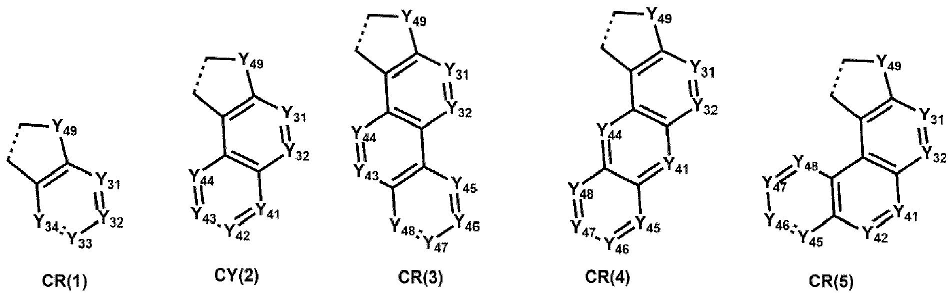 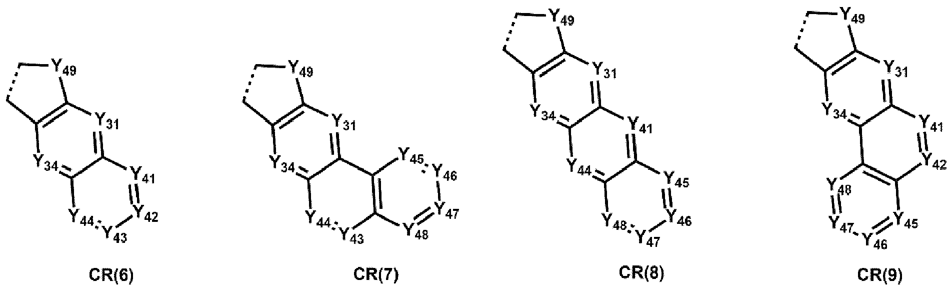 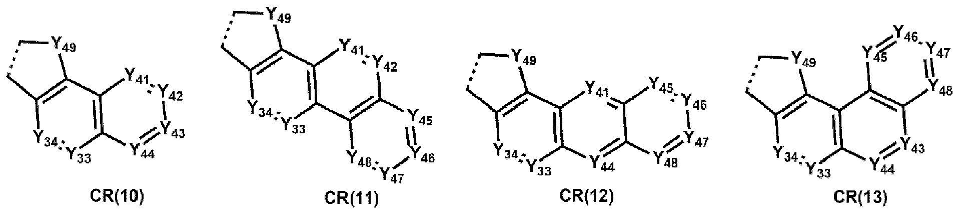 wherein, in Formulae CR(1) to CR(13),
Y₄₉ may be as described herein, and
Y₃₁ to Y₃₄ and Y₄₁ to Y₄₈ may each independently be C or N.

In one or more embodiments, the iridium-containing organometallic compound may include at least one deuterium.

In one or more embodiments, the iridium-containing organometallic compound may be an organometallic compound represented by Formula 2 satisfying all of the following i) to v):
i) n11 and n13 each are 0,
ii) n12 is 3, and three L₁₂ are identical to each other,
iii) in Formula 2-2, Y₃ is N, and Y₄ is C,
iv) a group represented by 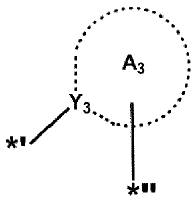 in Formula 2-2 may be a group represented by one of Formulae NR29 to NR48, and
v) a group represented by 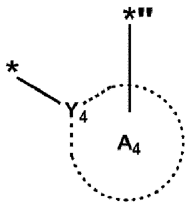
in Formula 2-2 is a group represented by one of Formulae CR24 to CR29, and Y₄₉ in Formulae CR24 to CR29 may be O, S, Se, or Si(Z₄₉ₐ)(Z_{49b}).

For example, the iridium-containing organometallic compound may be selected from the compounds of [Group 1-1] to [Group 1-7]:

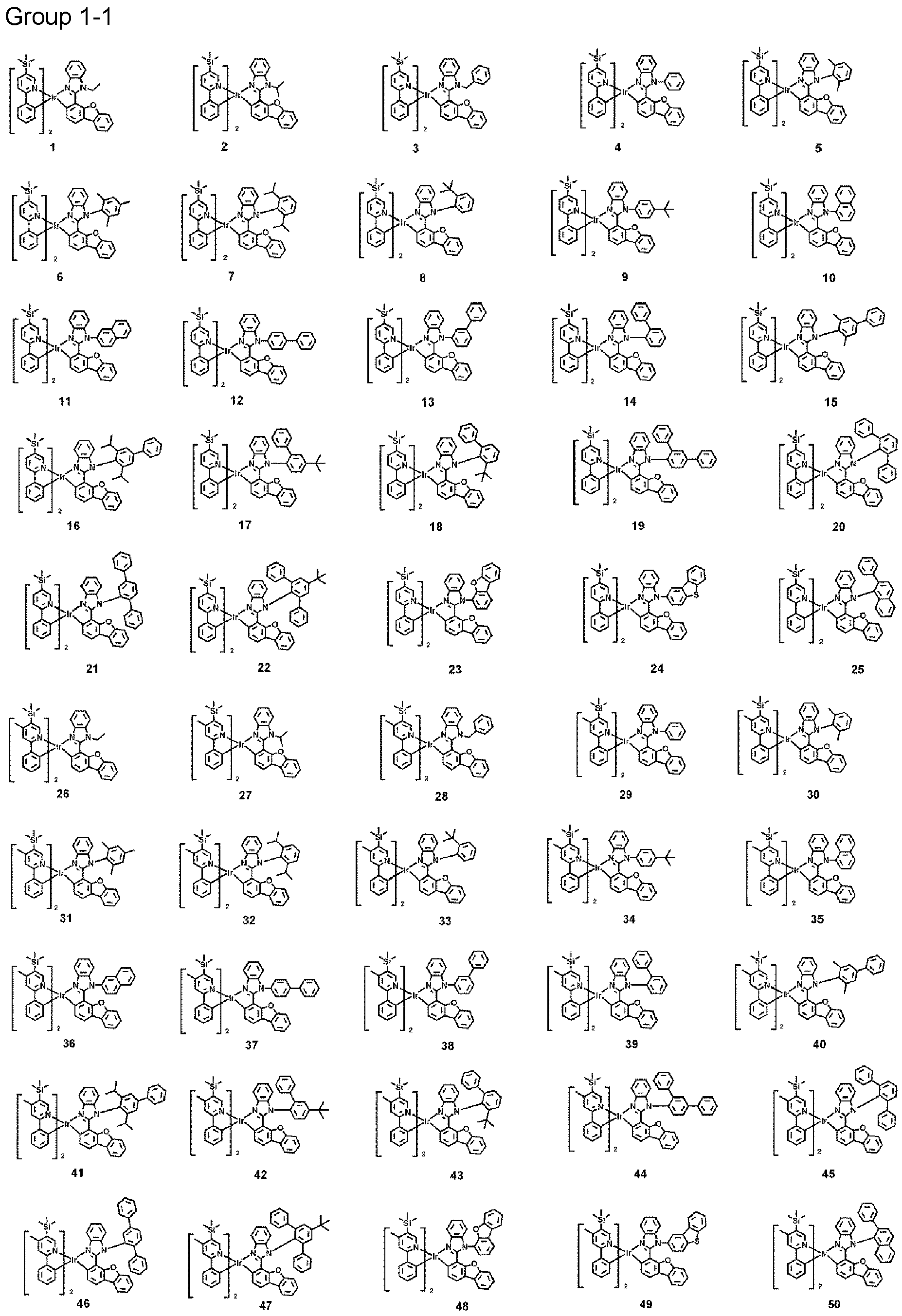

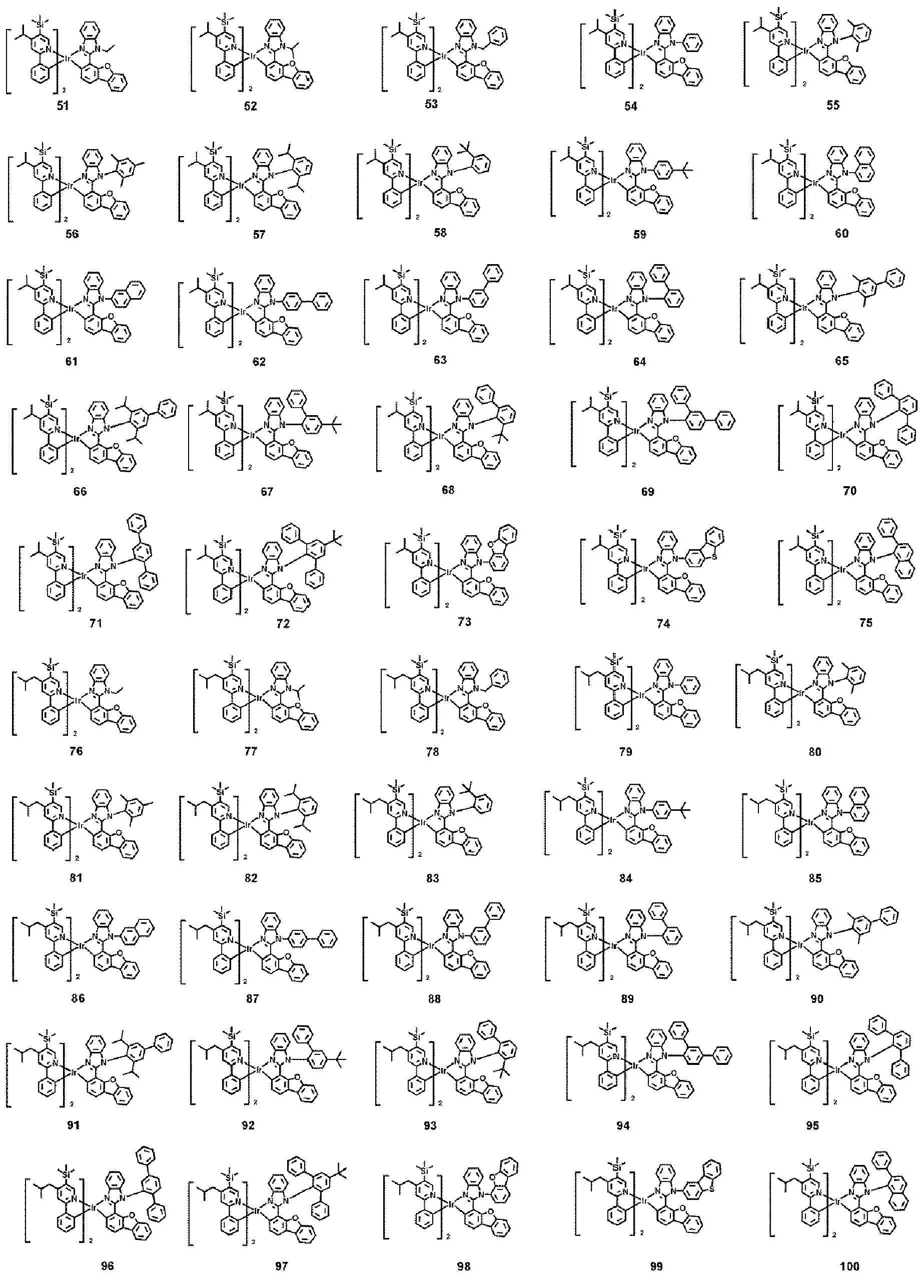

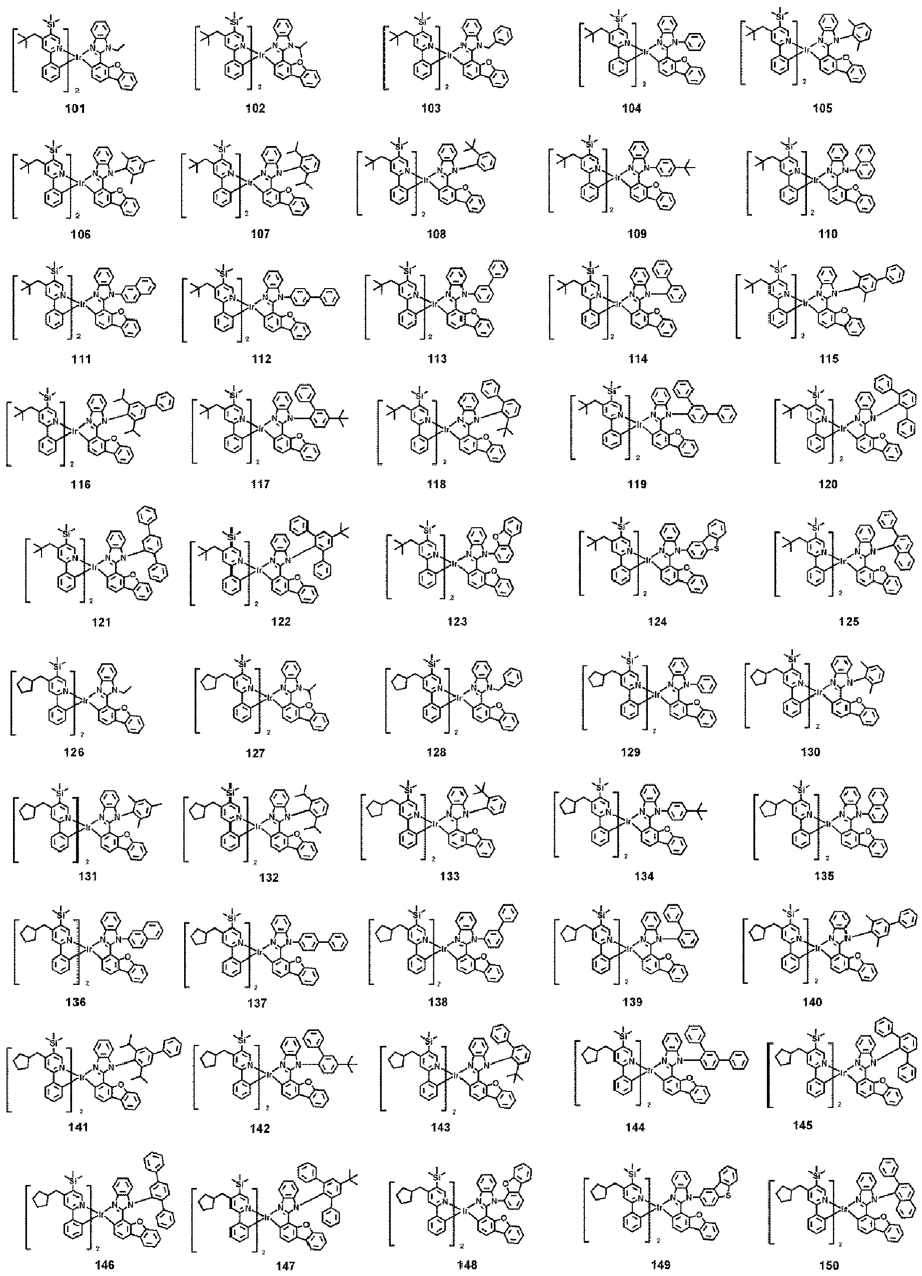

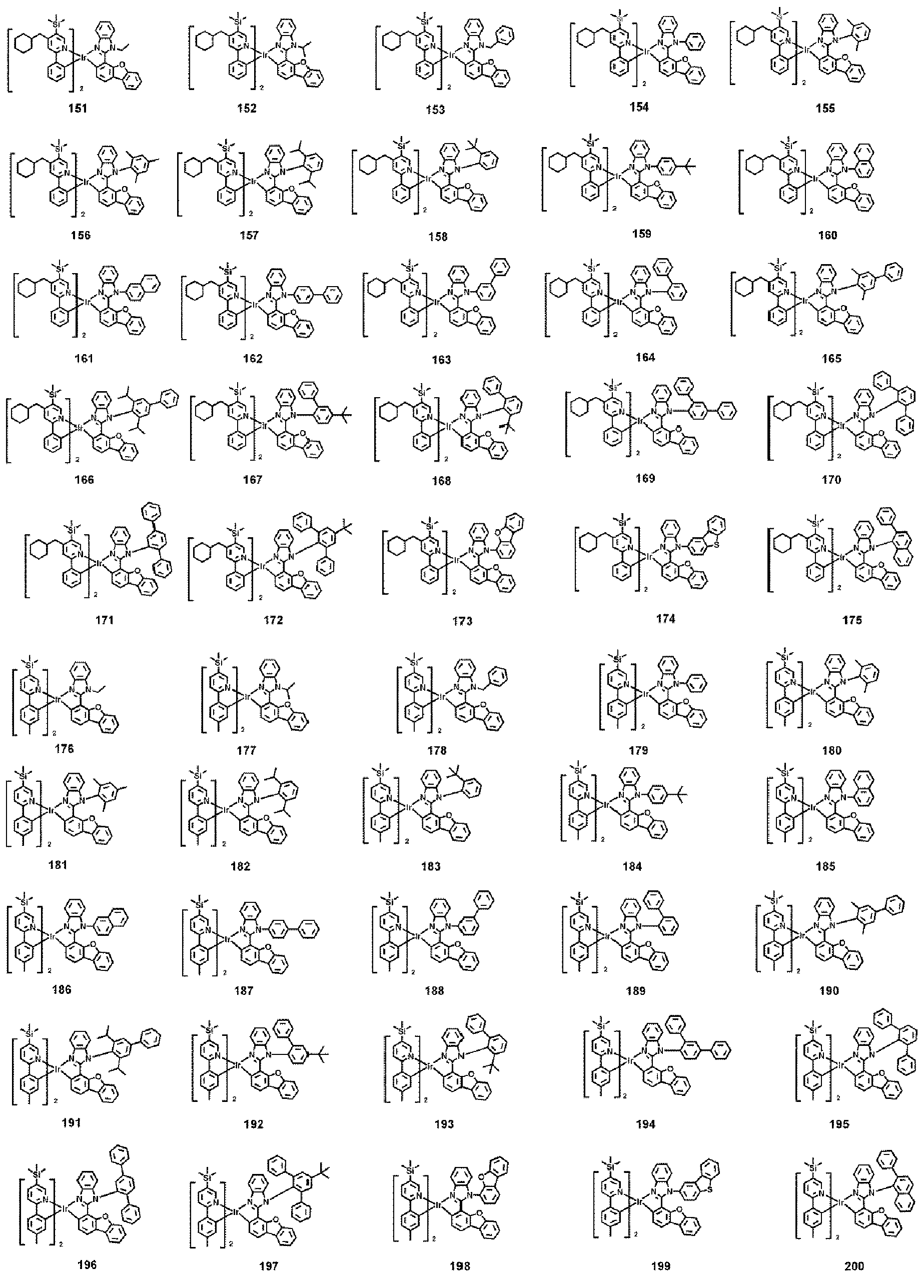

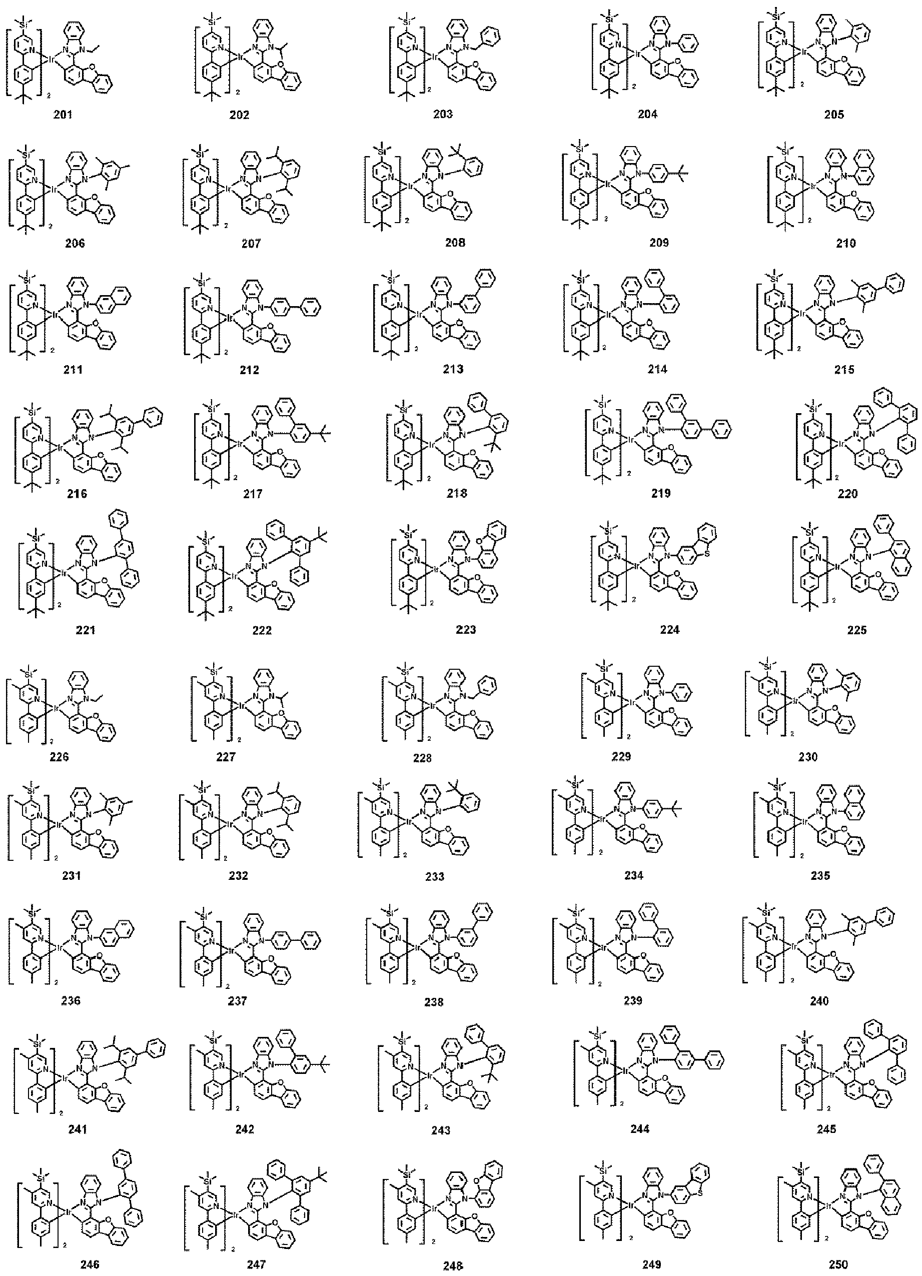

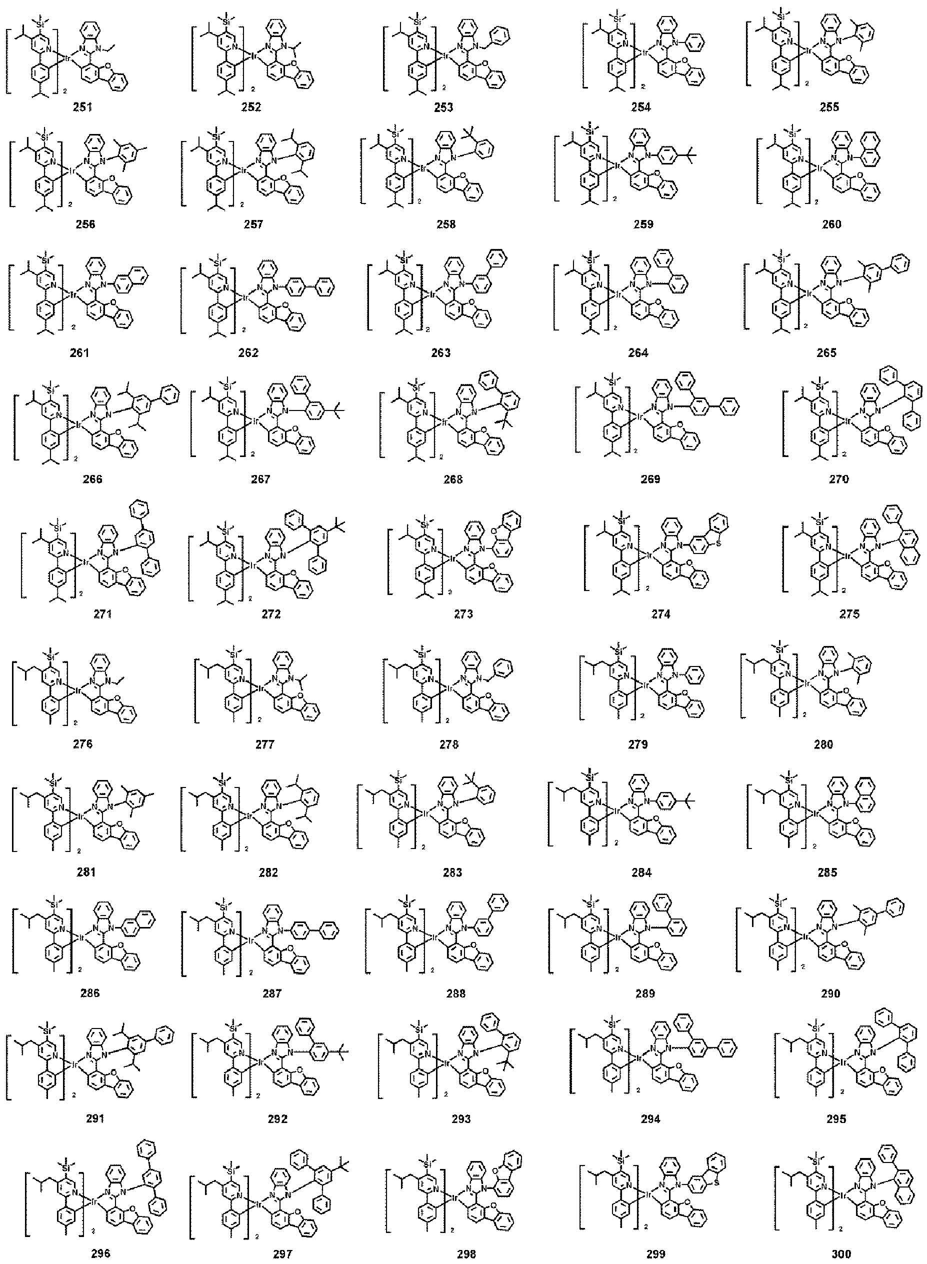

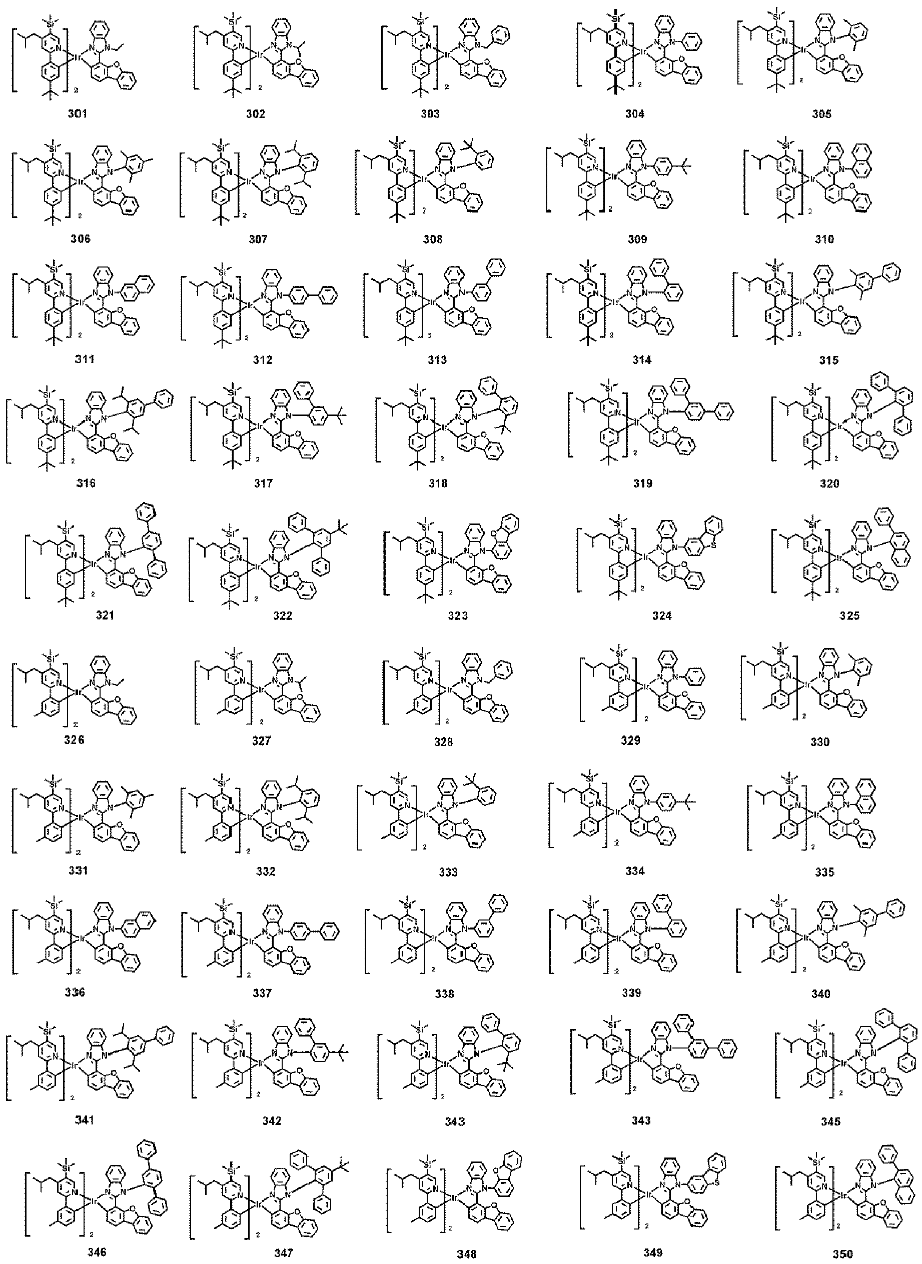

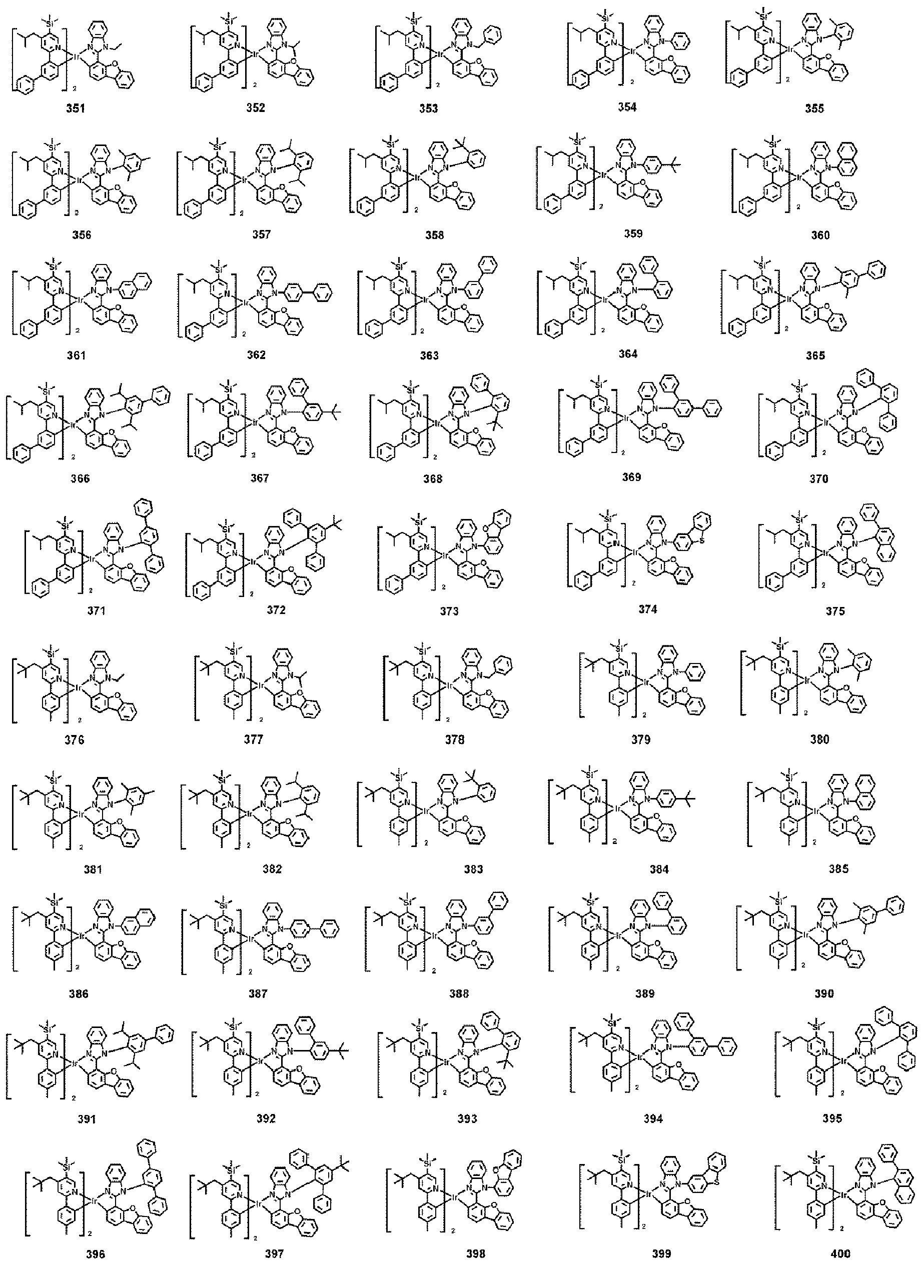

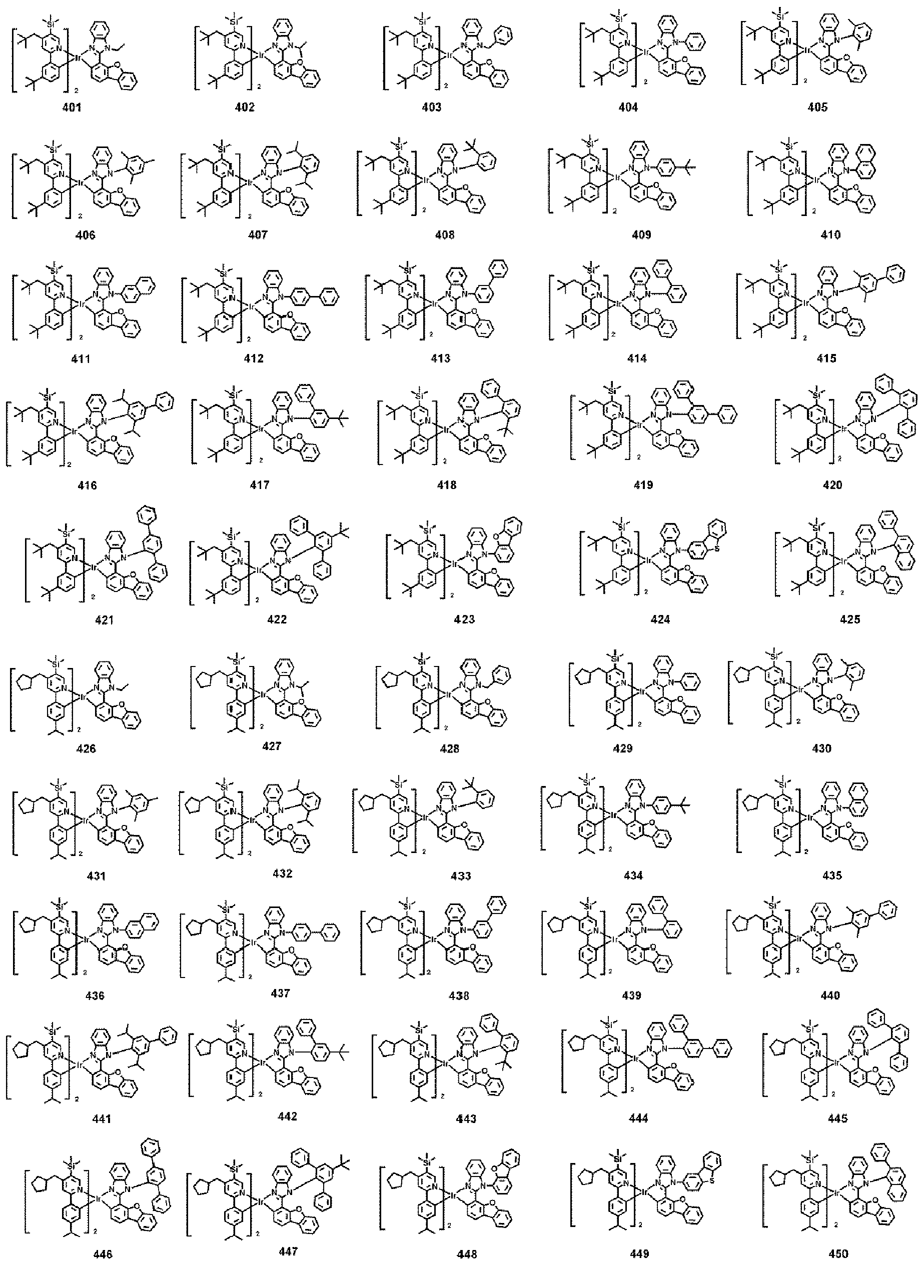

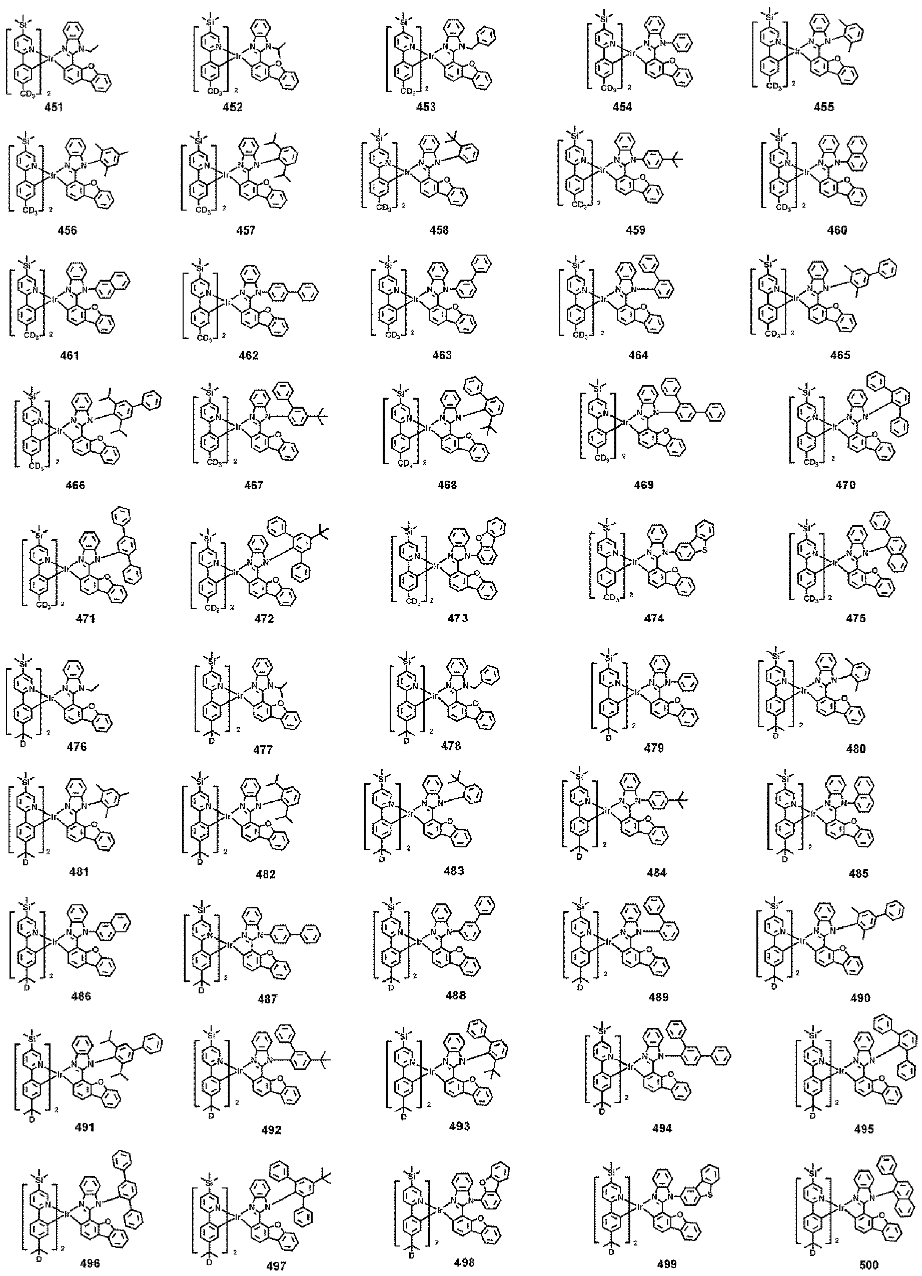

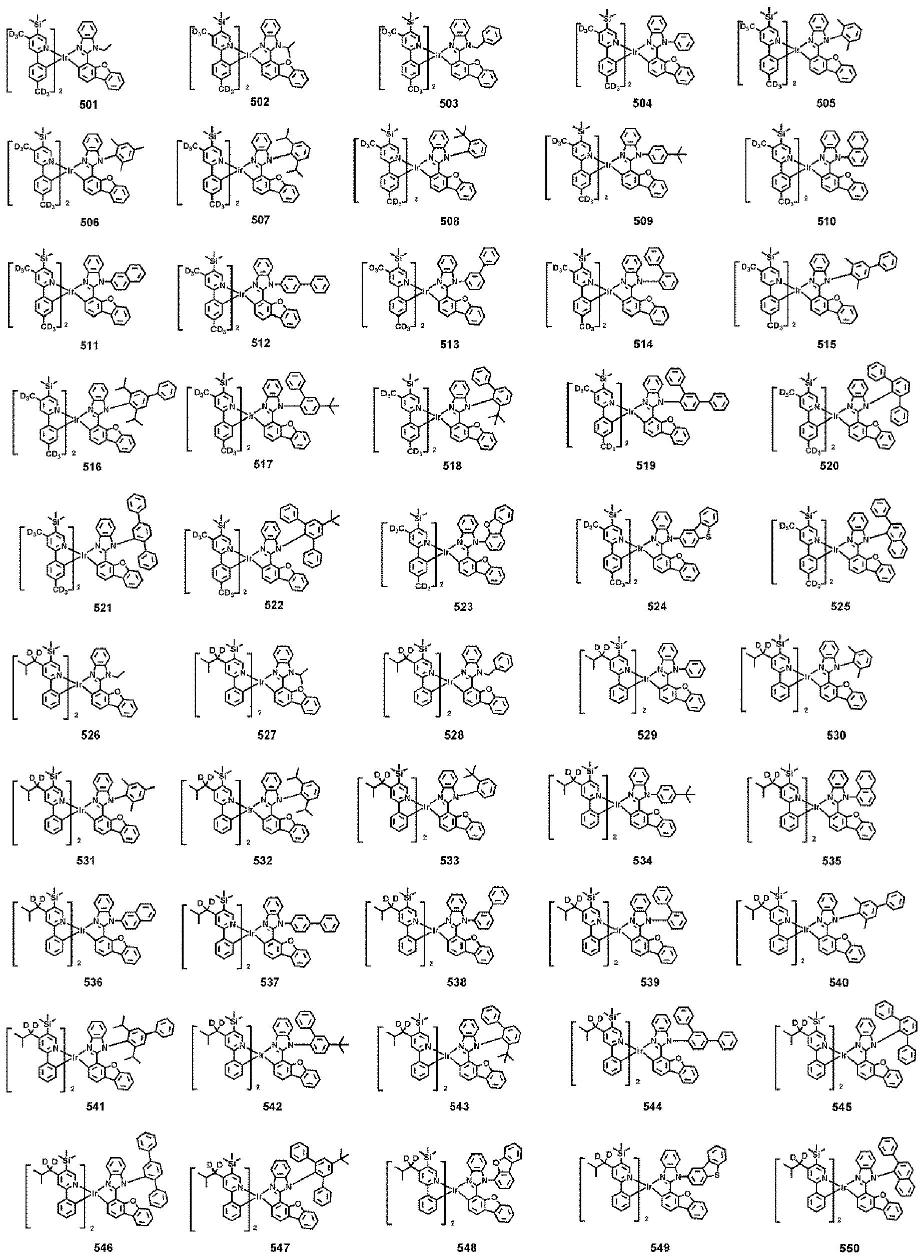

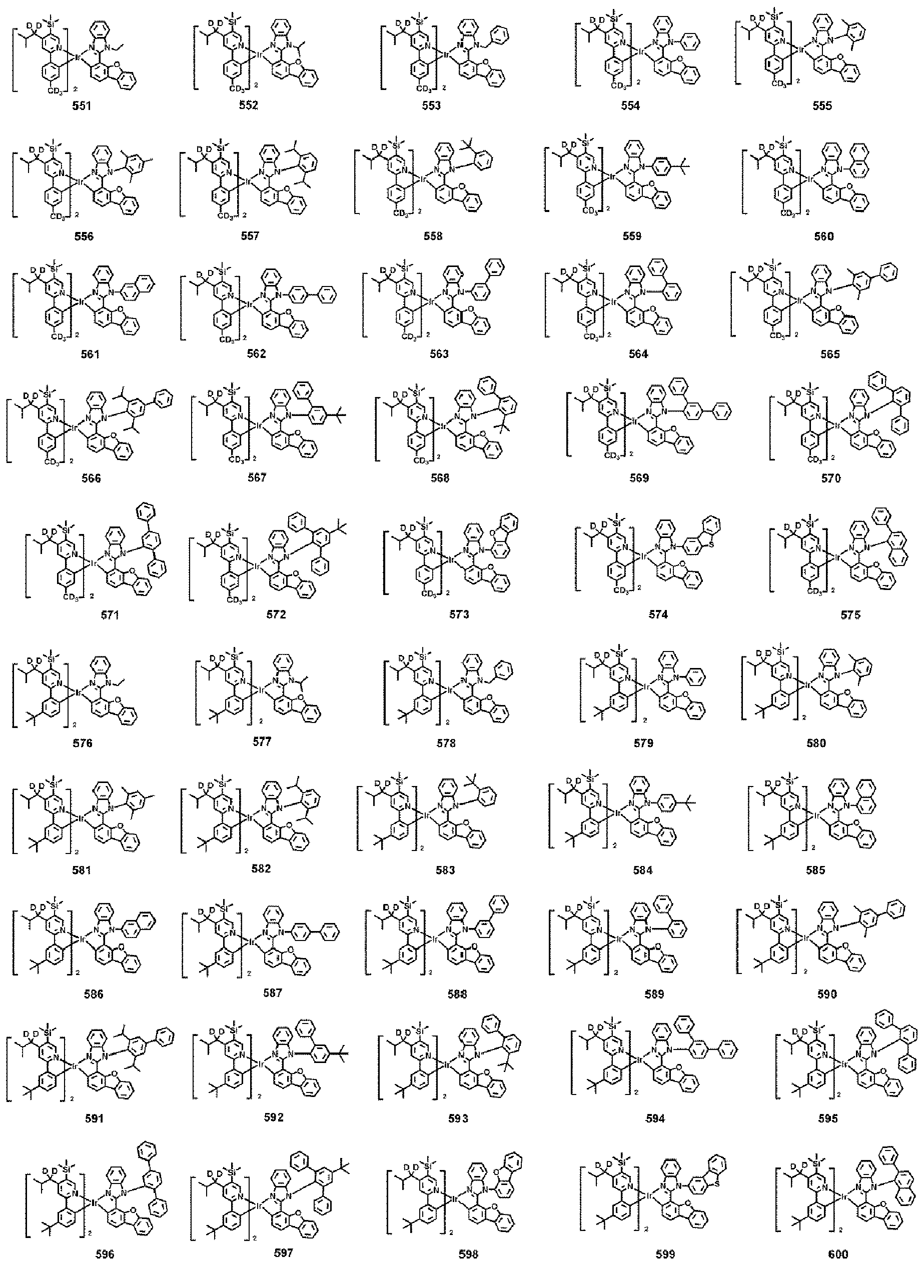

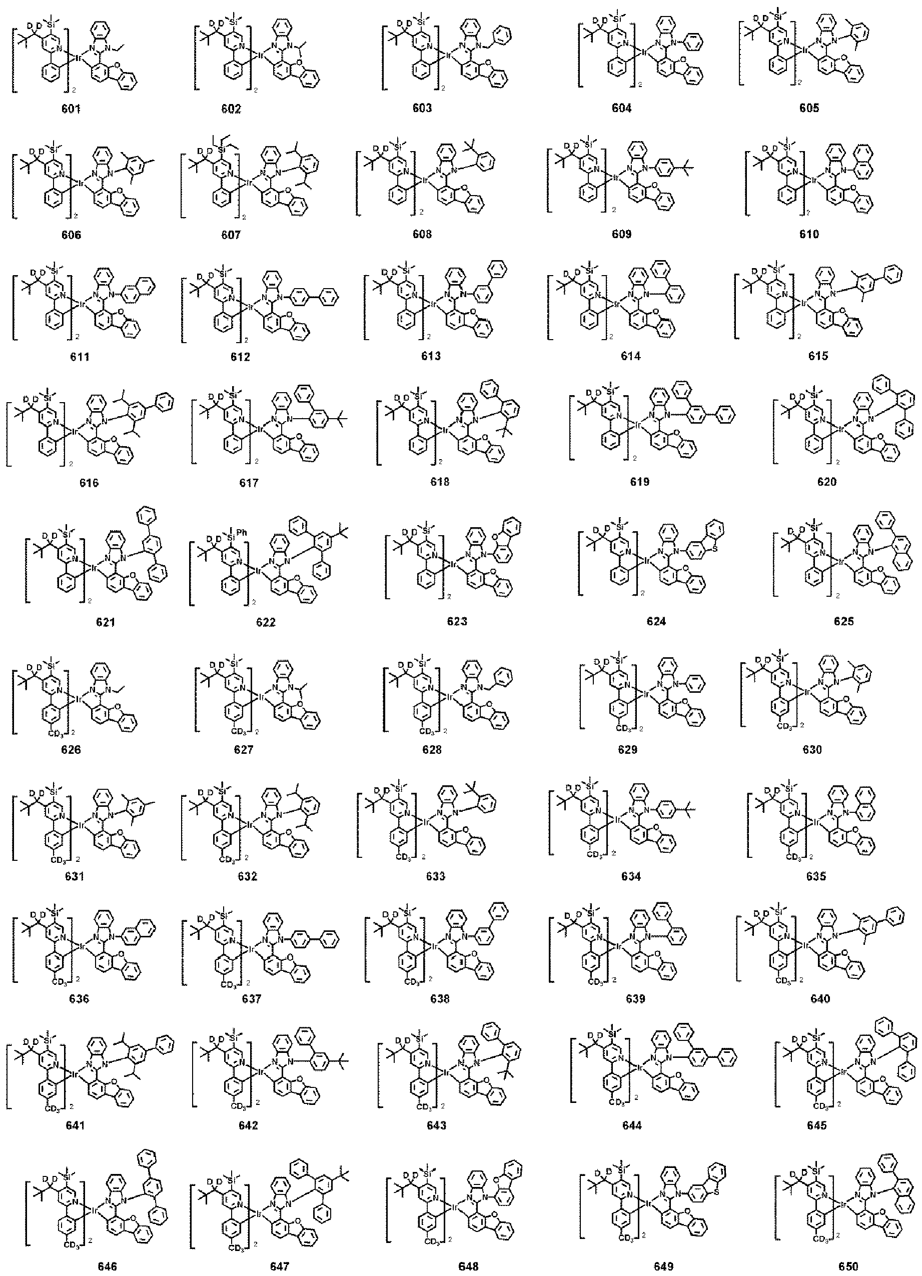

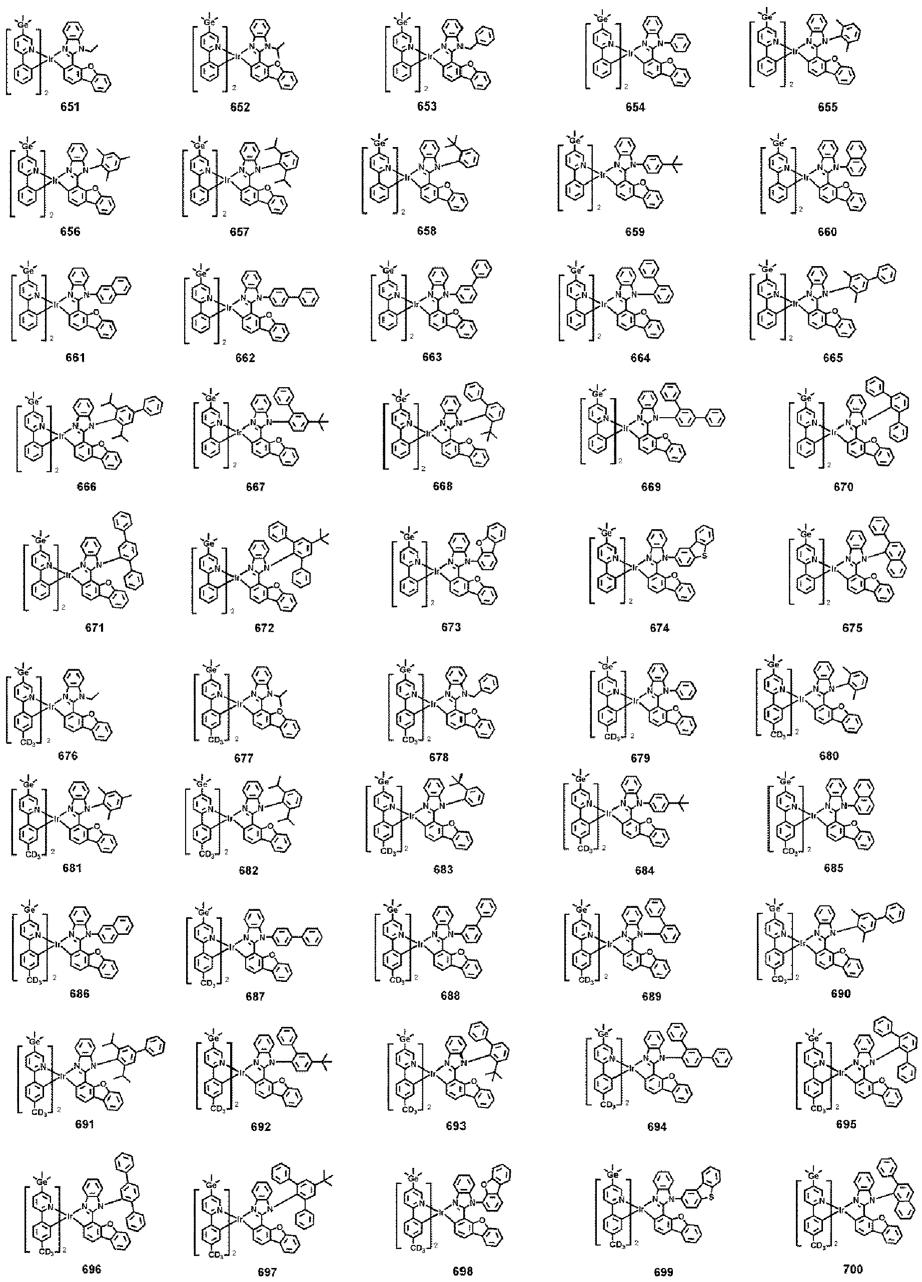

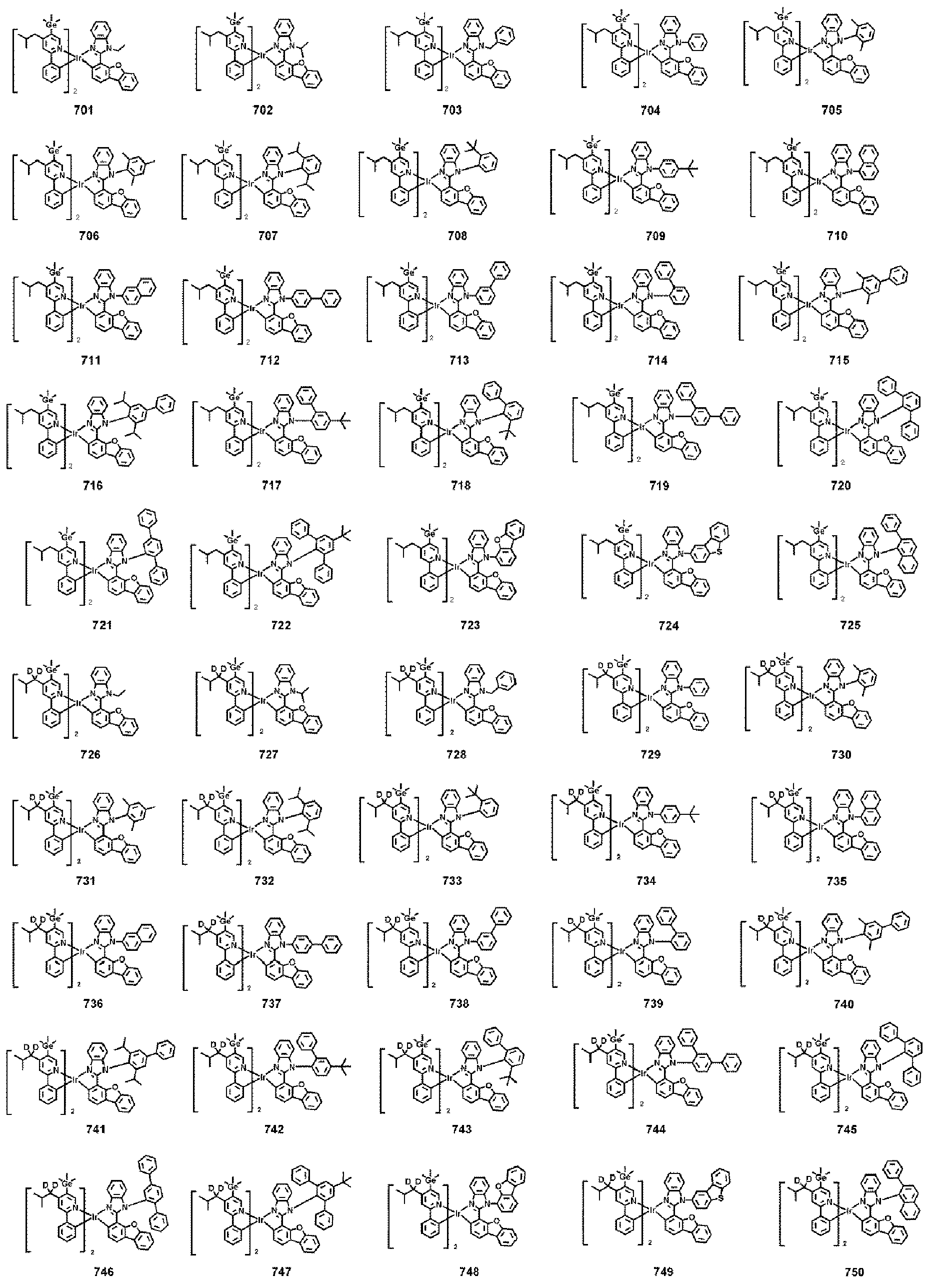

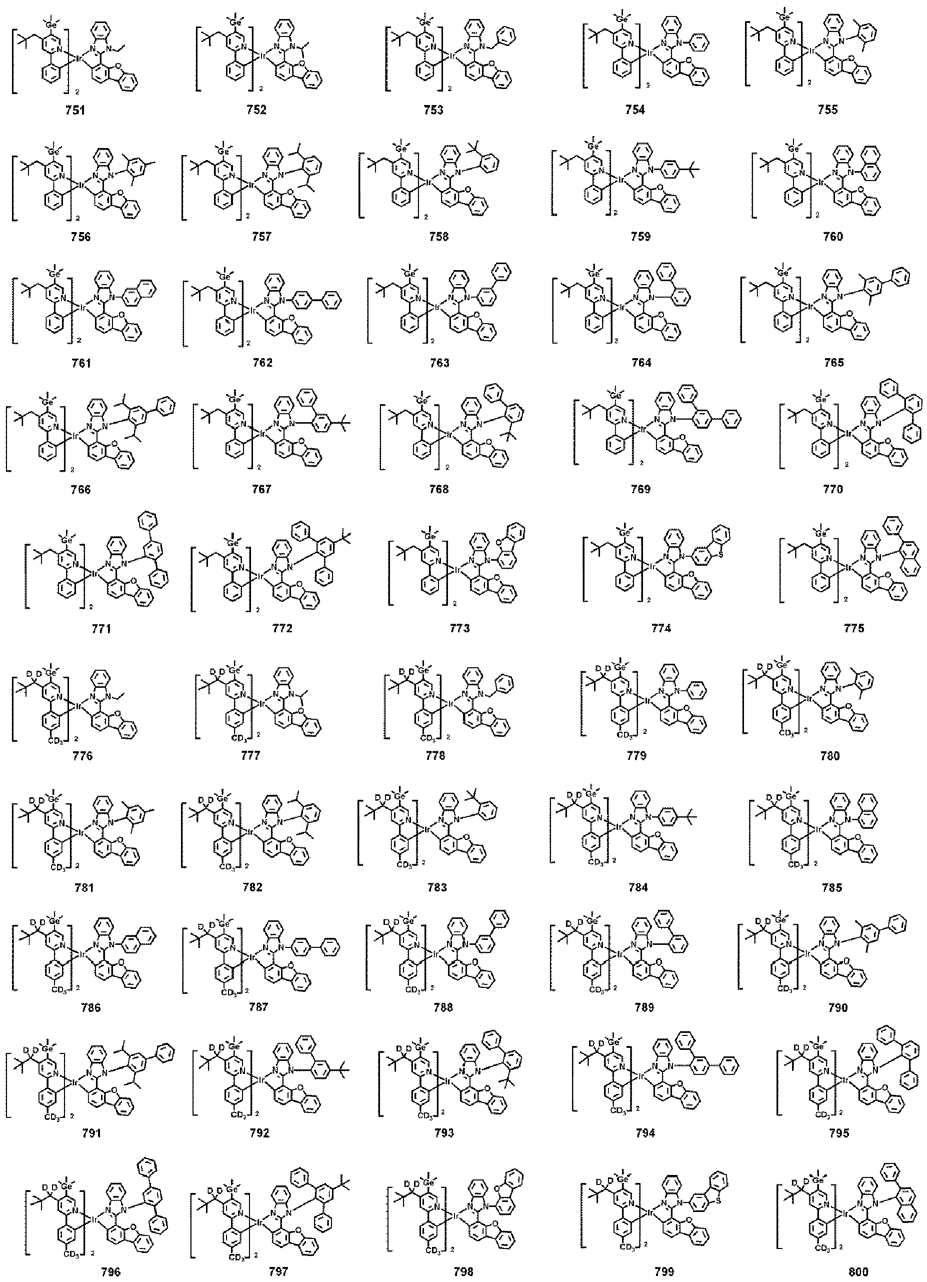

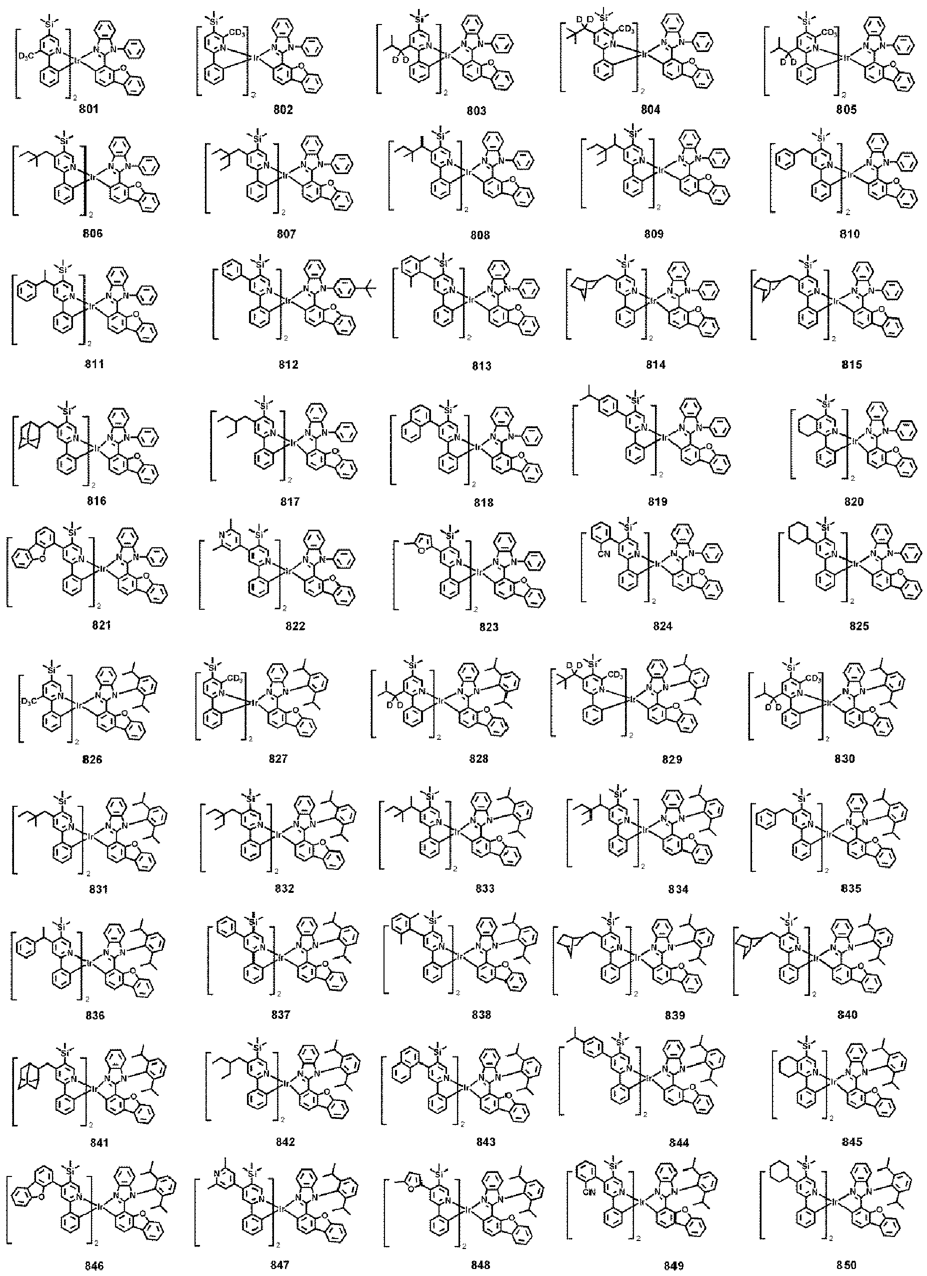

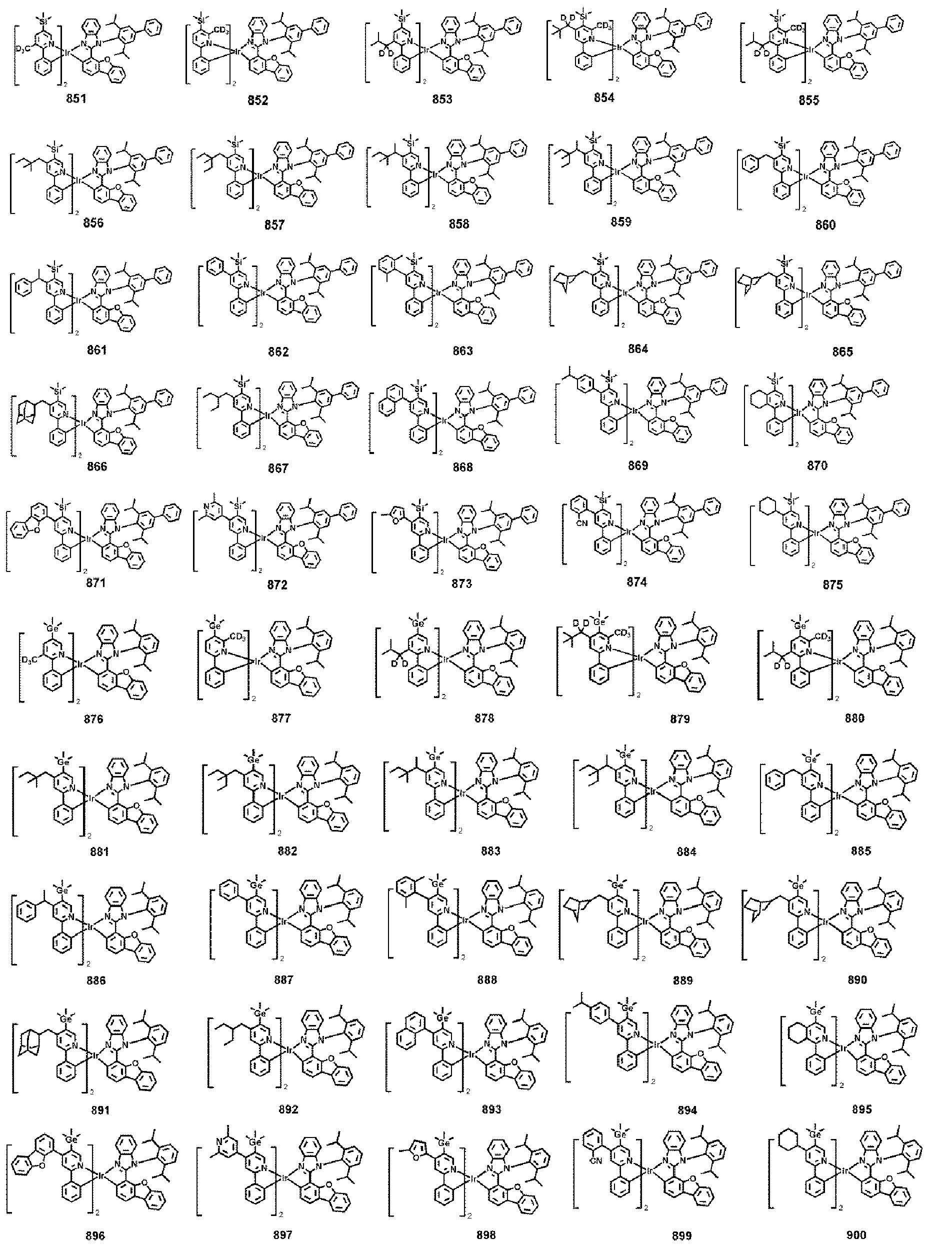

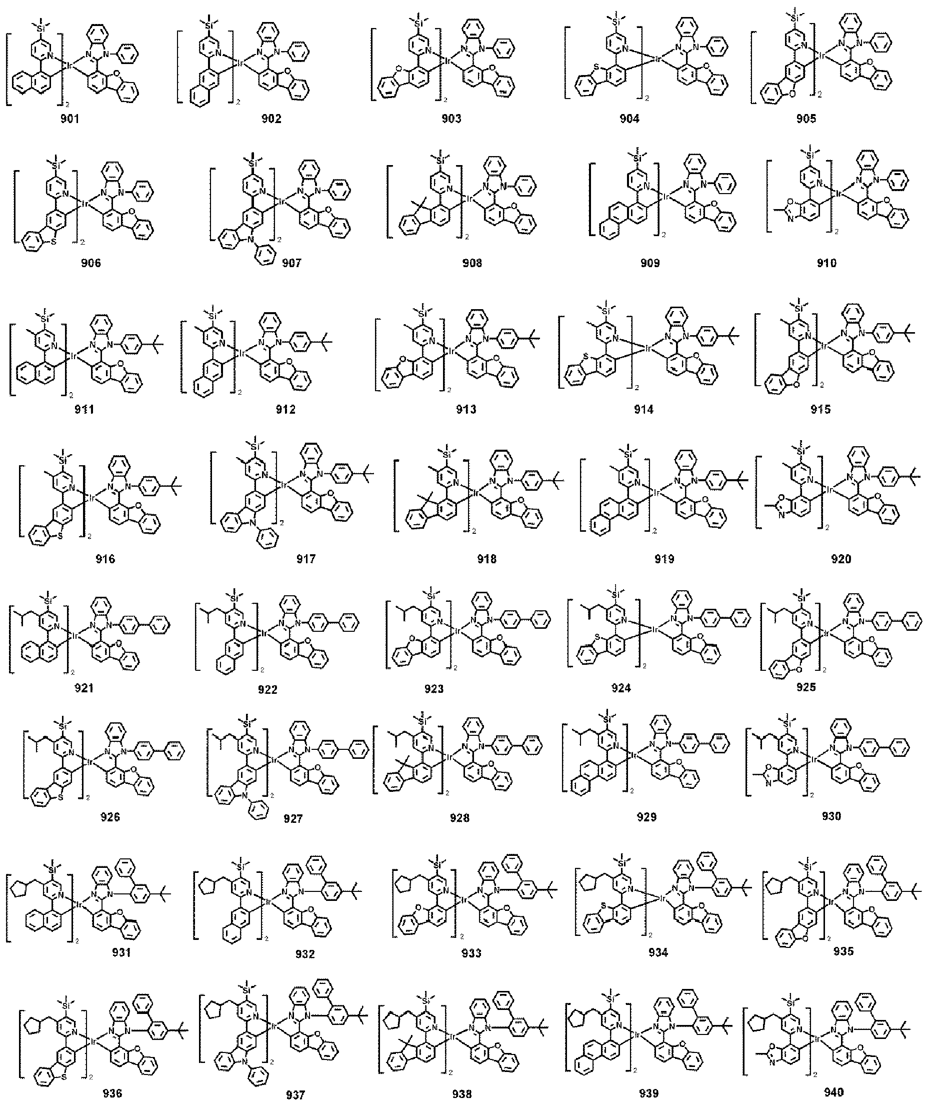

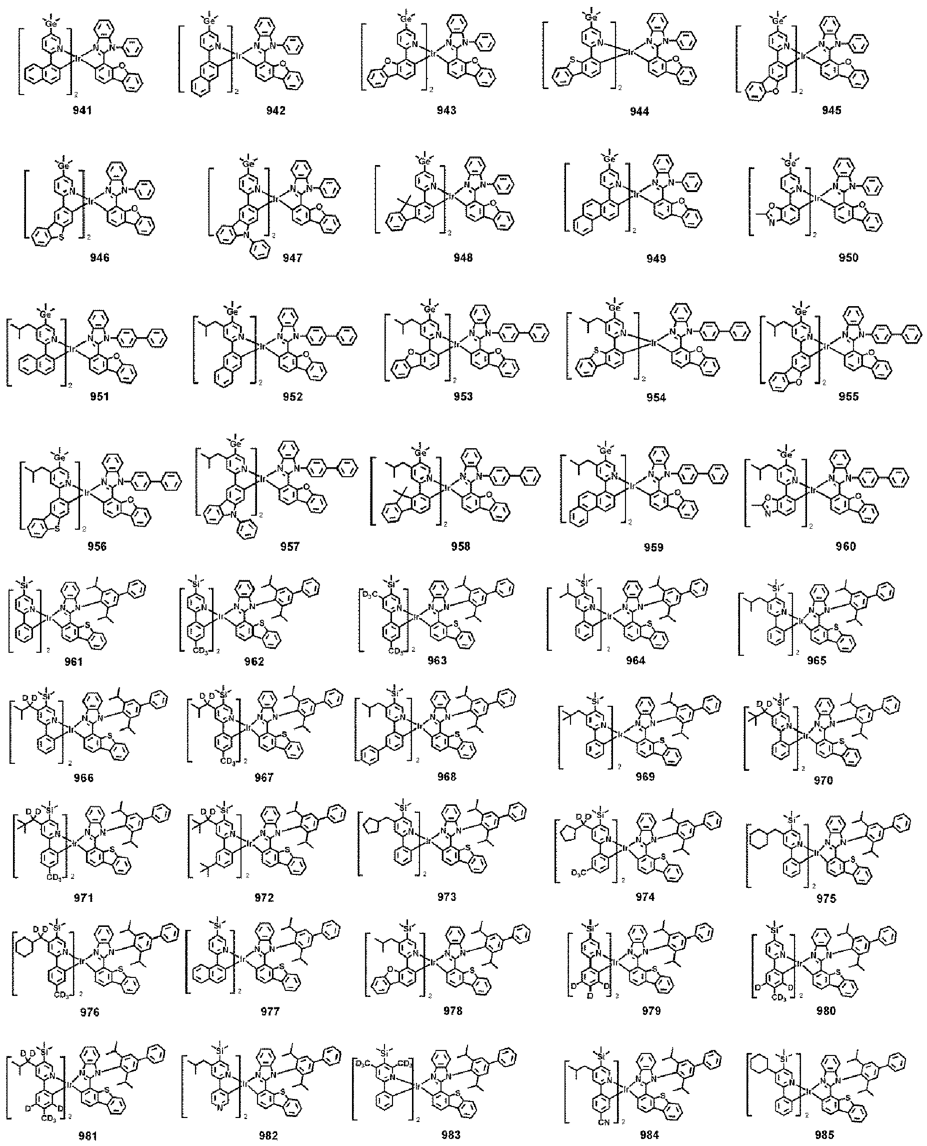

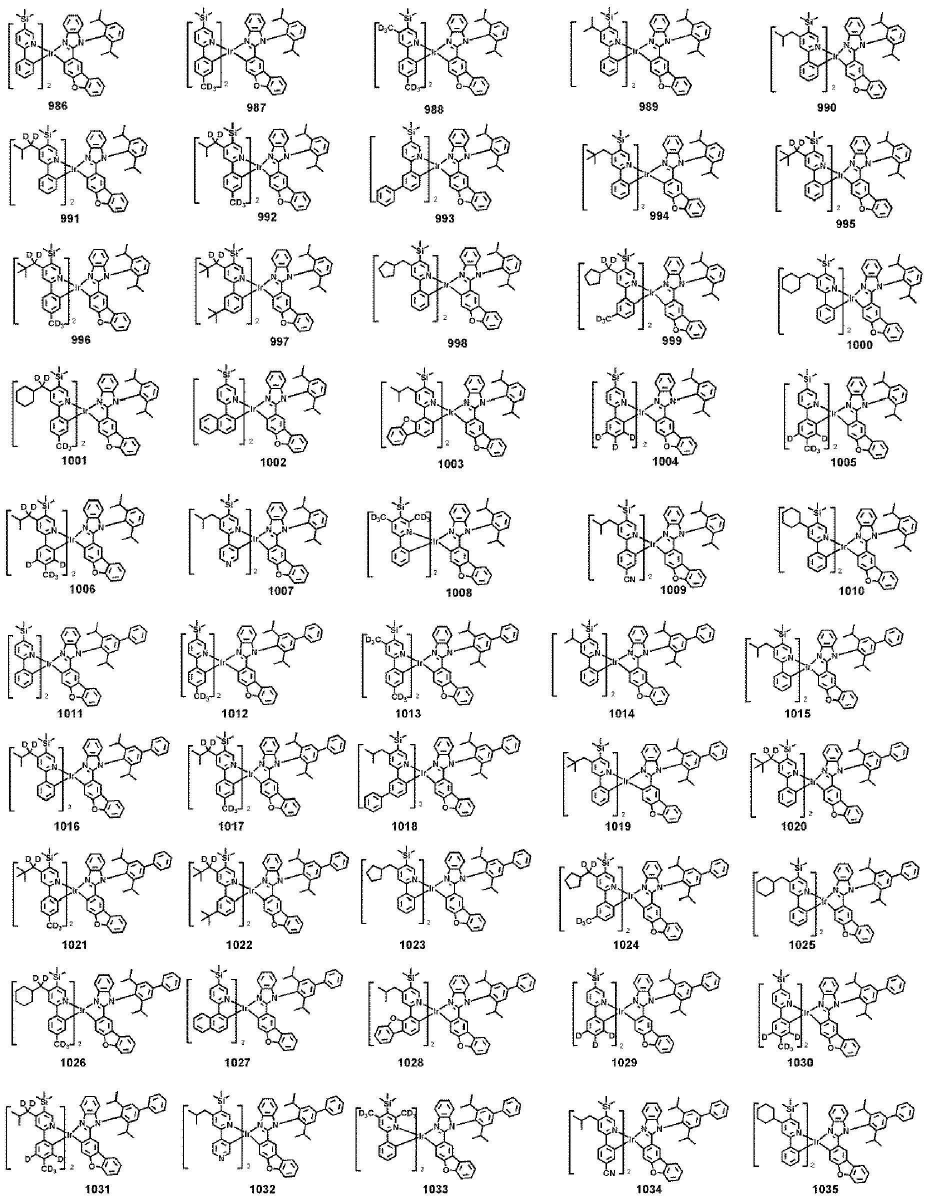

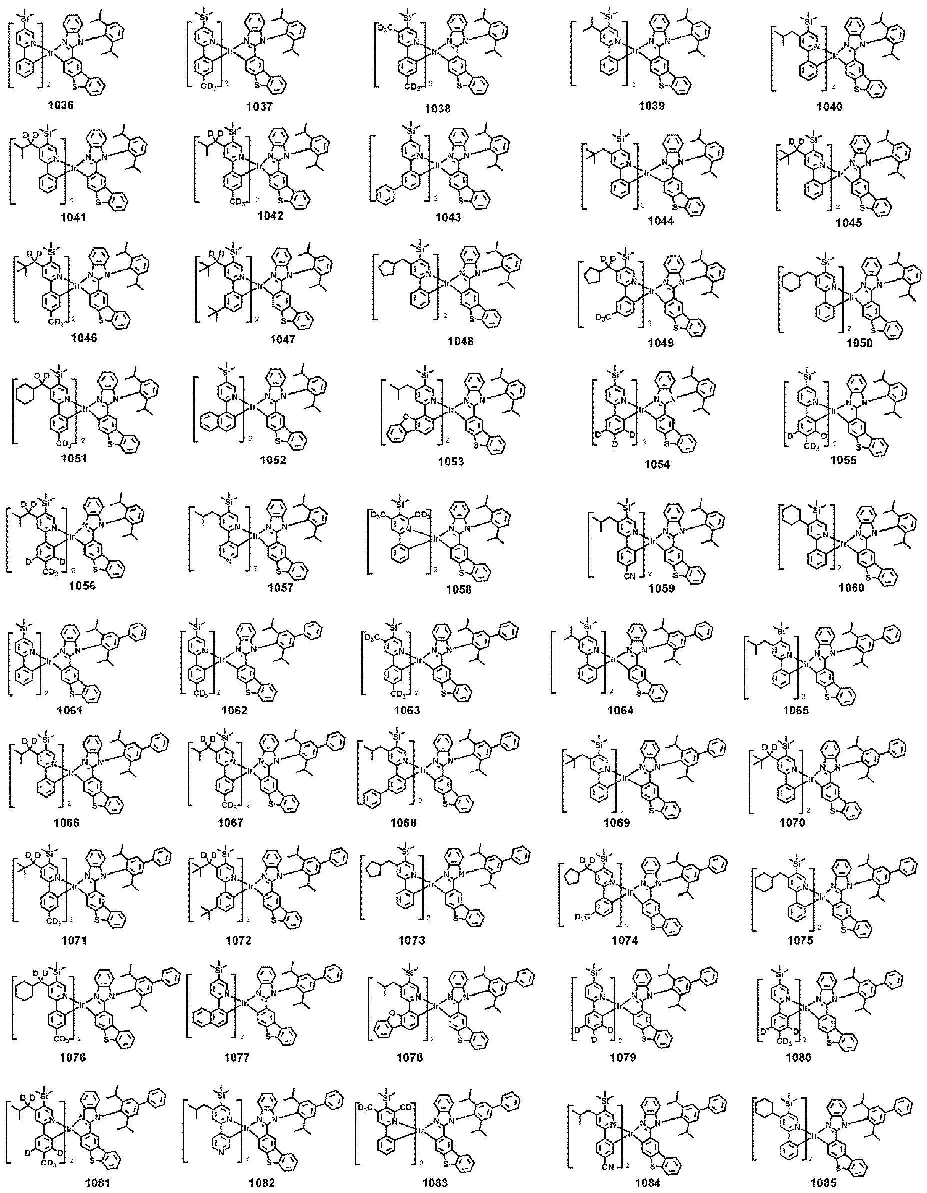

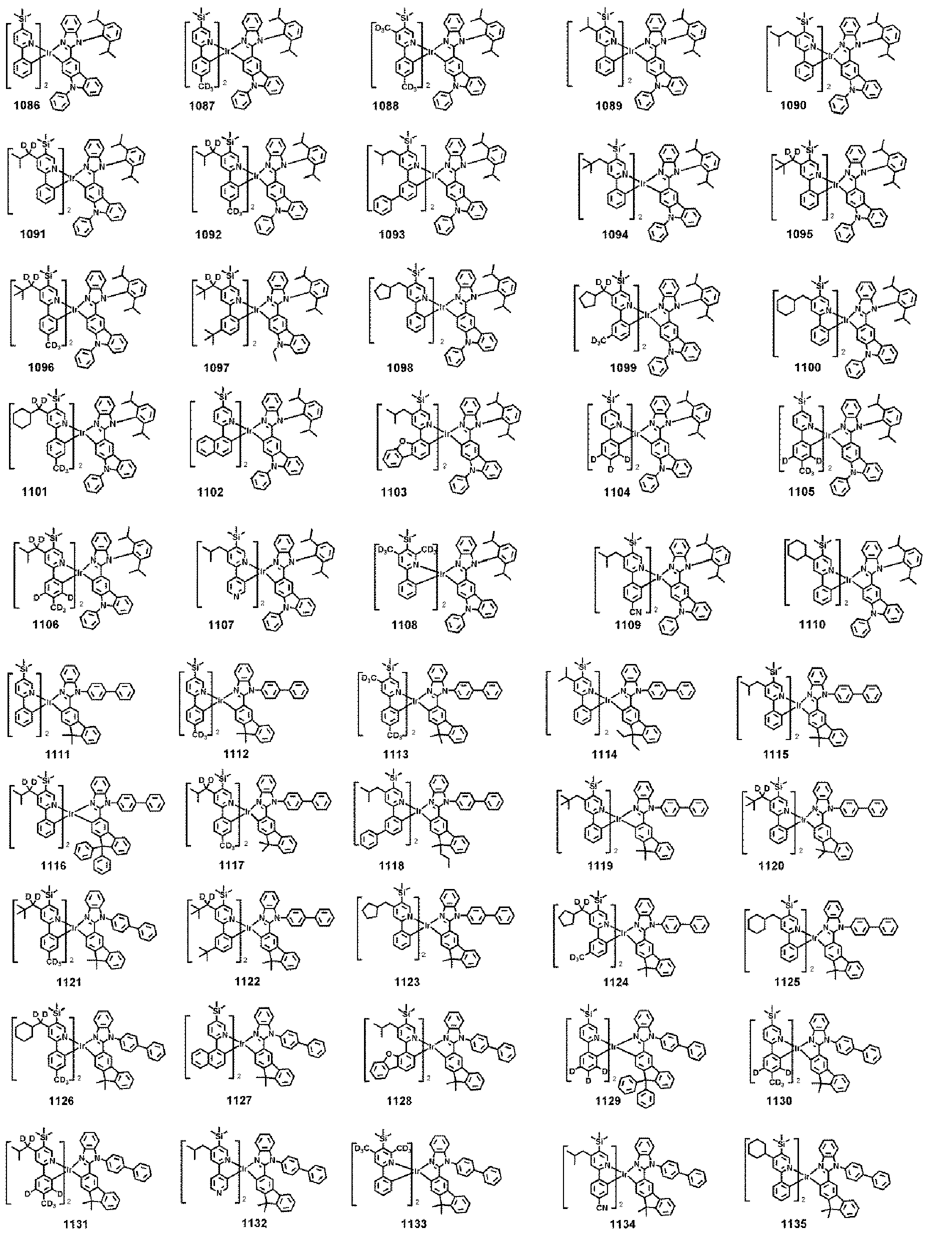

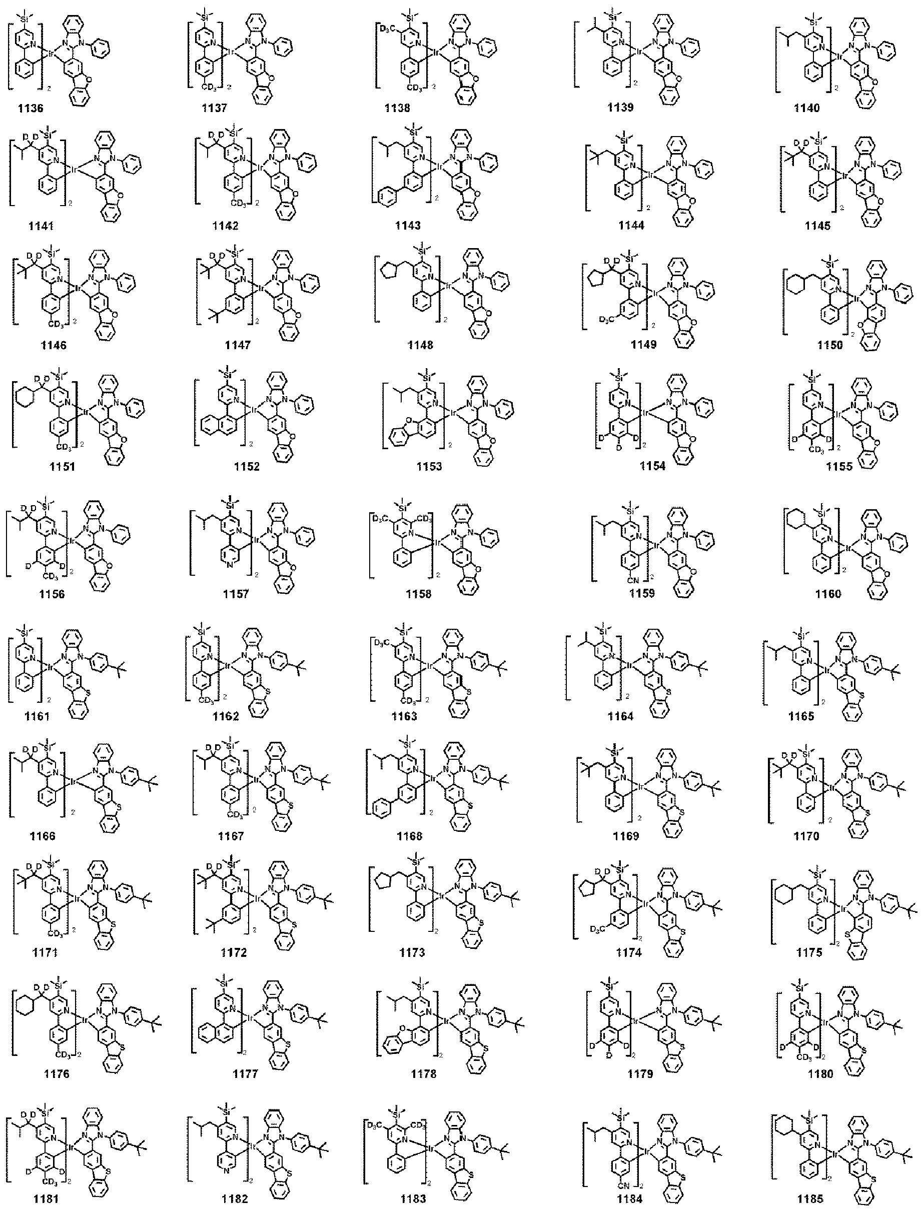

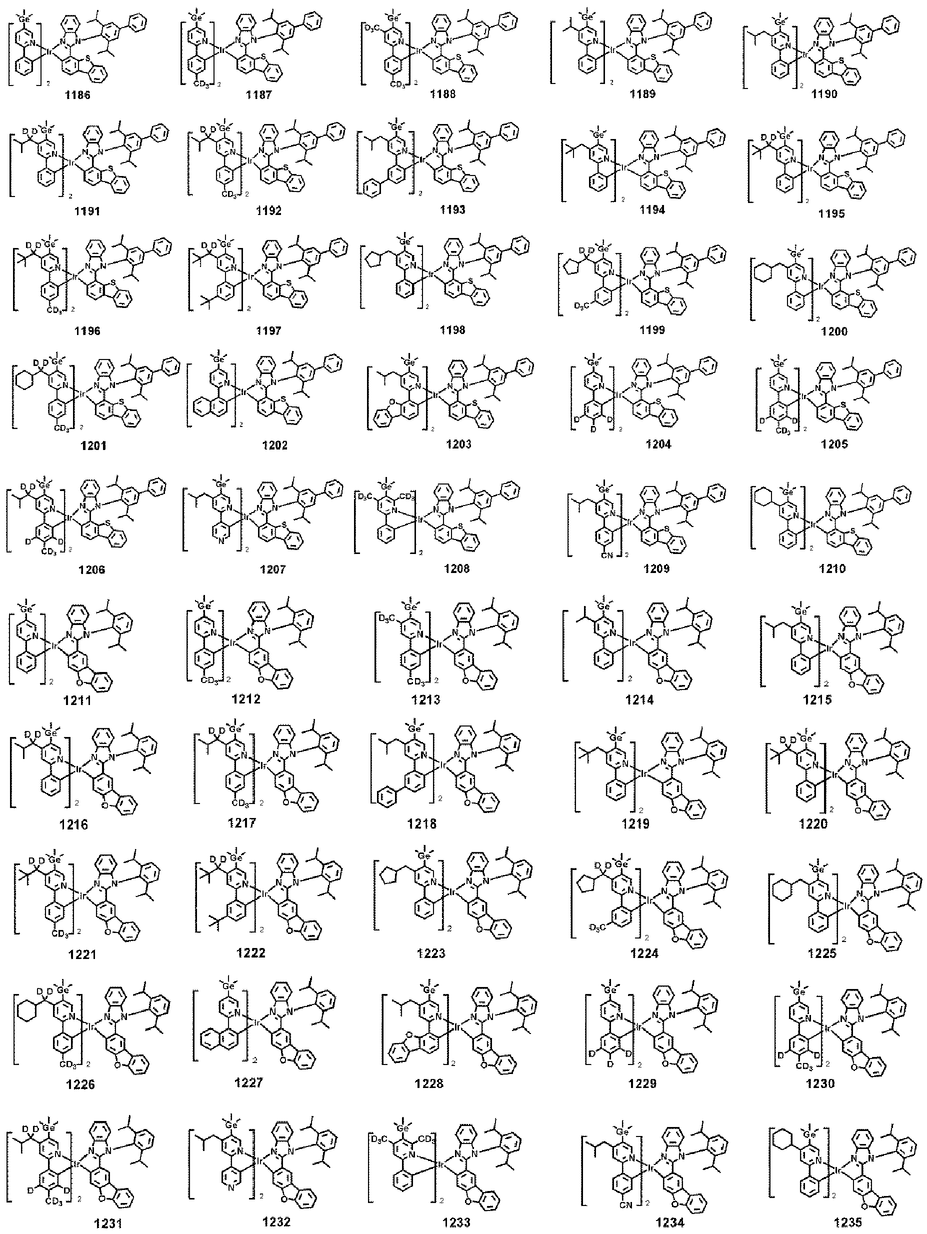

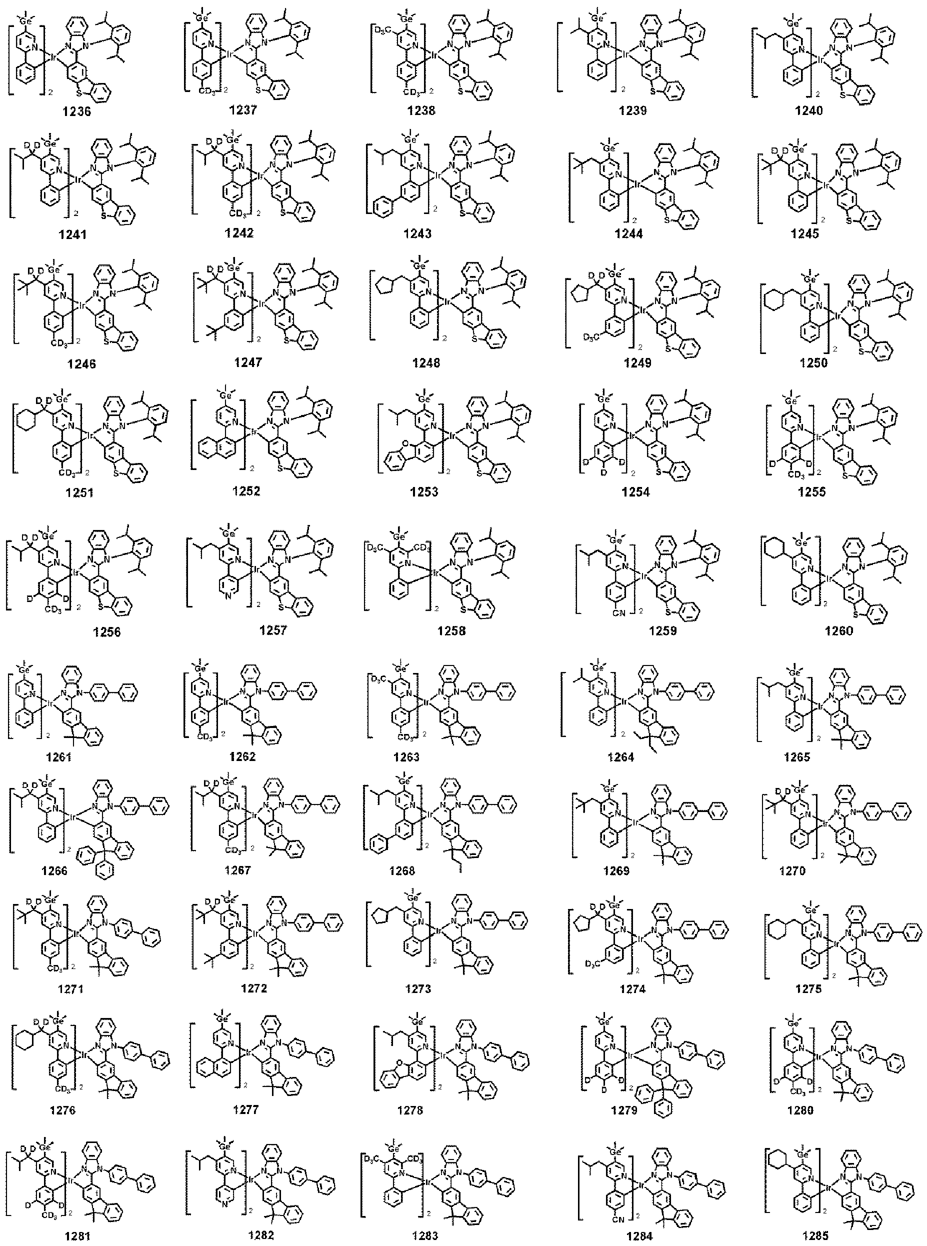

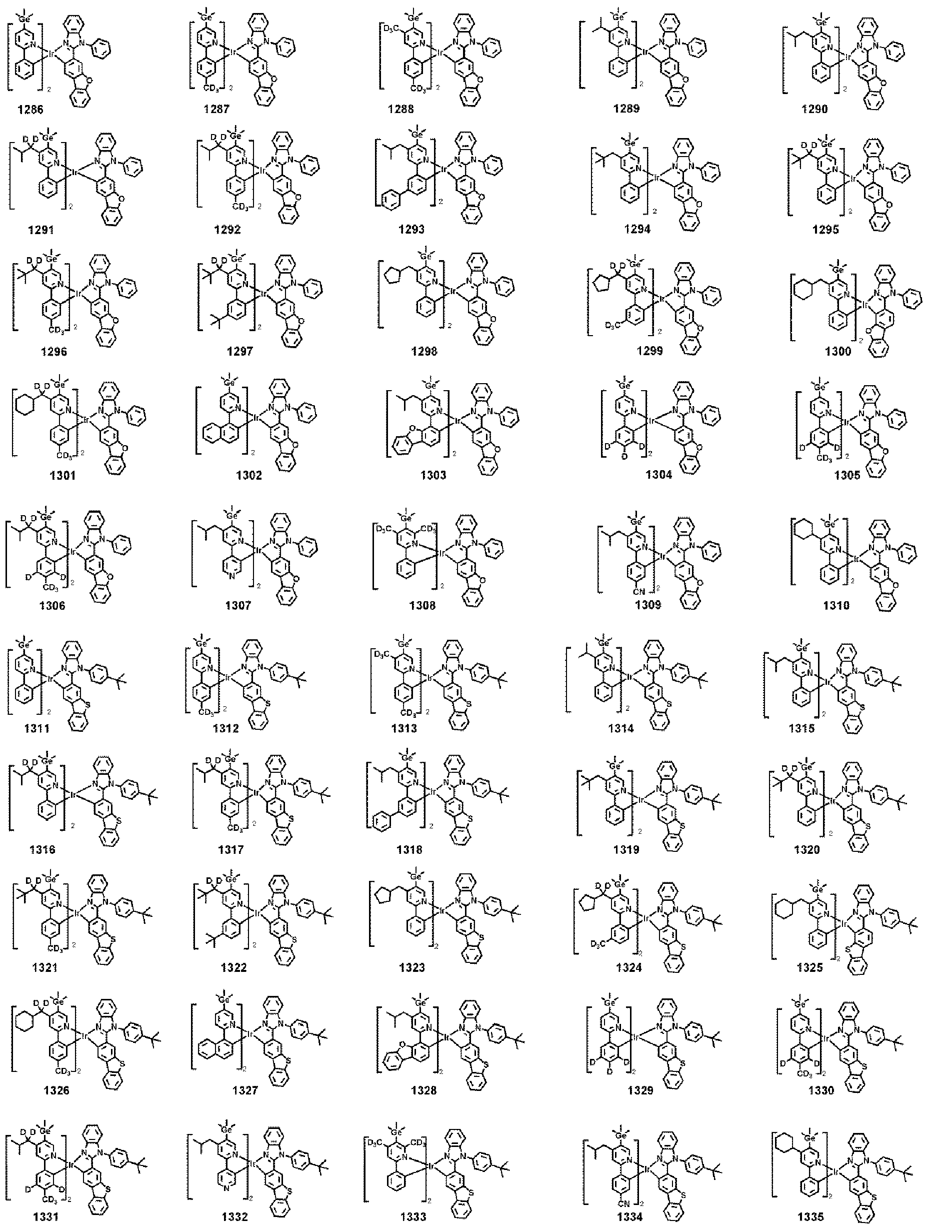

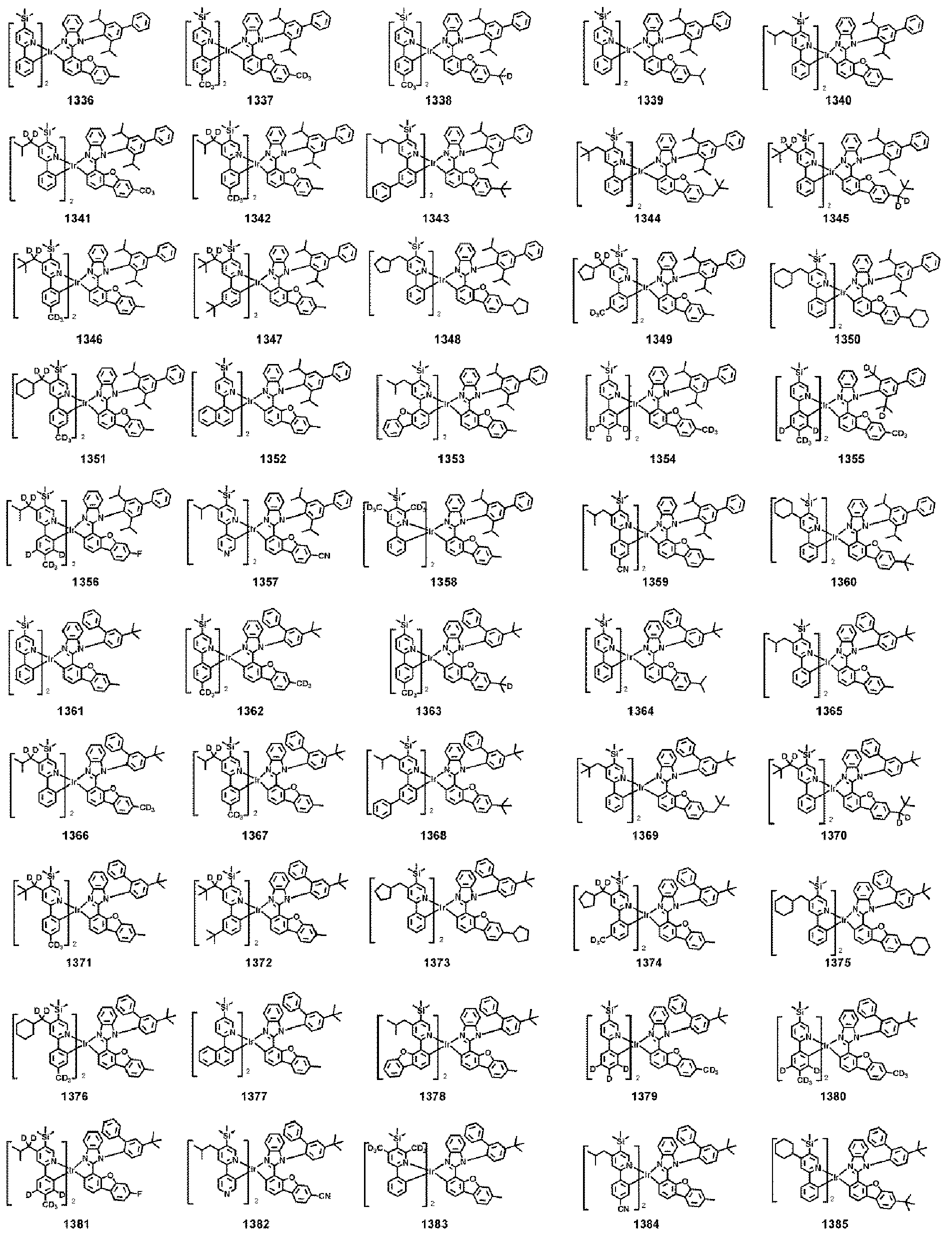

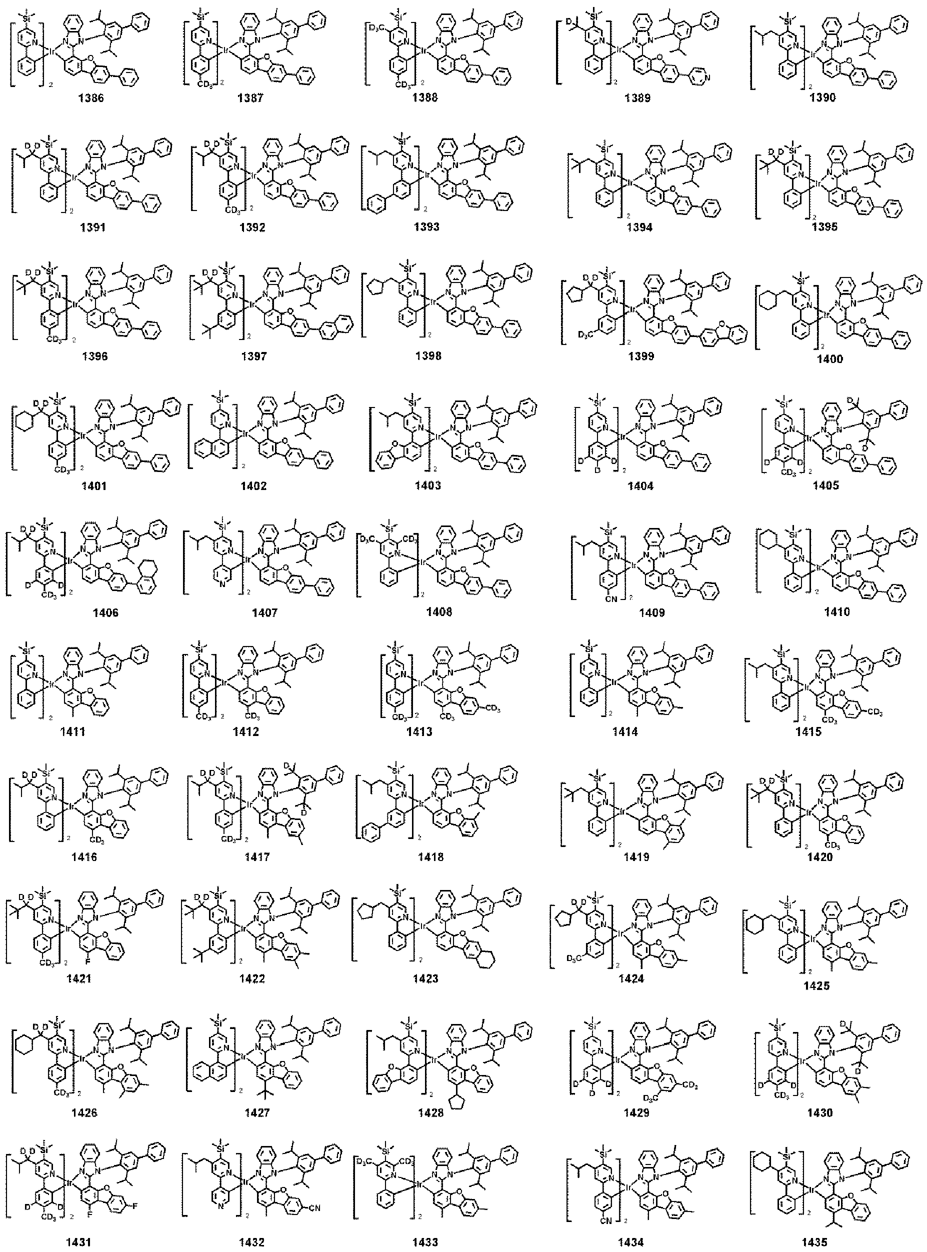

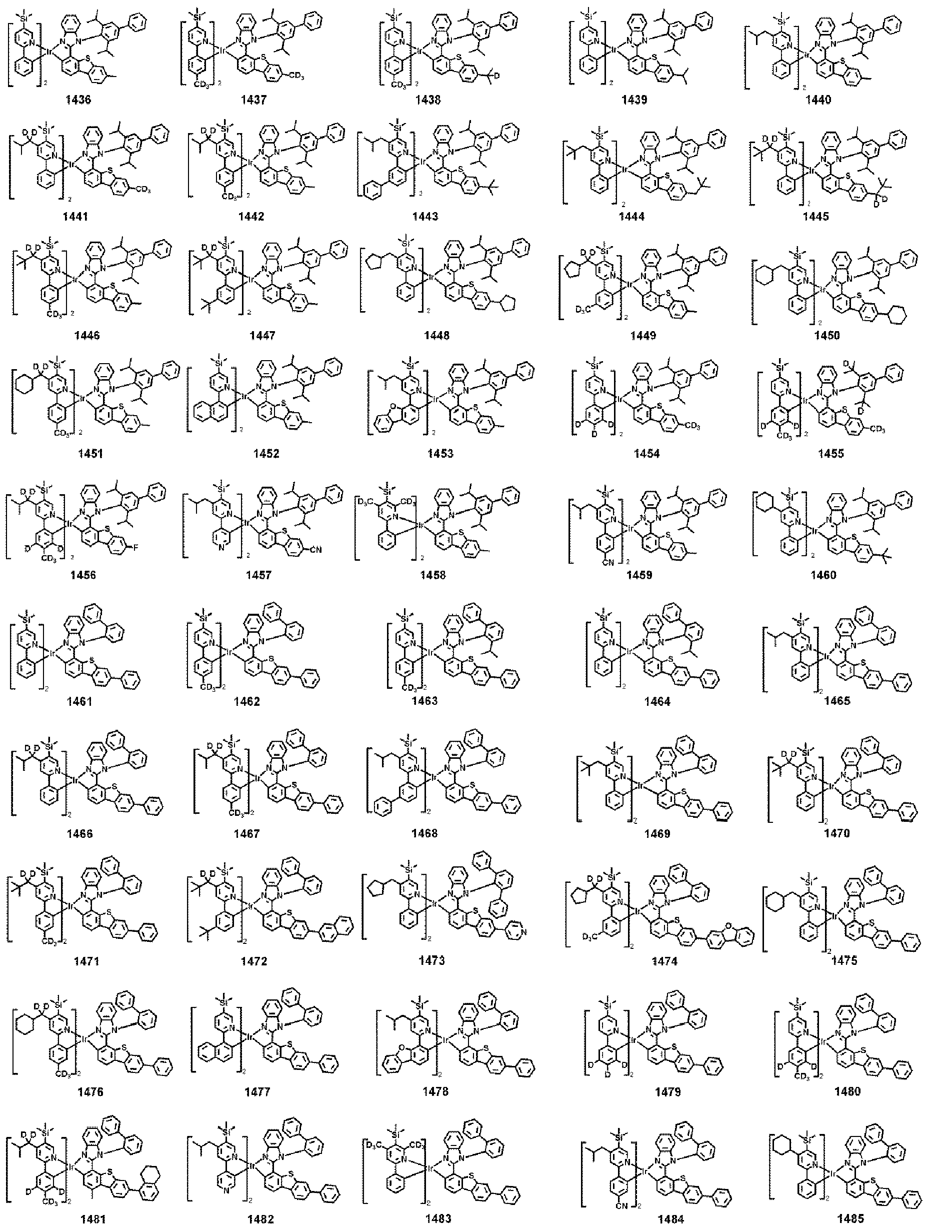

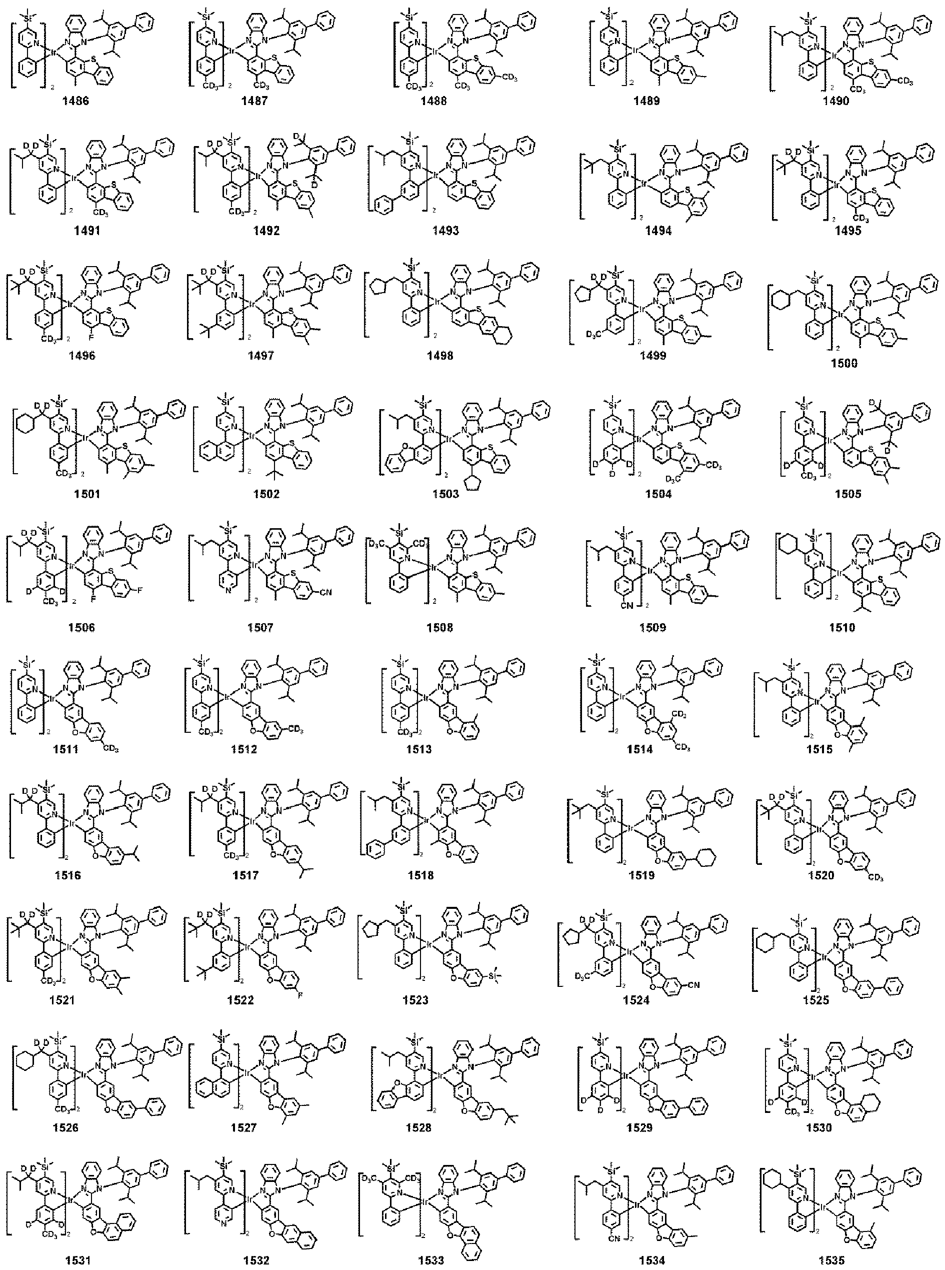

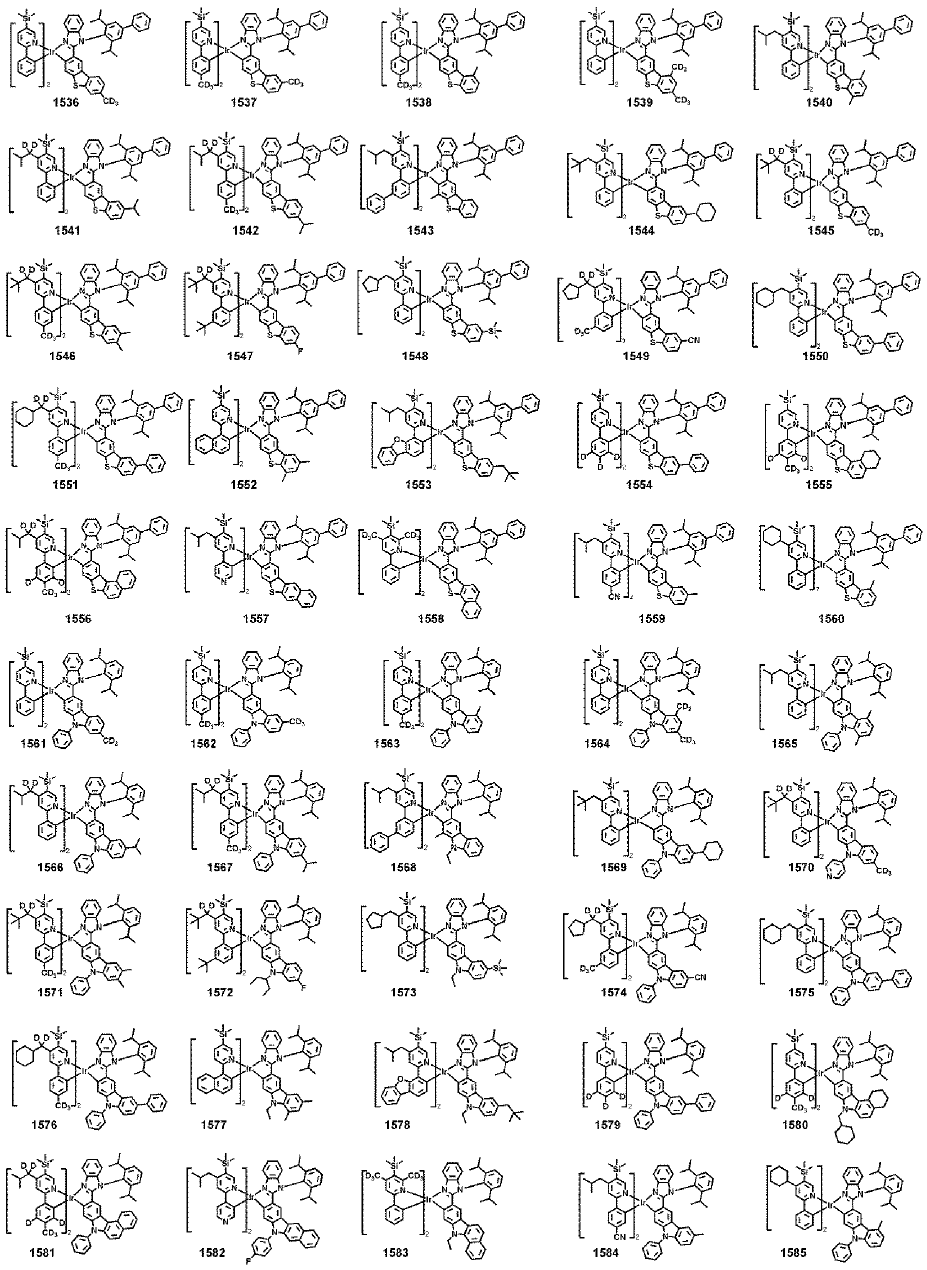

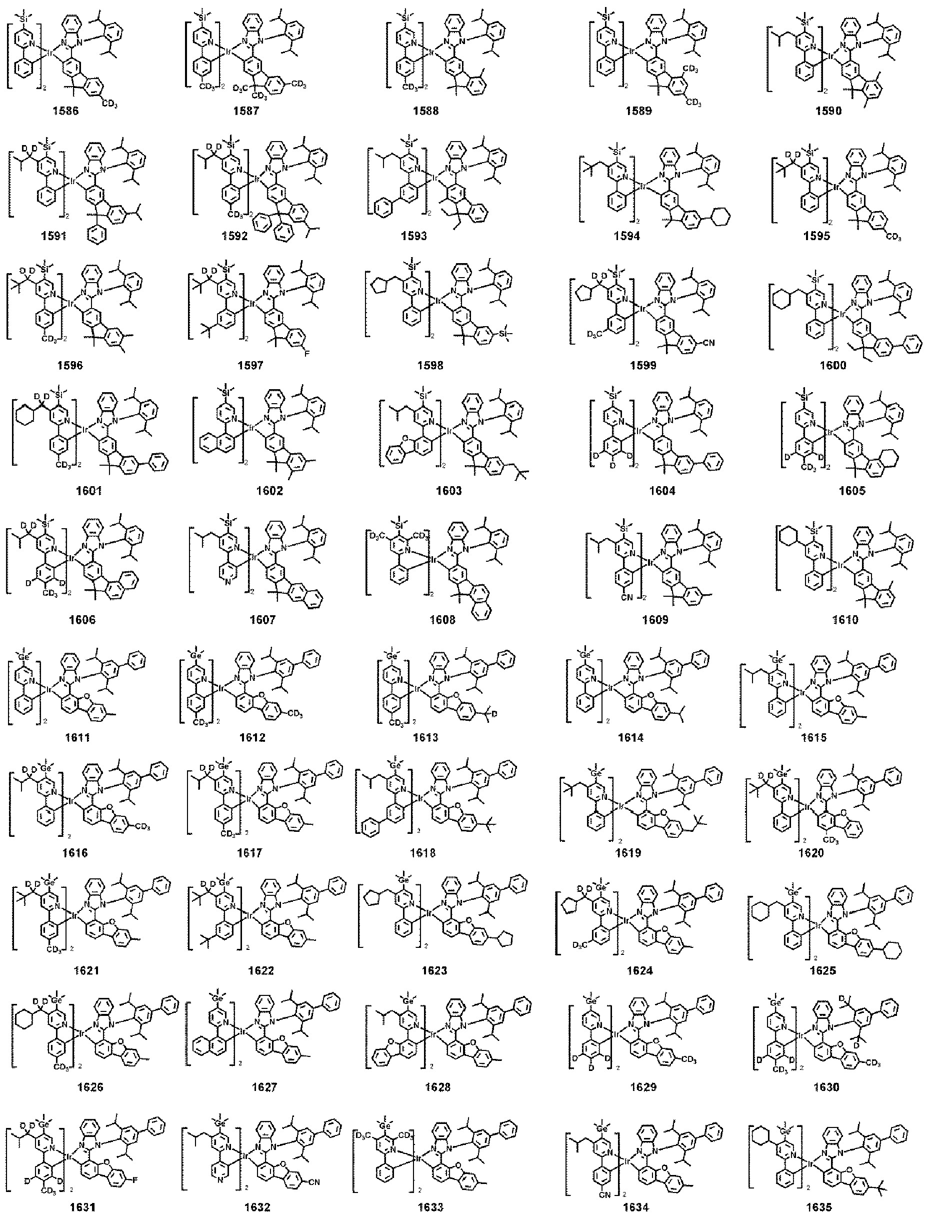

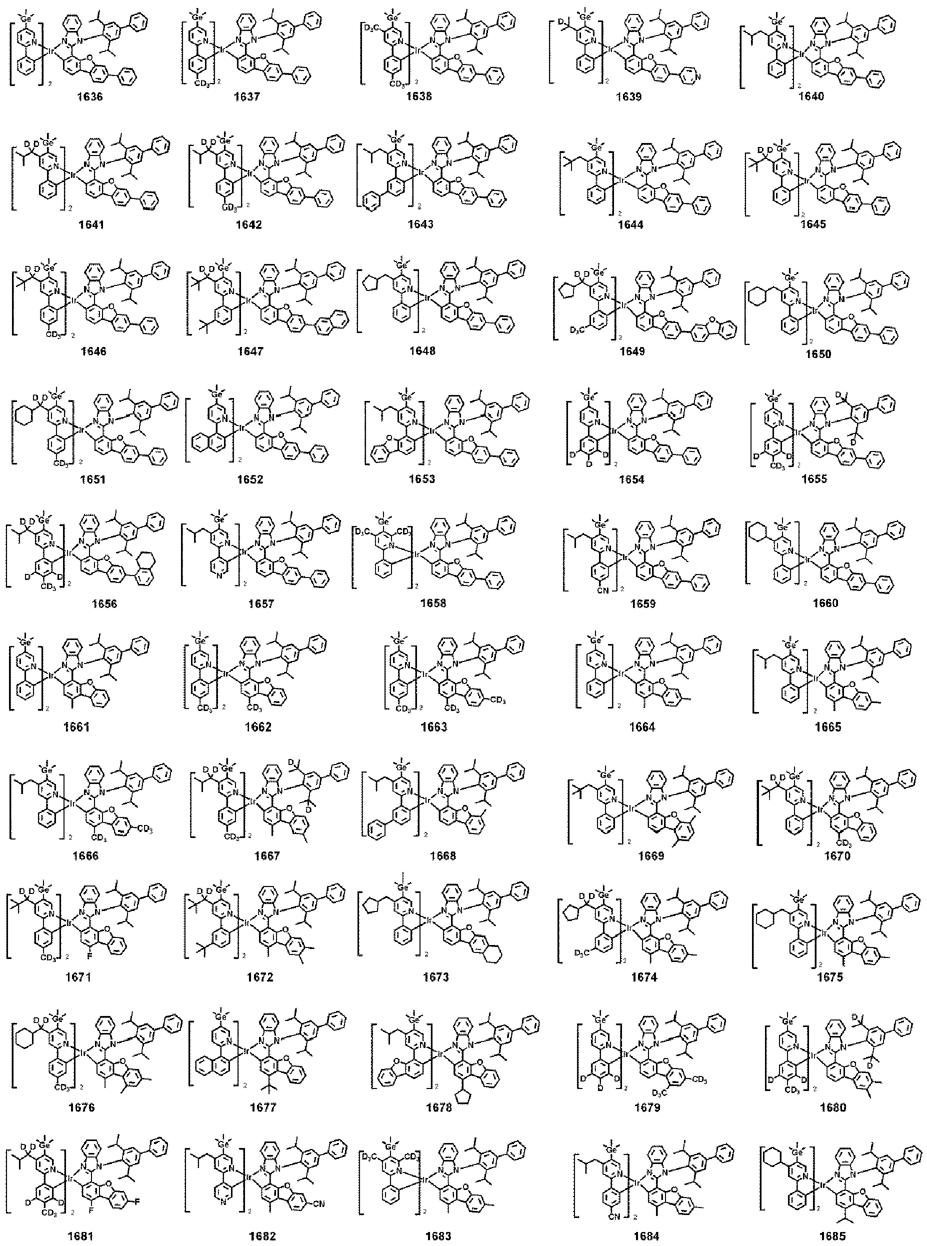

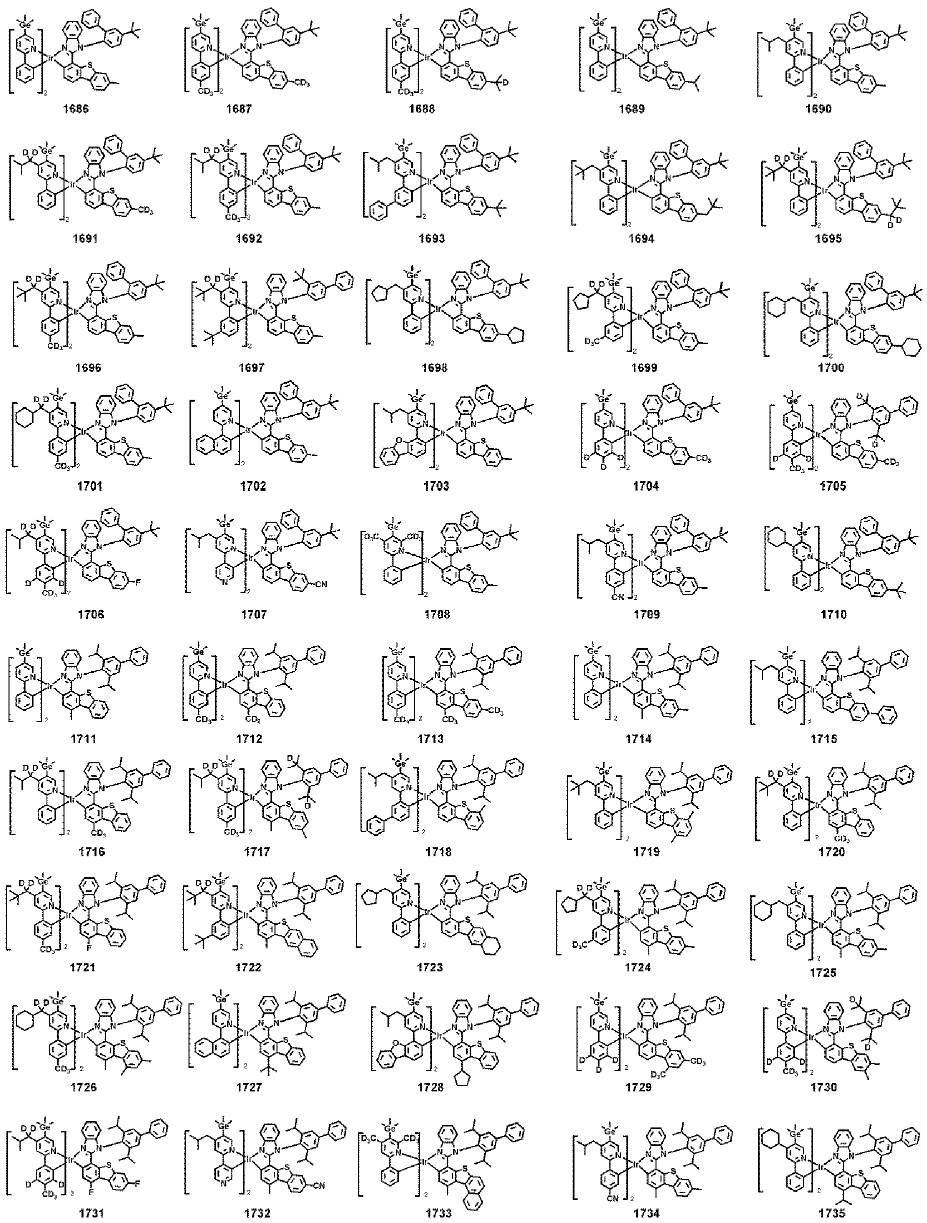

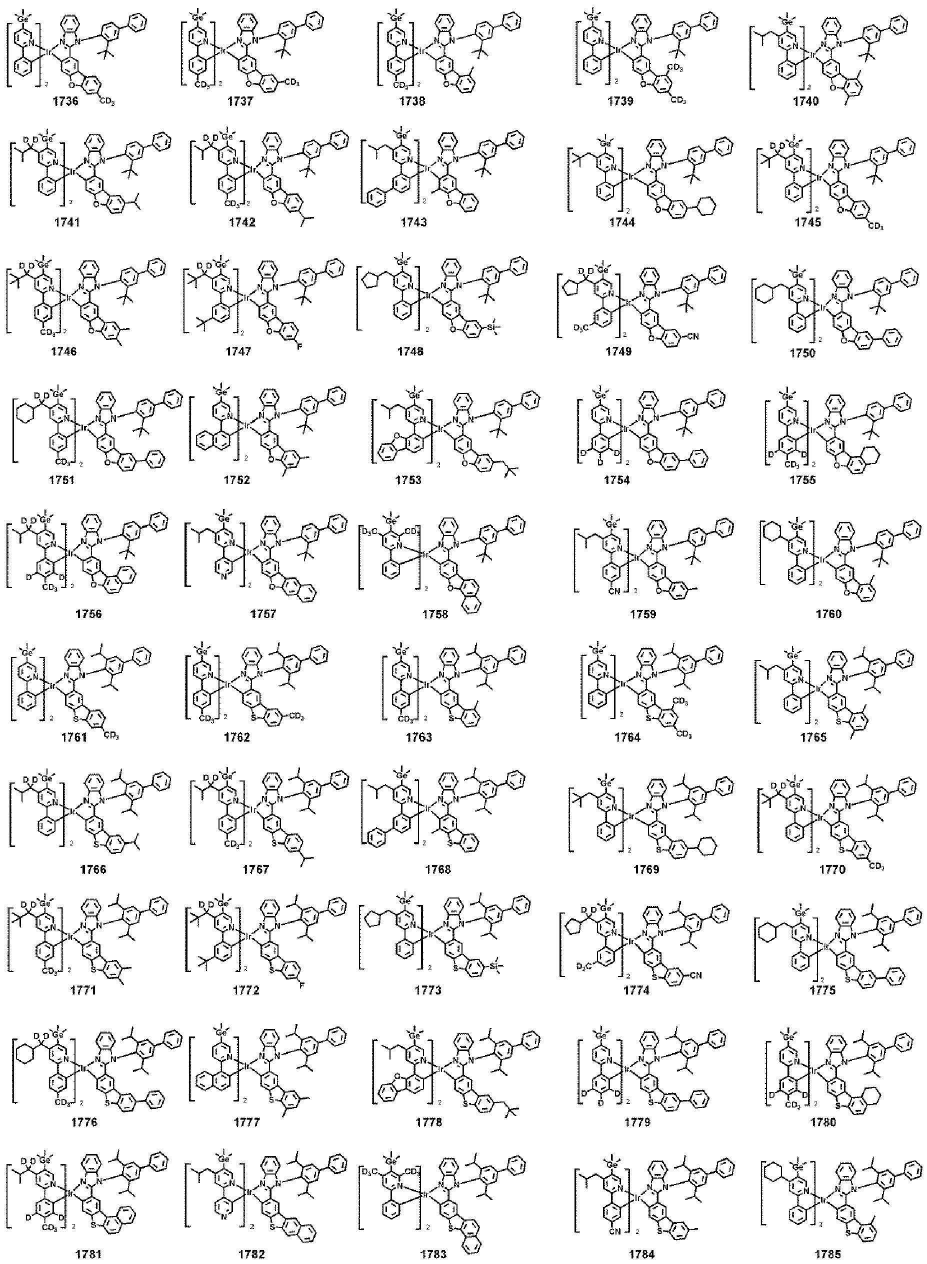

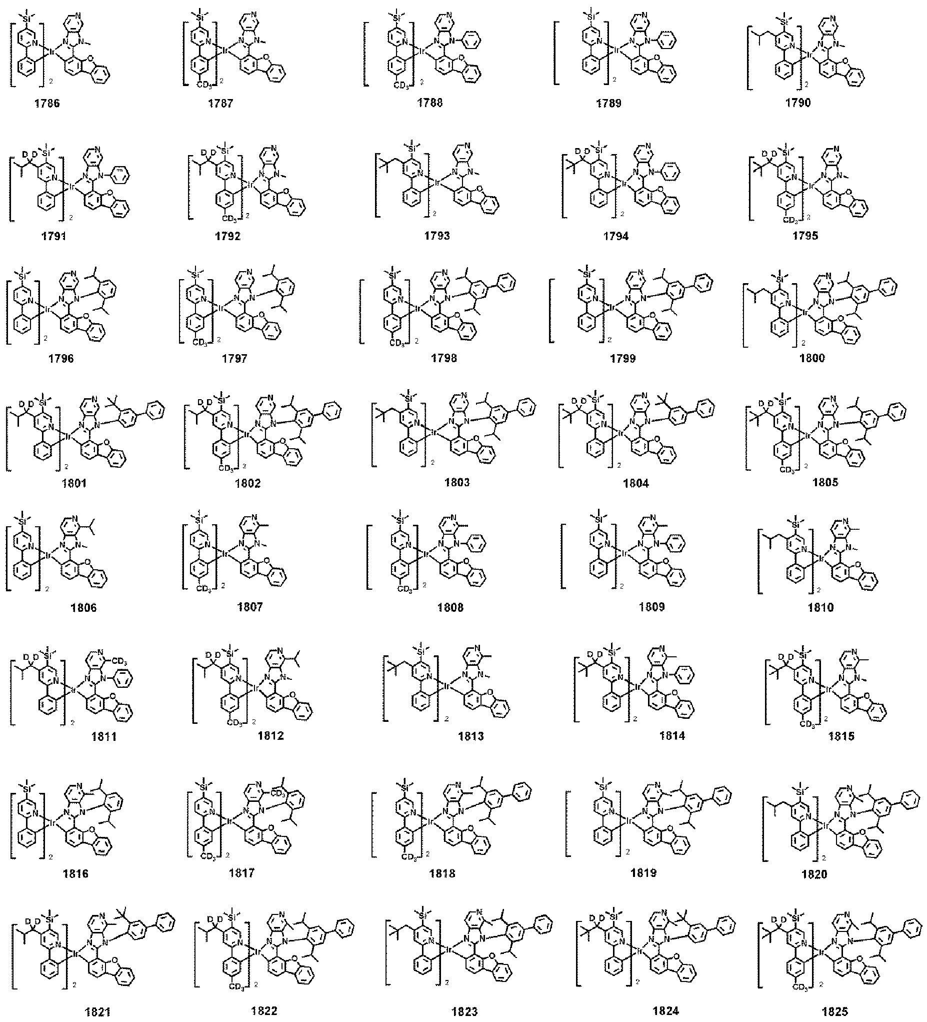

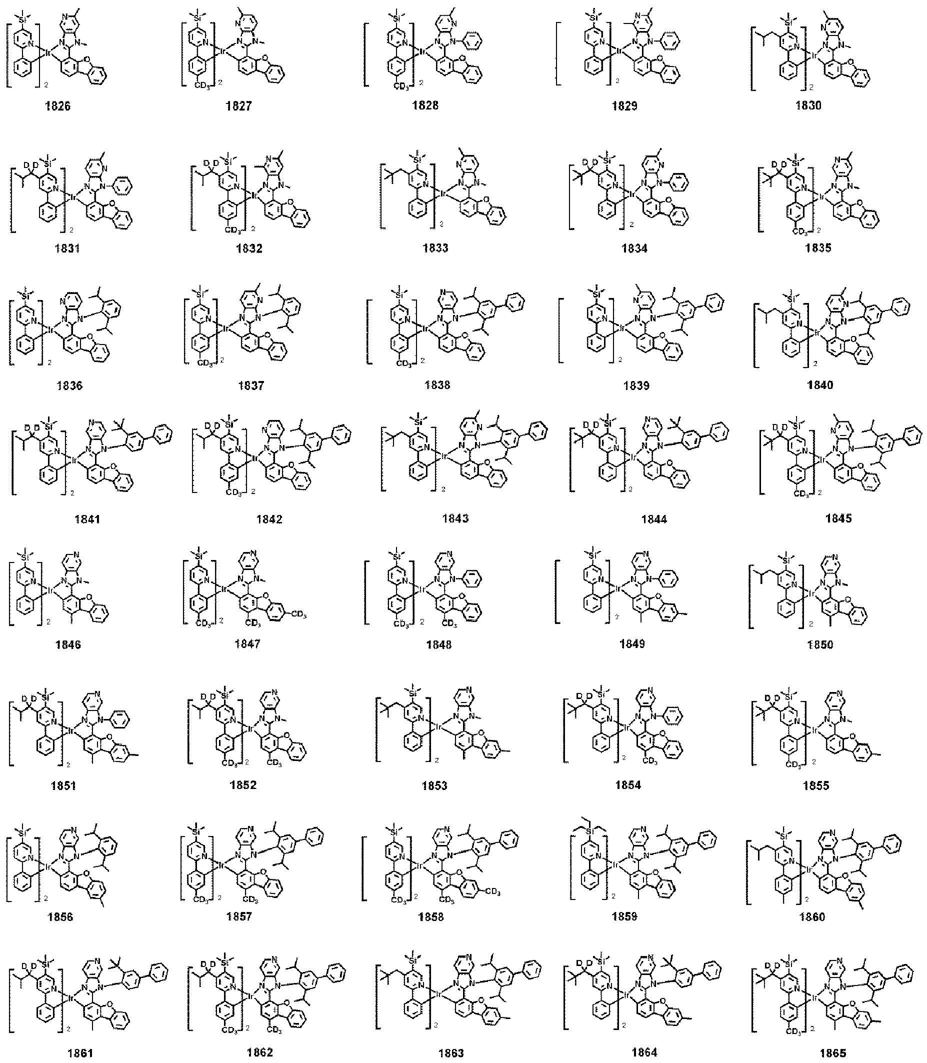

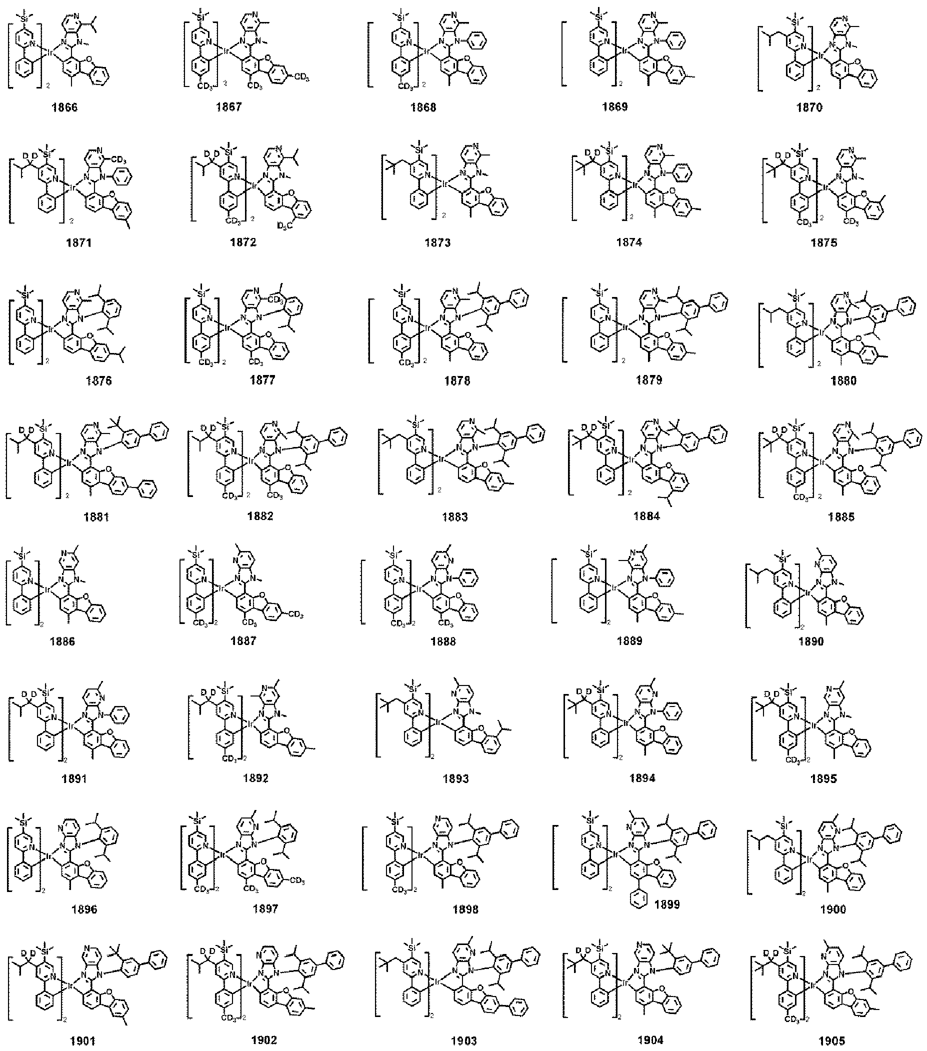

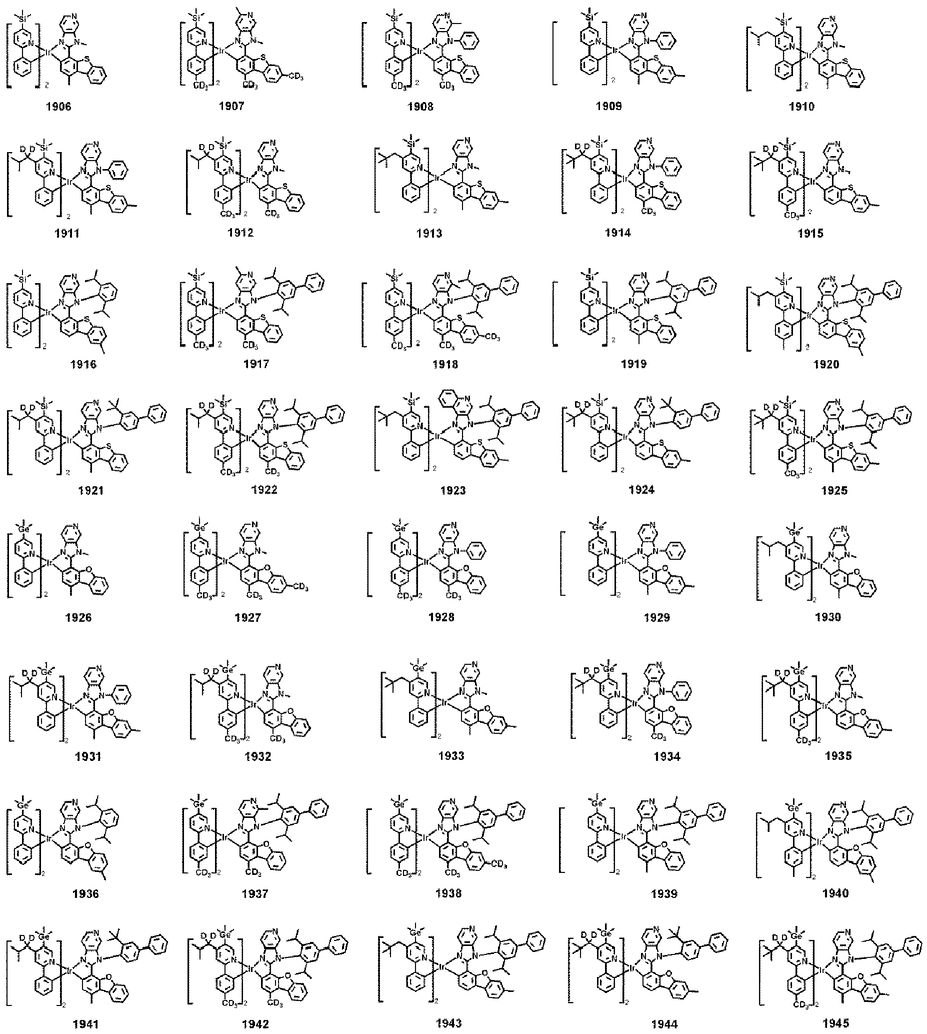

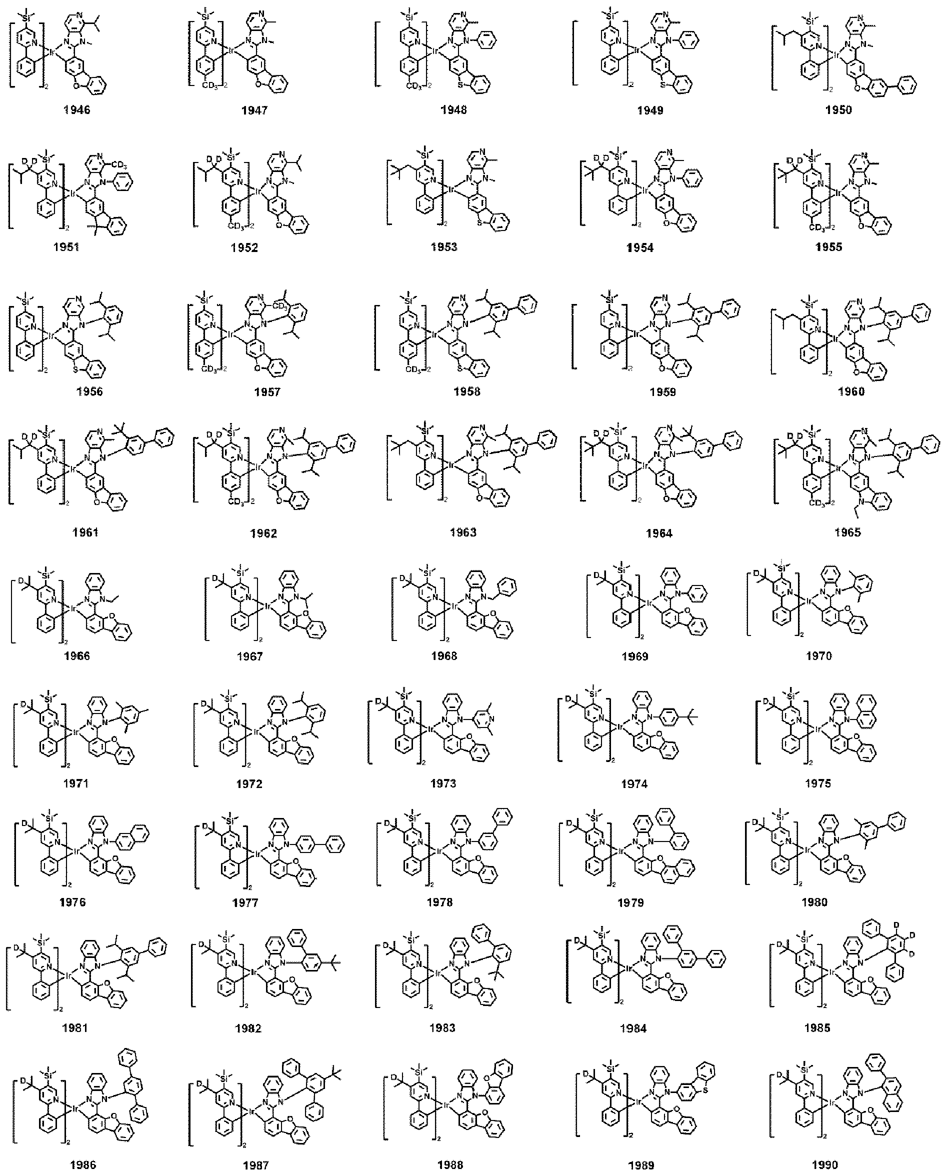

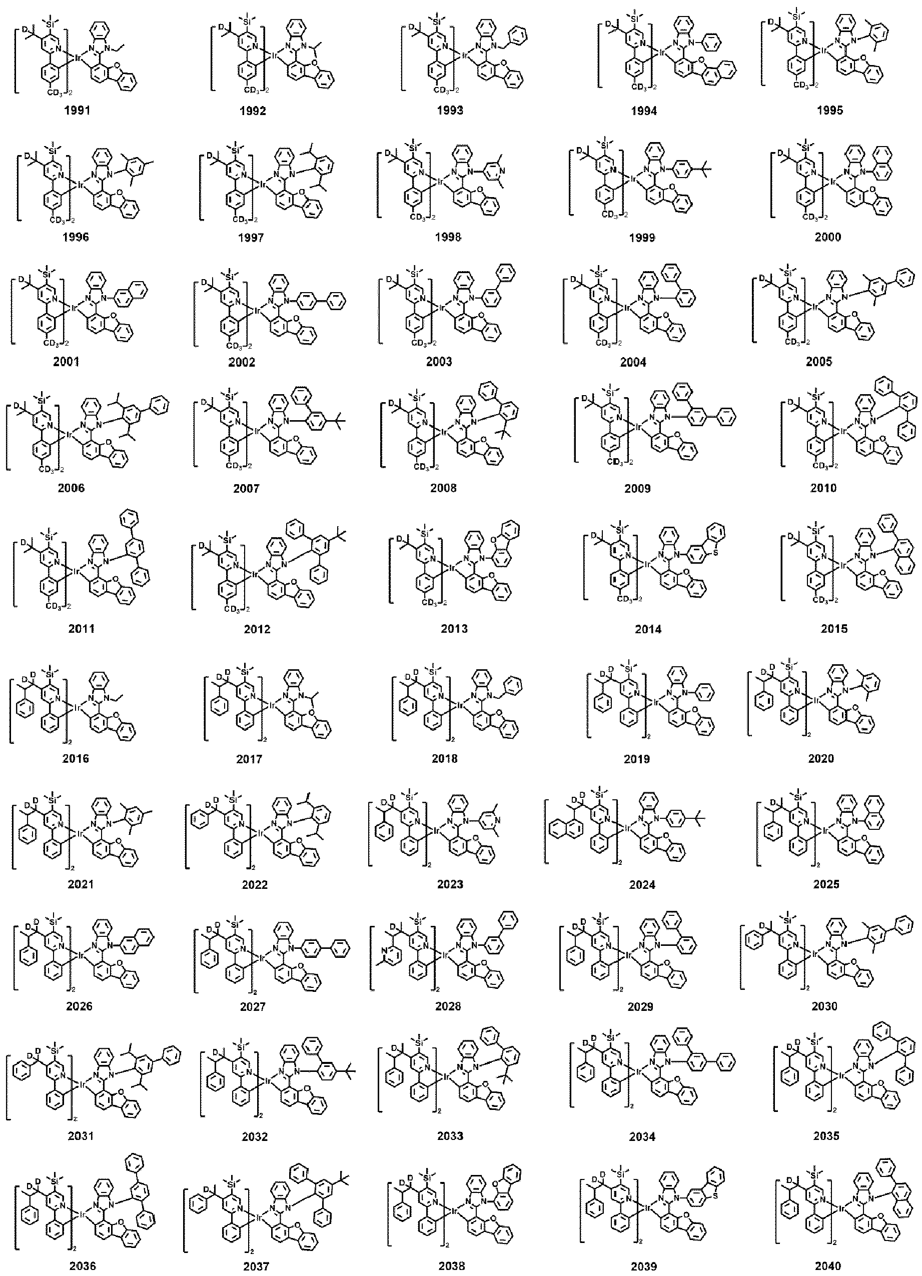

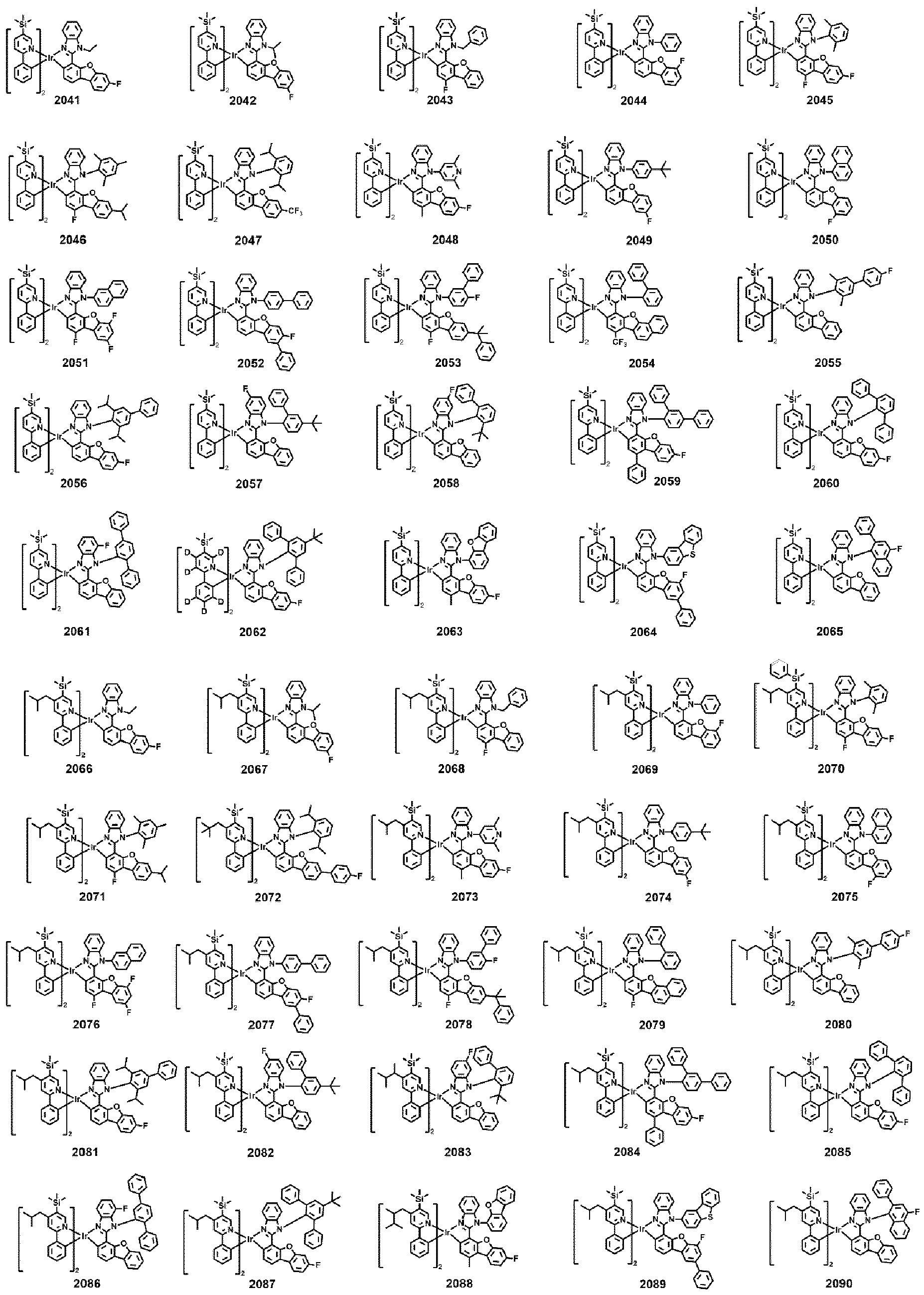

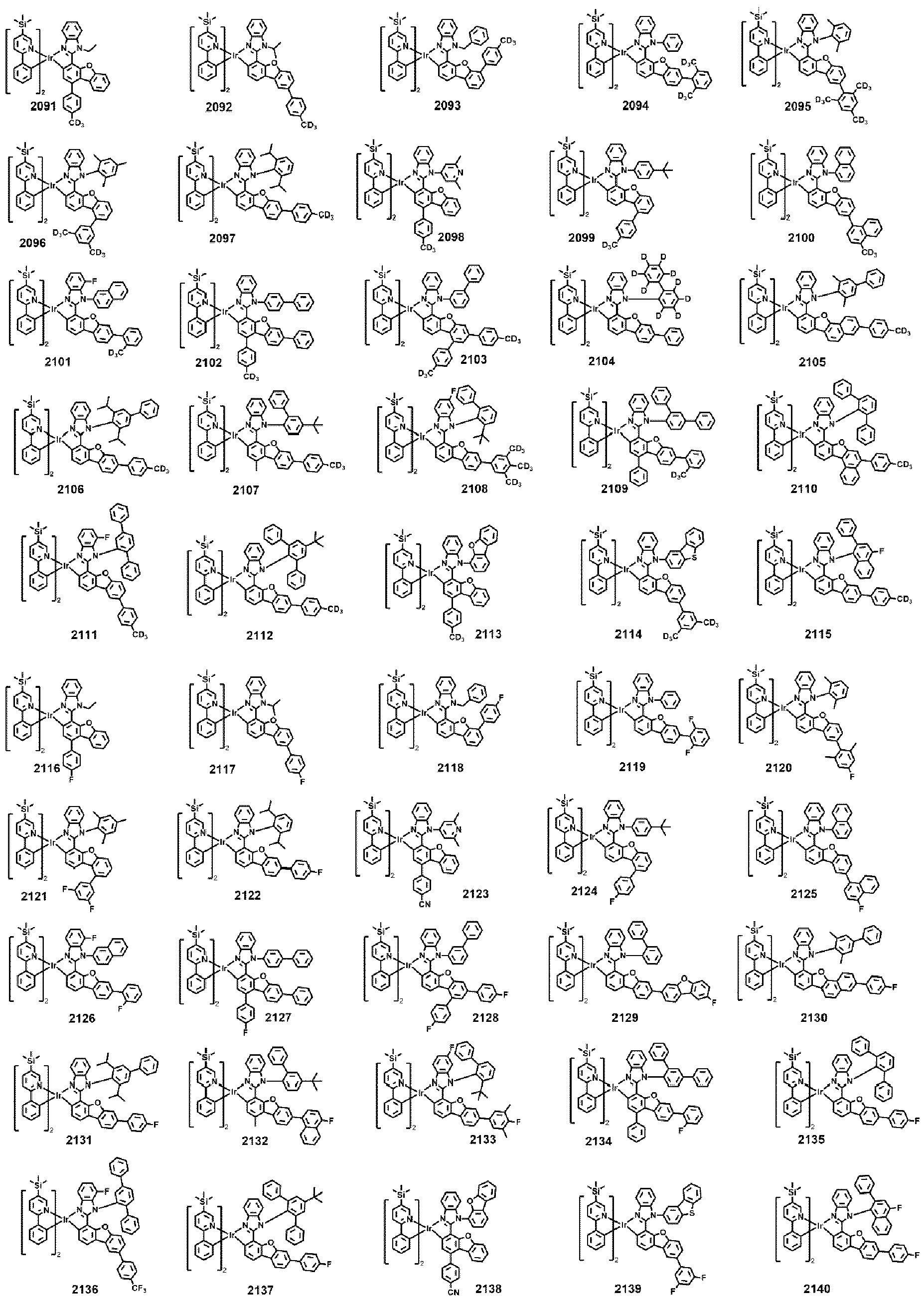

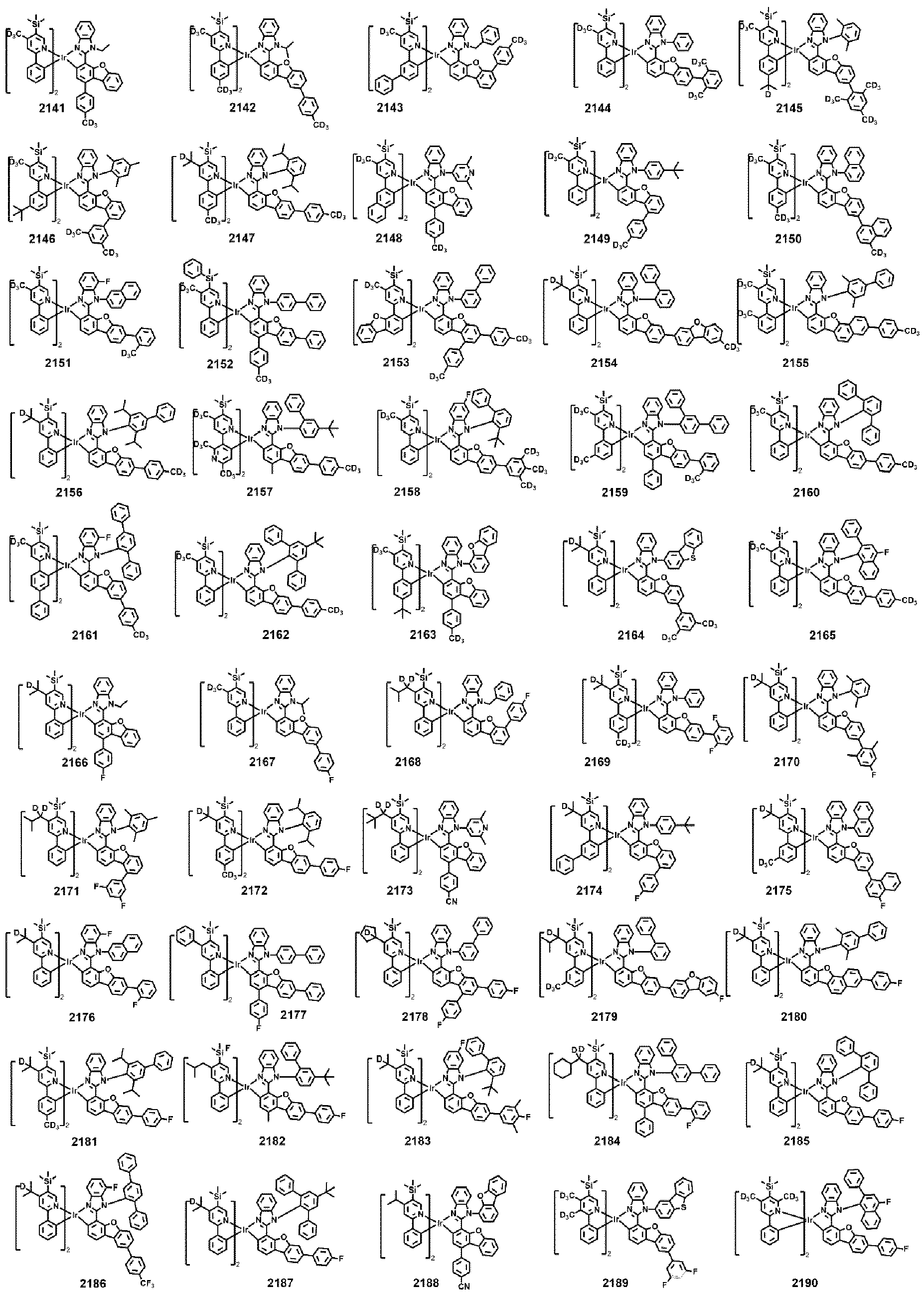

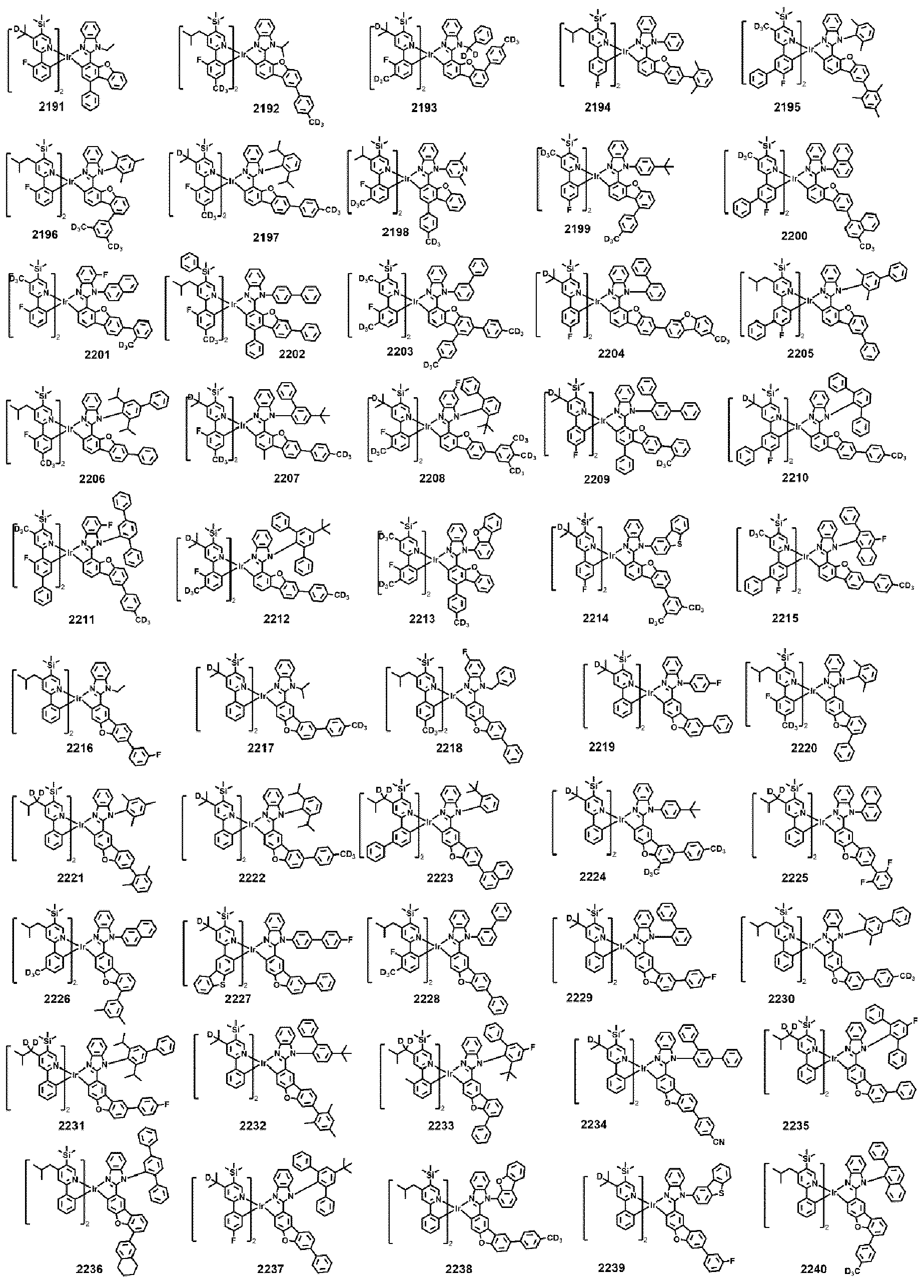

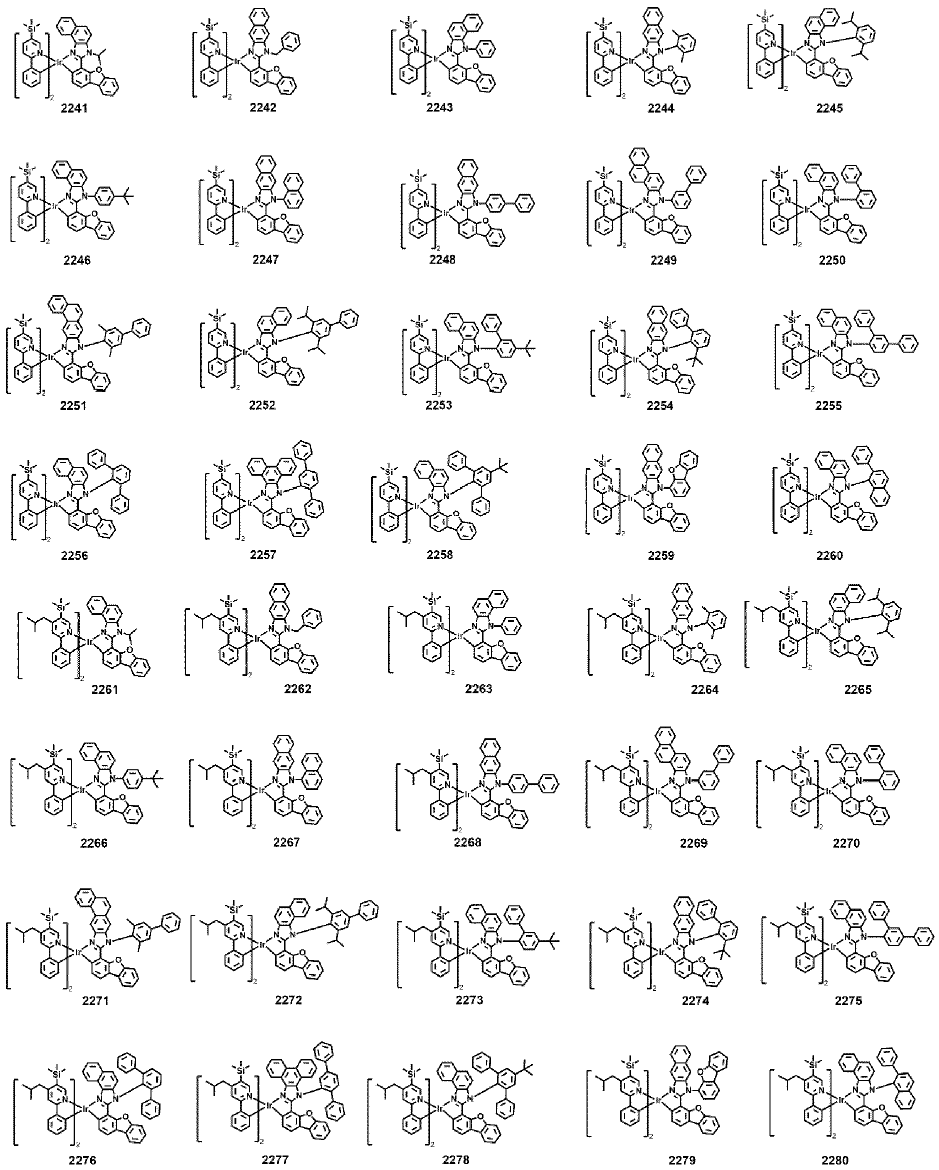

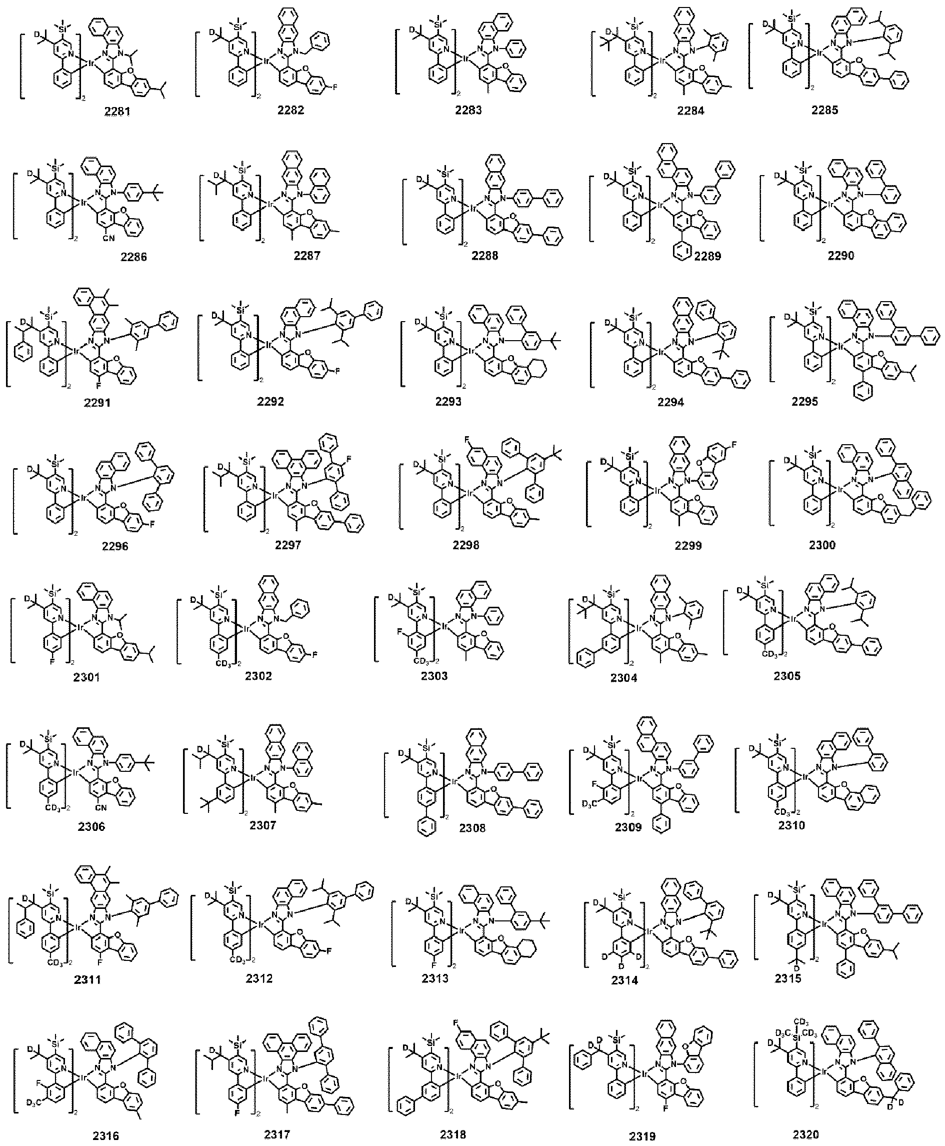

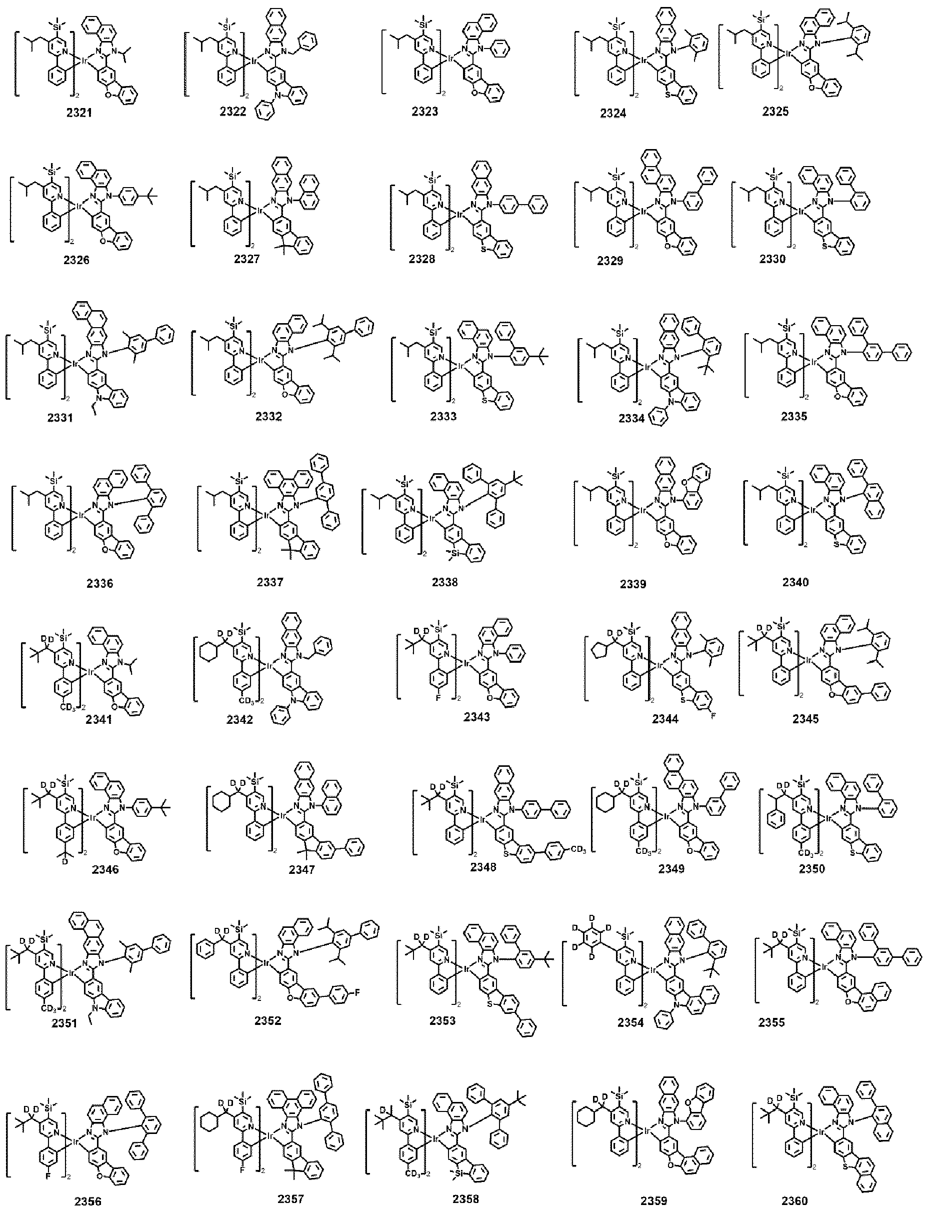

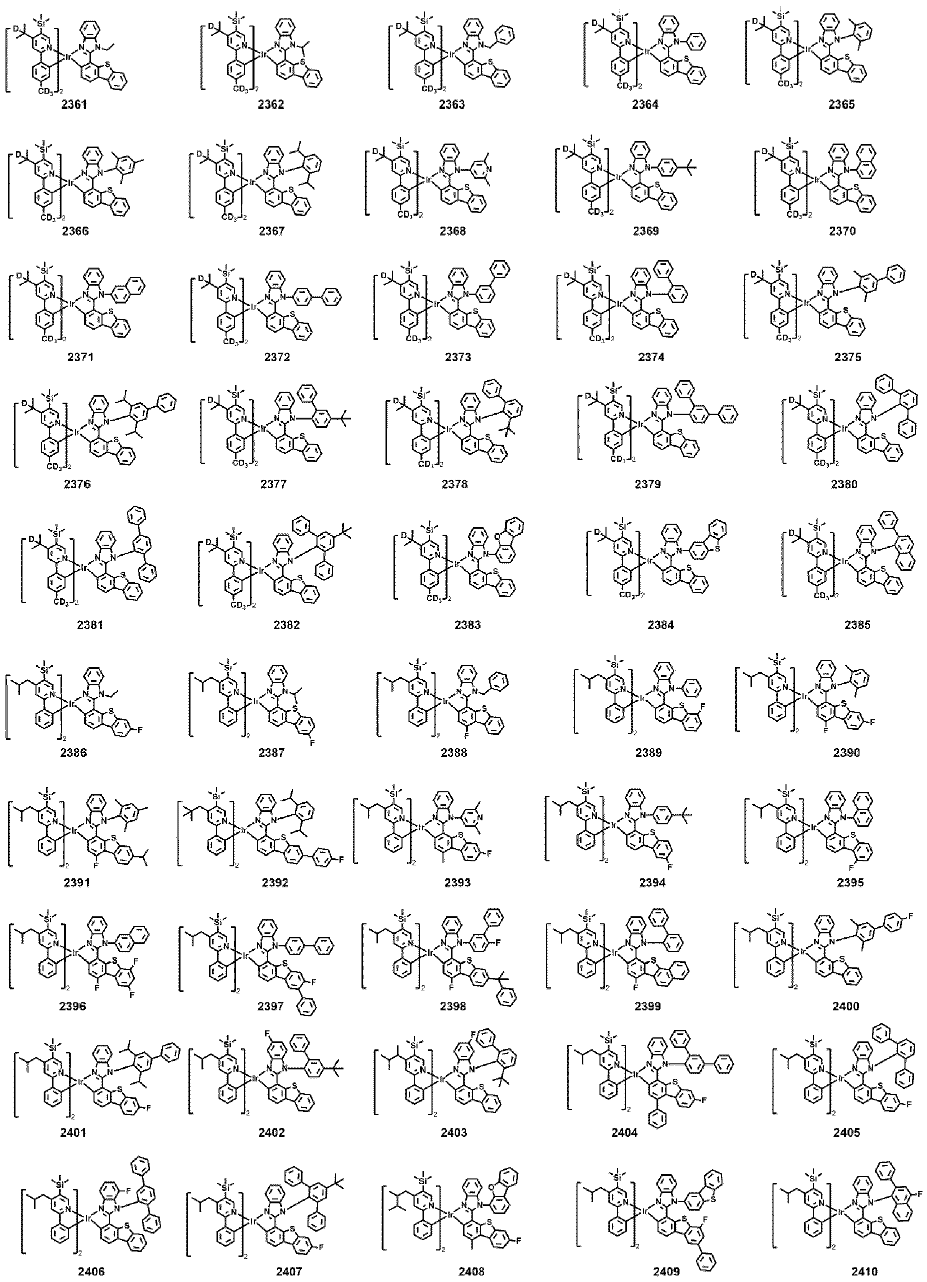

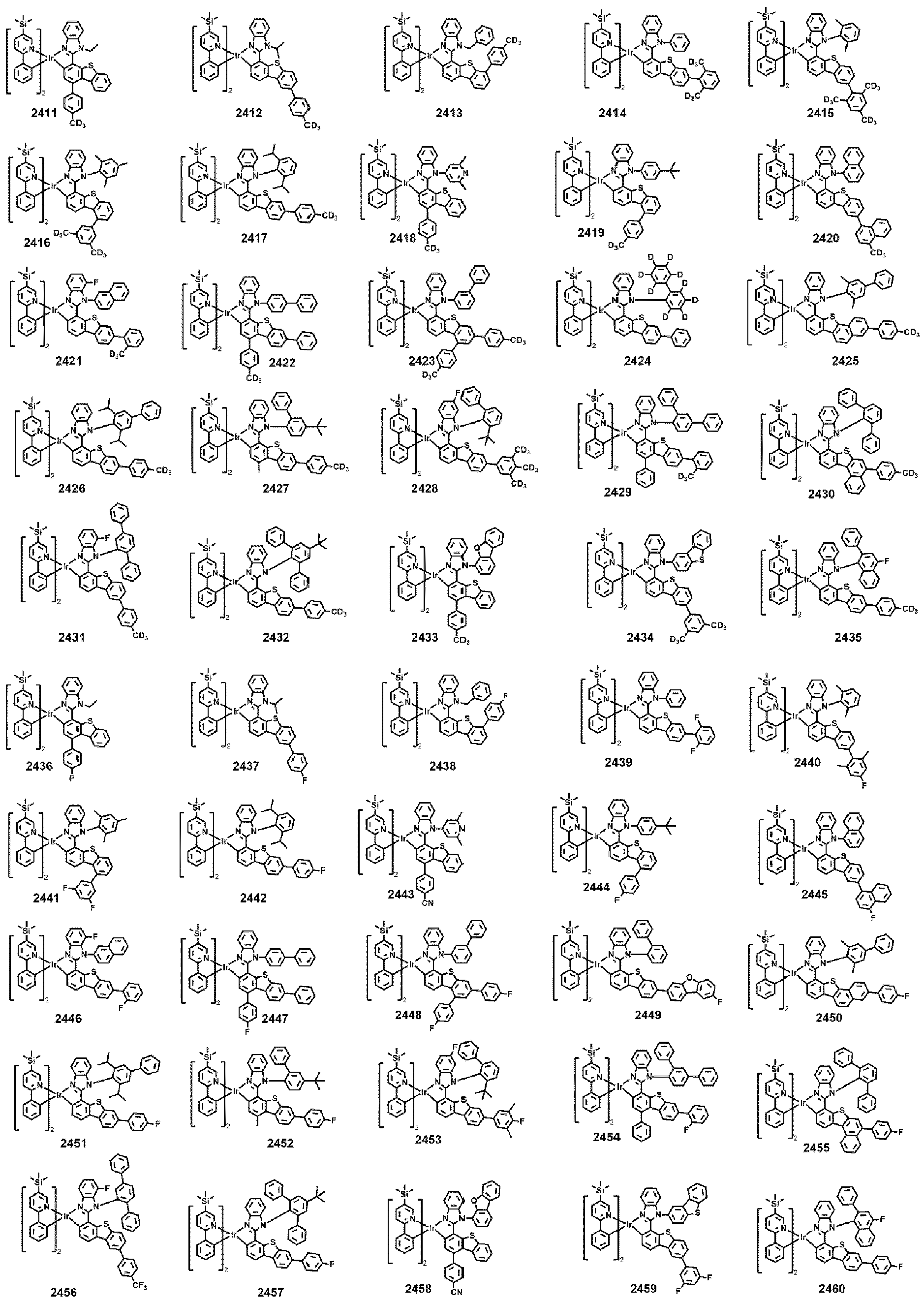

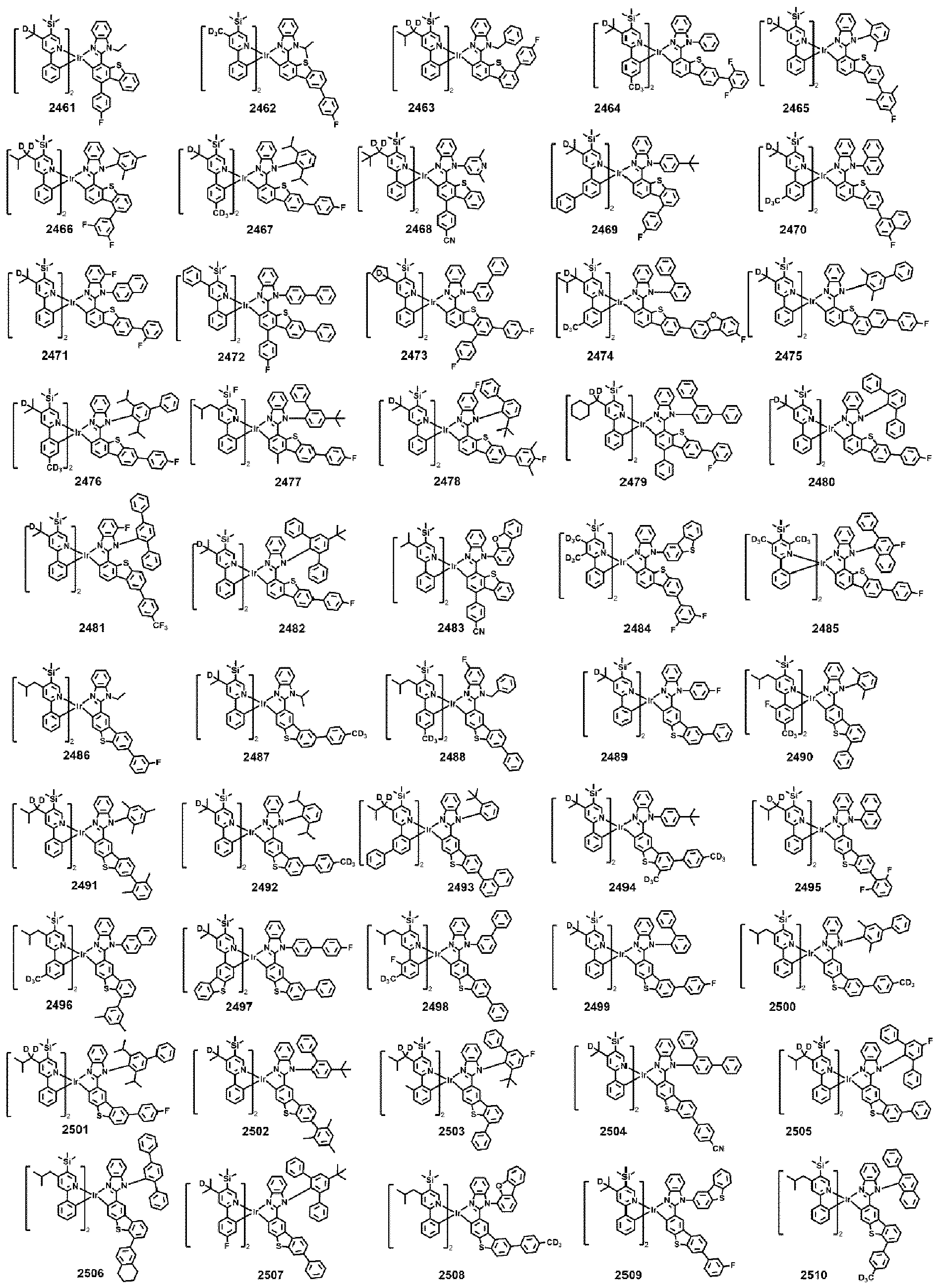

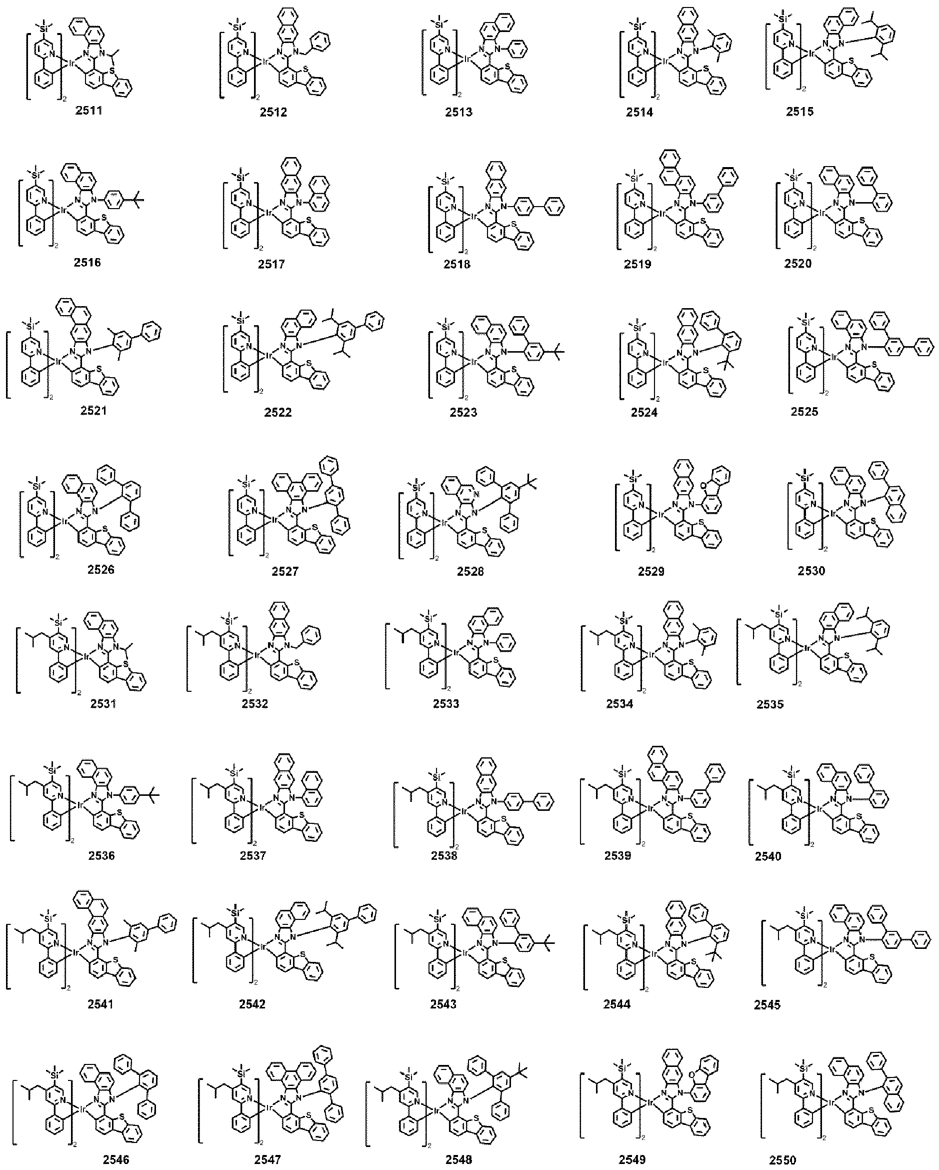

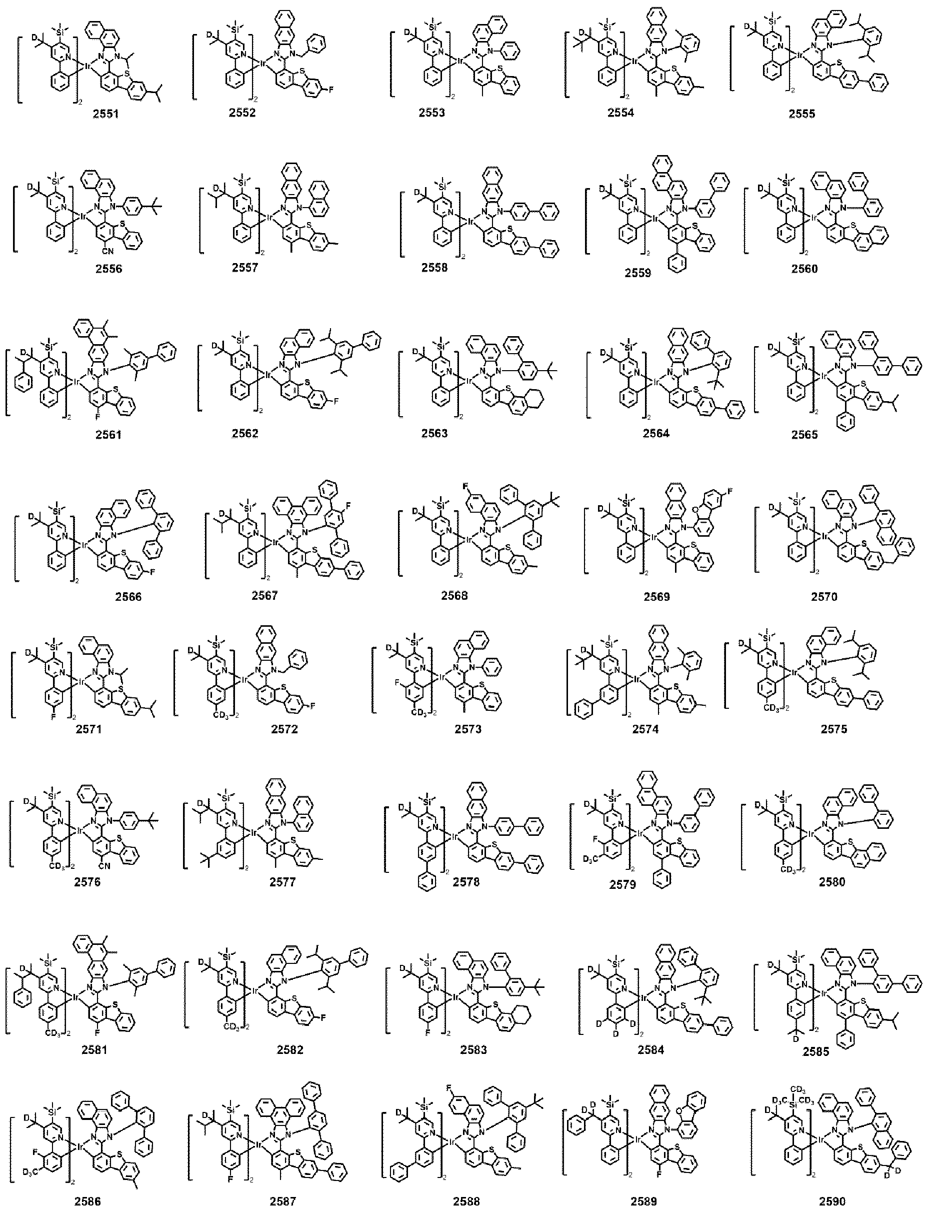

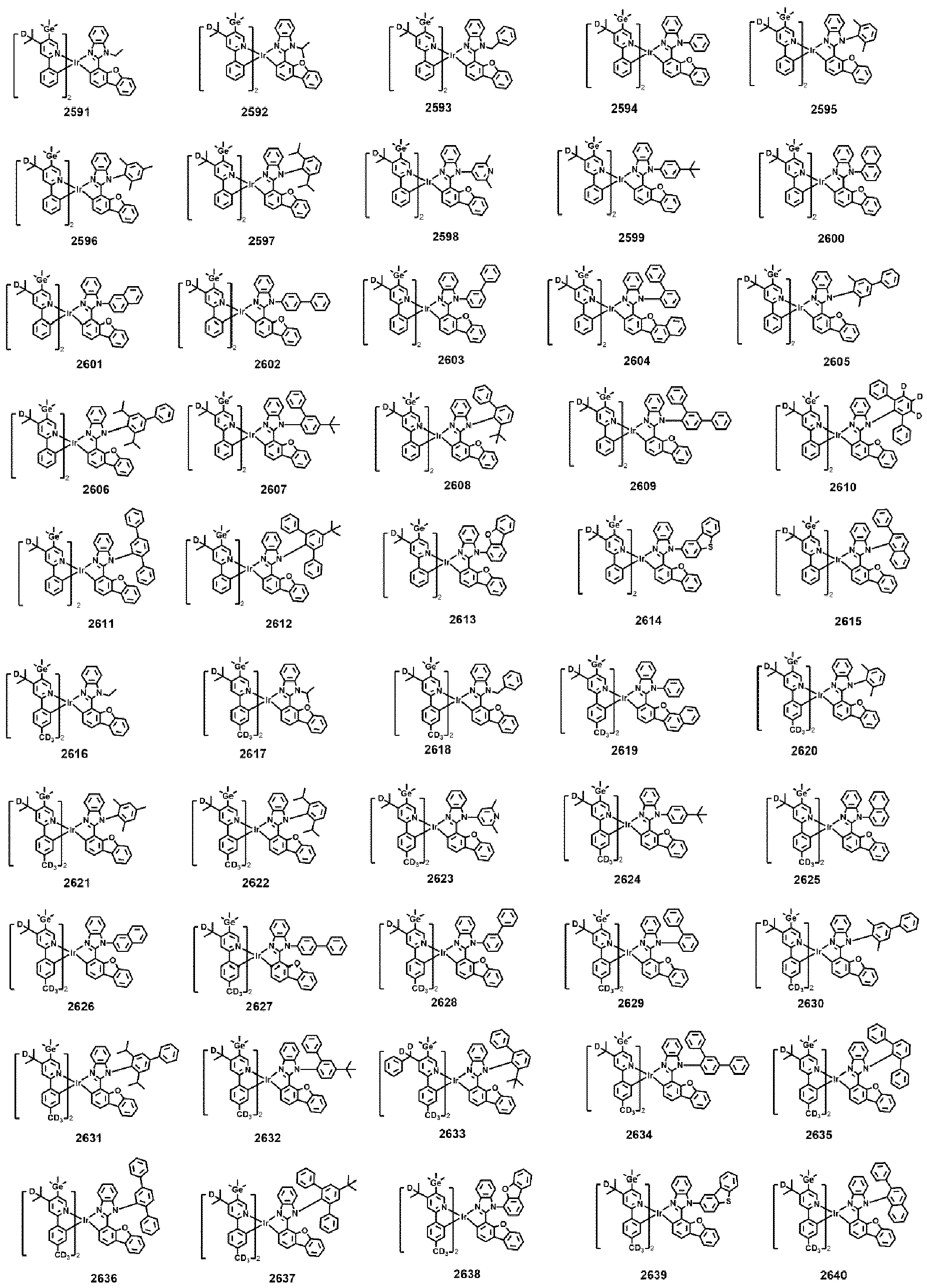

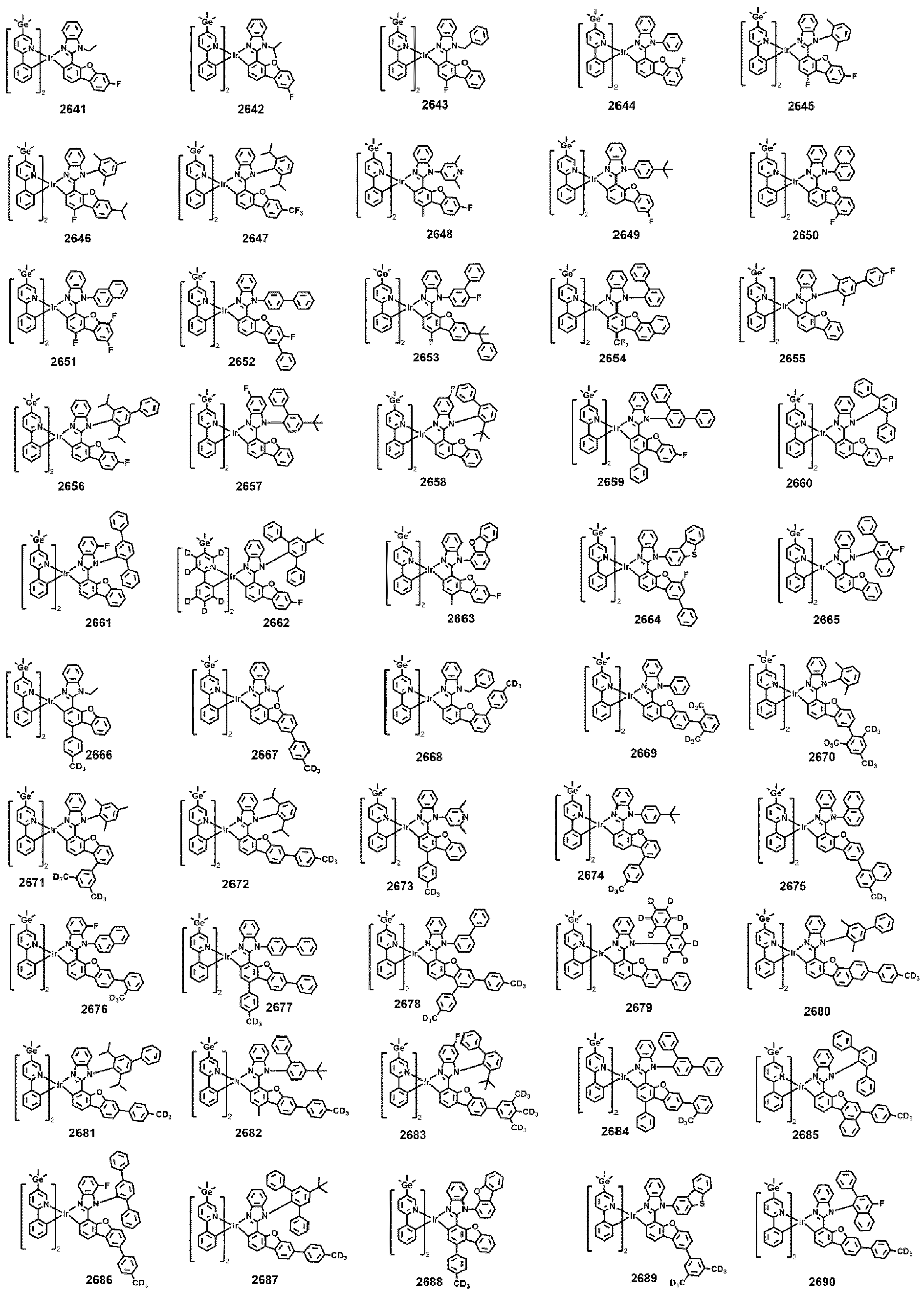

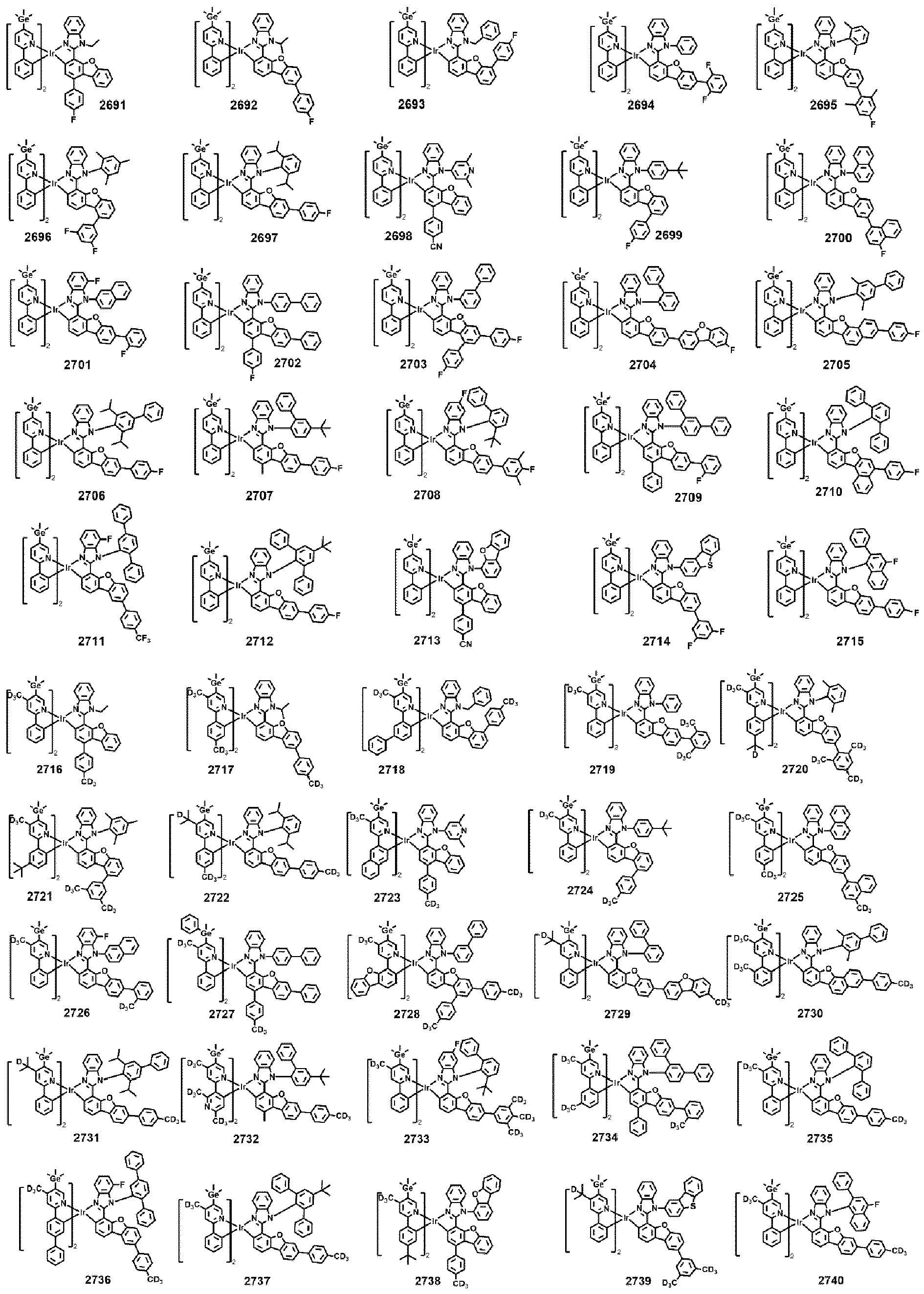

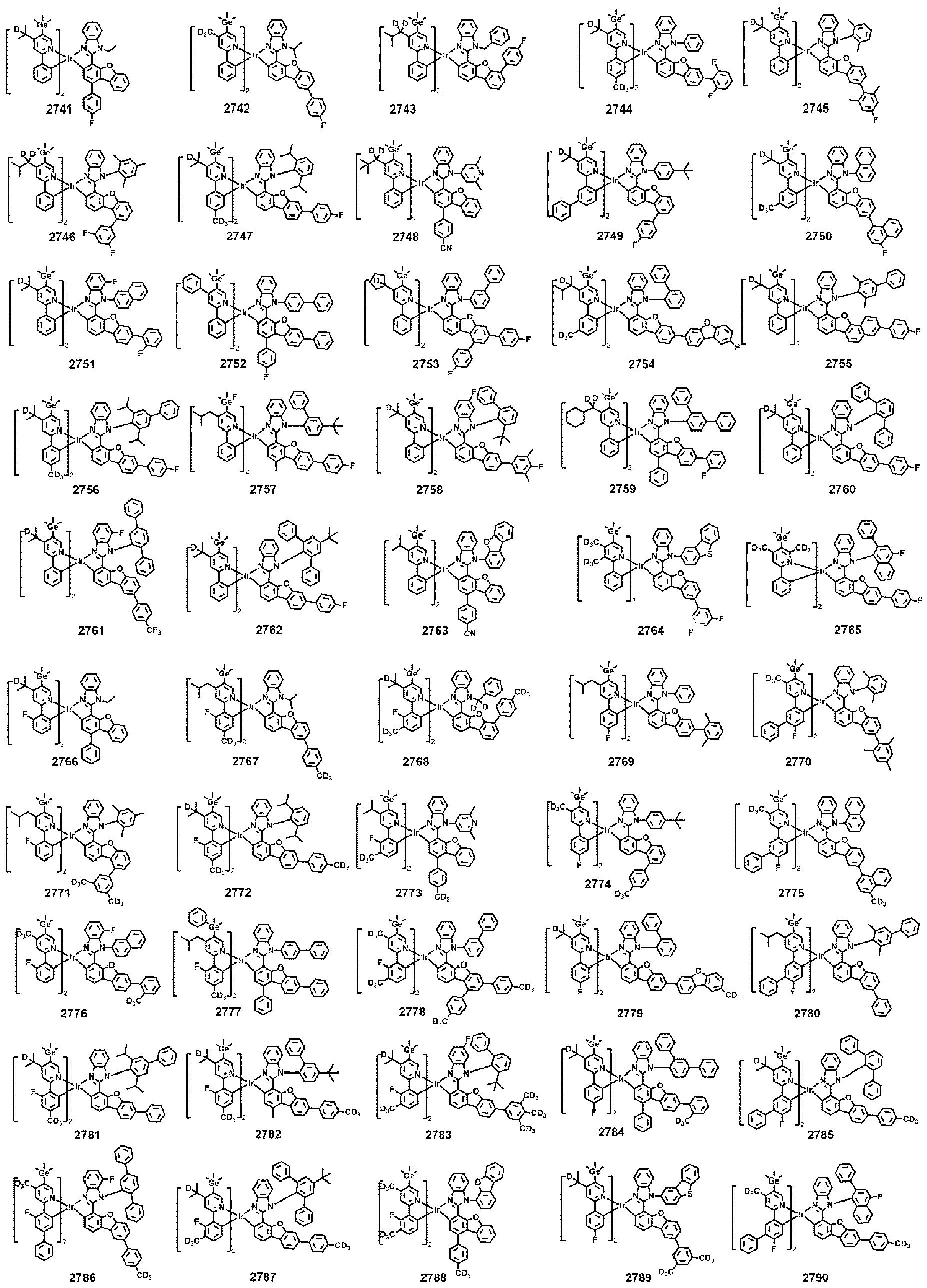

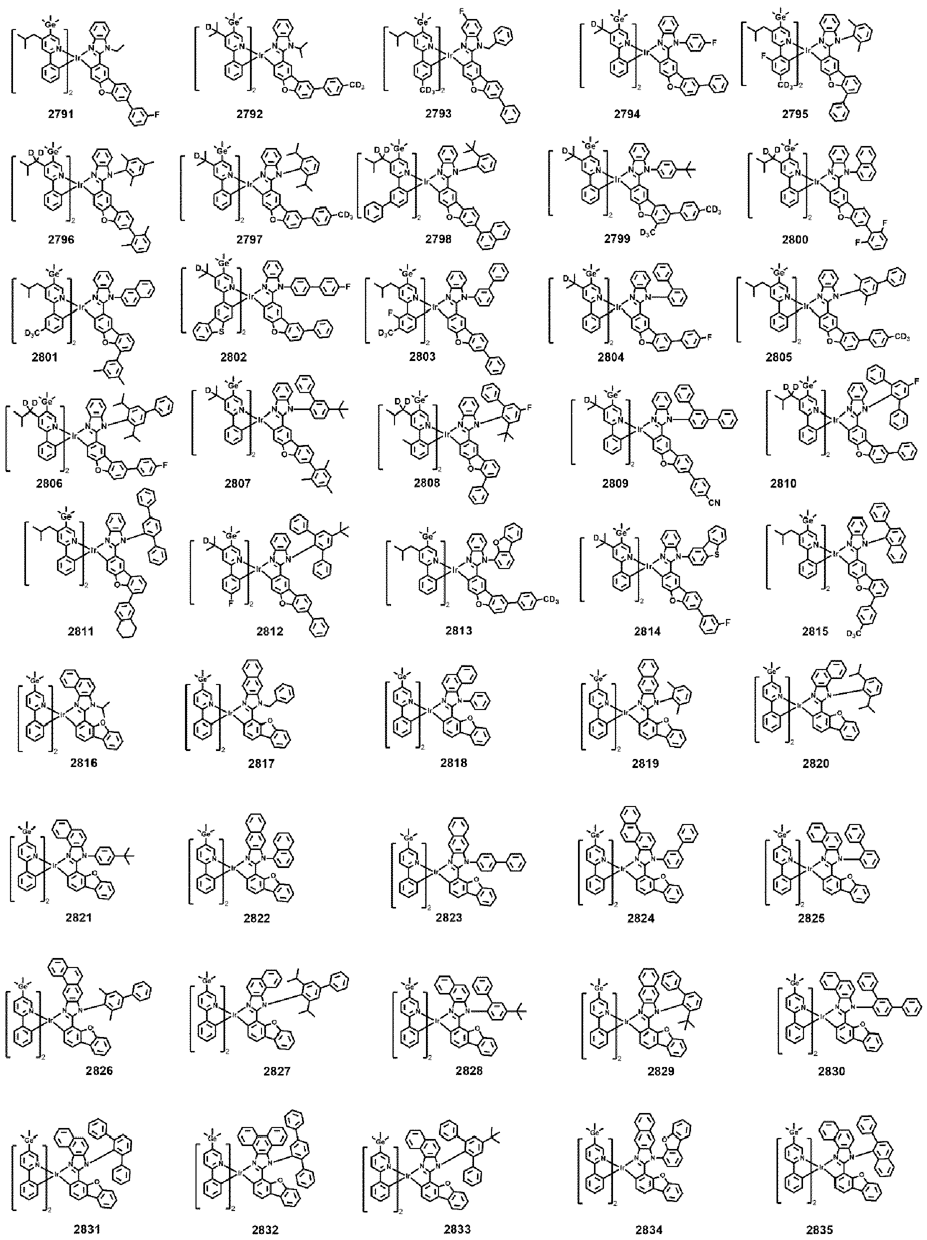

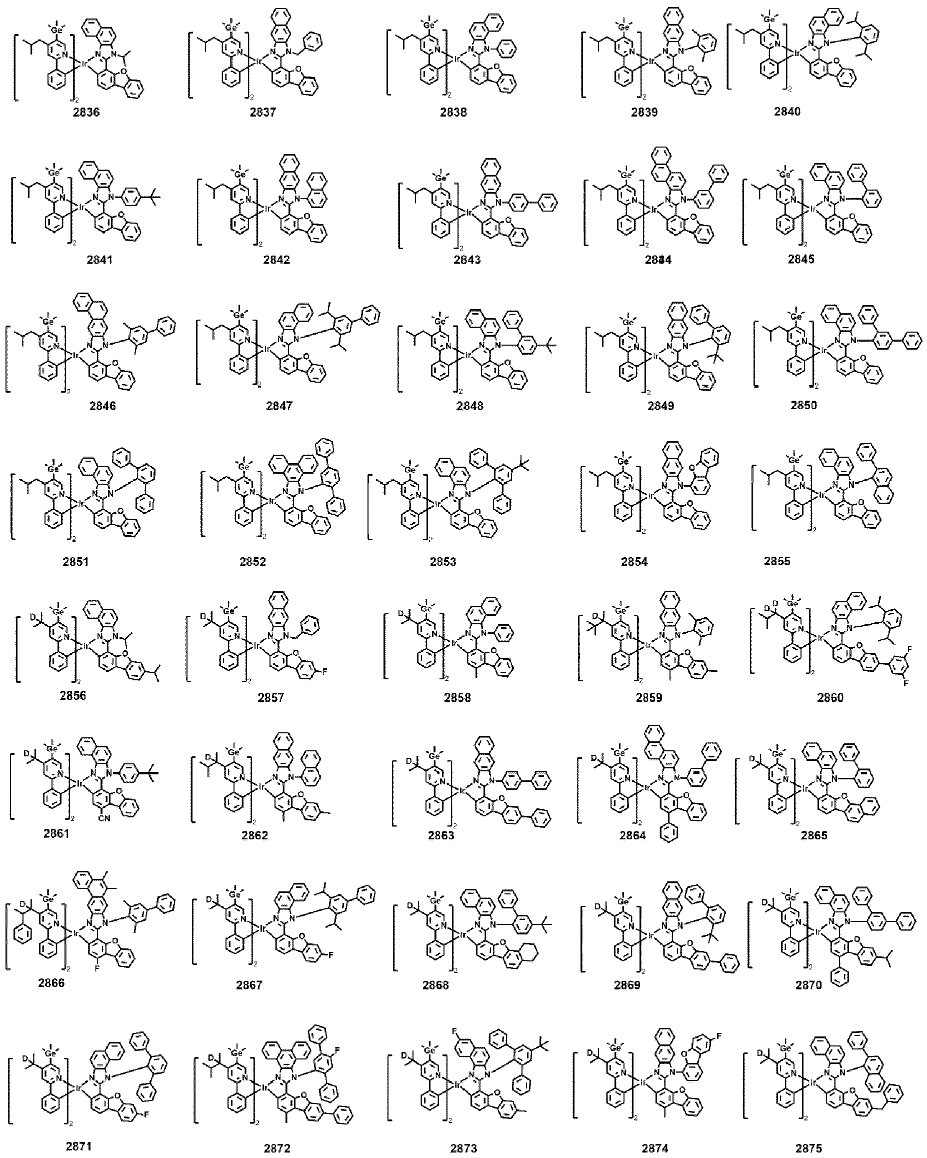

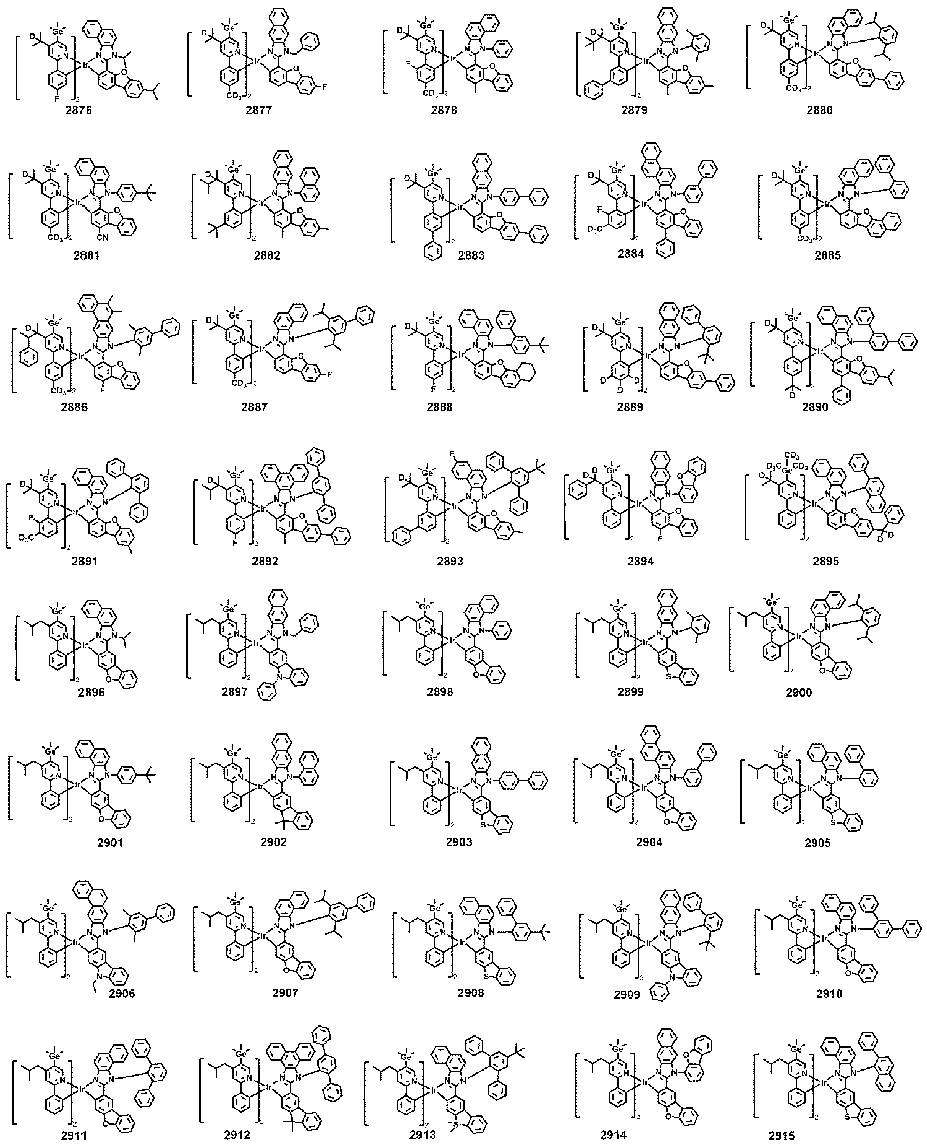

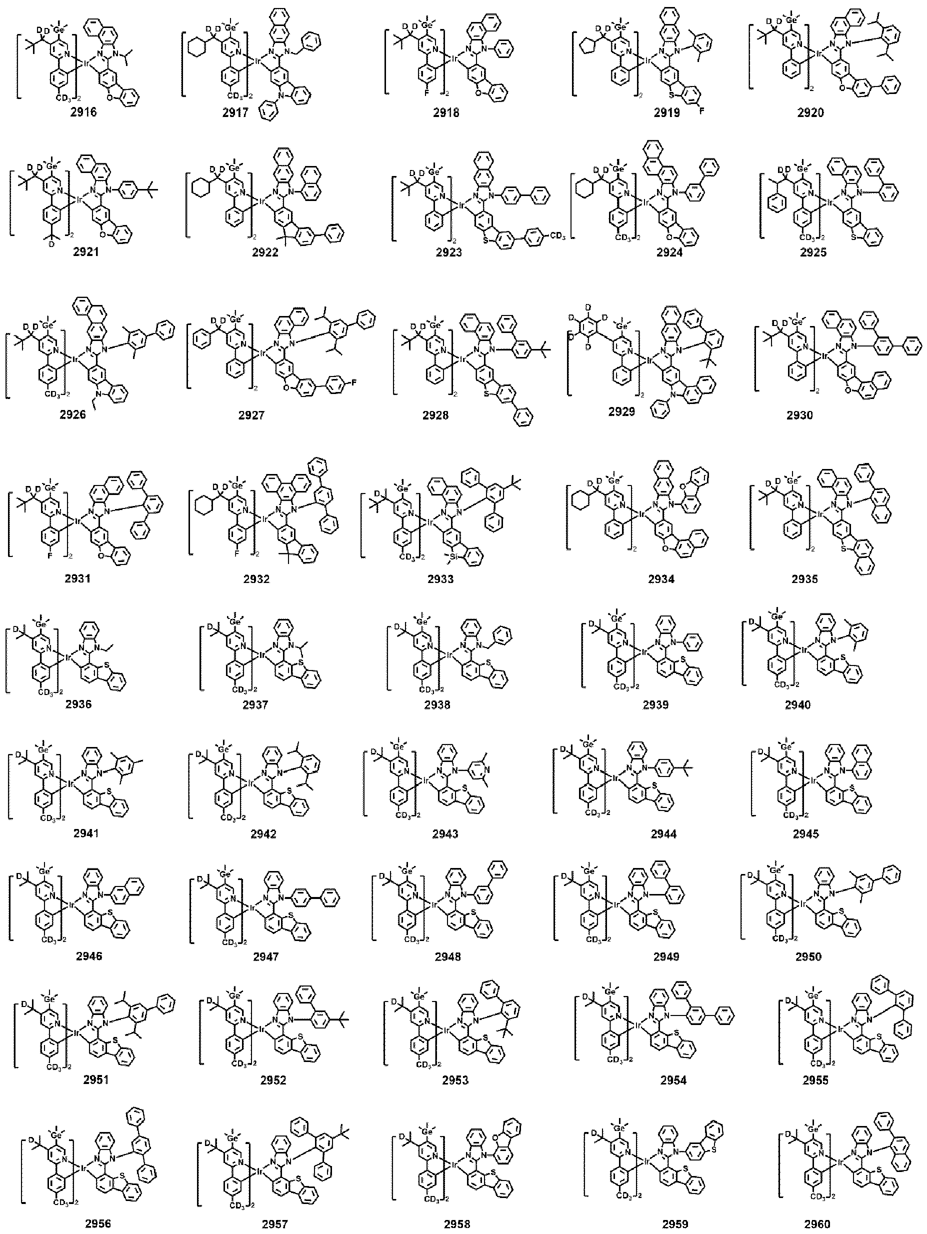

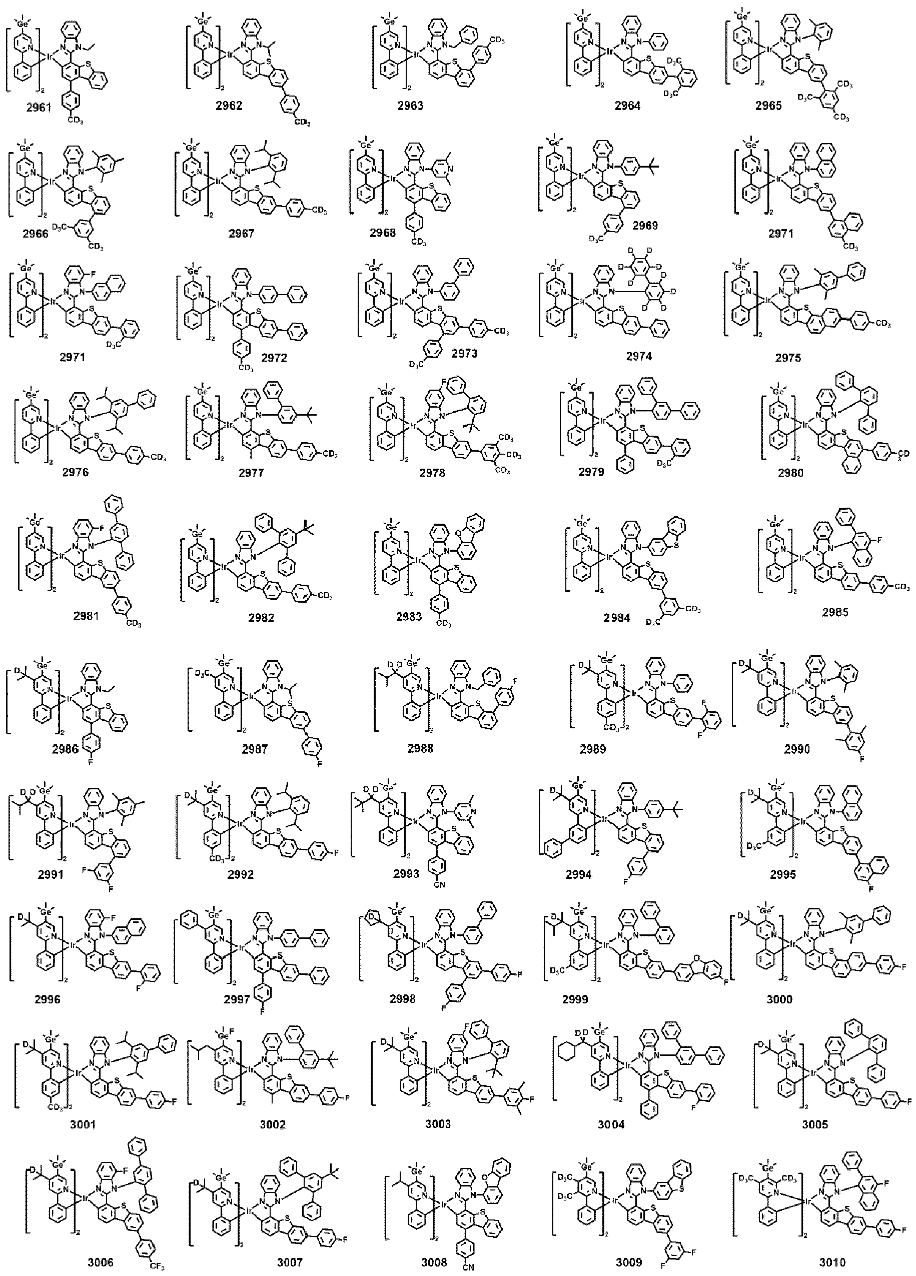

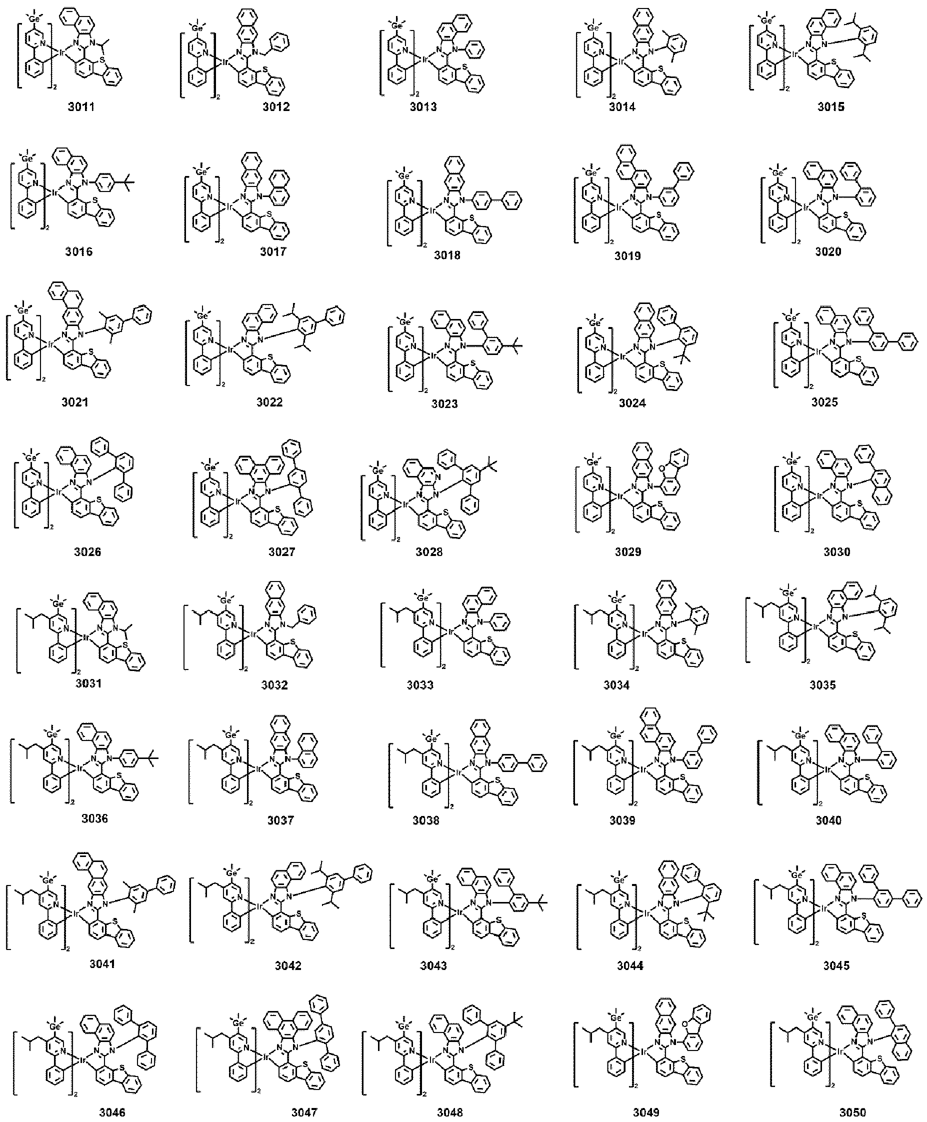

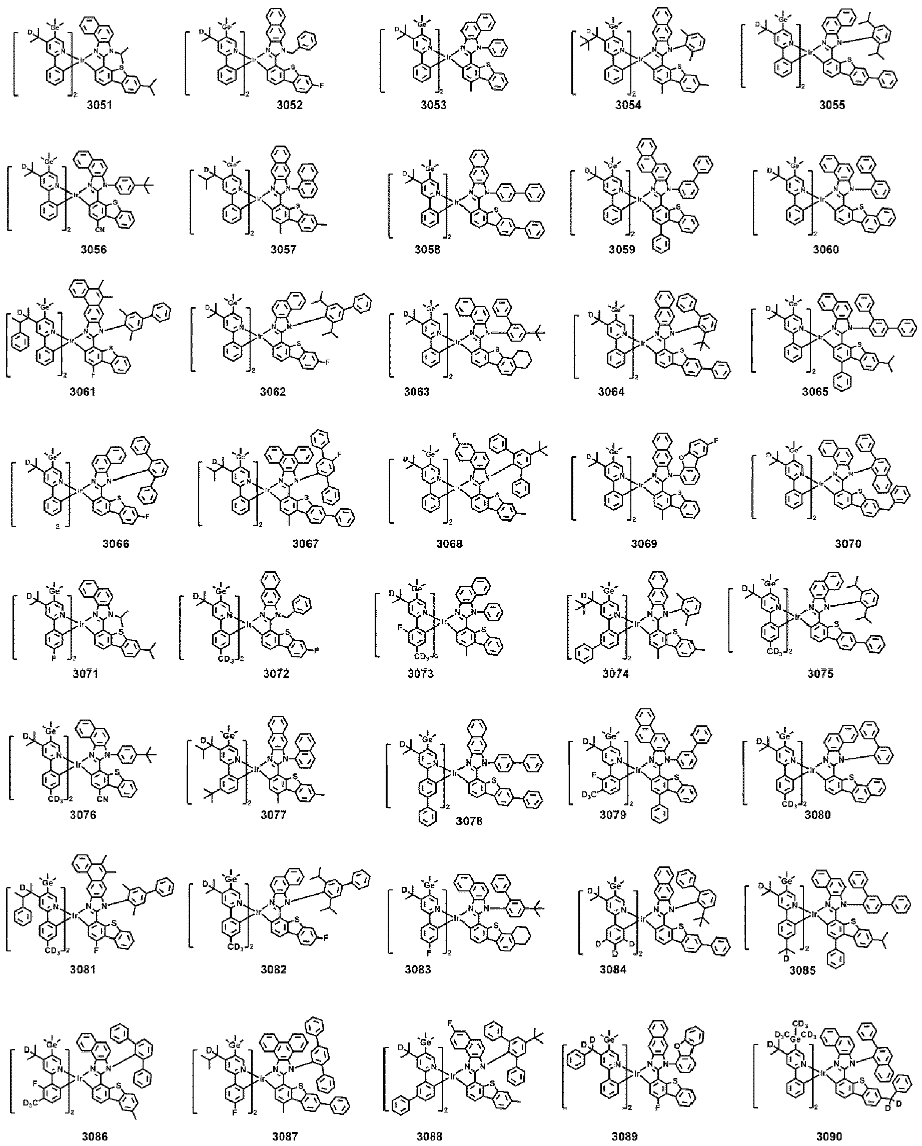

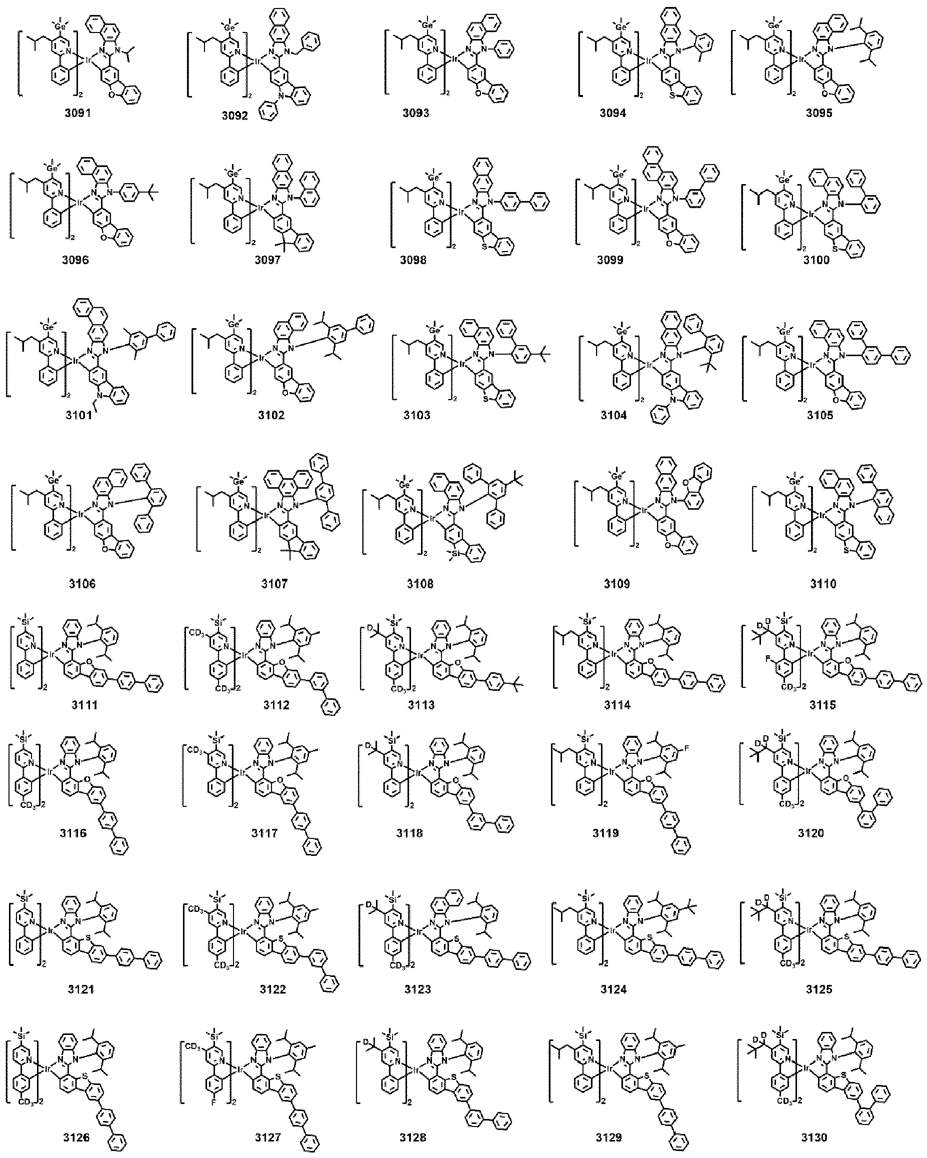

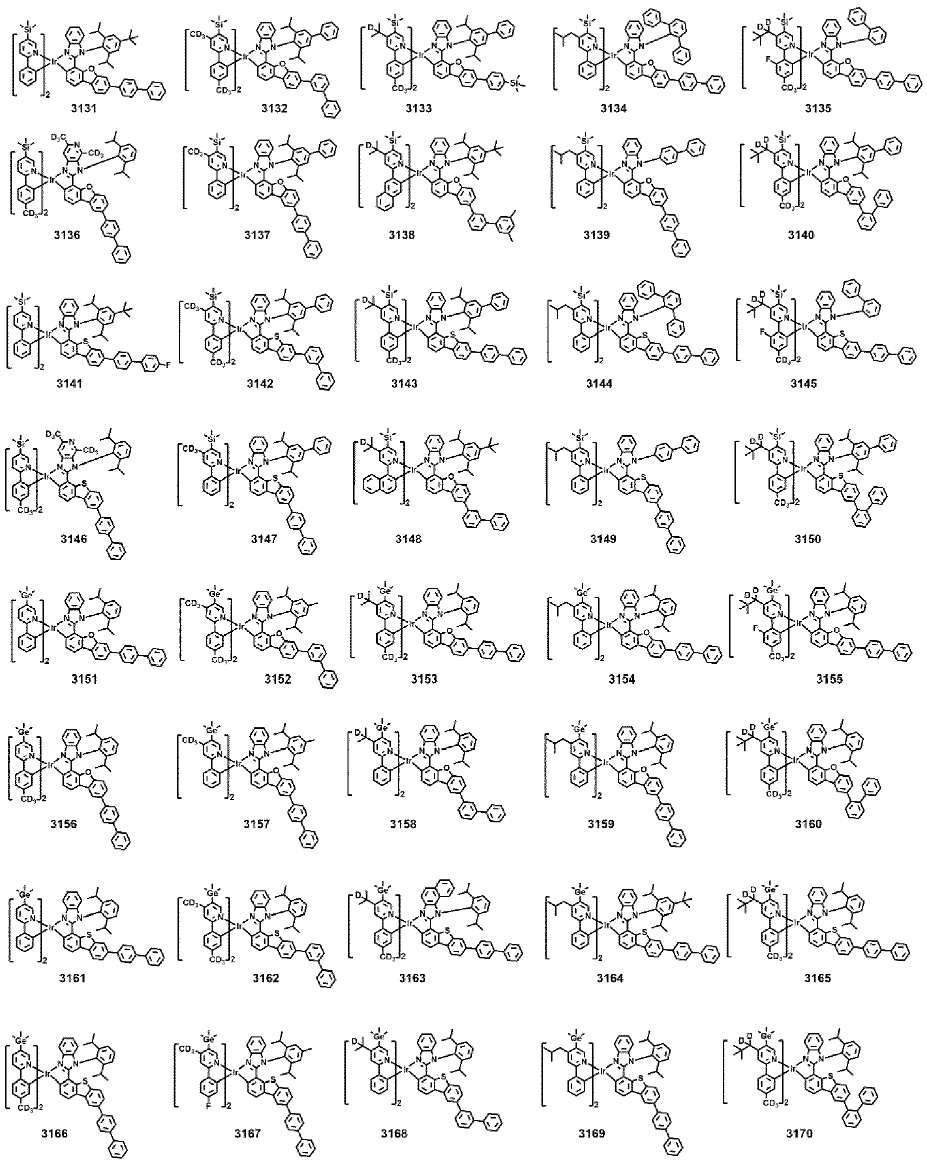

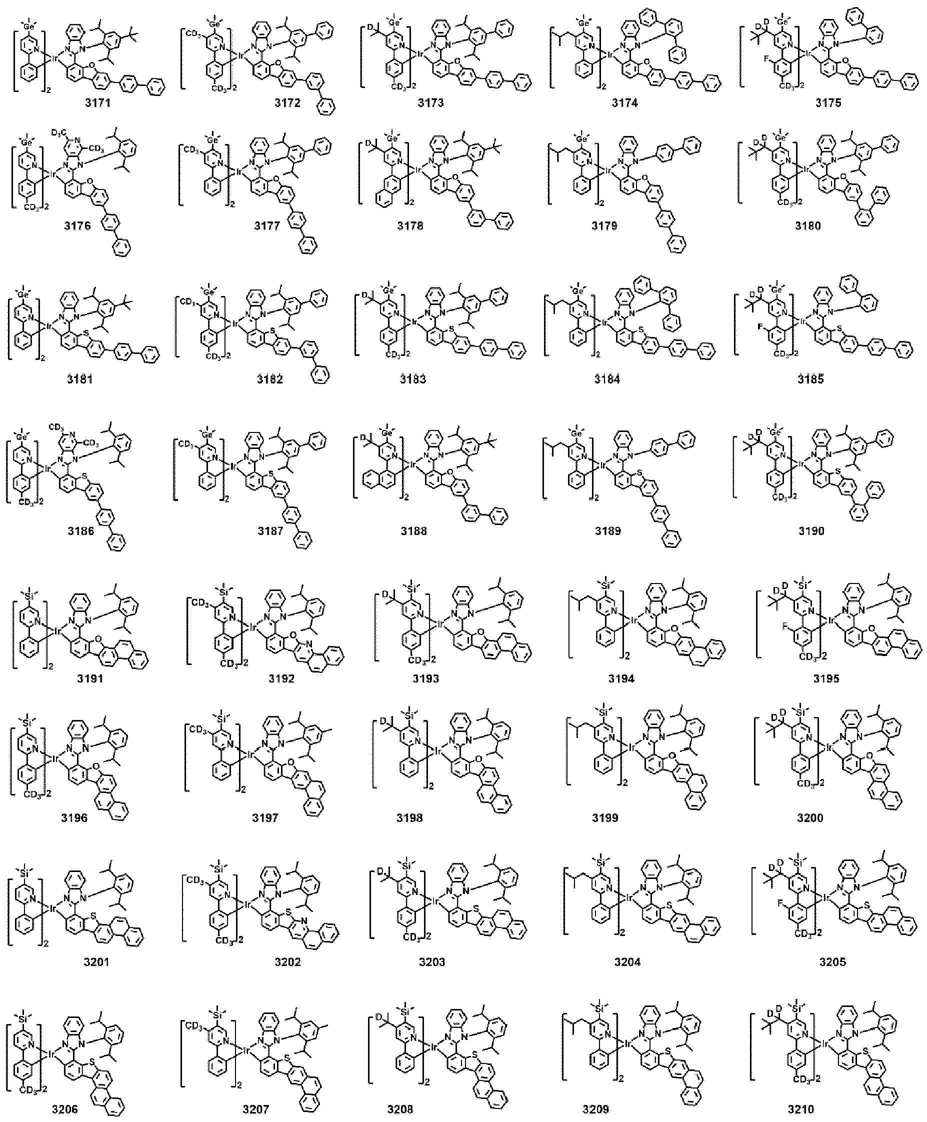

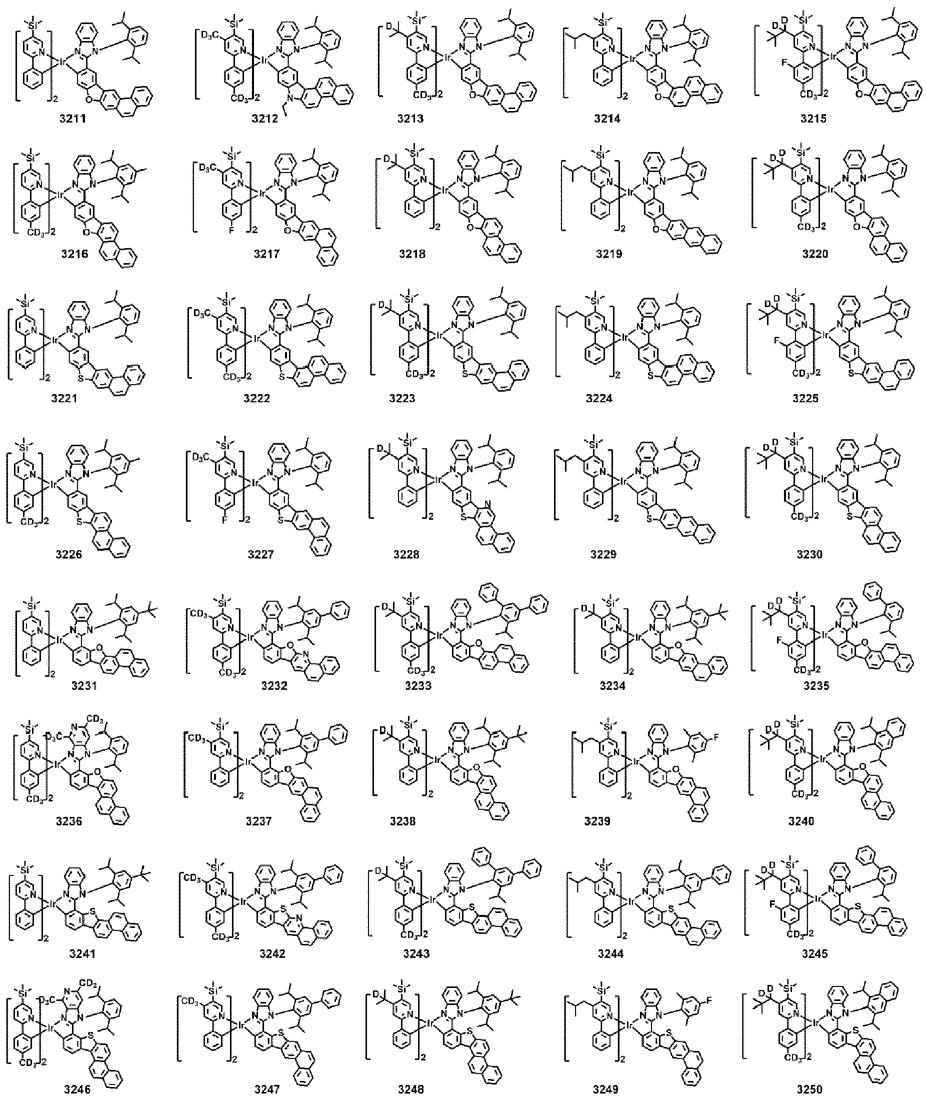

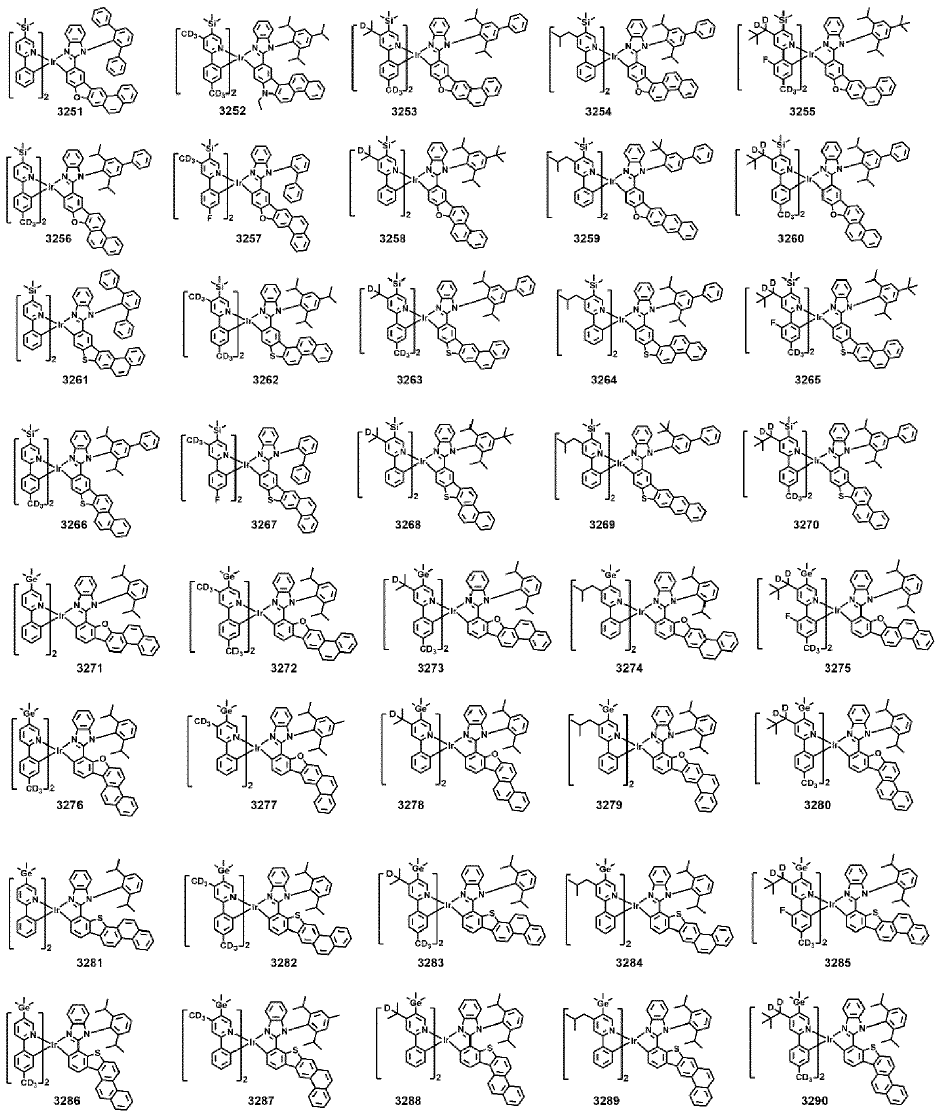

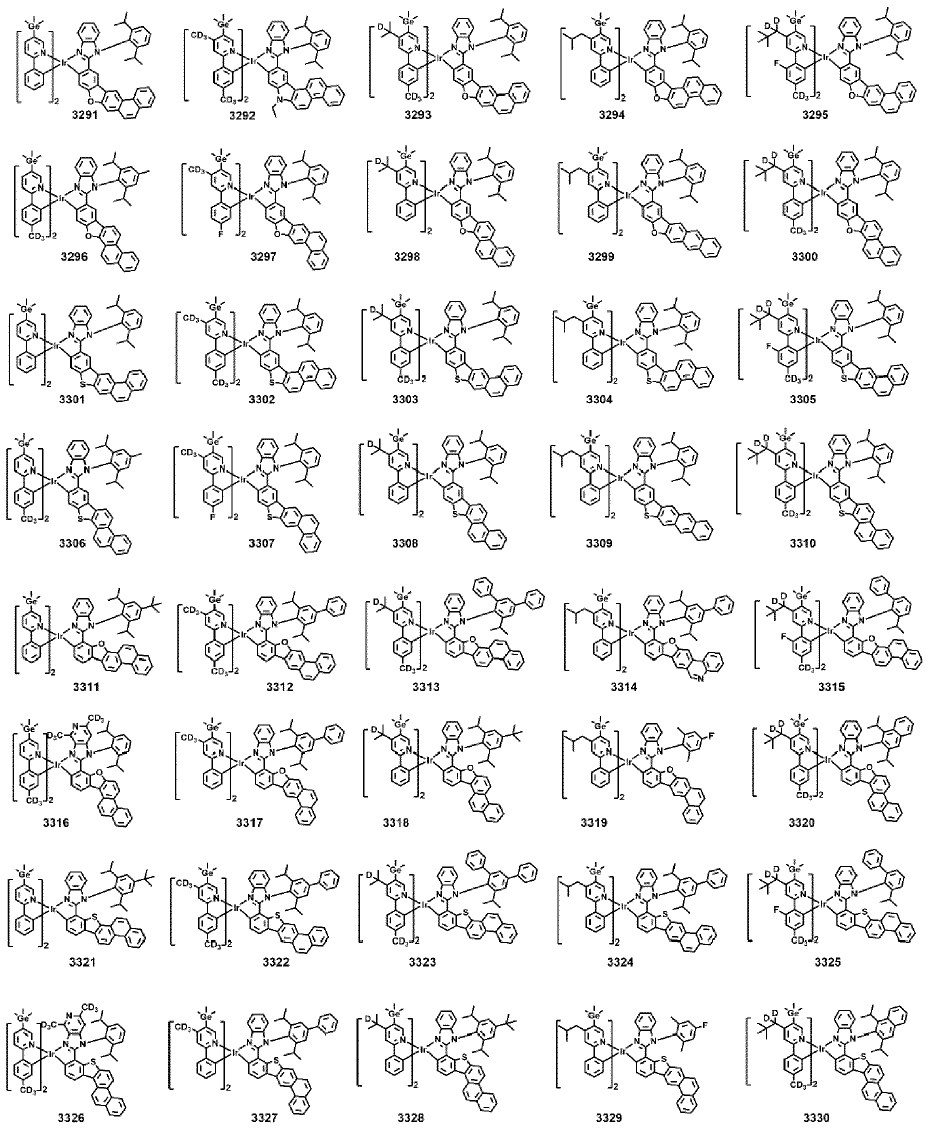

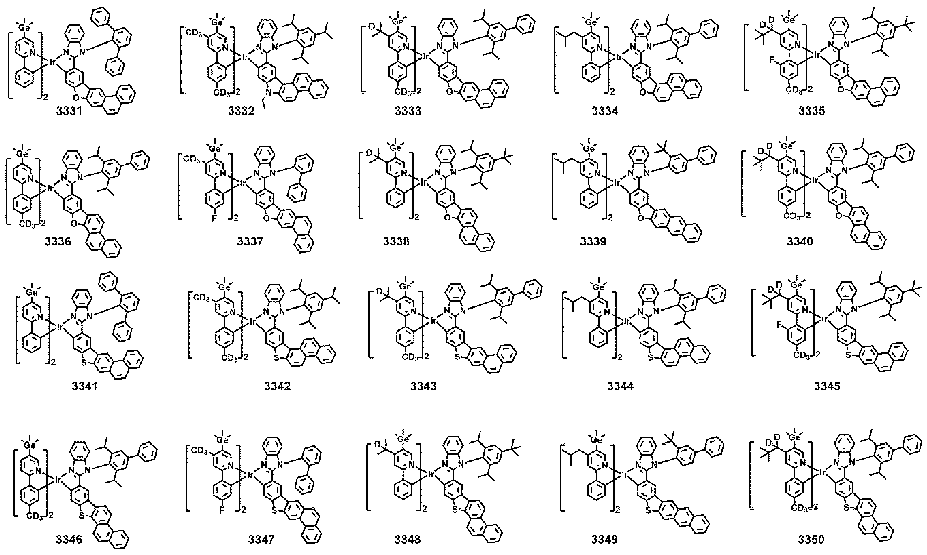

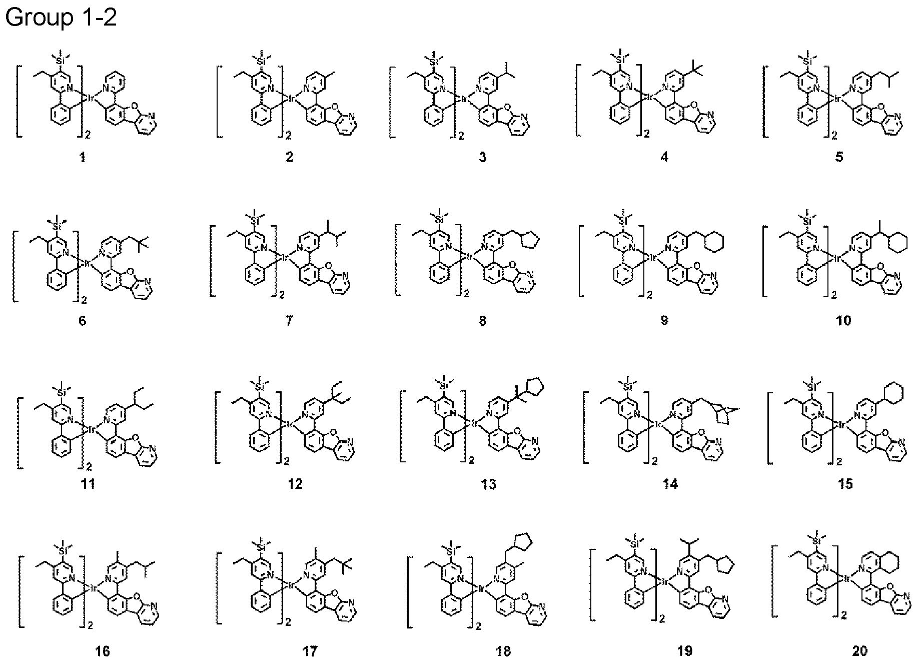

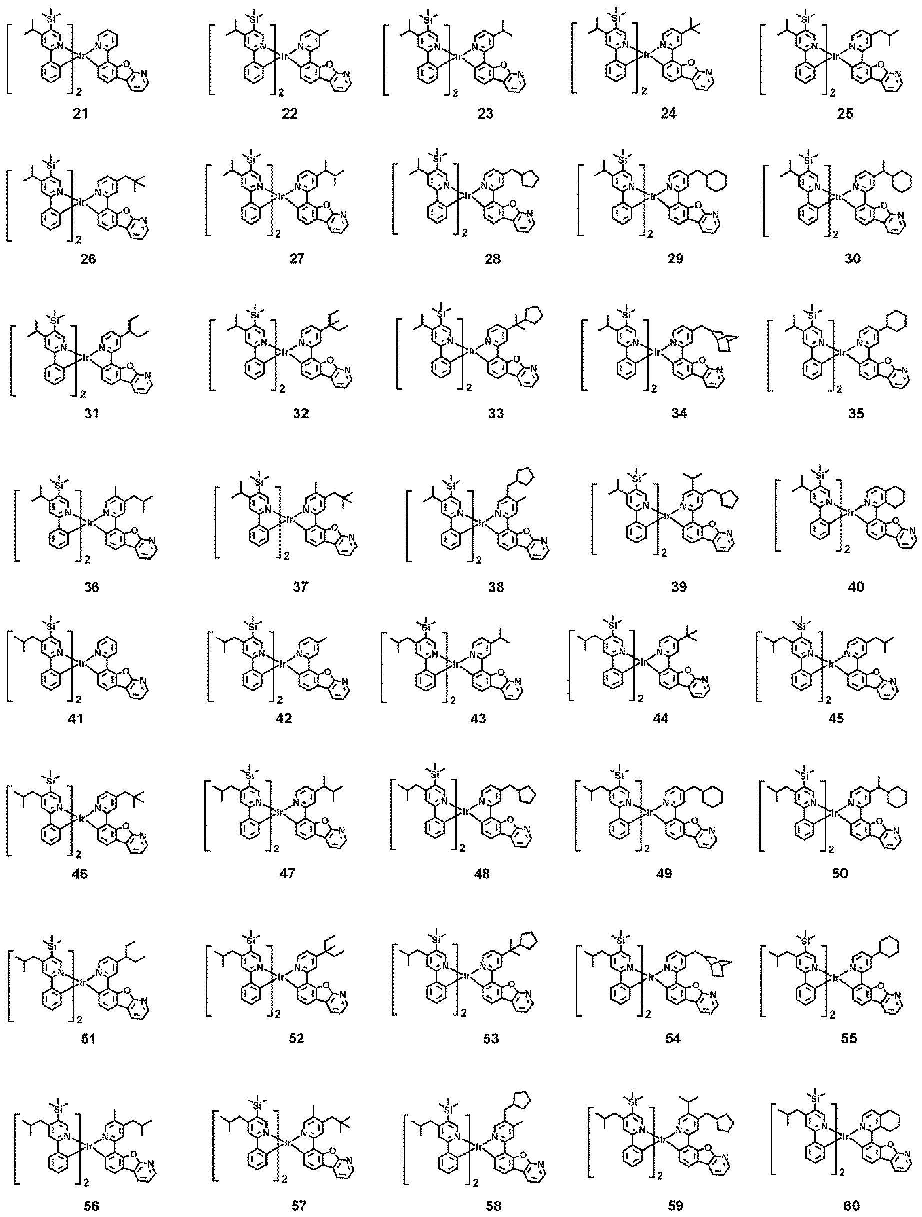

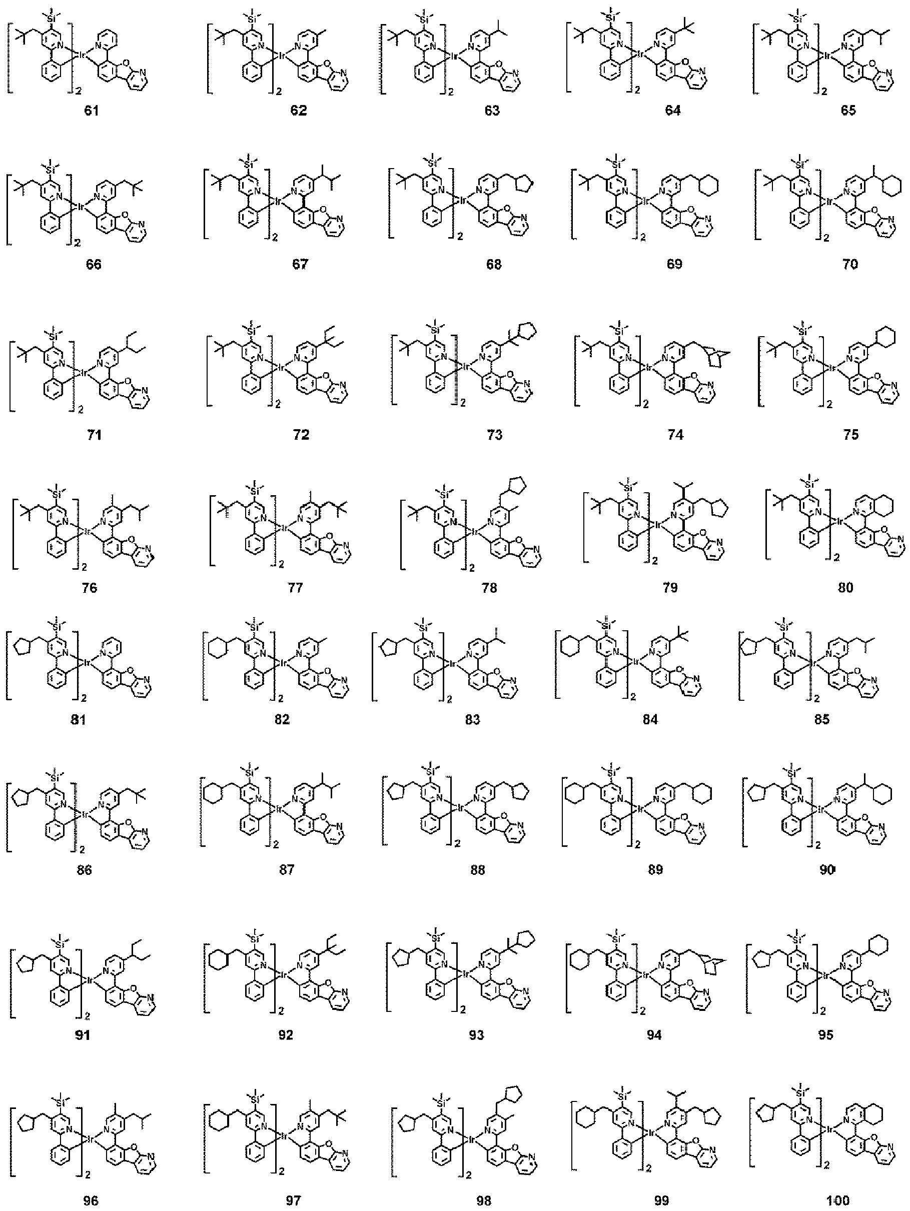

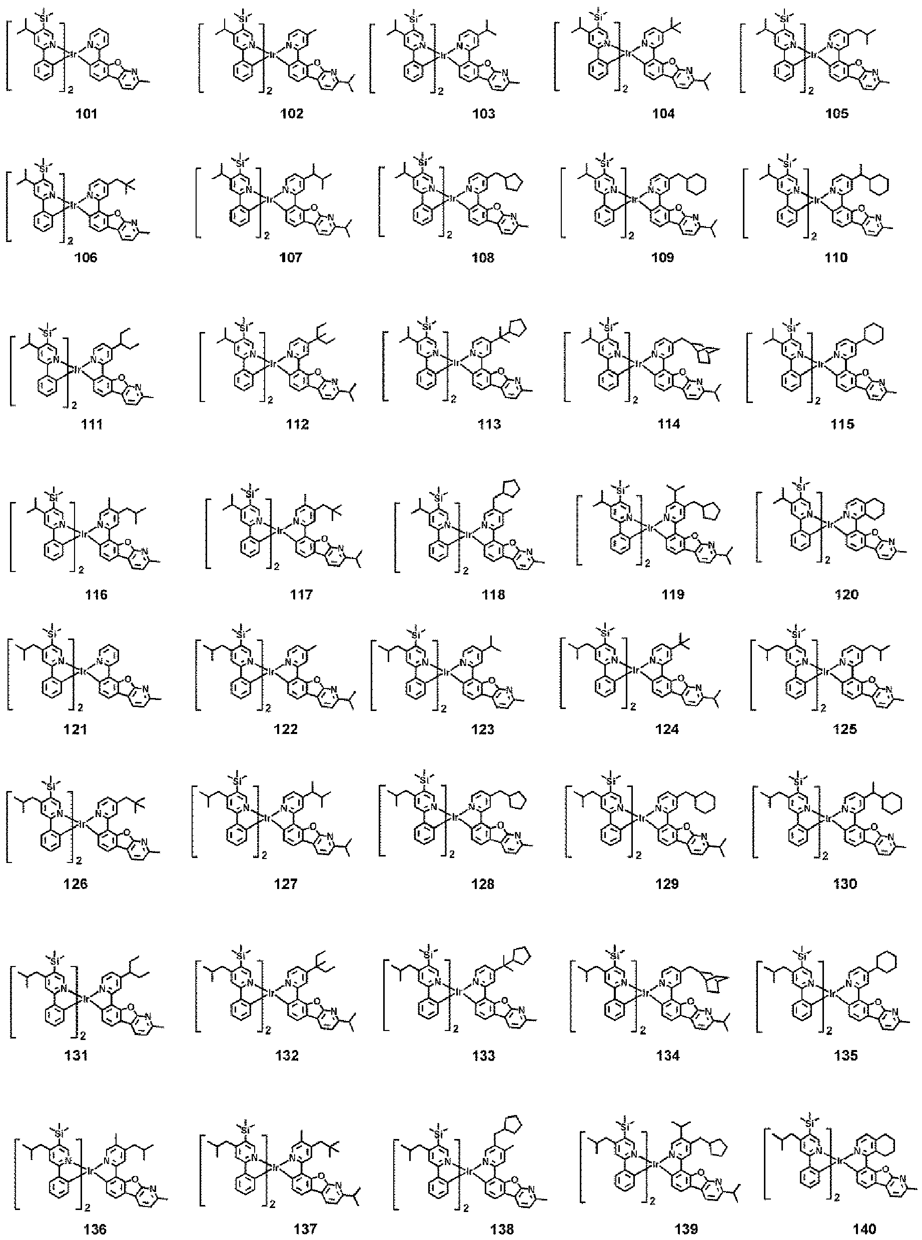

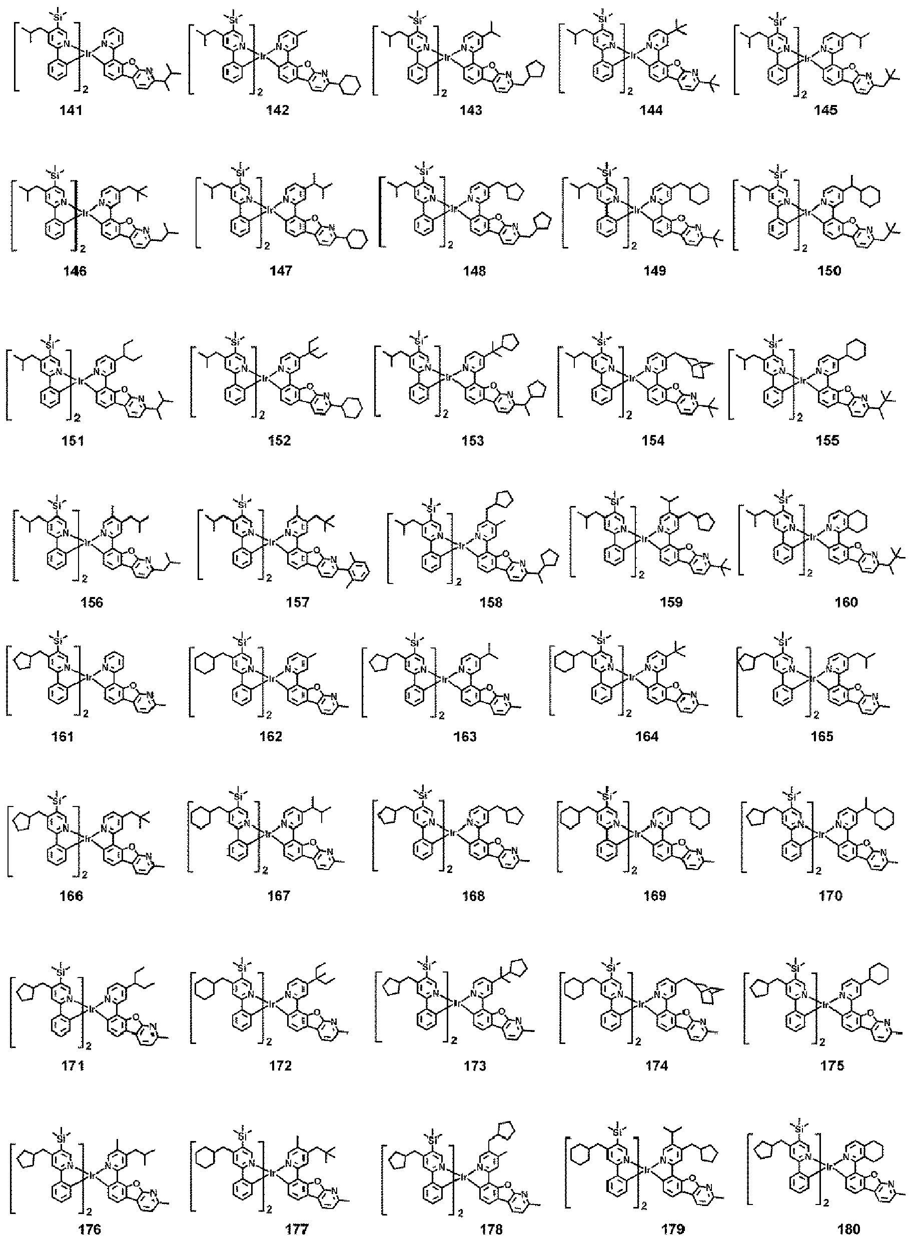

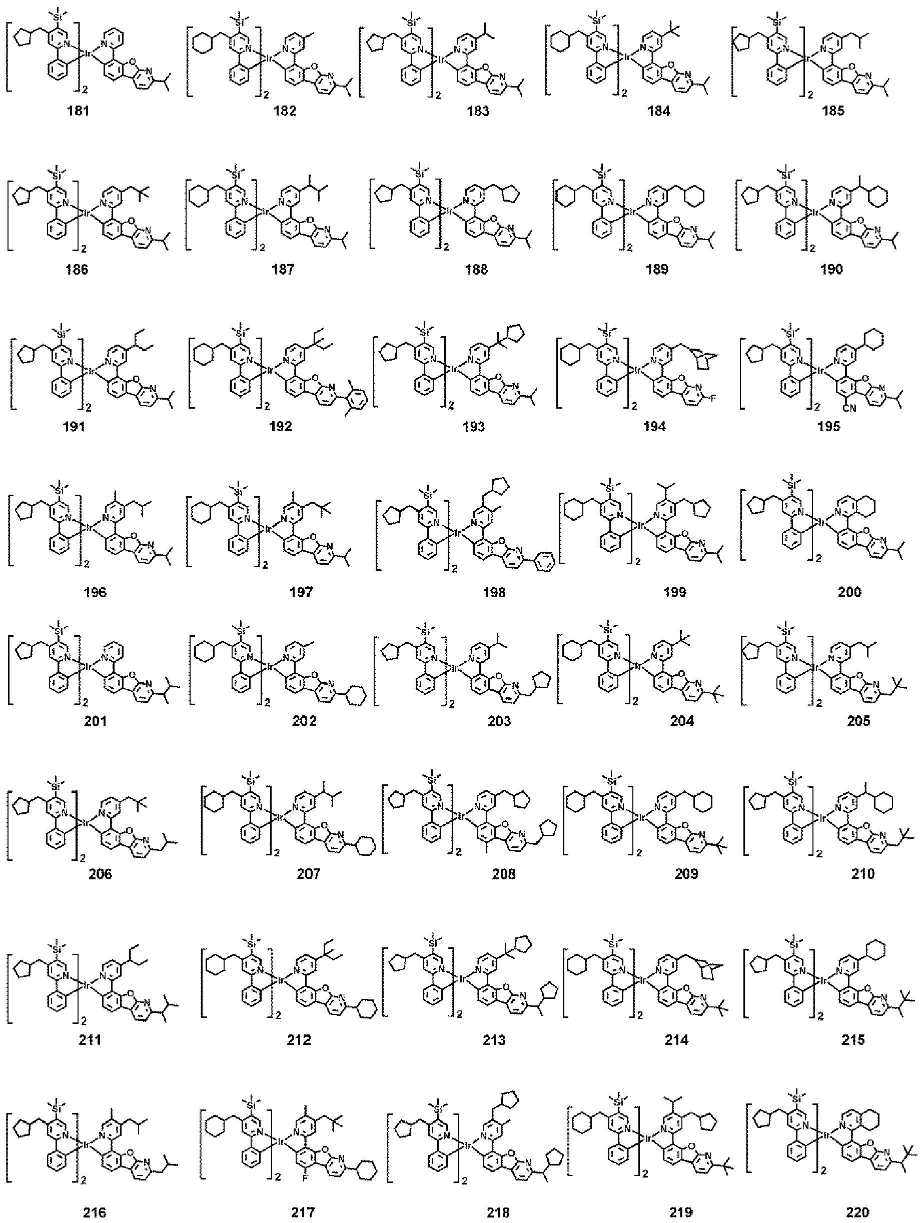

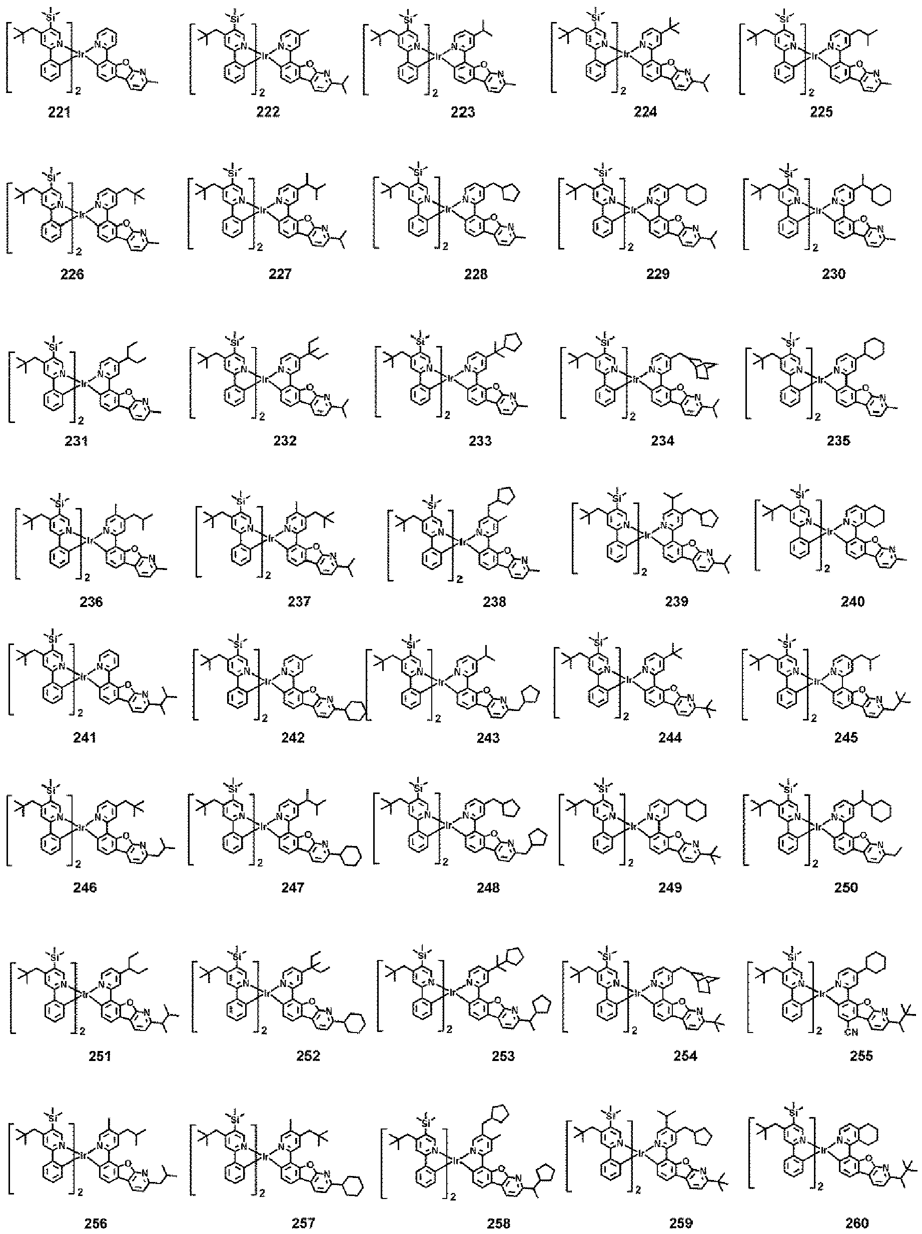

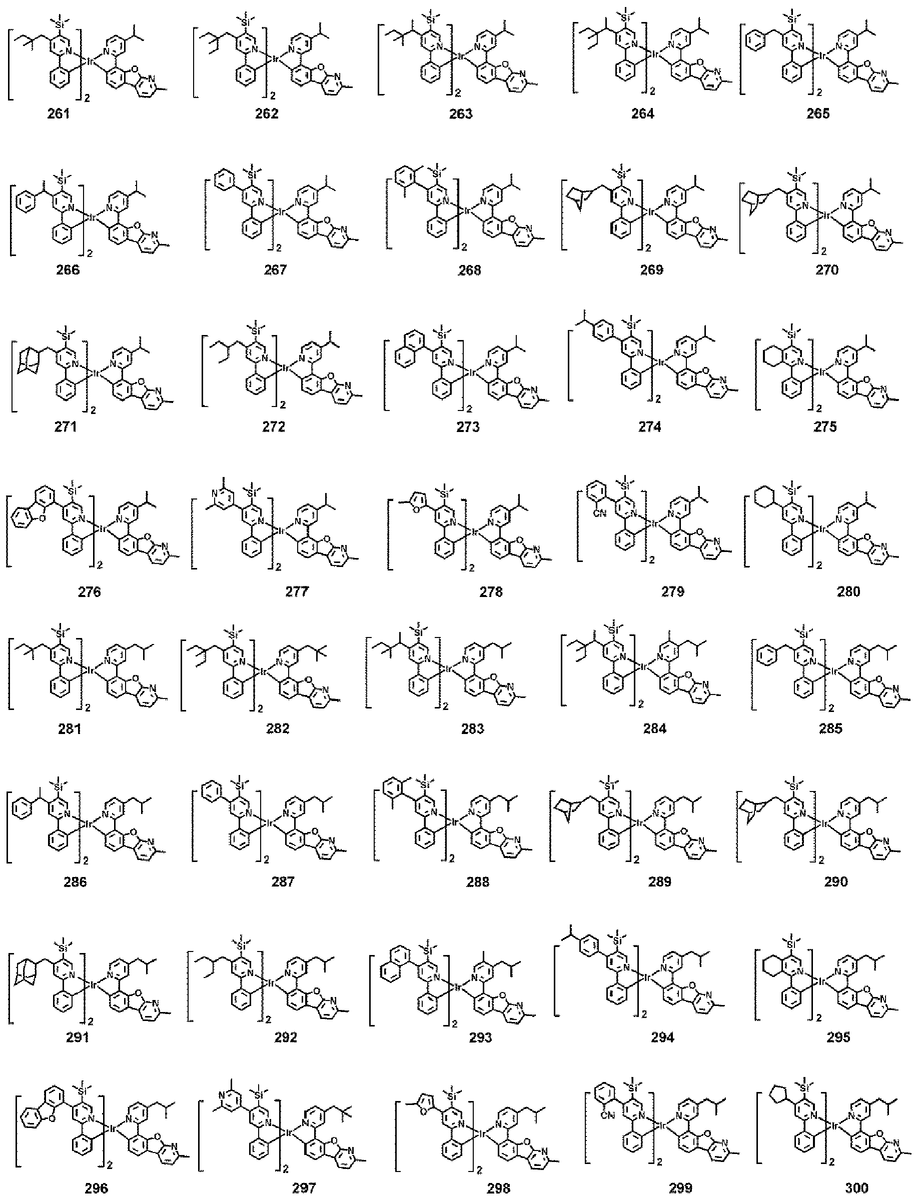

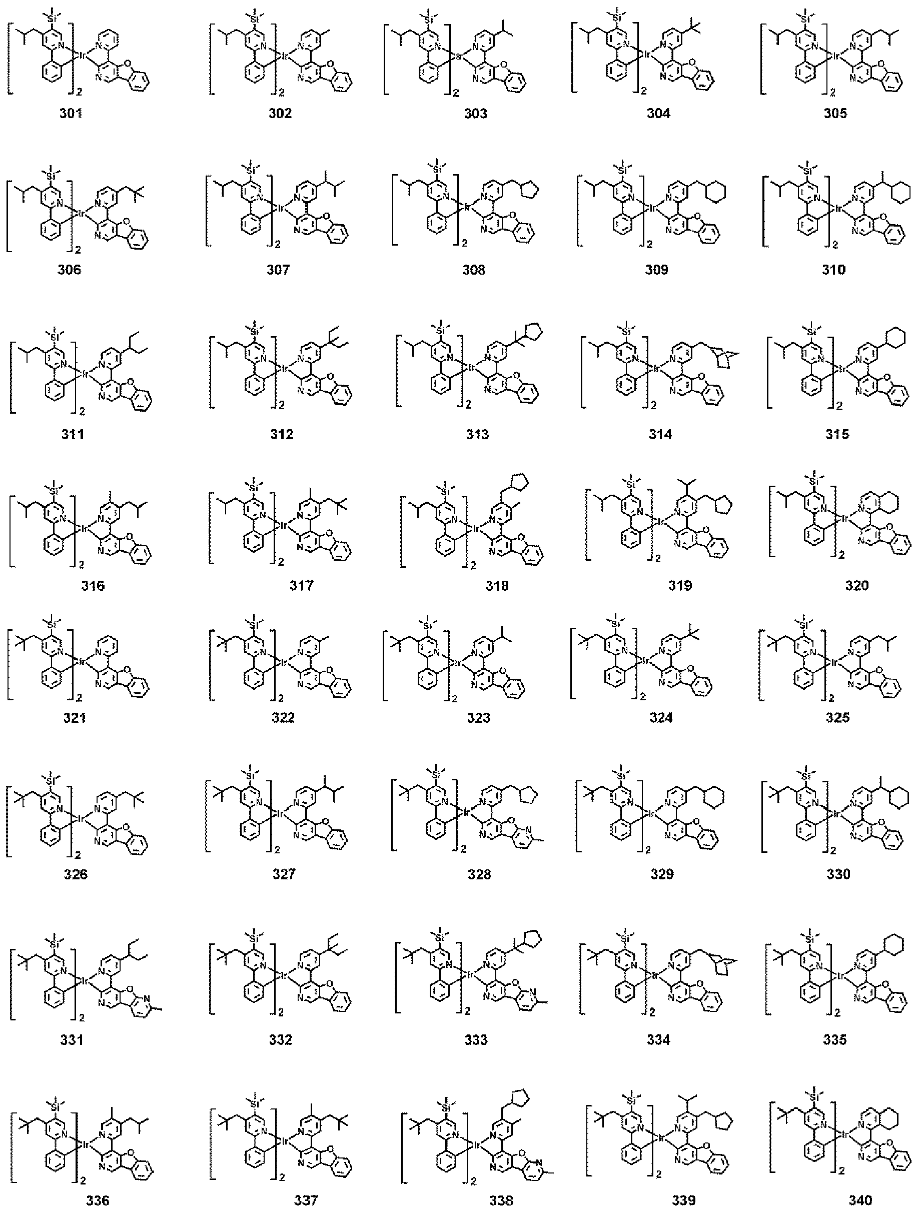

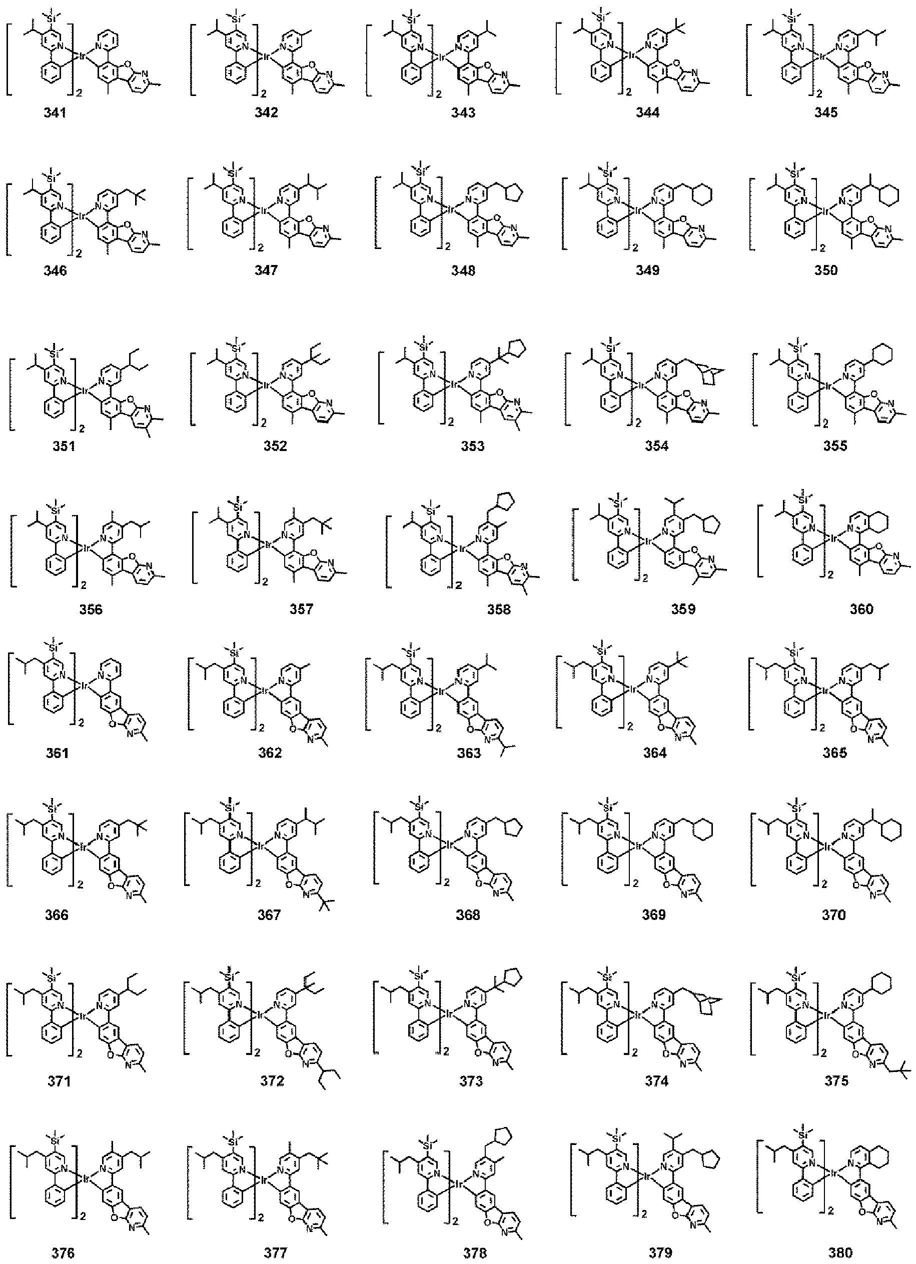

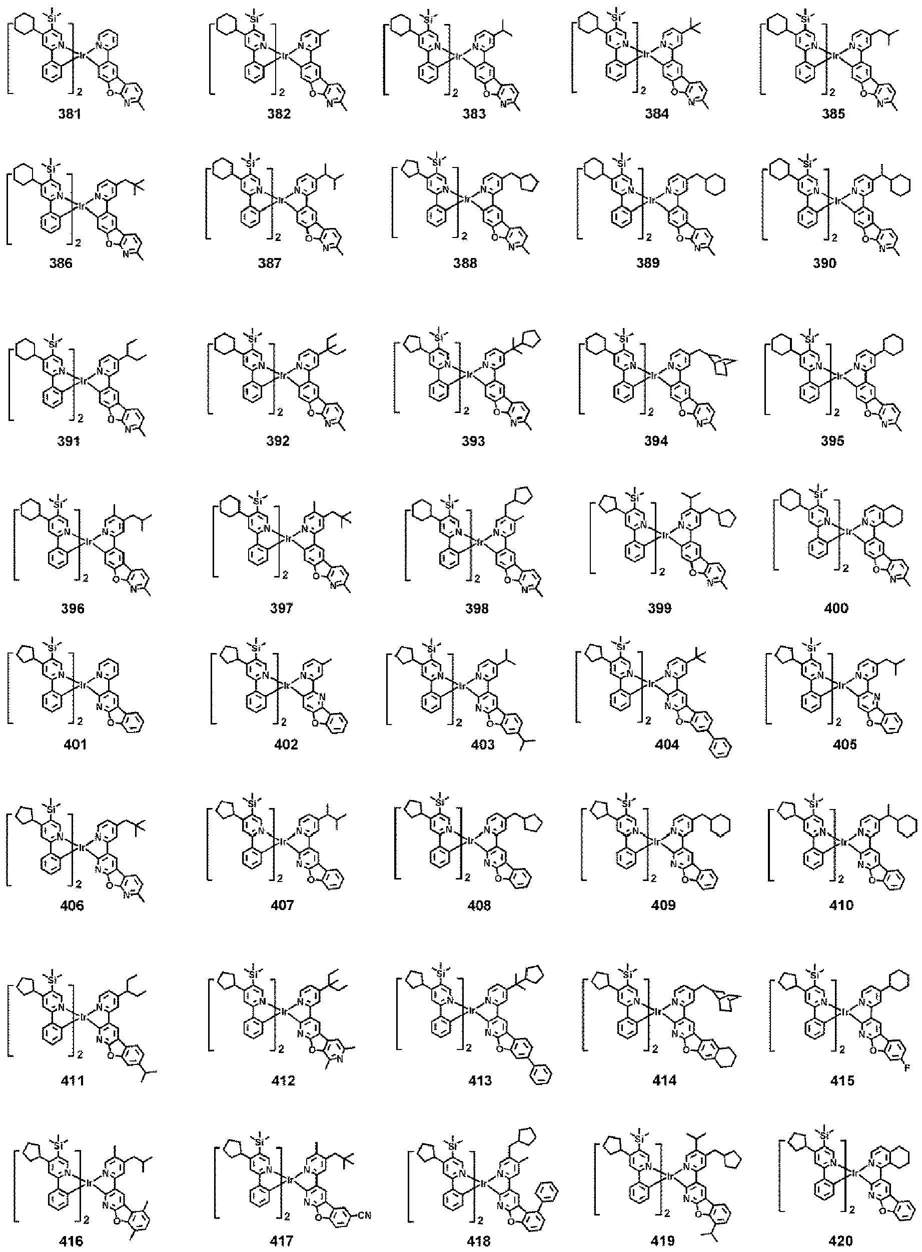

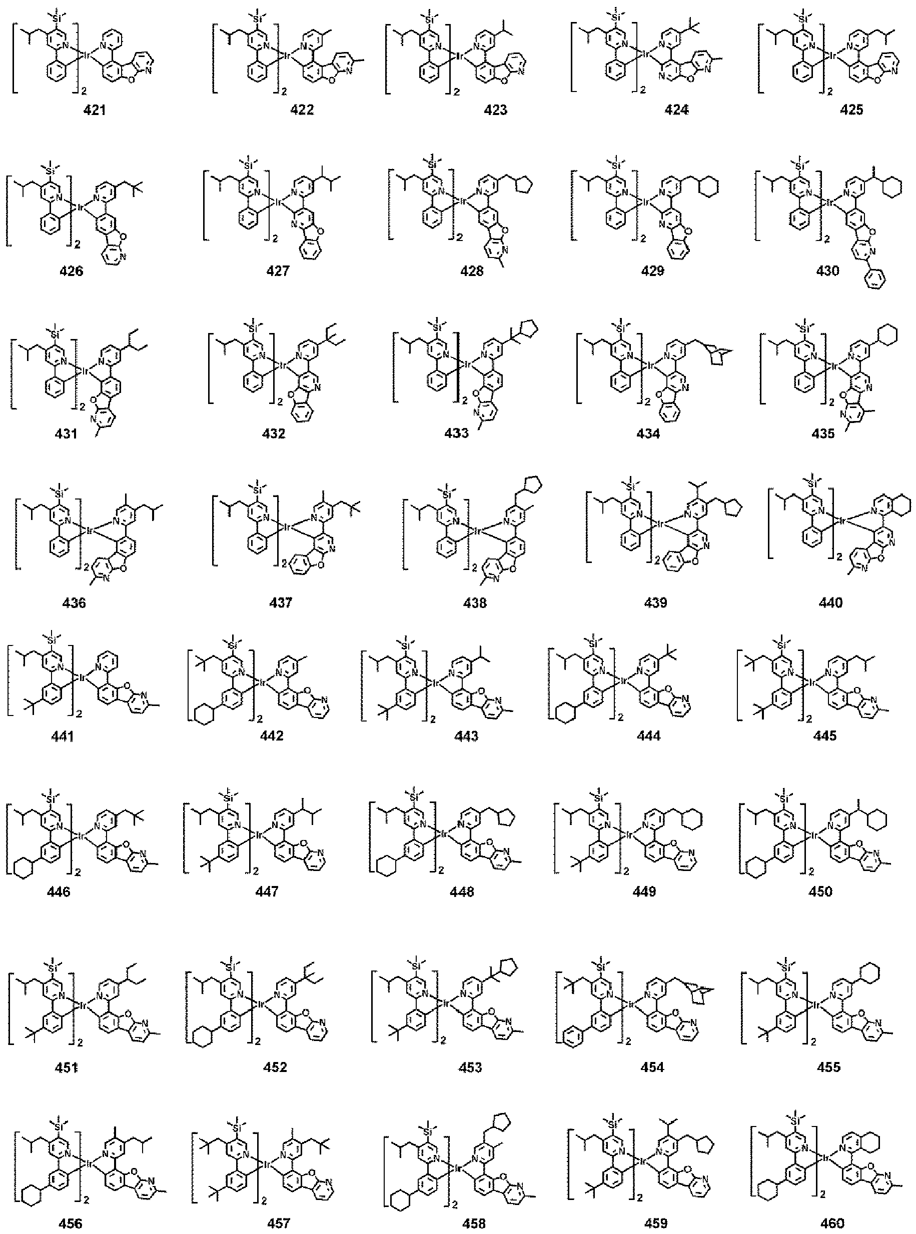

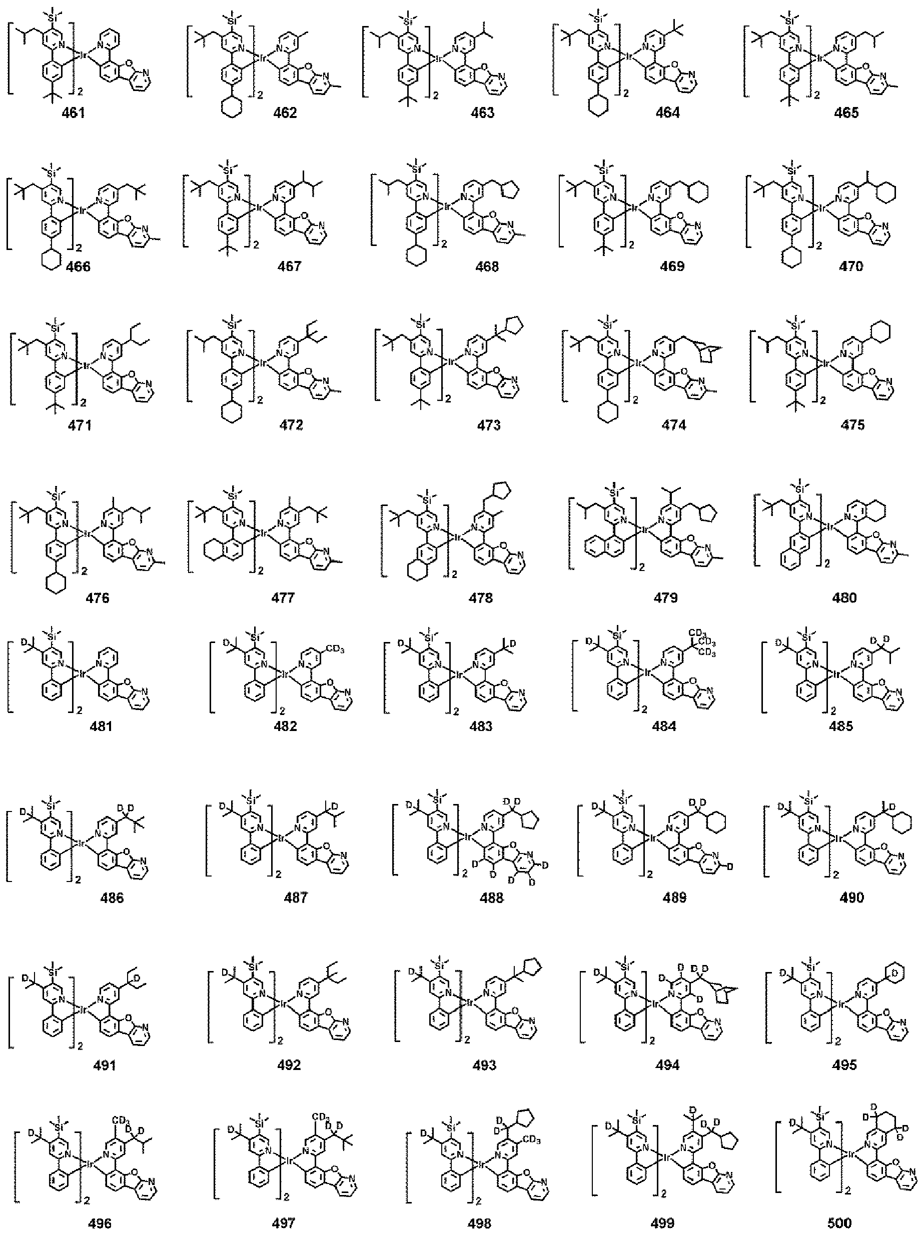

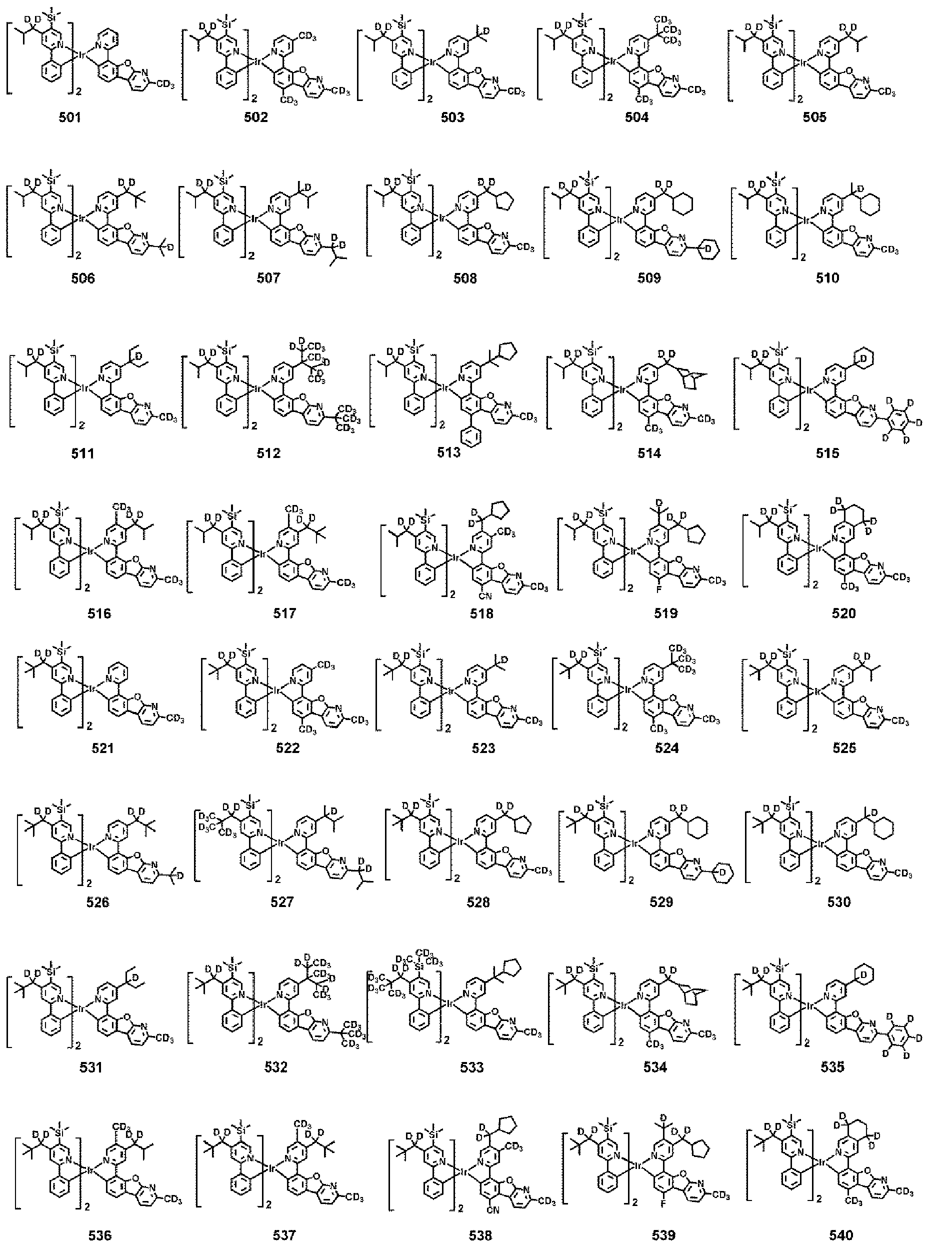

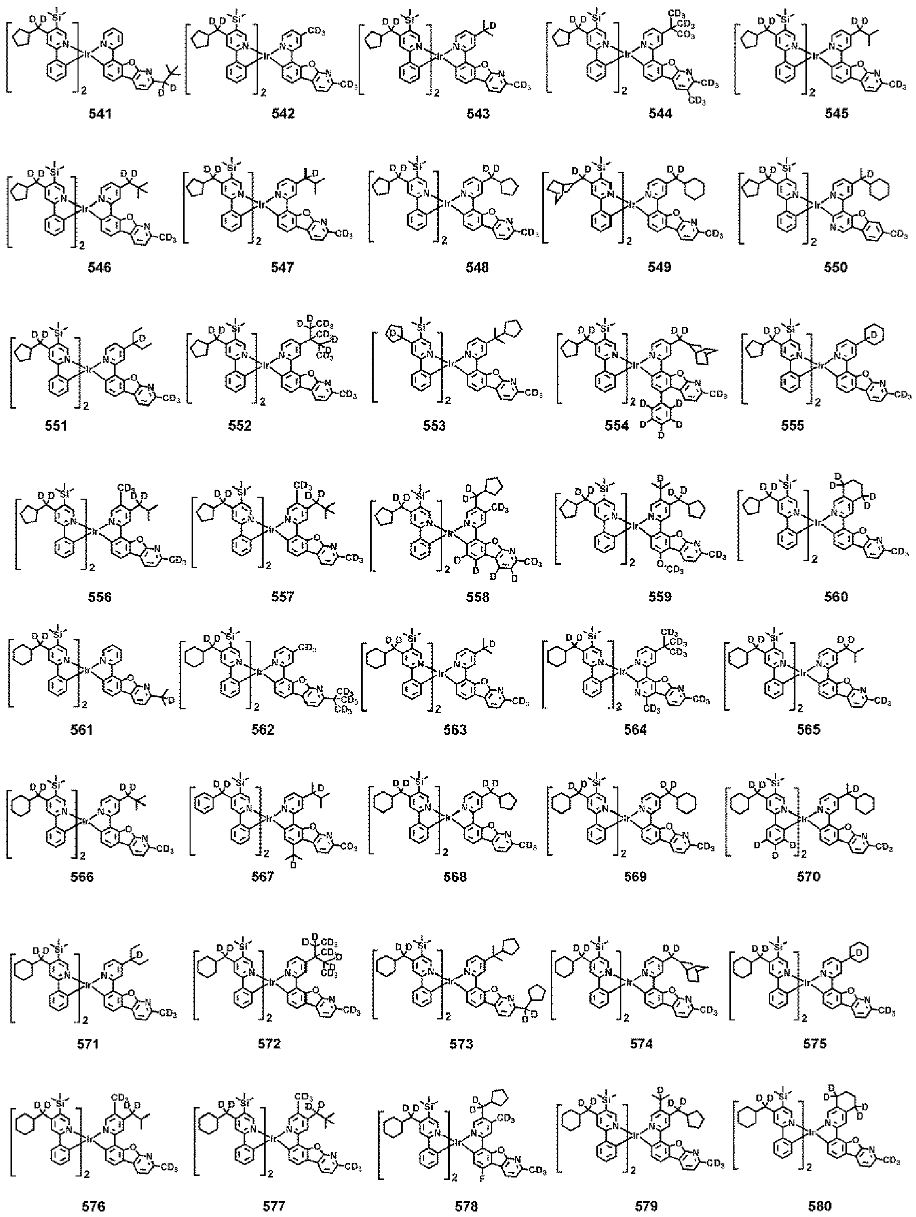

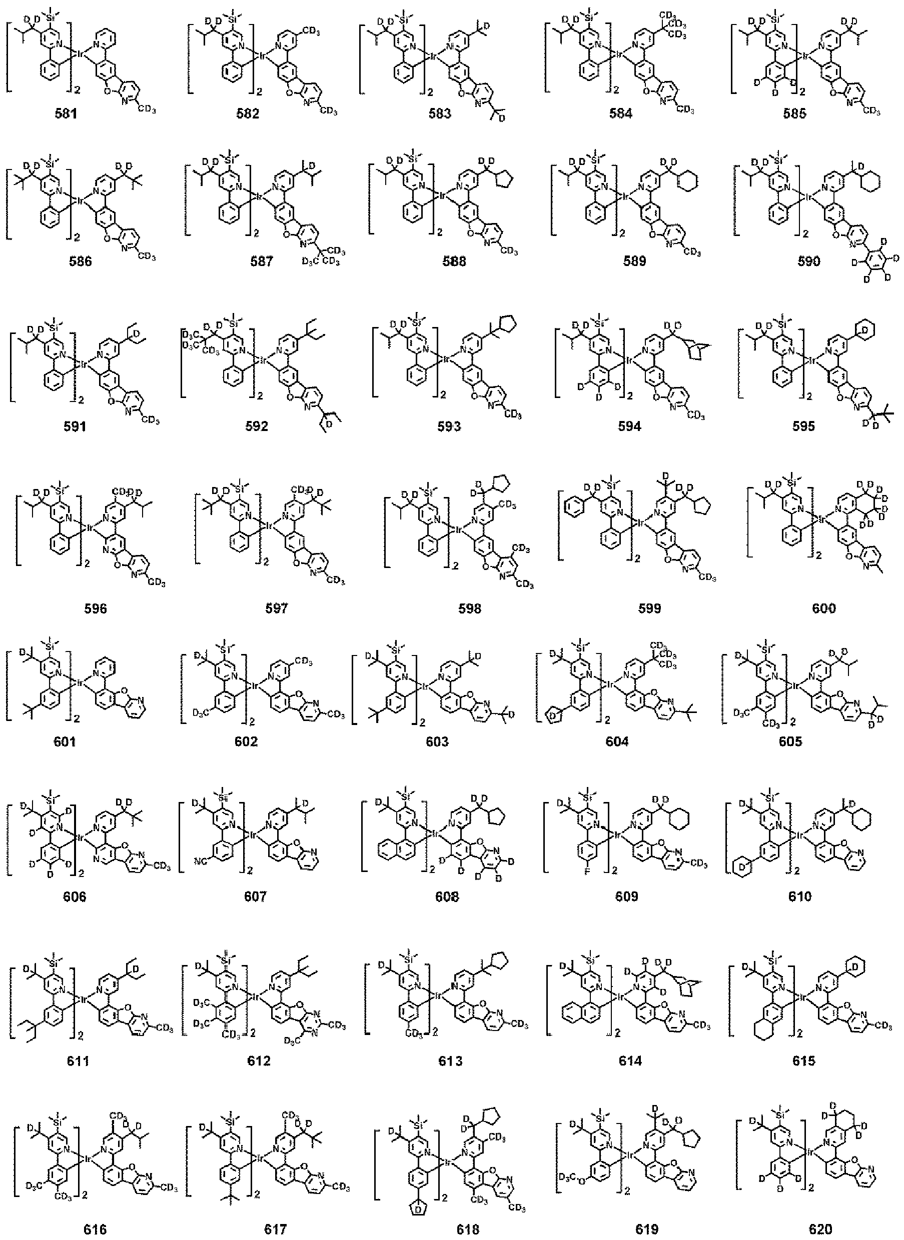

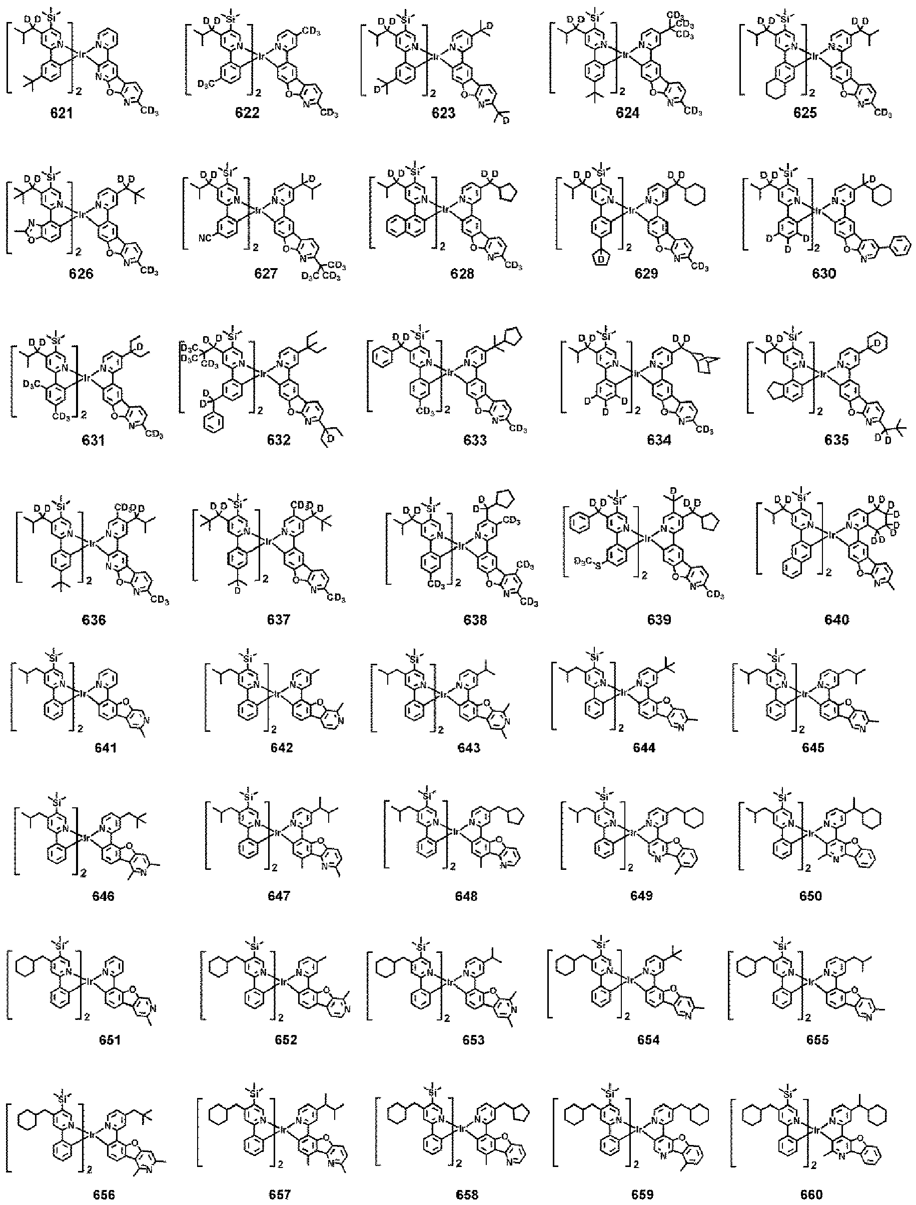

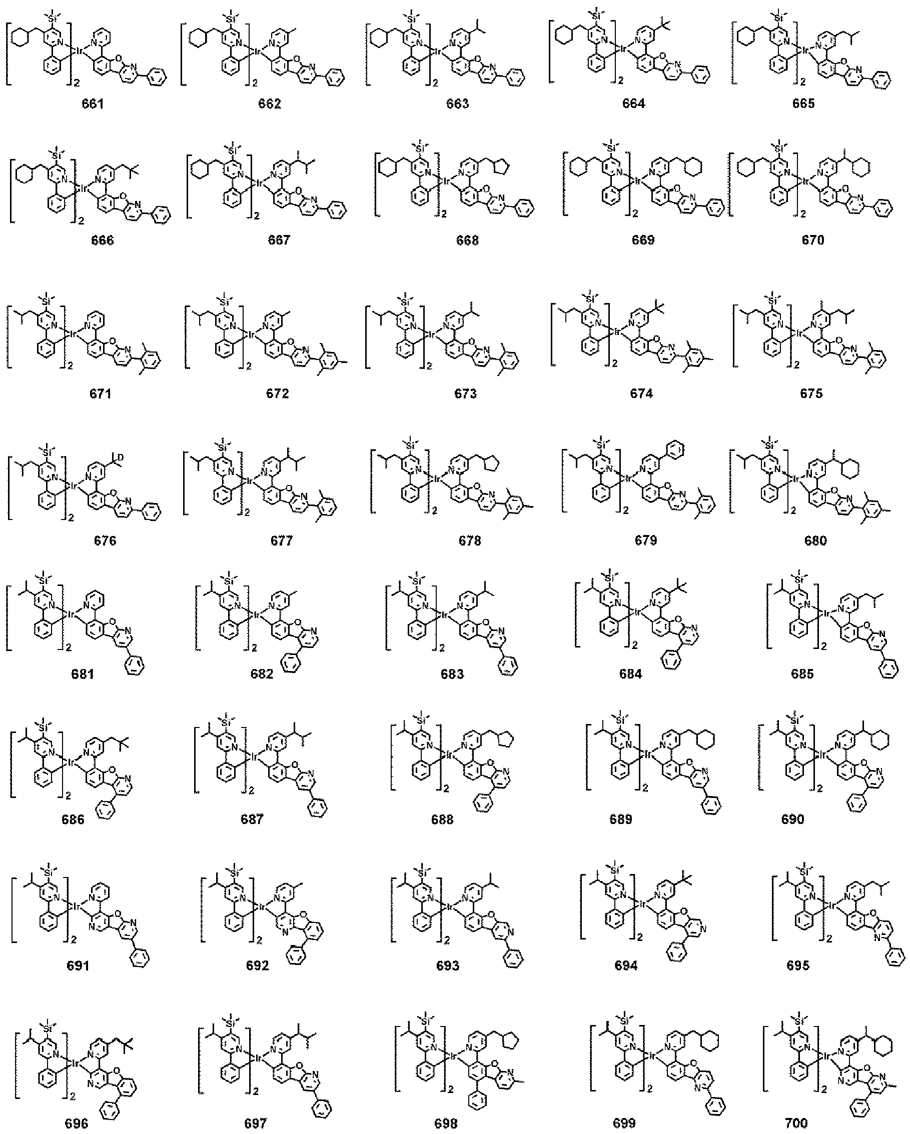

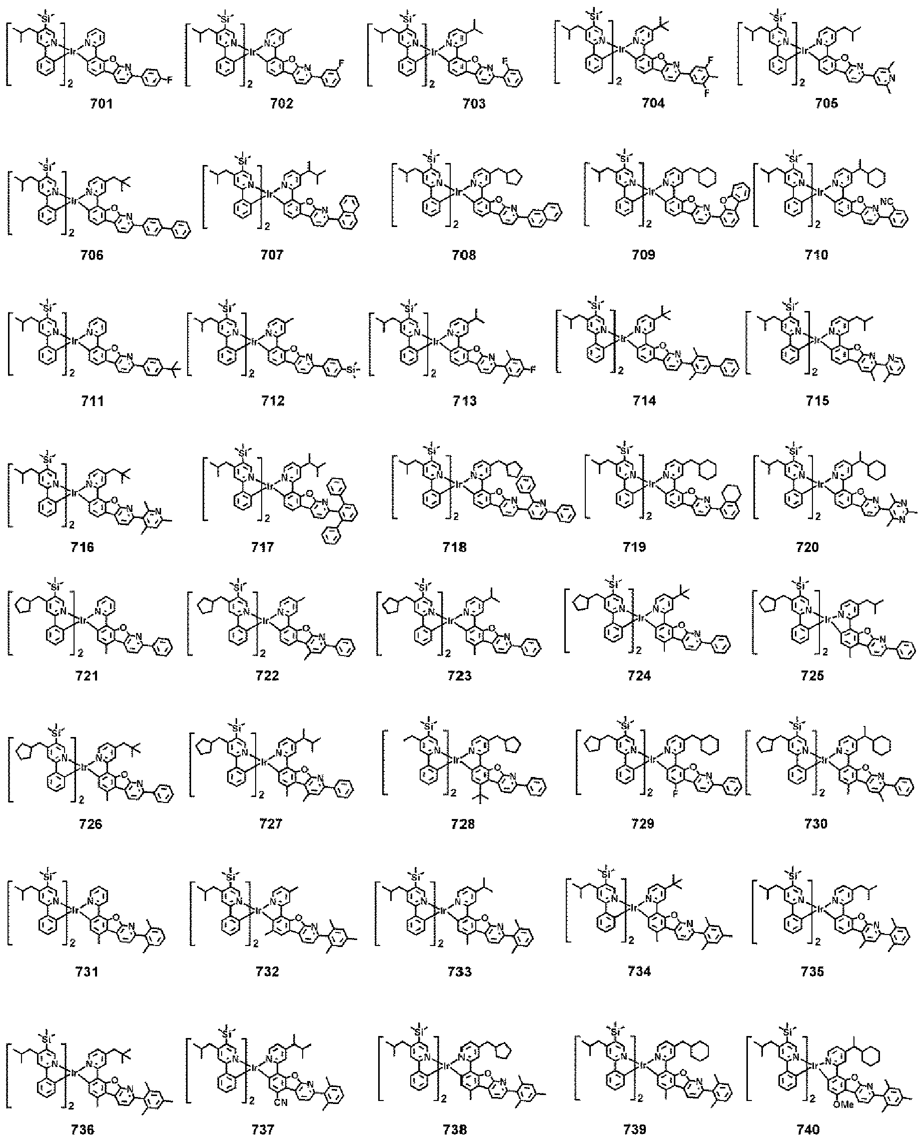

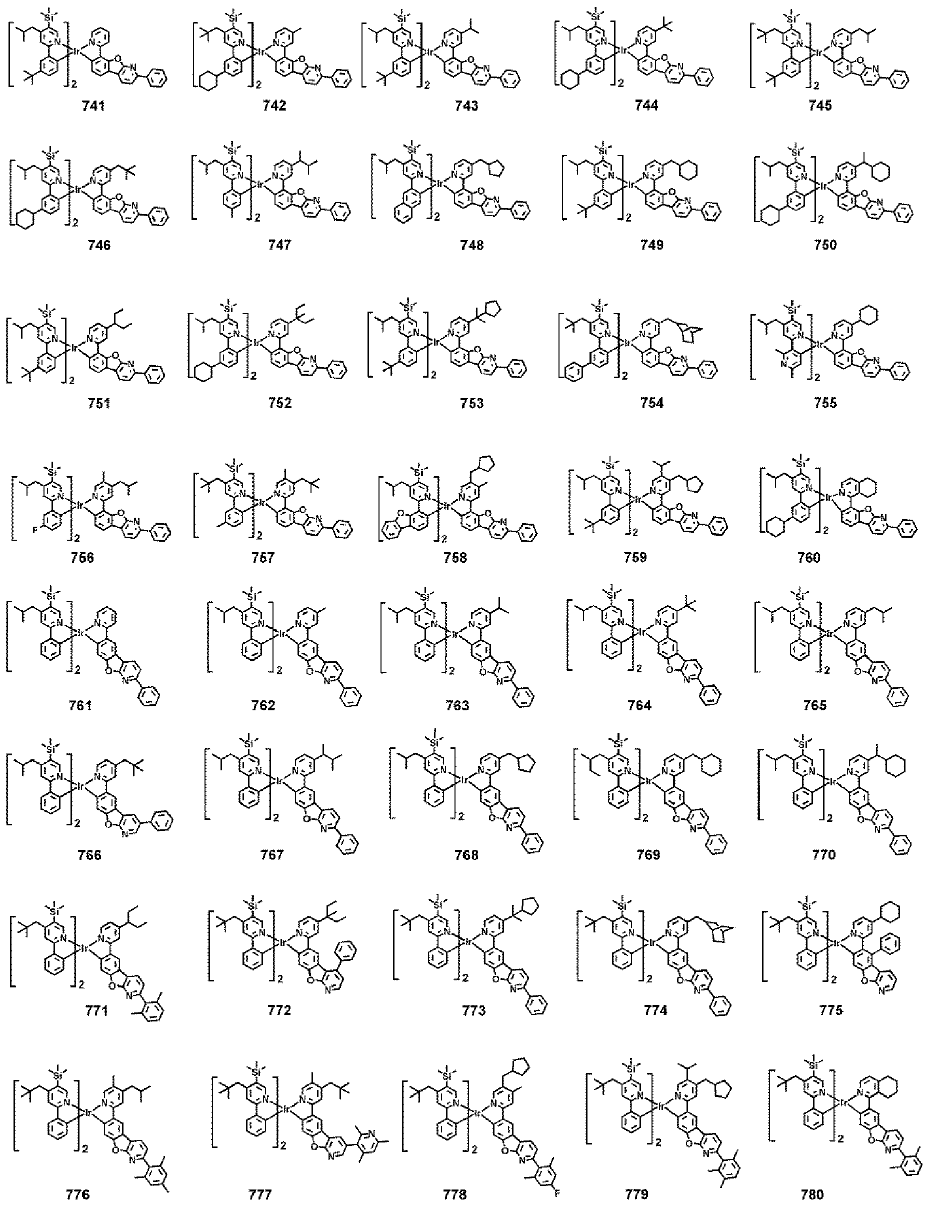

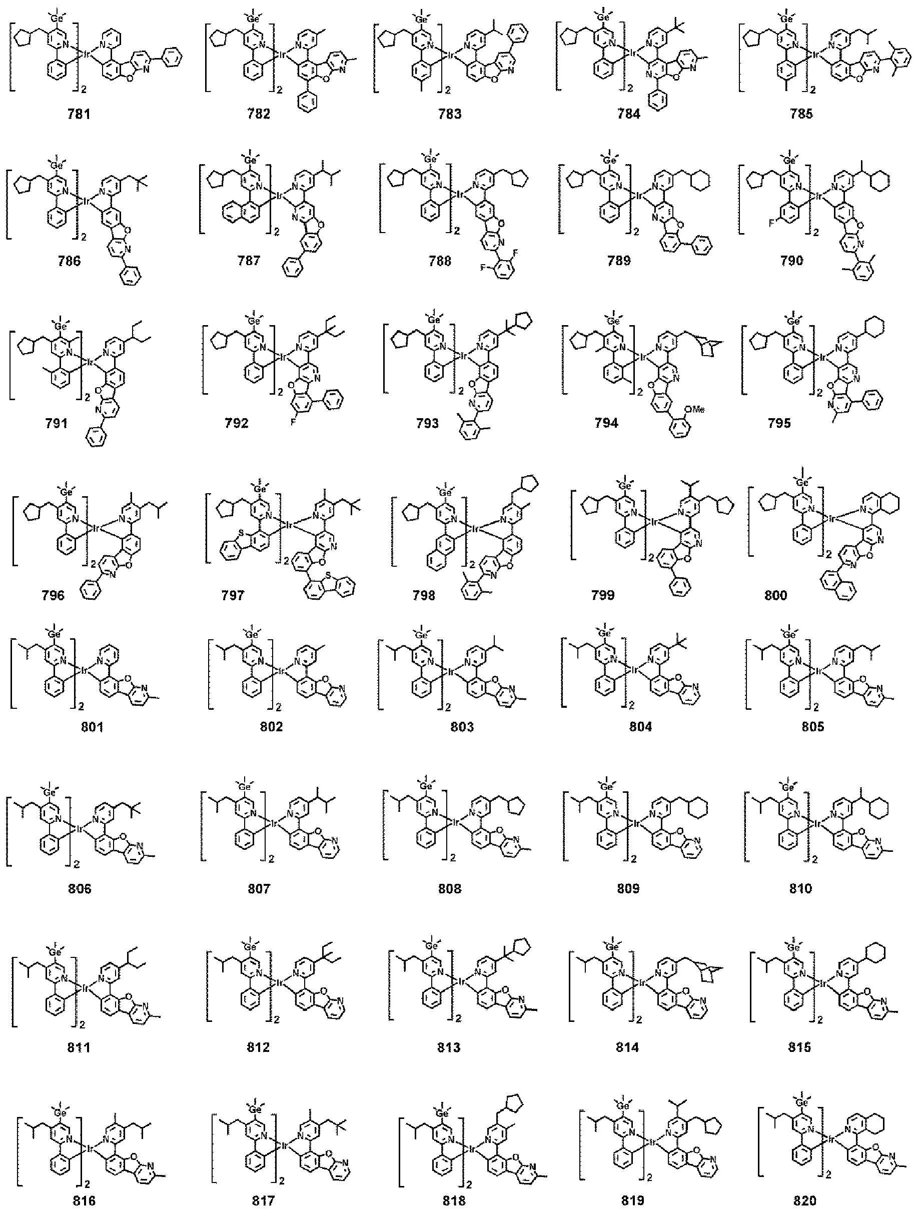

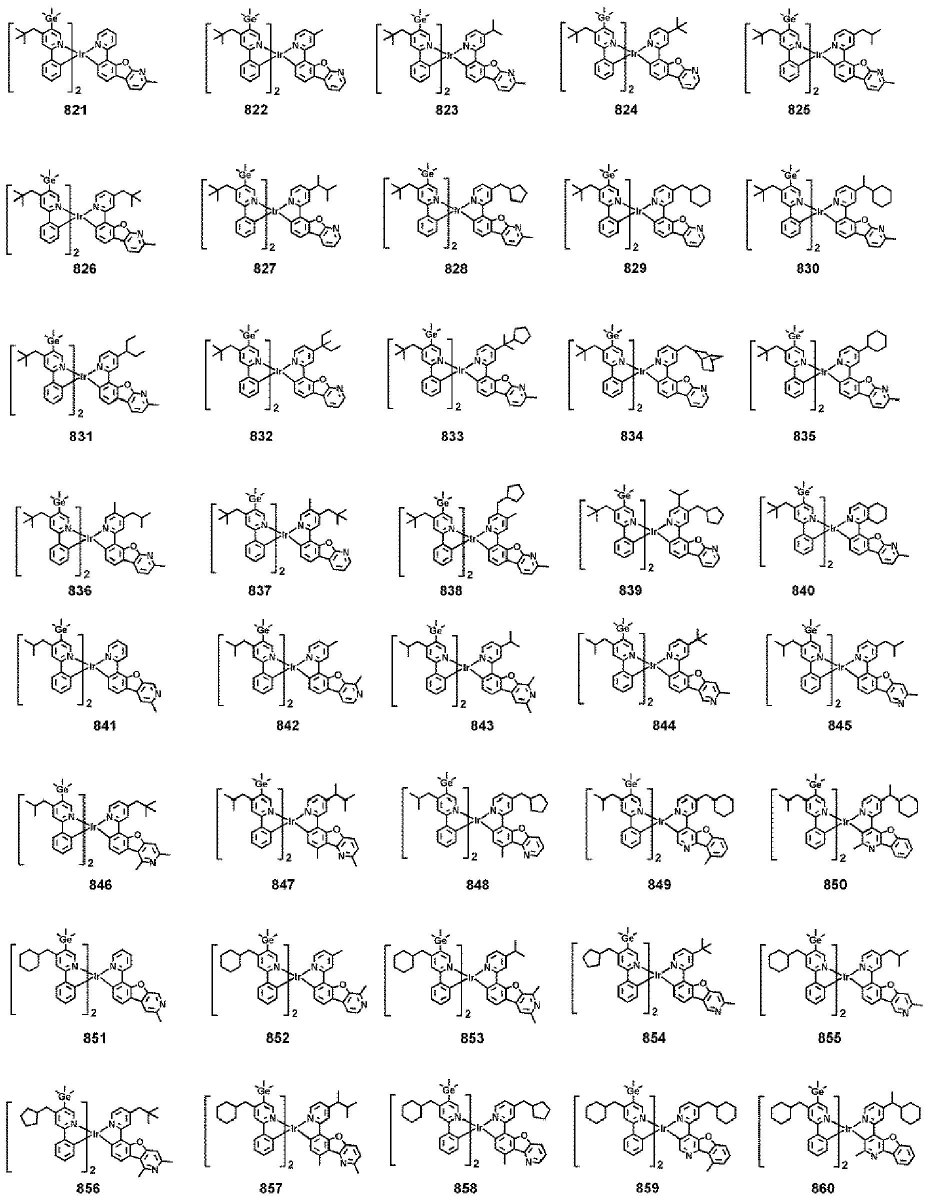

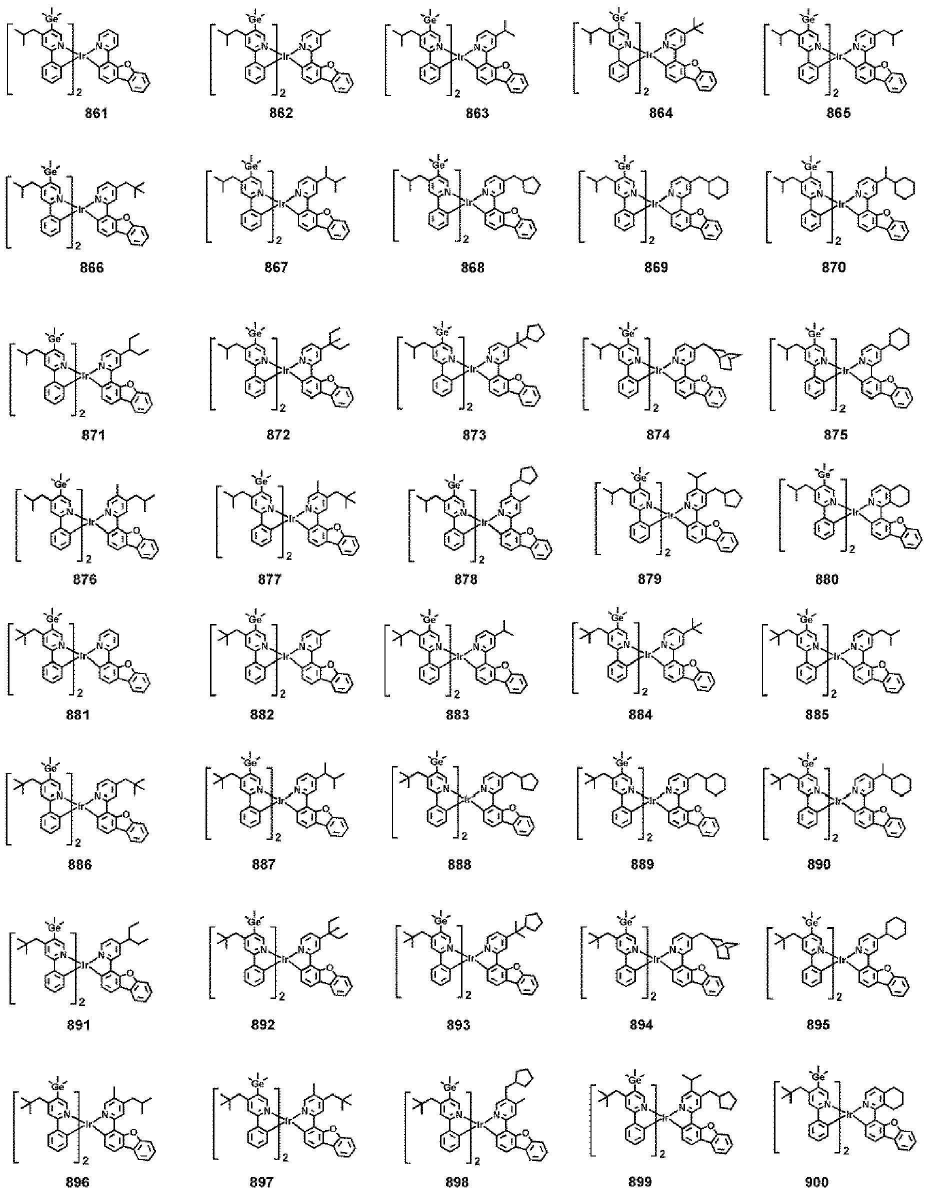

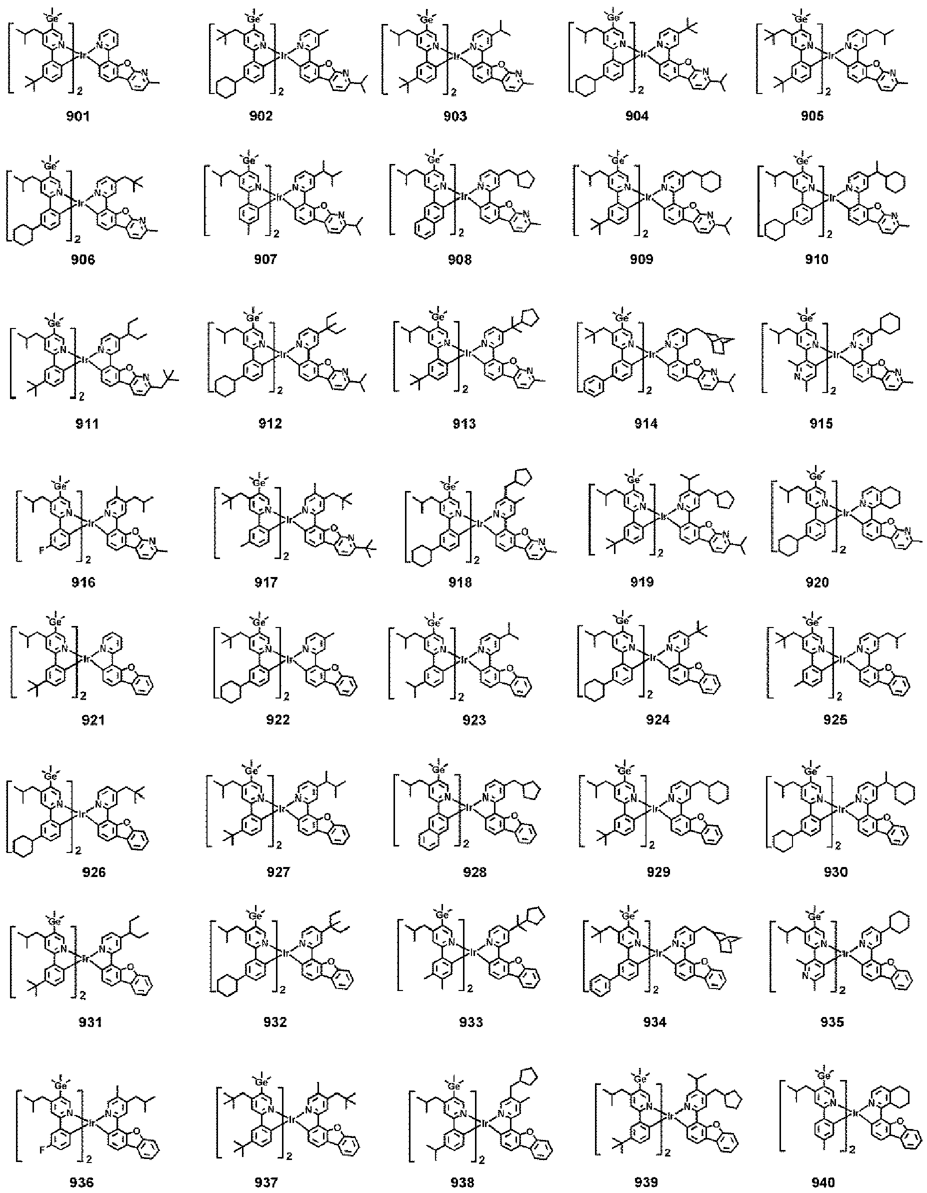

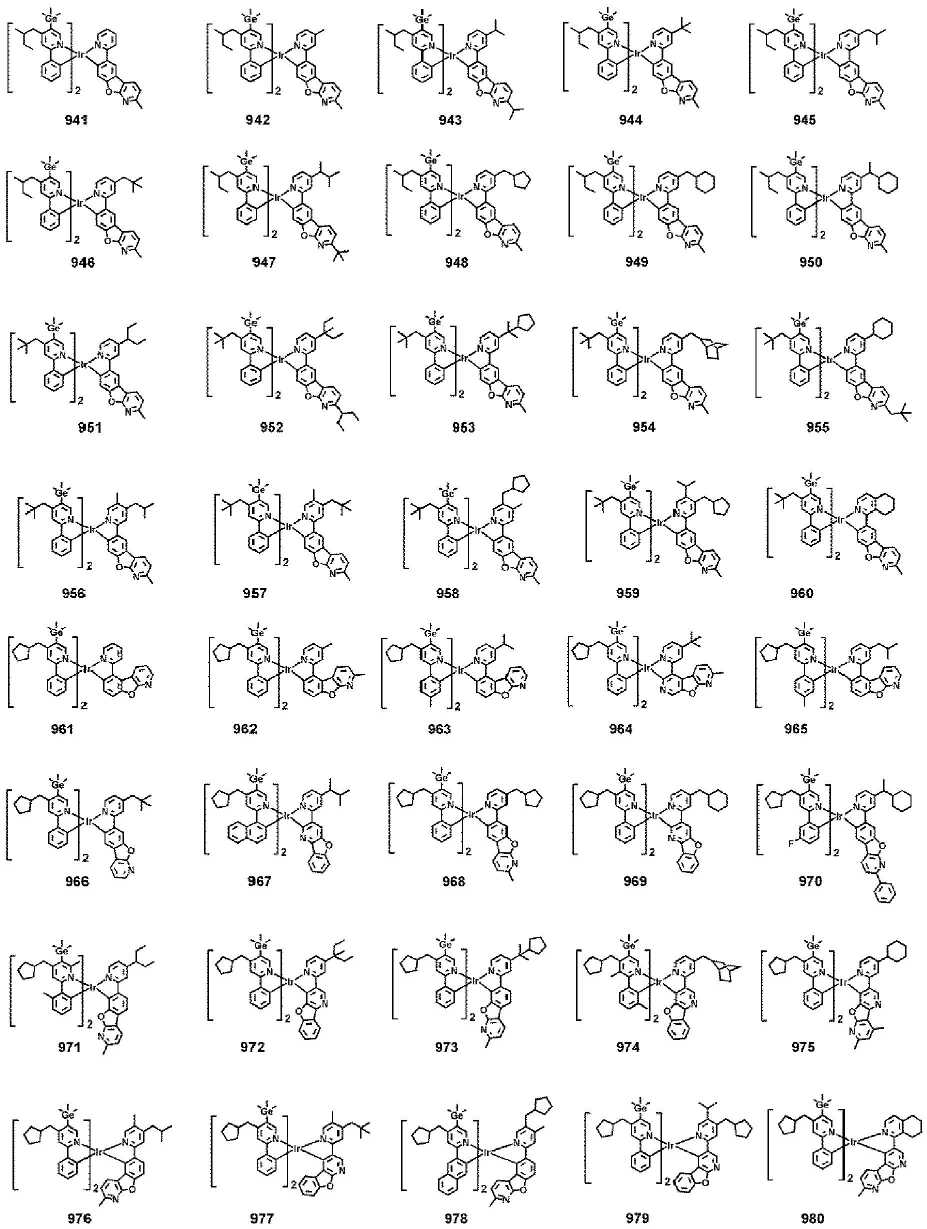

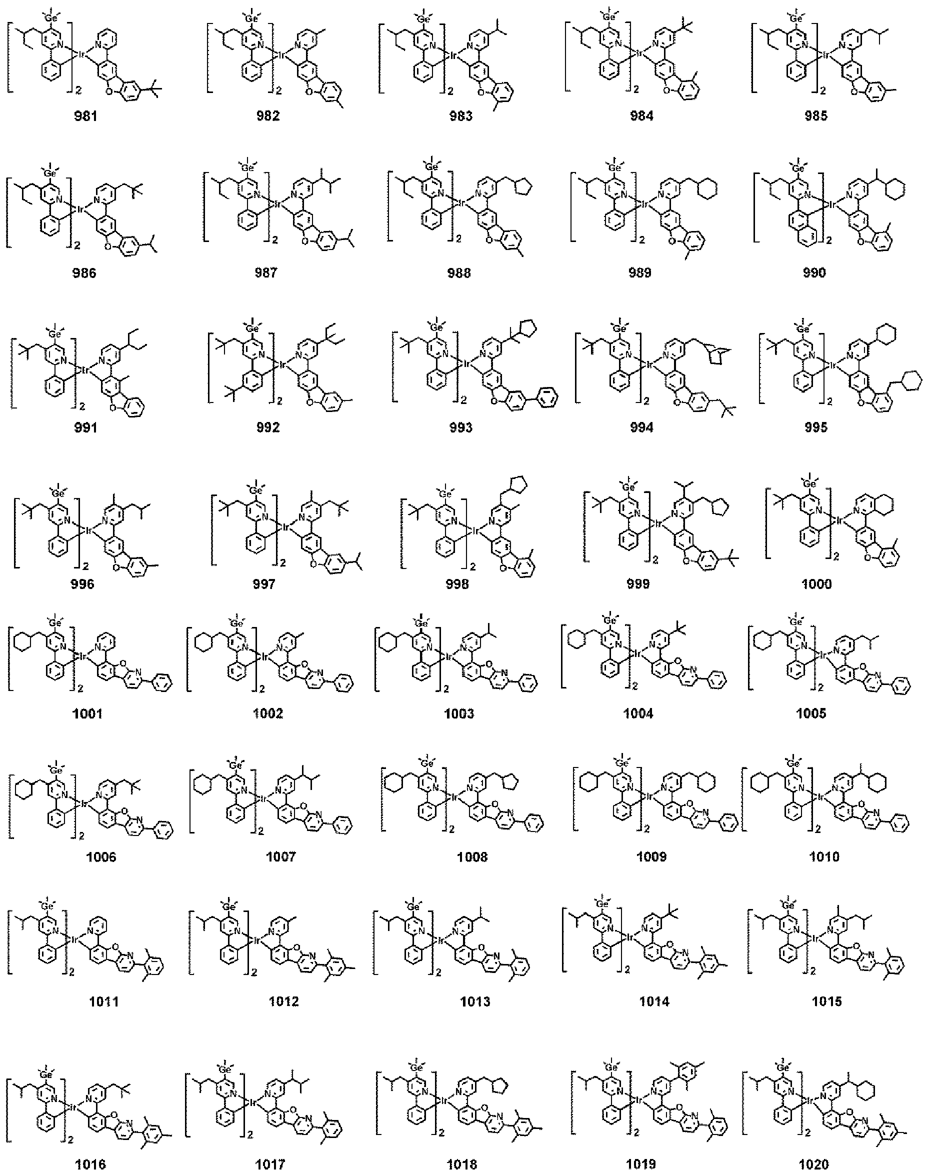

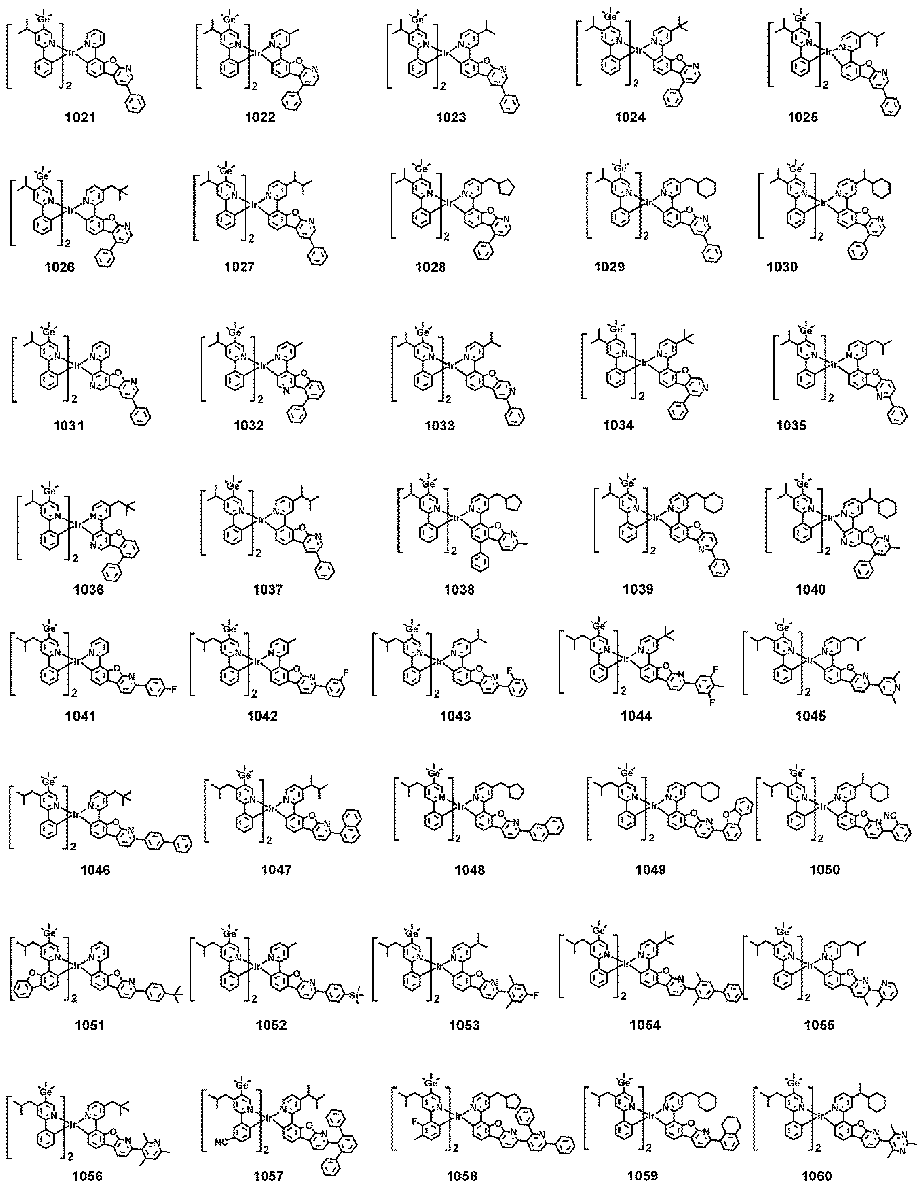

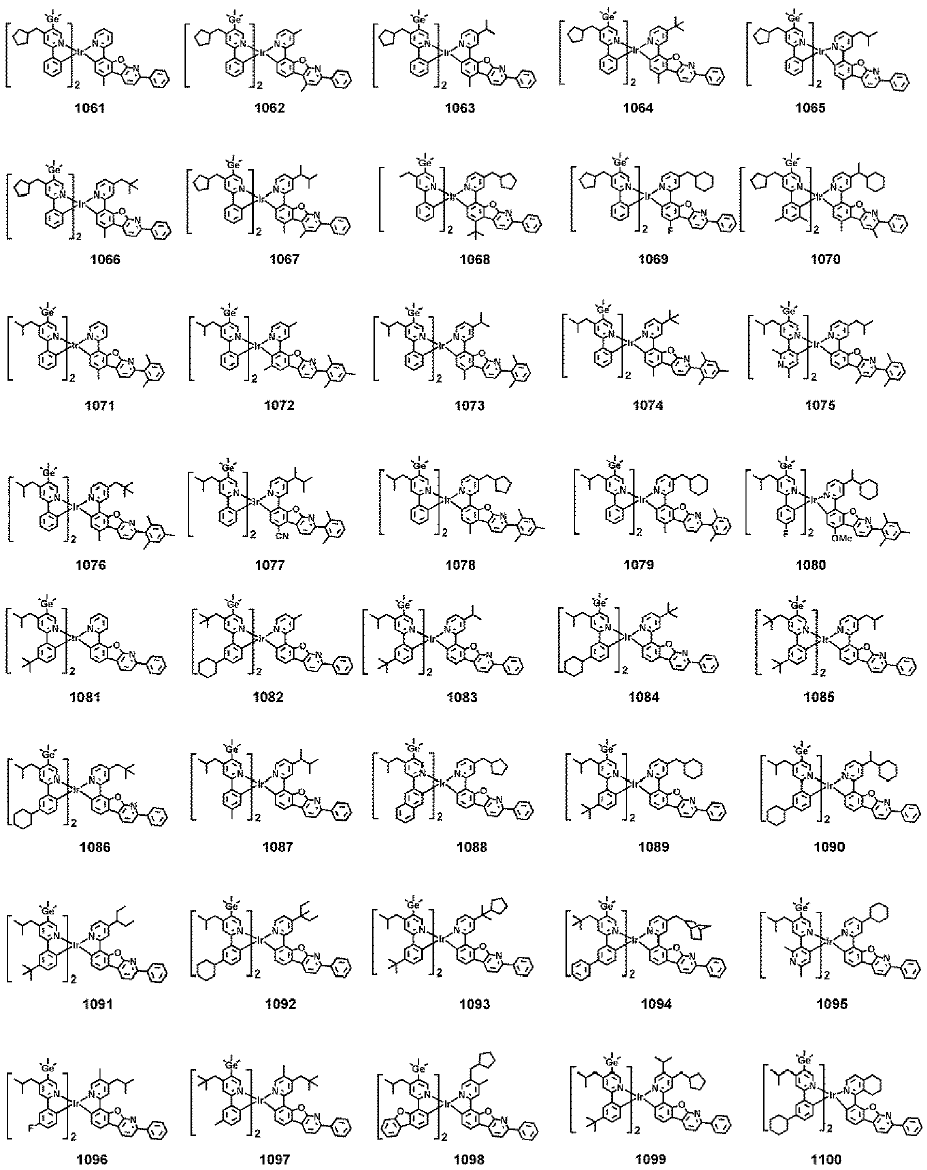

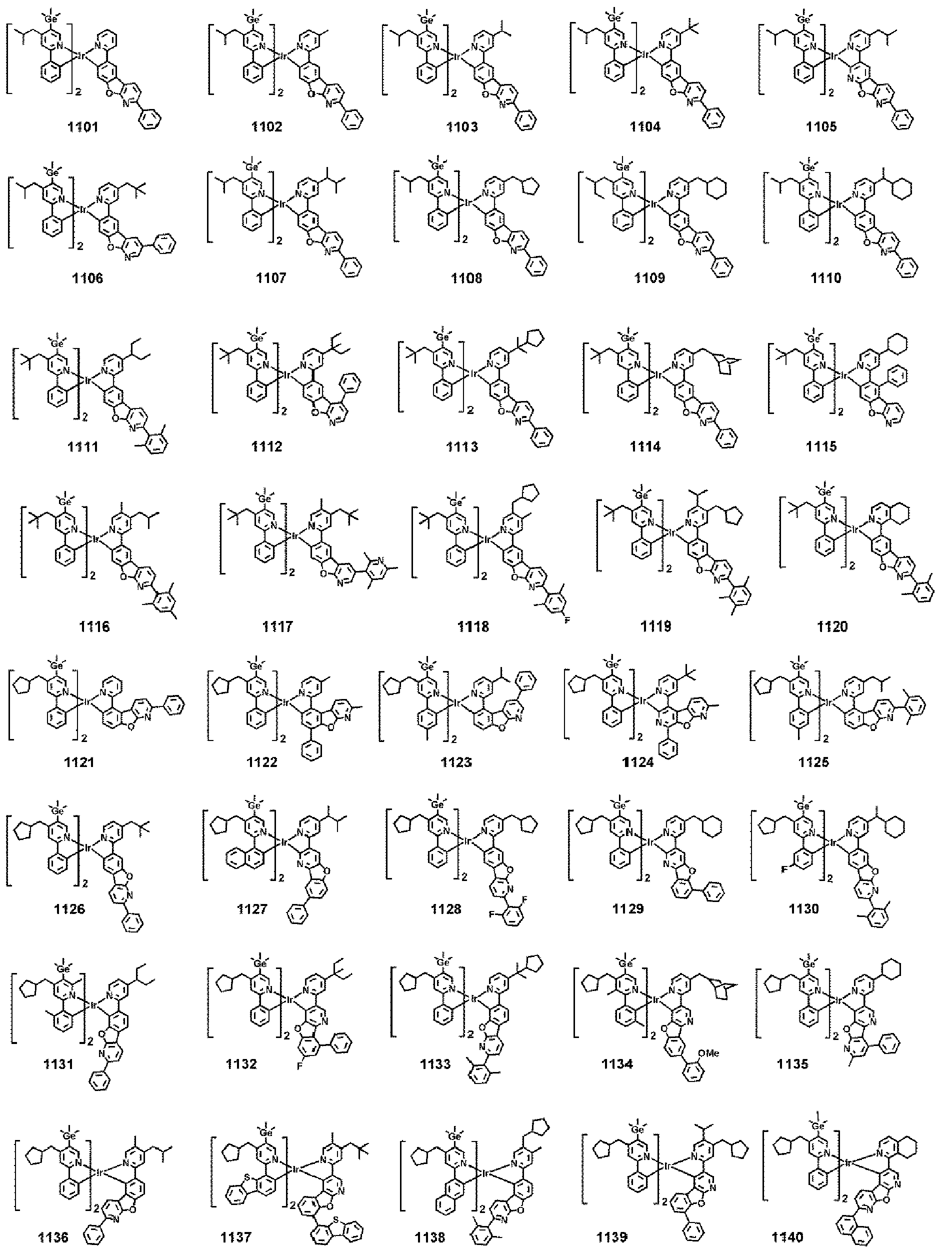

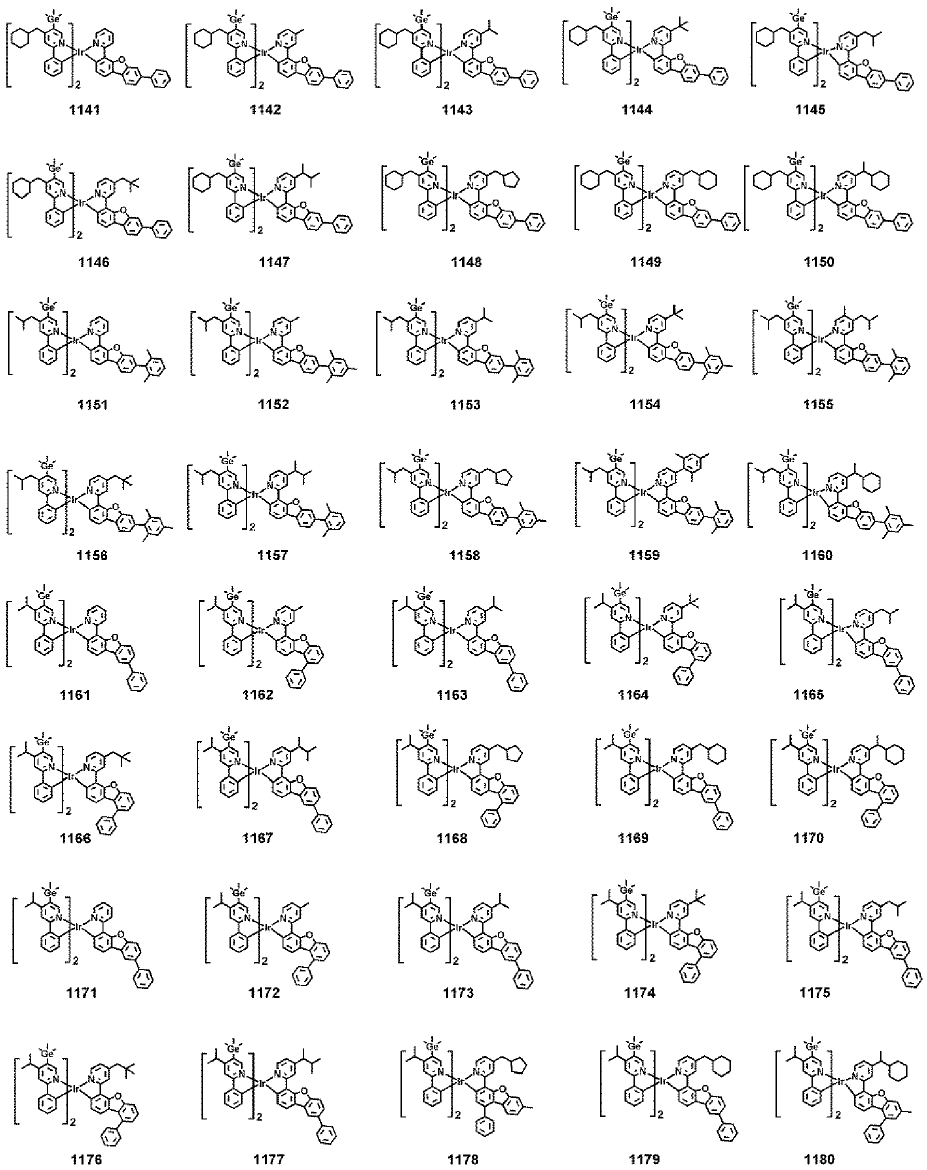

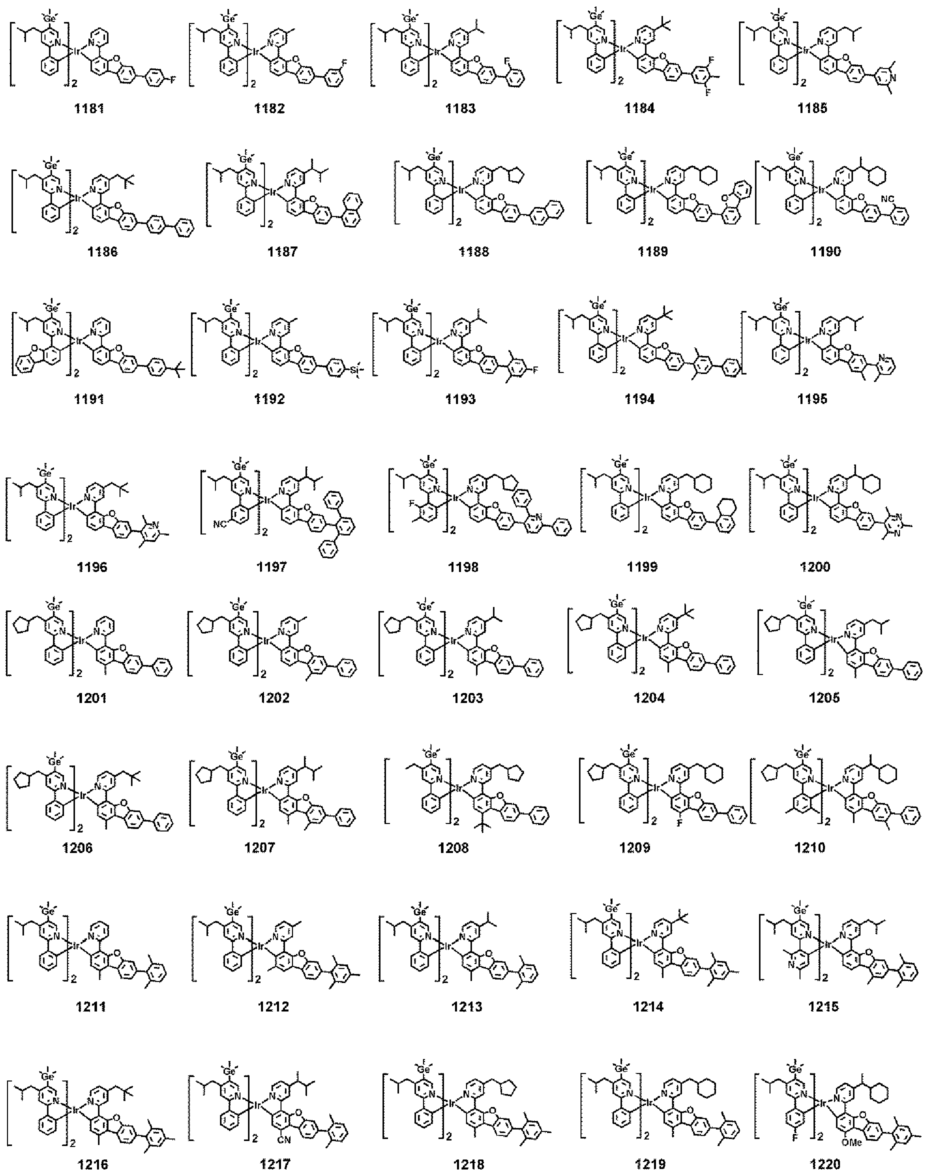

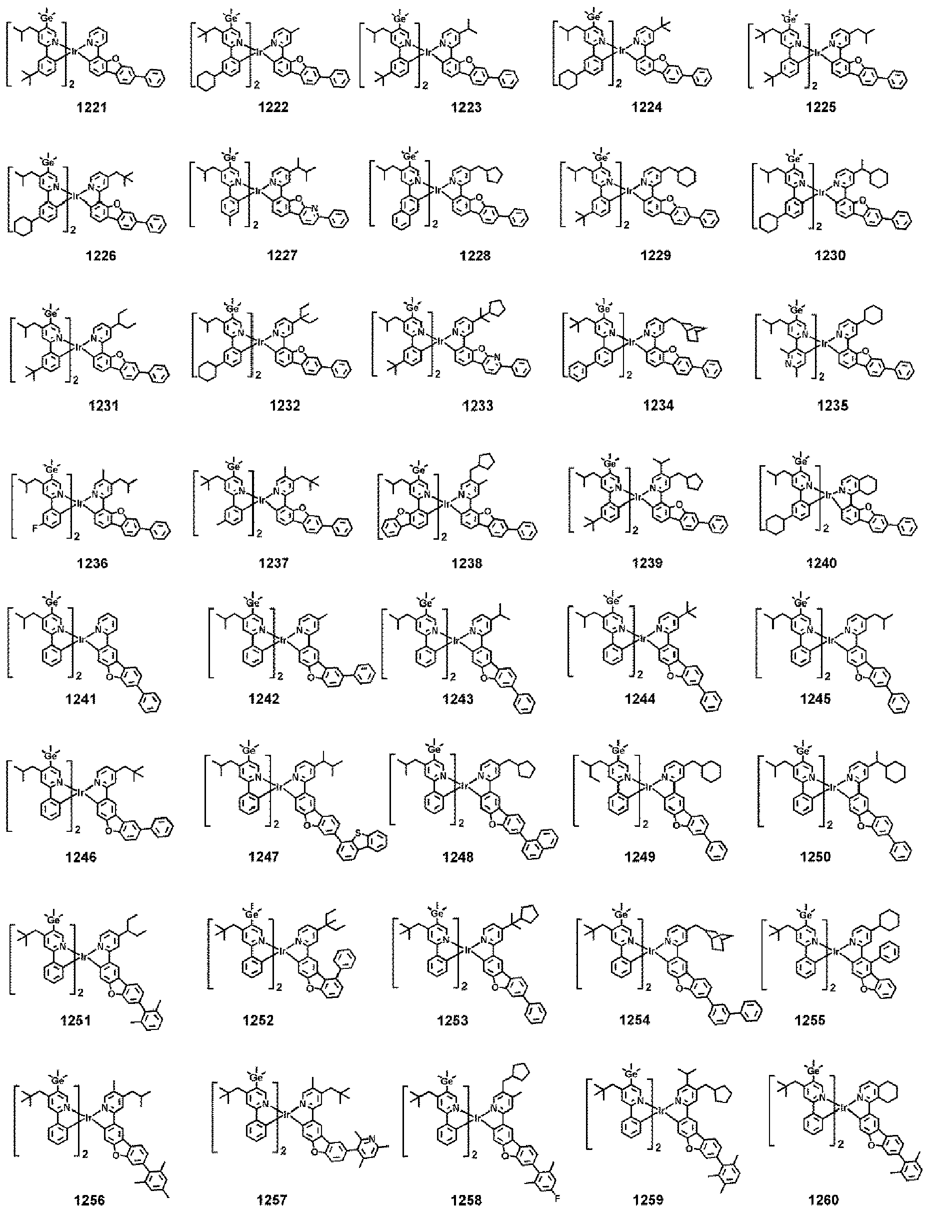

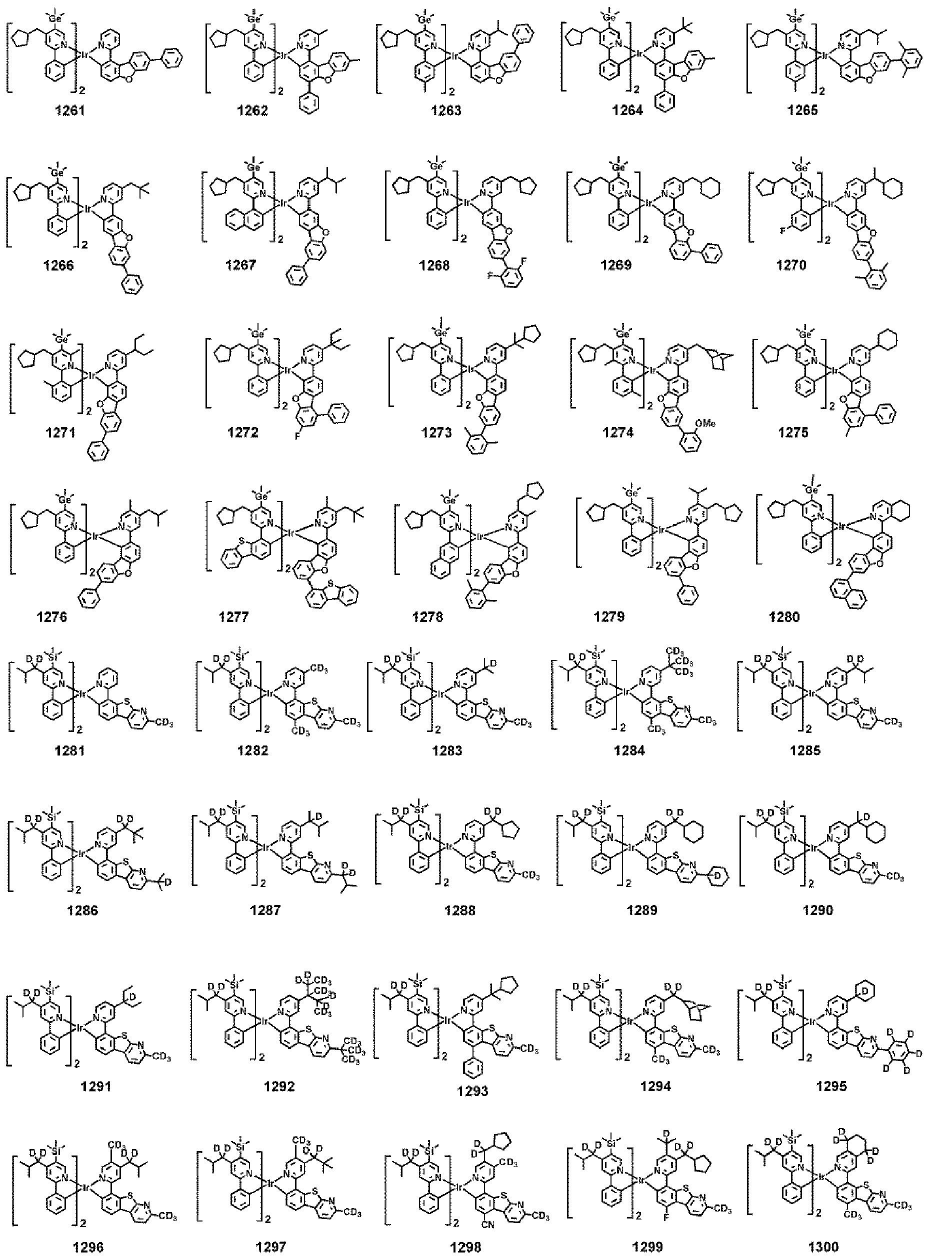

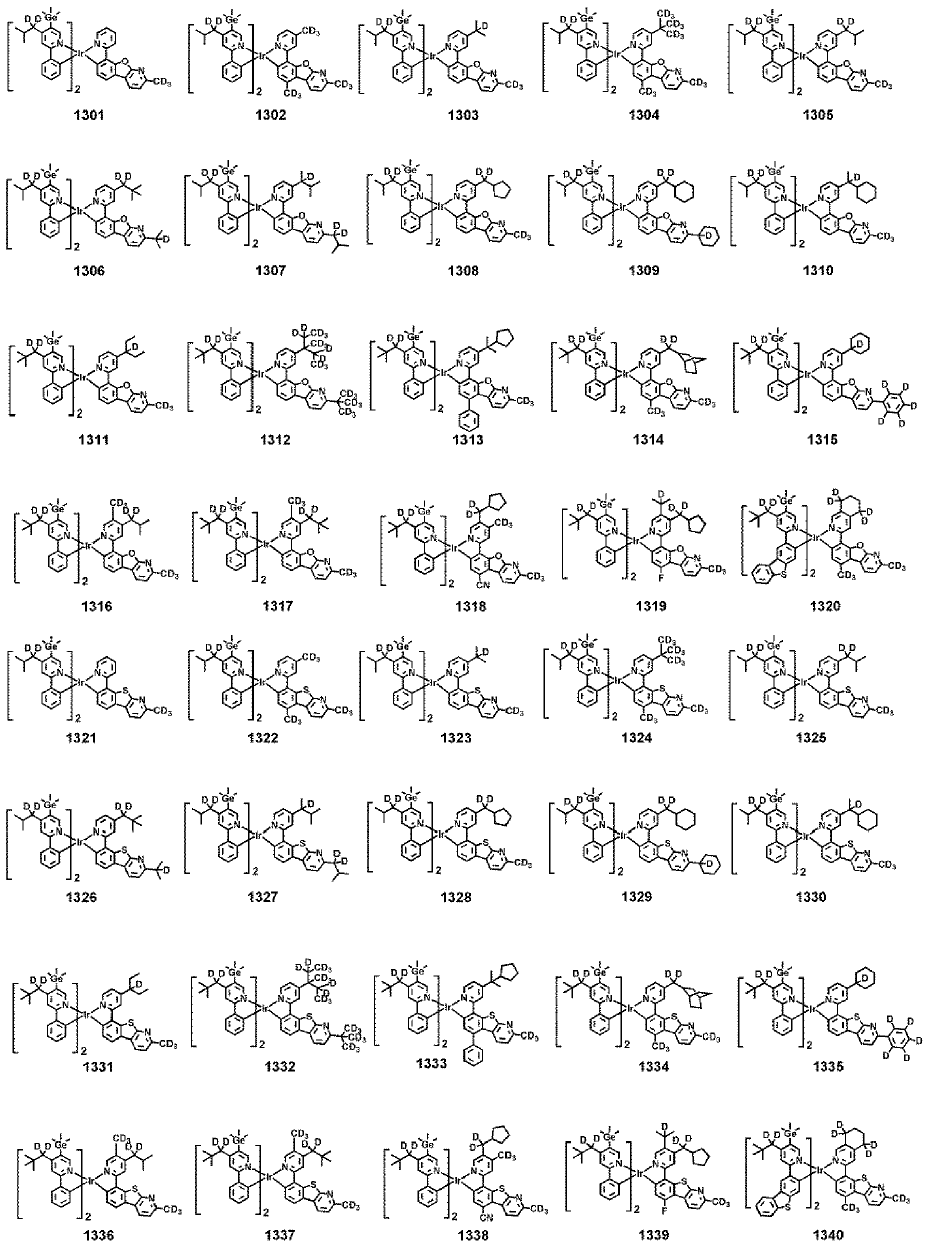

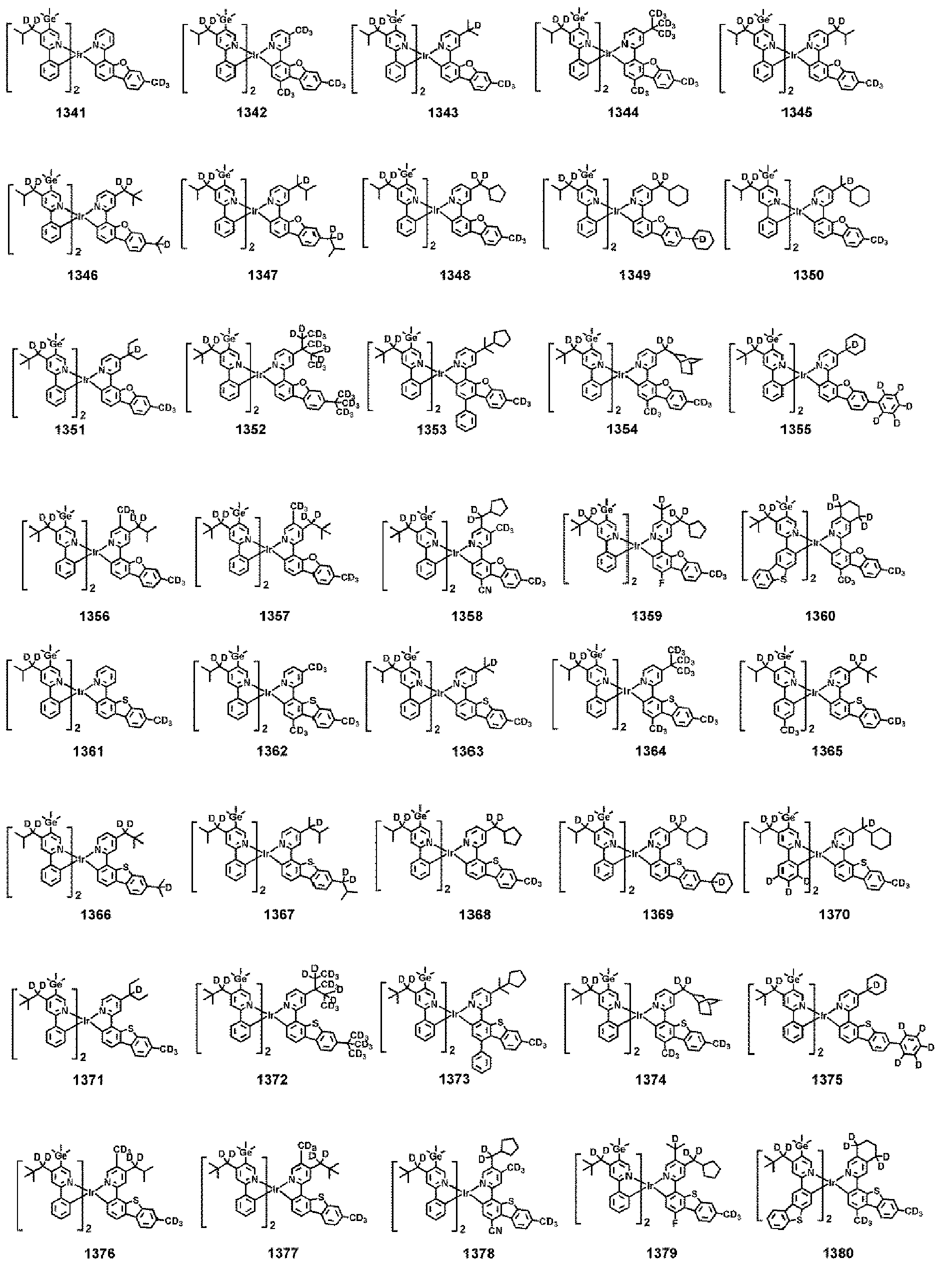

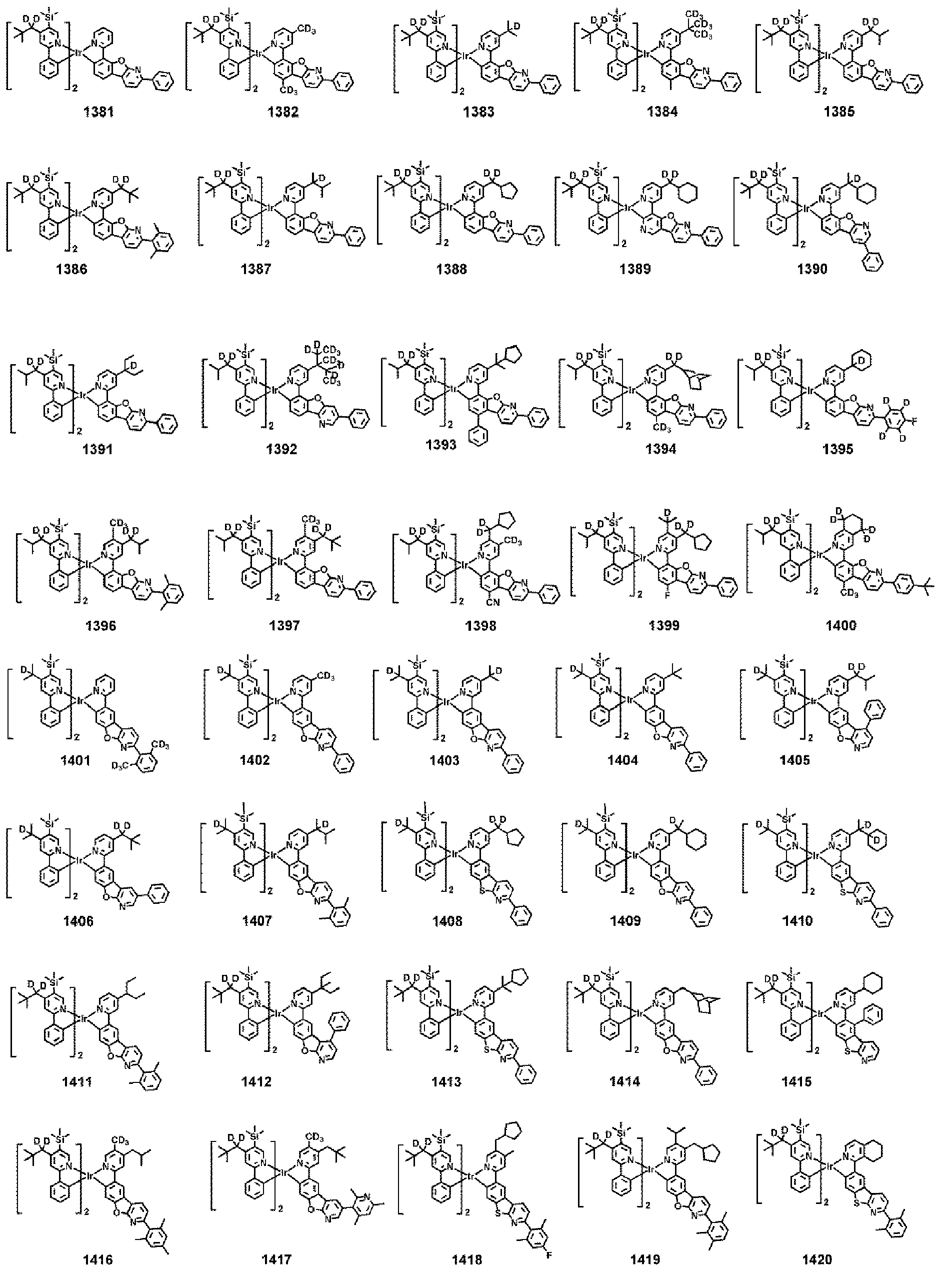

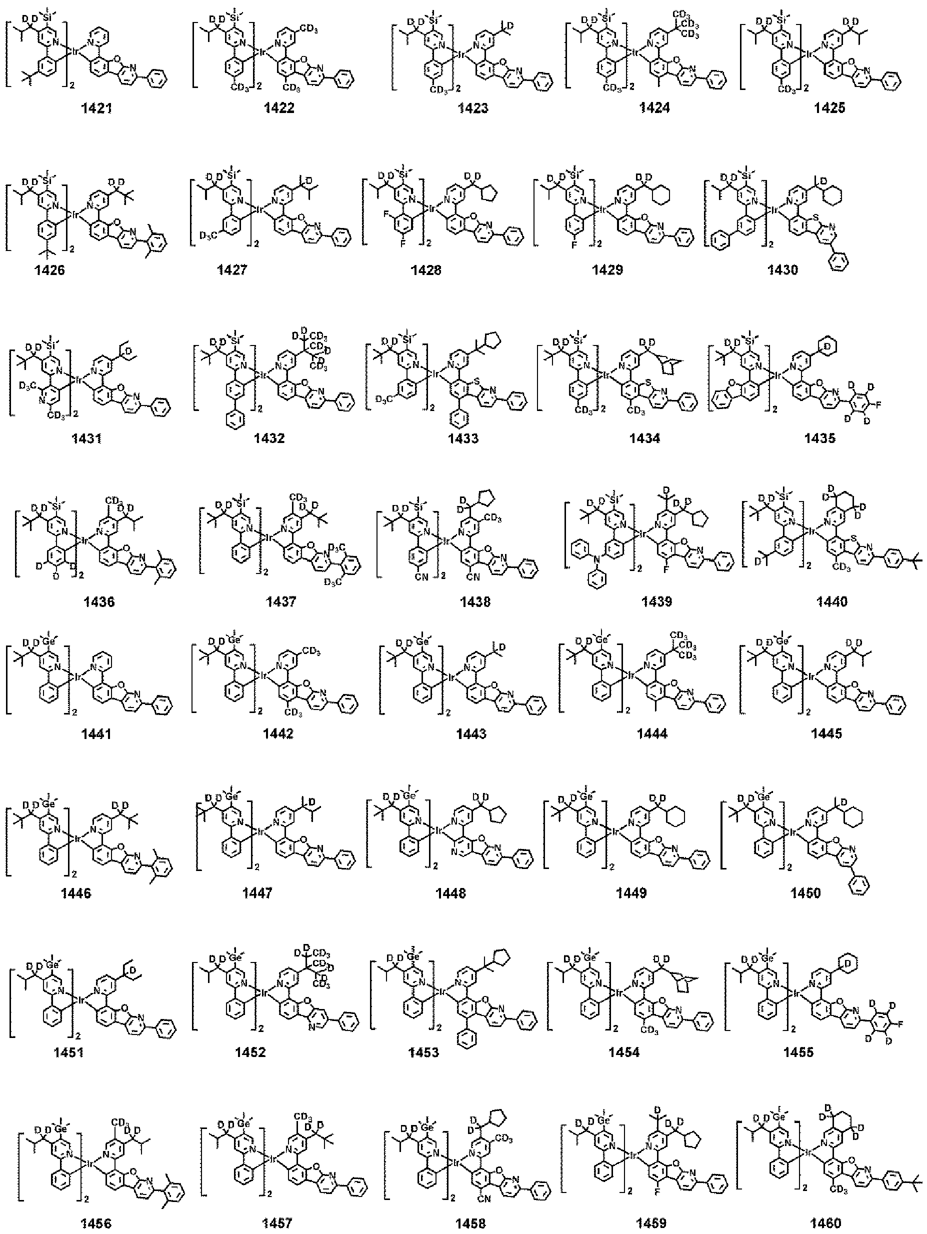

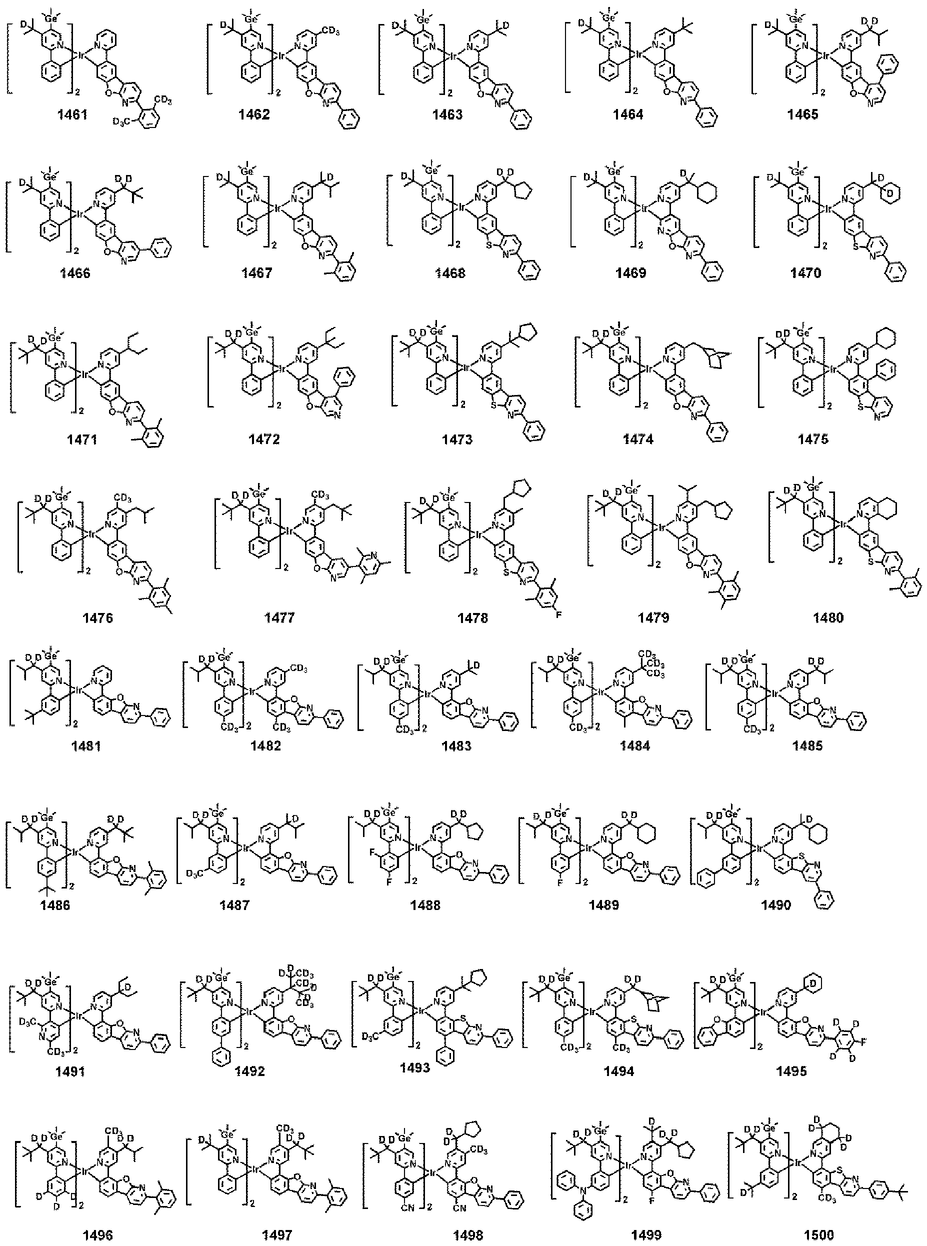

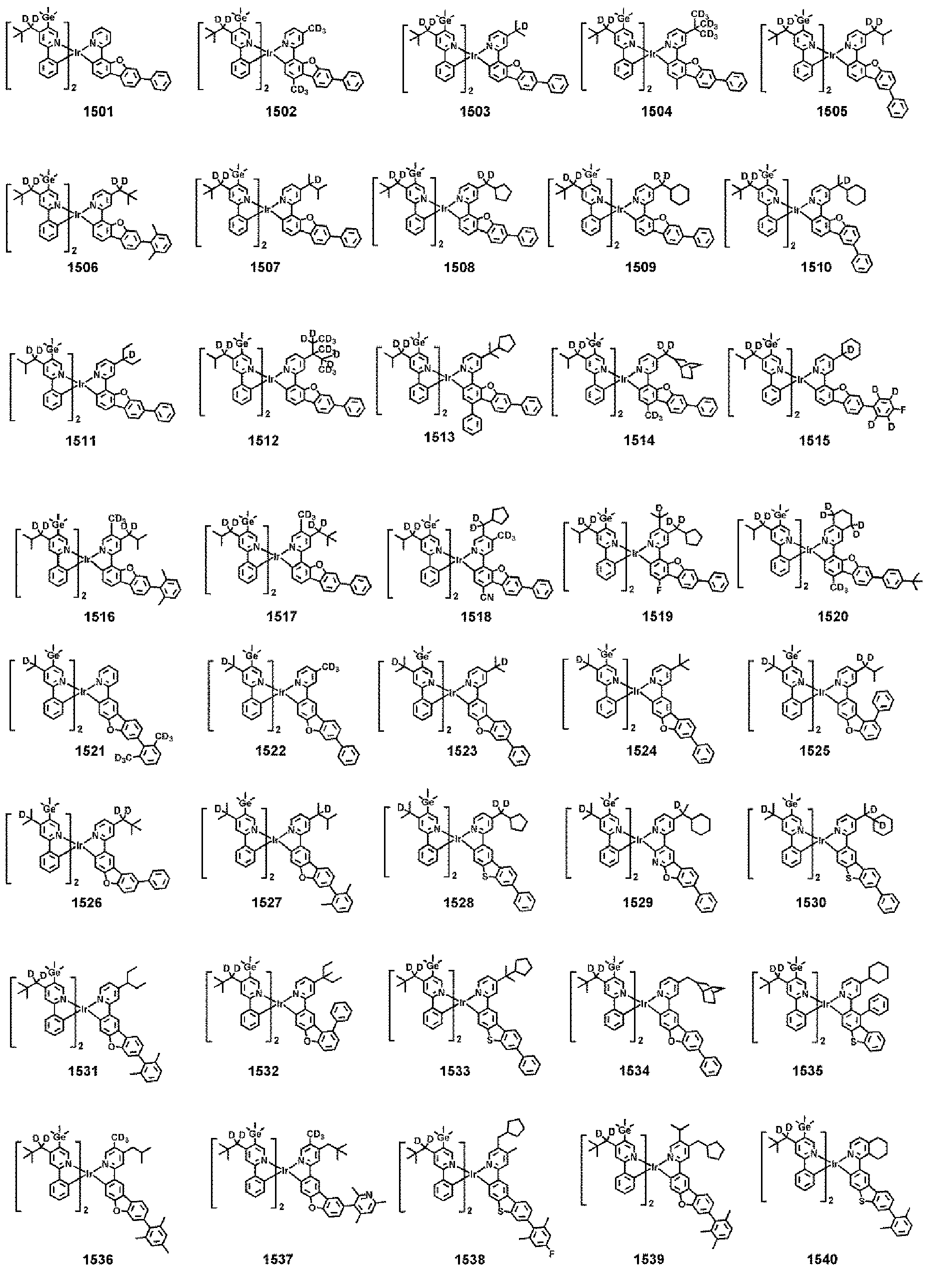

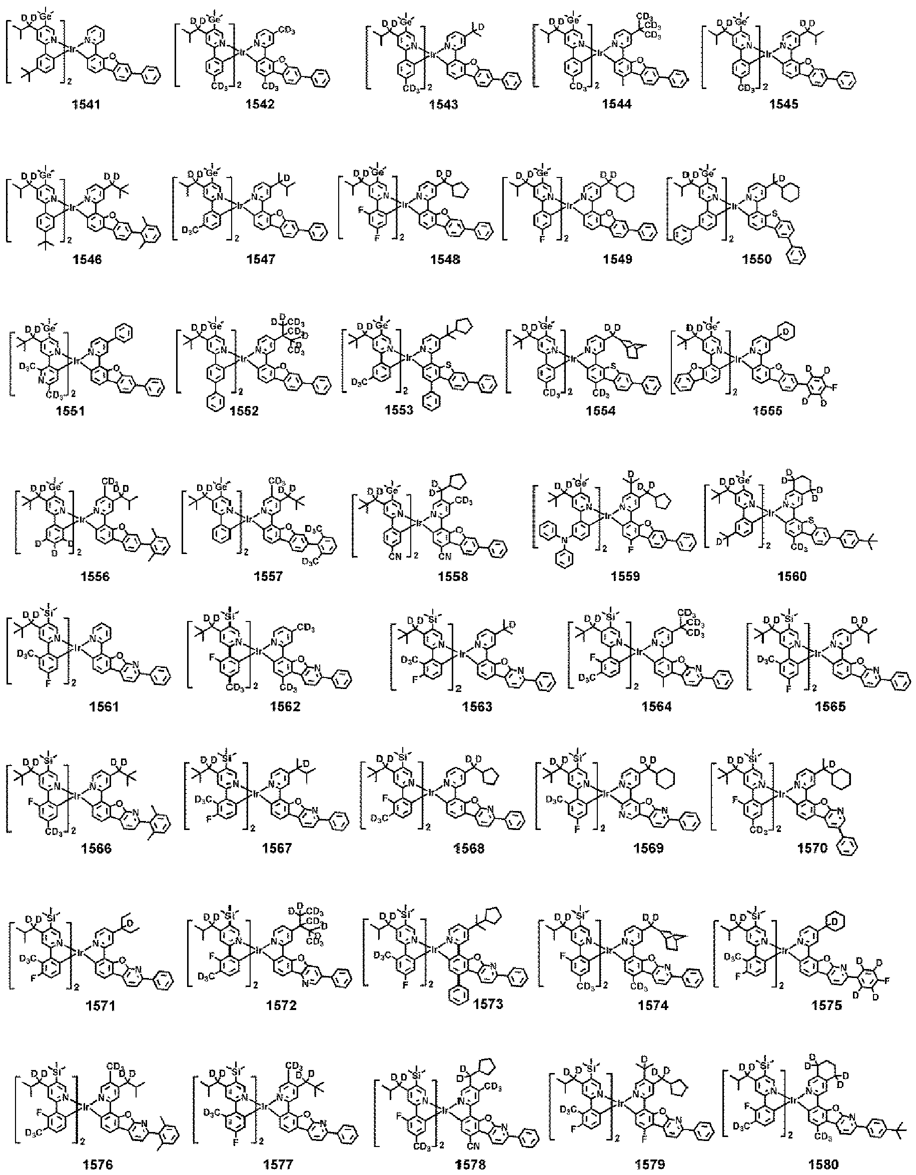

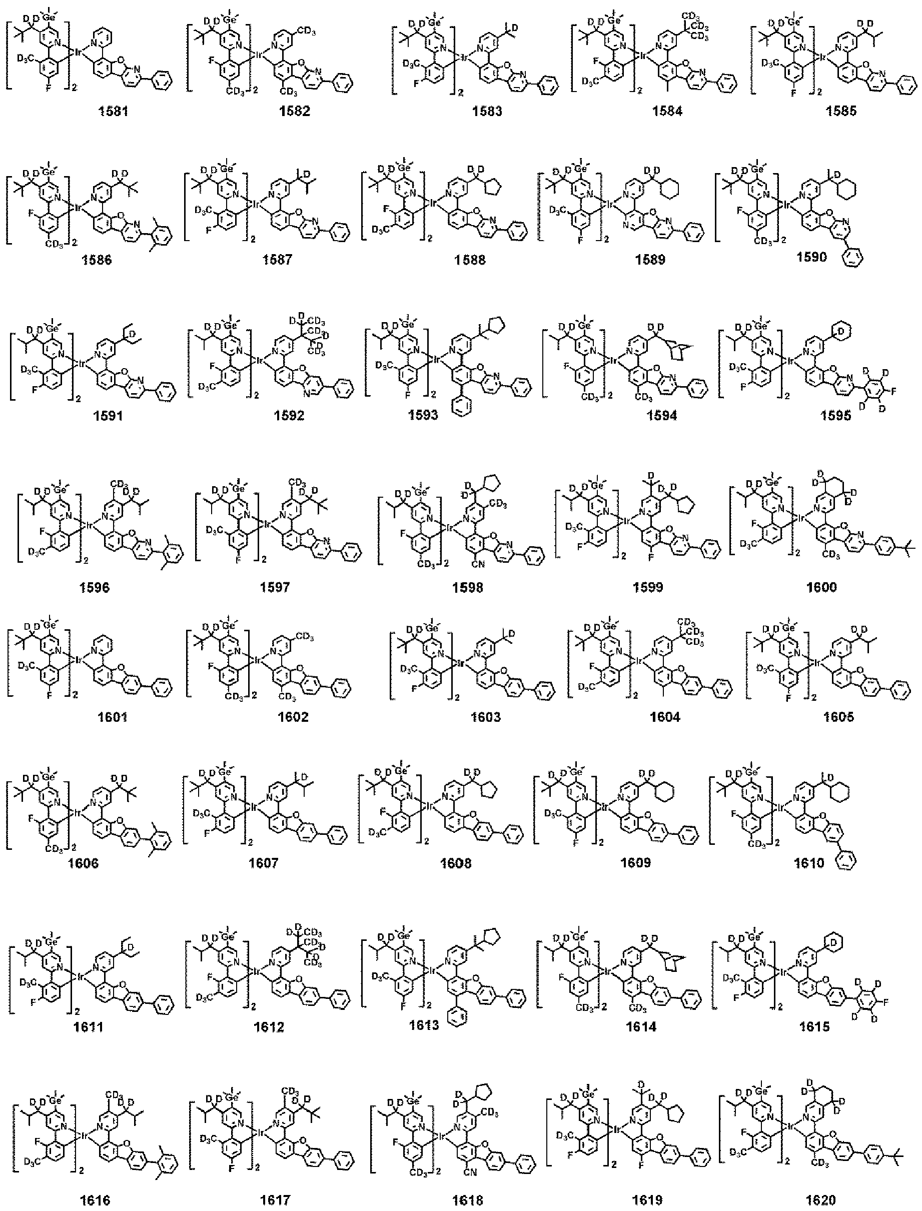

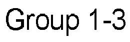

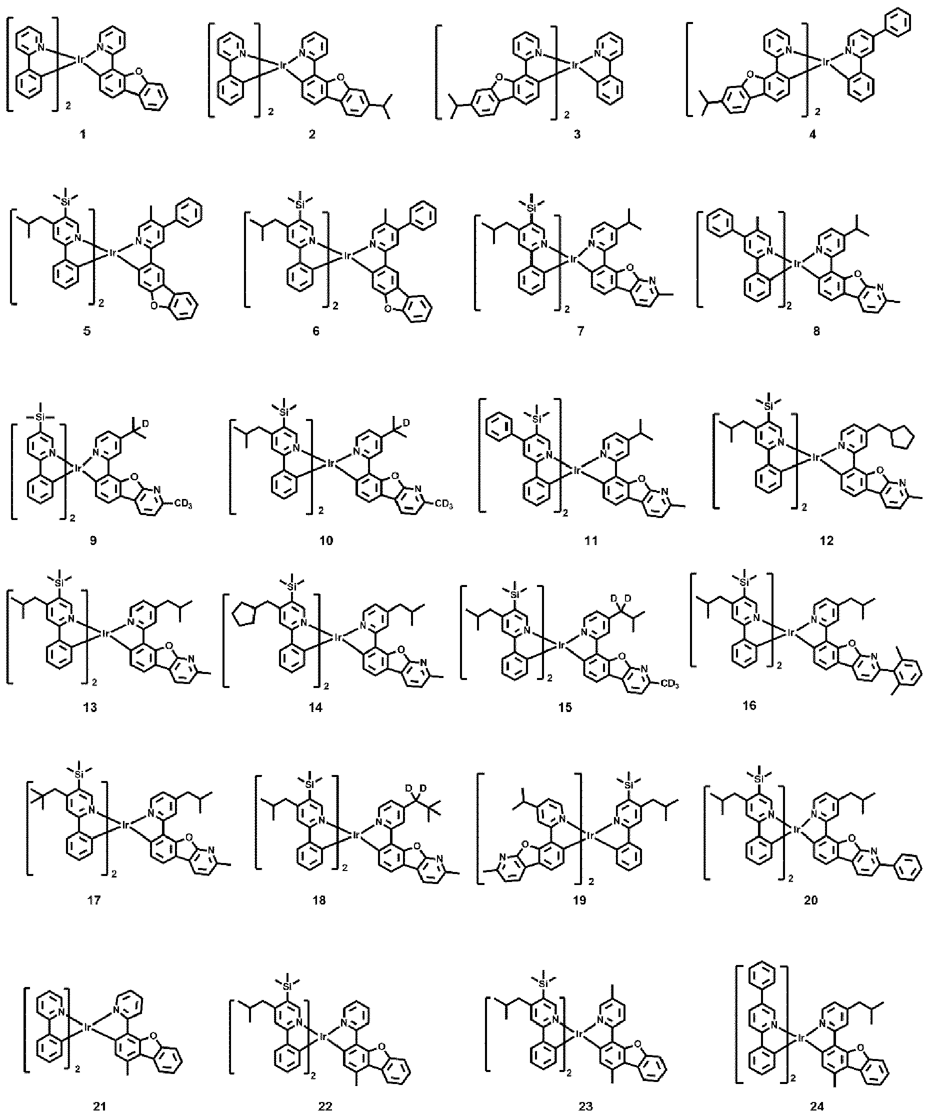

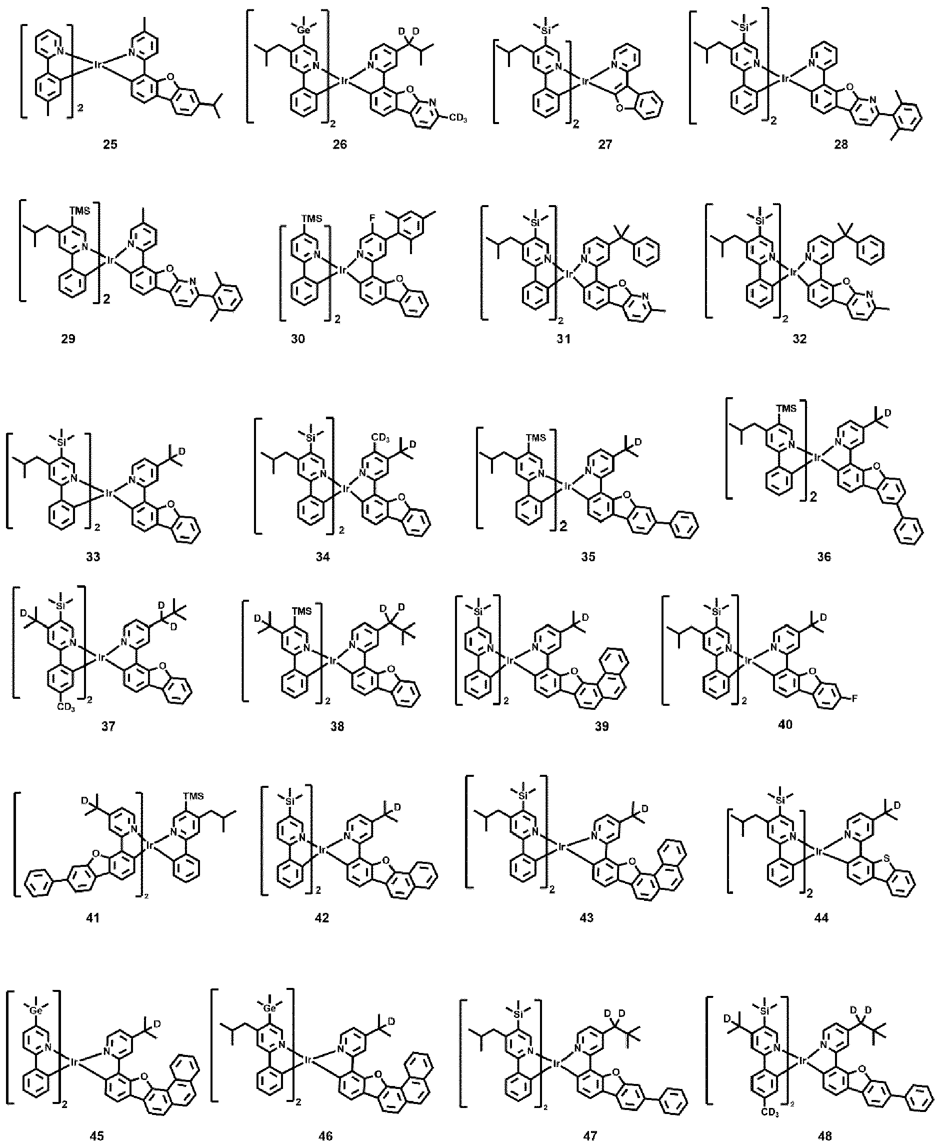

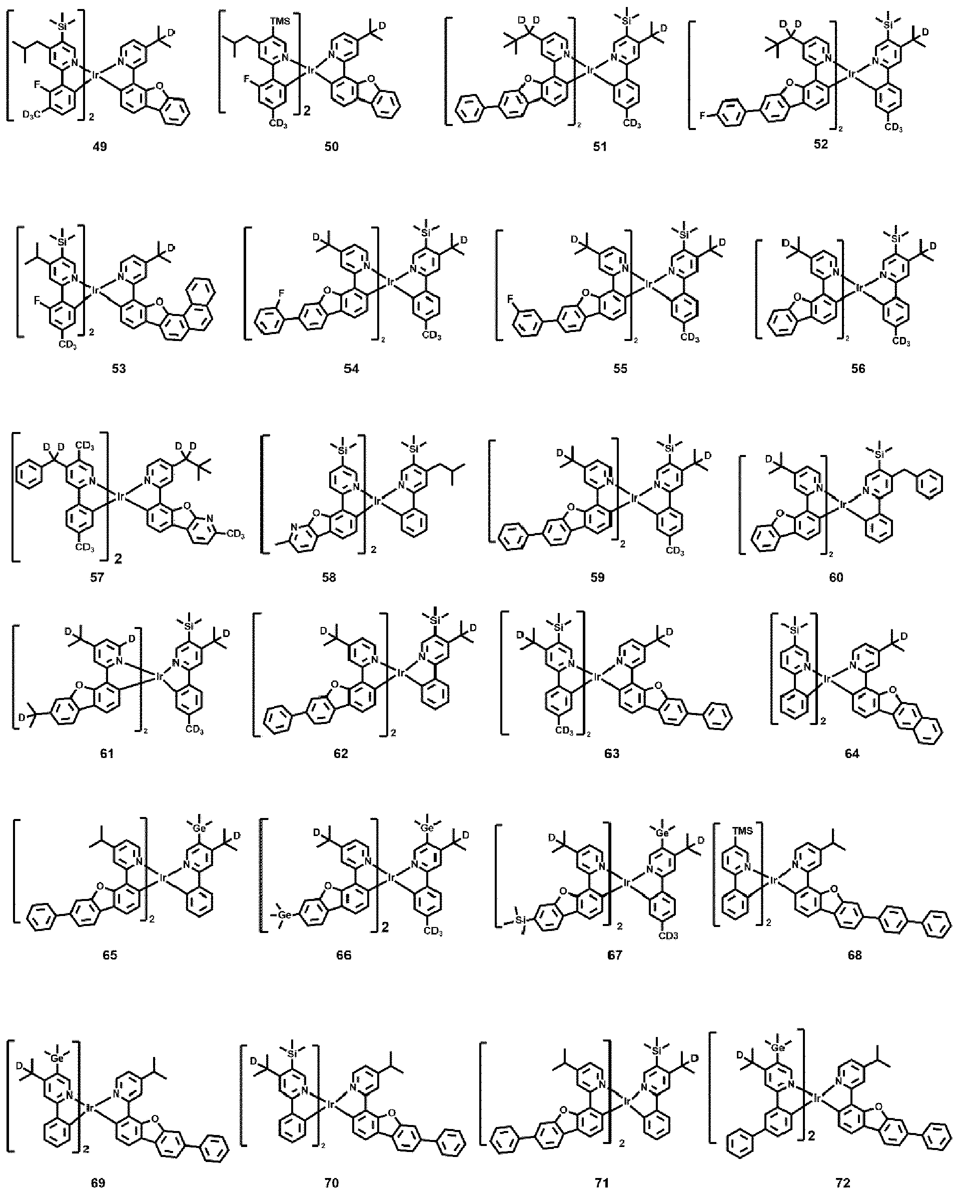

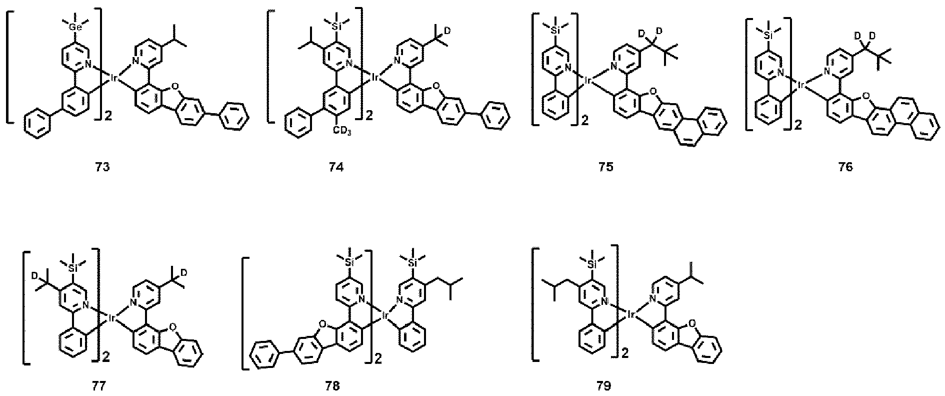

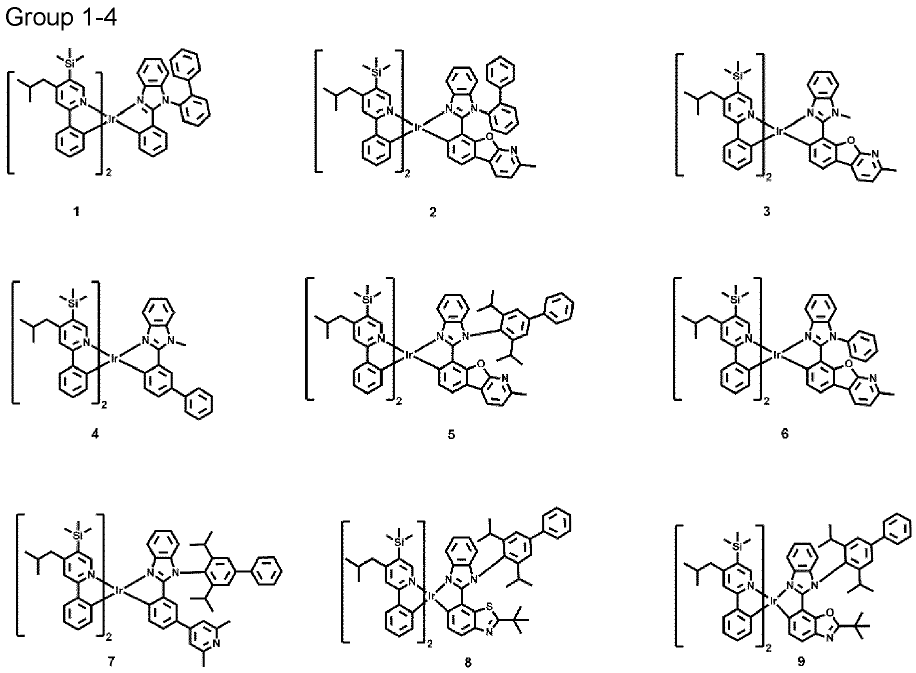

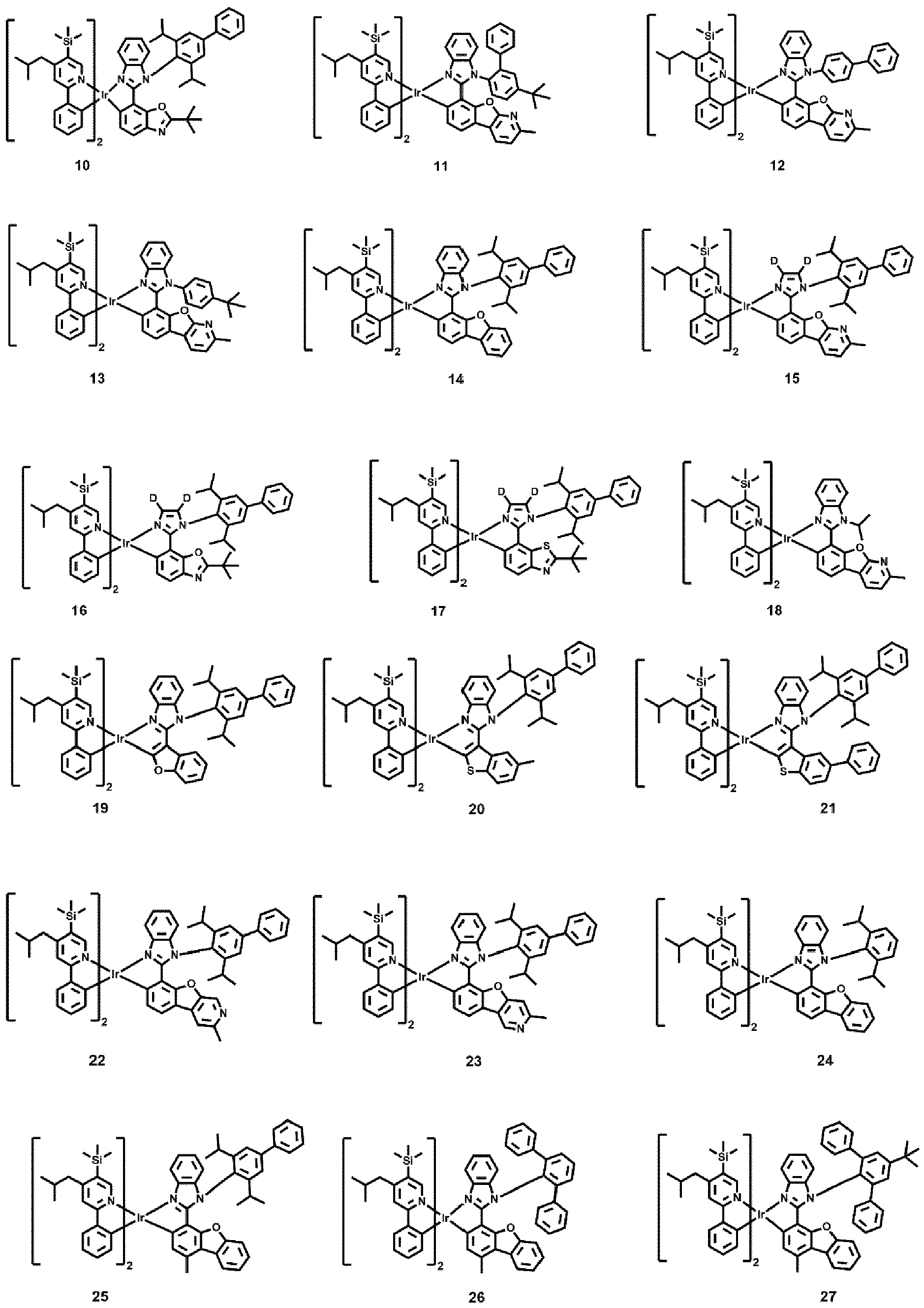

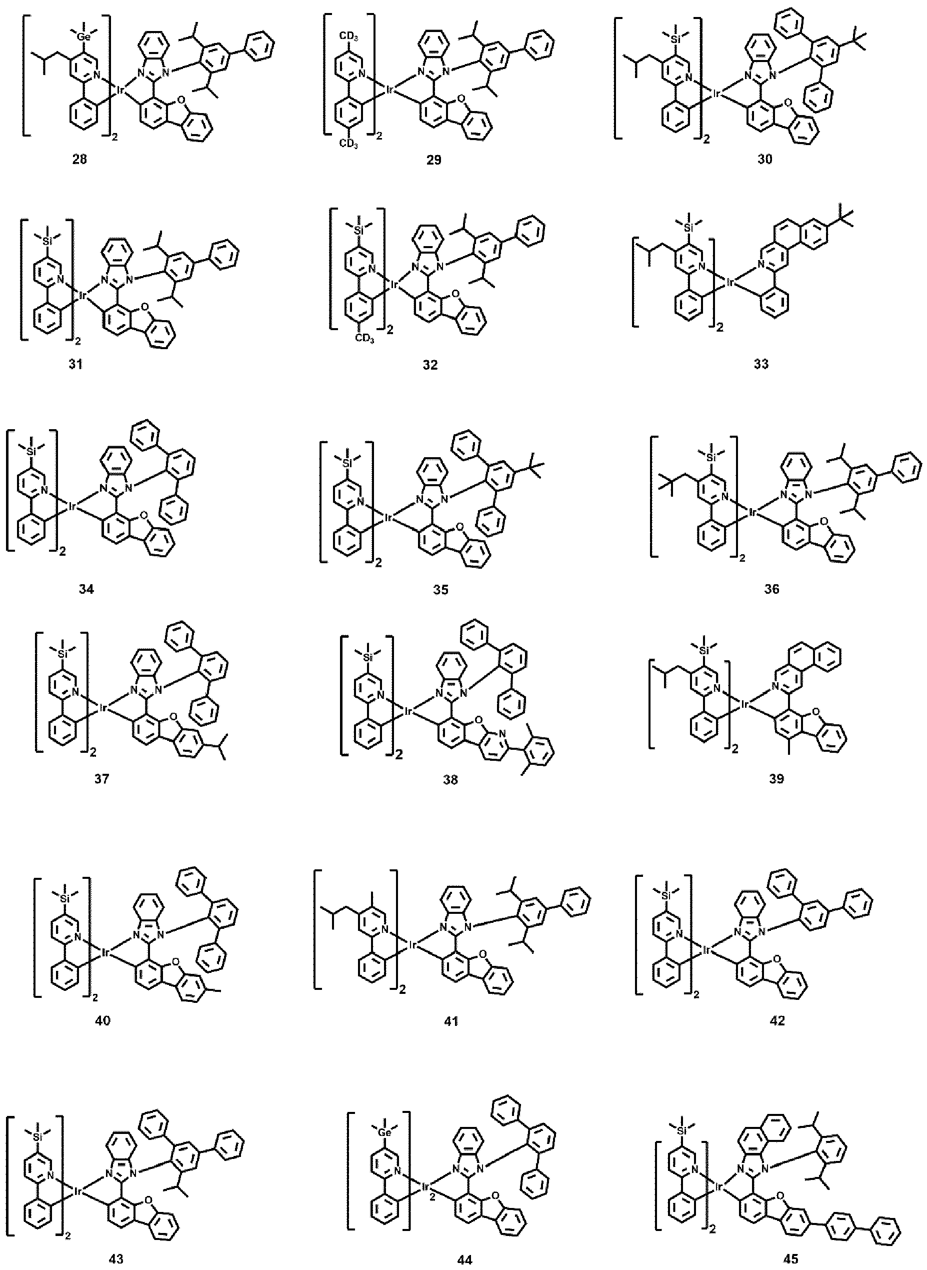

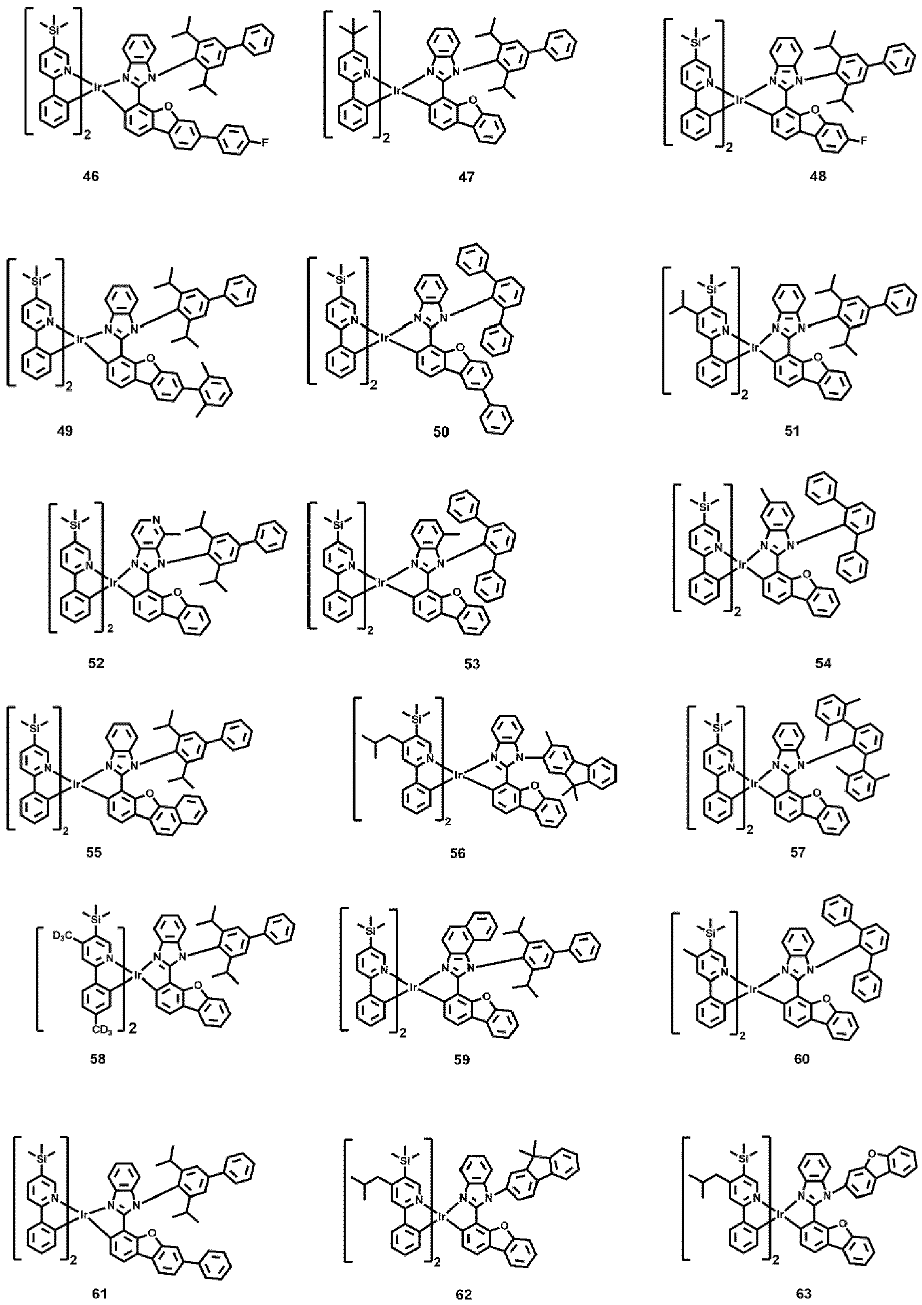

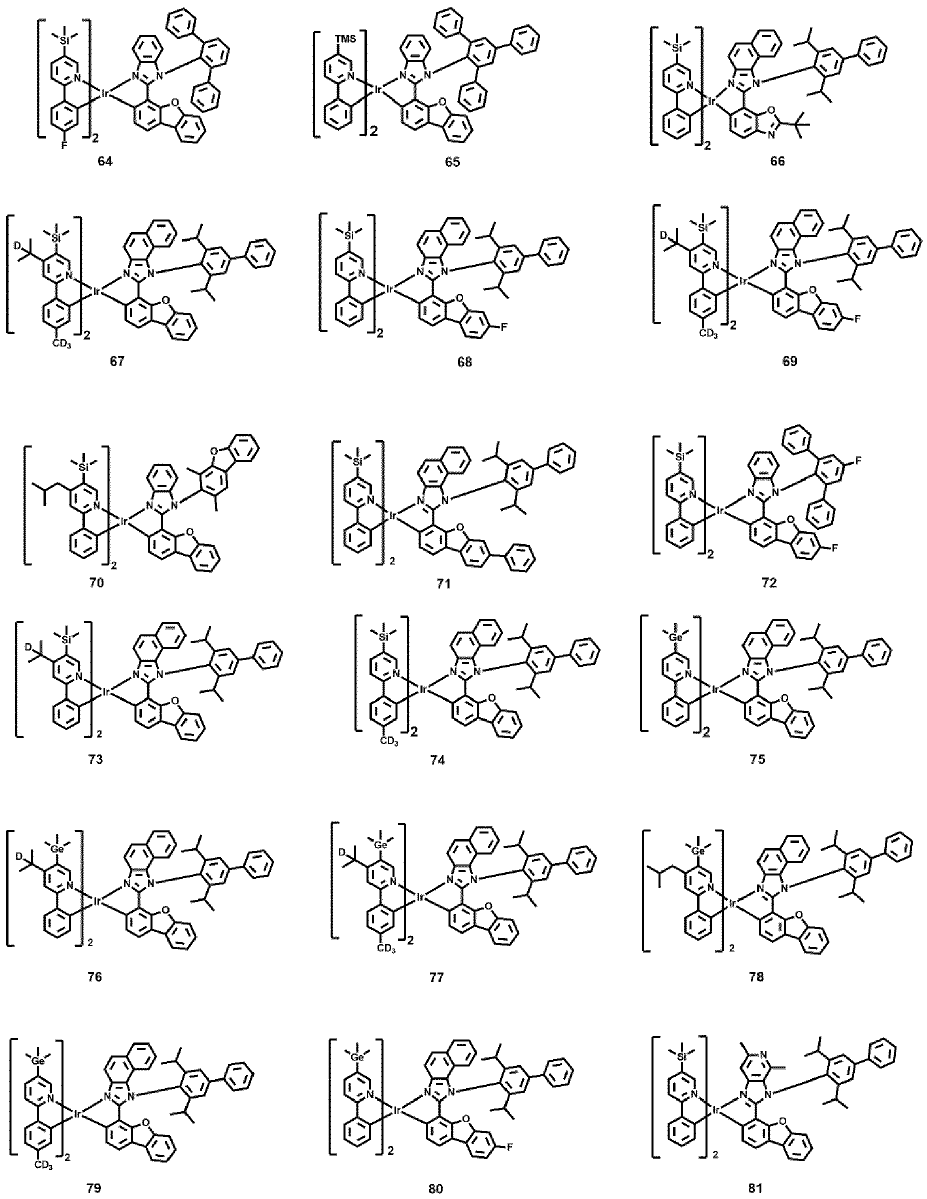

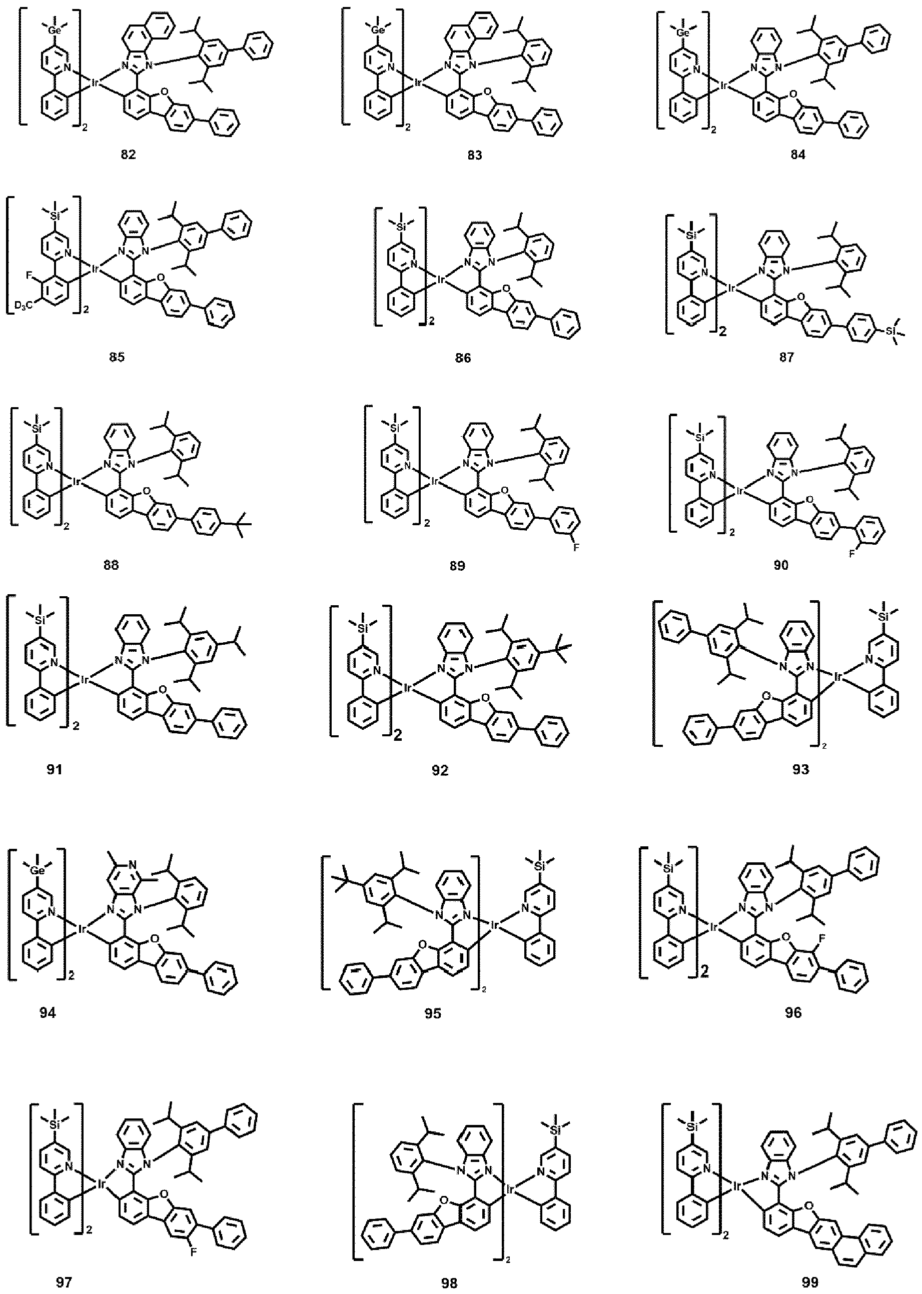

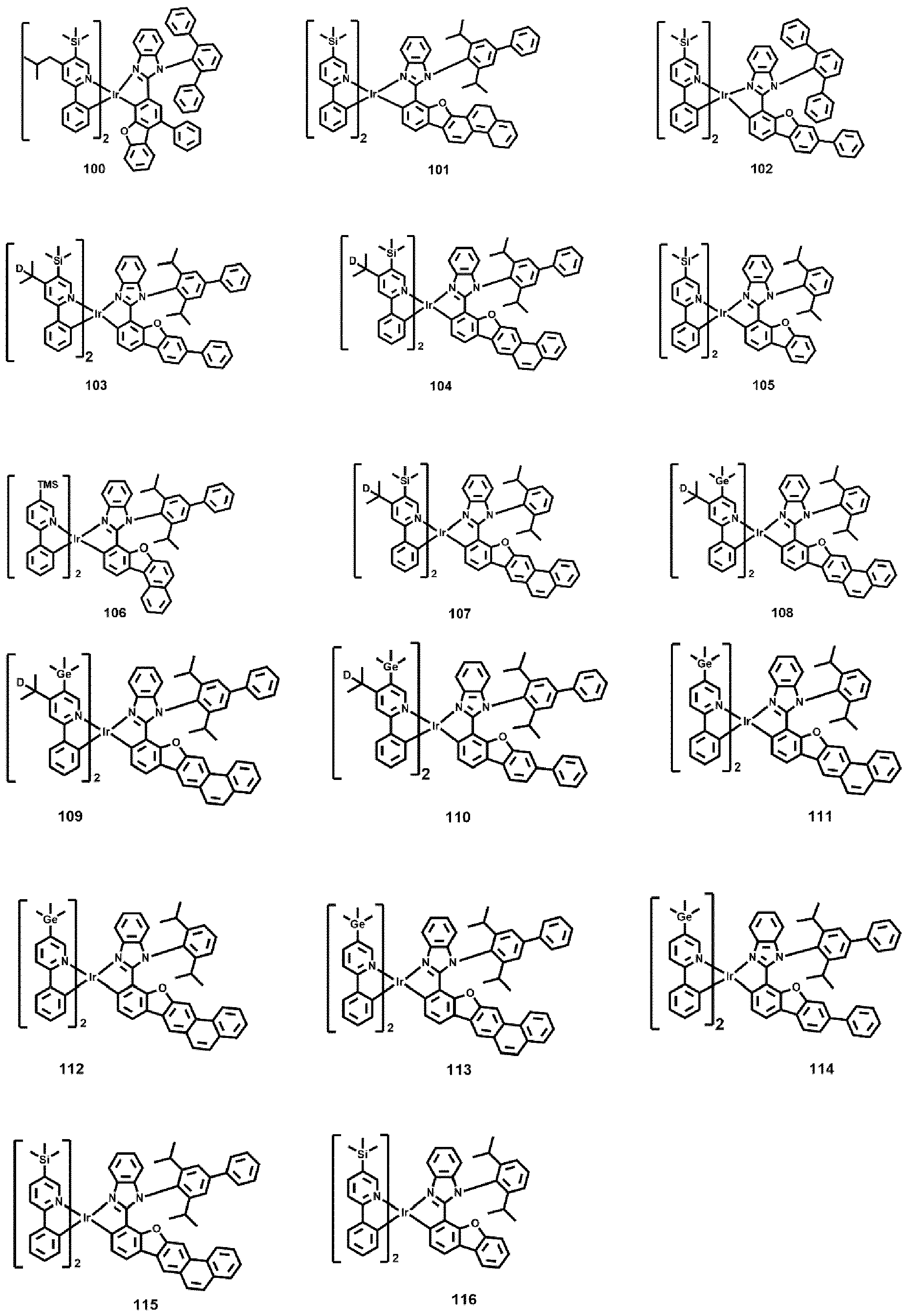

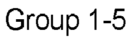

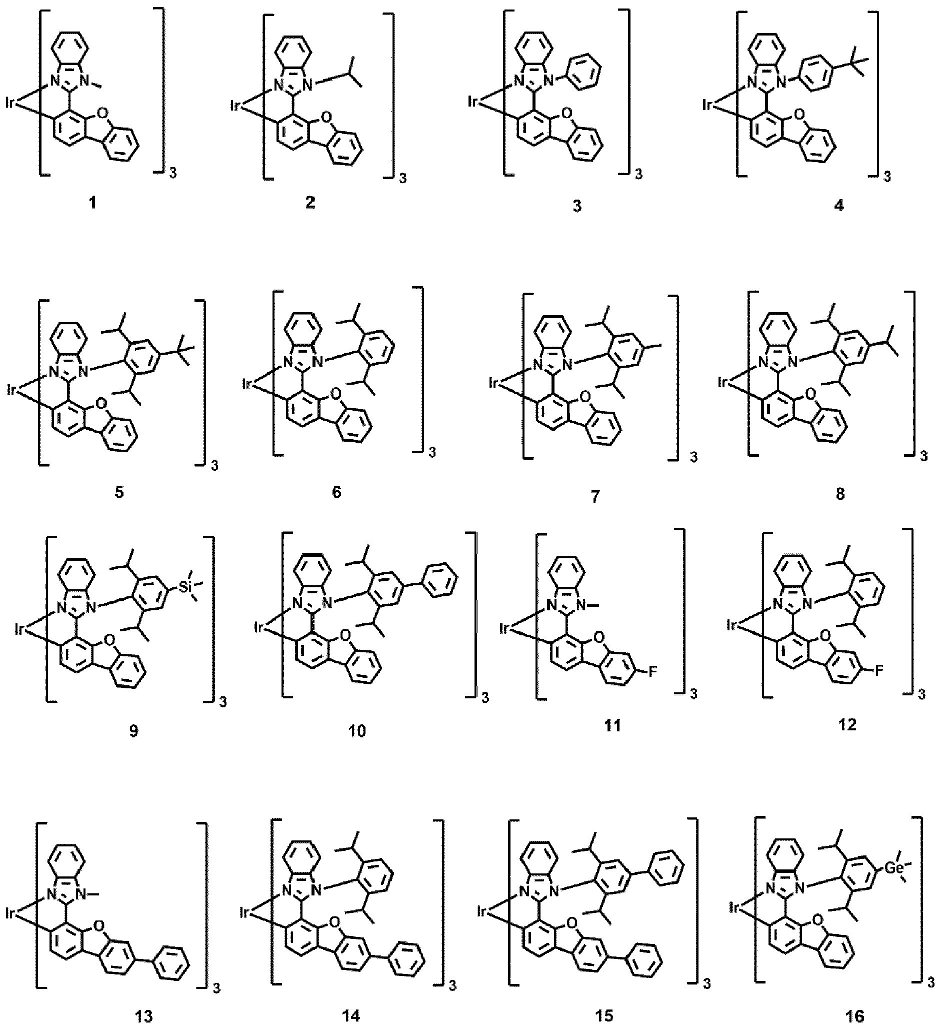

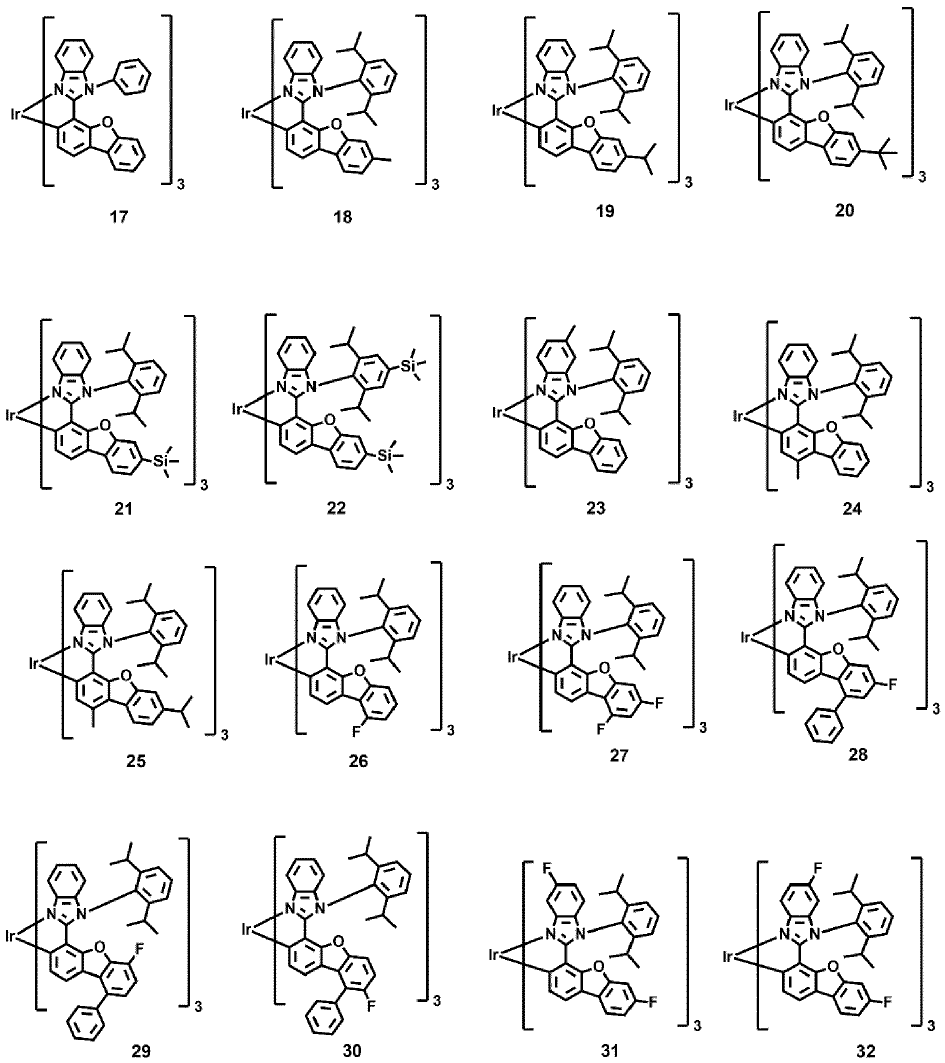

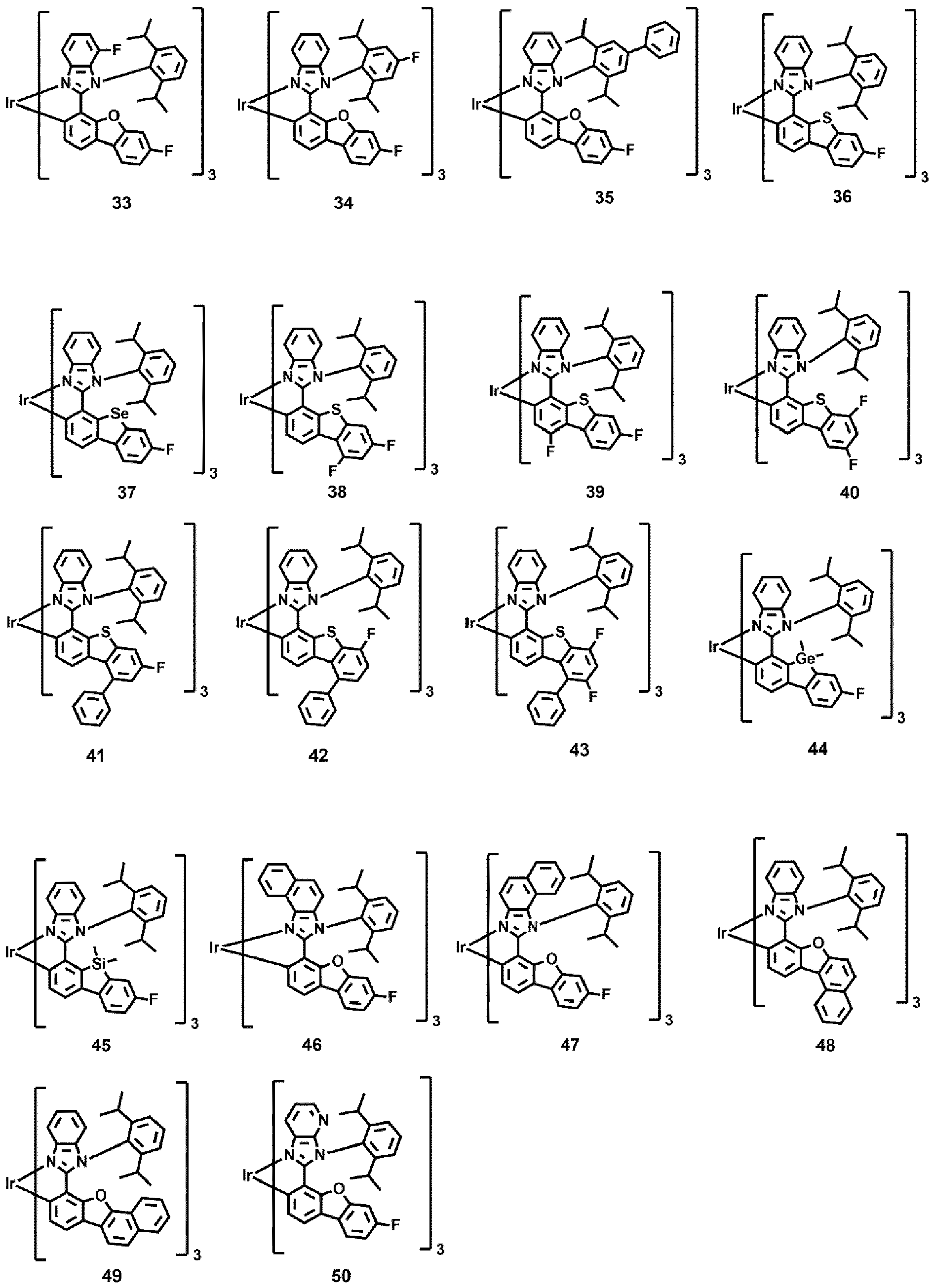

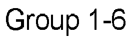

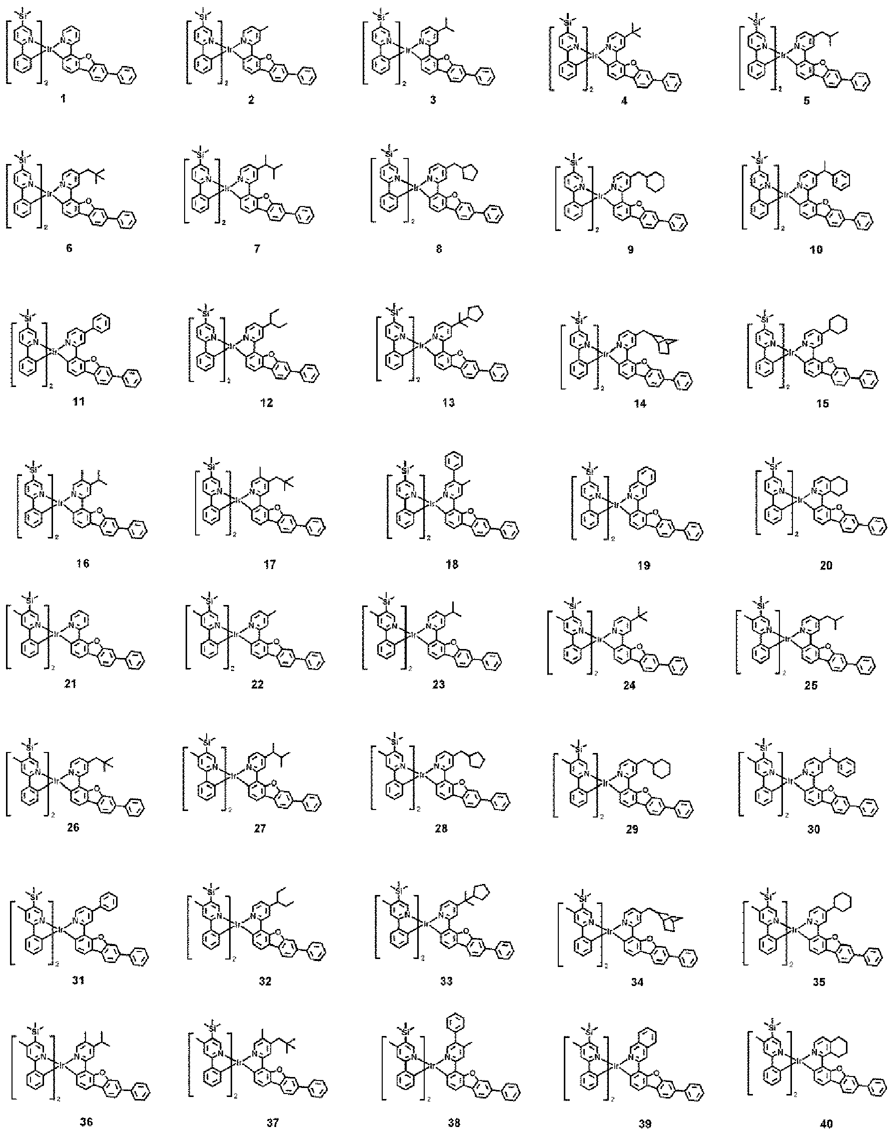

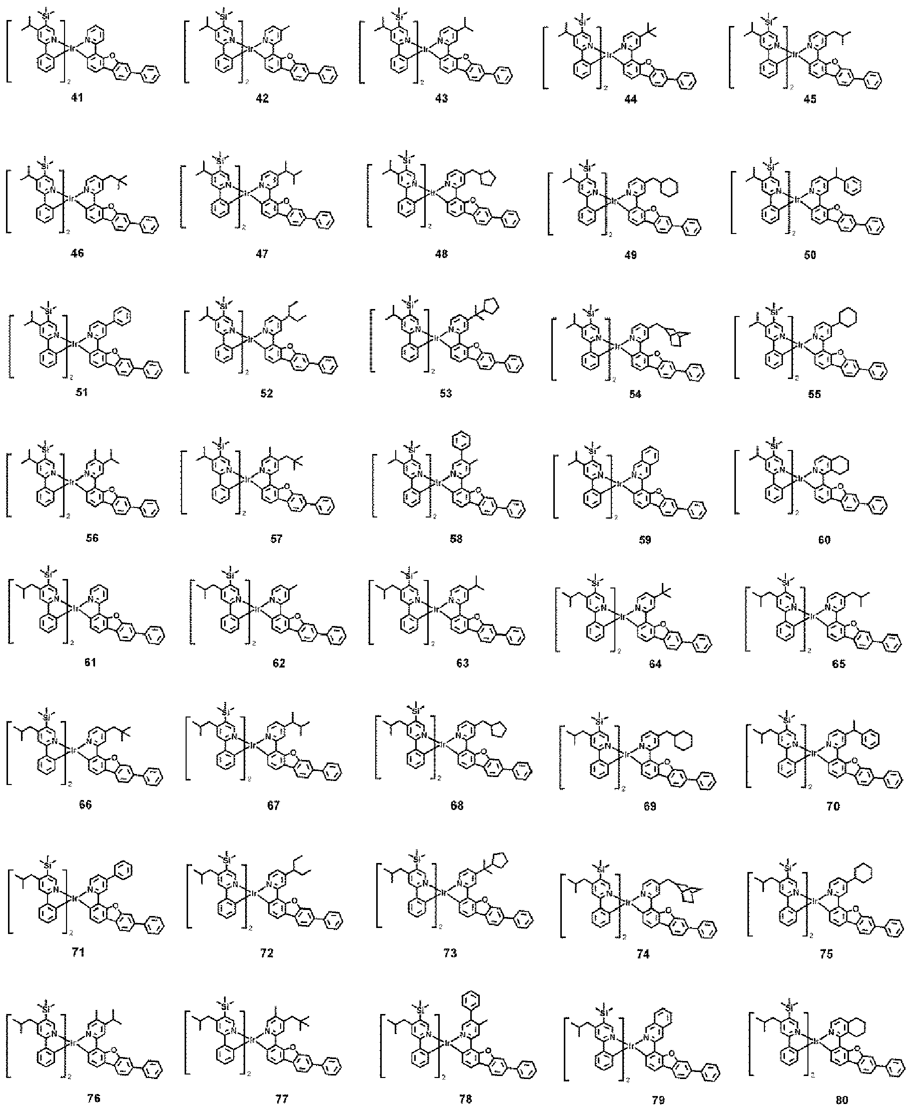

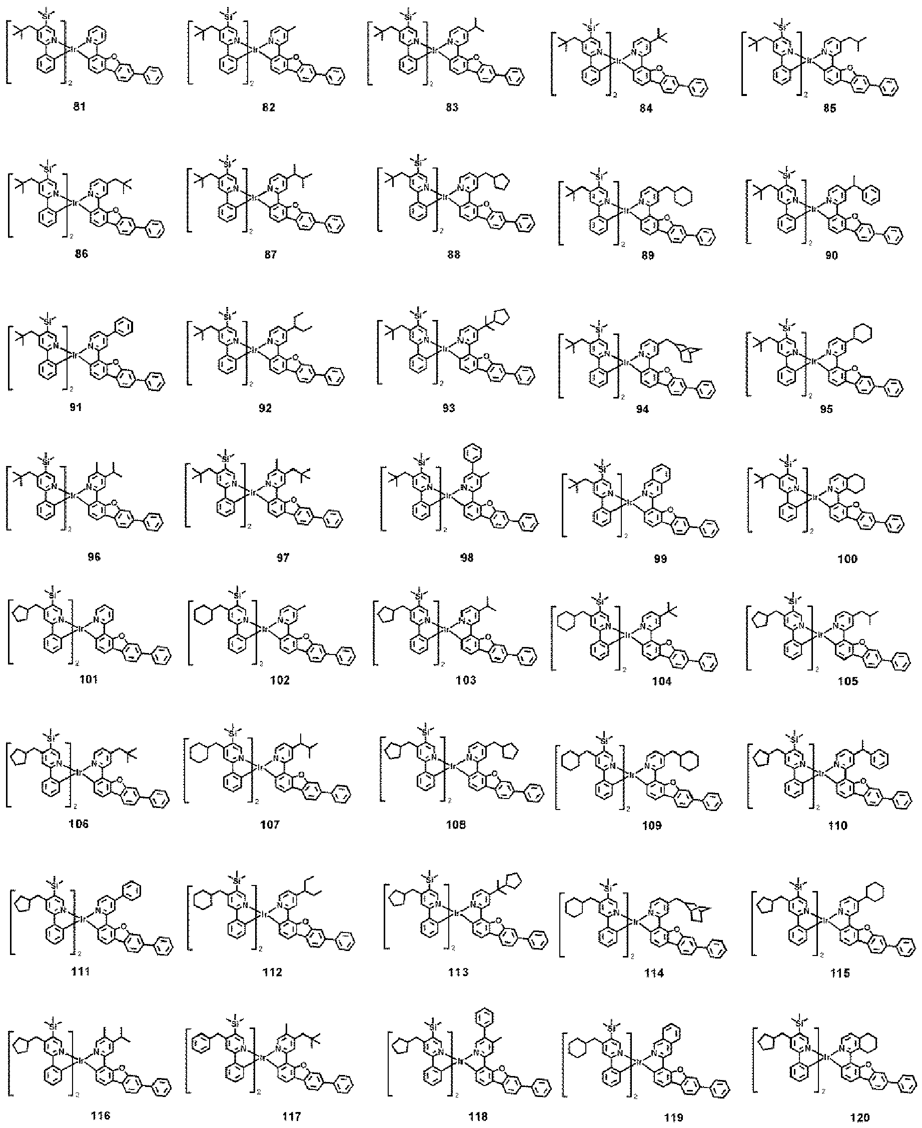

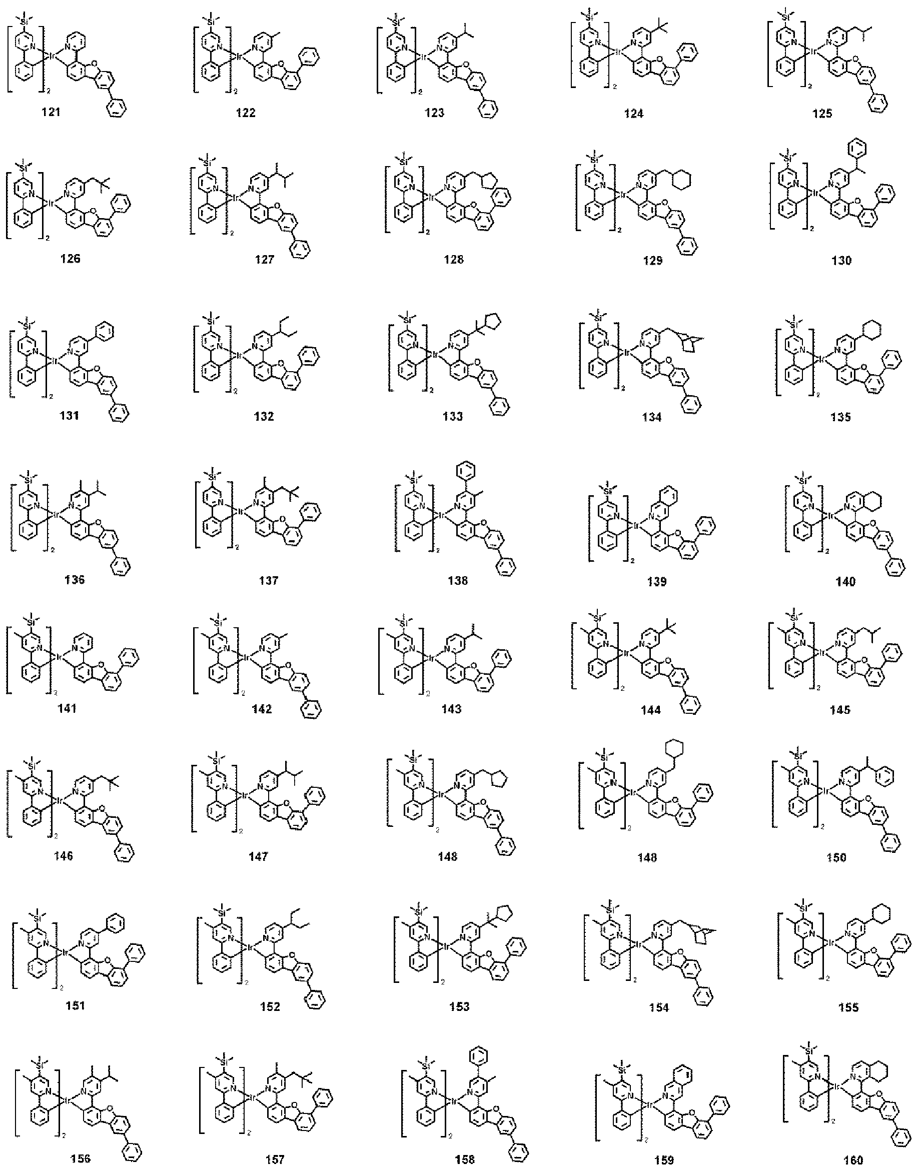

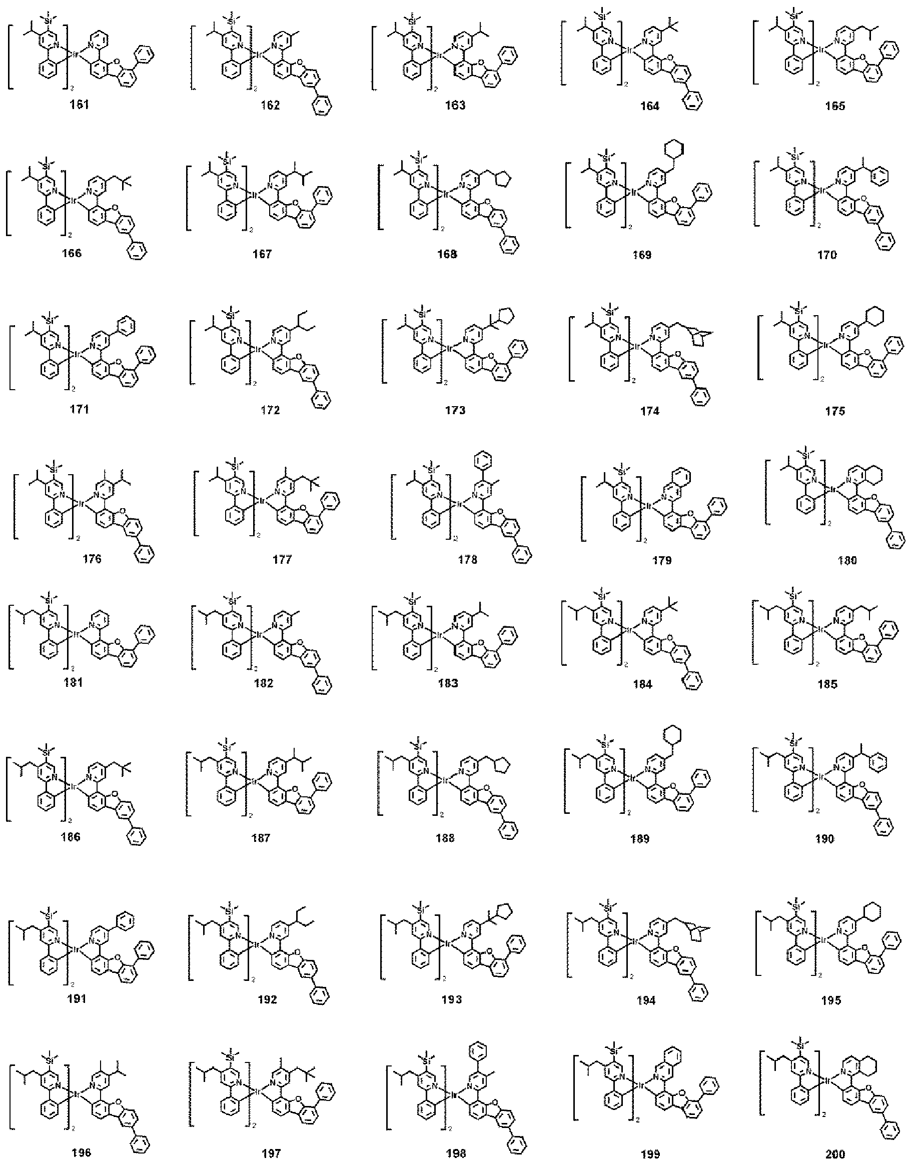

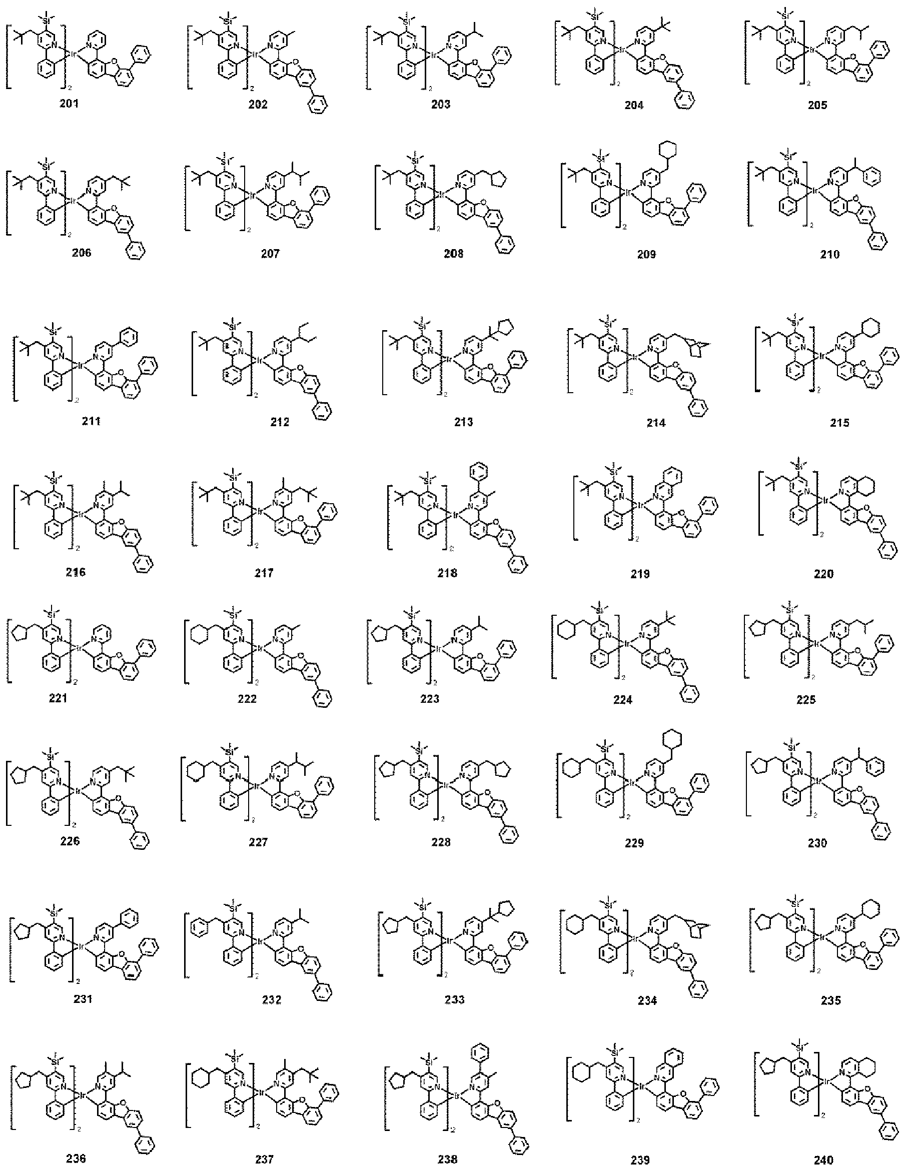

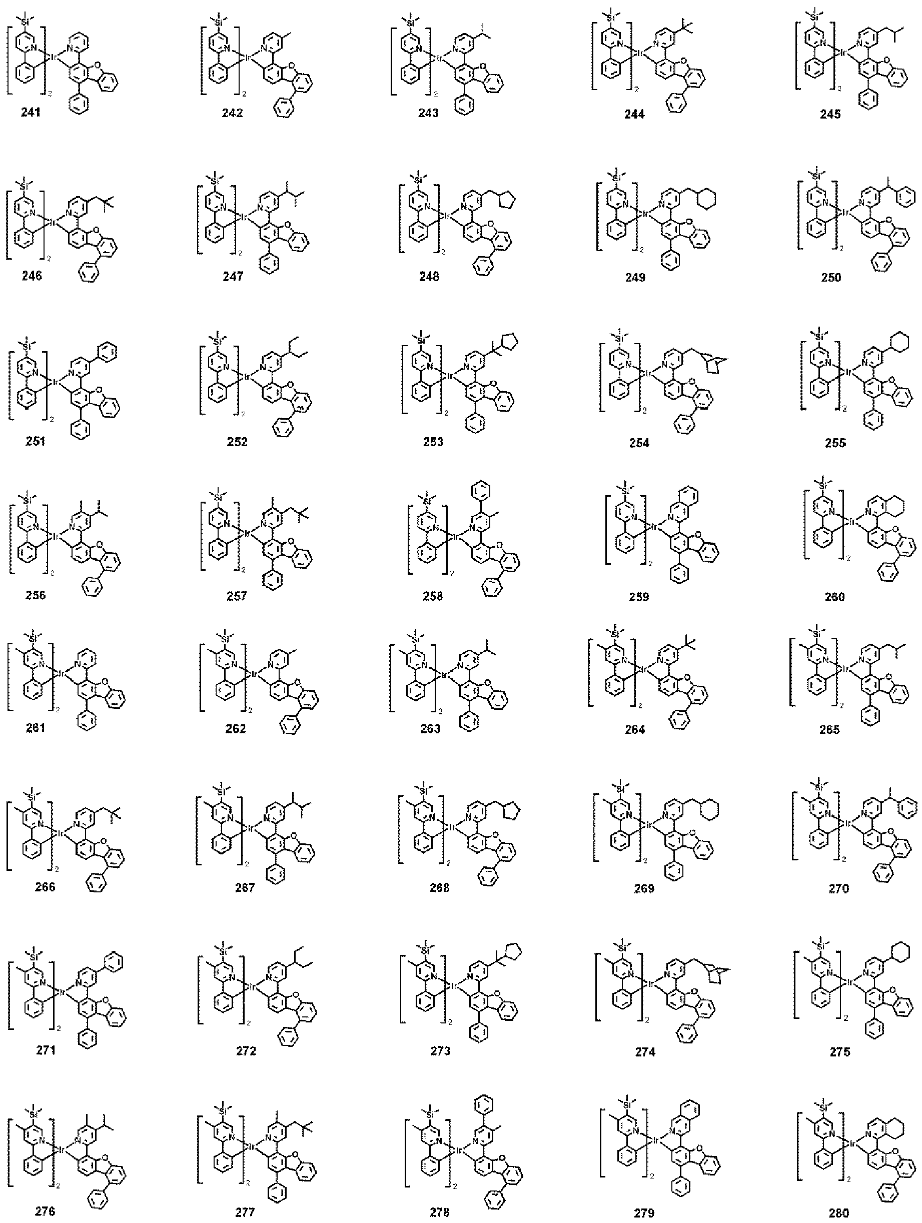

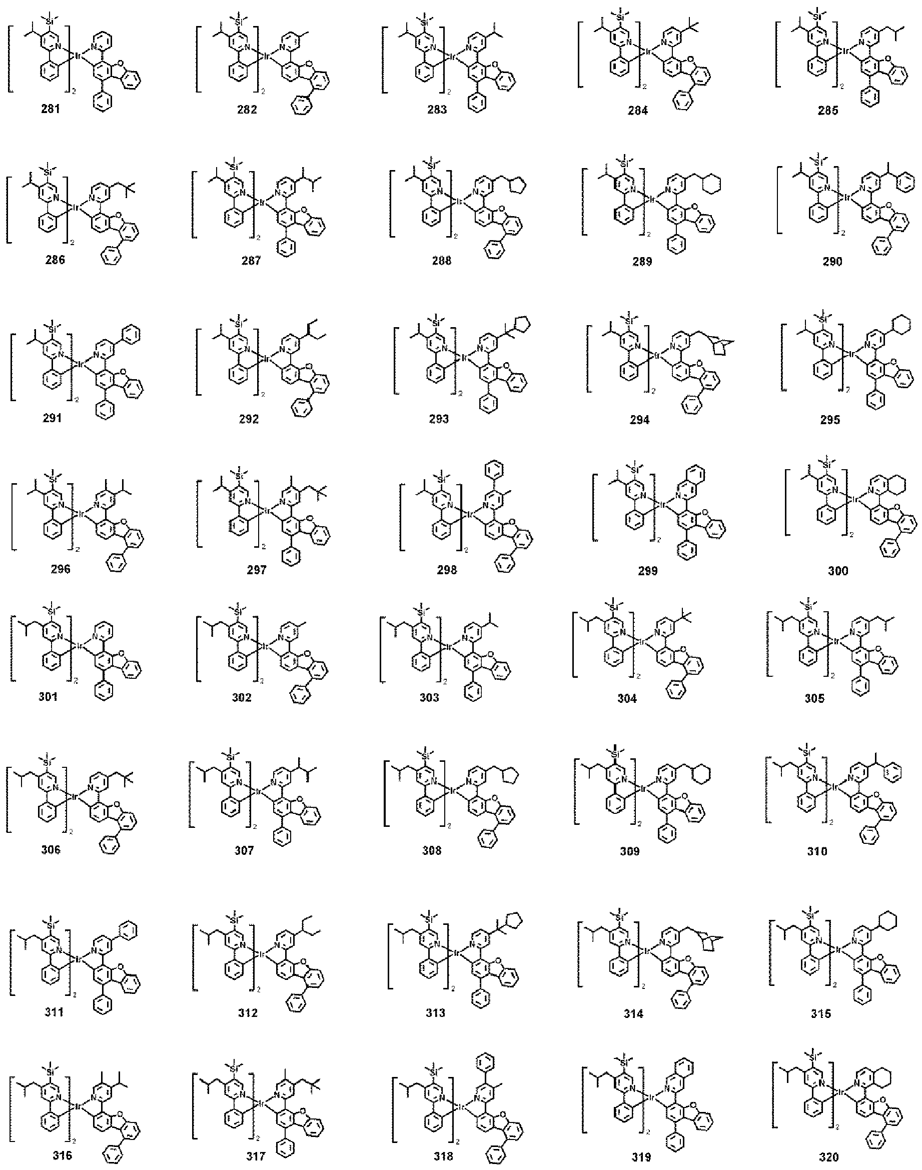

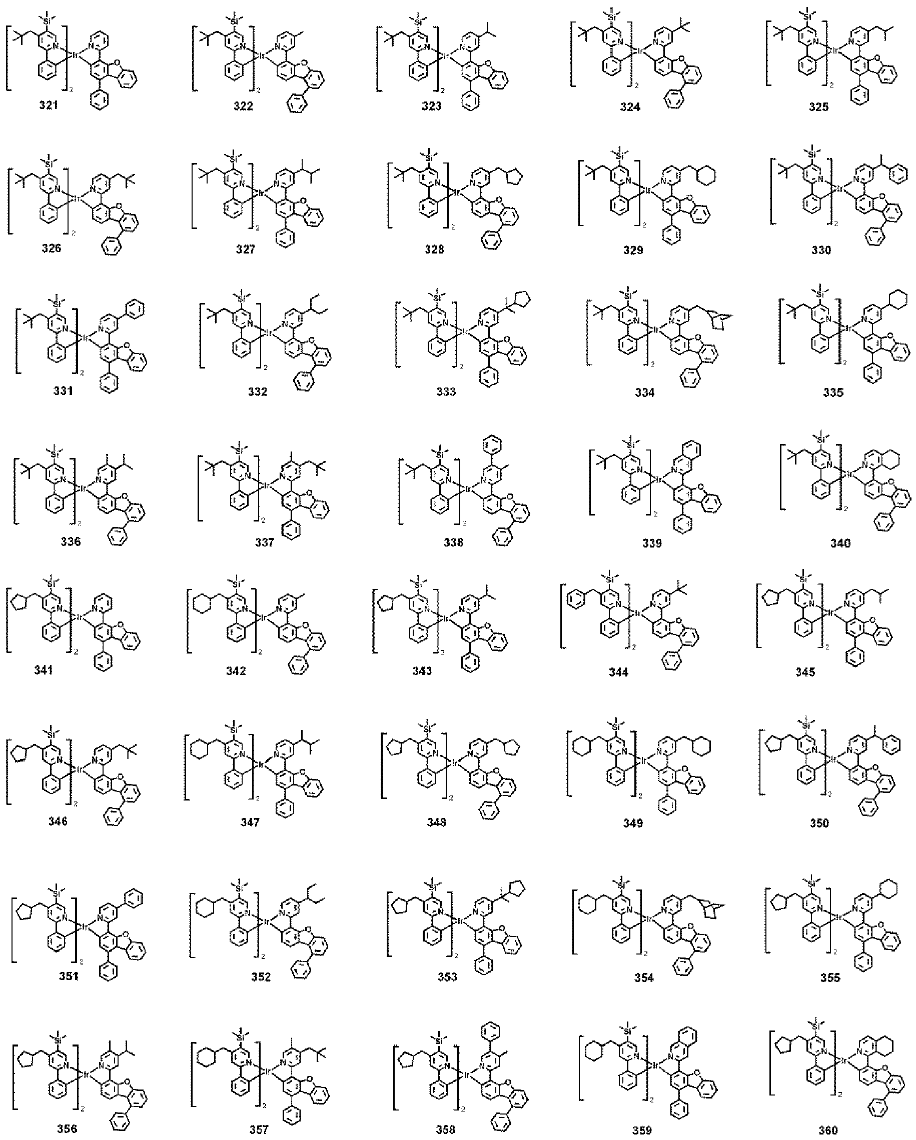

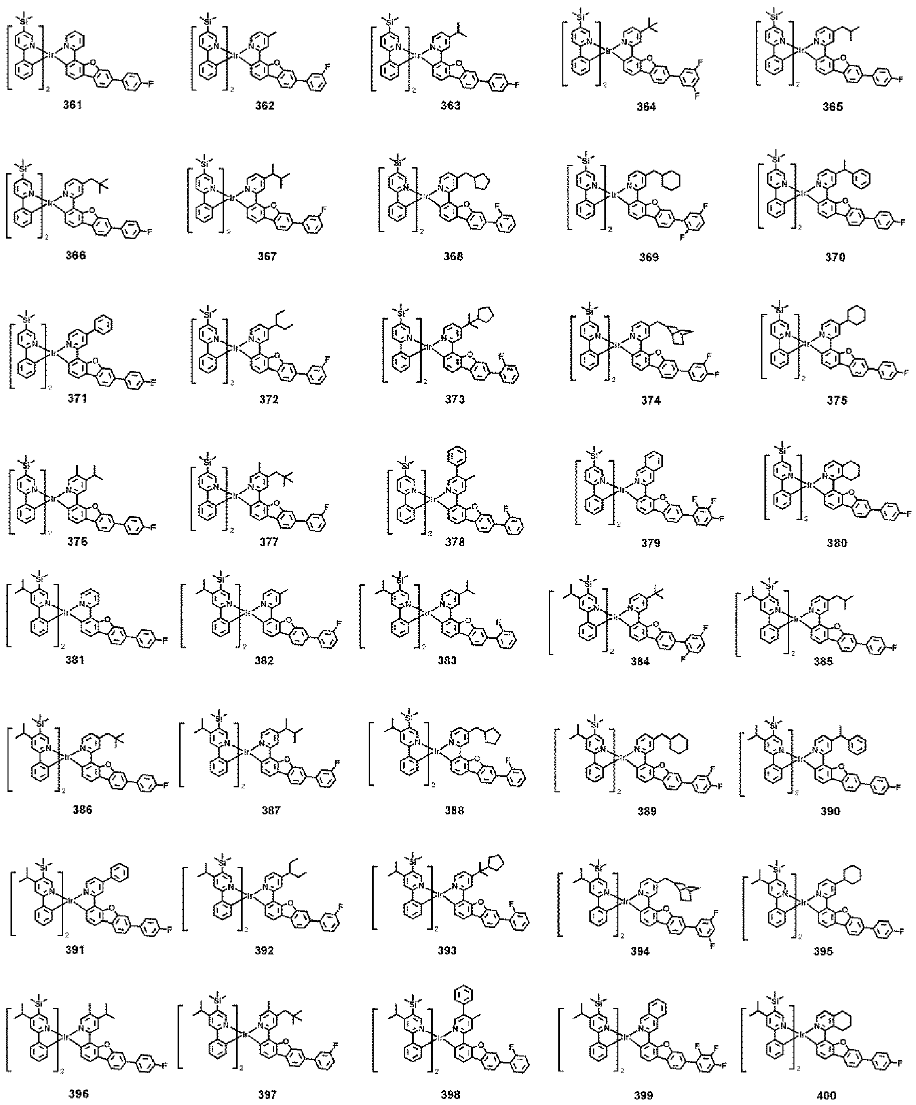

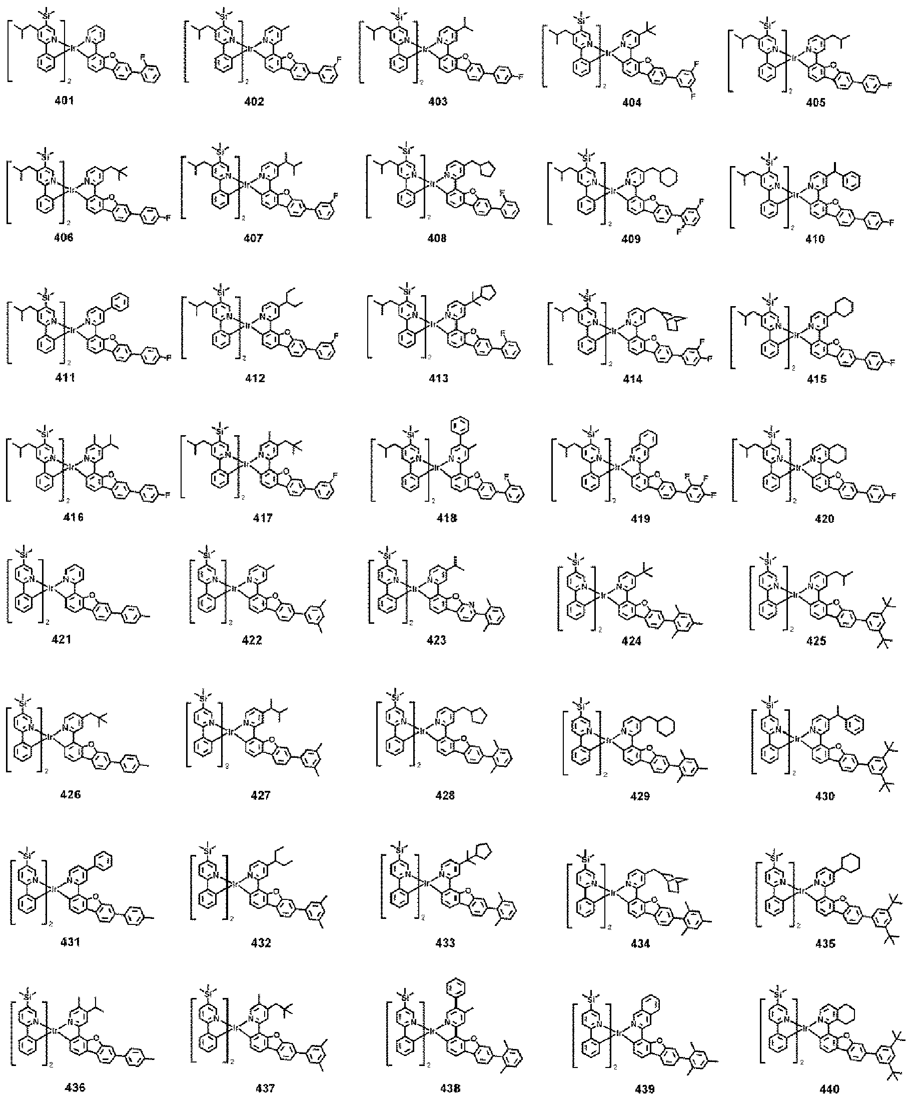

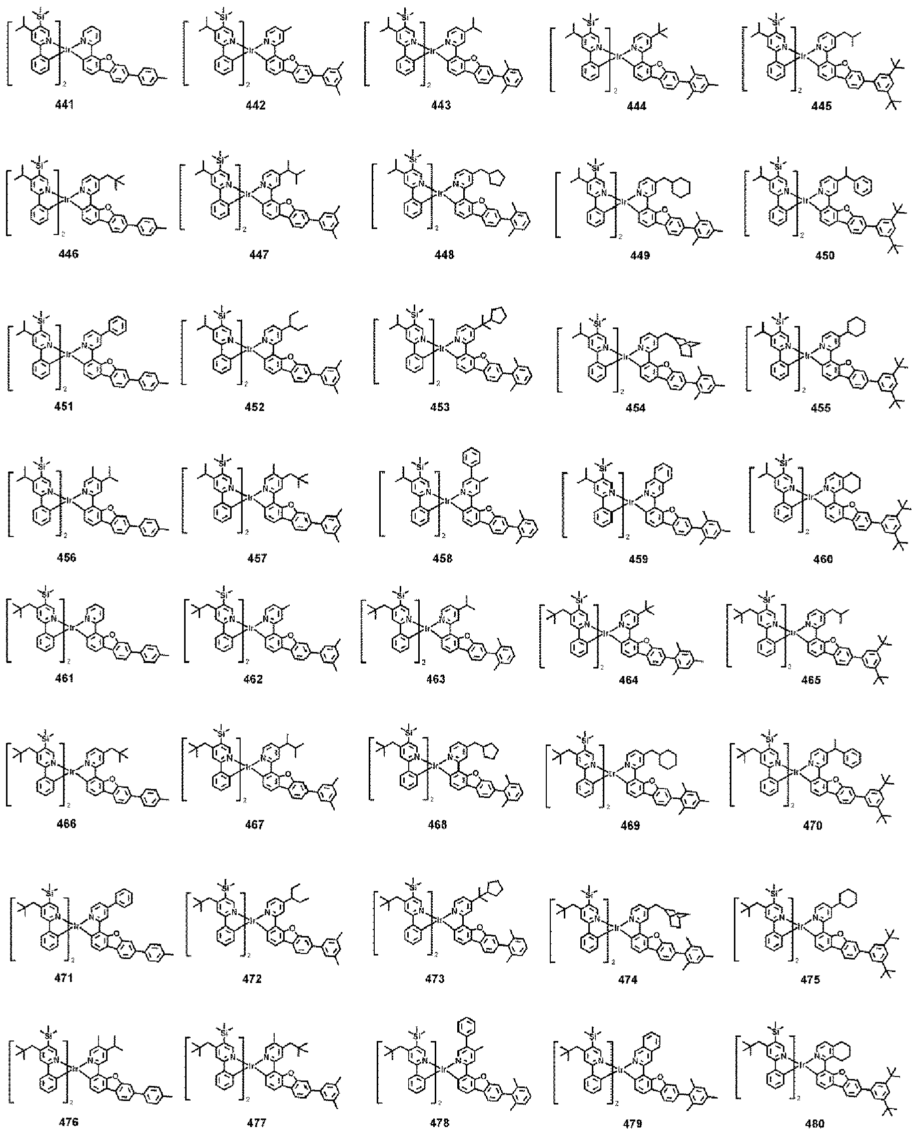

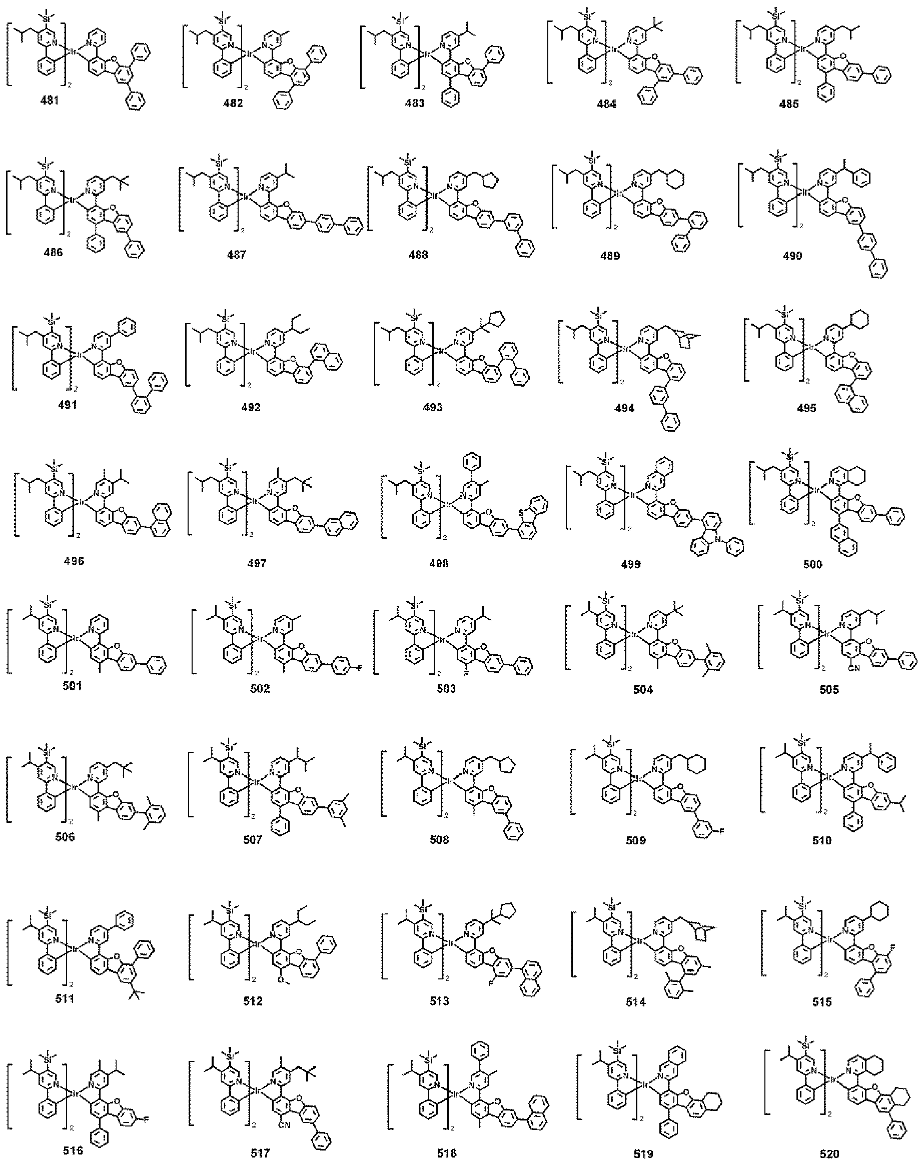

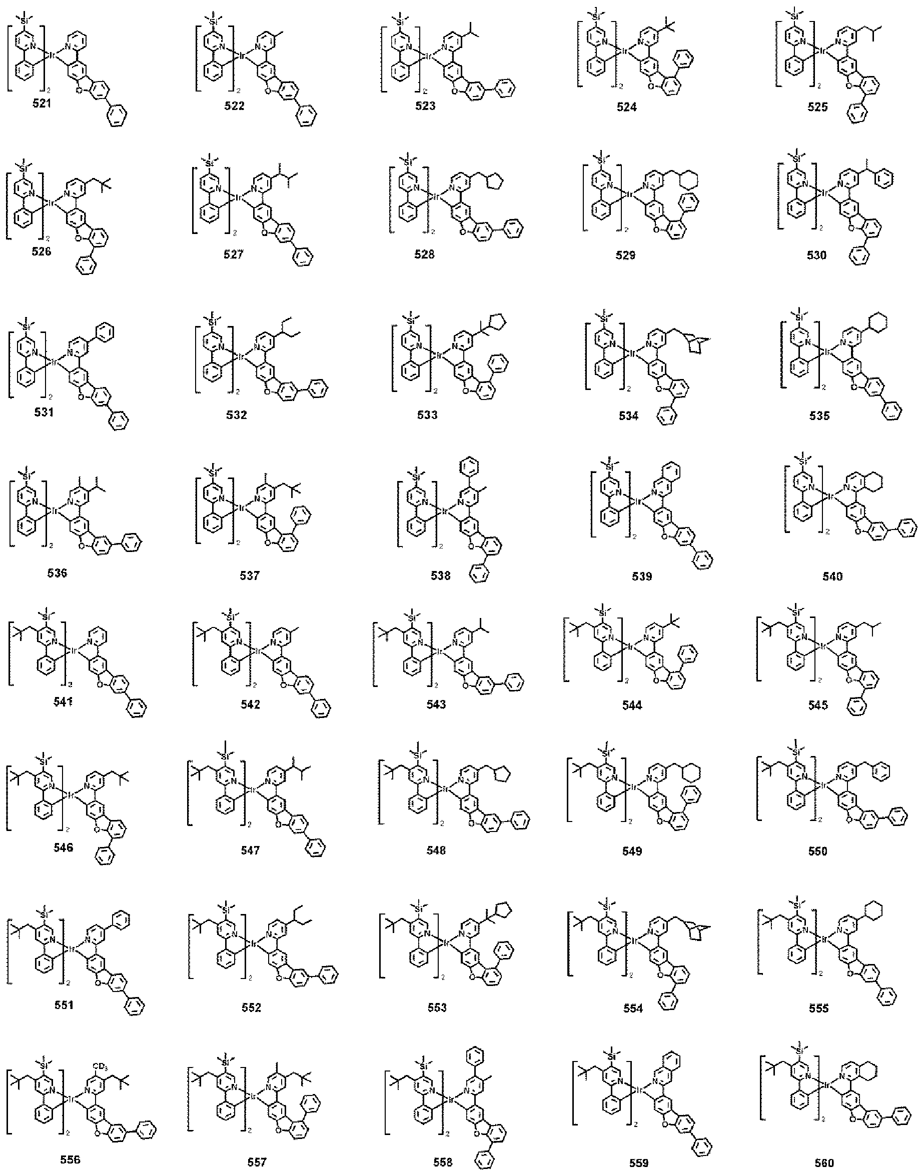

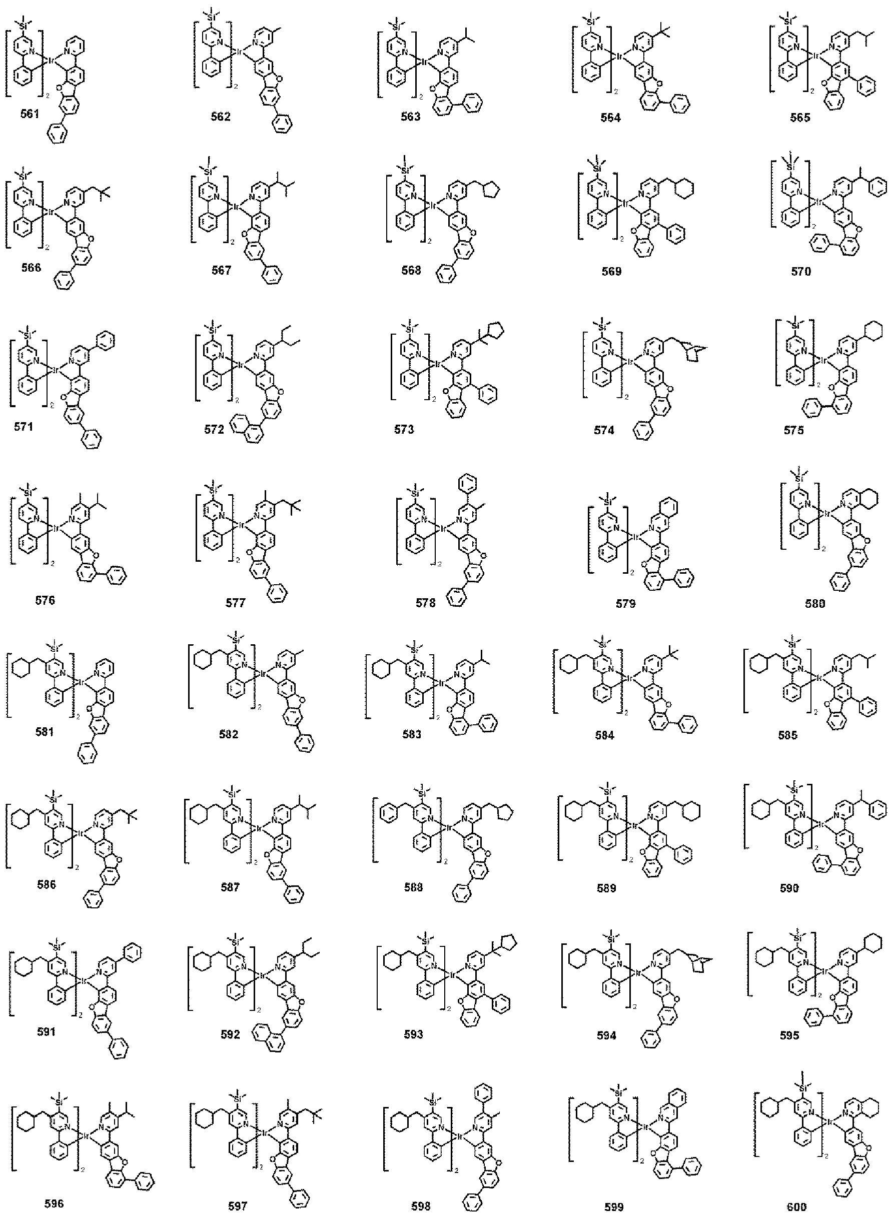

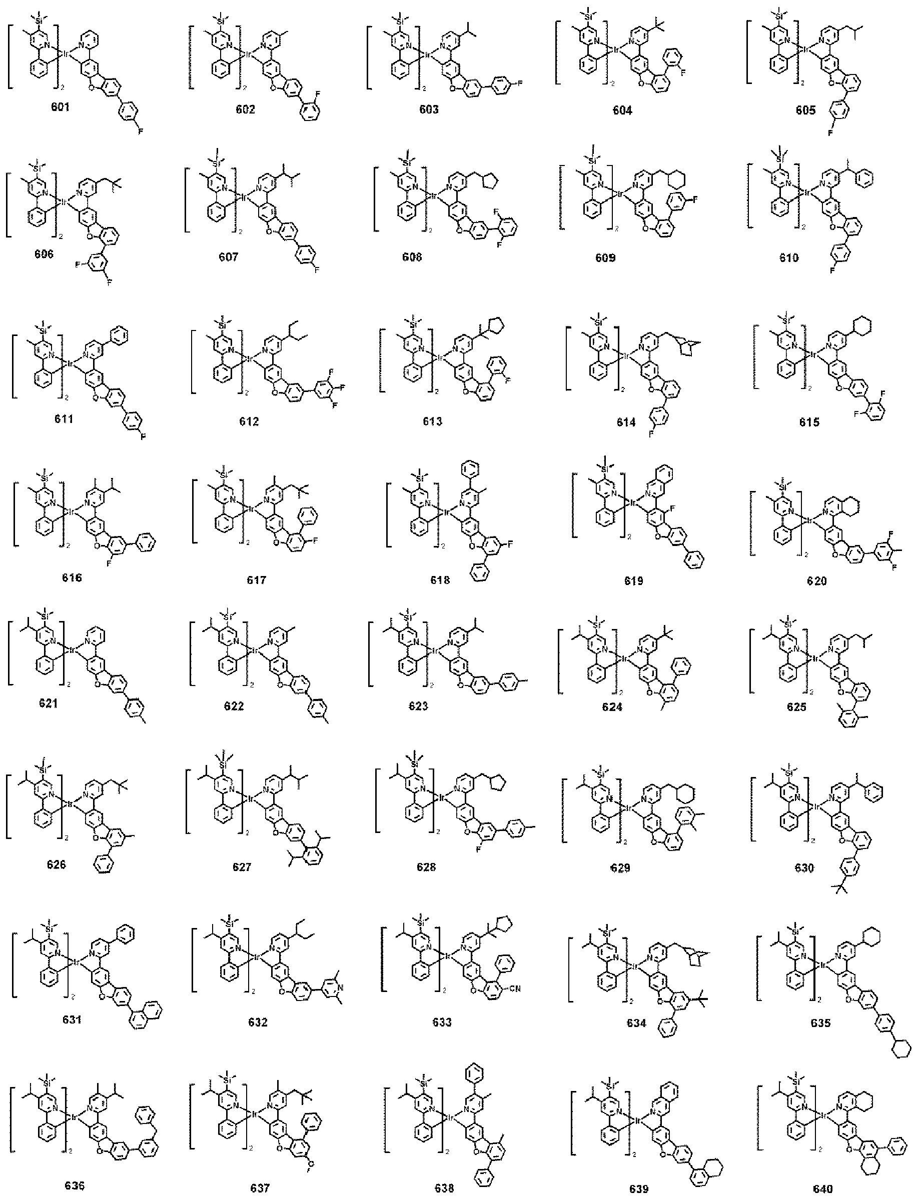

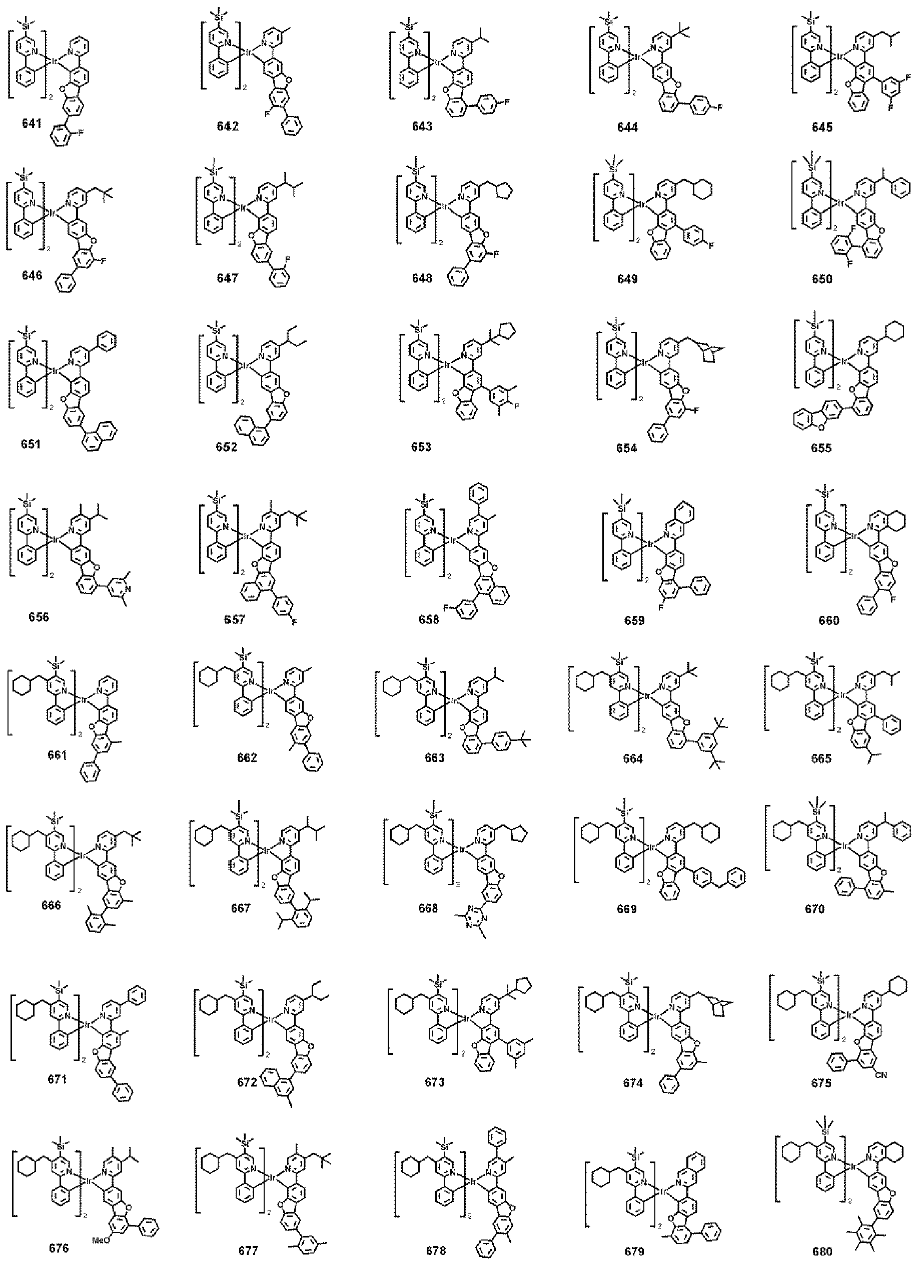

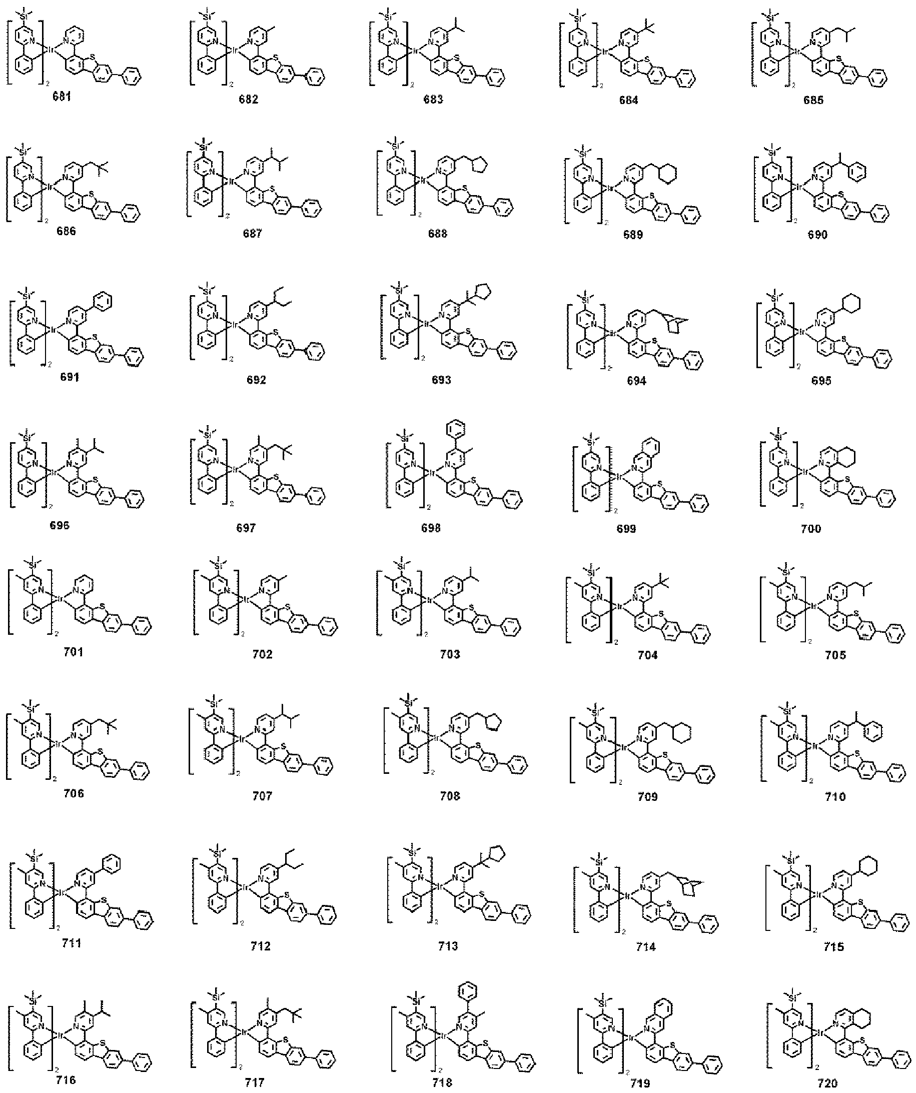

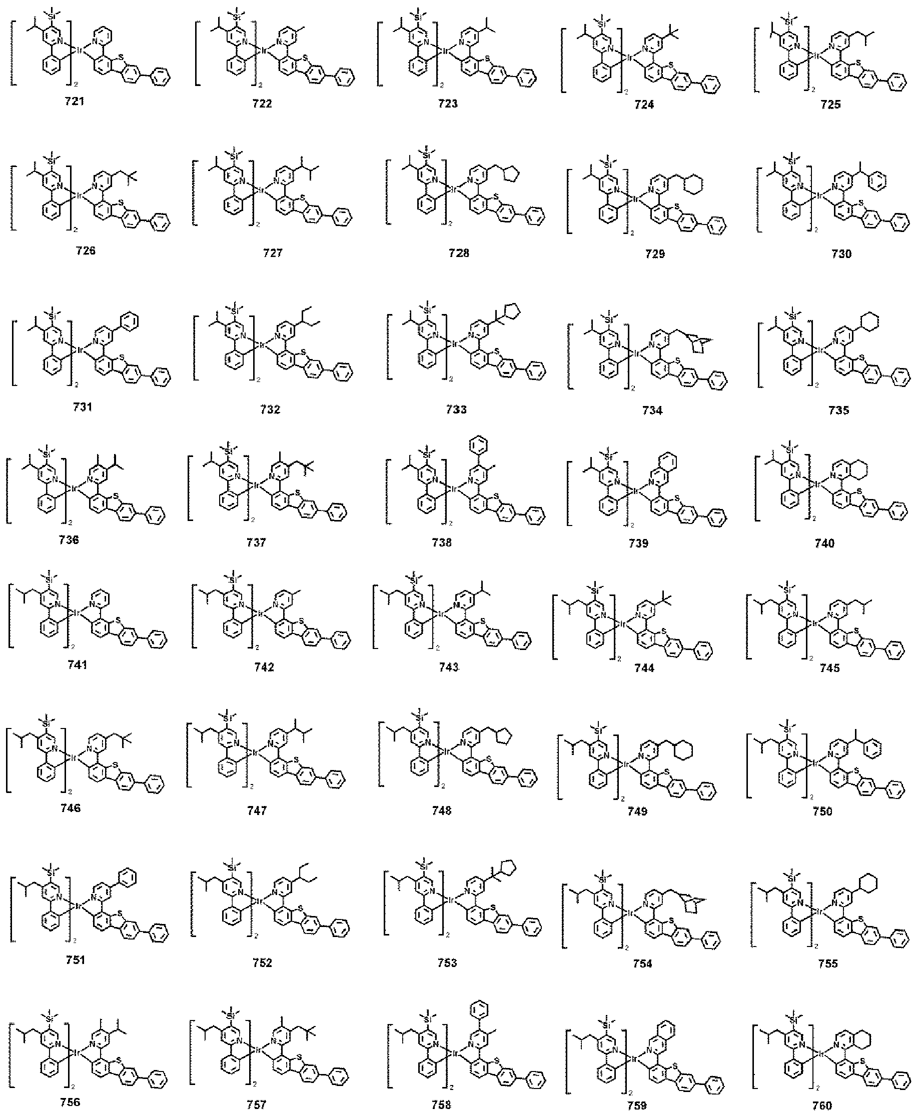

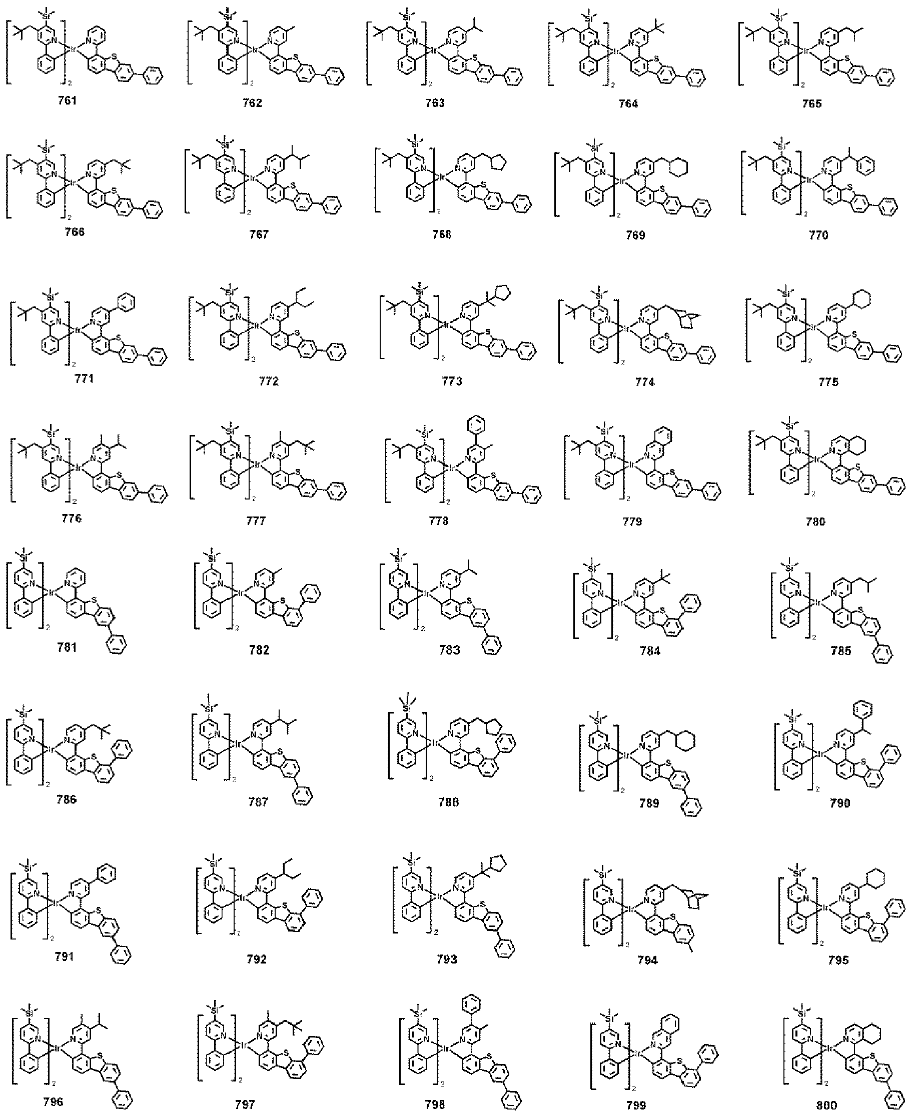

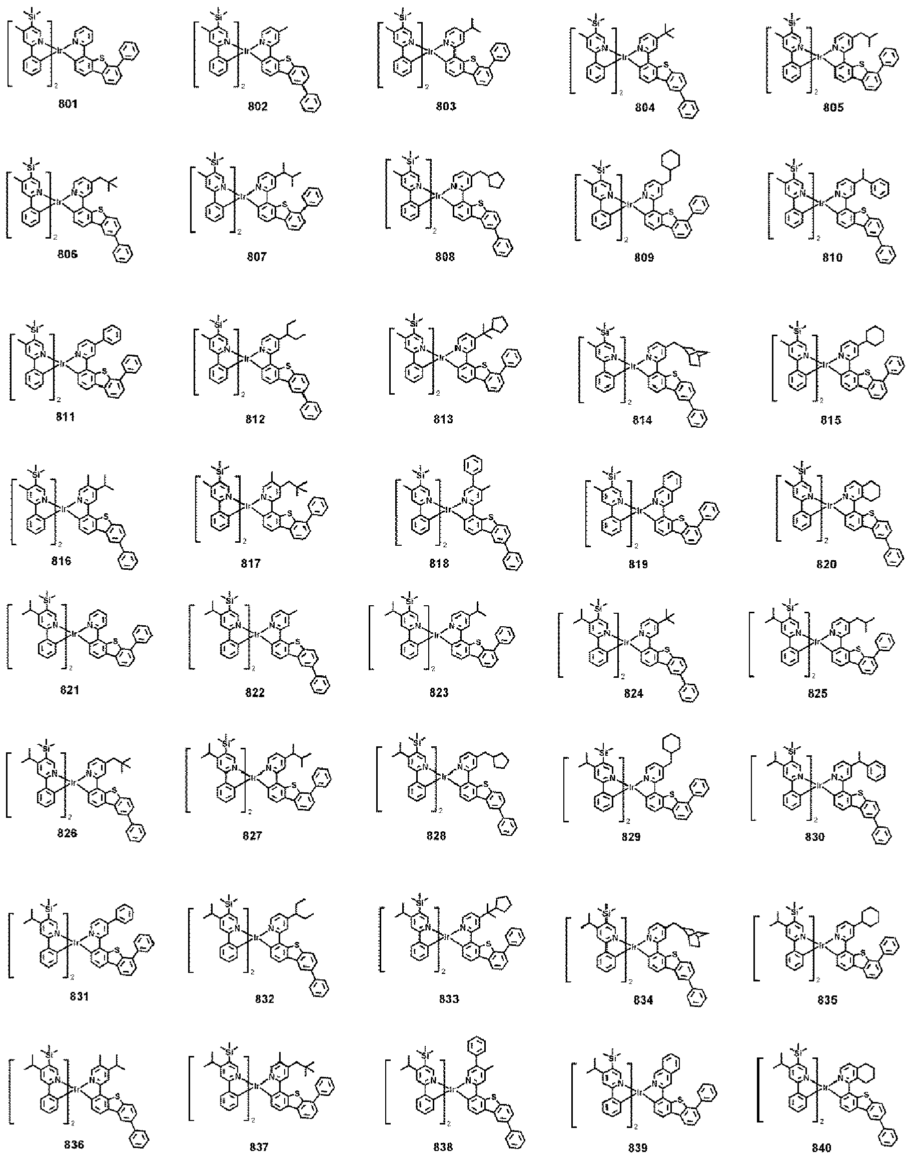

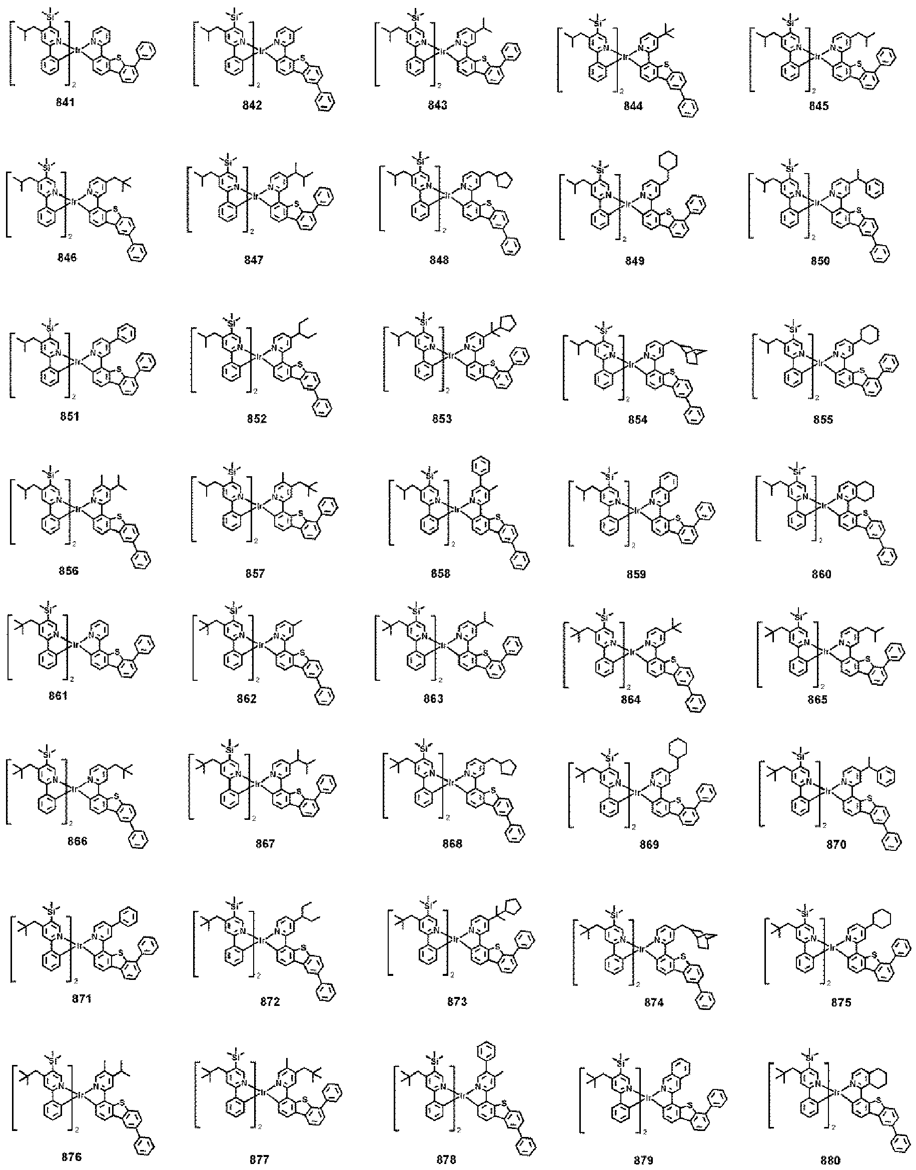

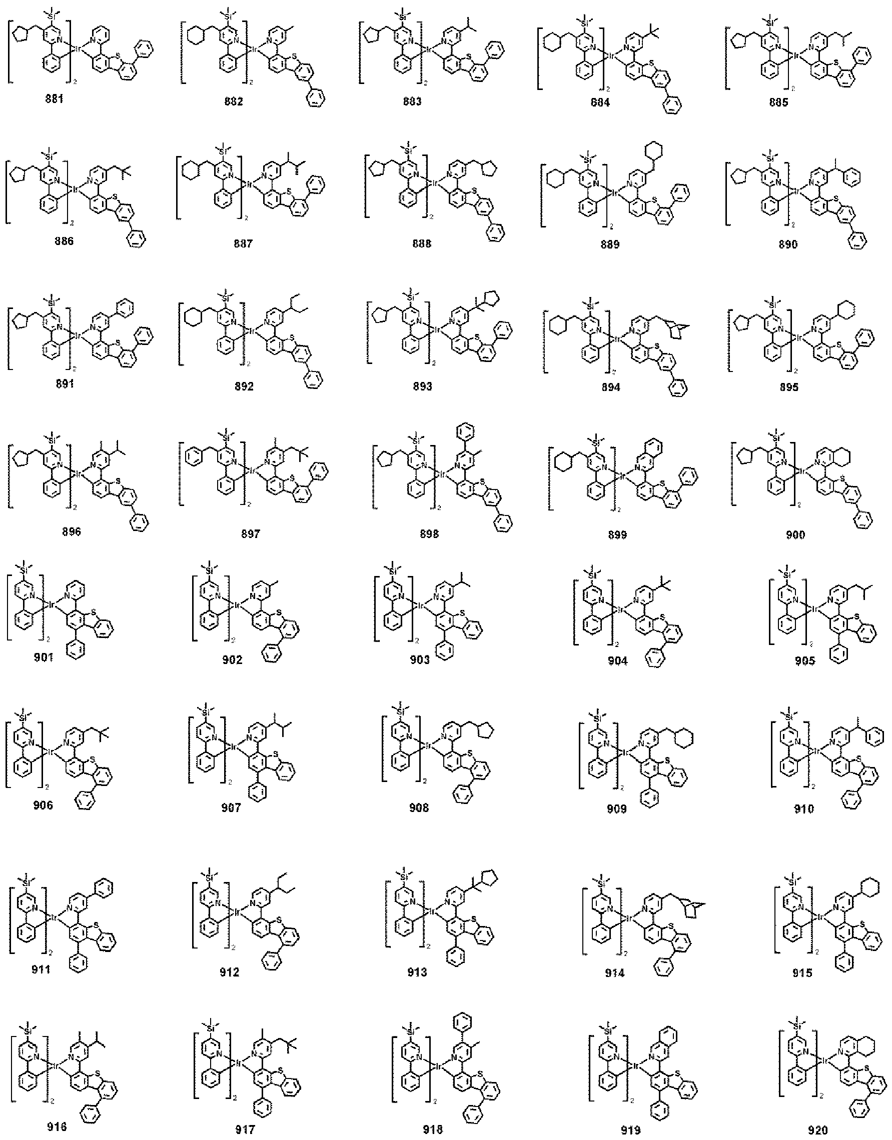

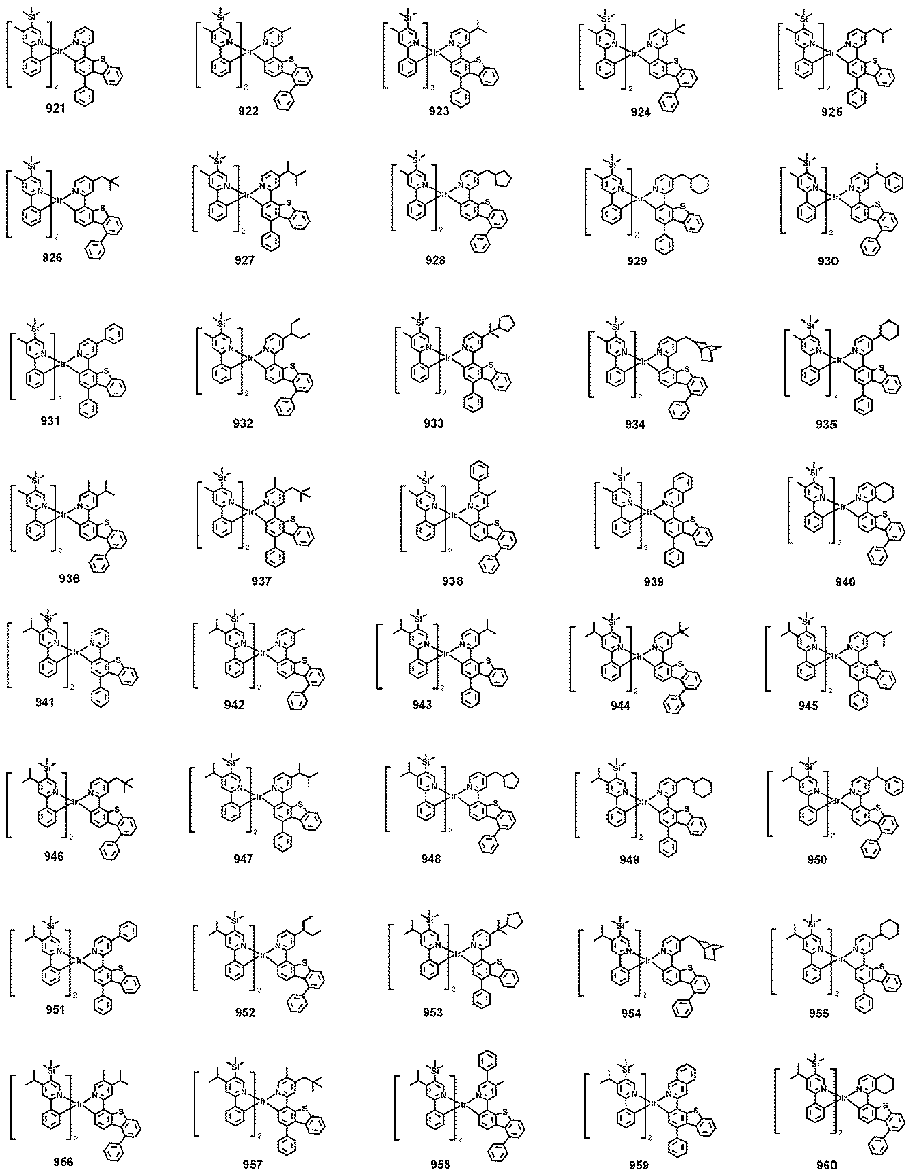

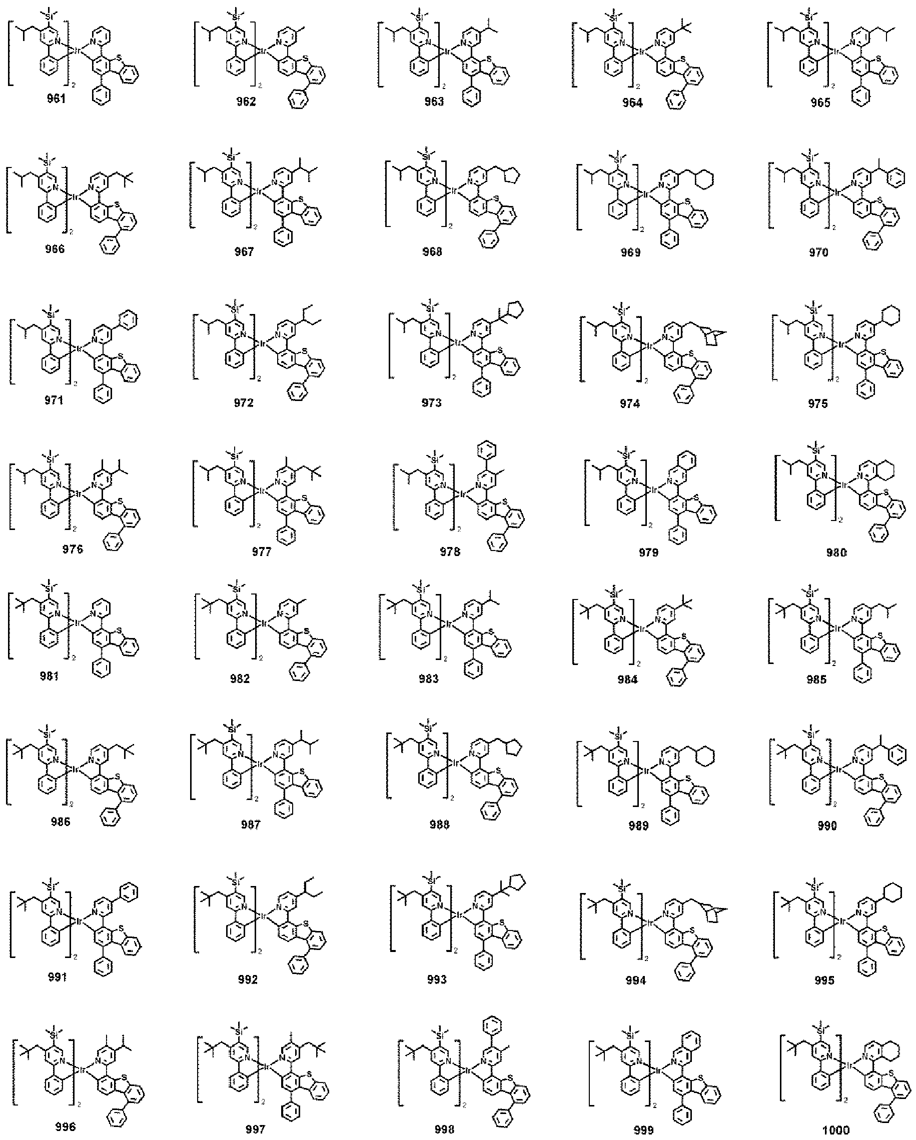

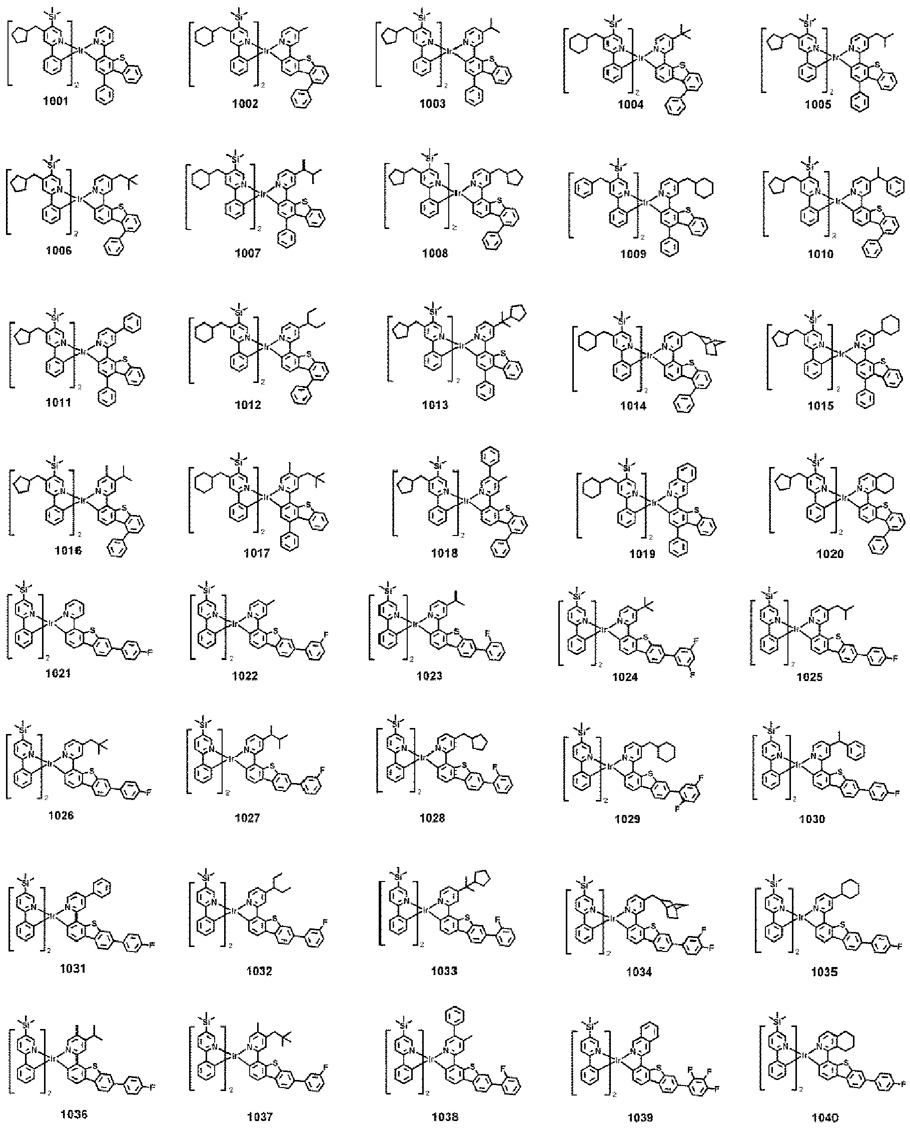

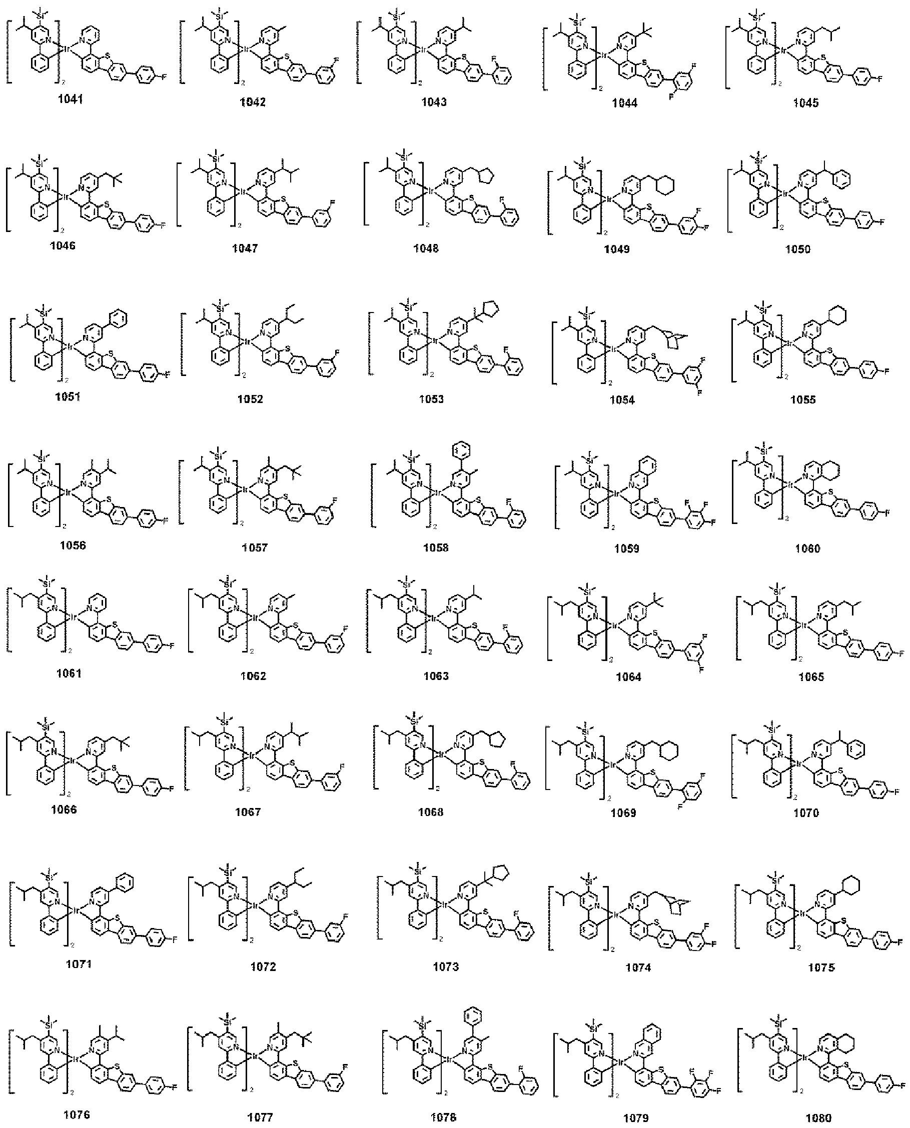

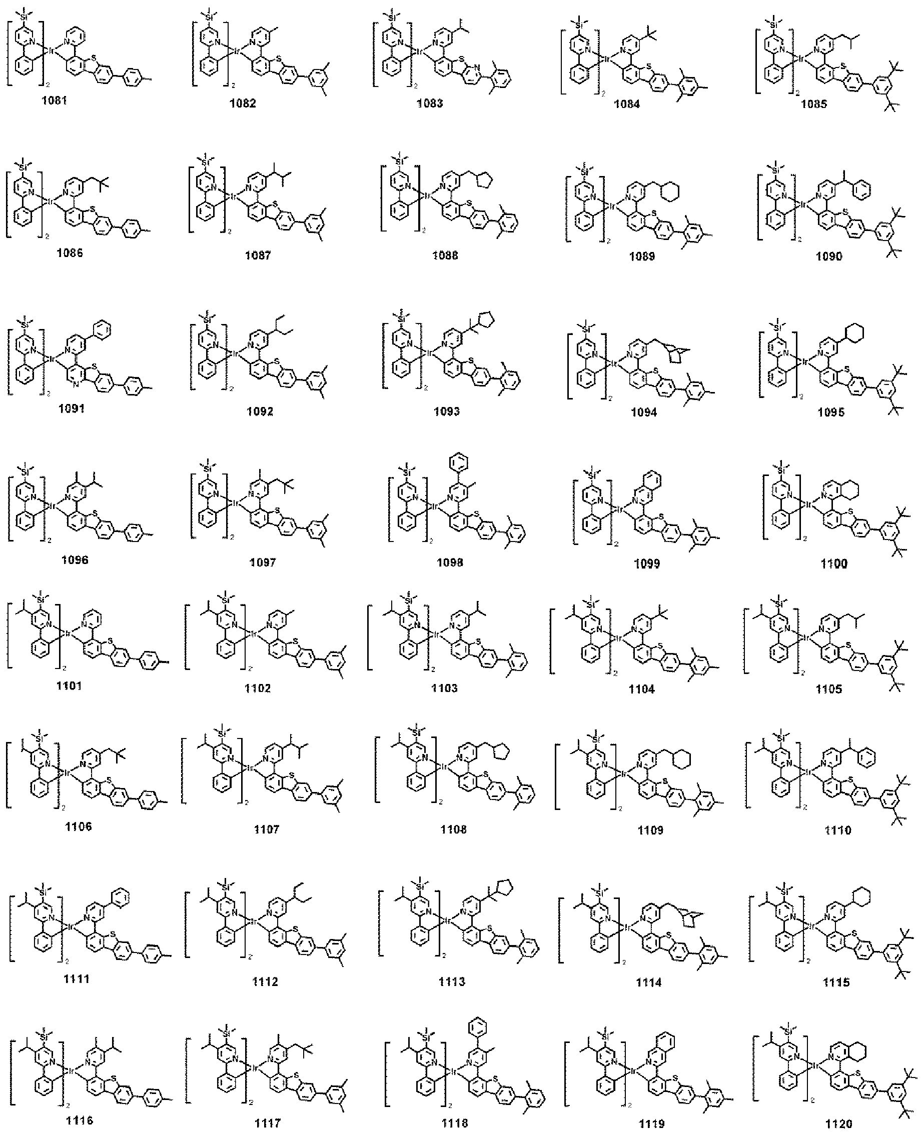

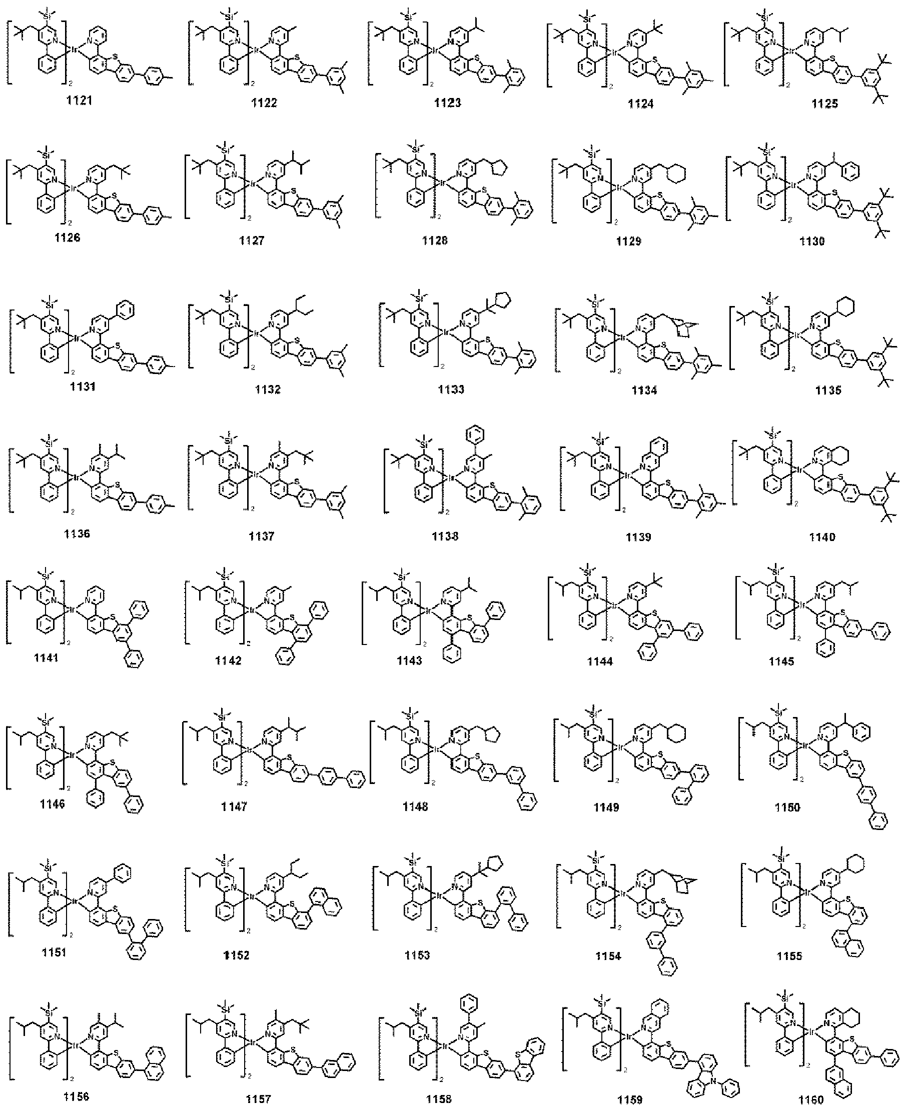

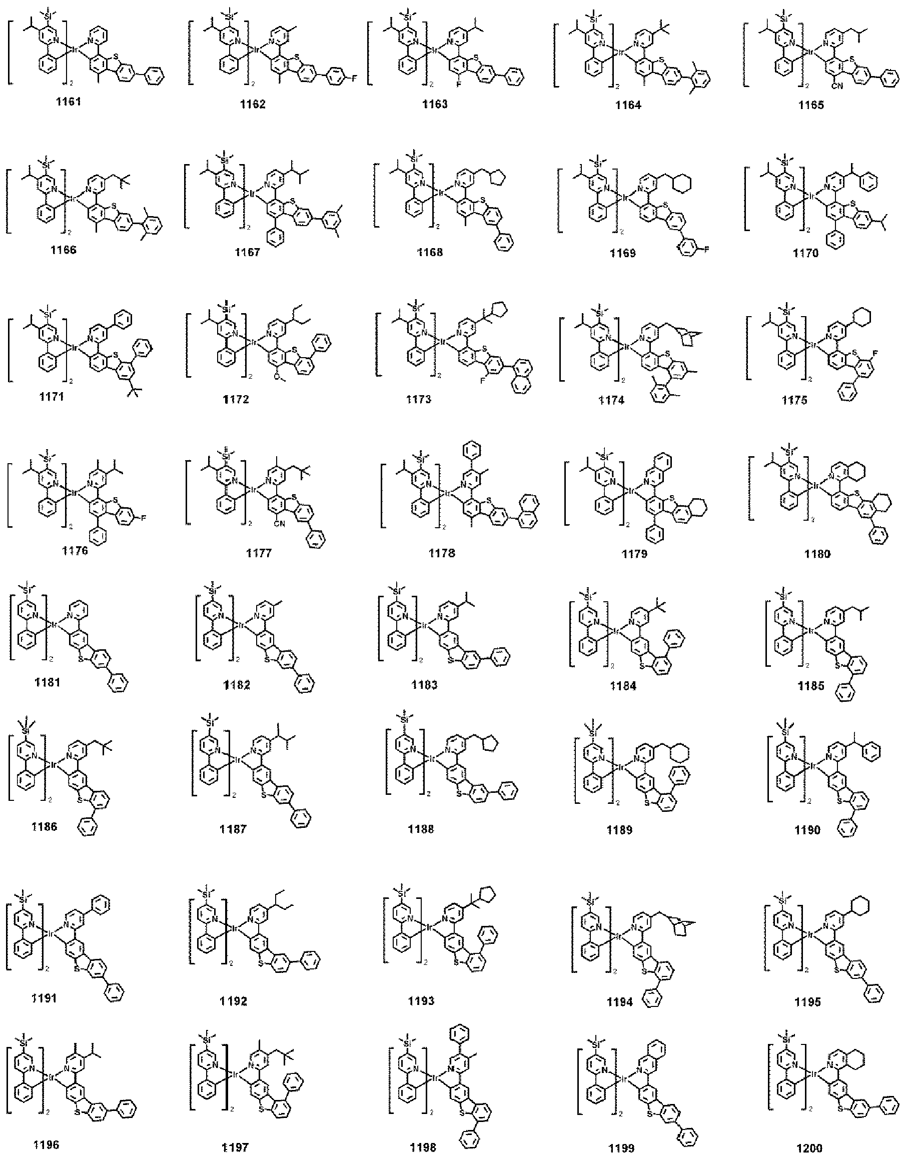

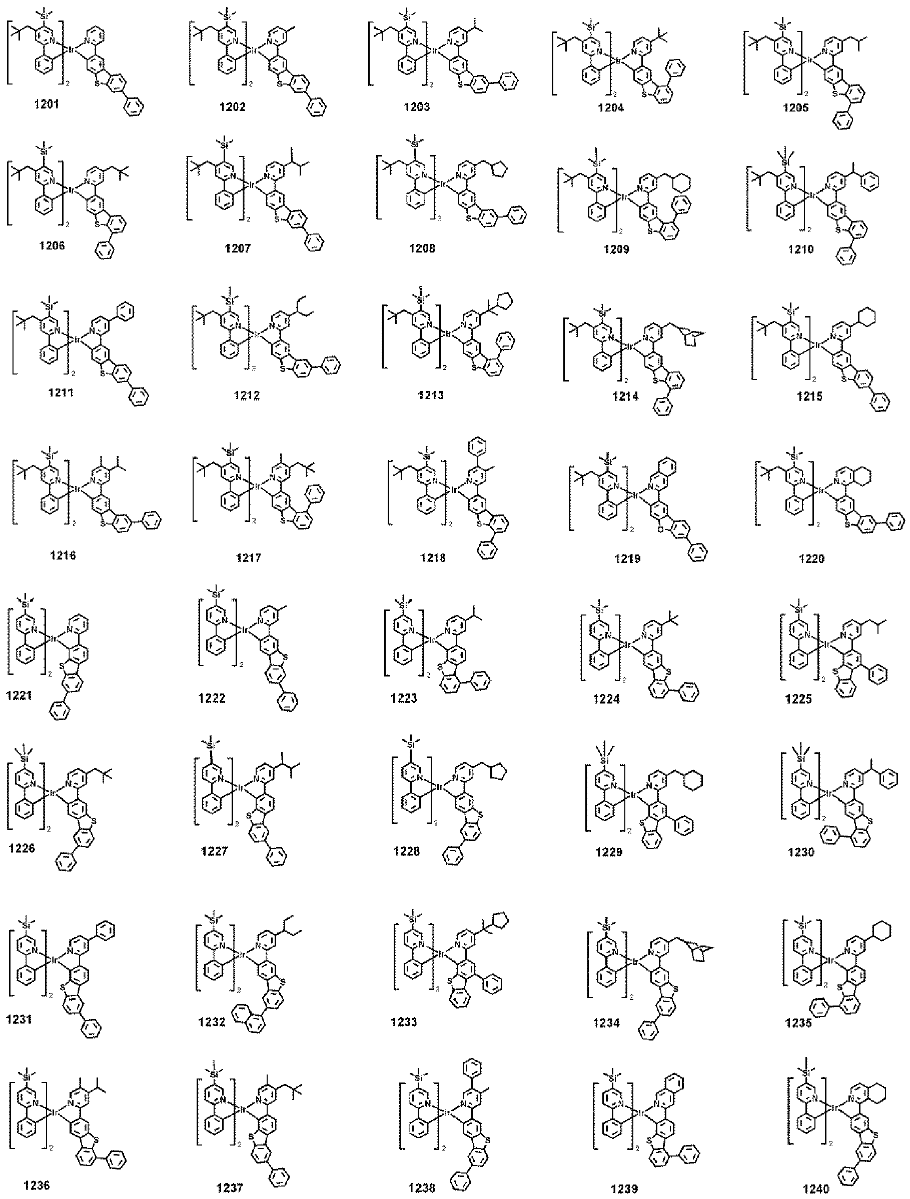

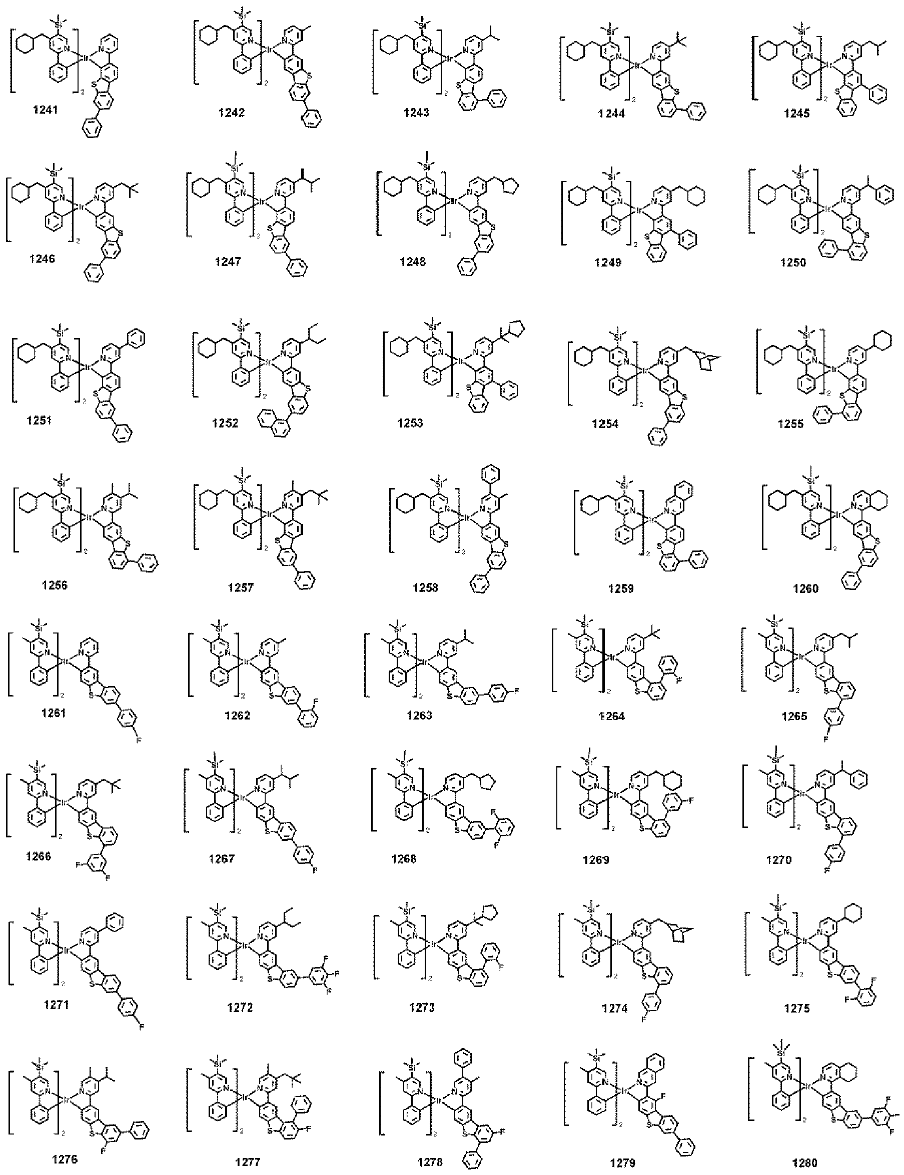

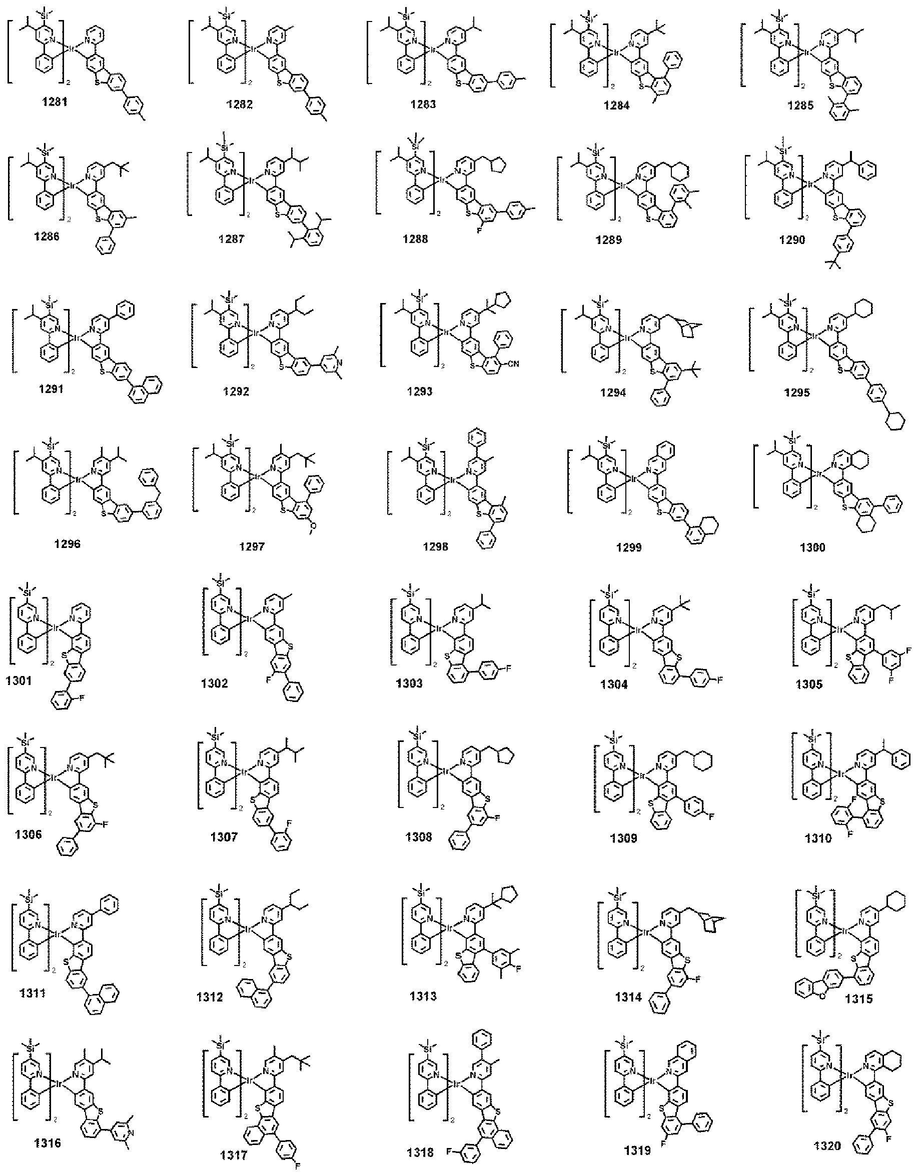

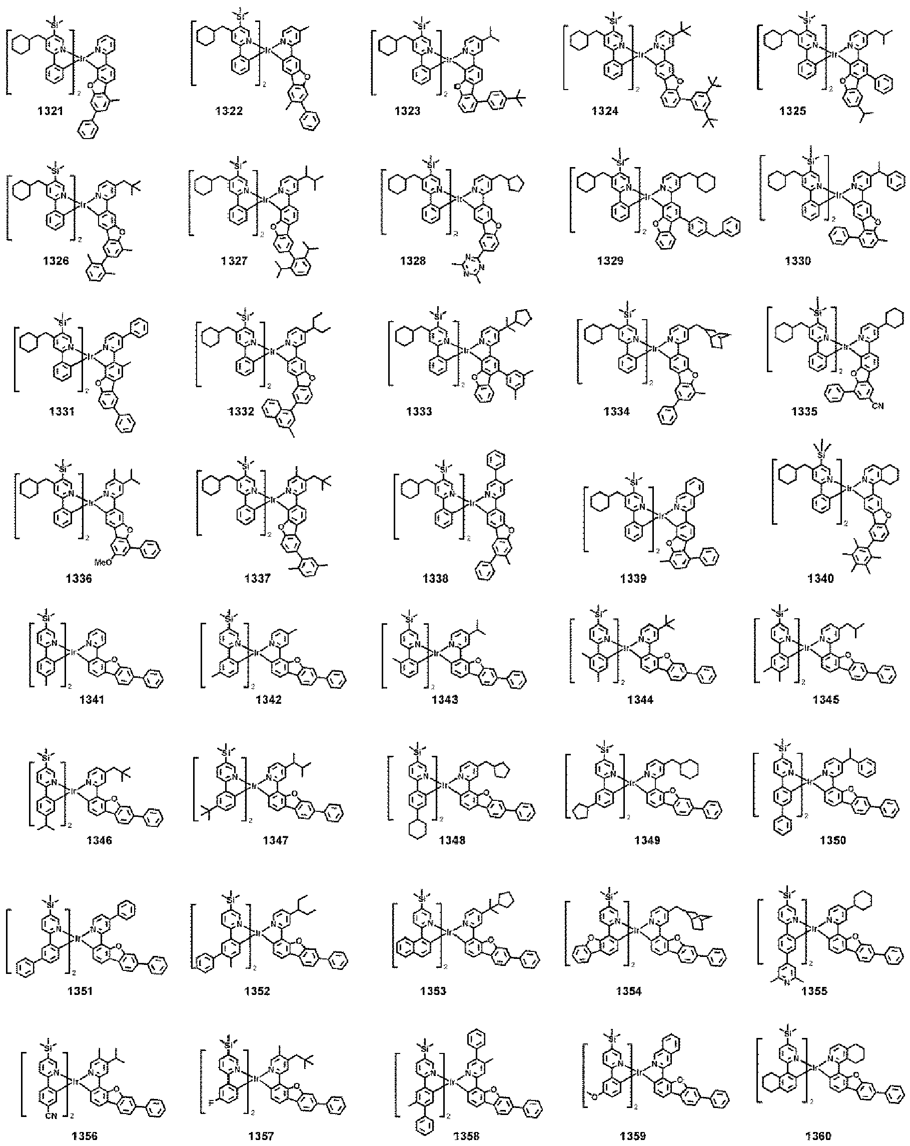

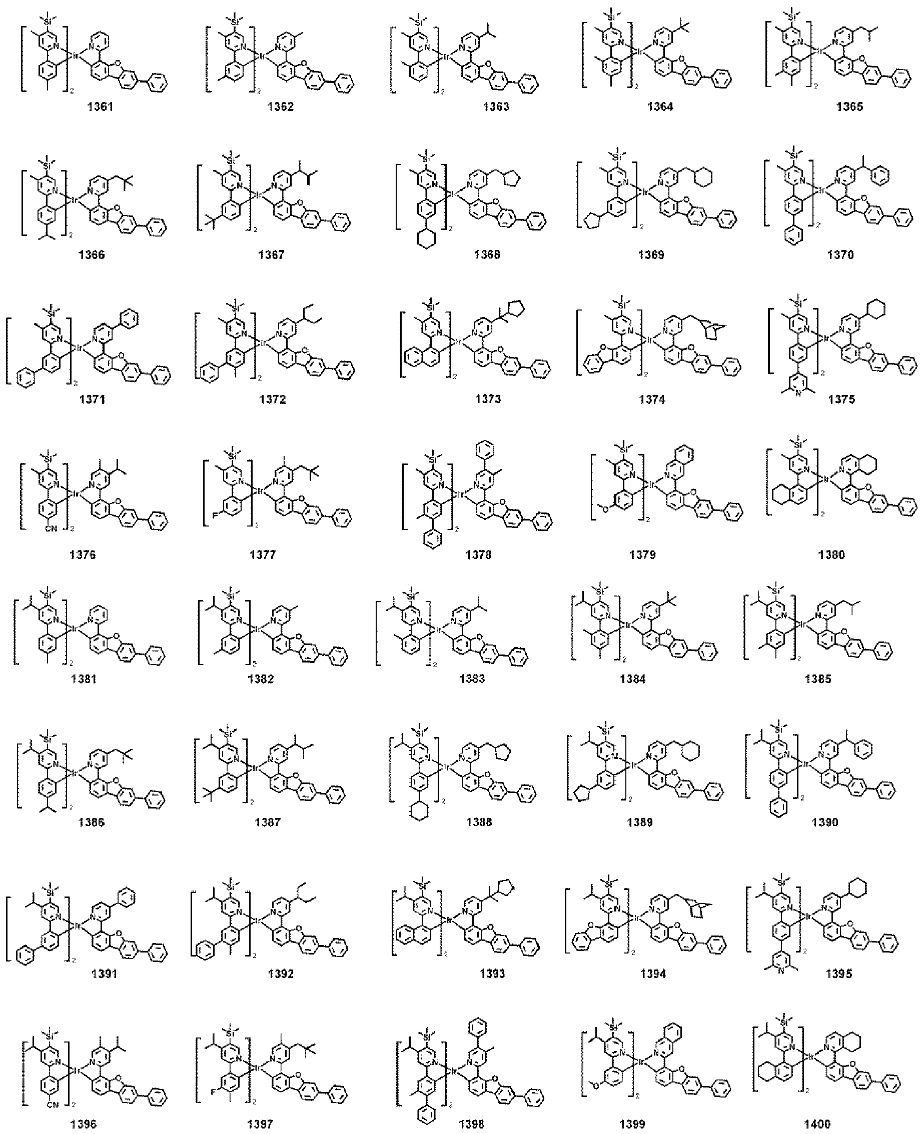

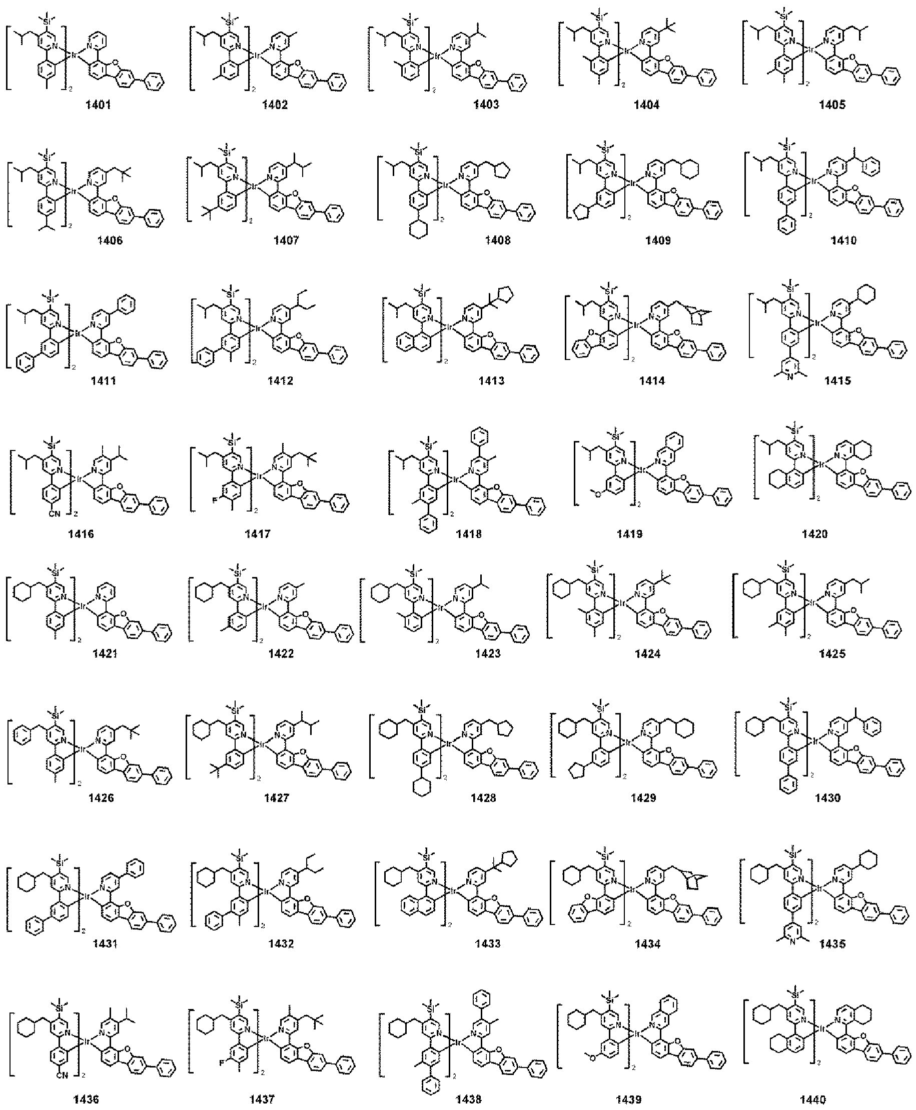

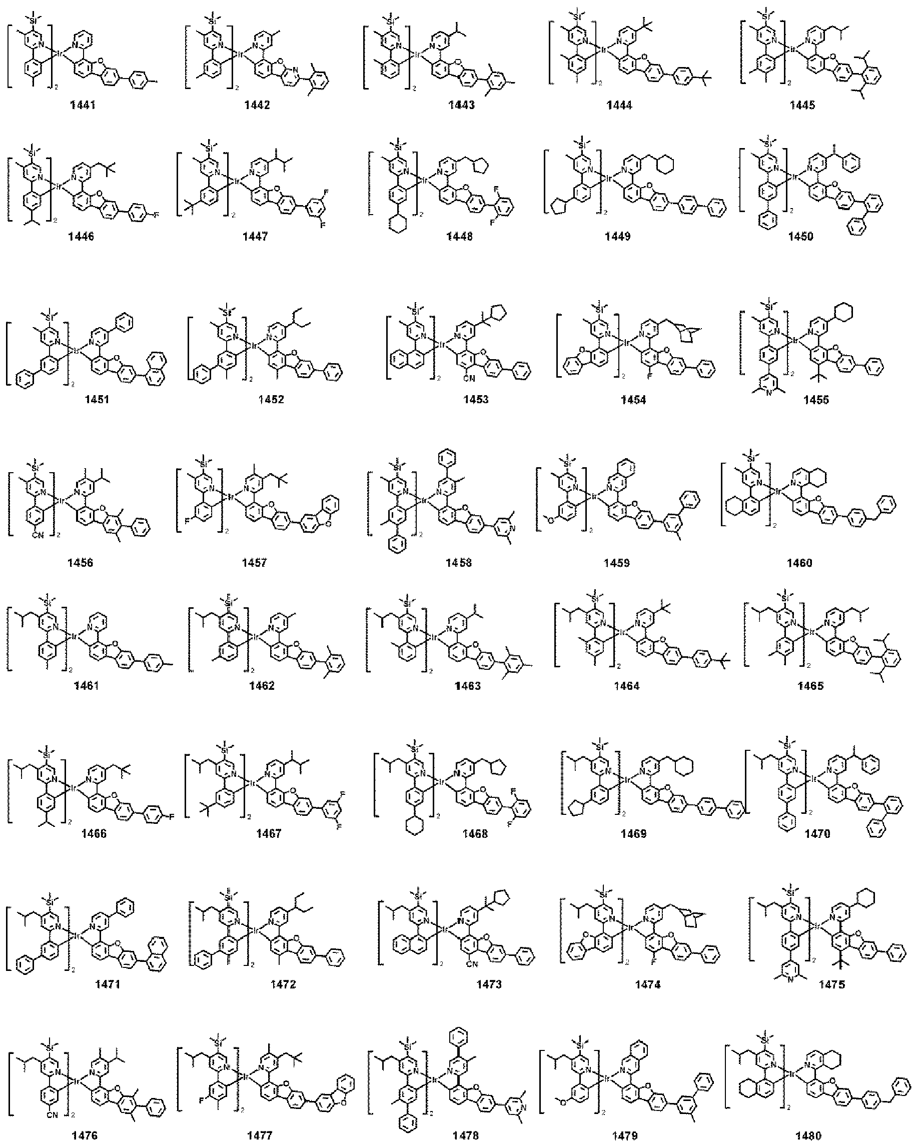

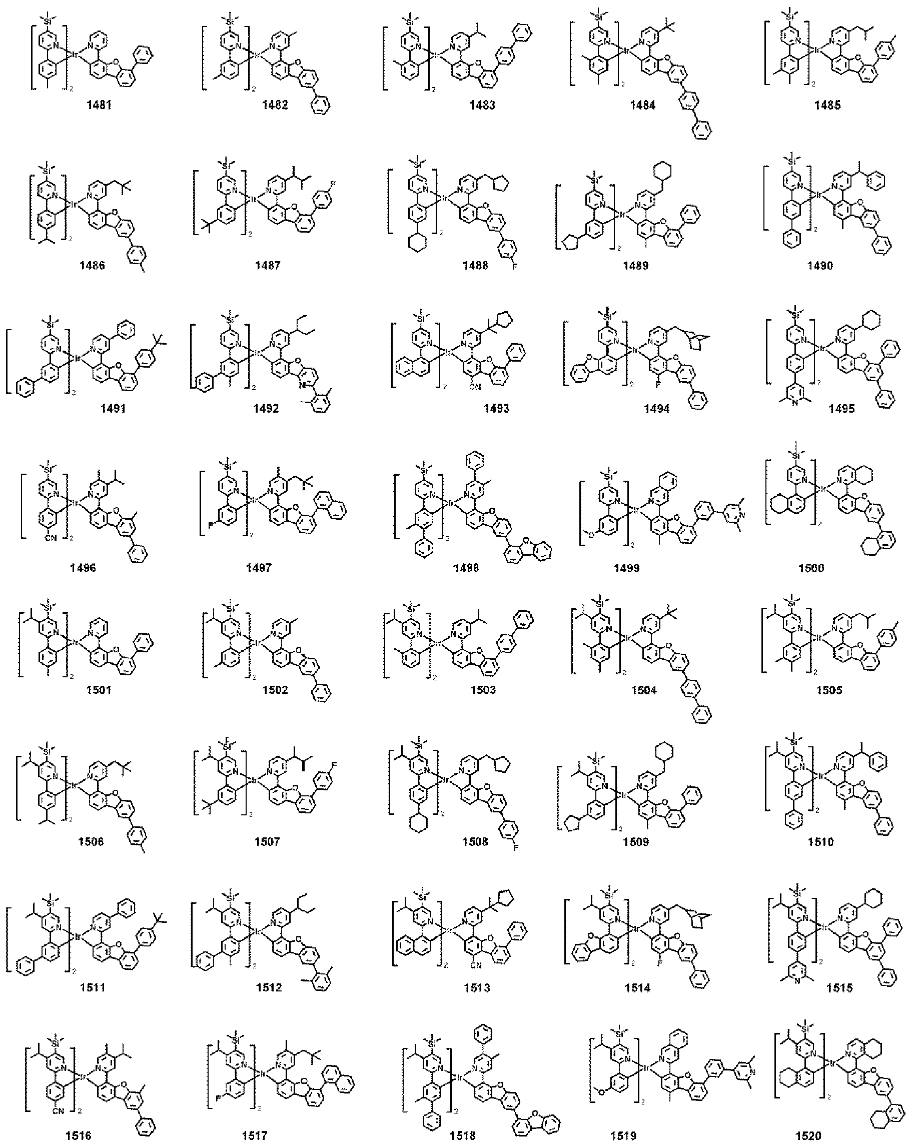

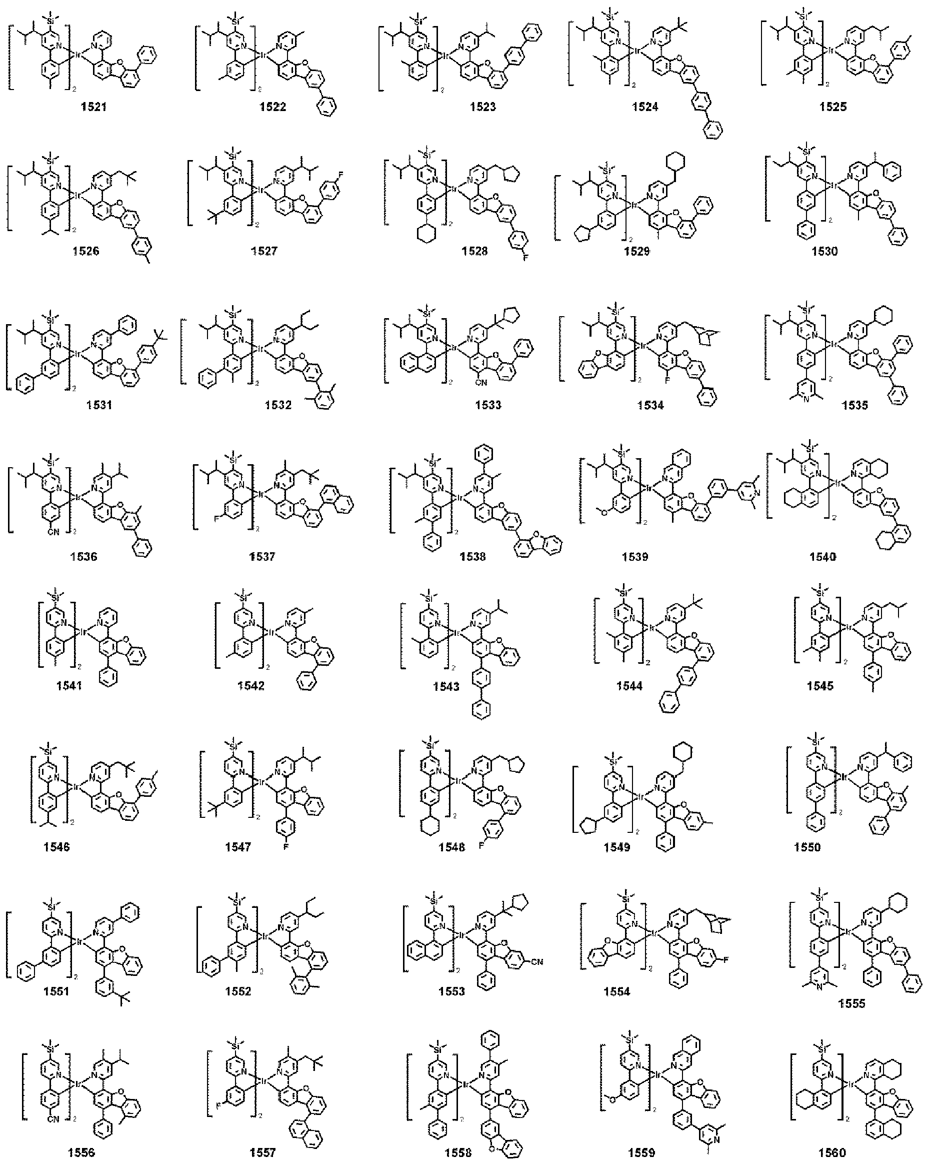

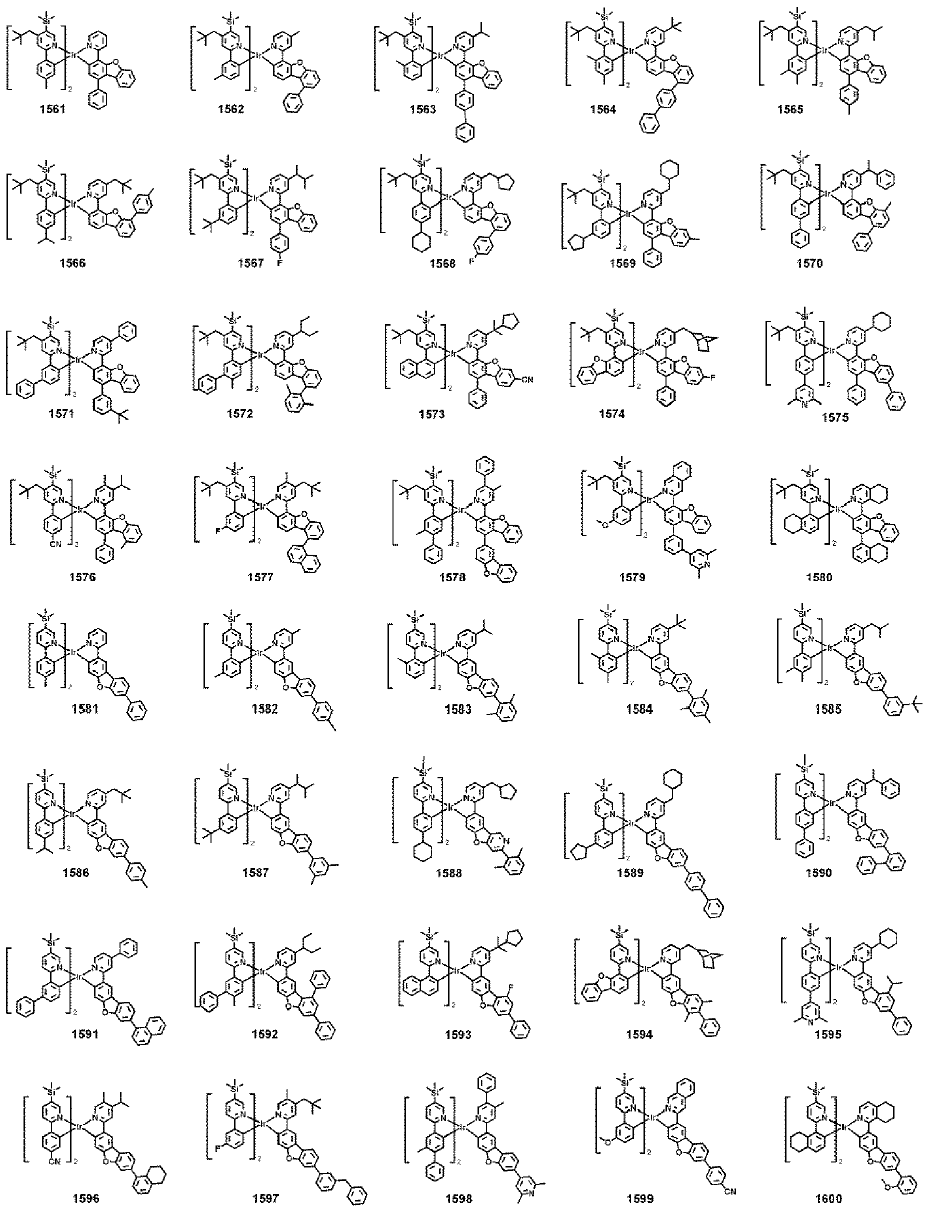

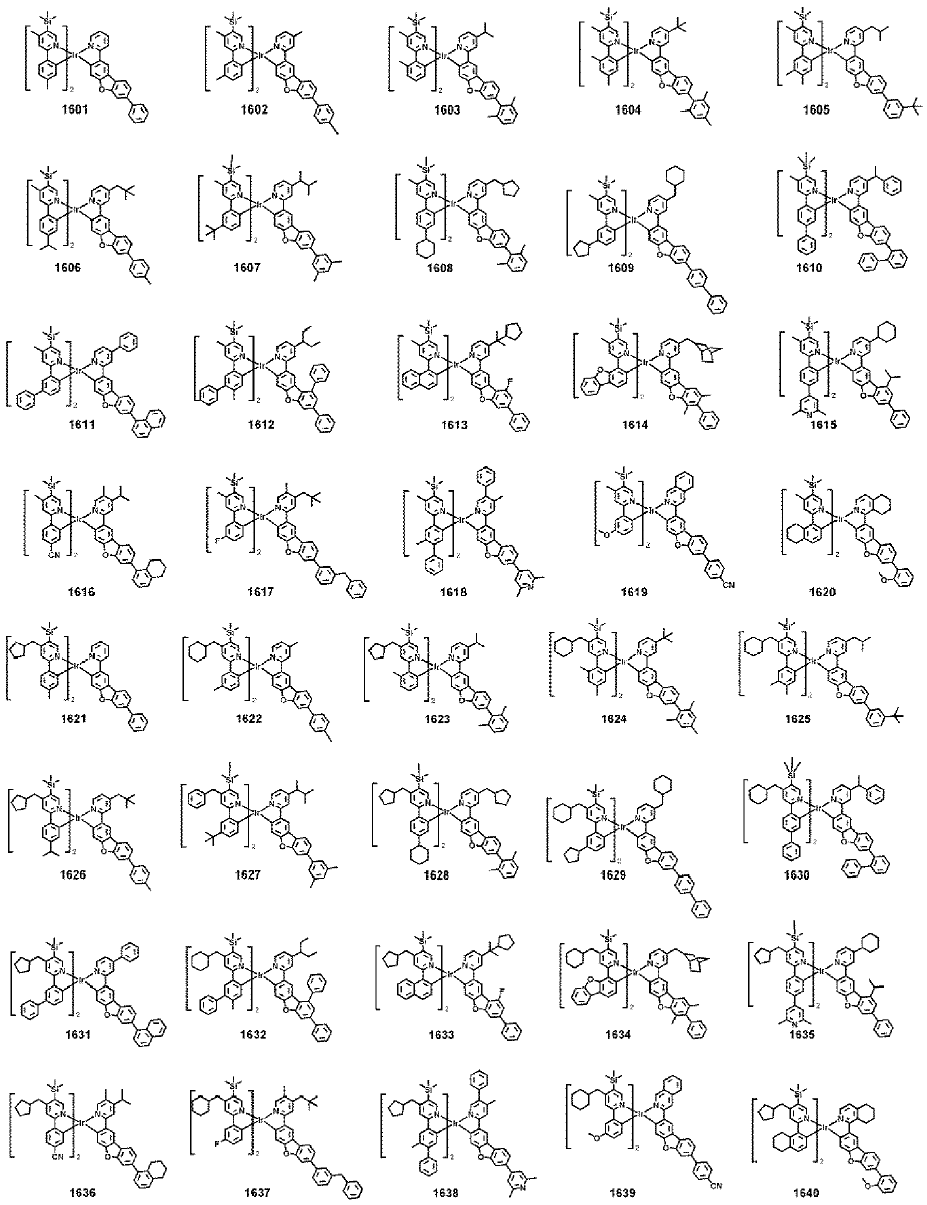

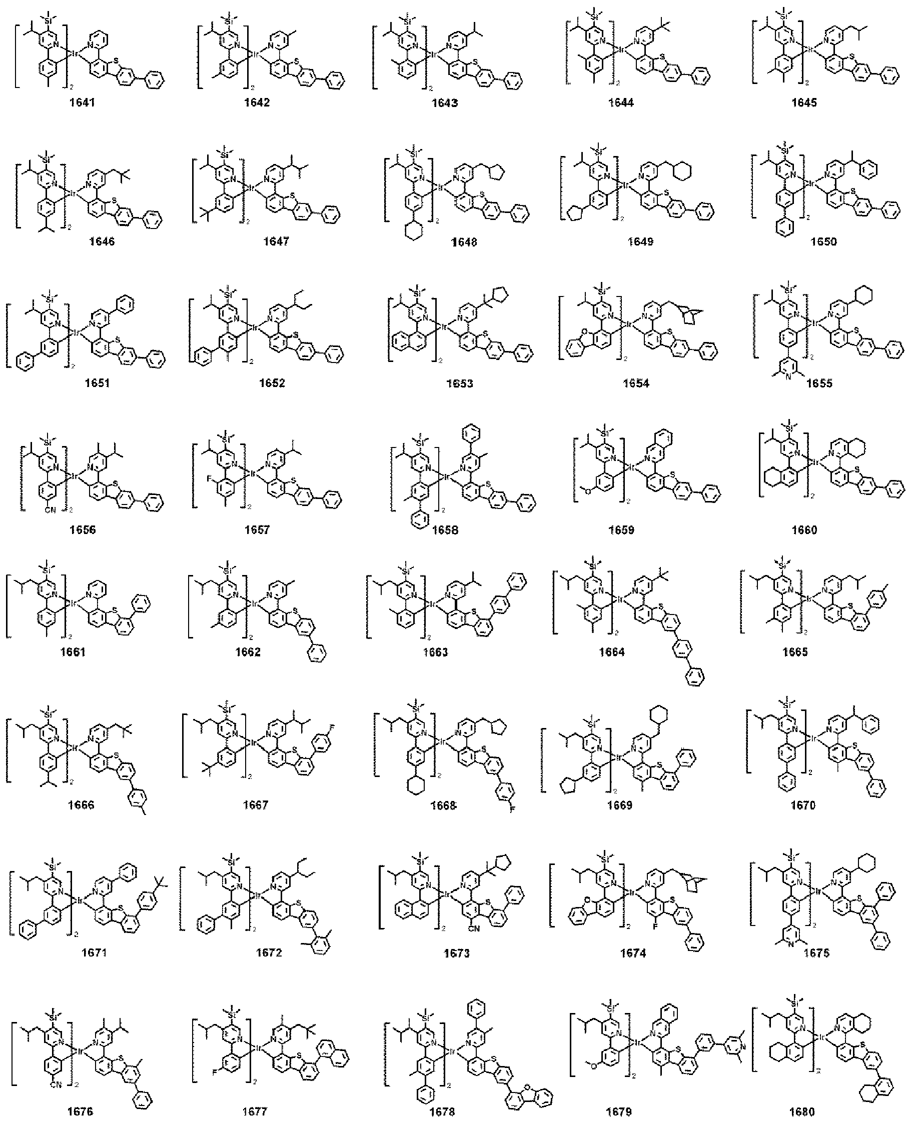

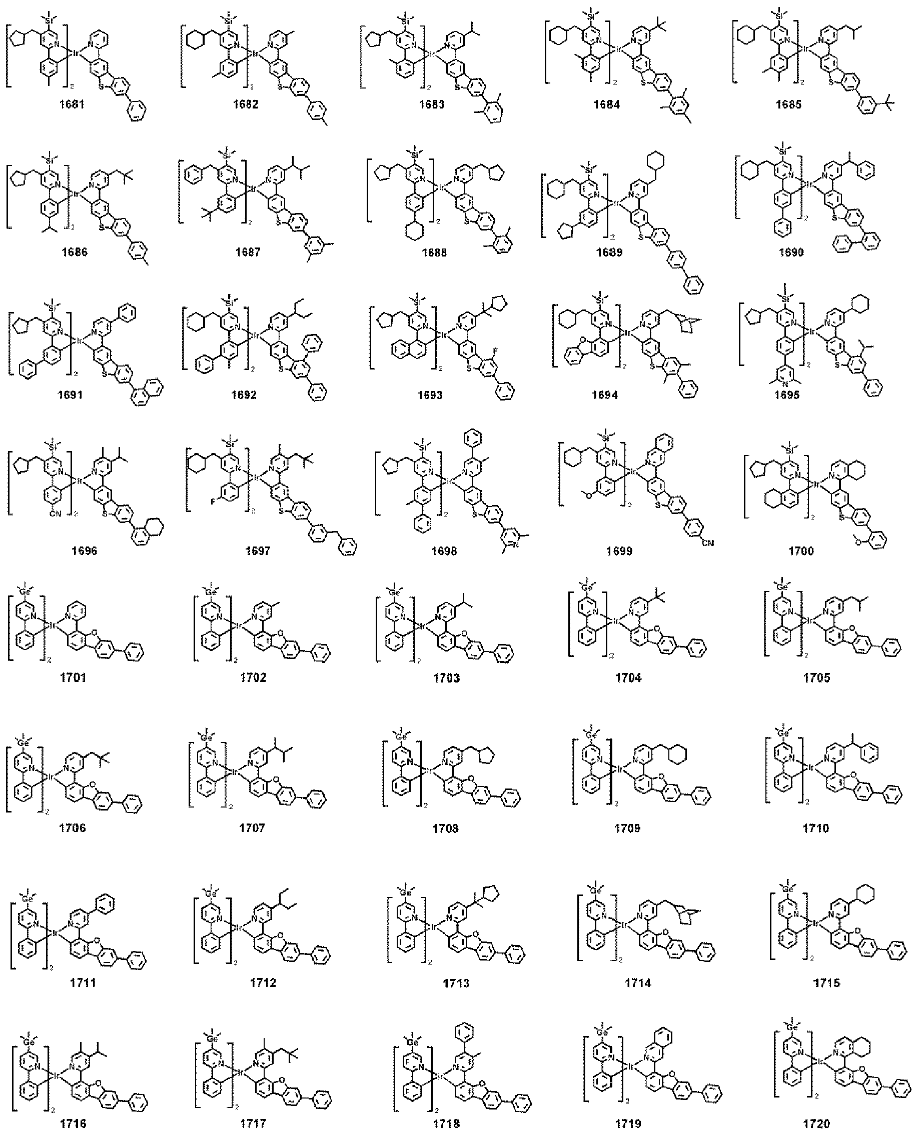

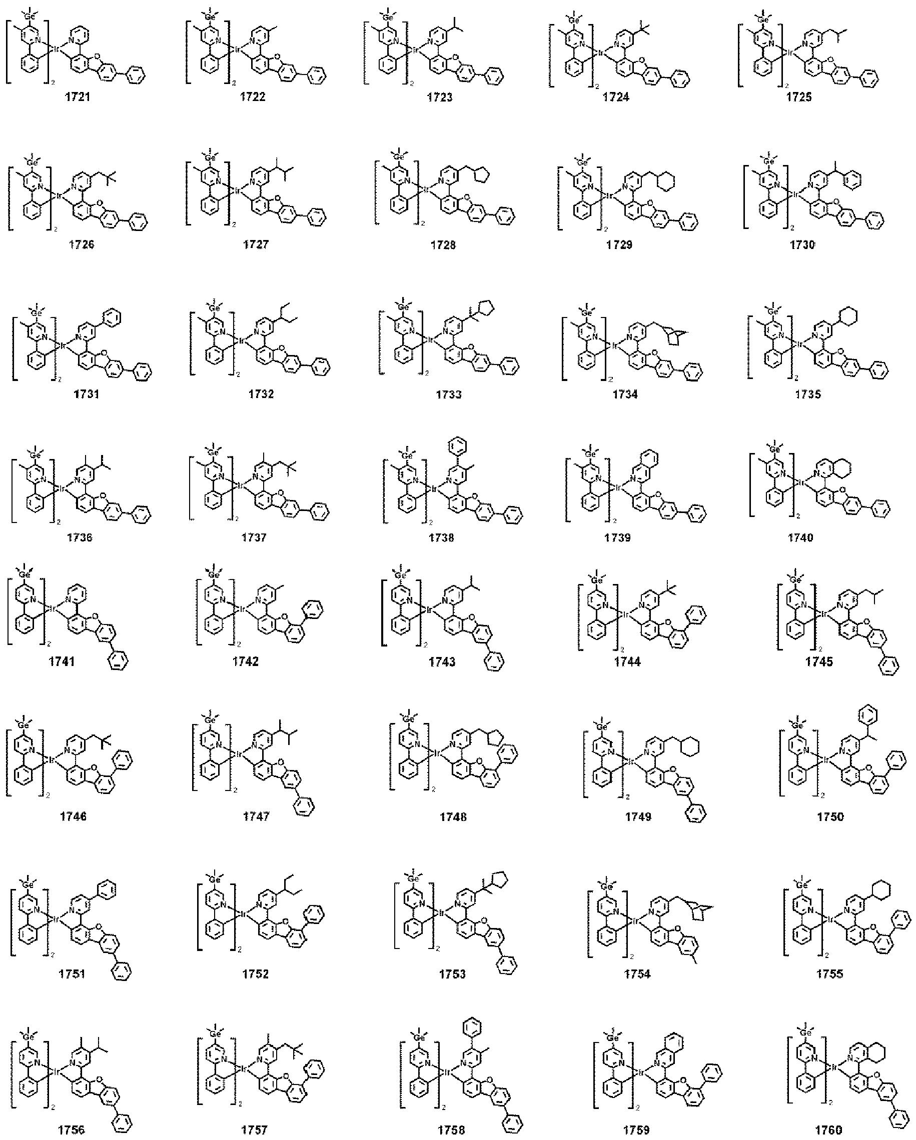

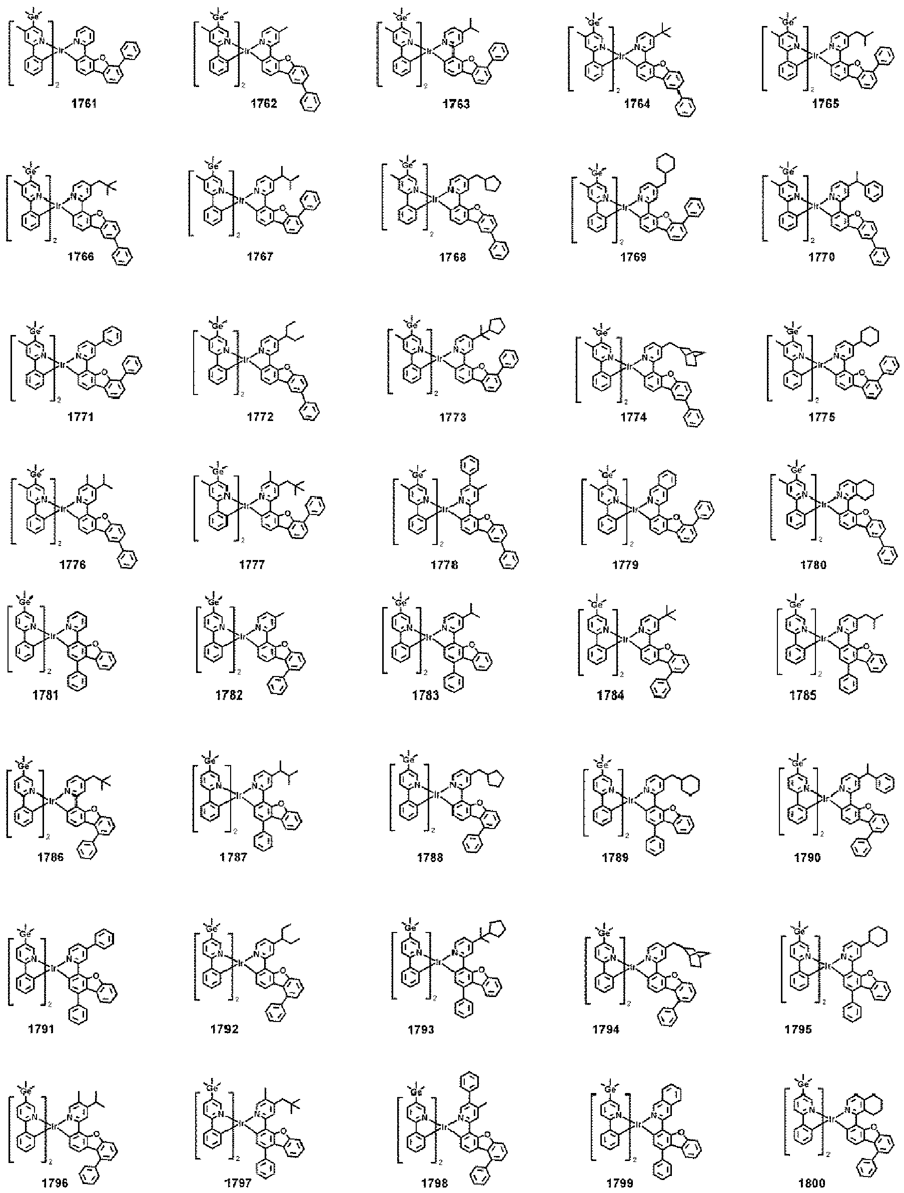

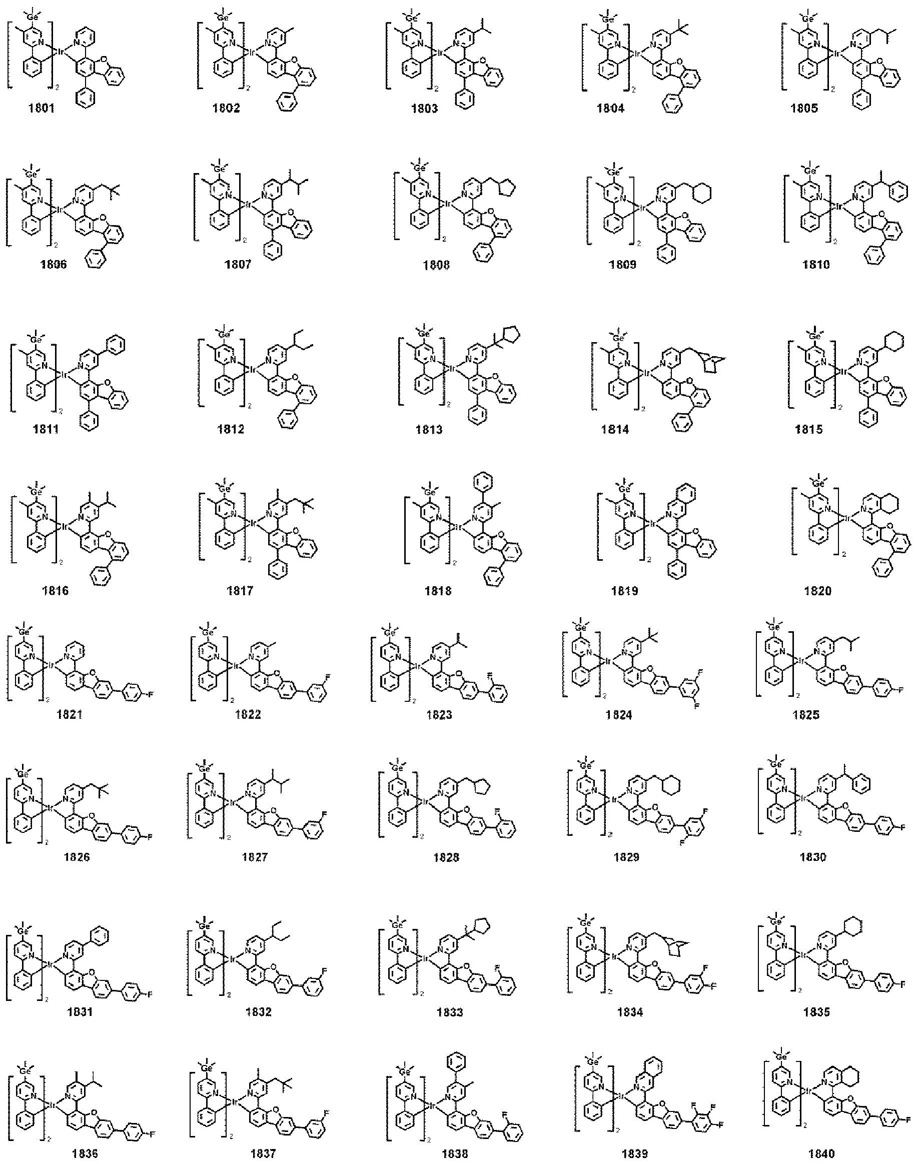

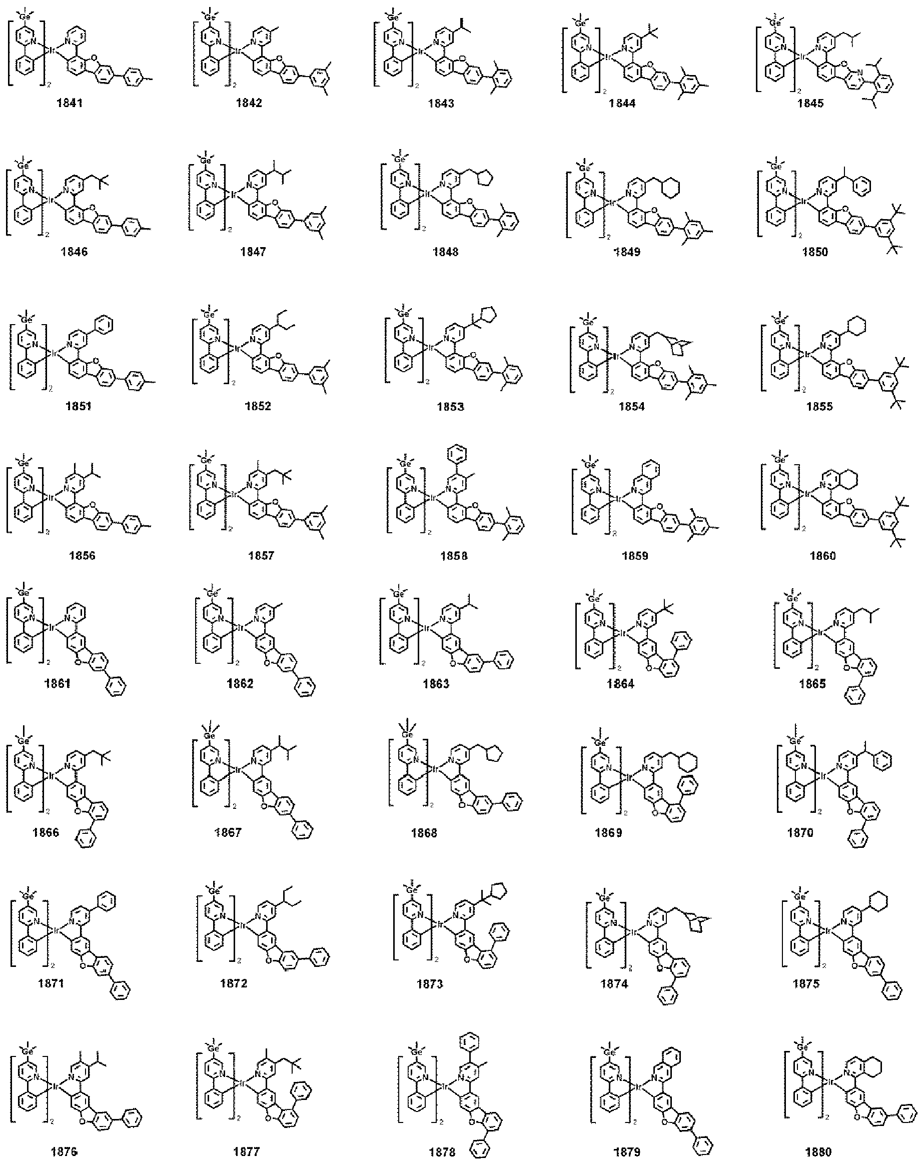

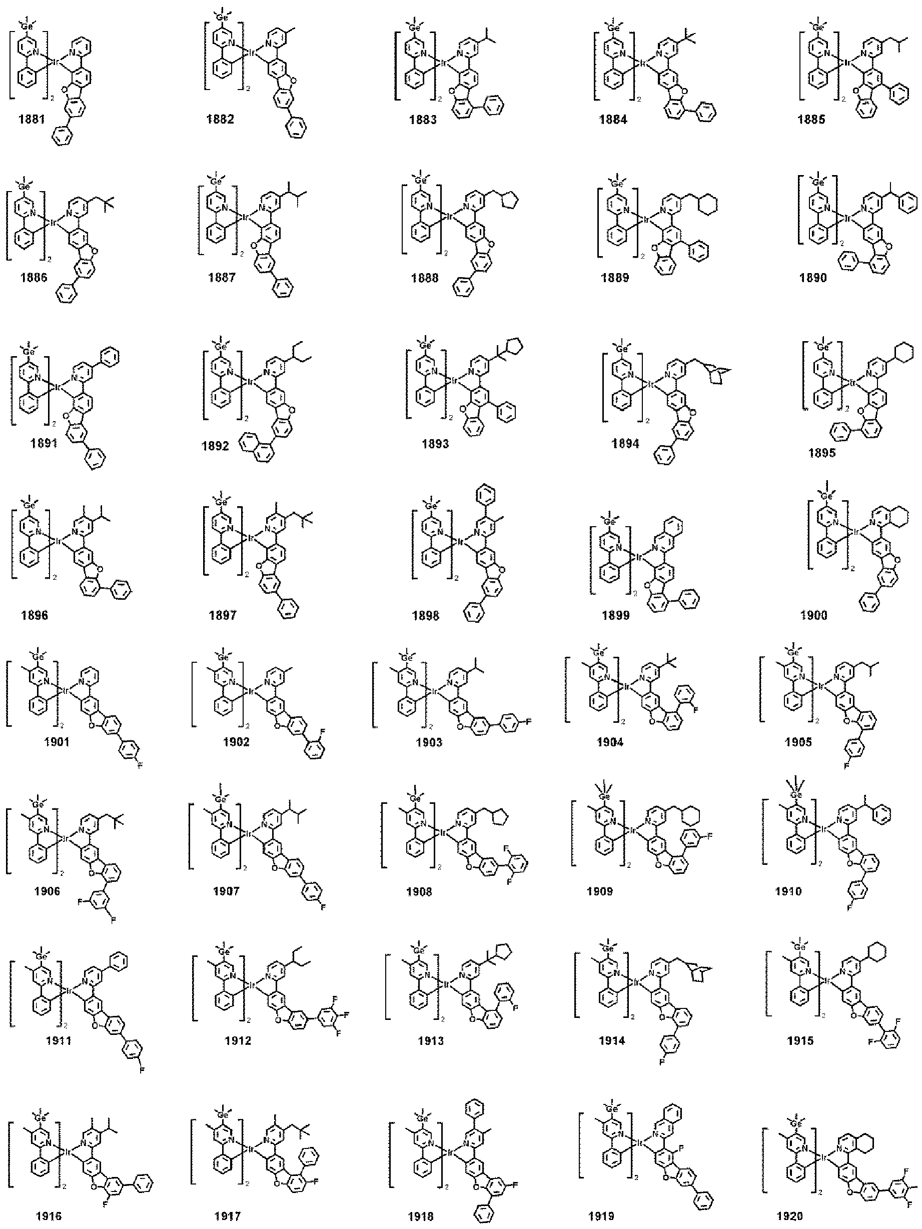

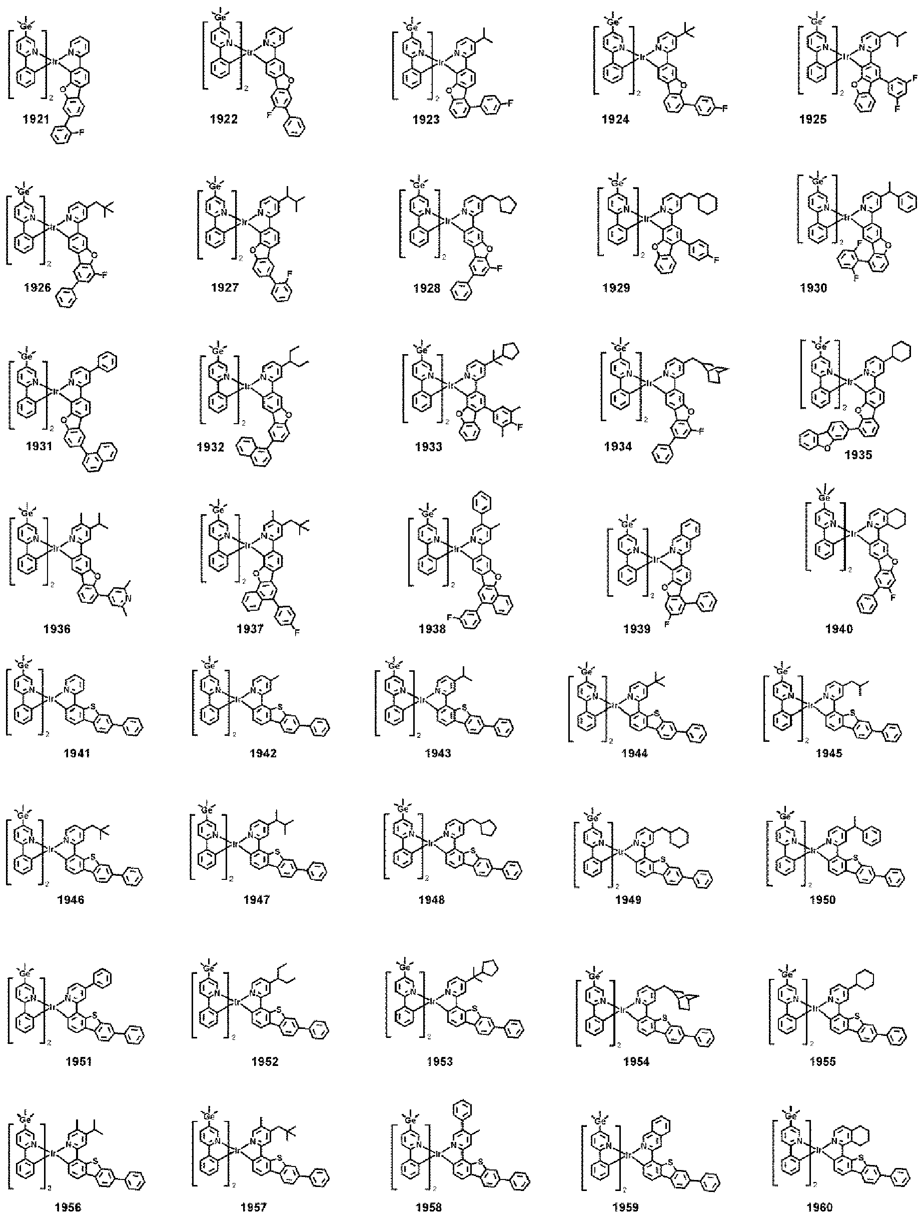

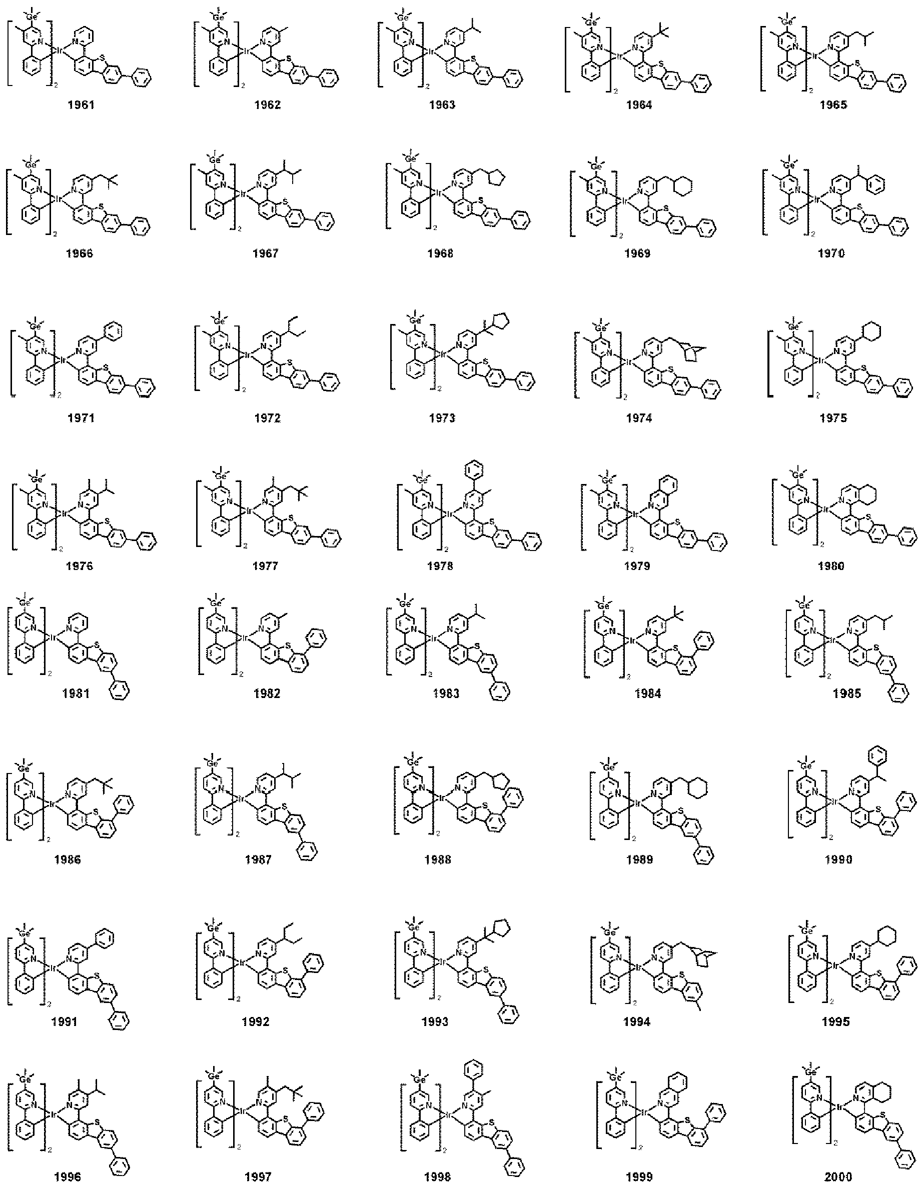

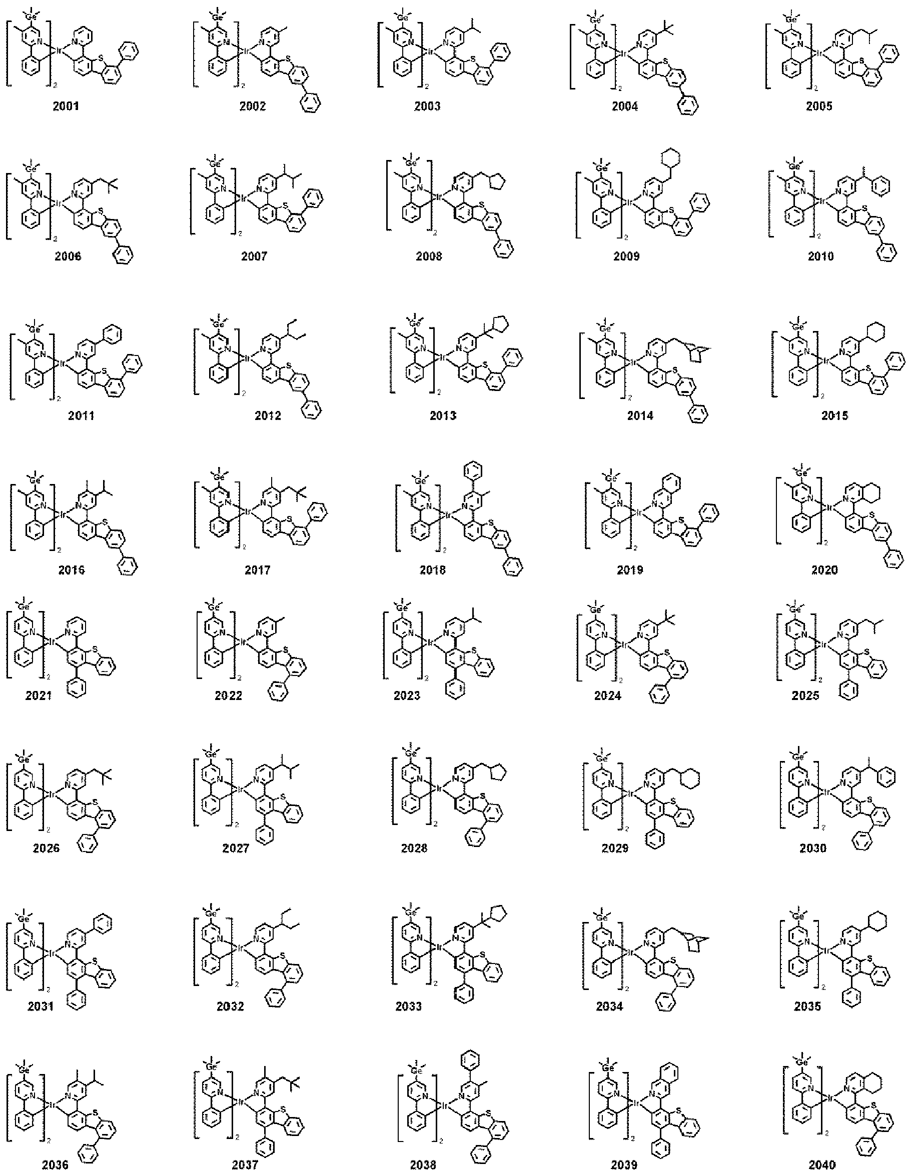

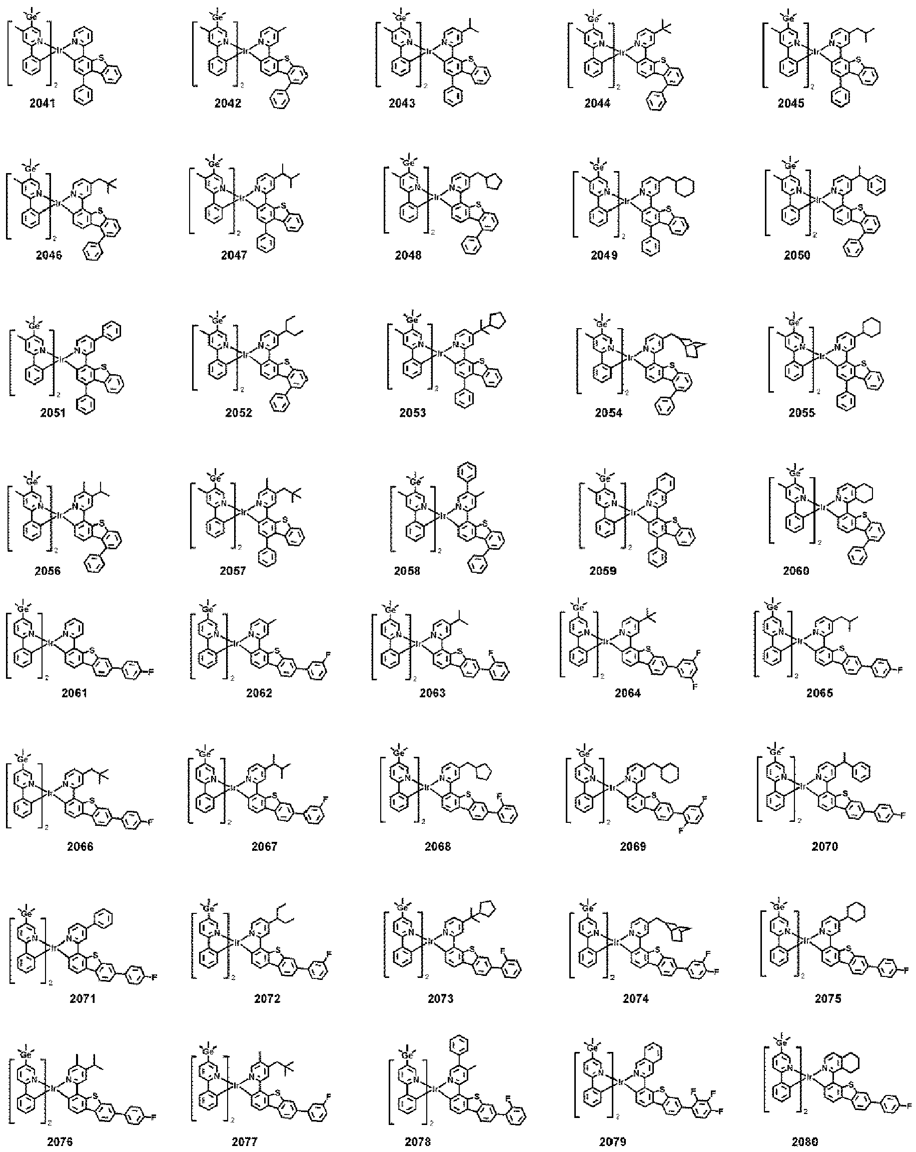

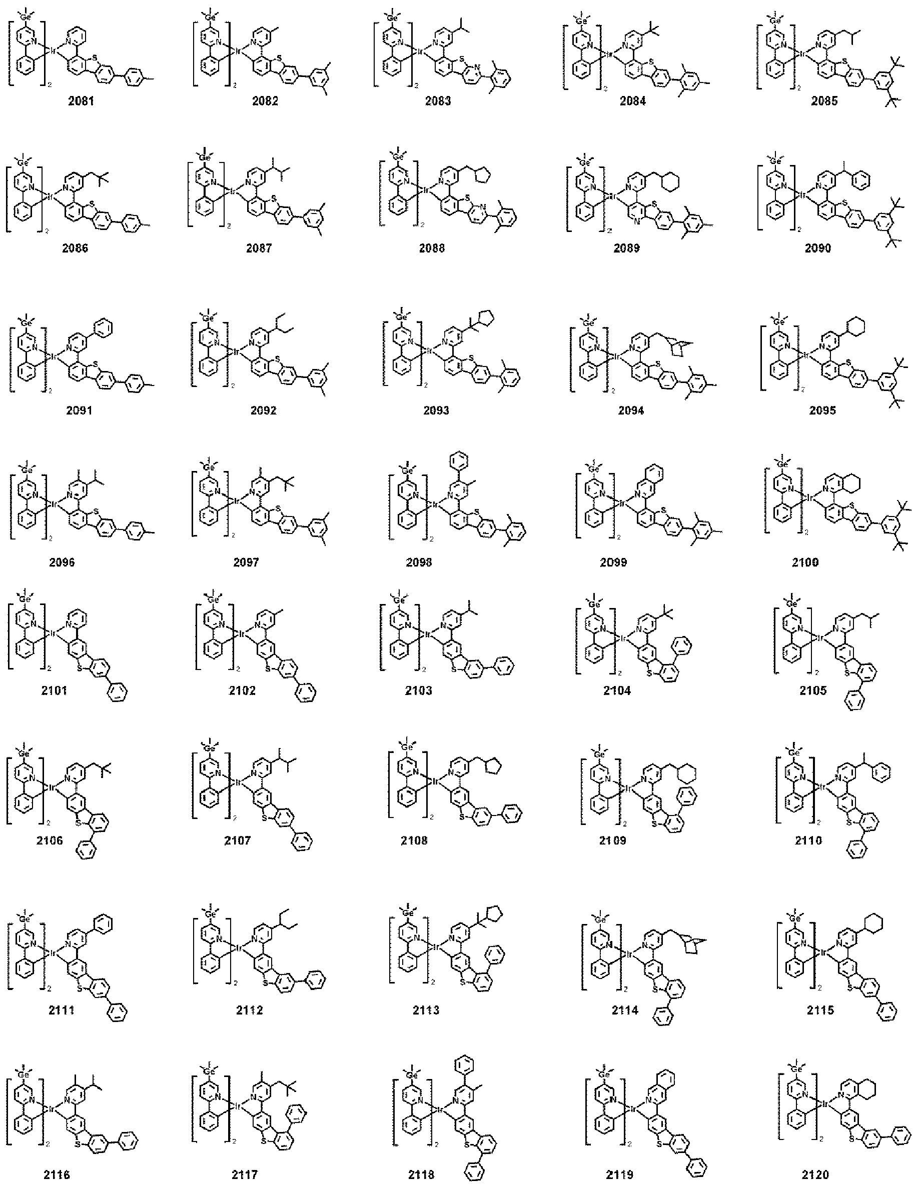

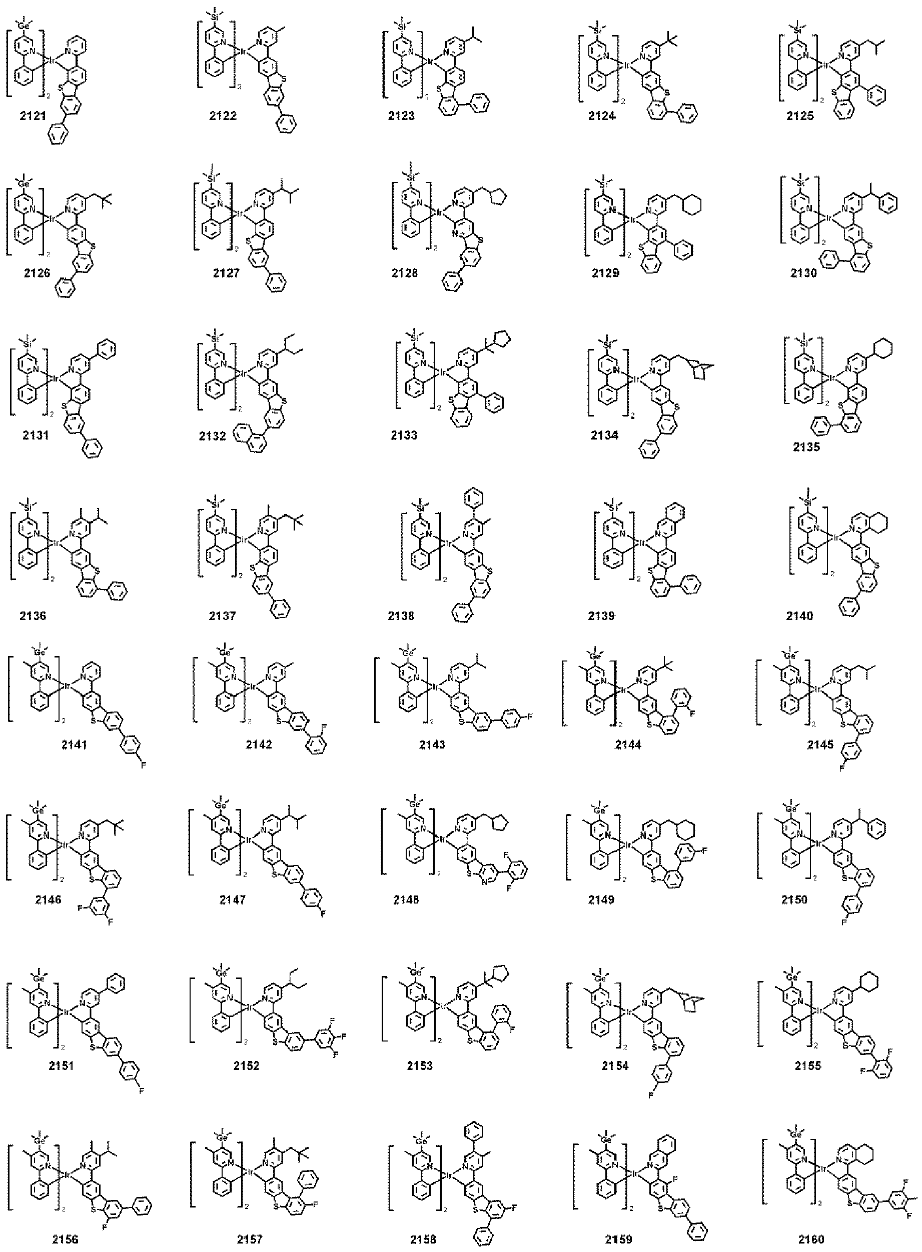

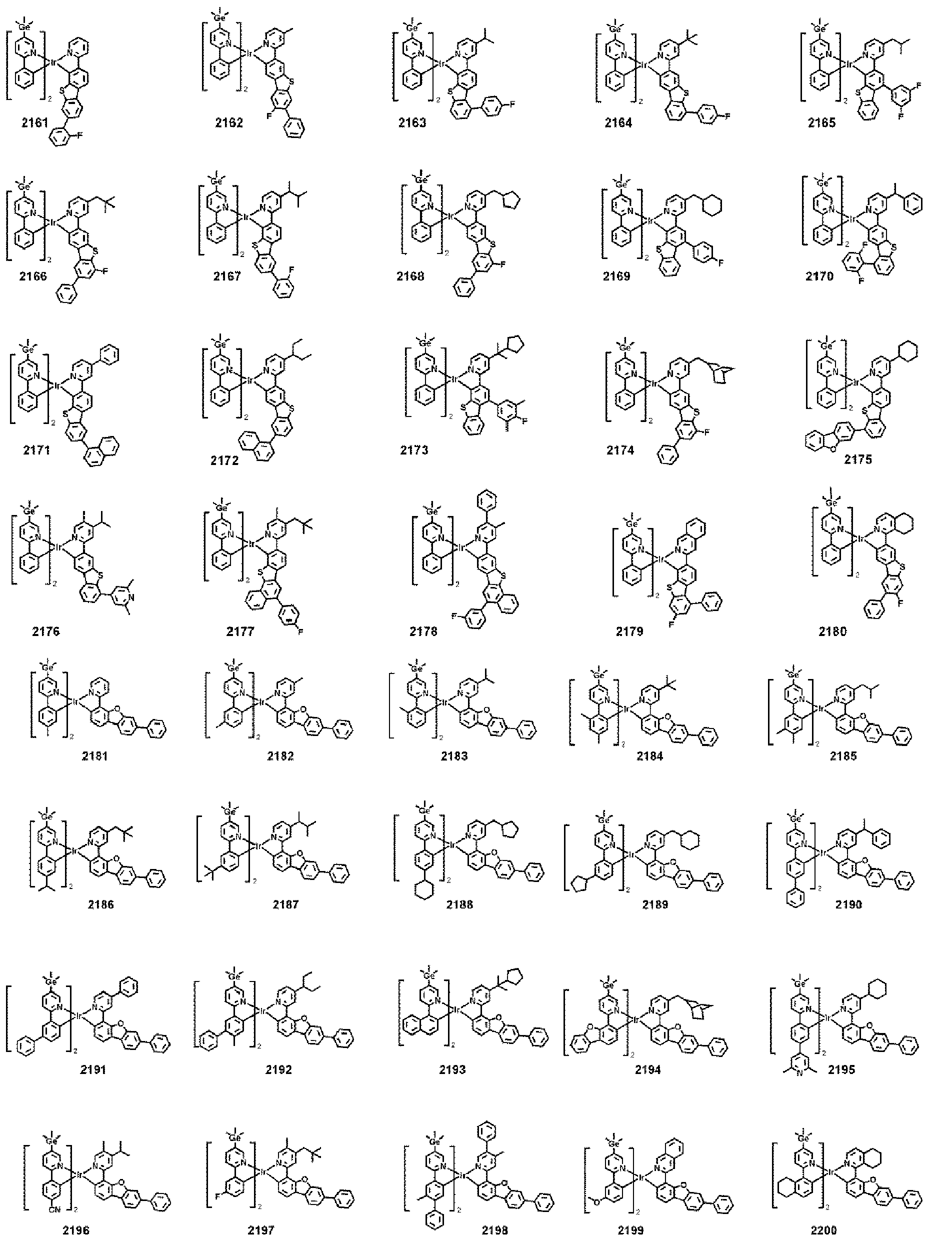

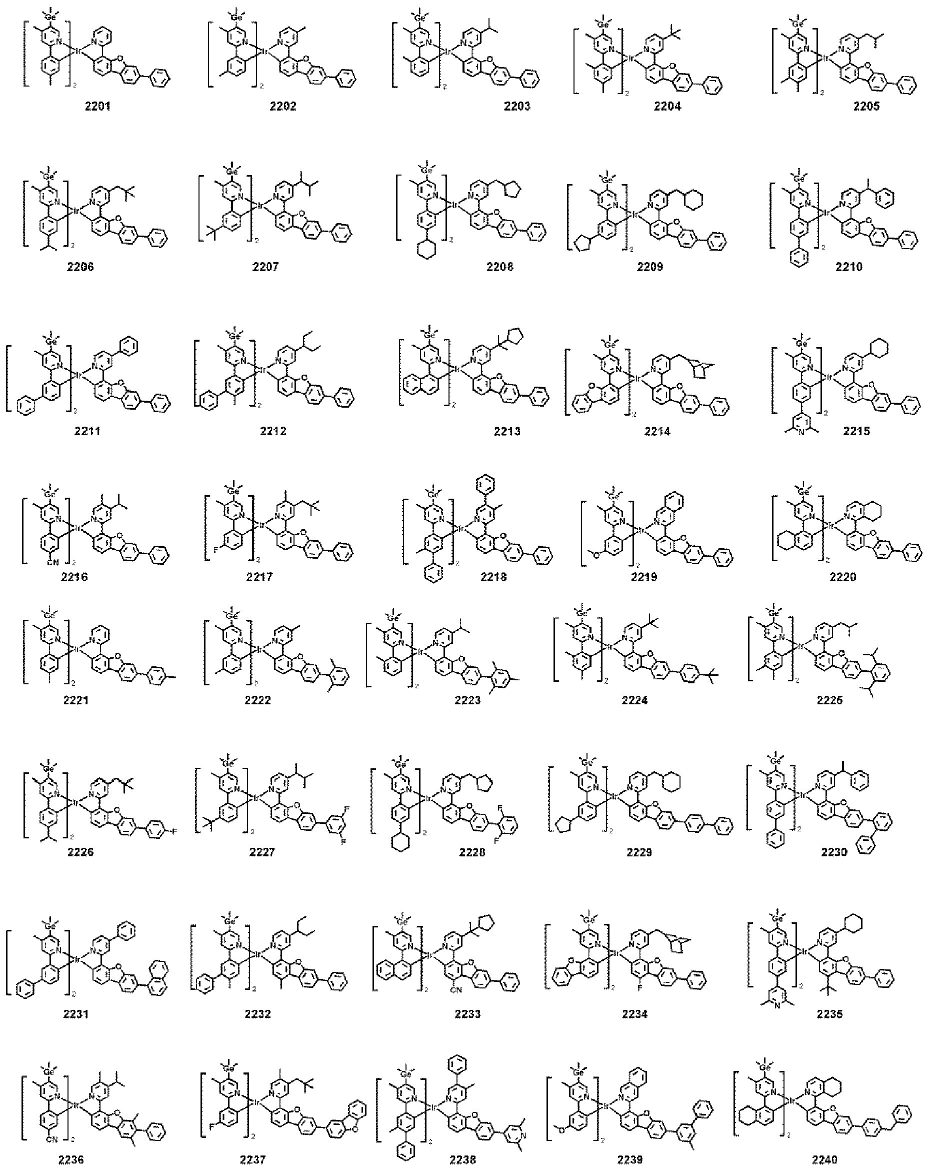

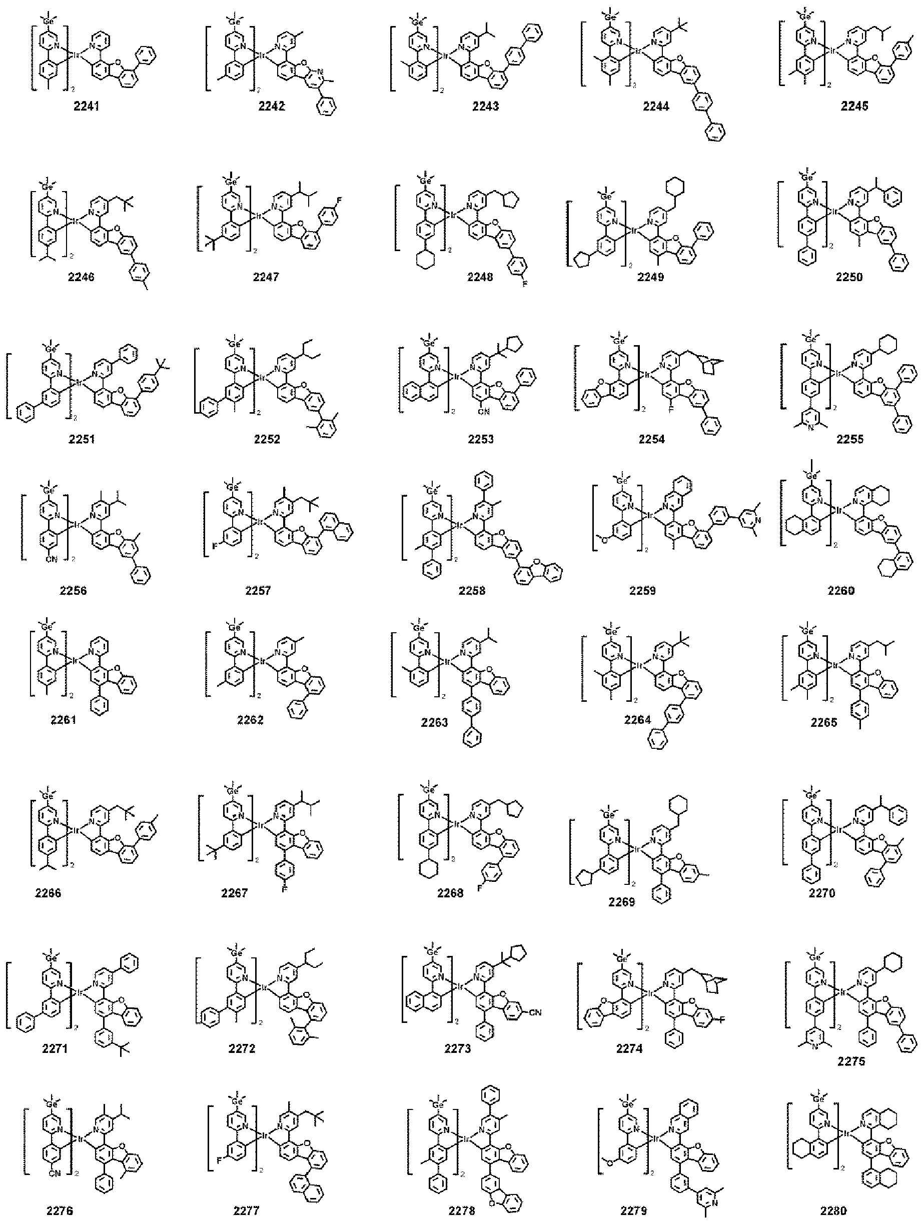

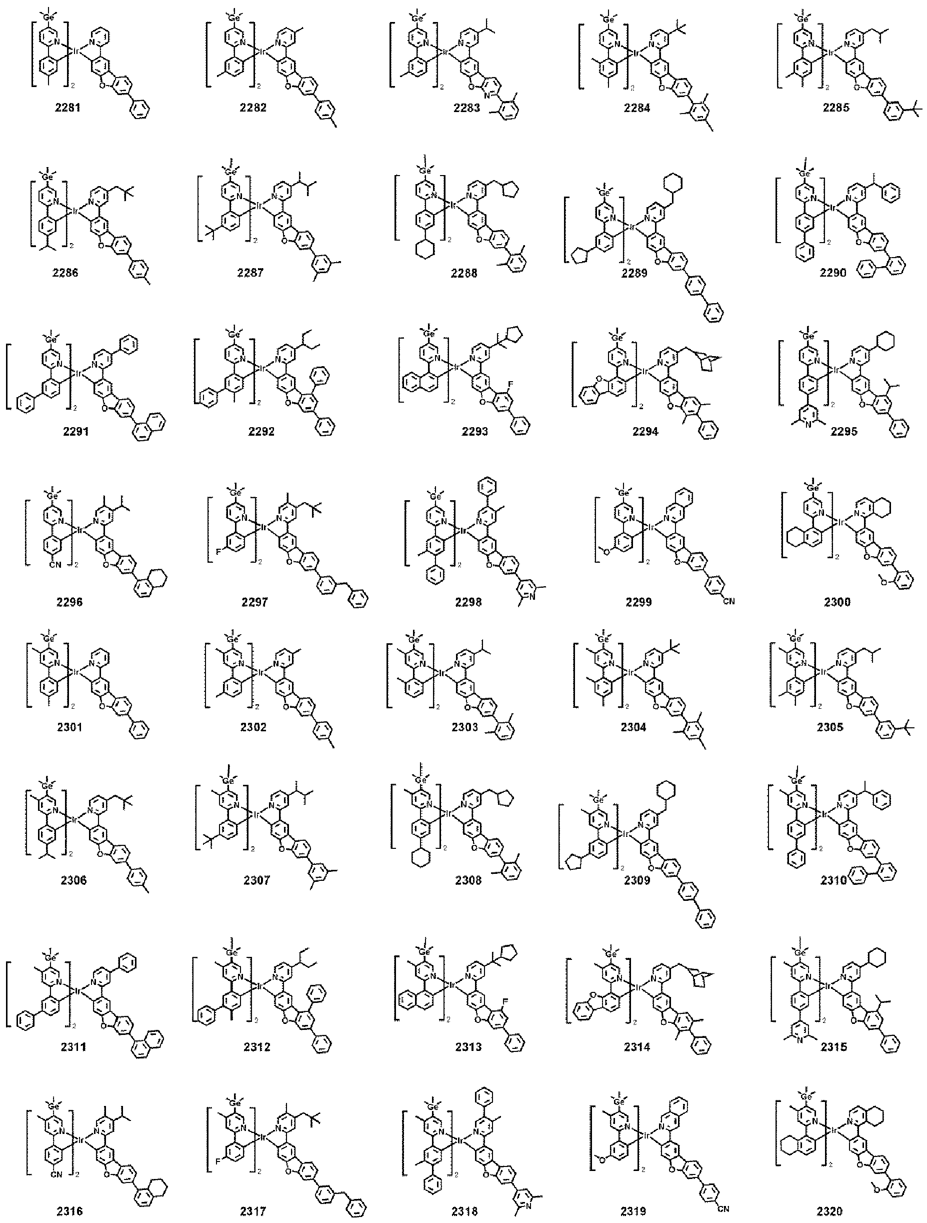

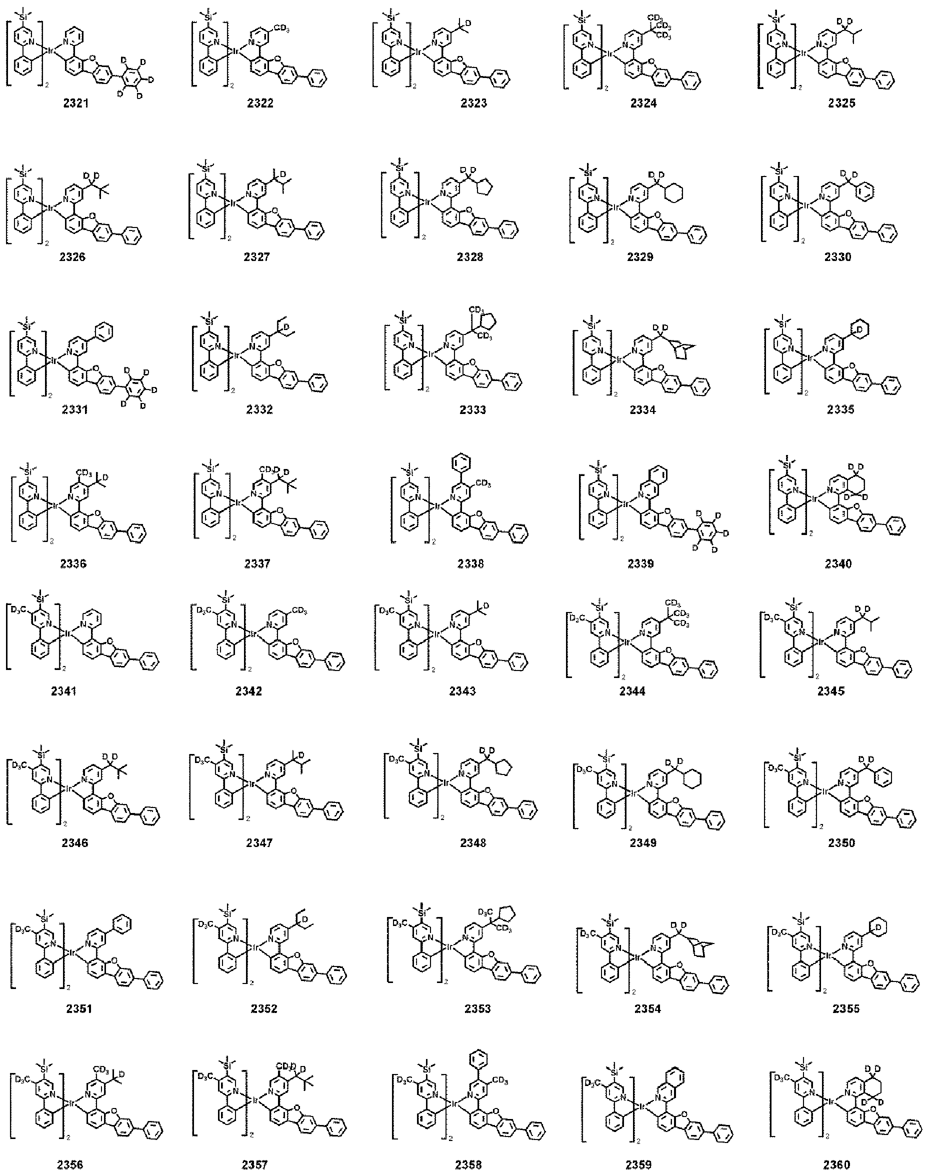

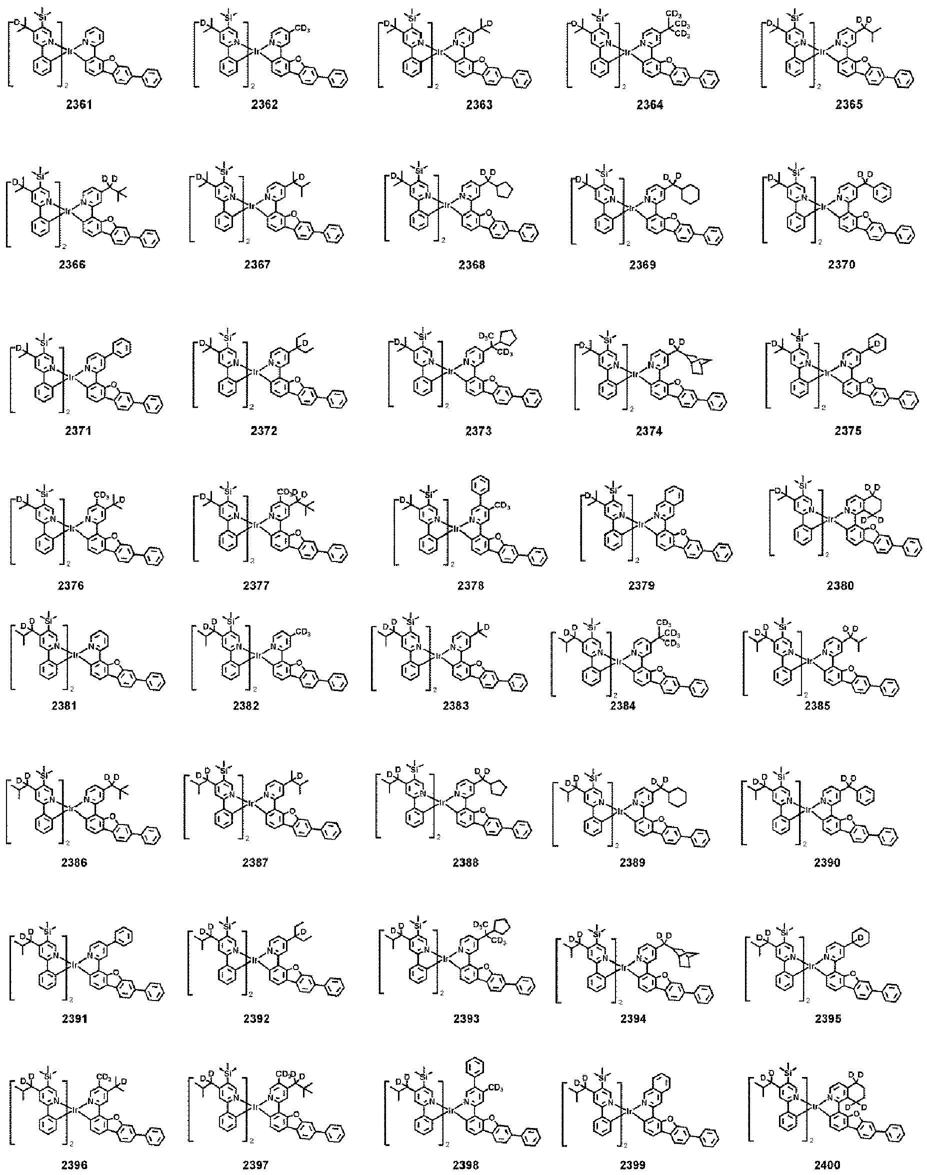

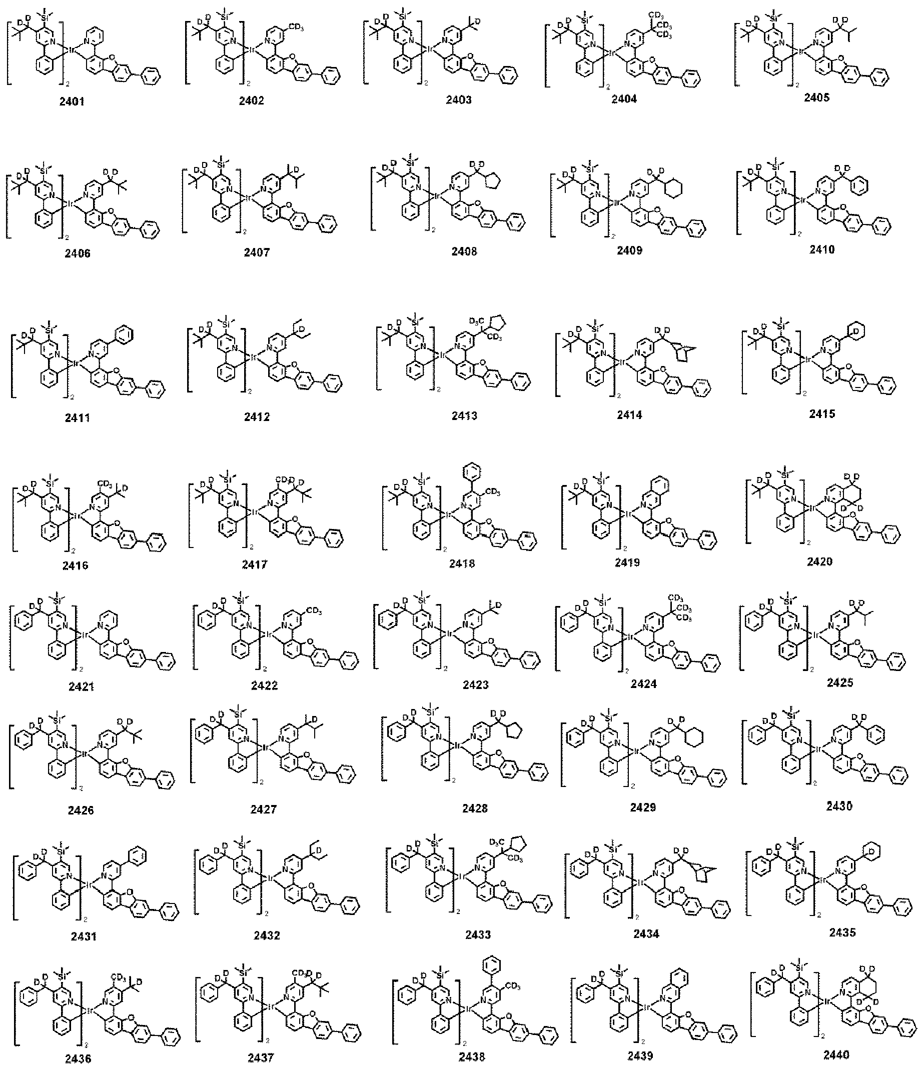

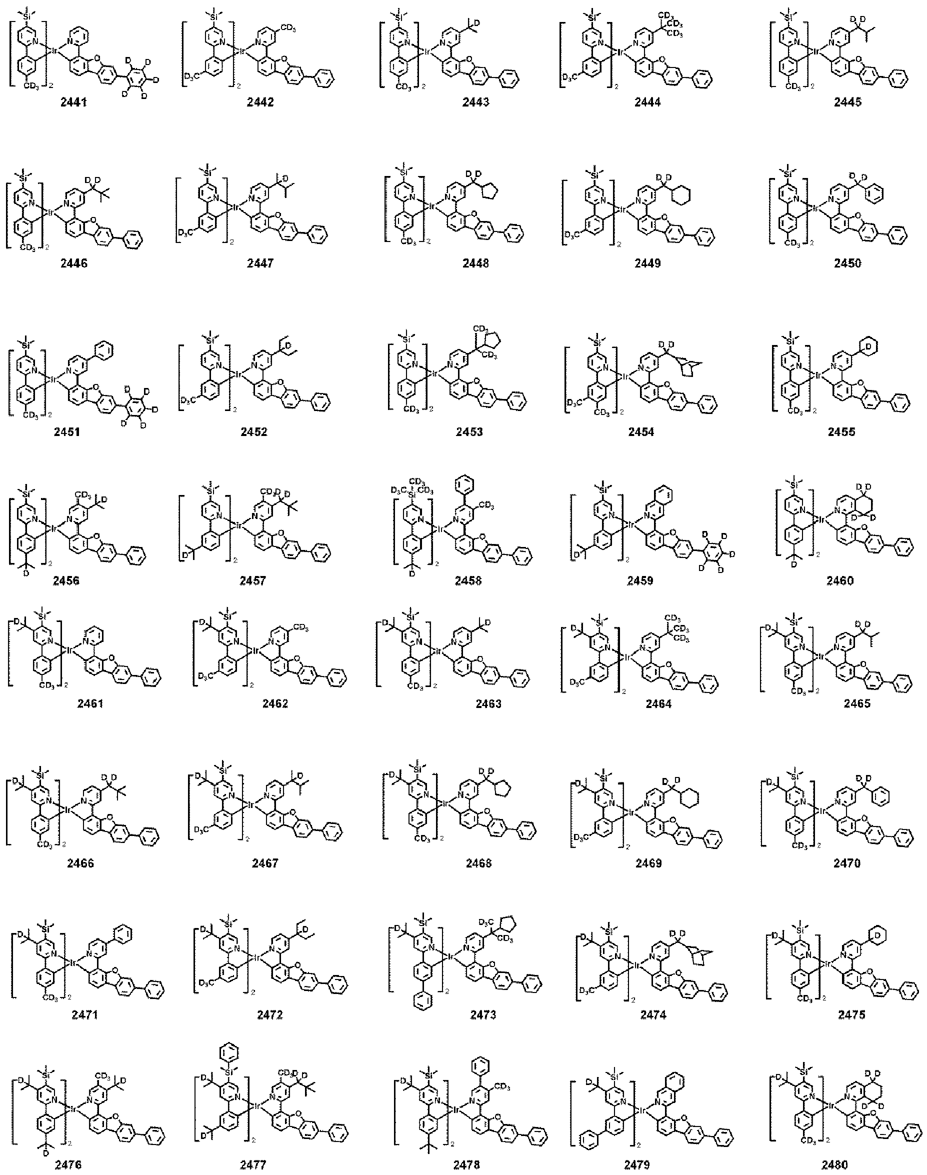

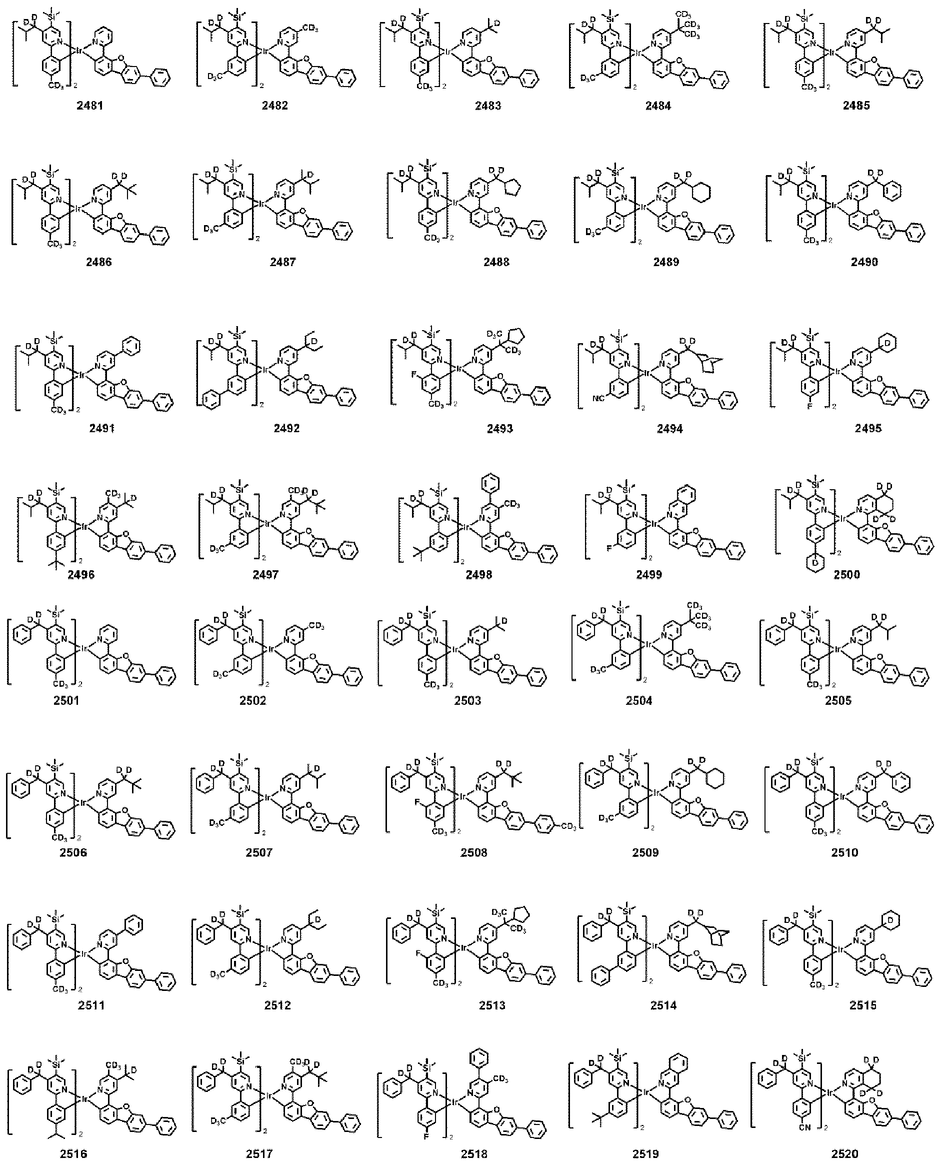

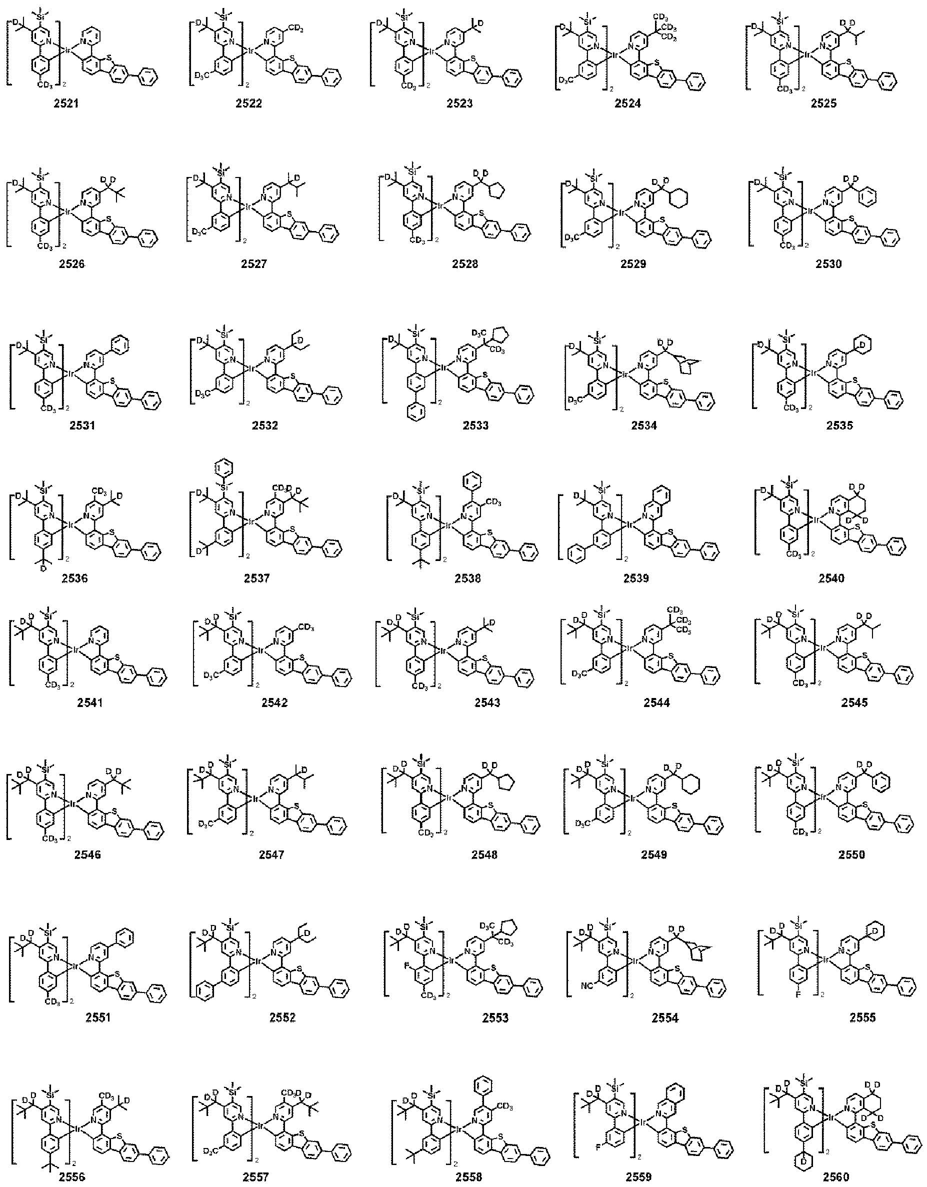

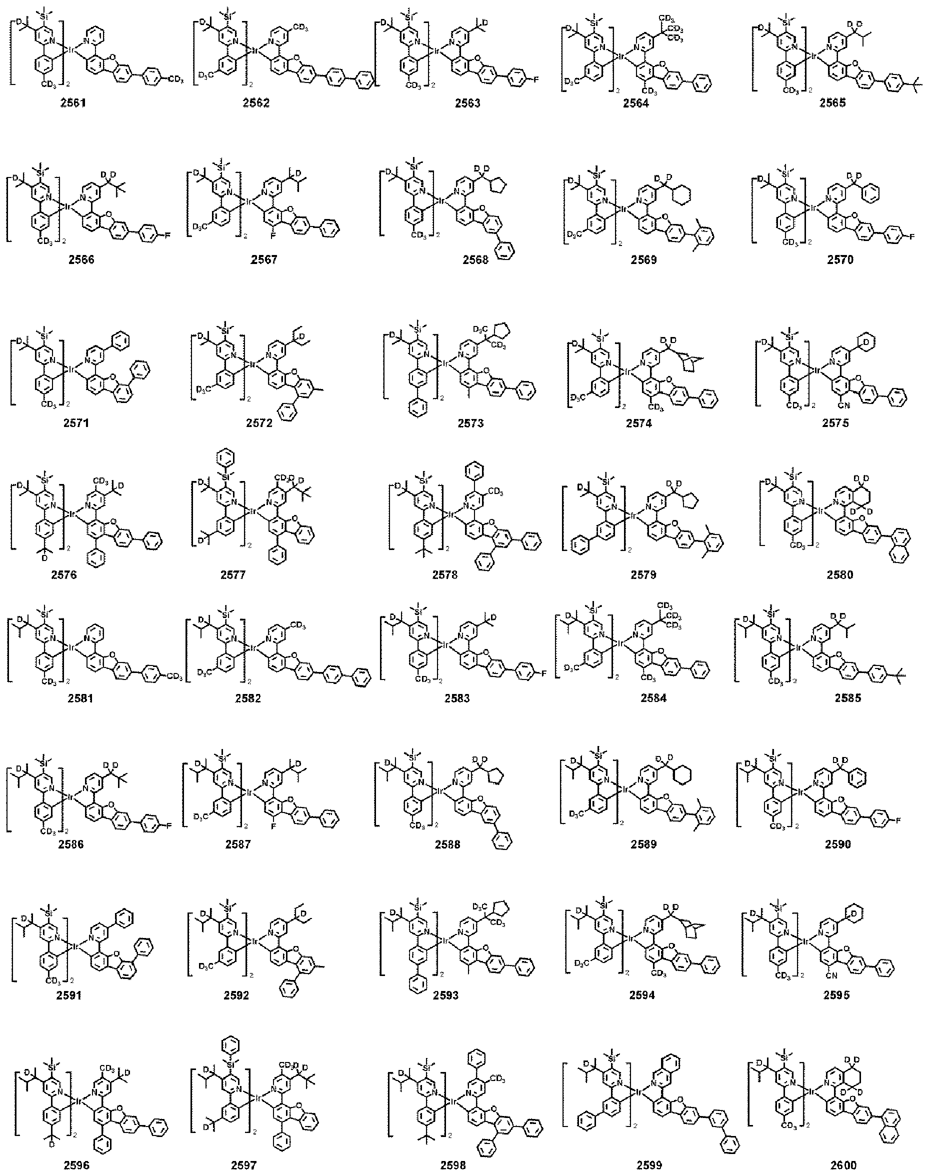

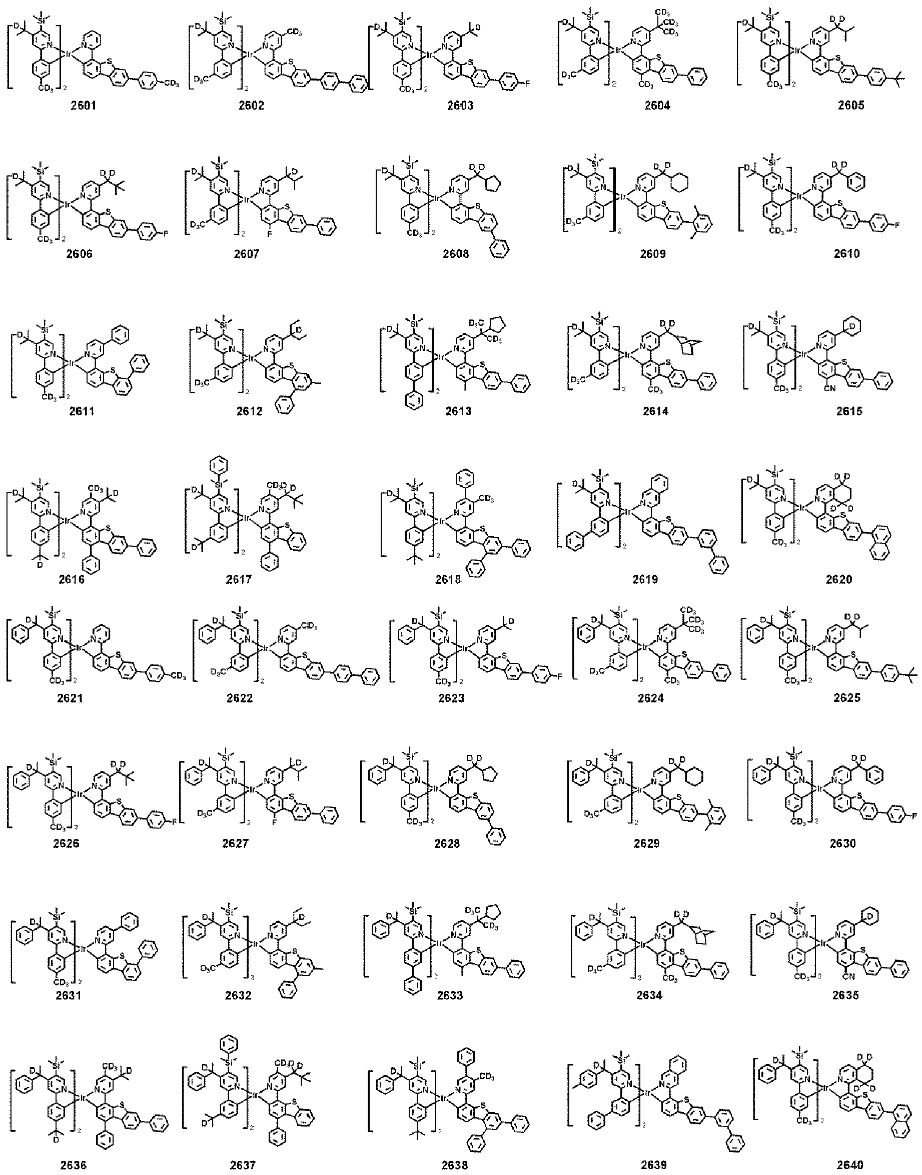

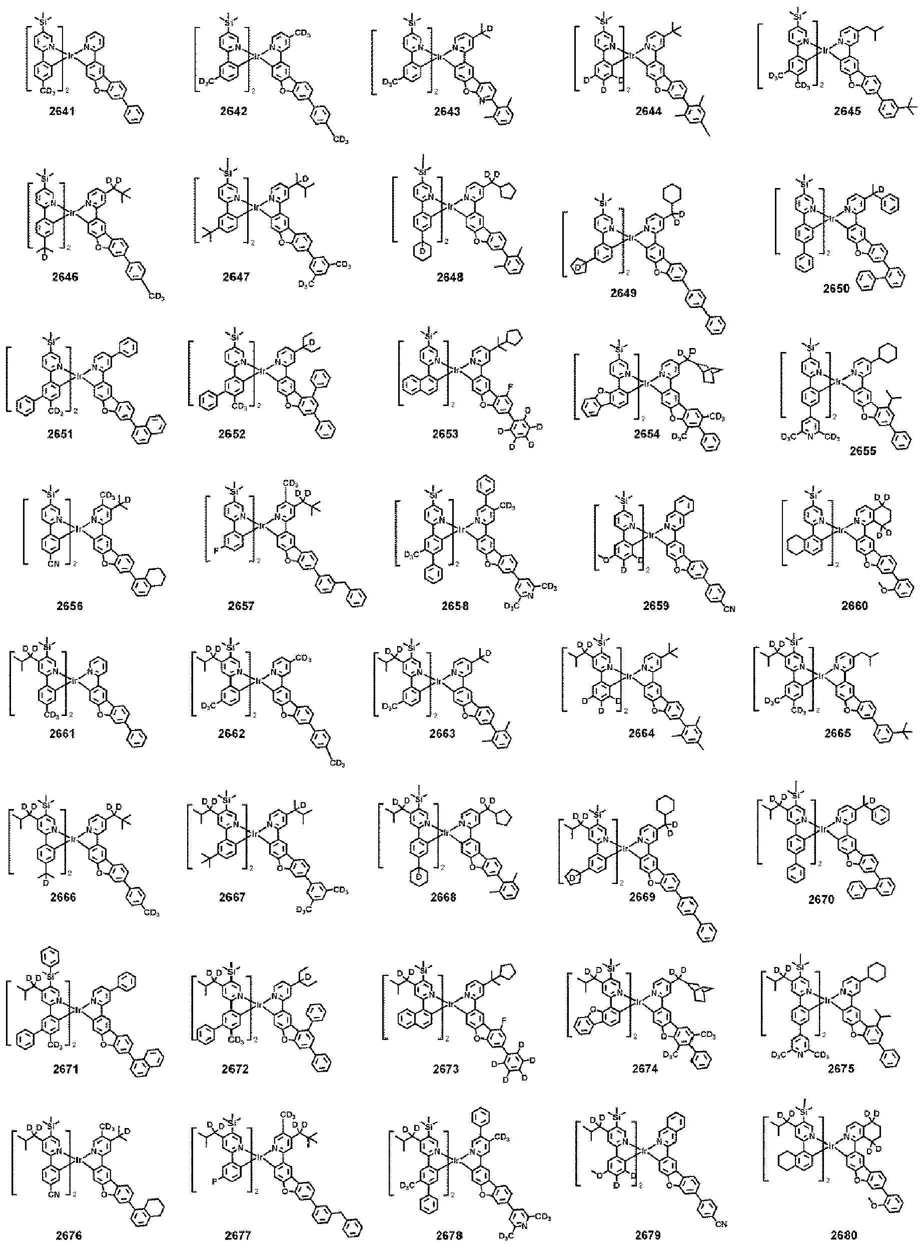

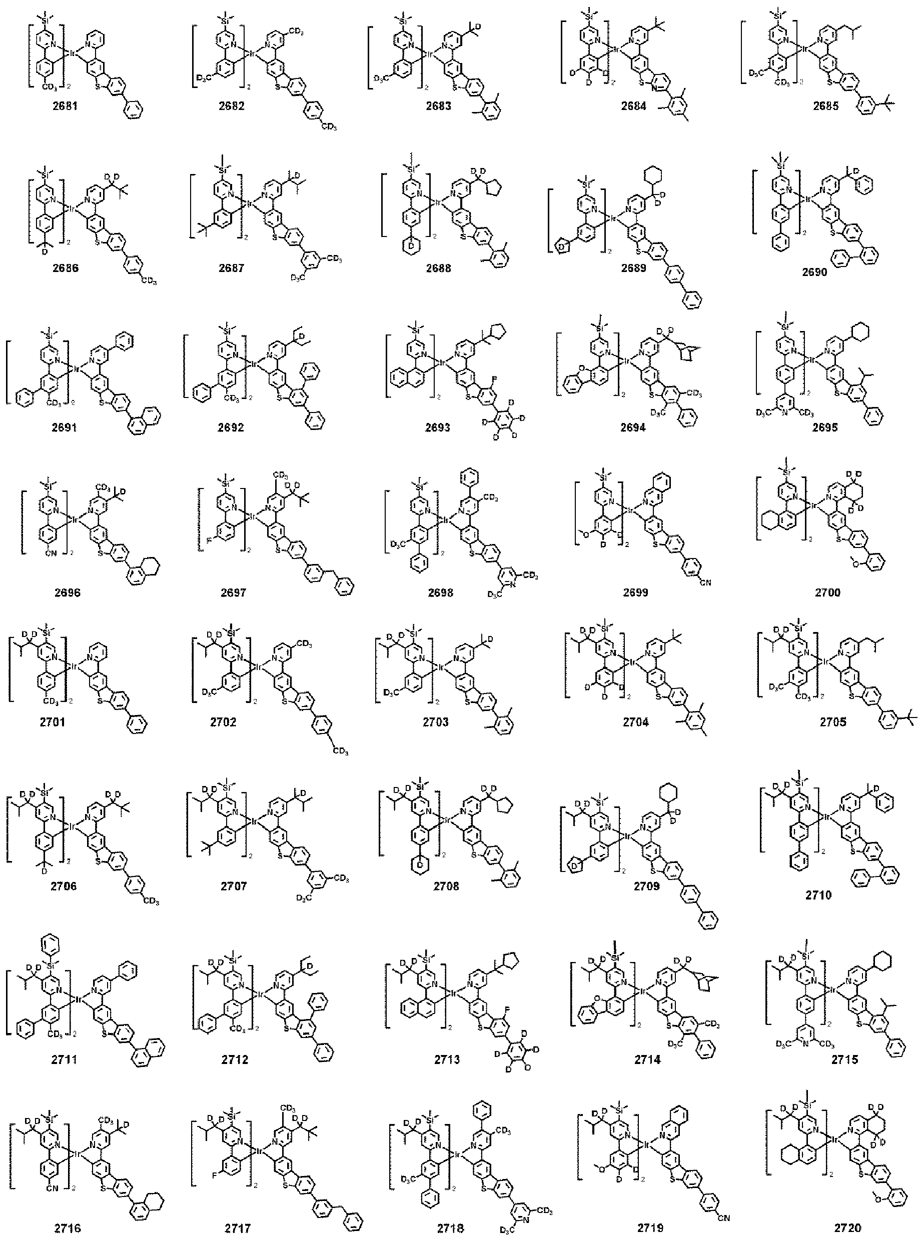

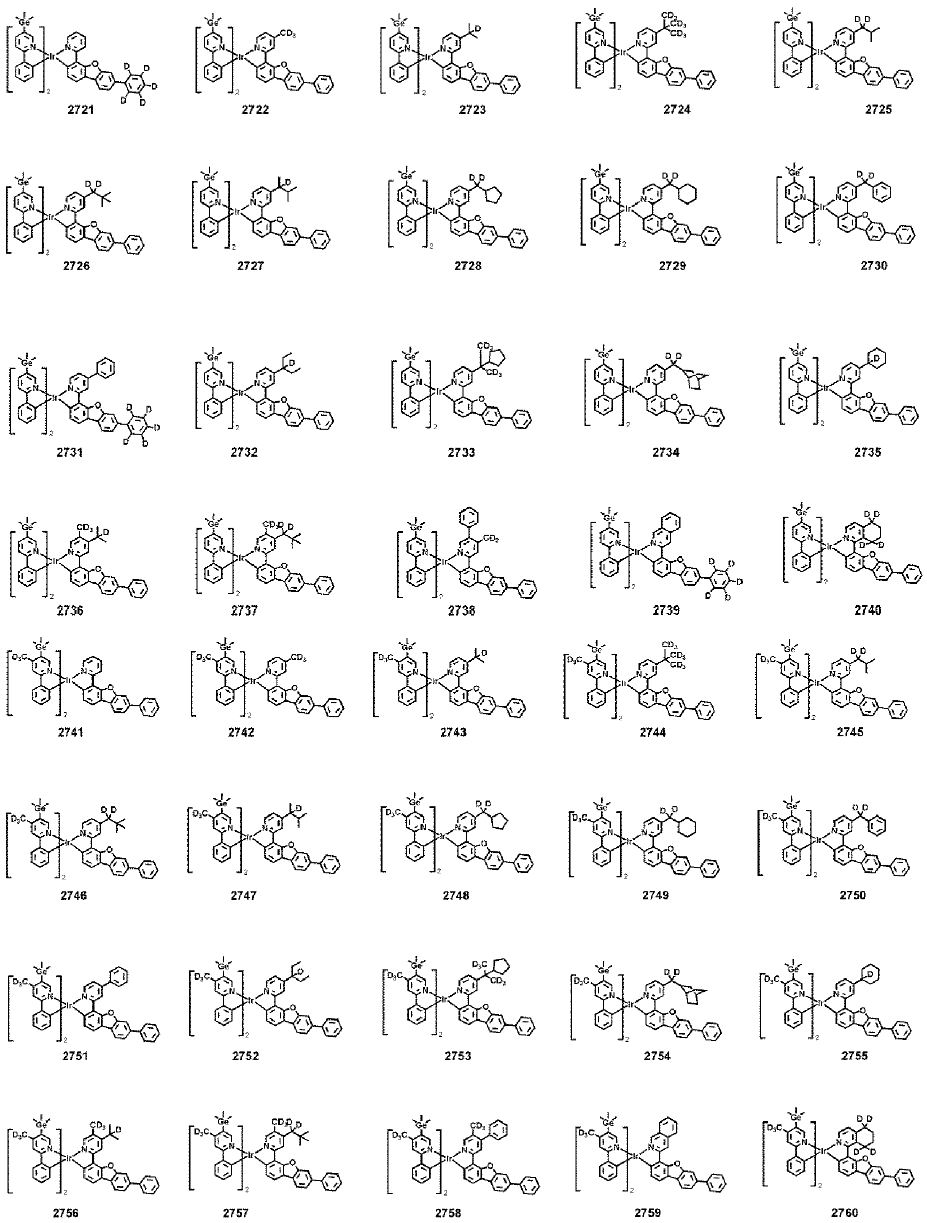

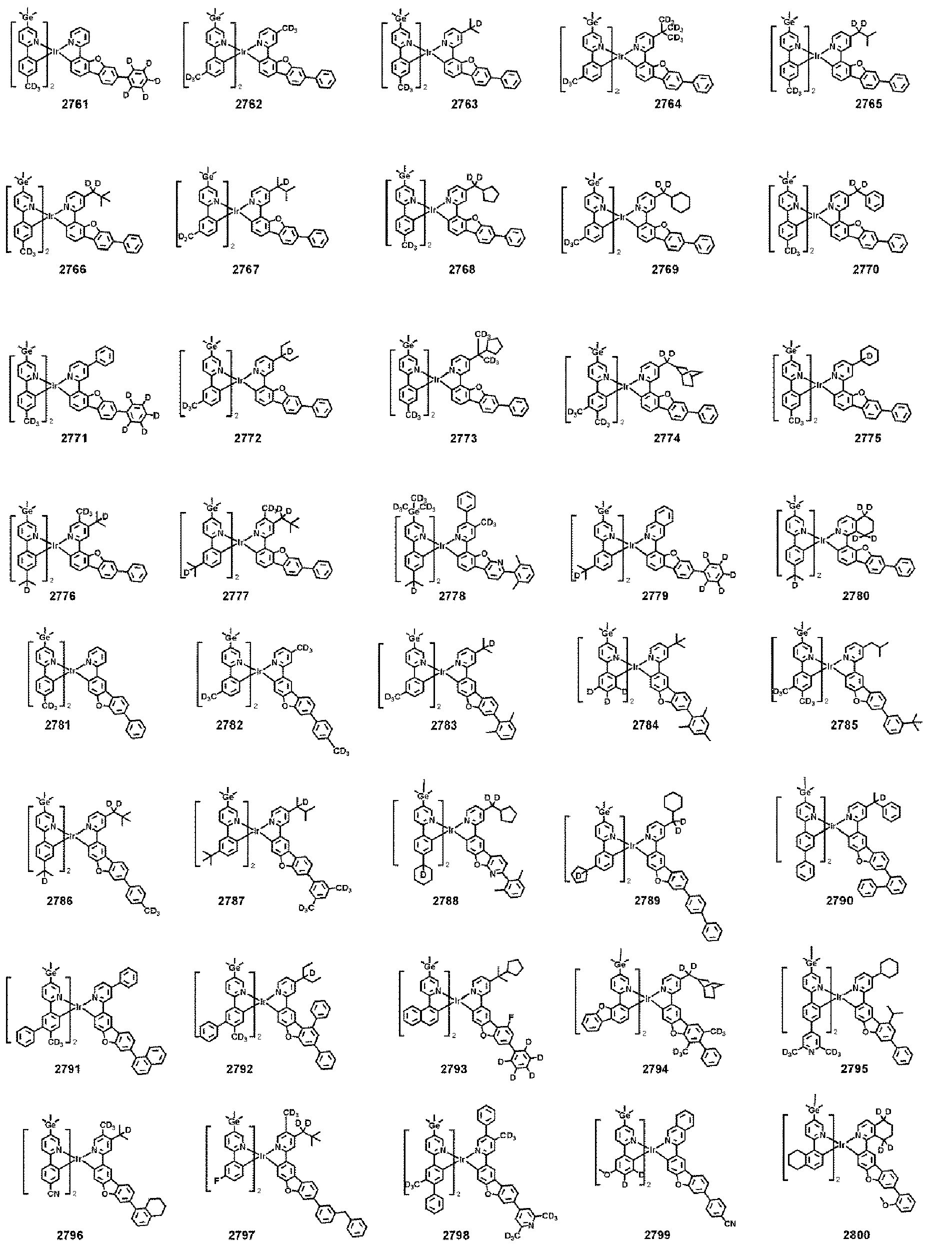

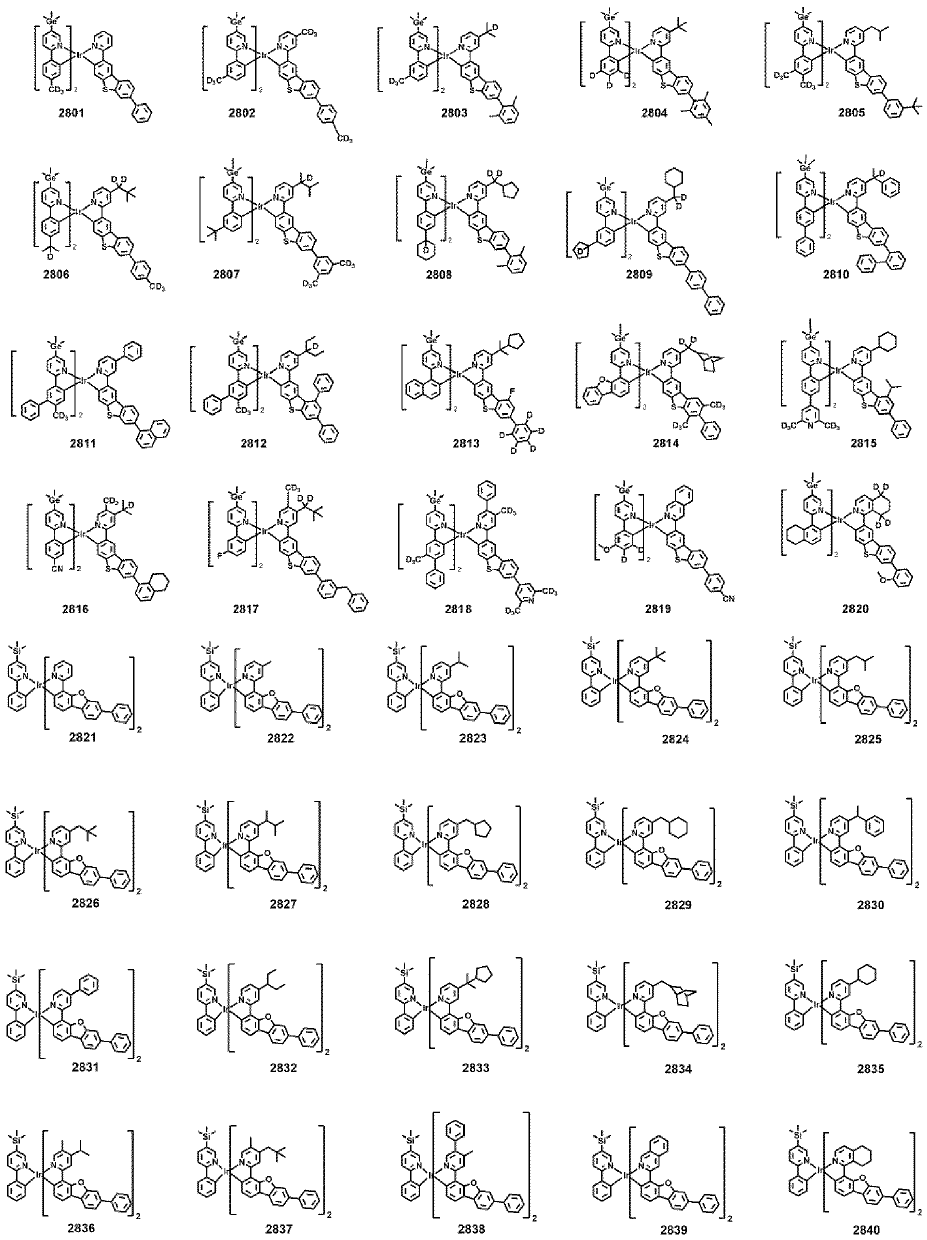

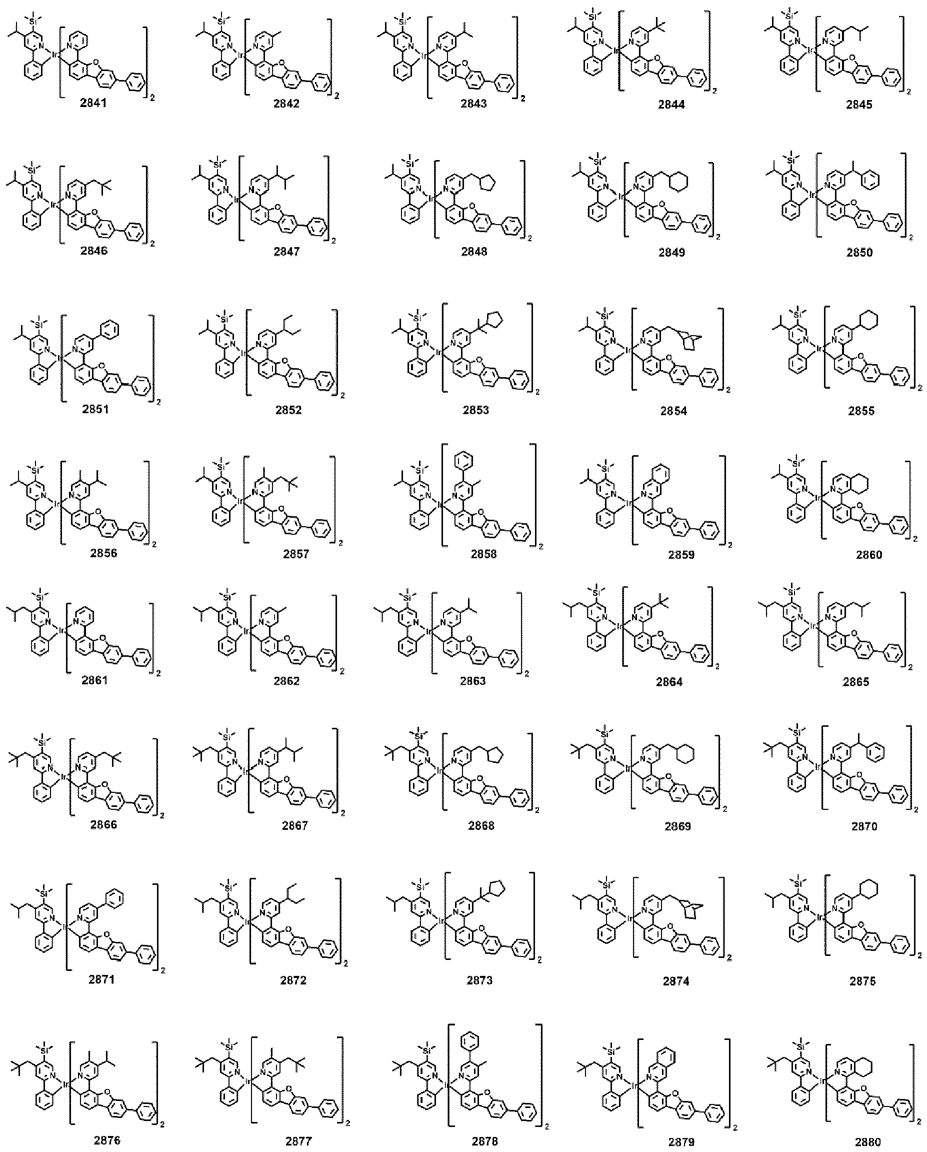

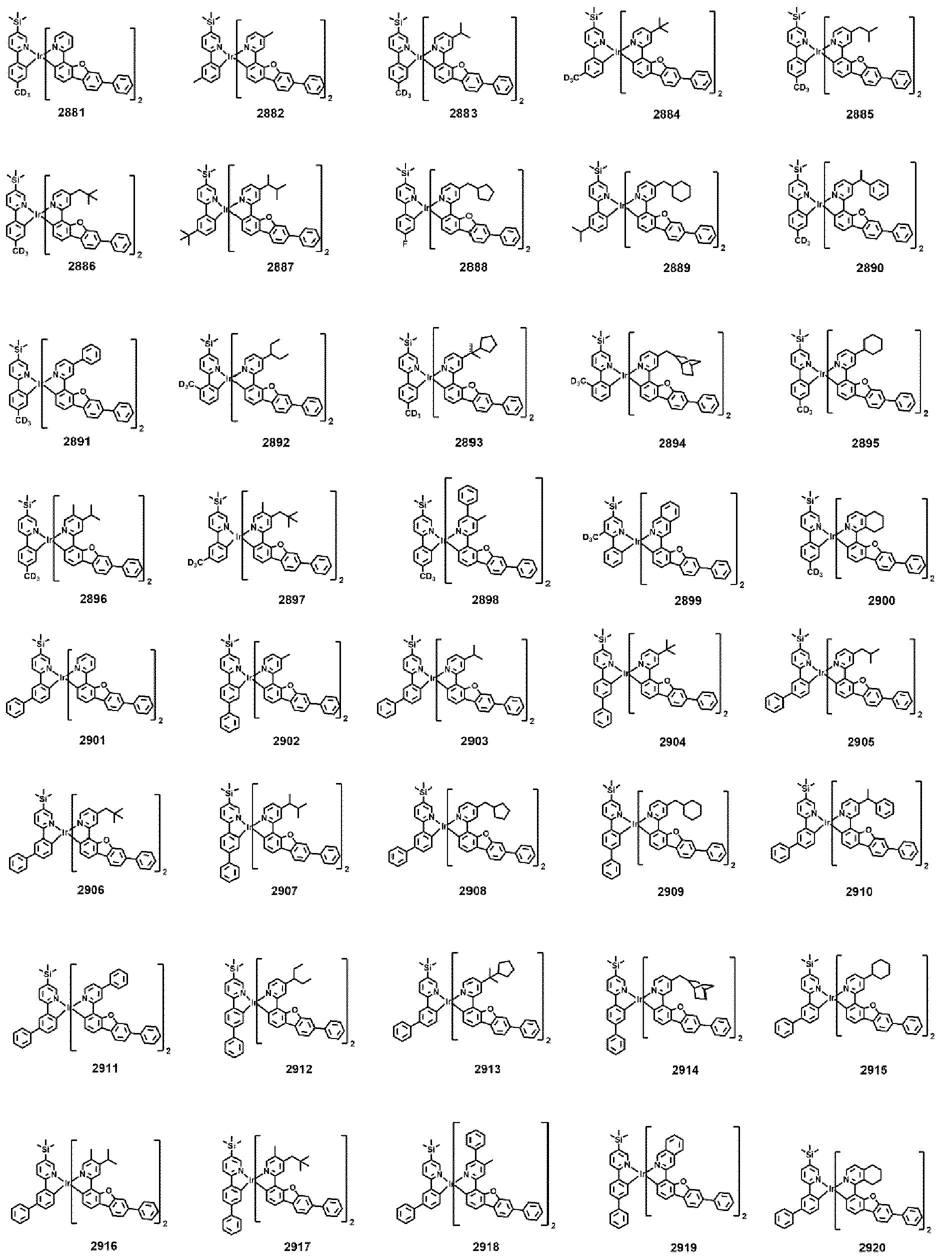

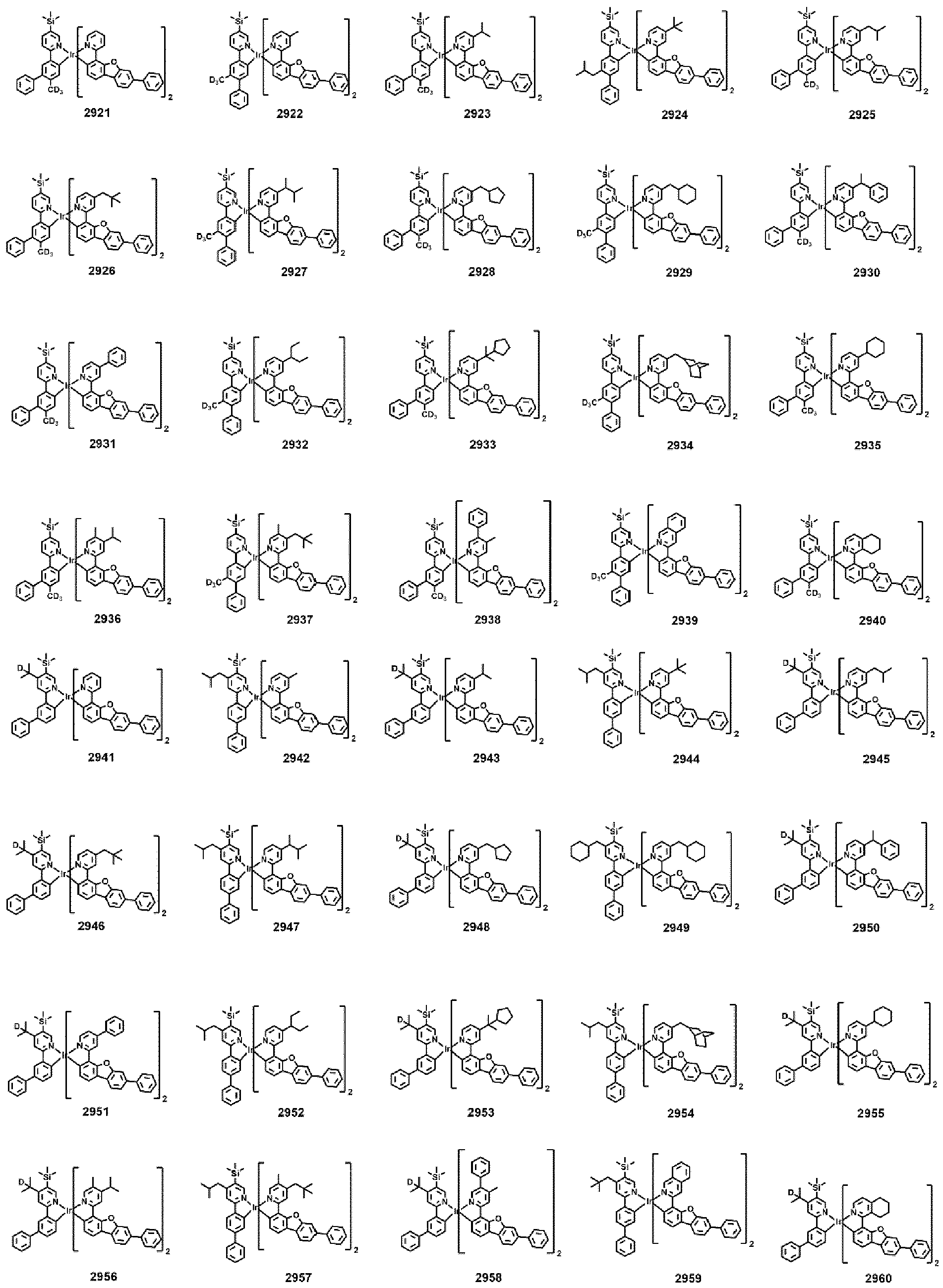

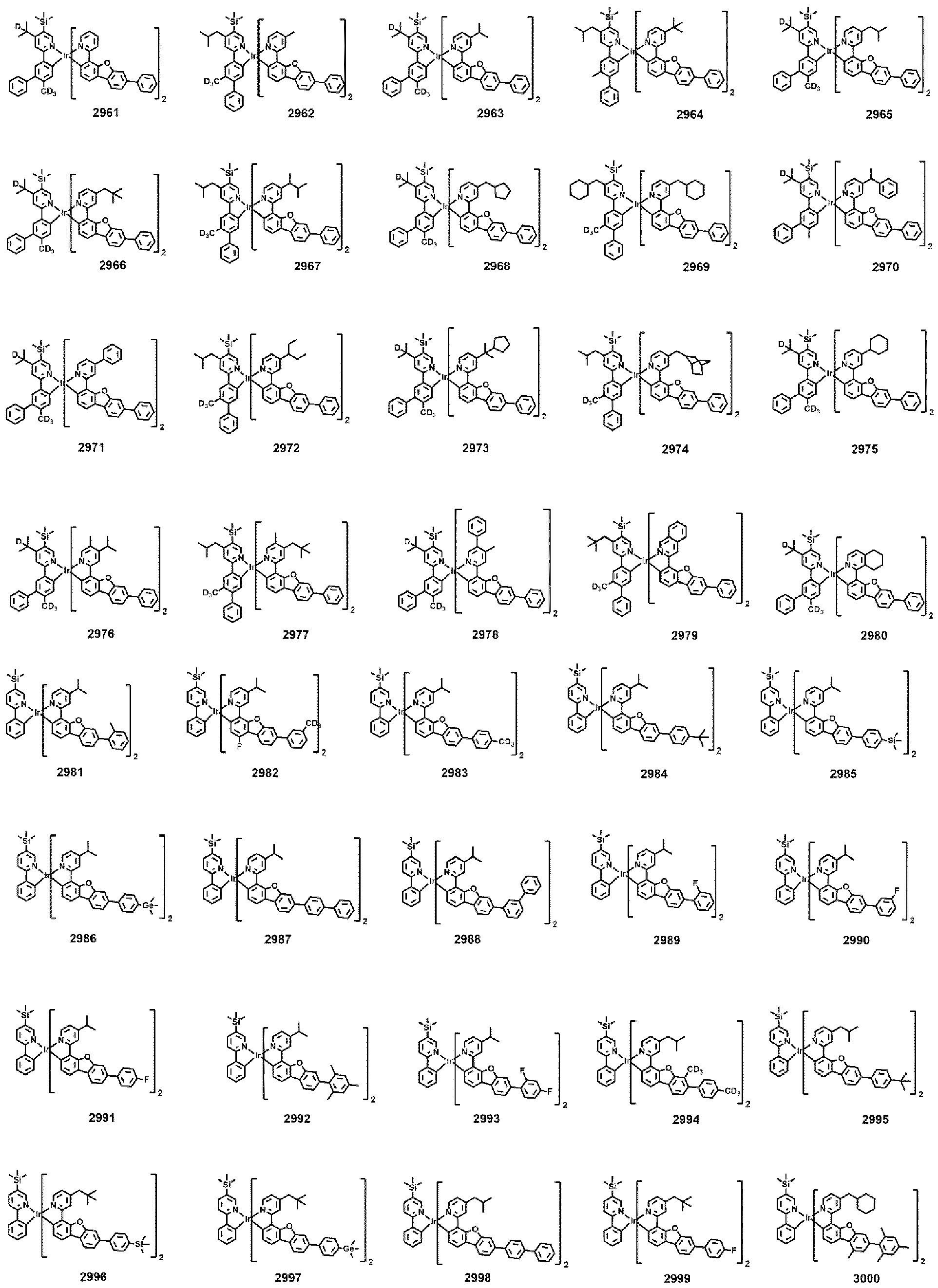

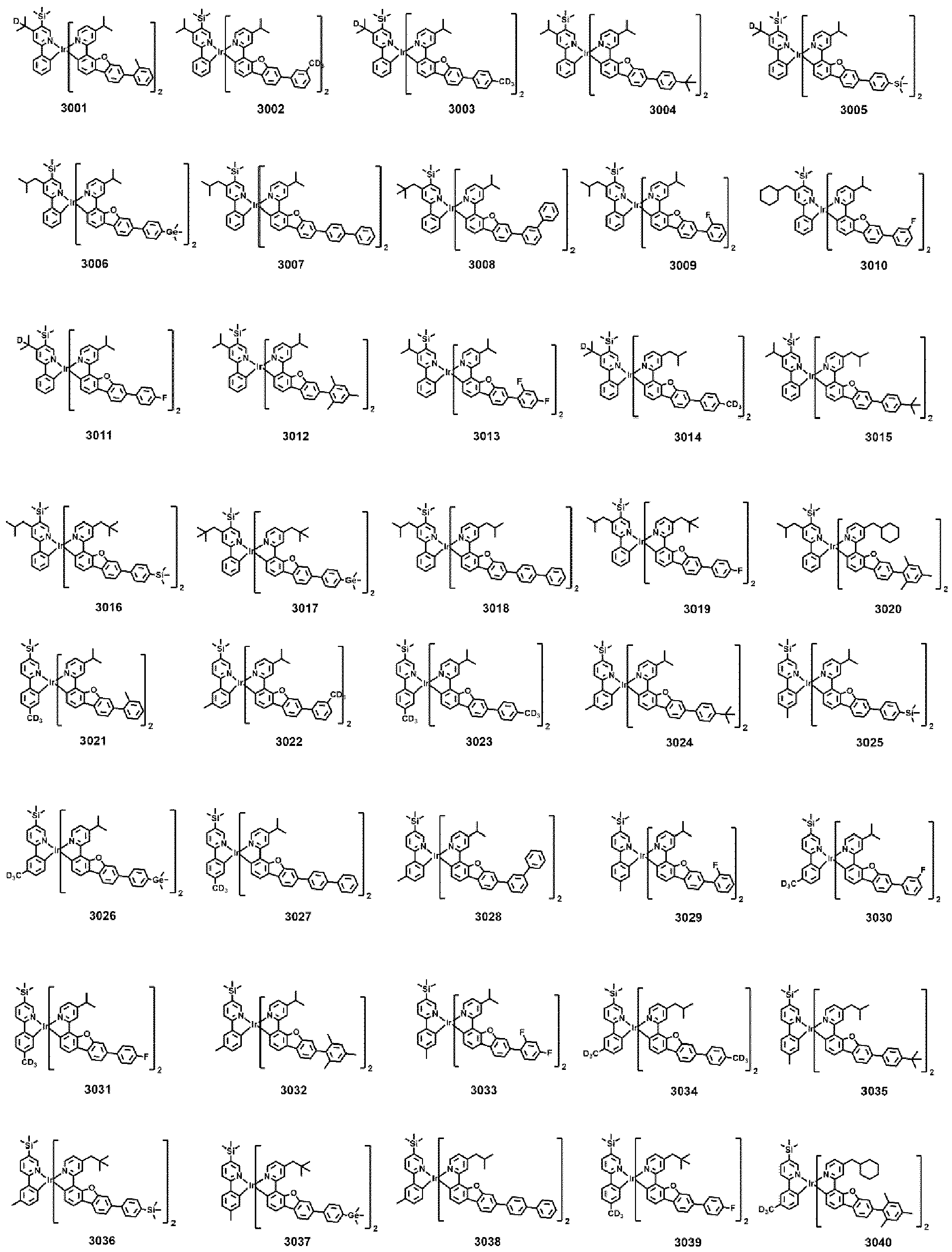

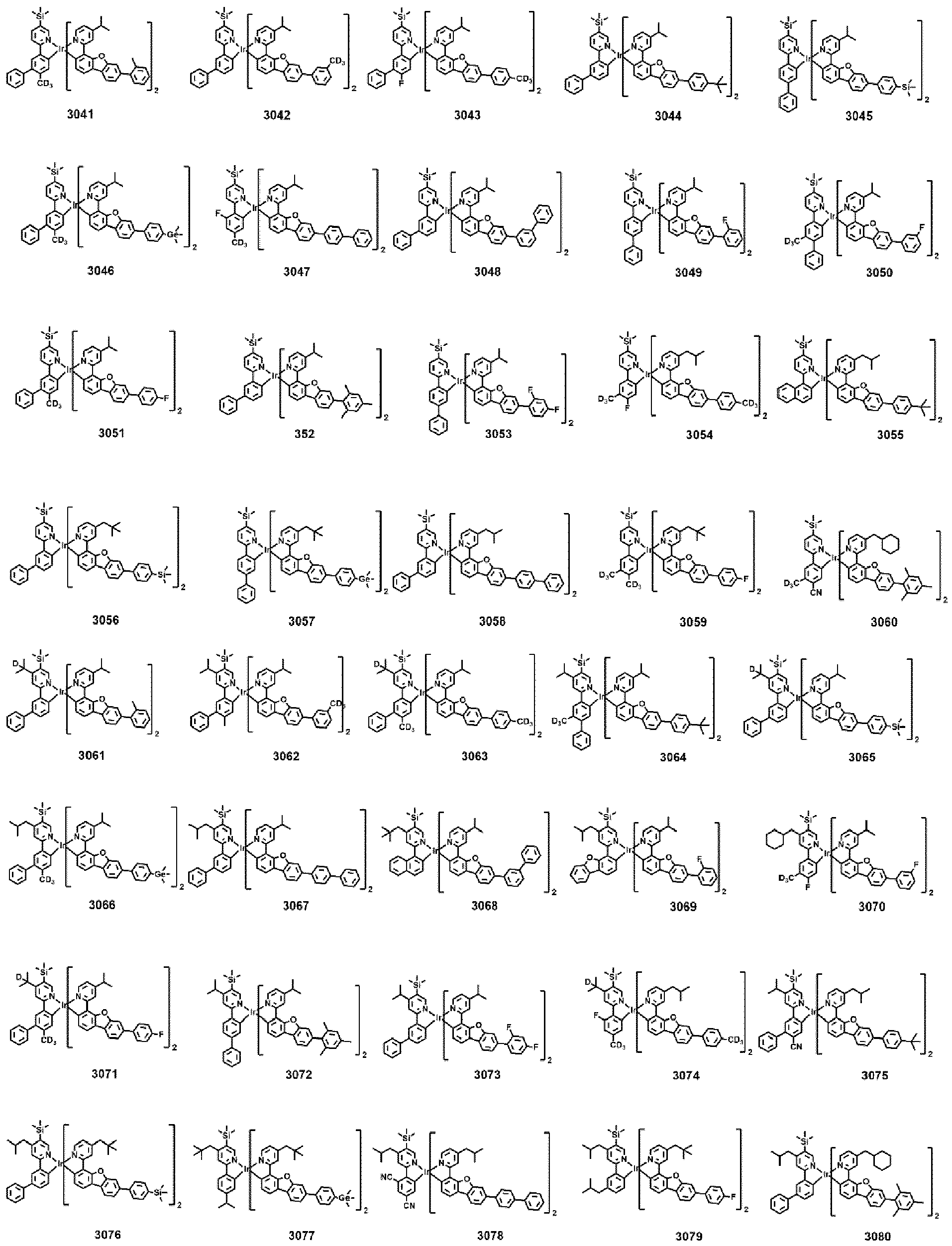

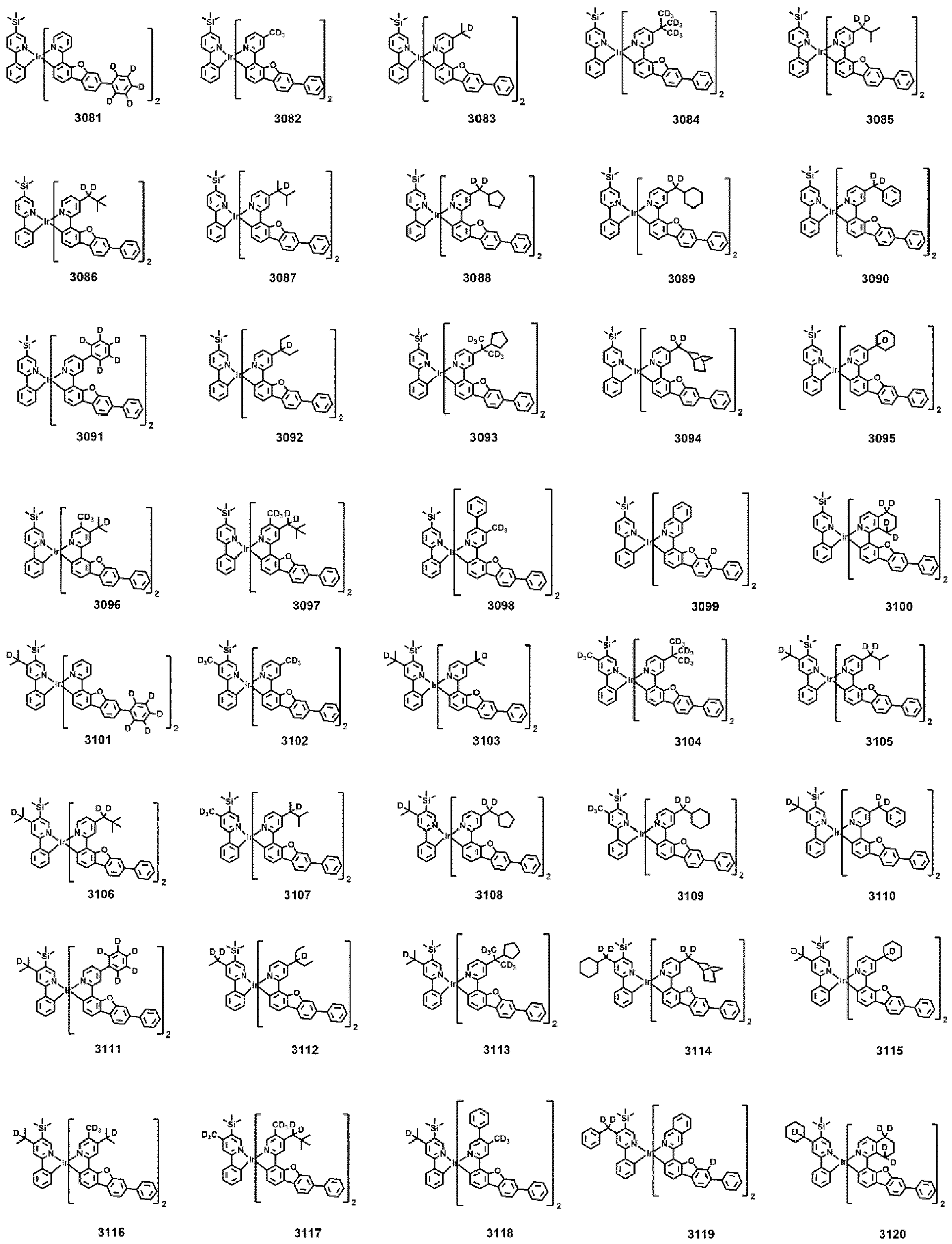

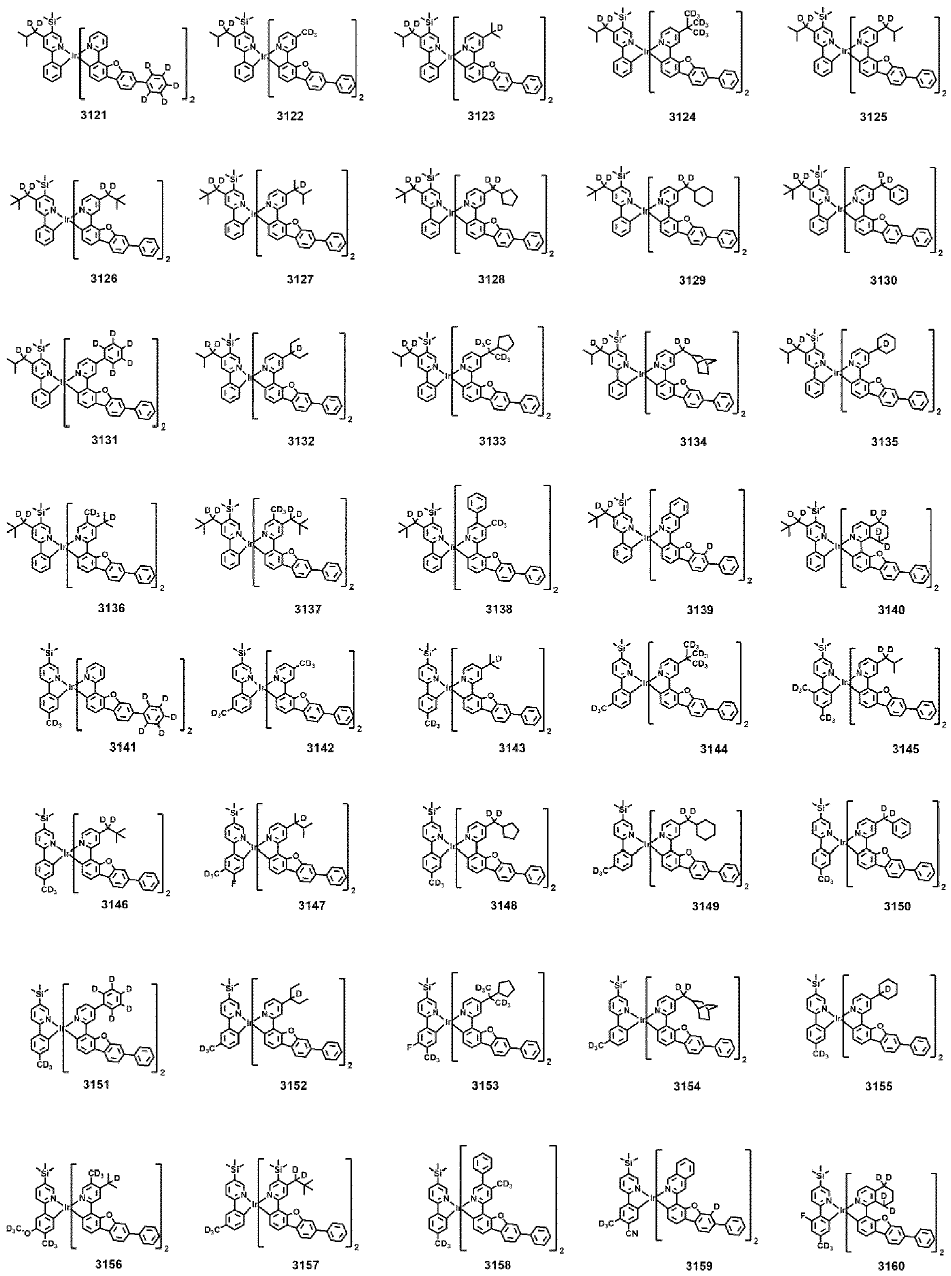

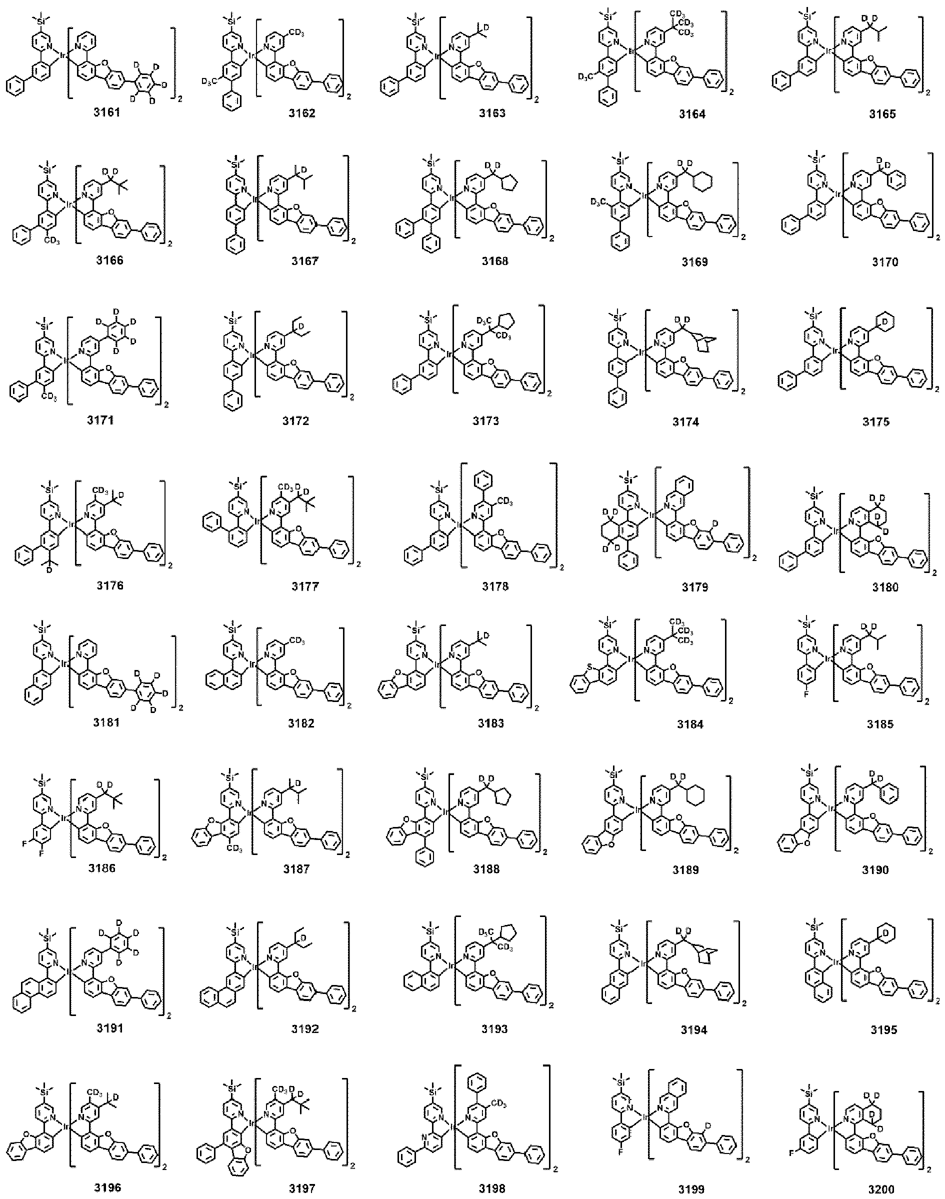

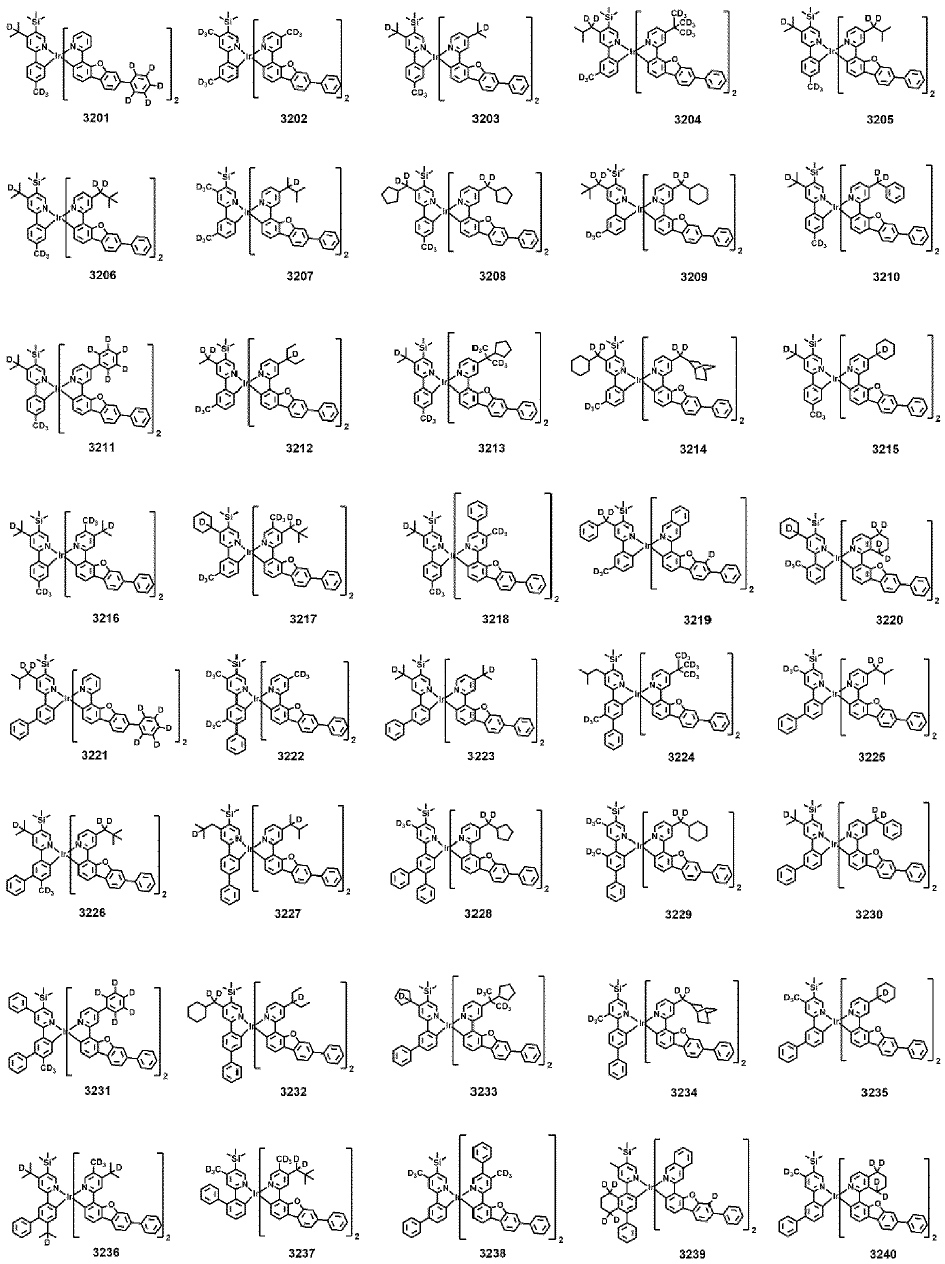

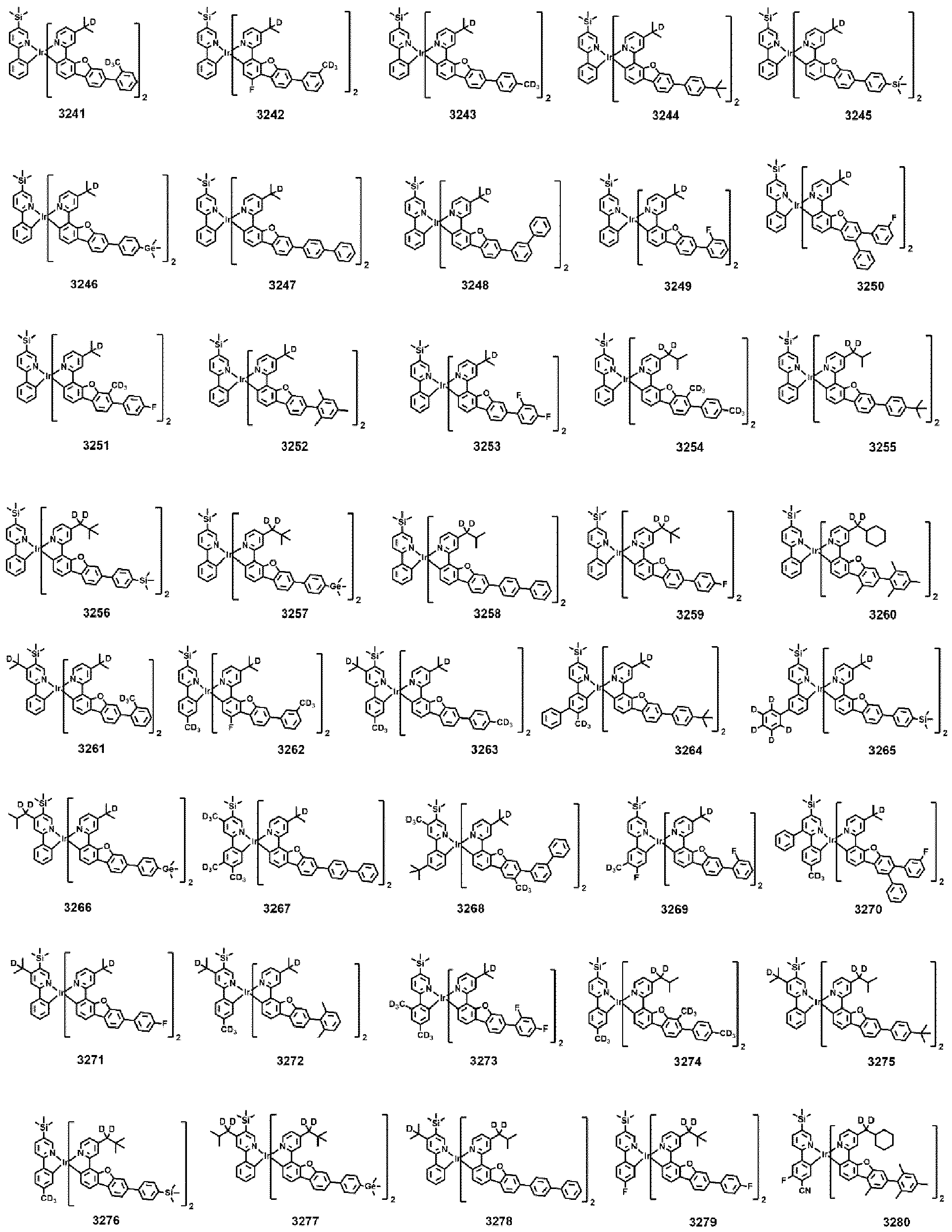

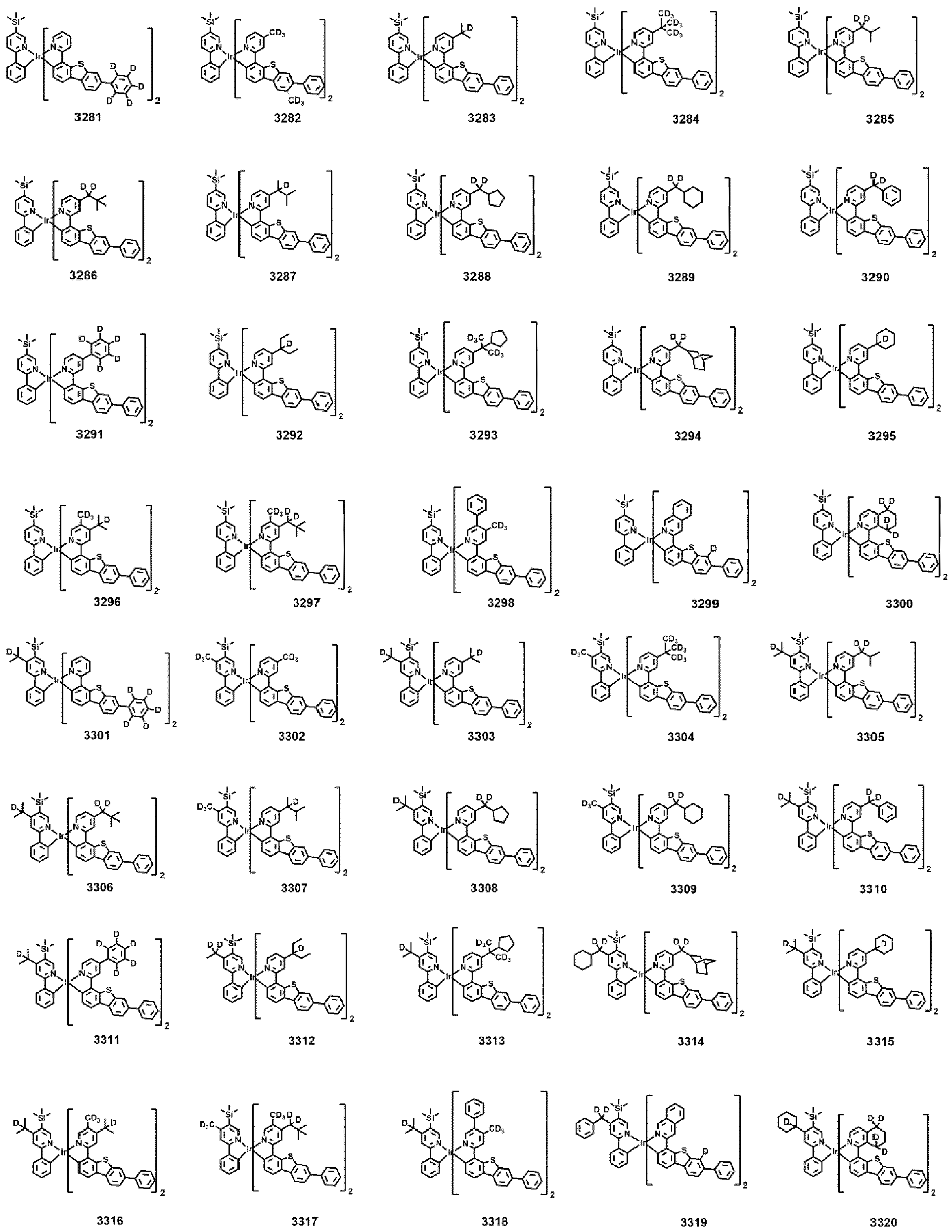

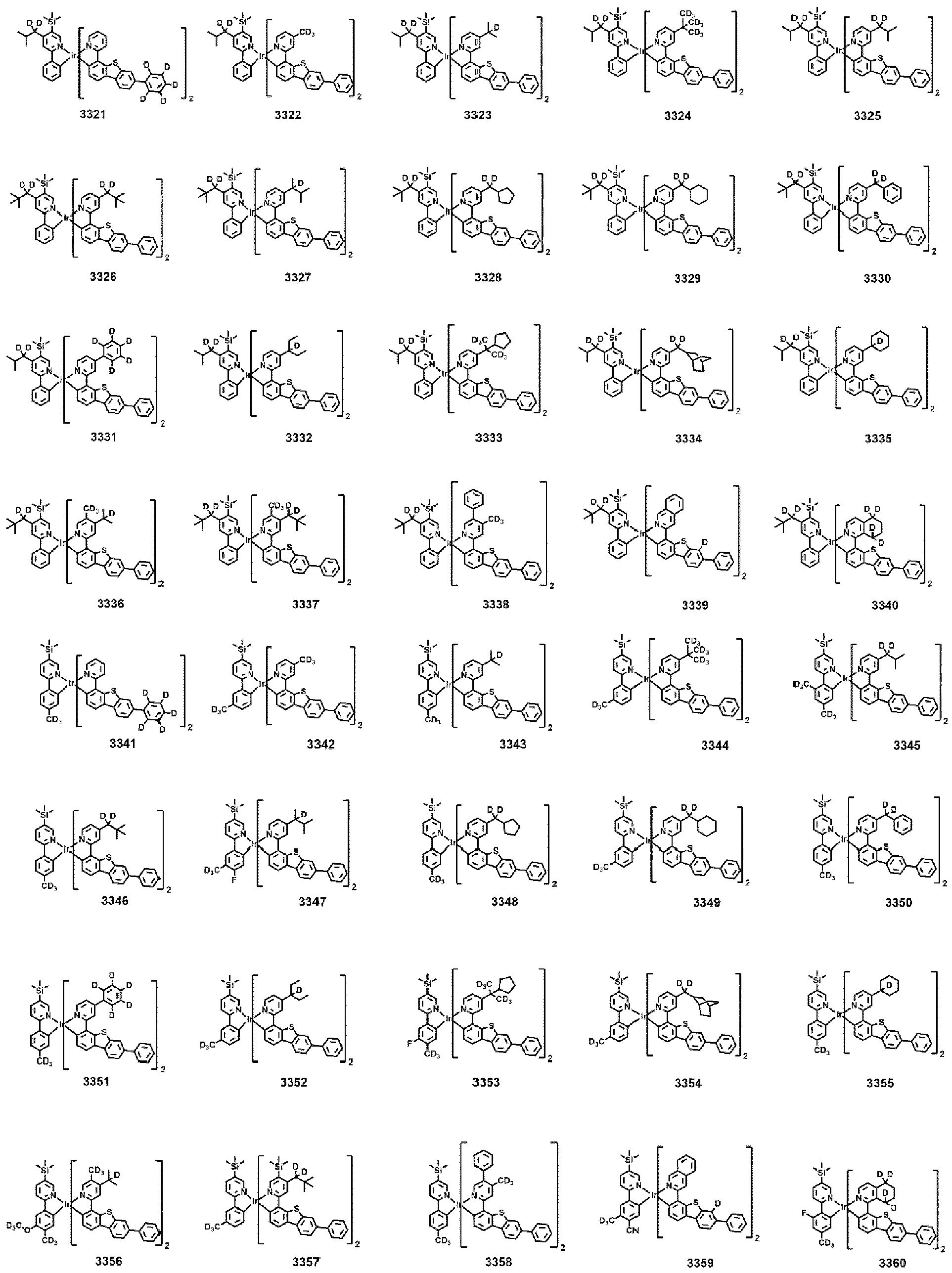

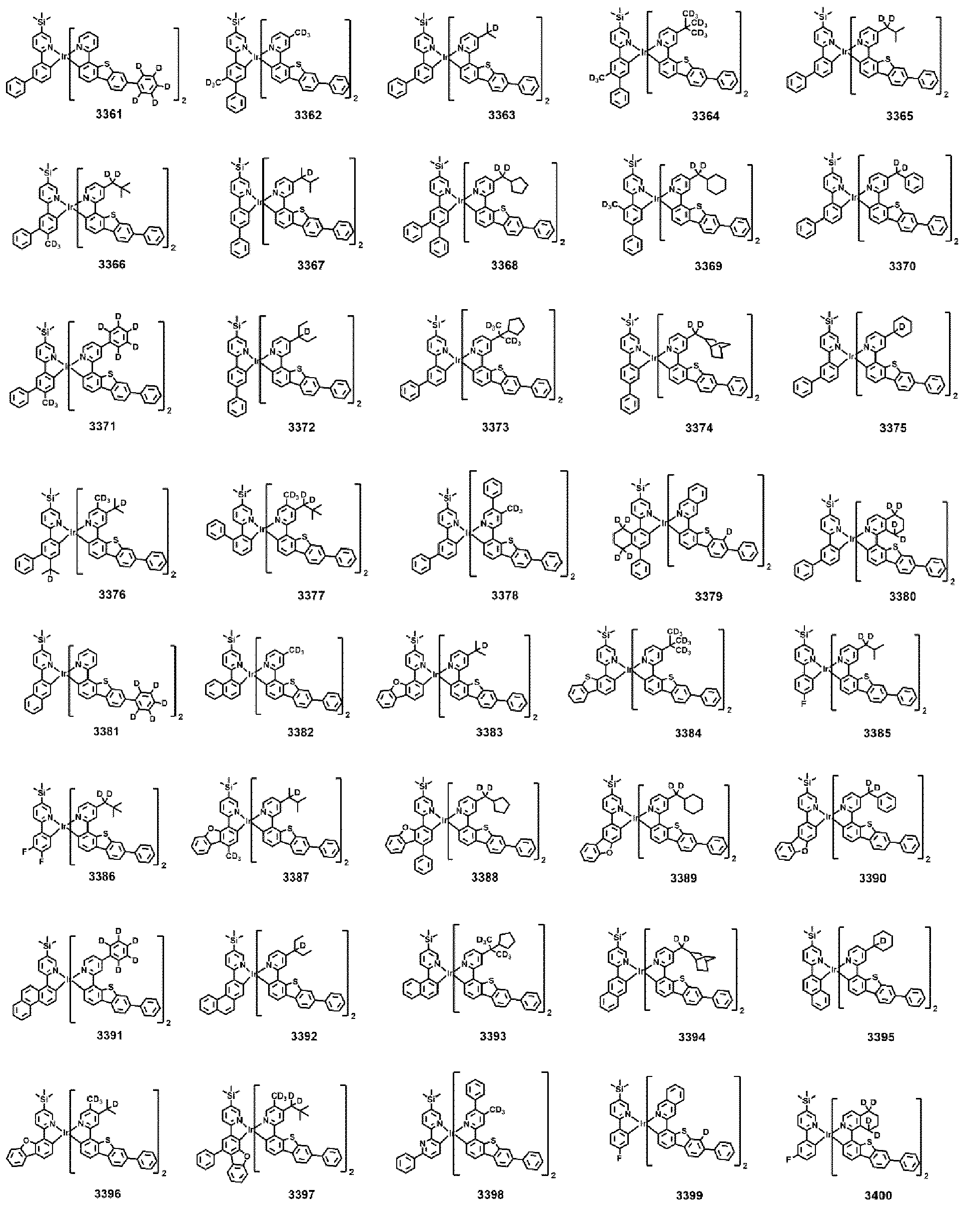

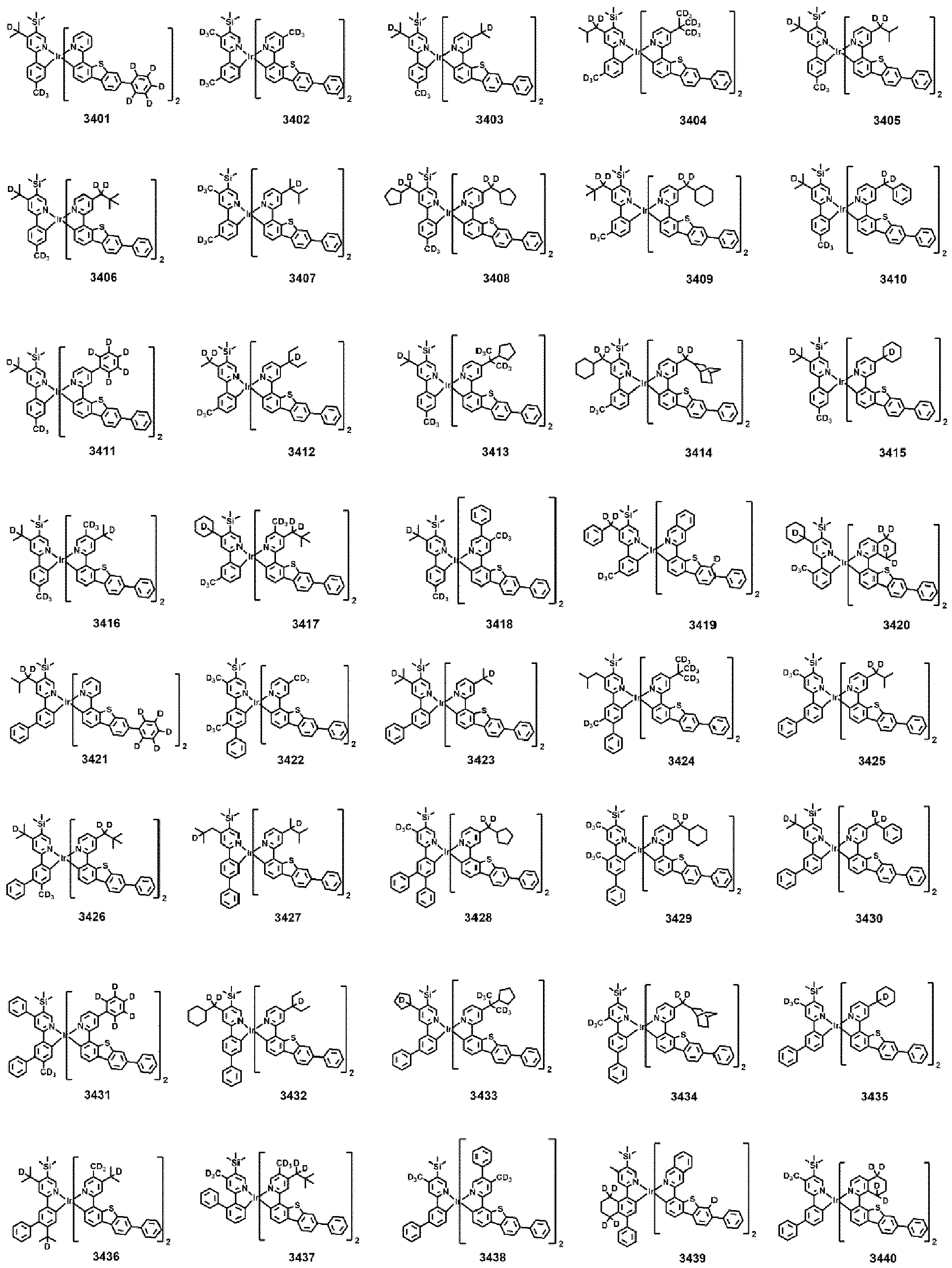

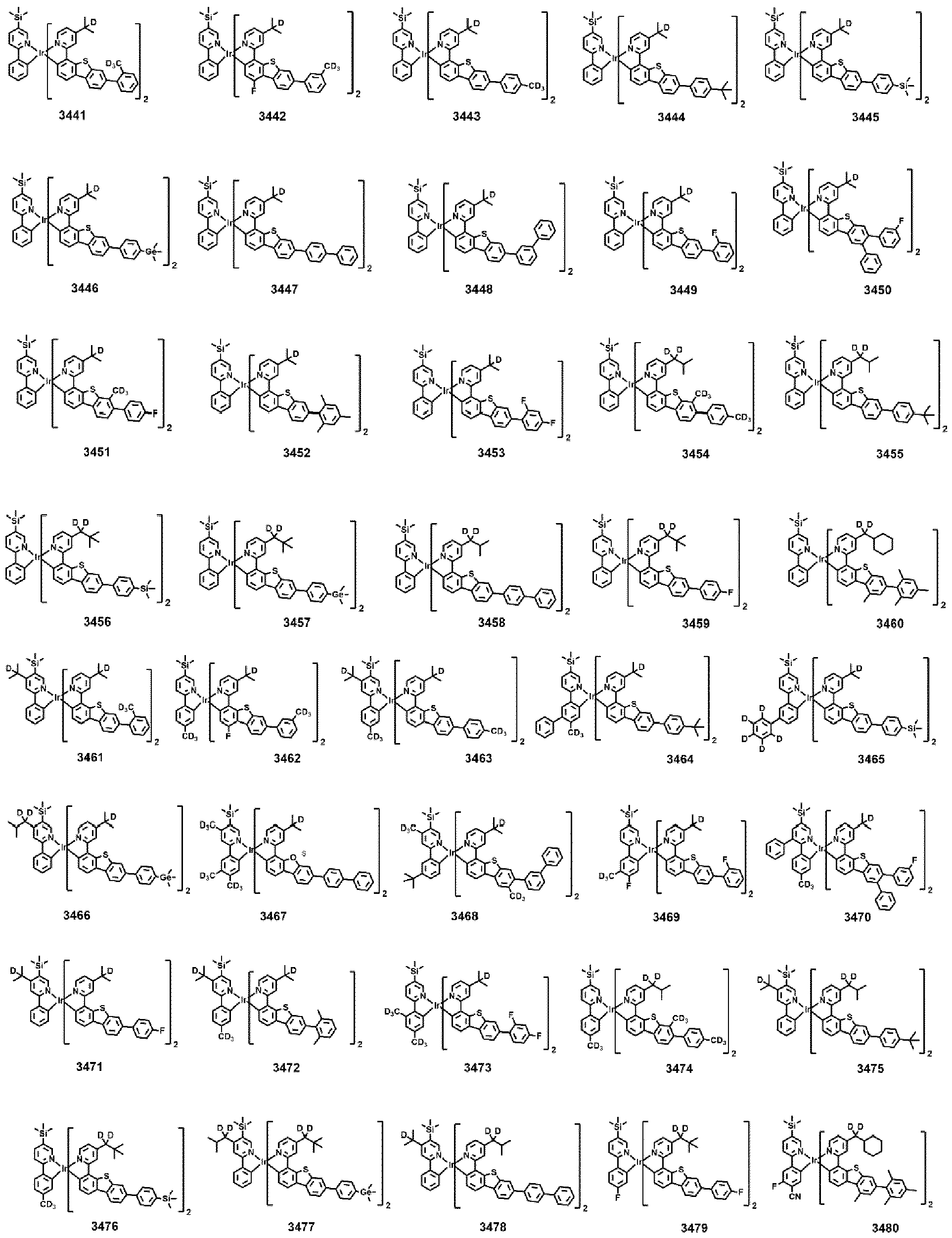

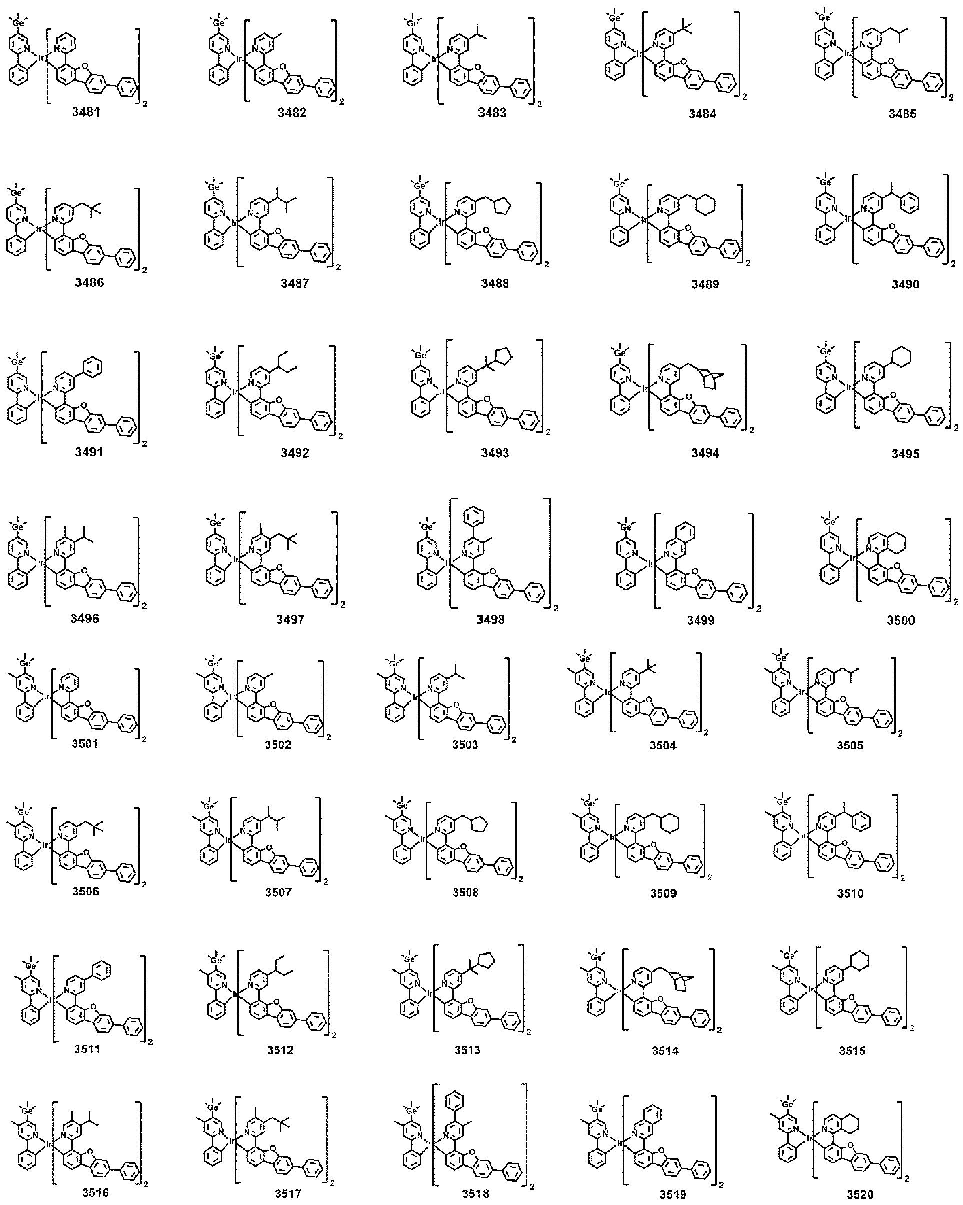

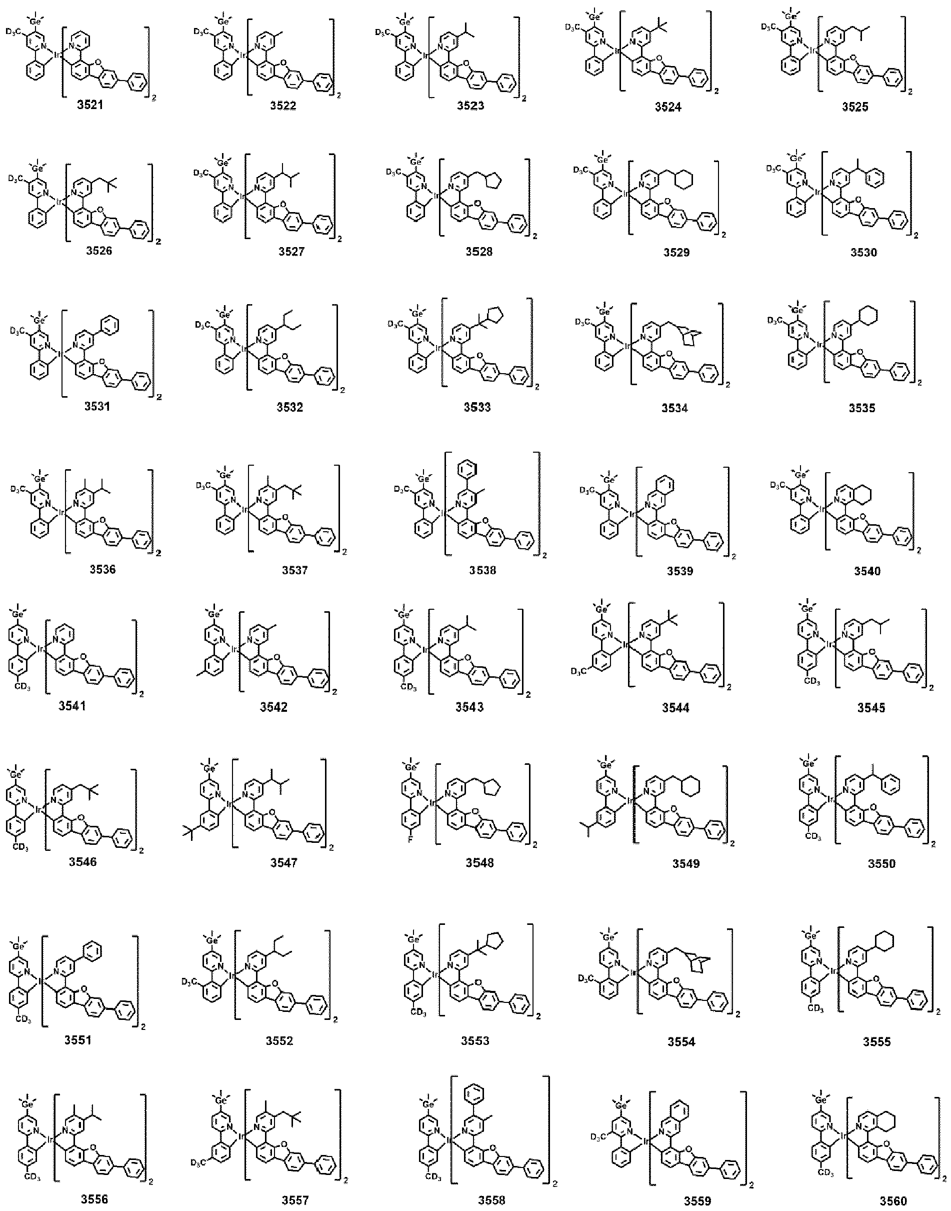

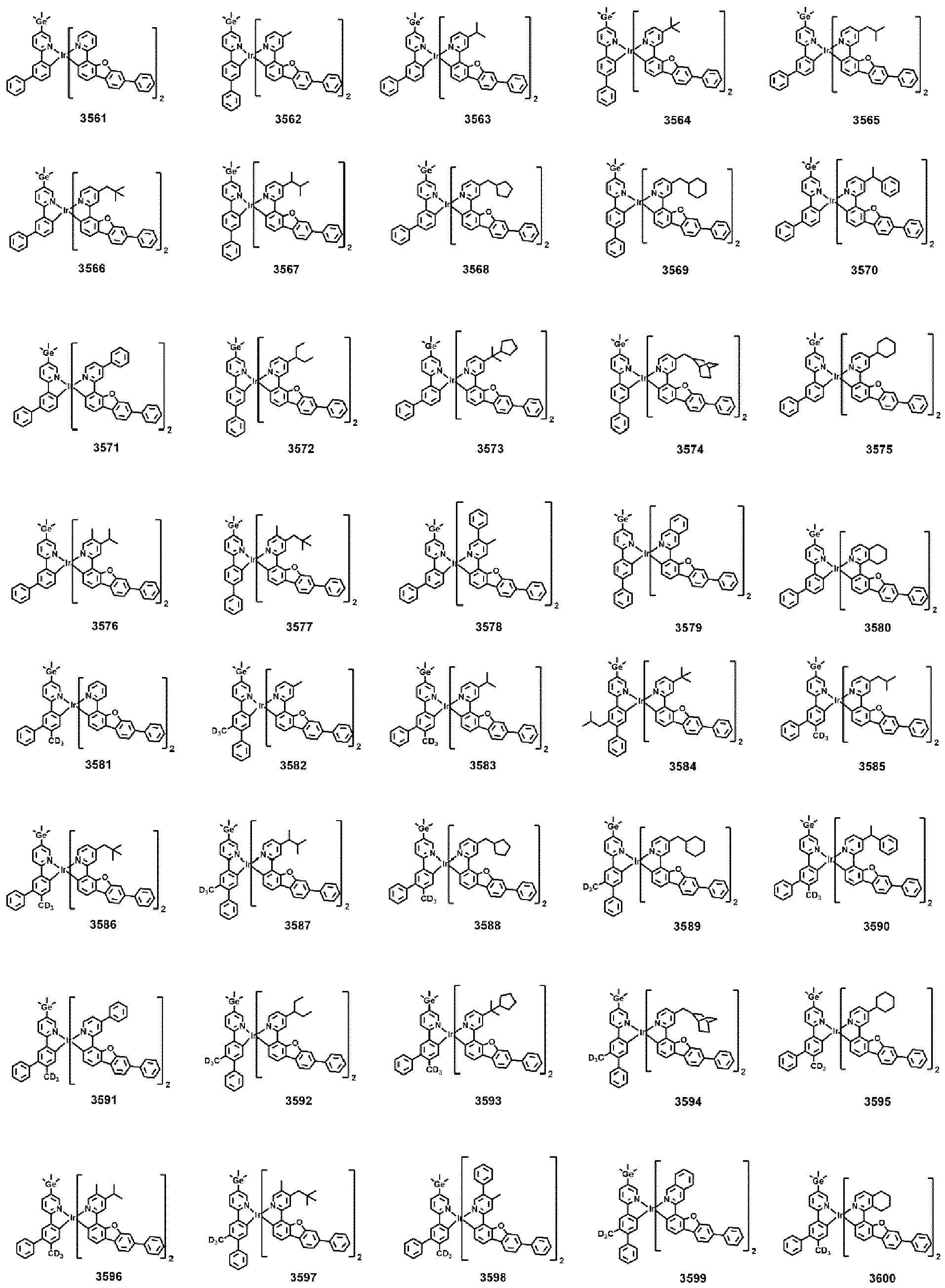

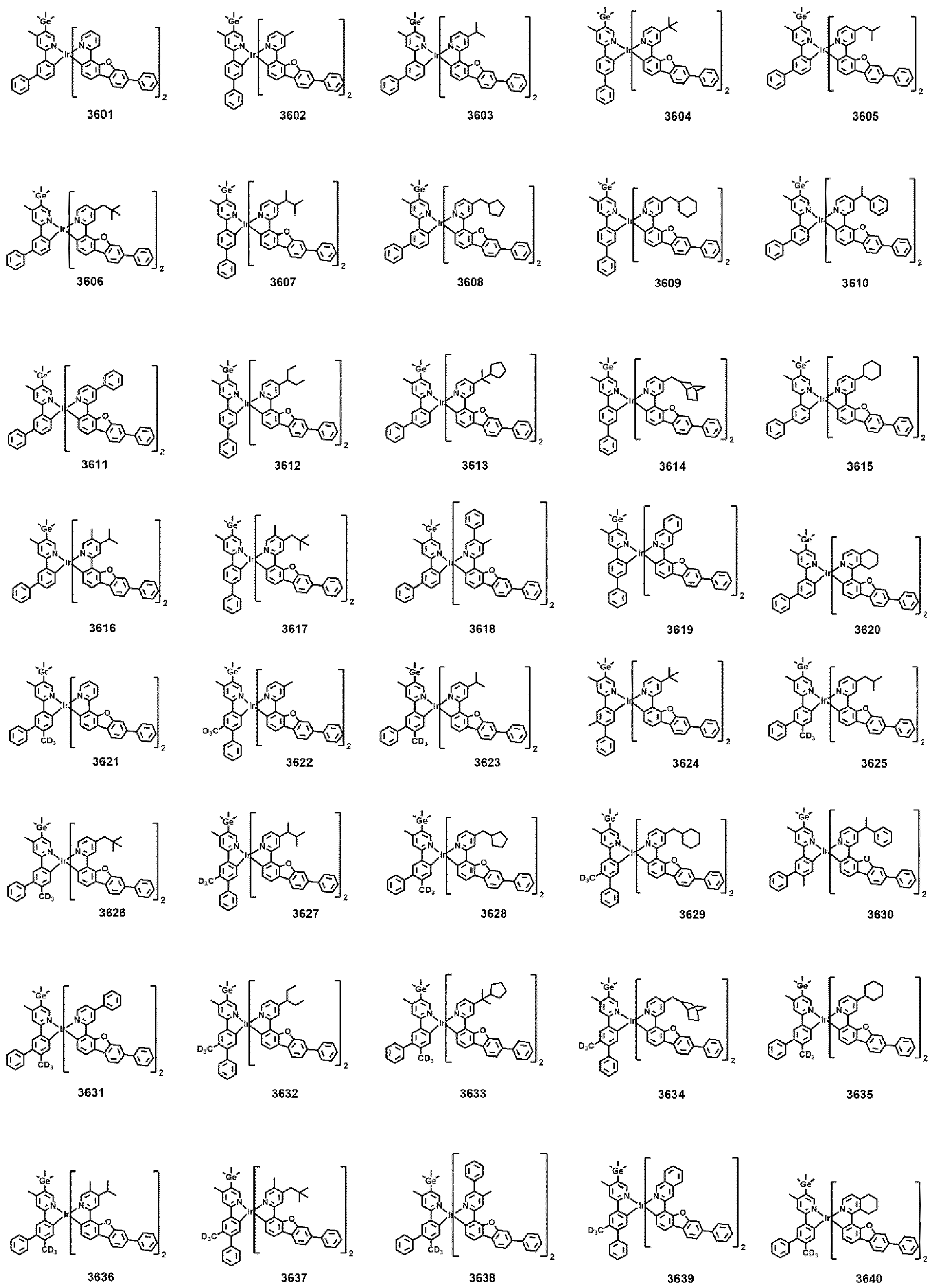

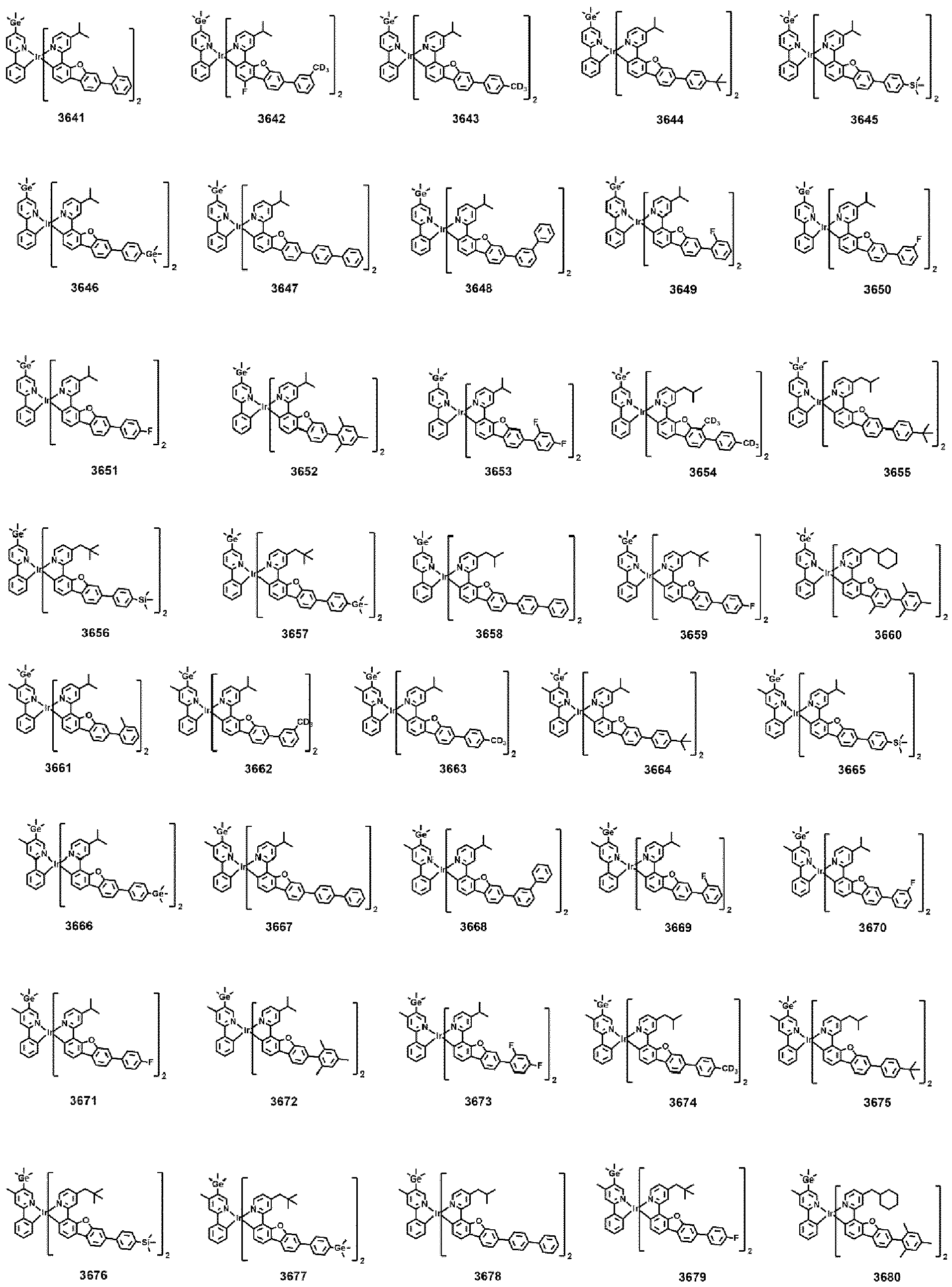

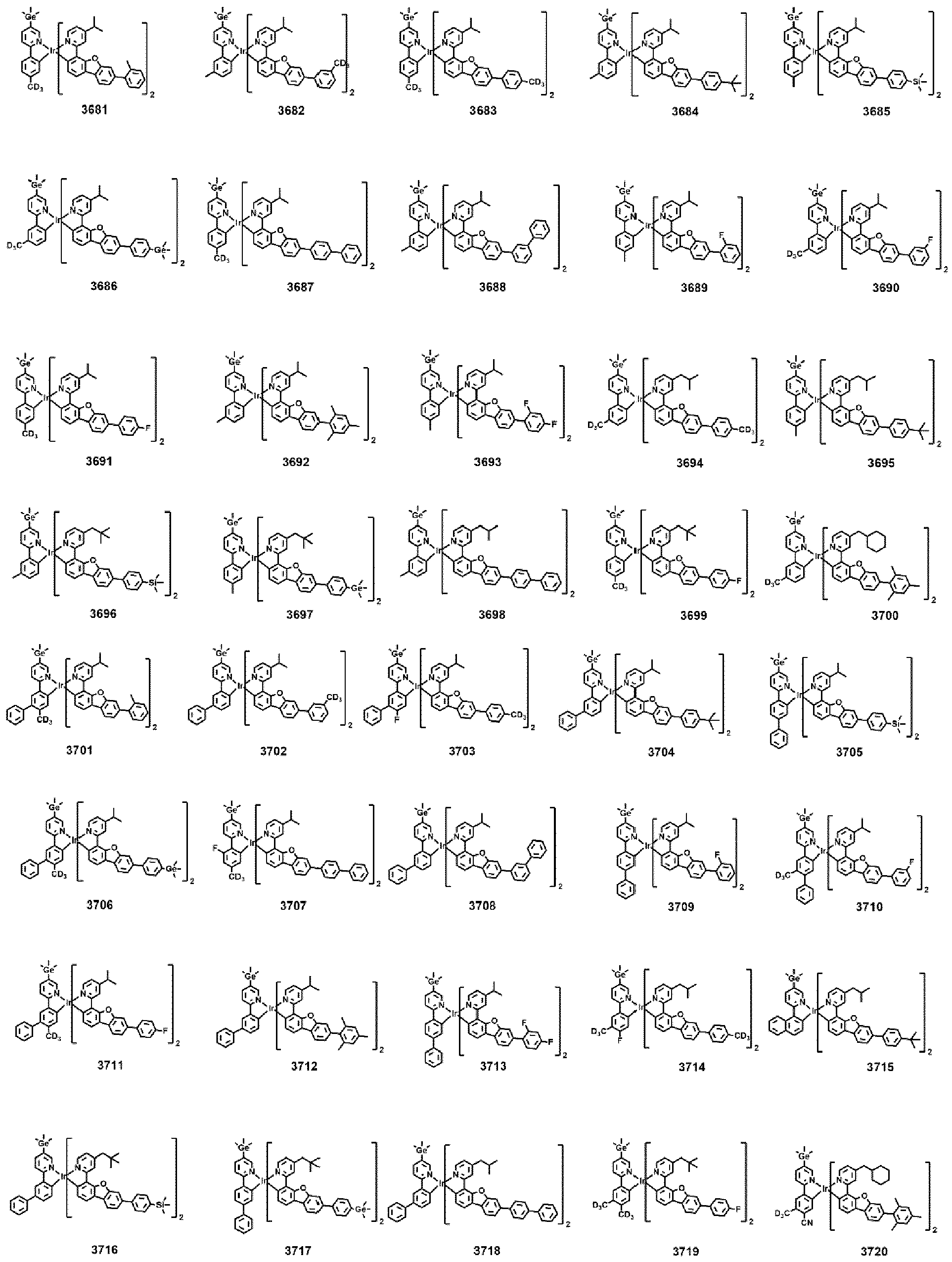

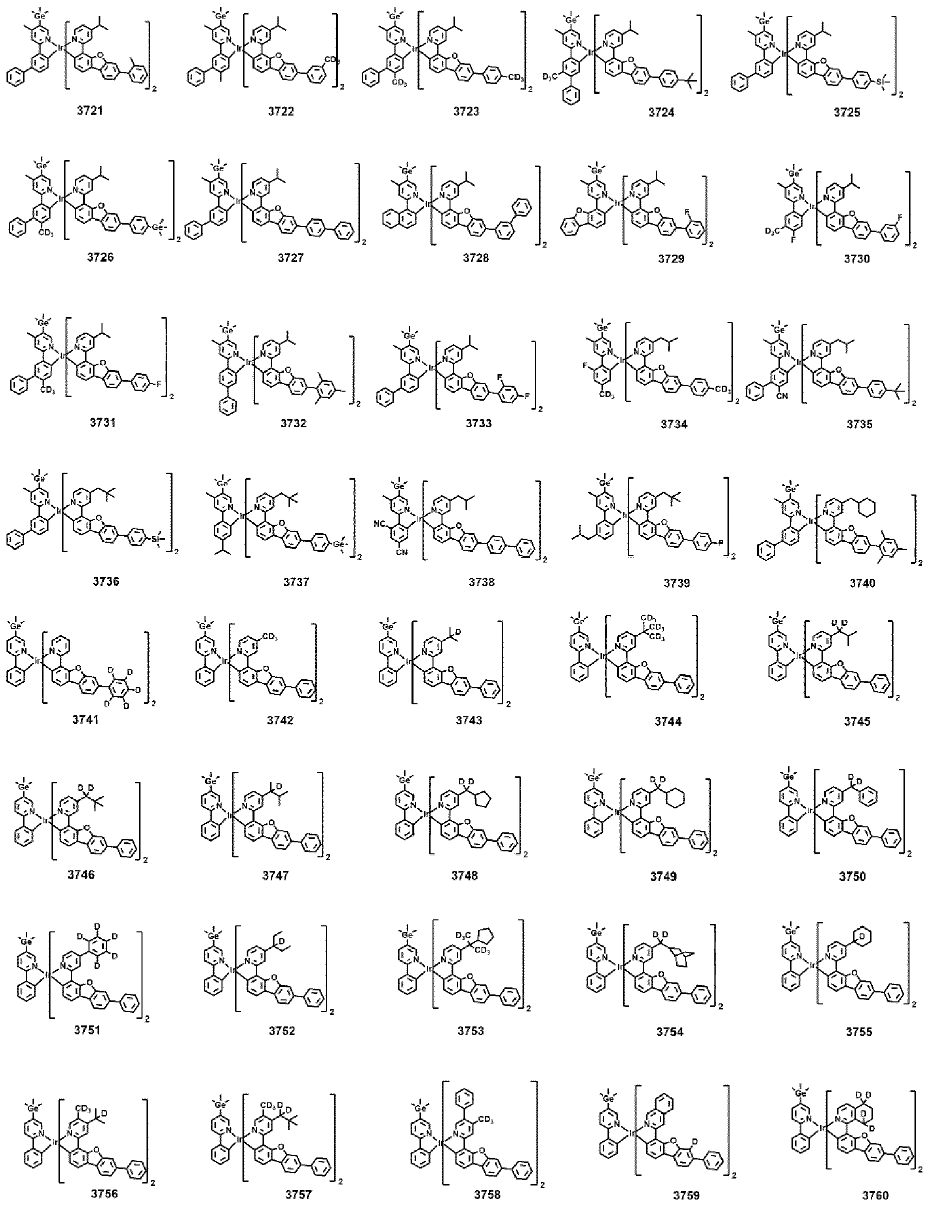

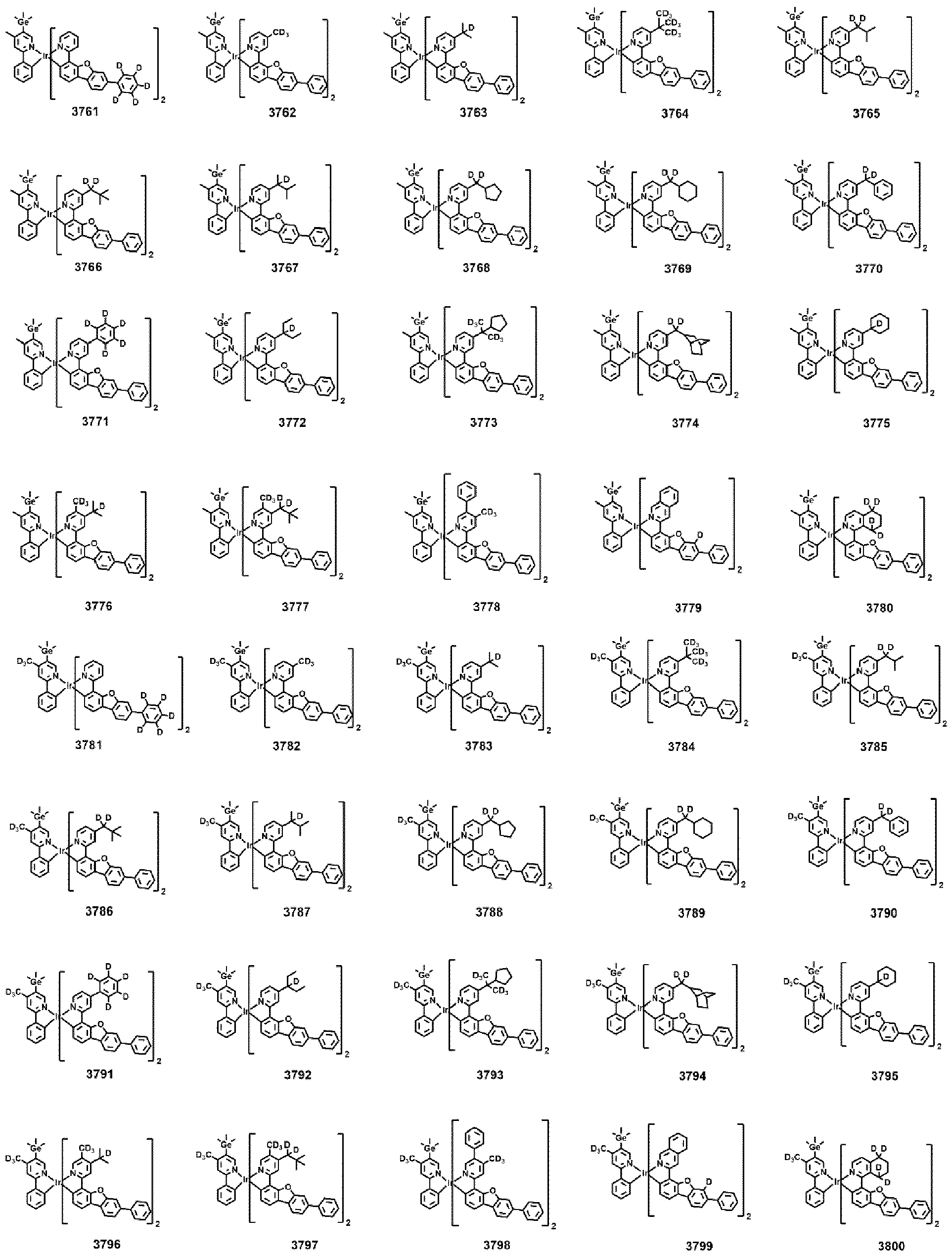

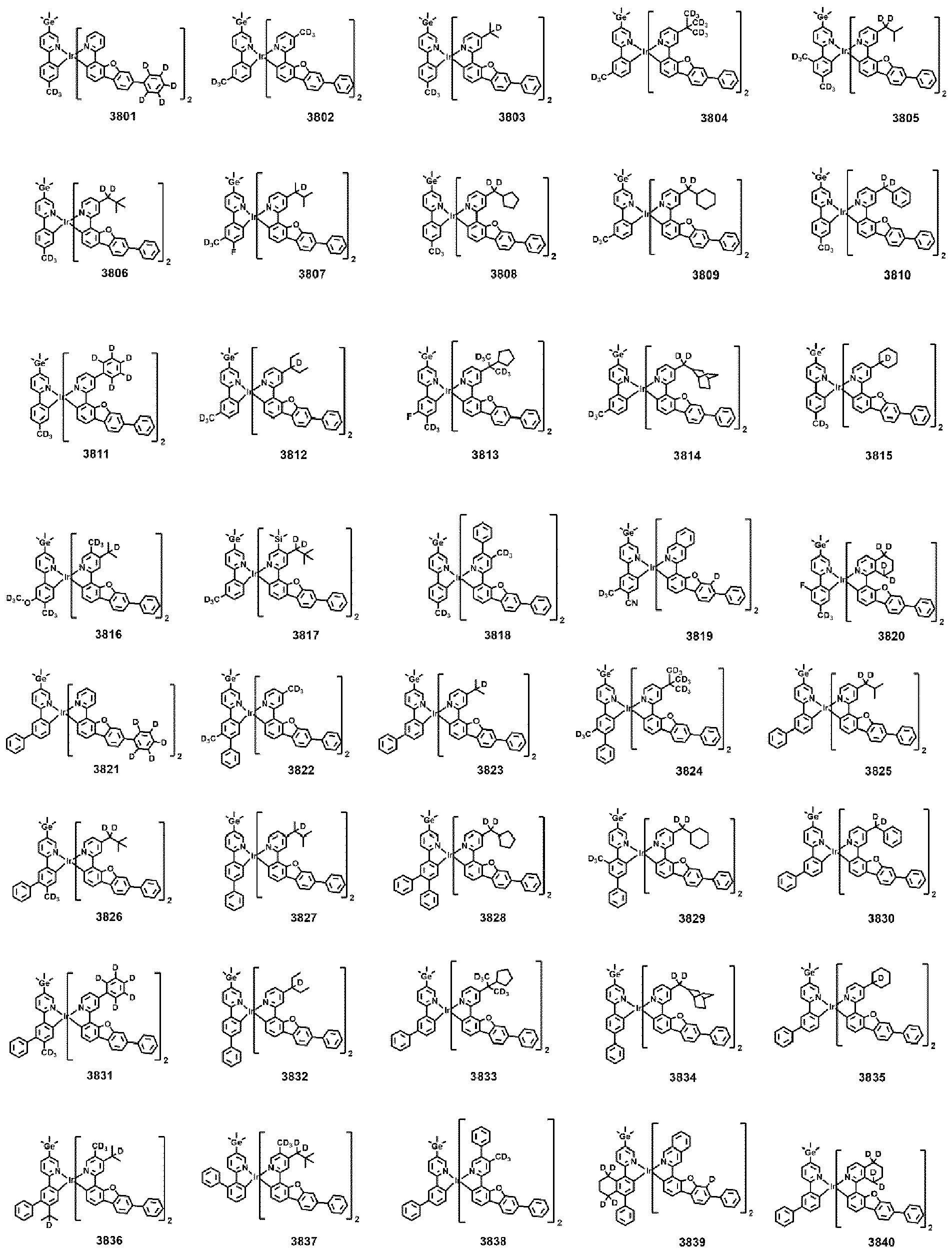

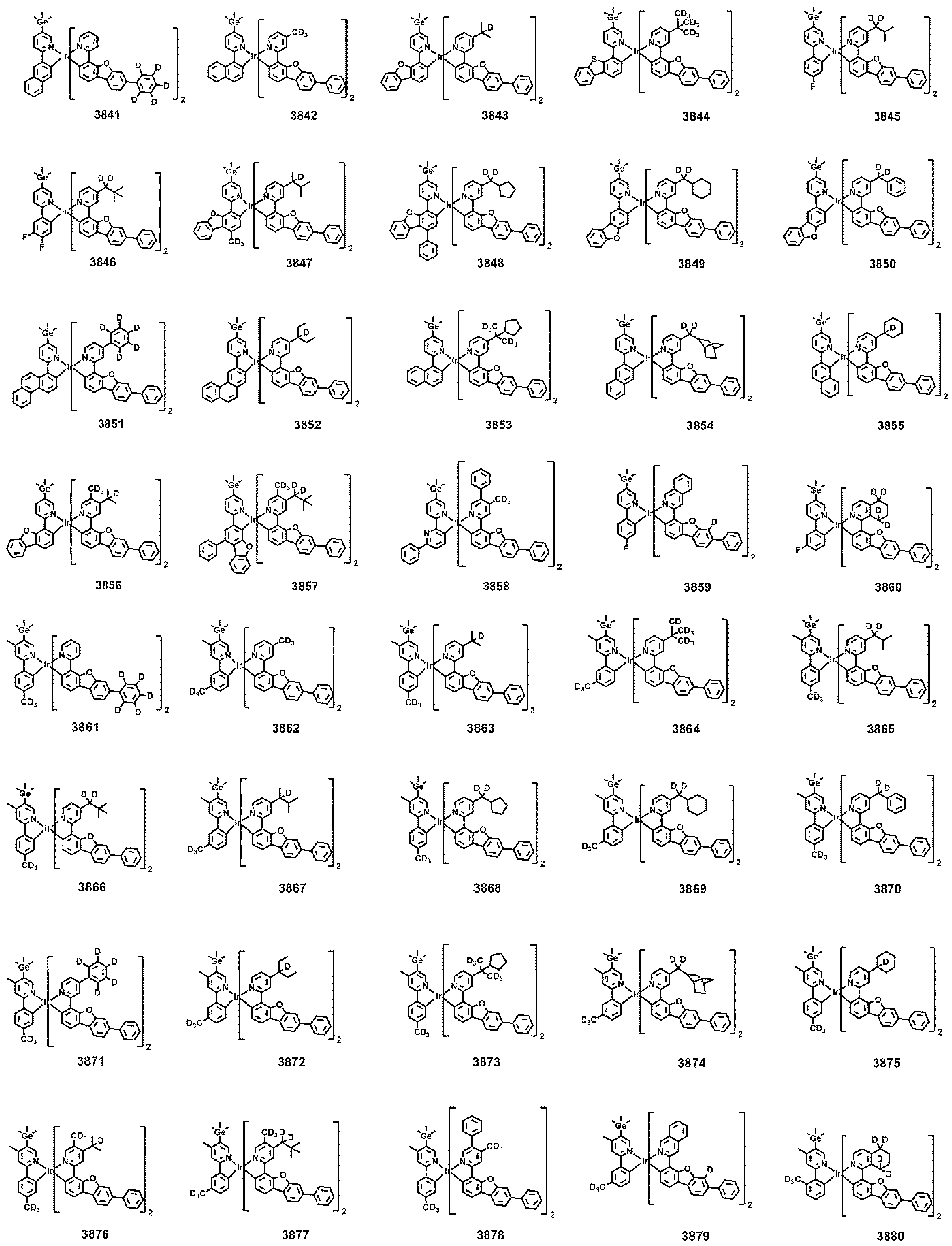

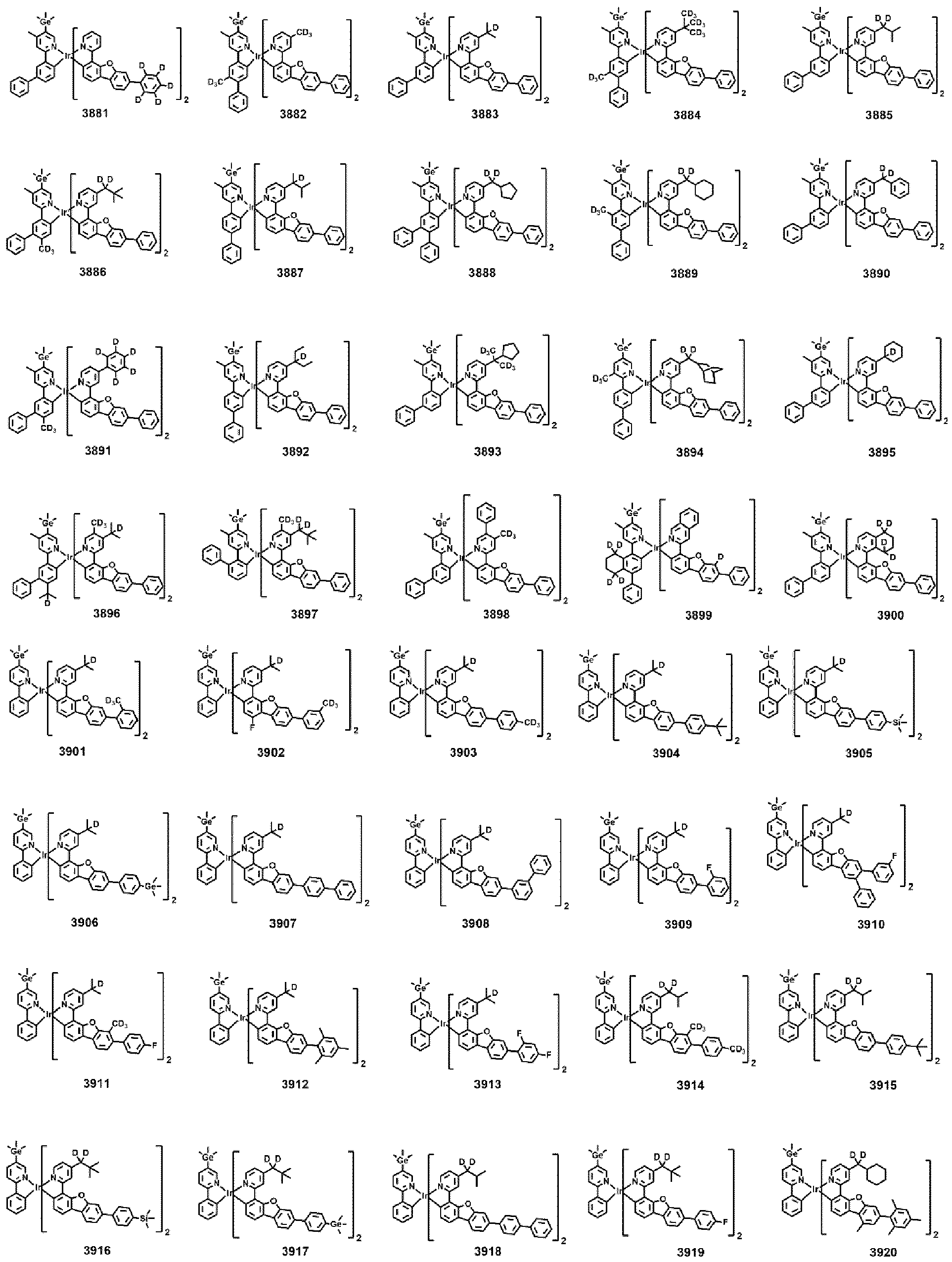

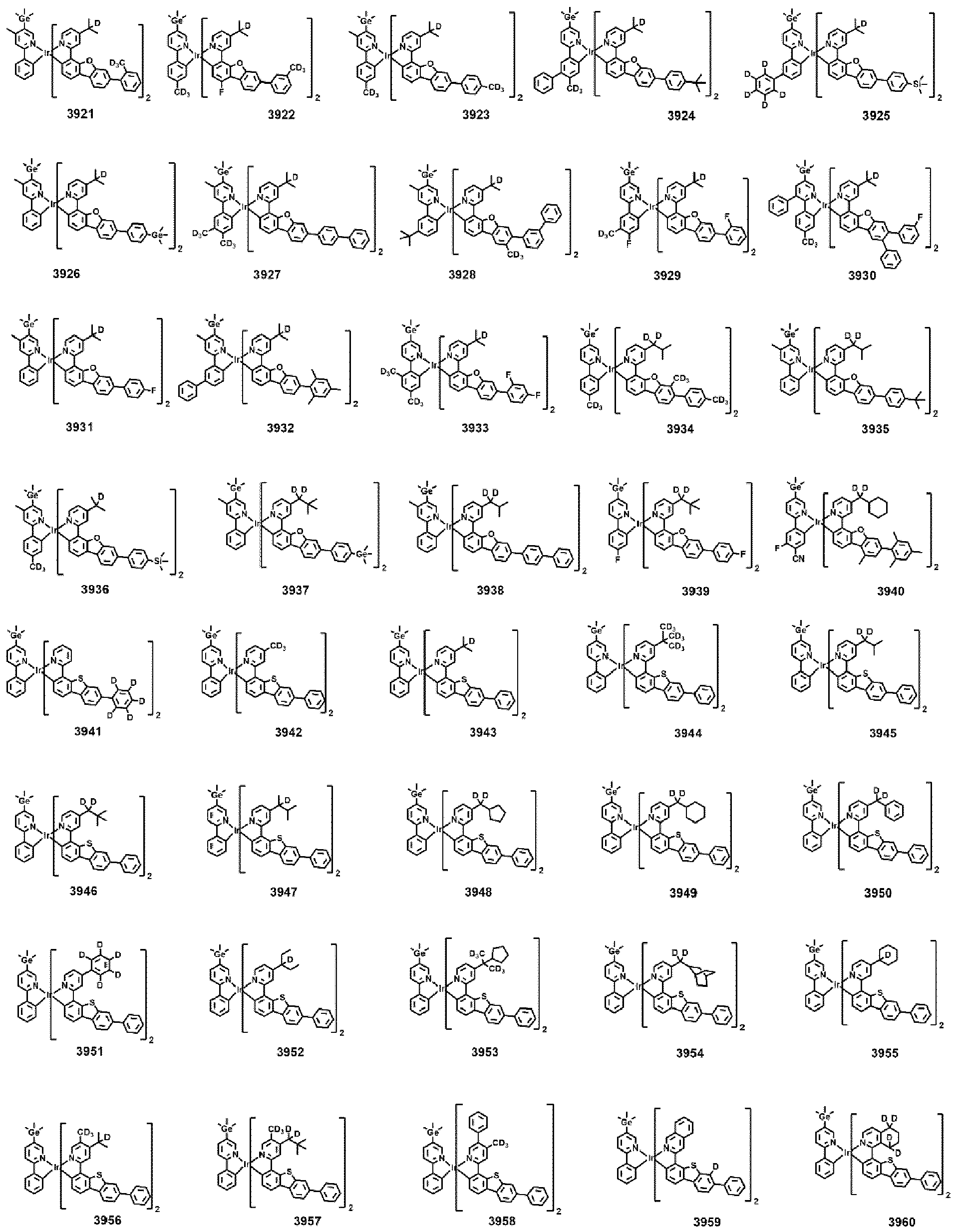

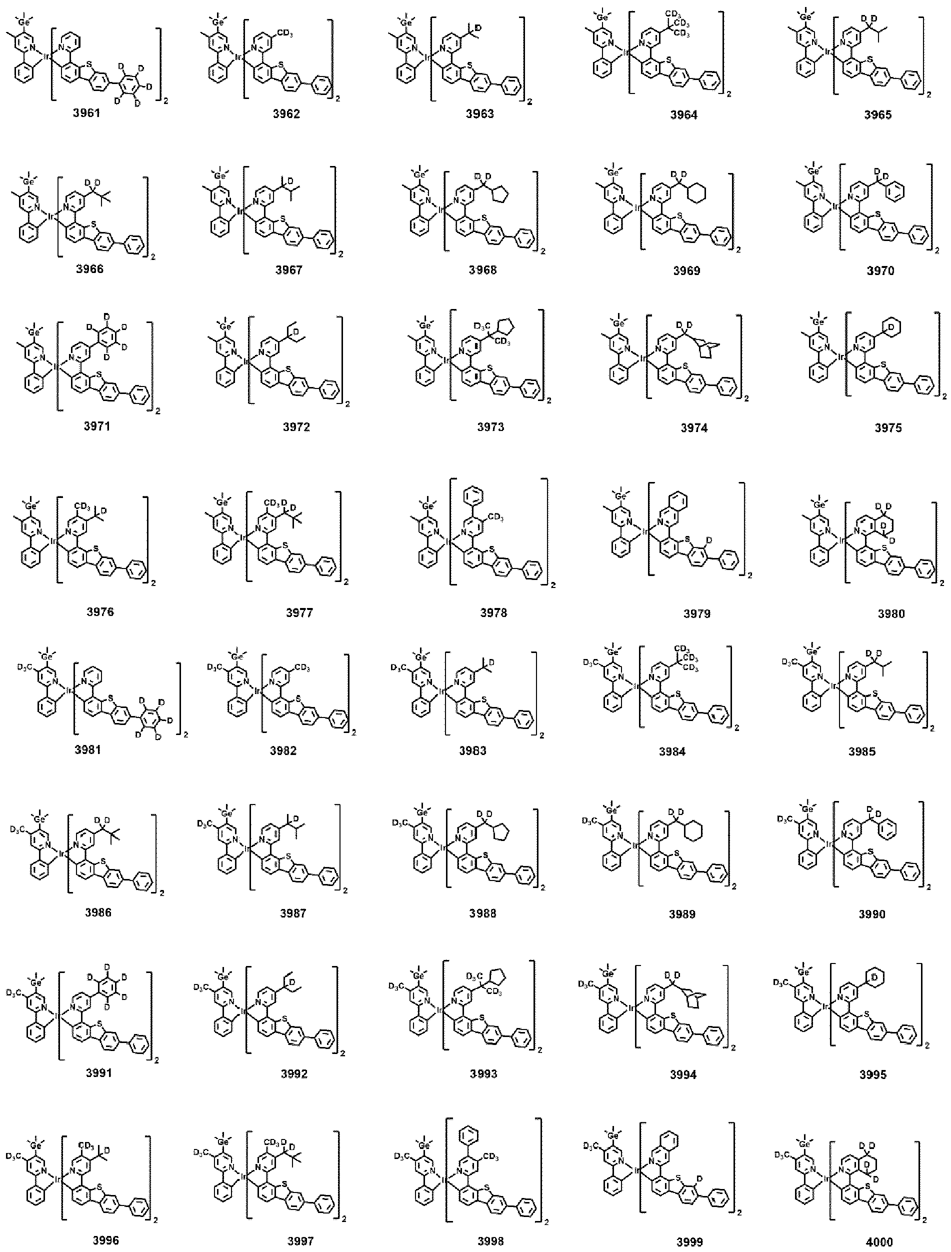

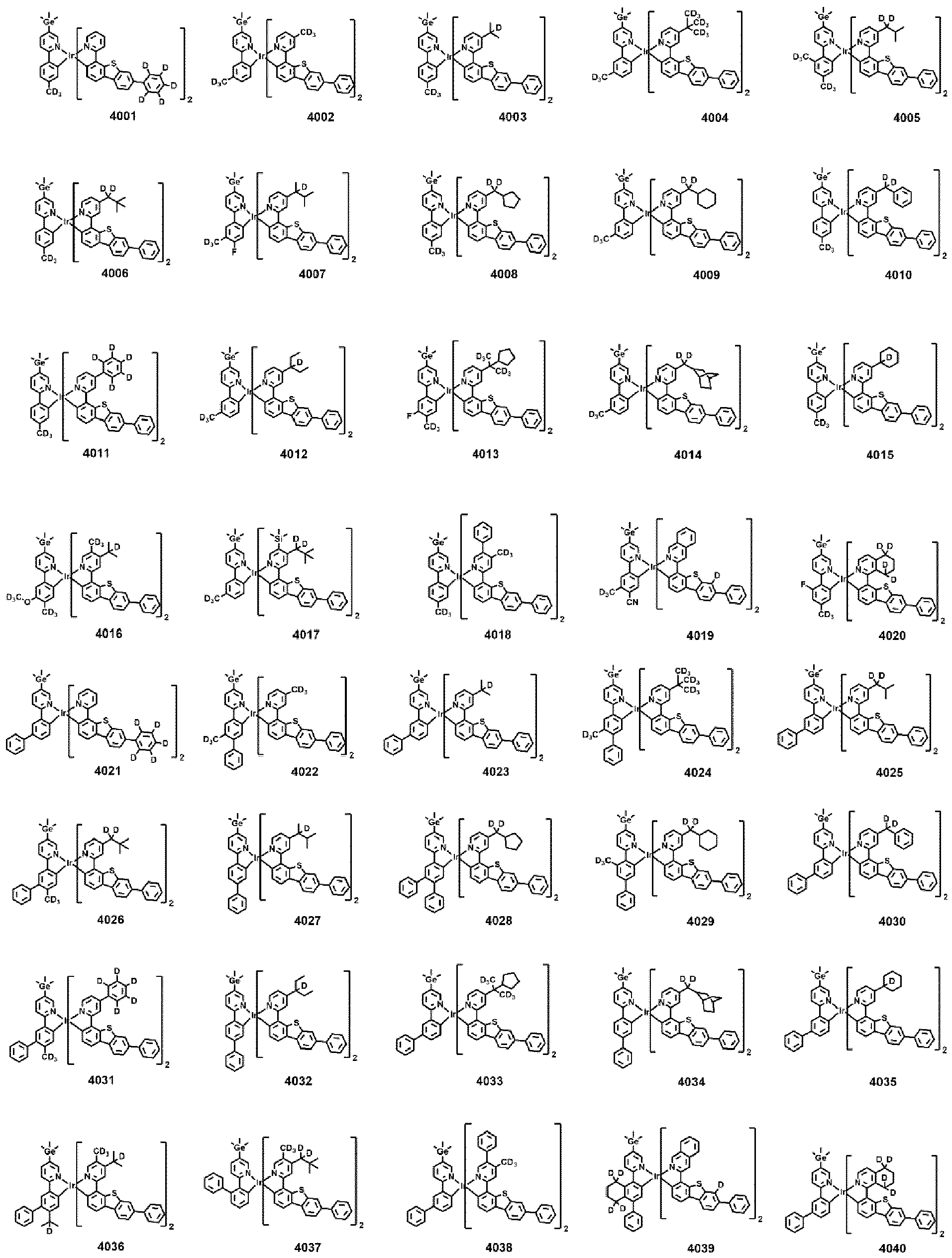

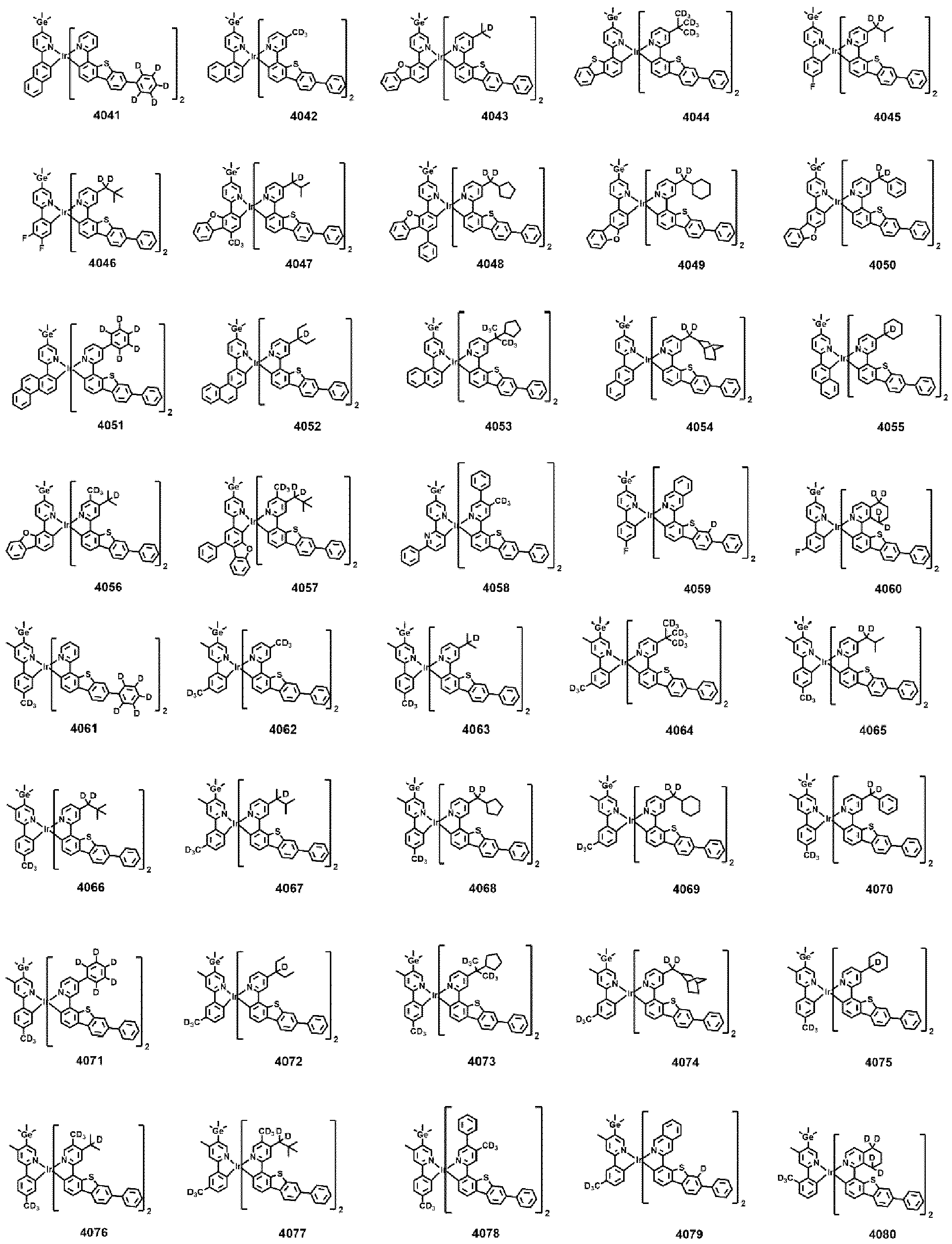

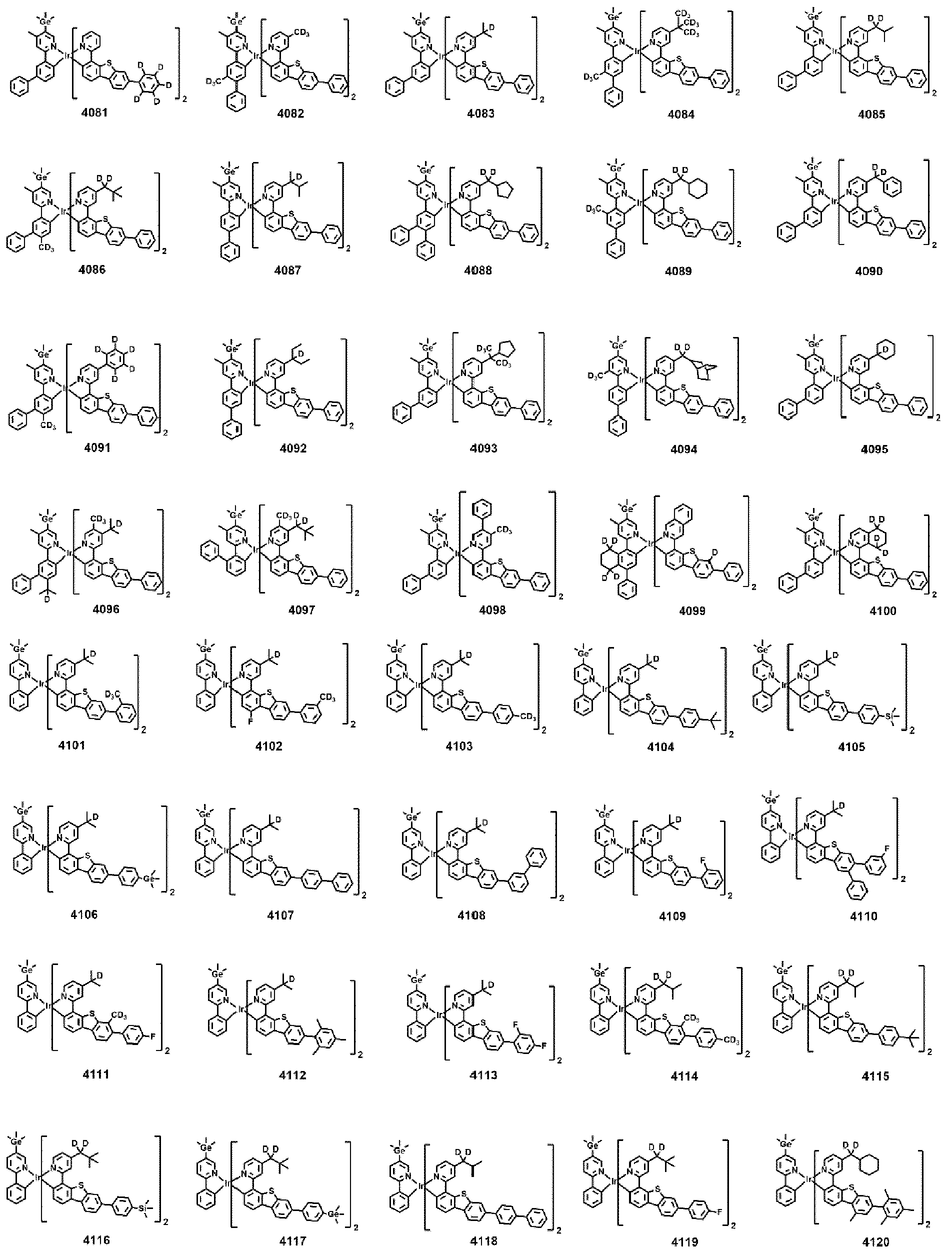

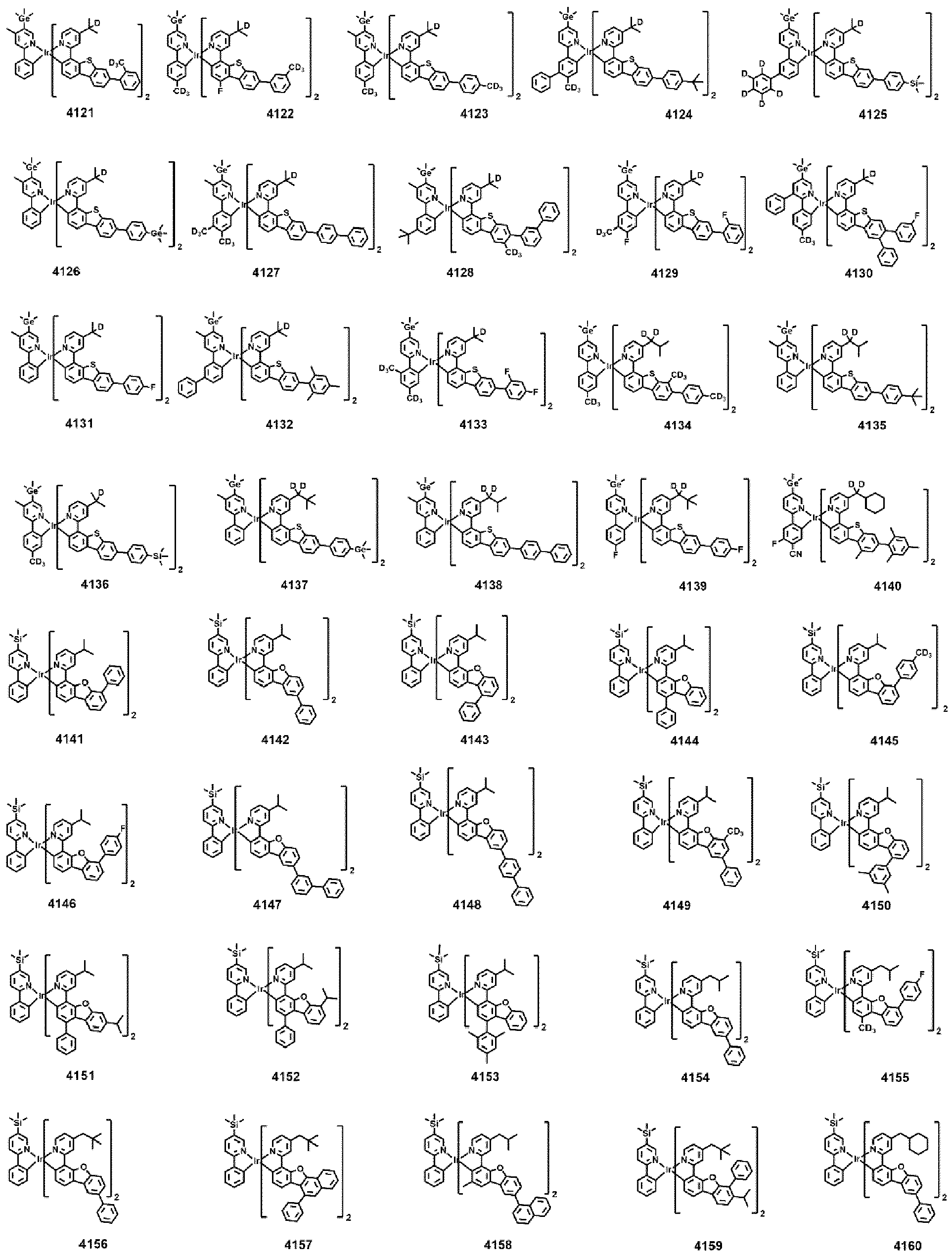

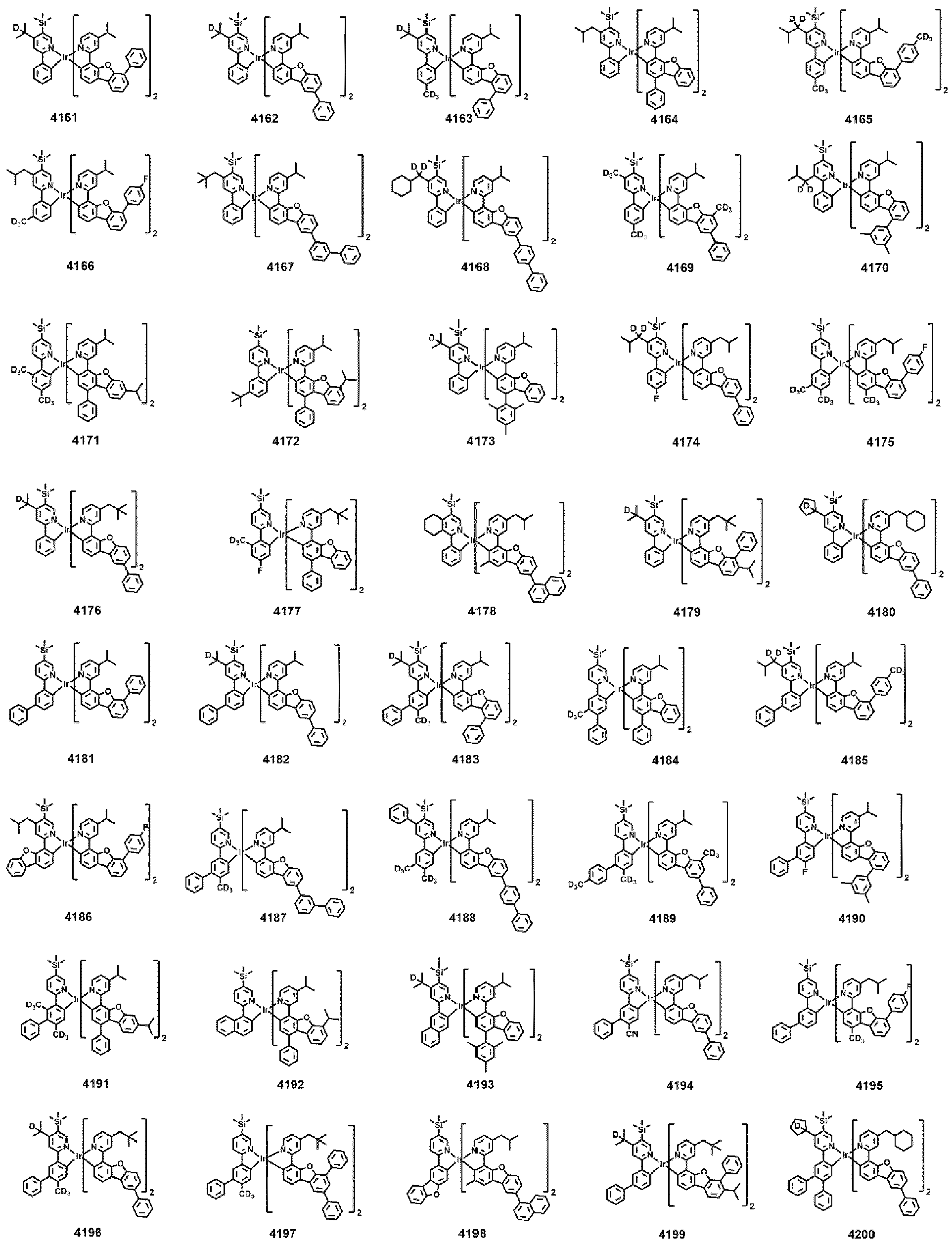

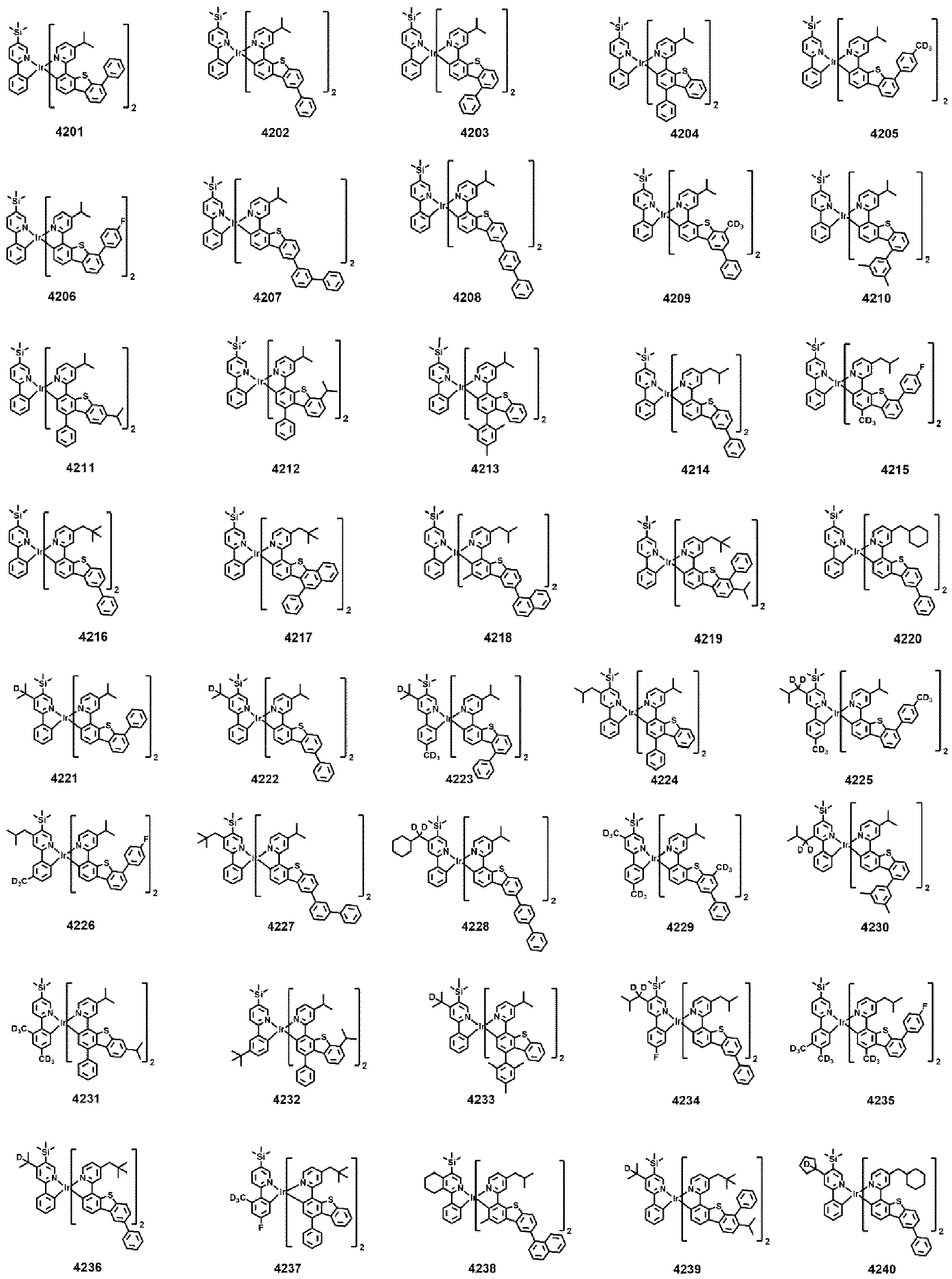

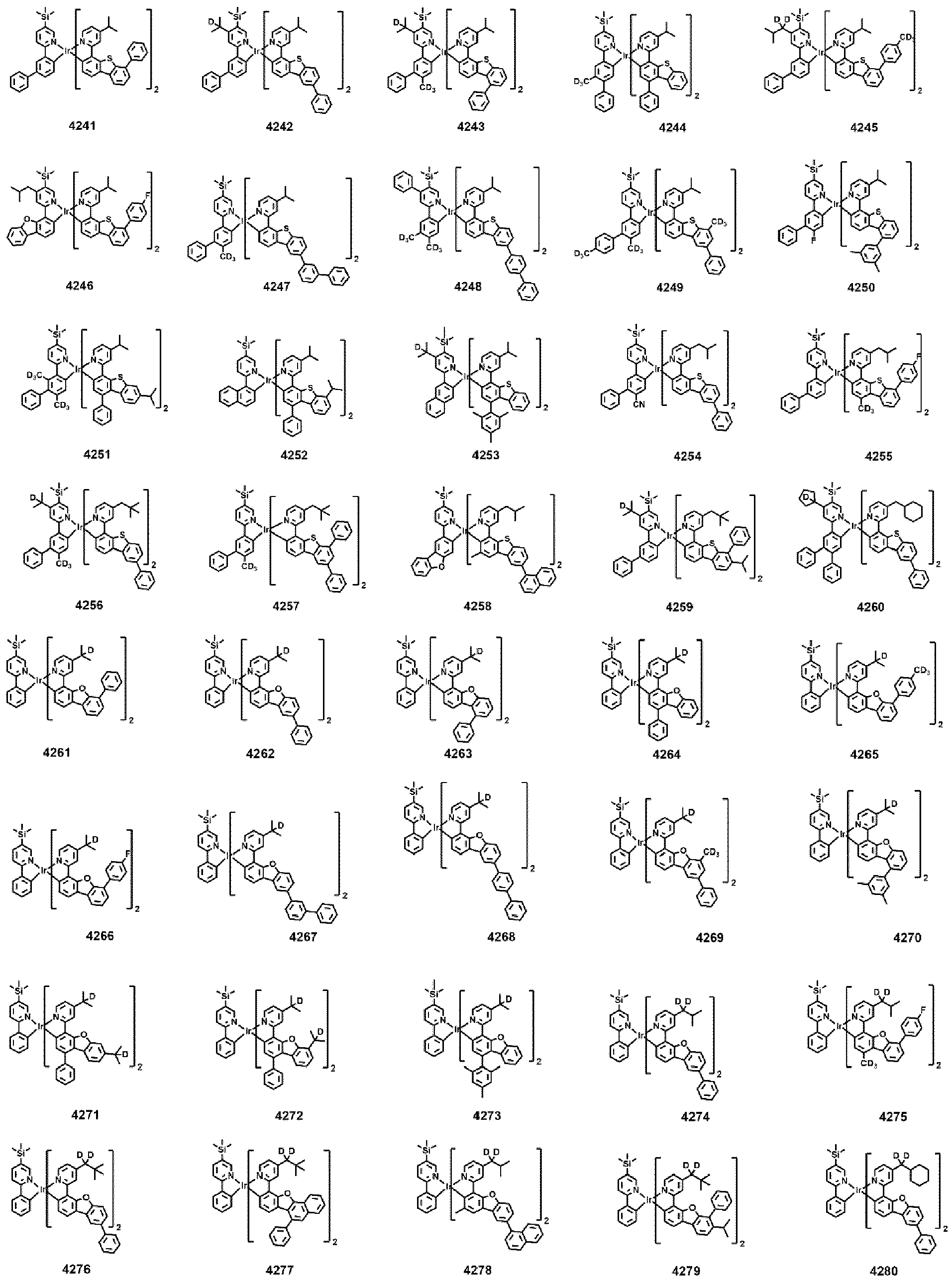

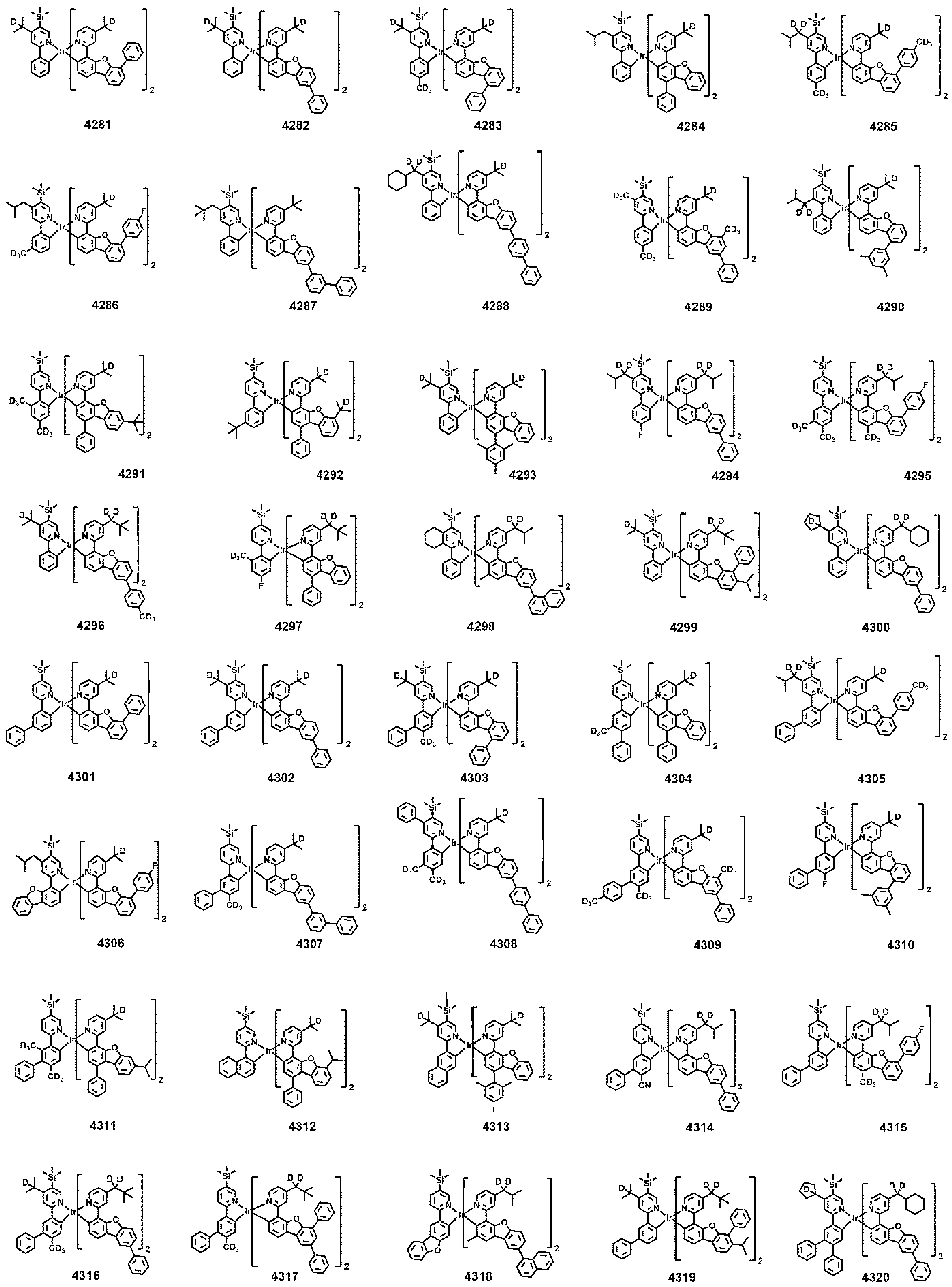

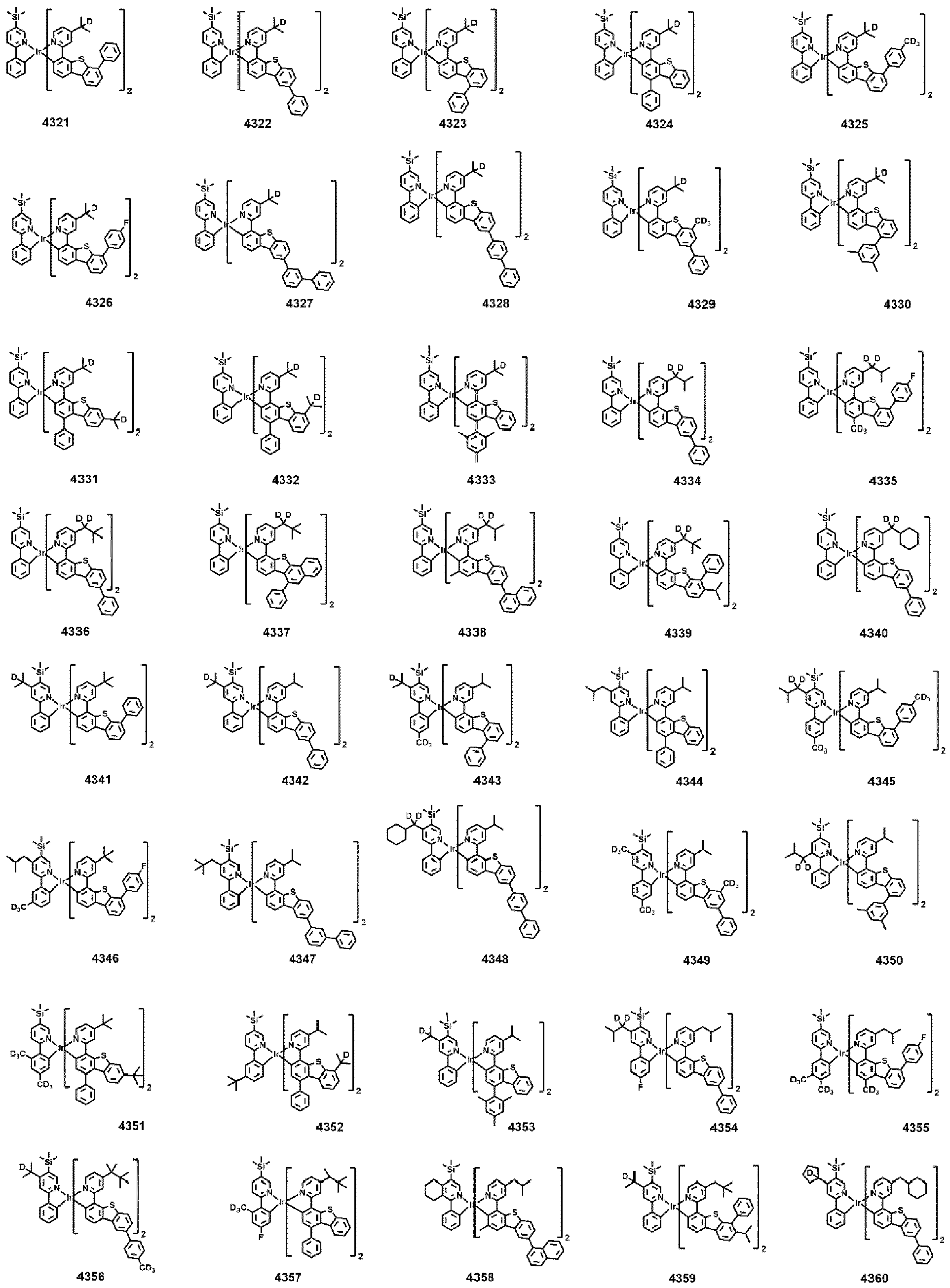

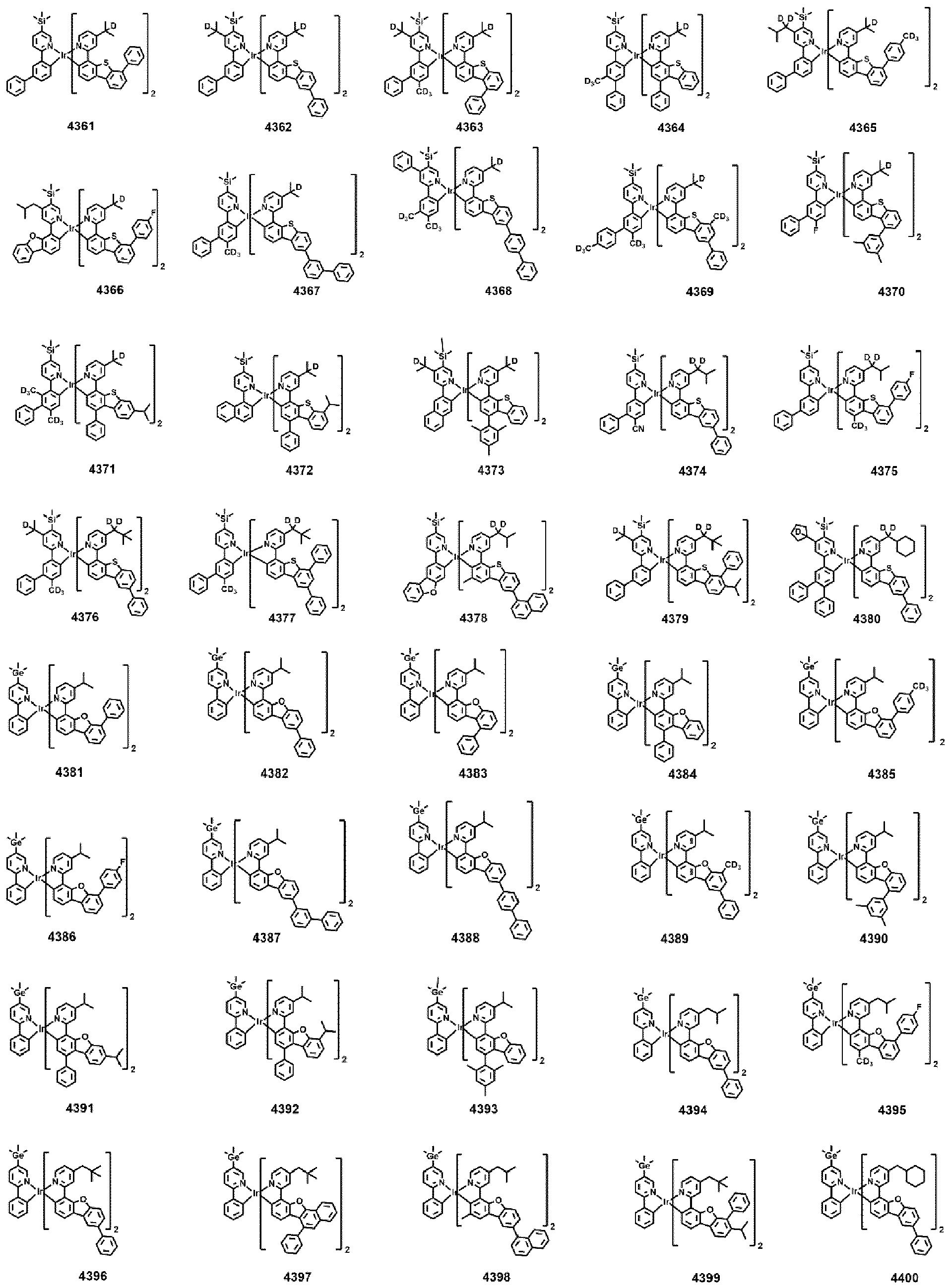

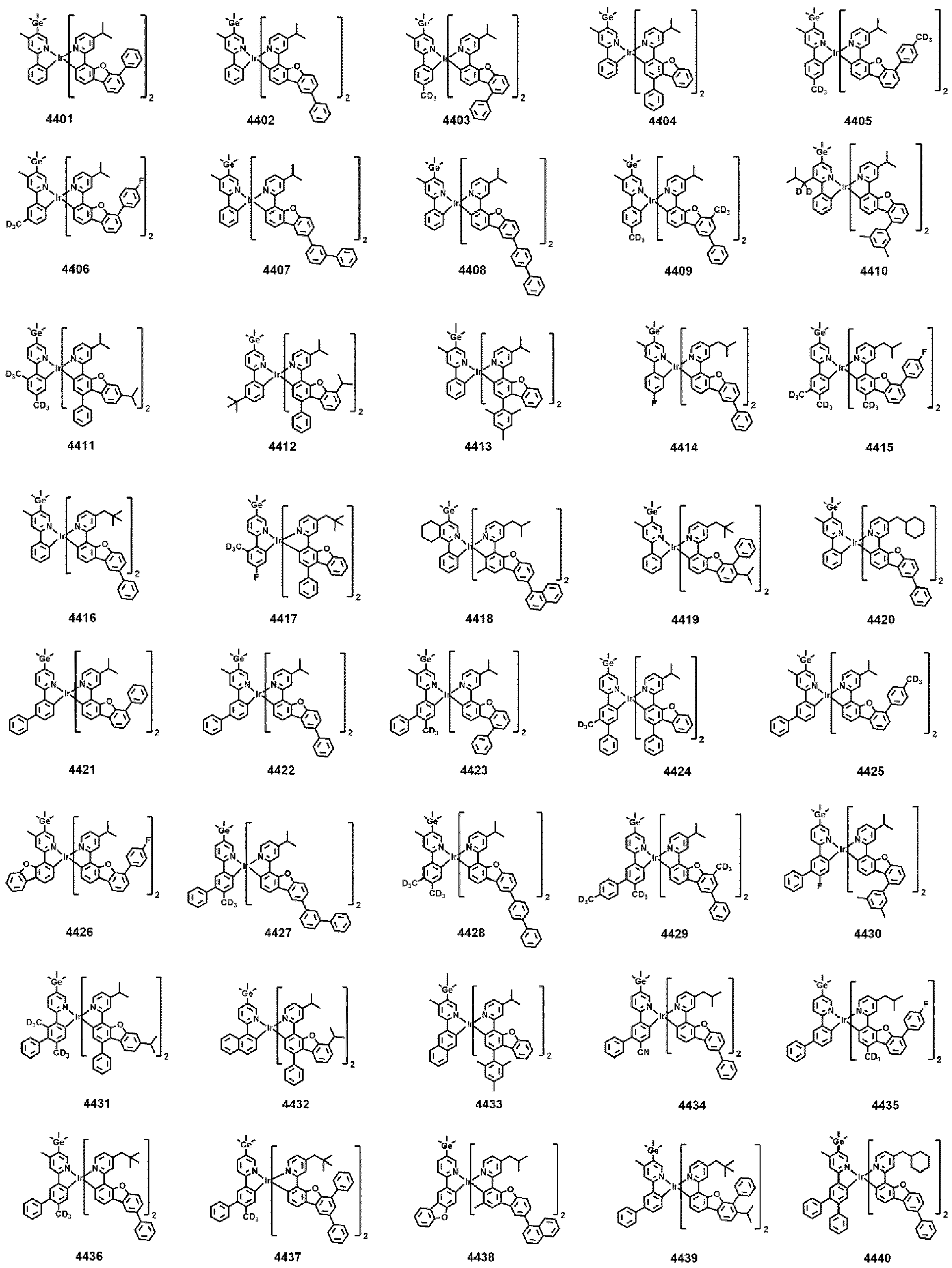

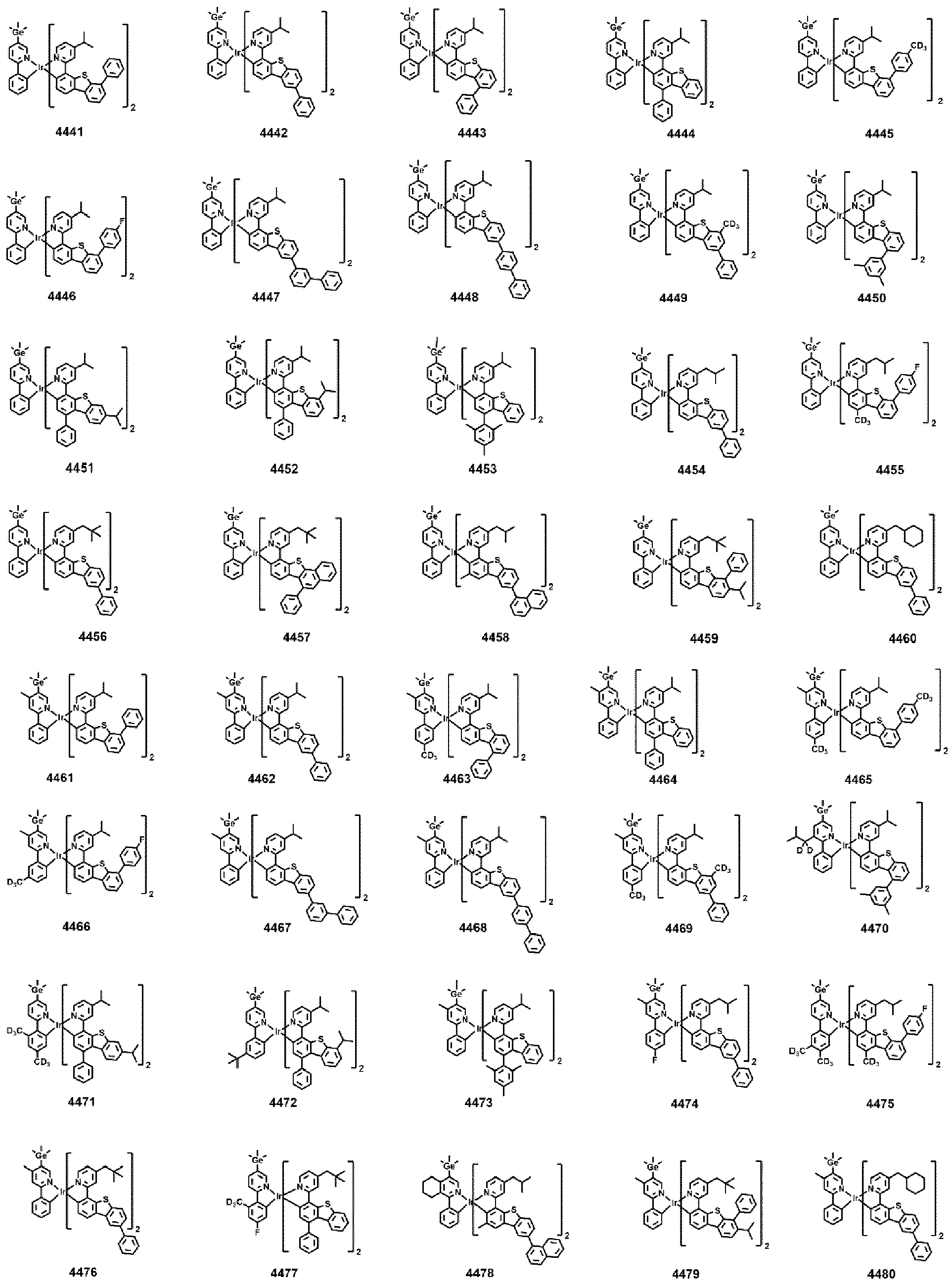

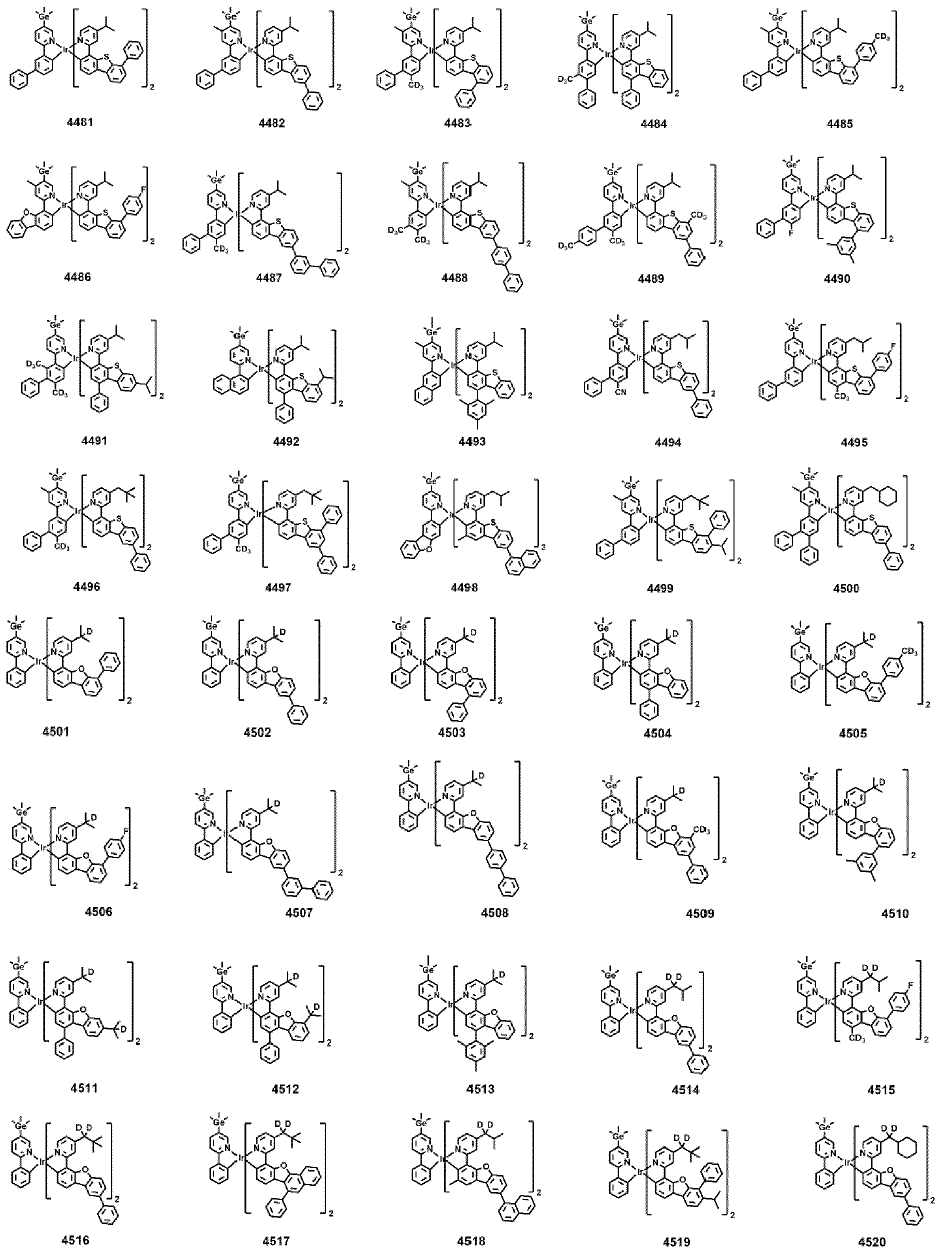

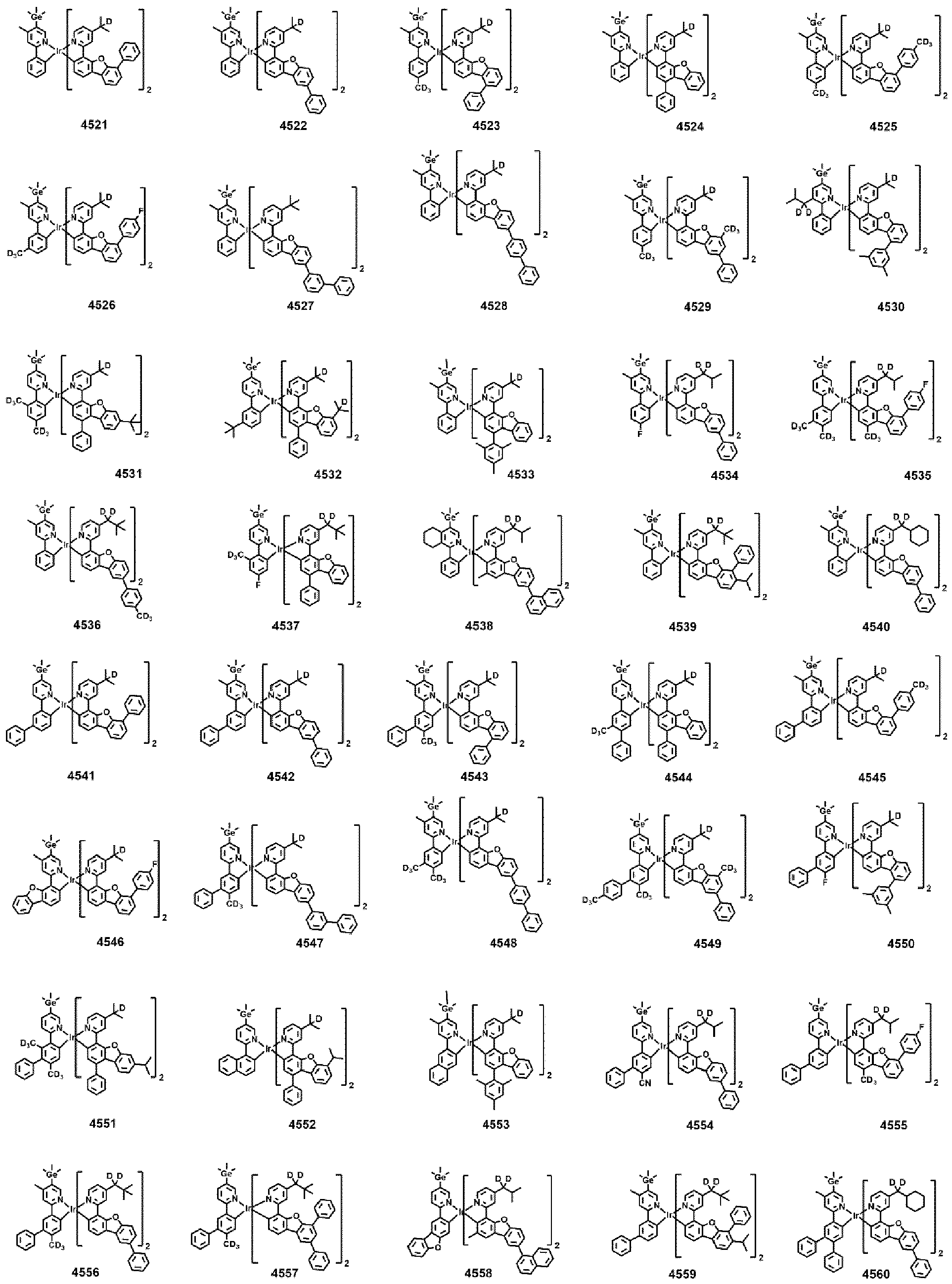

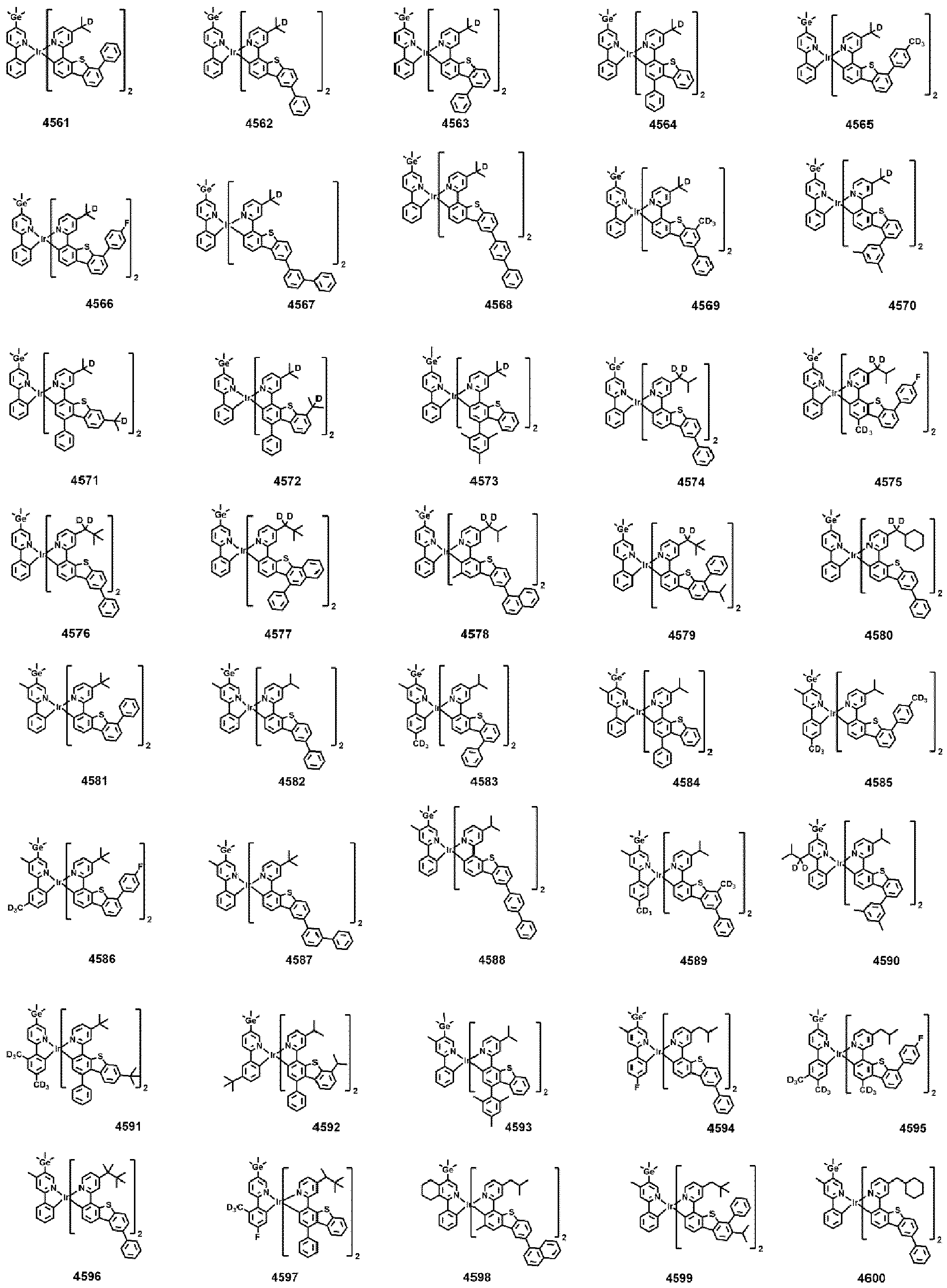

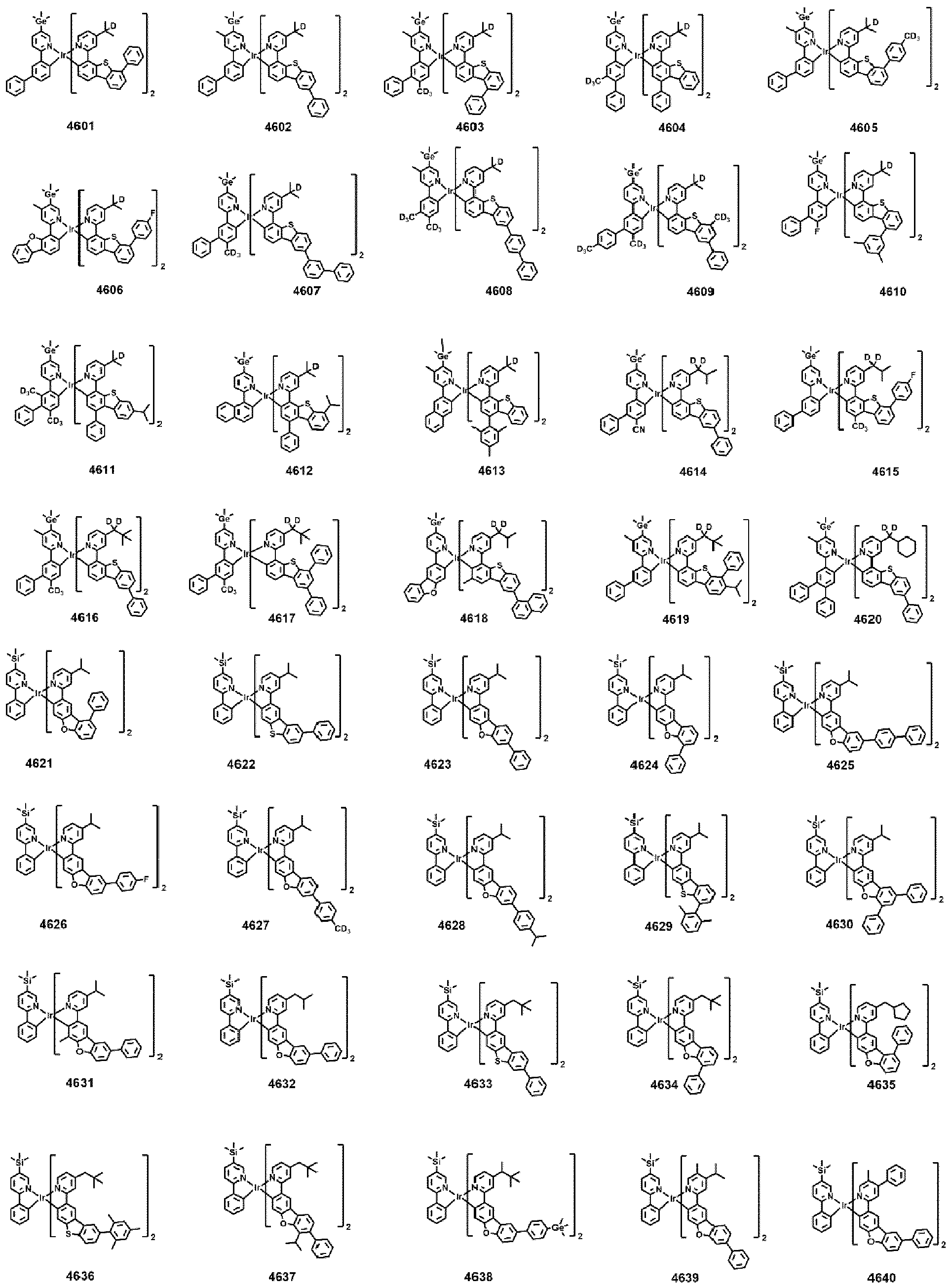

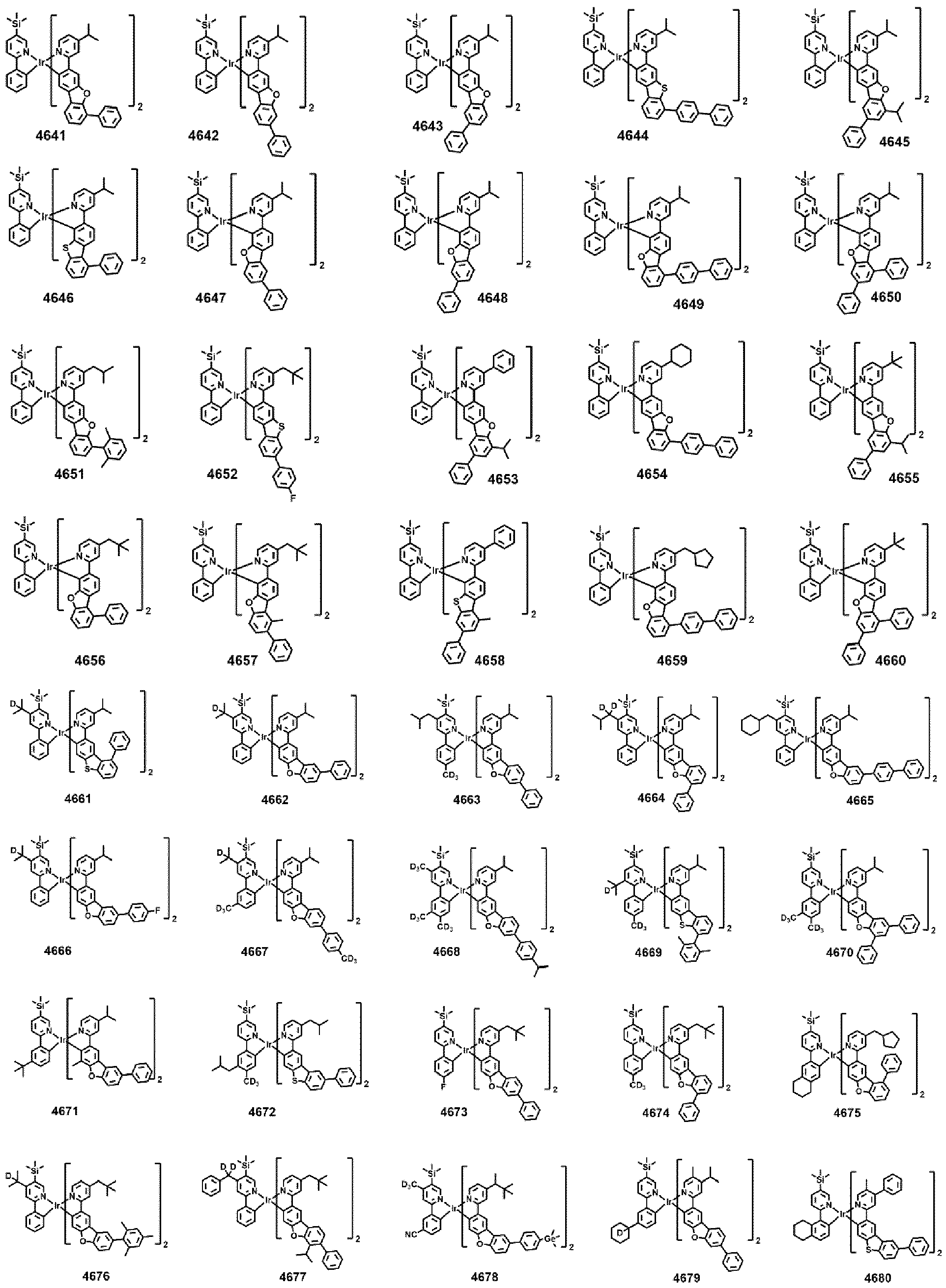

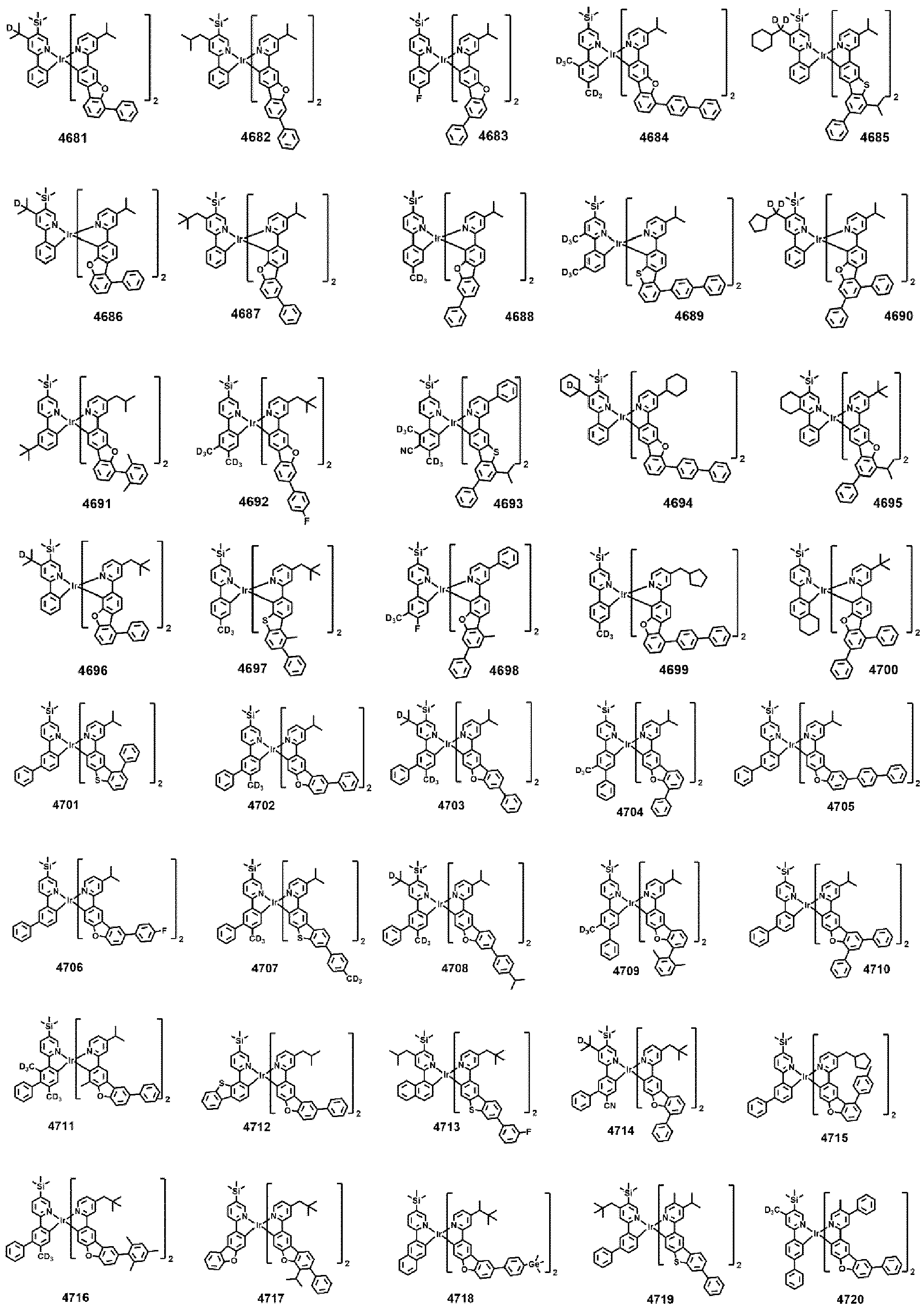

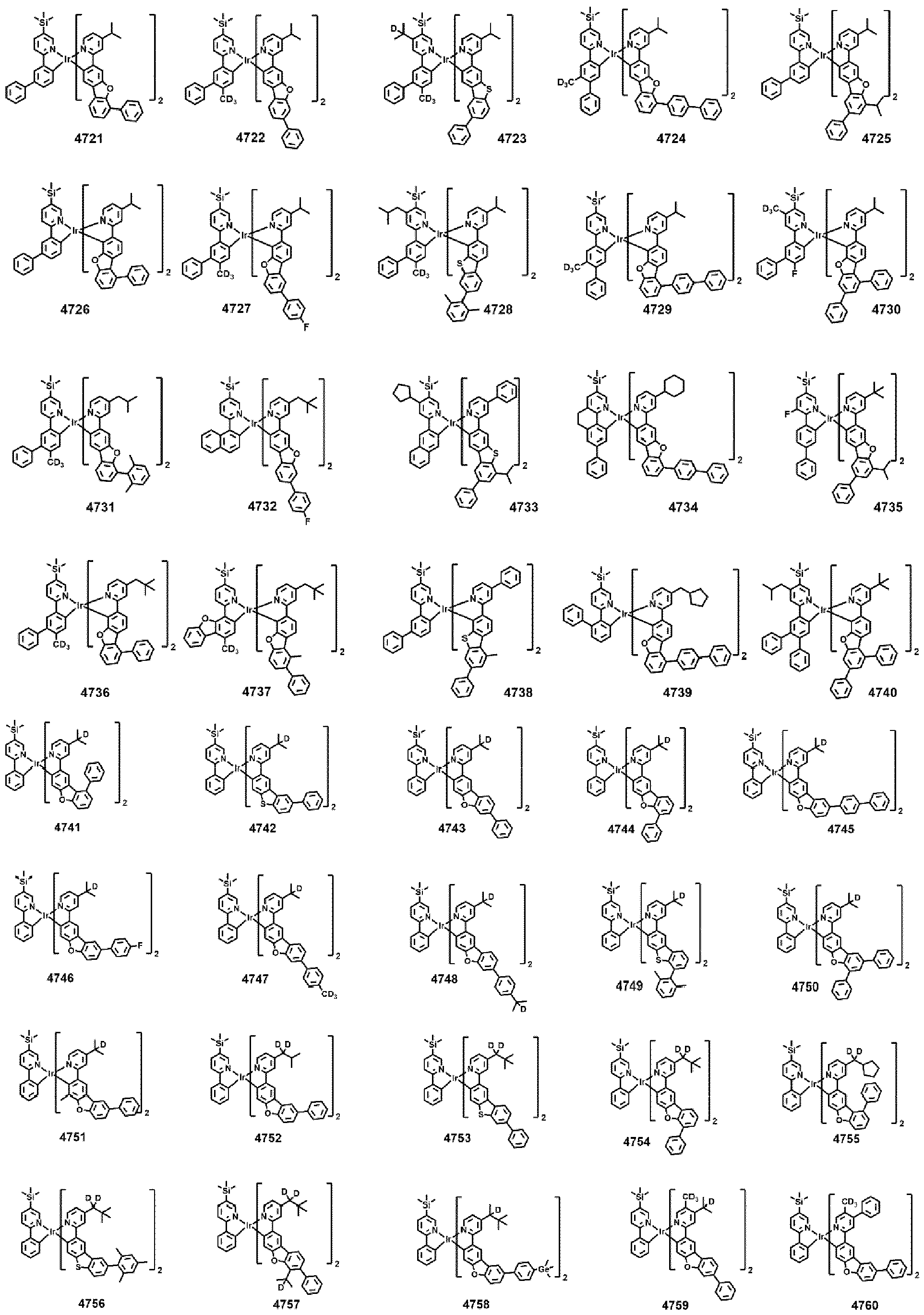

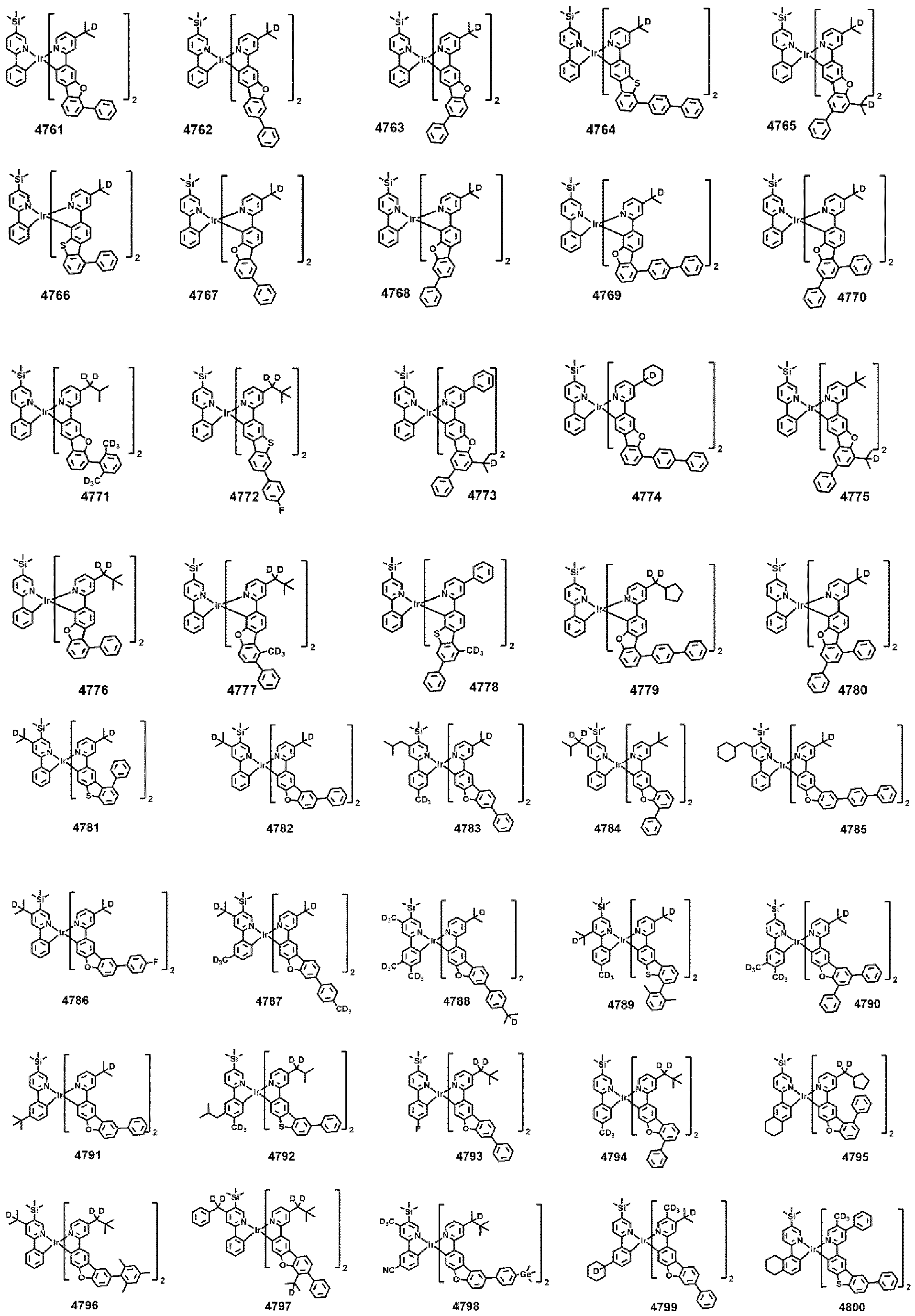

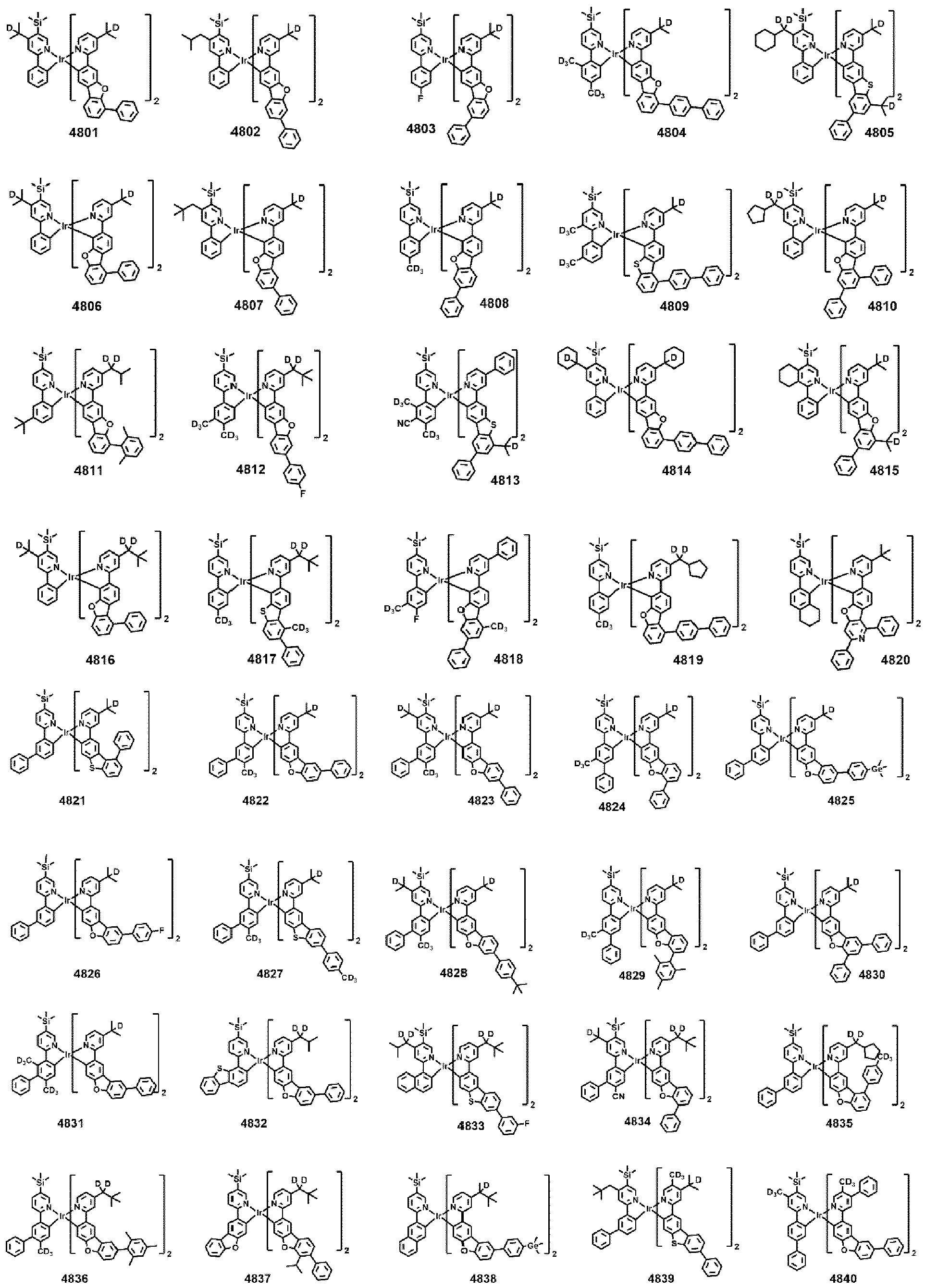

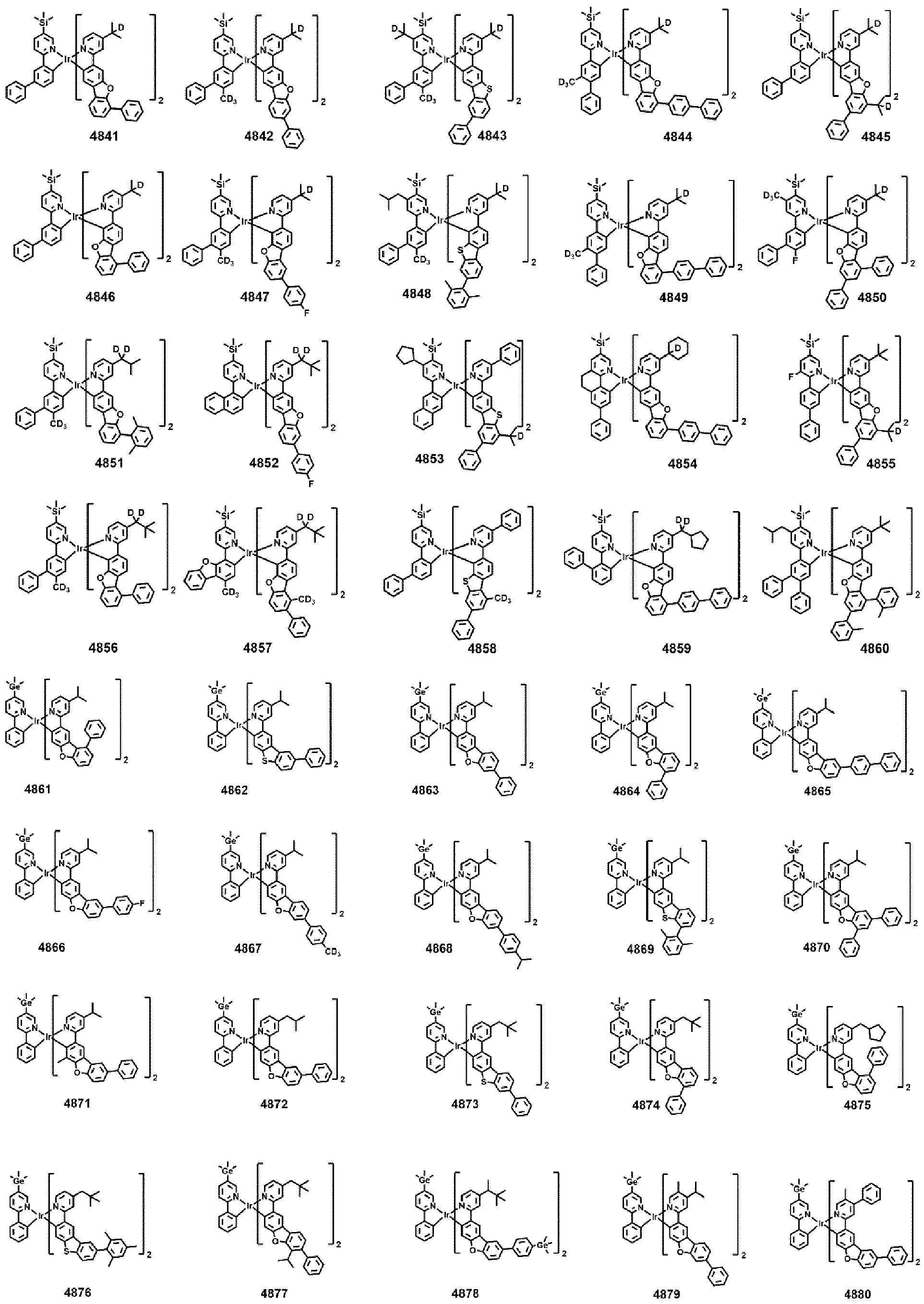

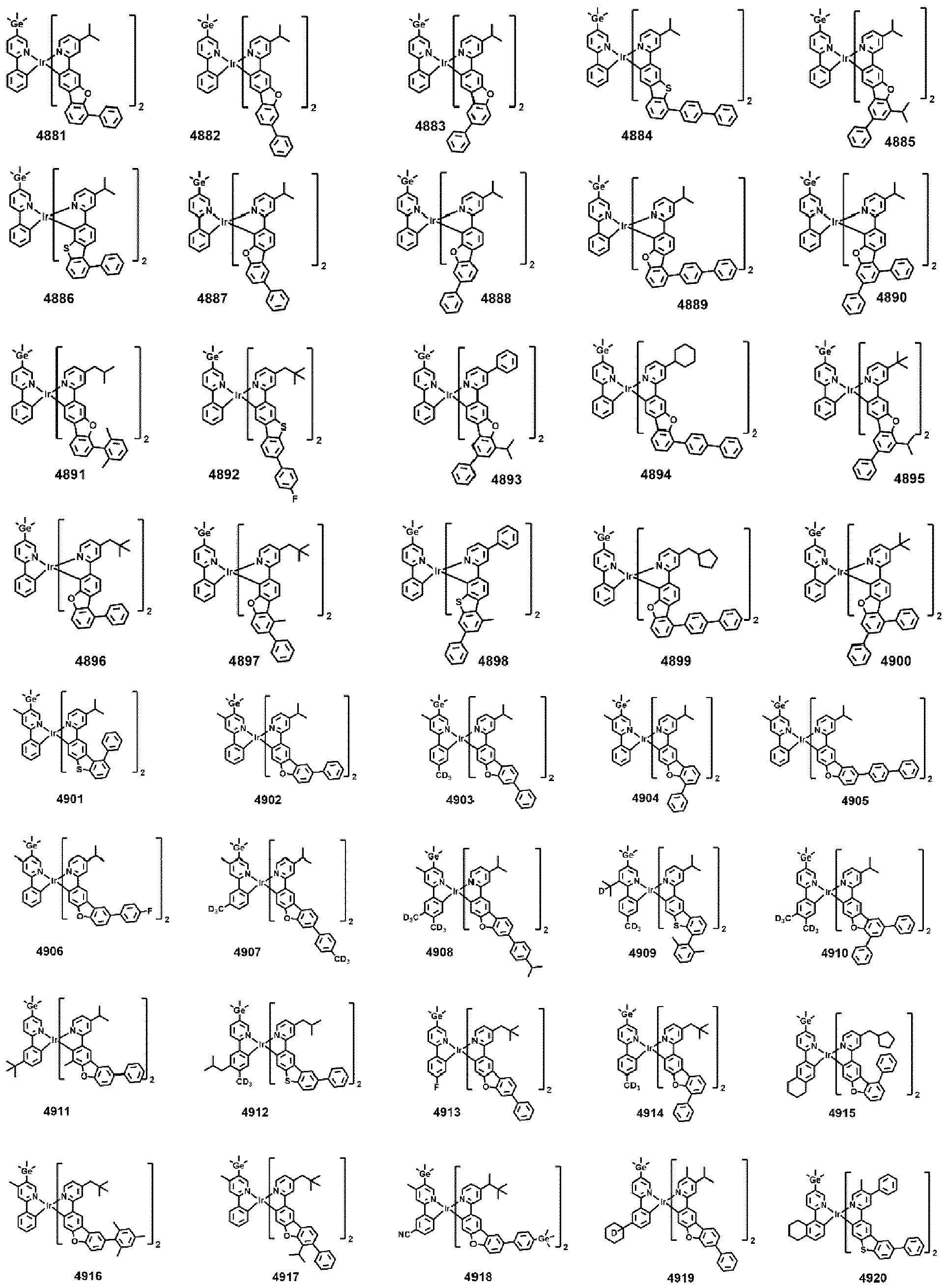

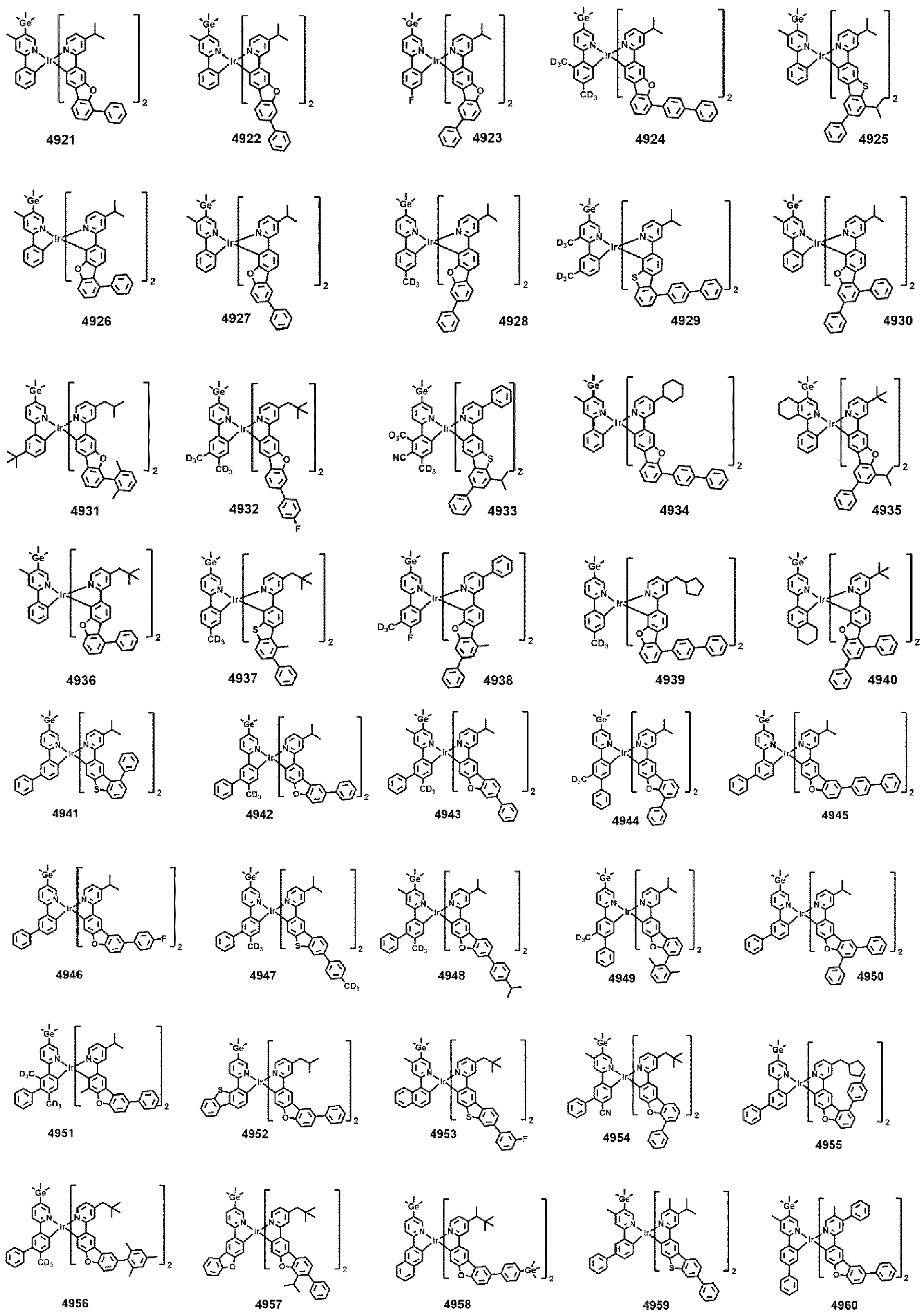

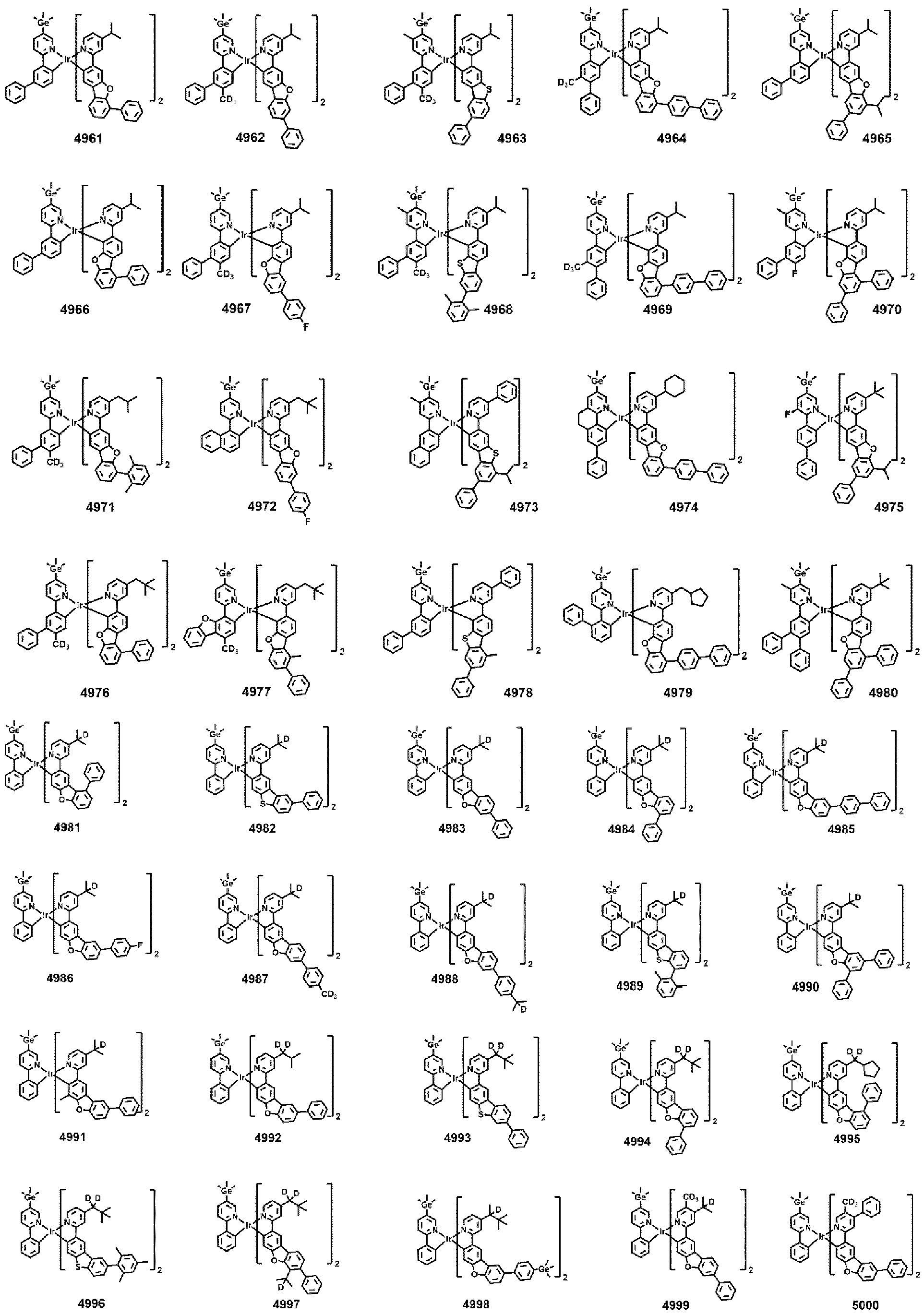

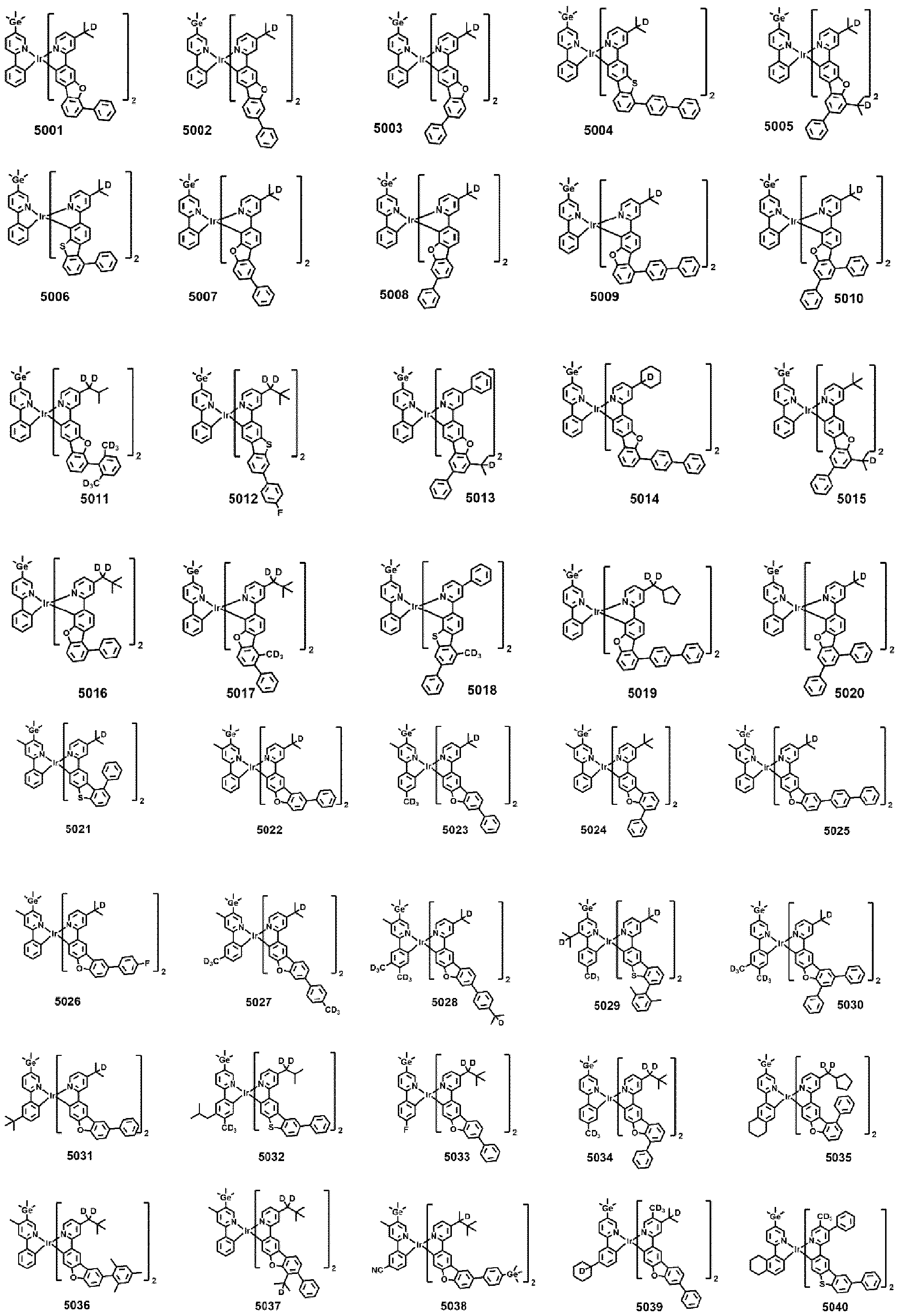

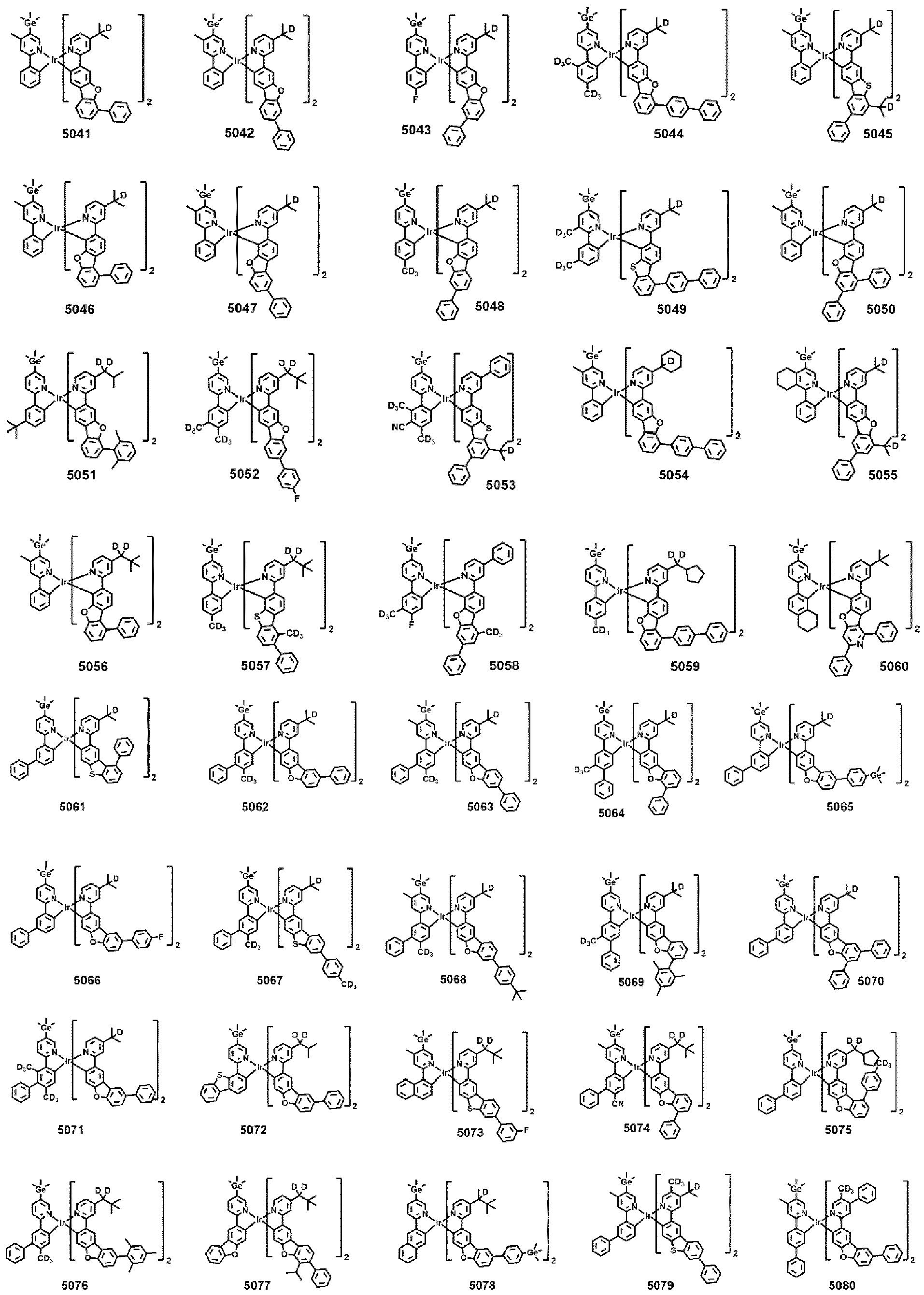

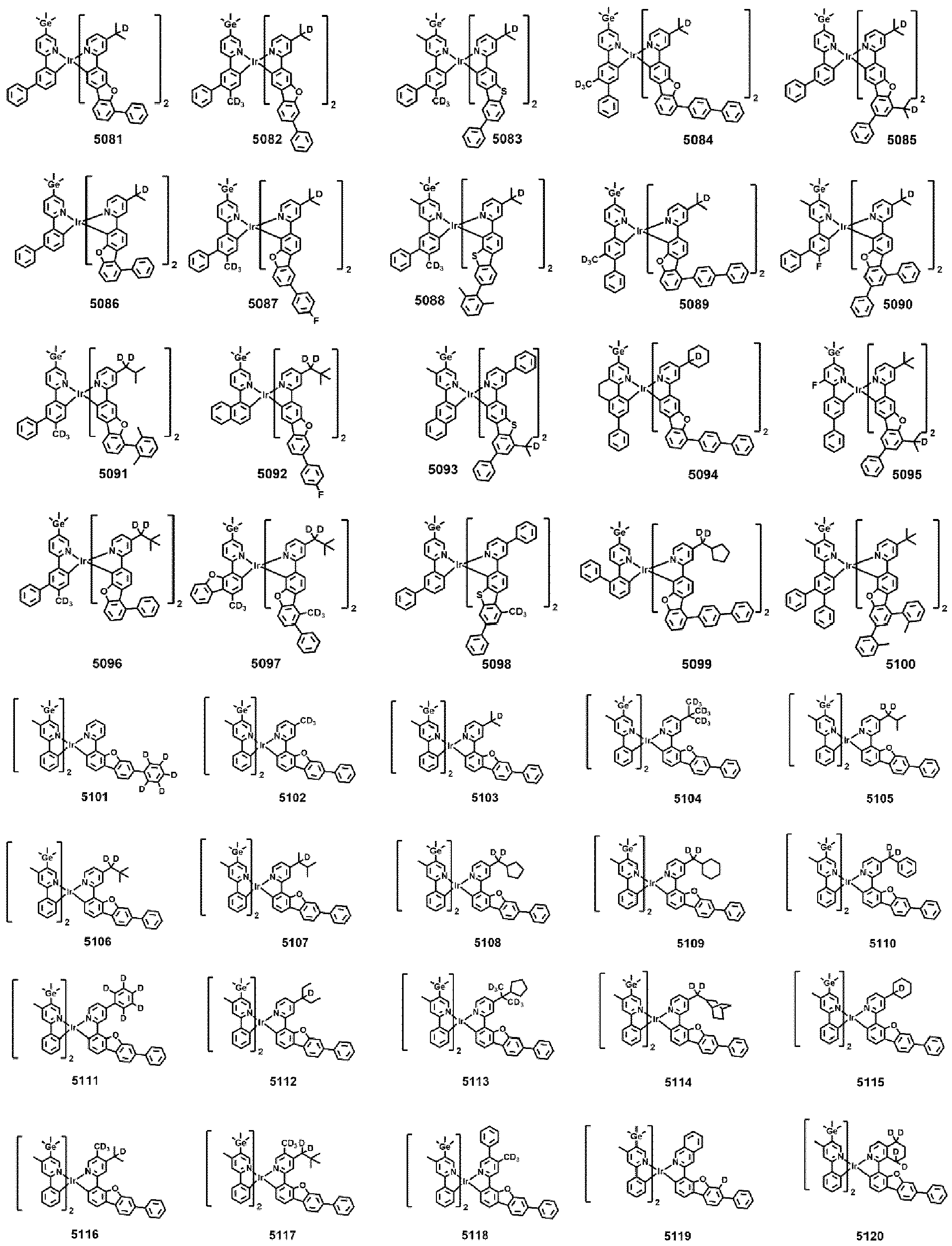

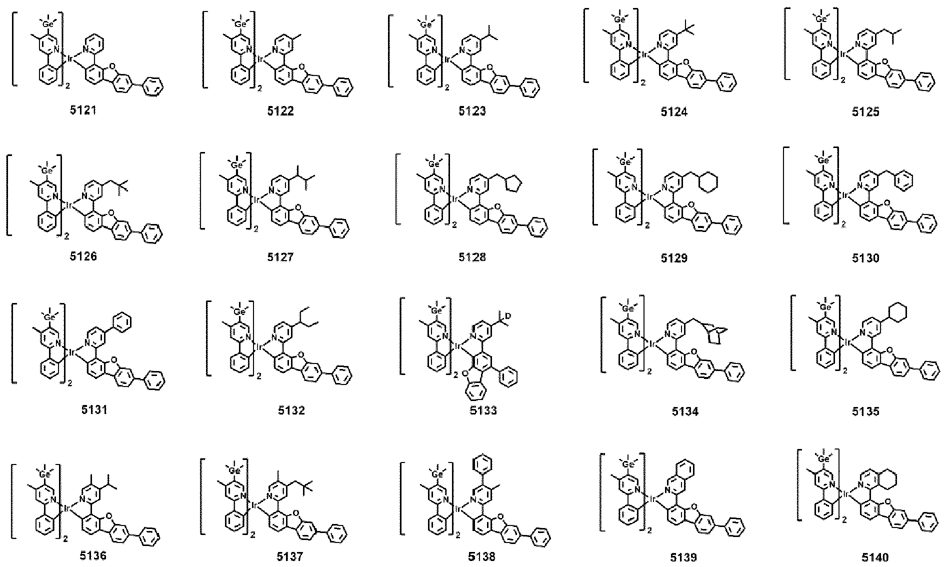

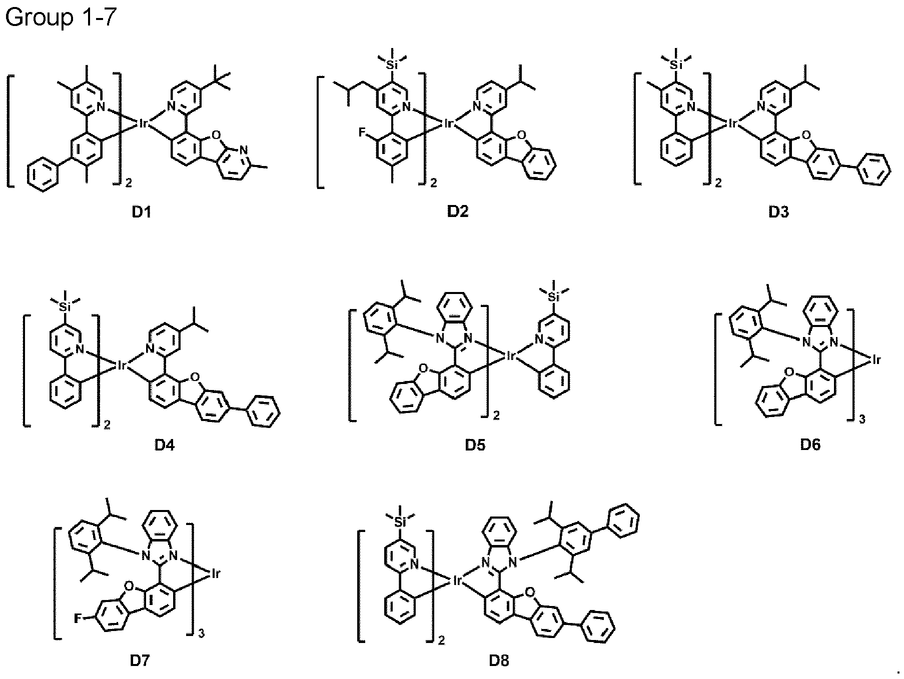

As used herein, "OMe" is a methoxy group, "TMS" is a trimethylsilyl group, and "TMG" is a trimethylgermyl group.

Meanwhile, m2 hosts in the emission layer may include a hole-transporting compound, an electron-transporting compound, a bipolar compound, or a combination thereof. Each of the m2 hosts may not include a transition metal.

For example, m2 may be 2, and the host may include a hole-transporting compound and an electron-transporting compound, and the hole-transporting compound and the electron-transporting compound may be different from each other.

In one or more embodiments, the hole-transporting compound may include at least one π electron-rich C₃-C₆₀ cyclic group, and may not include an electron-transporting group. Examples of the electron-transporting group include a cyano group, a fluoro group, a π-electron deficient nitrogen-containing cyclic group, a phosphine oxide group, a sulfoxide group, or the like.

The term "π-electron deficient nitrogen-containing cyclic group" as used herein refers to a C₁-C₆₀ heterocyclic group having at least one *-N=*' moiety as a ring-forming moiety. Non-limiting examples of the π-electron deficient nitrogen-containing cyclic group may include a triazine group, an imidazole group, or the like.

The term " π electron-rich C₃-C₆₀ cyclic group" used herein may be a C₃-C₆₀ cyclic group that does not include a *-N=*' moiety as a ring-forming moiety. Non-limiting examples of the π electron-rich C₃-C₆₀ cyclic group may include a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrobenzofuran group, a phenanthrobenzothiophene group, a naphthocarbazole group, a dinaphthofuran group, a dinaphthothiophene group, a dibenzocarbazole group, or the like.

For example, the hole-transporting compound may include two or more carbazole groups.

In one or more embodiments, the electron-transporting compound may be a compound including at least one electron-transporting group. The electron-transporting group may be a cyano group, a fluoro group, a π electron-deficient nitrogen-containing C₁-C₆₀ cyclic group, a phosphine oxide group, a sulfoxide group, or the like, or a combination thereof. In one or more embodiments, the electron-transporting compound may include a triazine group.

For example, the electron-transporting compound may include at least one electron-transporting group (for example, a triazine group) and at least one π electron-rich C₃-C₆₀ cyclic group (for example, a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrobenzofuran group, a phenanthrobenzothiophene group, a naphthocarbazole group, a dinaphthofuran group, a dinaphthothiophene group, a dibenzocarbazole group, or the like, or a combination thereof).

In one or more embodiments, the hole-transporting compound may be a compound represented by Formula 6: 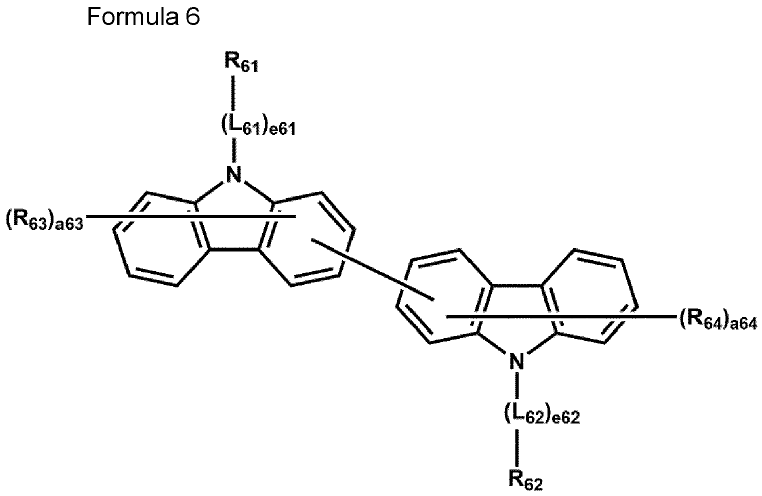 wherein, in Formula 6,
L₆₁ and L₆₂ may each independently be a π electron-rich C₃-C₆₀ cyclic group (for example, a benzene group), unsubstituted or substituted with at least one of deuterium, a C₁-C₂₀ alkyl group, a deuterated C₁-C₂₀ alkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, - Si(Q₃₃)(Q₃₄)(Q₃₅), or a combination thereof,
e61 and e62 may each independently be an integer from 1 to 6,
R₆₁ to R₆₄ may each independently be:
hydrogen, deuterium, a C₁-C₂₀ alkyl group, or a deuterated C₁-C₂₀ alkyl group;
a π electron-rich C₃-C₆₀ cyclic group (for example, a benzene group) unsubstituted or substituted with at least one of deuterium, a C₁-C₂₀ alkyl group, a deuterated C₁-C₂₀ alkyl group, a phenyl group, a deuterated phenyl group, a (C₁-C₂₀alkyl)phenyl group, a biphenyl group, a deuterated biphenyl group, a (C₁-C₂₀alkyl)biphenyl group, -Si(Q₃₃)(Q₃₄)(Q₃₅), or a combination thereof; or
-Si(Q₃)(Q₄)(Q₅),
a63 and a64 may each independently be an integer from 0 to 7.

Q₃ to Q₅ and Q₃₃ to Q₃₅ are each as described herein.

In one or more embodiments, the hole-transporting compound may be a compound represented by at least one of Formulae 6-1, 6-2, or 6-3, but embodiments are not limited thereto: 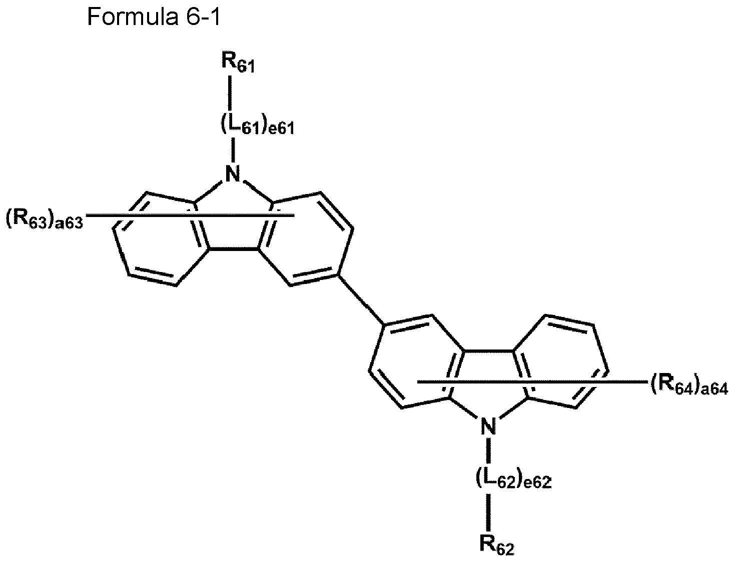 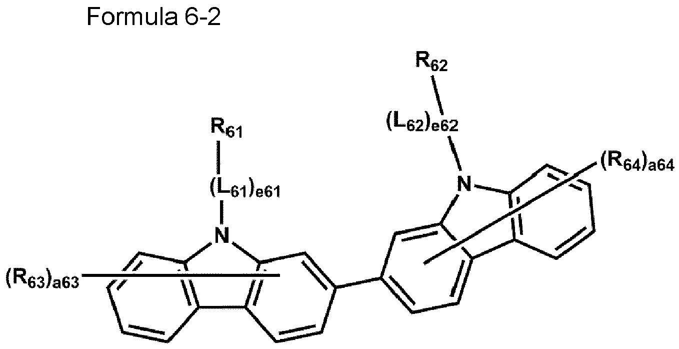 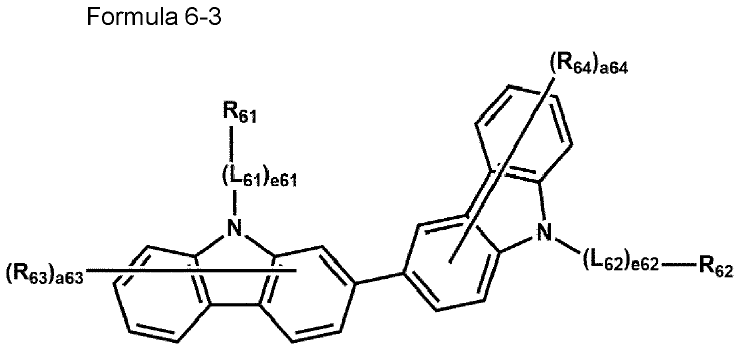 wherein, in Formulae 6-1 to 6-3, L₆₁, L₆₂, R₆₁ to R₆₄, e61, e62, a63, and a64 are respectively as those described herein.

In one or more embodiments, the hole-transporting compound may be at least one of compounds H-HT1 to H-HT4, but embodiments are not limited thereto:

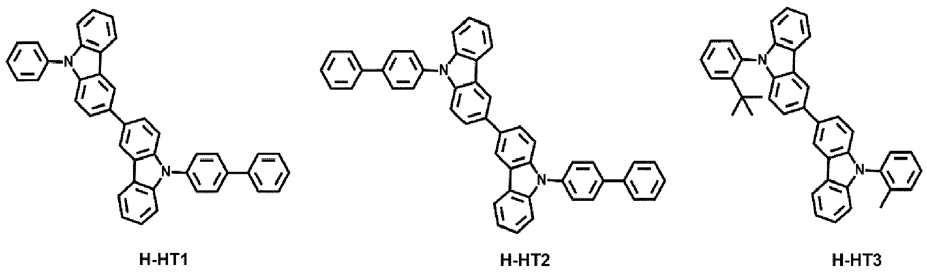

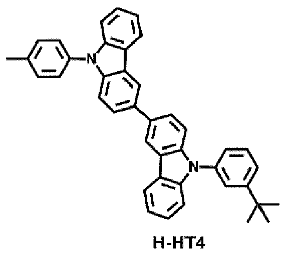

In one or more embodiments, the electron-transporting compound may be a compound represented by Formula 7: 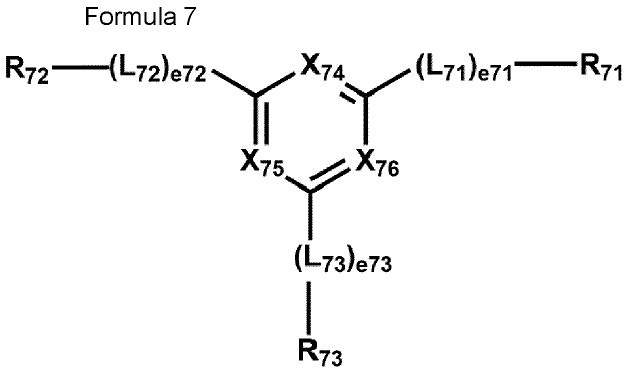 wherein, in Formula 7,
X₇₄ may be C(R₇₄) or N, X₇₅ may be C(R₇₅) or N, X₇₆ may be C(R₇₆) or N, and at least one of X₇₄ to X₇₆ may be N,
L₇₁ to L₇₃ may each independently be a C₅-C₃₀ carbocyclic group or a C₁-C₃₀ heterocyclic group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or a combination thereof,
e71 to e73 may each independently be an integer from 1 to 10,
R₇₁ to R₇₆ may each independently be:
hydrogen, deuterium, -F, or a cyano group;
a C₁-C₂₀ alkyl group, unsubstituted or substituted with at least one of deuterium, -F, a cyano group, or a combination thereof;
a C₅-C₃₀ carbocyclic group or a C₁-C₃₀ heterocyclic group, each unsubstituted or substituted with at least one of deuterium, F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a -Si(Q₃₃)(Q₃₄)(Q₃₅), or a combination thereof; or
-Si(Q₃)(Q₄)(Q₅).

Q₃ to Q₅ and Q₃₃ to Q₃₅ are each as described herein.

In one or more embodiments, each of X₇₄ to X₇₆ in Formula 7 may be N.

In one or more embodiments, L₇₁ to L₇₃ in Formula 7 may each independently be a phenylene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrobenzofuran group, a phenanthrobenzothiophene group, a naphthocarbazole group, a dinaphthofuran group, a dinaphthothiophene group, or a dibenzocarbazole group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated a biphenyl group, a fluorinated biphenyl group, a (C₁-C₂₀ alkyl)a biphenyl group, - Si(Q₃₃)(Q₃₄)(Q₃₅), or a combination thereof.

In one or more embodiments, in Formula 7, at least one of e71 L₇₁, at least one of e72 L₇₂, at least one of e73 L₇₃, or a combination thereof may each independently be a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrobenzofuran group, a phenanthrobenzothiophene group, a naphthocarbazole group, a dinaphthofuran group, a dinaphthothiophene group, or a dibenzocarbazole group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a - Si(Q₃₃)(Q₃₄)(Q₃₅), or a combination thereof.

In one or more embodiments, in Formula 7, at least one of L₇₁, at least one of L₇₂, at least one of L₇₃, or a combination thereof may include a carbazole group, a indolocarbazole group, a benzocarbazole group, a naphthocarbazole group, or a dibenzocarbazole group, wherein a nitrogen atom of a pyrrole group in the carbazole group, the indolocarbazole group, the benzocarbazole group, the naphthocarbazole group, or the dibenzocarbazole group may be bonded to the carbon atom of the 6-membered ring including X₇₄ to X₇₆ in Formula 7, with a single bond or neighboring L₇₁, L₇₂, and/or L₇₃ therebetween.

In one or more embodiments, e71 to e73 in Formula 7 each indicates the number of L₇₁ to L₇₃, respectively, and may each independently be, for example, 1, 2, 3, 4, or 5.

In one or more embodiments, R₇₁ to R₇₆ in Formula 7 may each independently be:
hydrogen, deuterium, -F, or a cyano group;
a C₁-C₂₀ alkyl group, unsubstituted or substituted with at least one of deuterium, -F, a cyano group, or a combination thereof;
a phenyl group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrobenzofuran group, a phenanthrobenzothiophene group, a naphthocarbazole group, a dinaphthofuran group, a dinaphthothiophene group, or a dibenzocarbazole group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or a combination thereof; or
-Si(Q₃)(Q₄)(Q₅).

In one or more embodiments, the electron-transporting compound may be at least one of Compounds H-ET1 to H-ET5, but embodiments are not limited thereto:

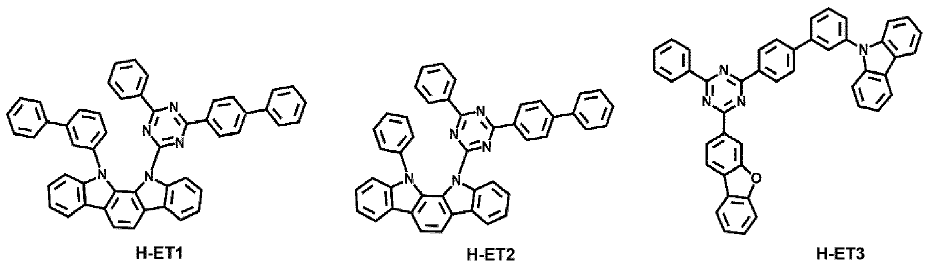

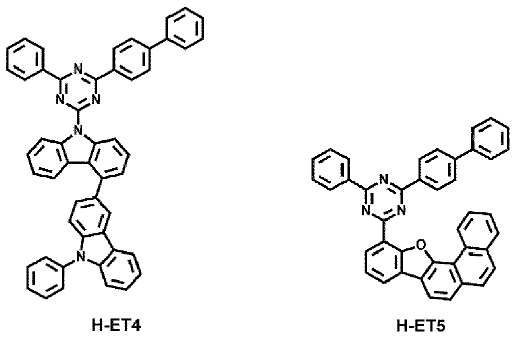

According to another aspect, the light-emitting device may be included in an electronic apparatus. Thus, an electronic apparatus including the light-emitting device is provided. The electronic apparatus may include, for example, a display, an illumination, a sensor, or the like, but embodiments are not limited thereto.

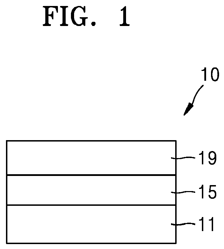

### Description of FIG. 1

FIG. 1 schematically illustrates a cross-sectional view of an organic light-emitting device 10, which is a light-emitting device according to one or more embodiments. Hereinafter, the structure and manufacturing method of the organic light-emitting device 10 according to one or more embodiments will be described in further detail and in connection with FIG. 1.

The organic light-emitting device 10 of FIG. 1 may include a first electrode 11, a second electrode 19, and an interlayer 15 located between the first electrode 11 and the second electrode 19. The interlayer 15 may include a hole transport region, an emission layer, an electron transport region, or a combination thereof.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and/or water repellency.

The first electrode 11 may be produced by depositing or sputtering, onto the substrate, a material for forming the first electrode 11. The first electrode 11 may be an anode. The material for forming the first electrode 11 may include materials with a high work function to facilitate hole injection. The first electrode 11 may be a reflective electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. For example, the first electrode 11 may have a three-layered structure of ITO/Ag/ITO.

The hole transport region may be located between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure, or a hole injection layer/hole transport layer/electron blocking layer structure, wherein, for each structure, respective layers are sequentially stacked in this stated order from the first electrode 11.

When the hole-transporting region includes a hole injection layer, the hole injection layer may be formed on the first electrode 11 by using various methods such as a vacuum deposition method, spin coating, casting, a Langmuir-Blodgett (LB) method, inkjet printing, or the like.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0.01 angstroms per second (Å/sec) to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed in a range of about 2,000 revolutions per minute (rpm) to about 5,000 rpm and a heat treatment temperature of about 80°C to about 200°C for removing a solvent after coating.

The conditions for forming the hole transport layer and the electron blocking layer may be similar to or the same as the conditions for forming the hole injection layer.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, TPD, spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof, but embodiments are not limited thereto:

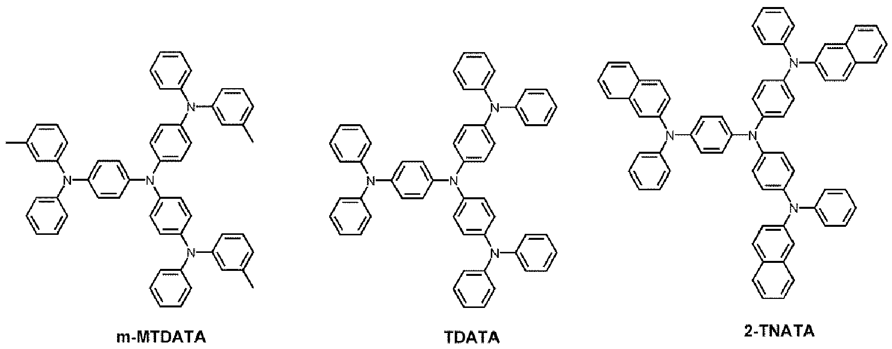

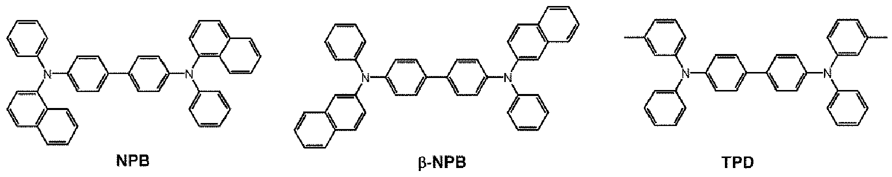

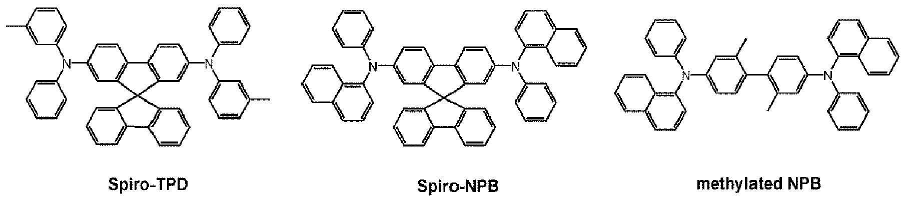

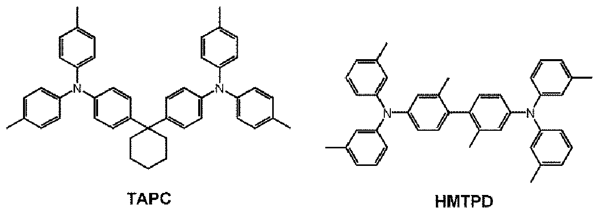

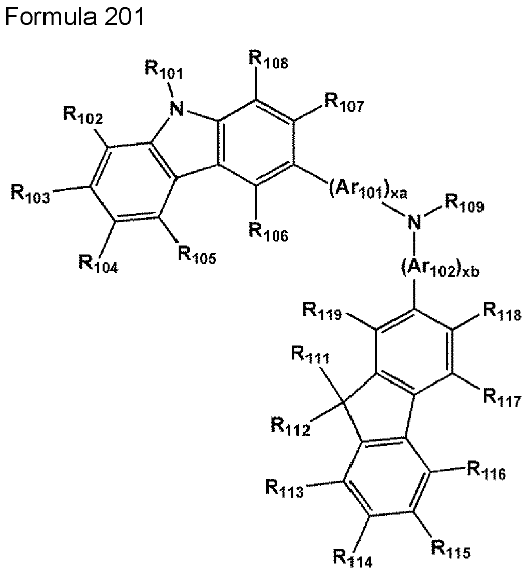

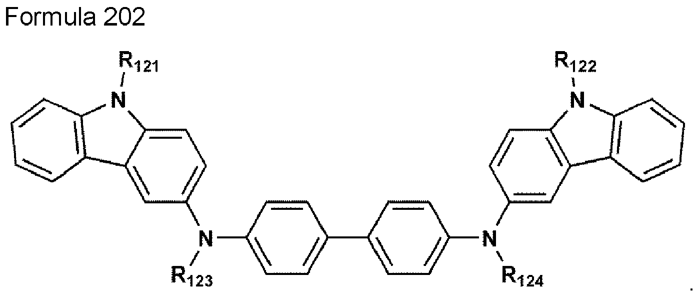

In Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇₋C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.
xa and xb in Formula 201 may each independently be an integer from 0 to 5, or xa and xb may each independently be 0, 1, or 2. For example, xa may be 1 and xb may be 0.
R₁₀₁ to R₁₀₈, R₁₁₁ to R₁₁₉ and R₁₂₁ to R₁₂₄ in Formulae 201 and 202 may each independently be selected from:
   hydrogen, deuterium, -F, -Cl, -Br, -I, -SF₅, a hydroxyl group, a cyano group, a nitro group, an amino group, a C₁-C₁₀ alkyl group (for example, a methyl group, an ethyl group, a propyl group, a butyl group, a pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
   a C₁-C₁₀ alkyl group, a C₁-C₁₀ alkoxy group, or a C₁-C₁₀ alkylthio group, each unsubstituted or substituted with at least one of deuterium, -F, -Cl, -Br, - I, -SF₅, a hydroxyl group, a cyano group, a nitro group, an amino group, or a combination thereof; or
   a phenyl group, a naphthyl group, an anthracenyl group, a fluorenyl group, or a pyrenyl group, each unsubstituted or substituted with at least one of deuterium, -F, -Cl, -Br, -I, -SF₅, a hydroxyl group, a cyano group, a nitro group, an amino group, a C₁-C₁₀ alkyl group, a C₁-C₁₀ alkoxy group, a C₁-C₁₀ alkylthio group, or a combination thereof.

In Formula 201, R₁₀₉ may be a phenyl group, a naphthyl group, an anthracenyl group, or a pyridinyl group, each unsubstituted or substituted with at least one of deuterium, -F, -Cl, -Br, -I, -SF₅, a hydroxyl group, a cyano group, a nitro group, an amino group, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one embodiment, the compound represented by Formula 201 may be represented by Formula 201A:

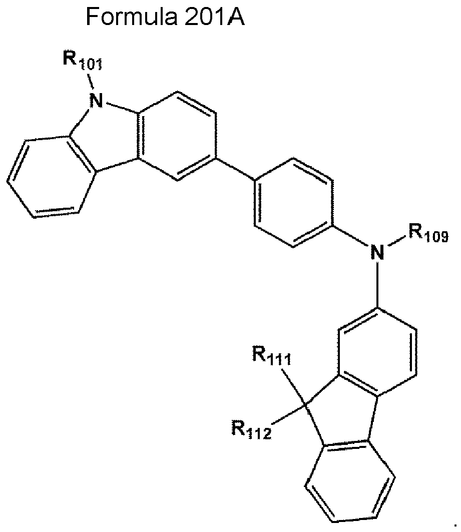

R₁₀₁, R₁₁₁, R₁₁₂, and R₁₀₉ in Formula 201A are each as described herein.

For example, the hole transport region may include at least one of Compounds HT1 to HT20, or a combination thereof, but embodiments are not limited thereto:

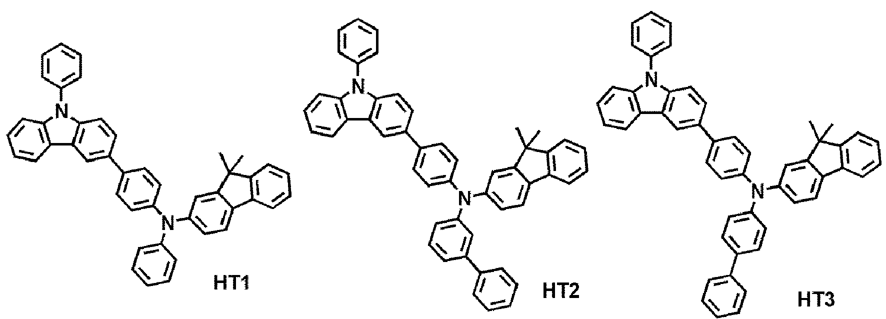

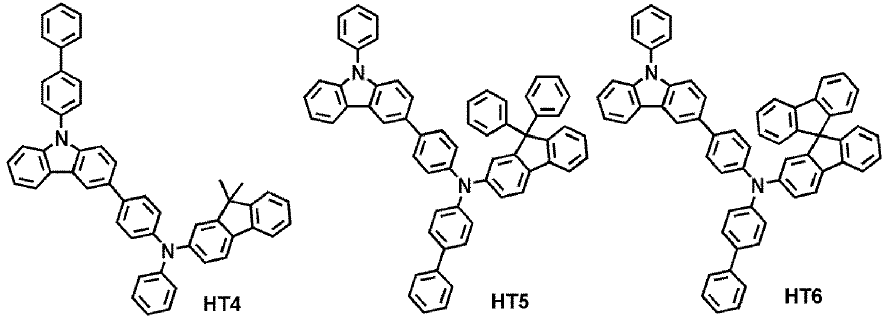

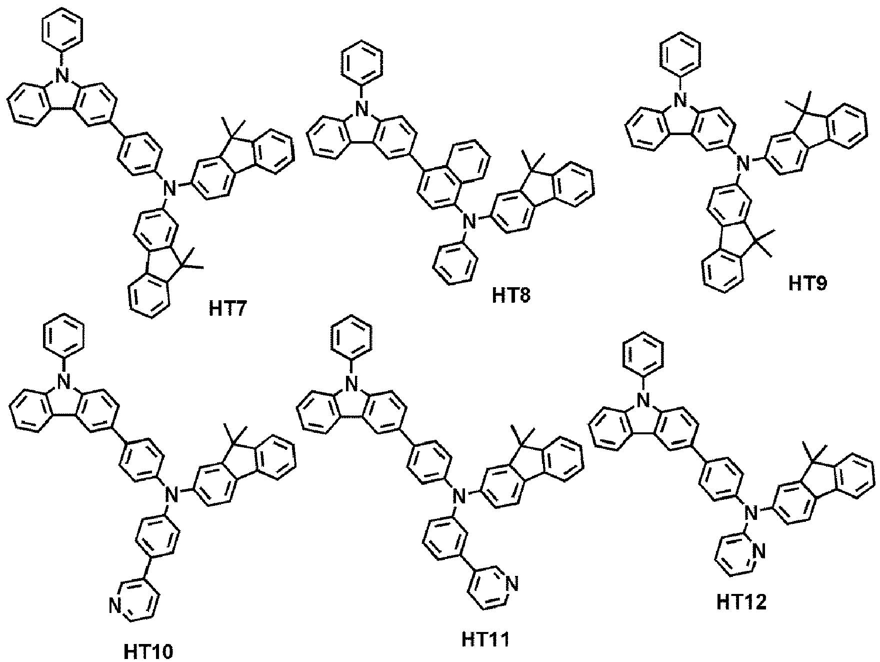

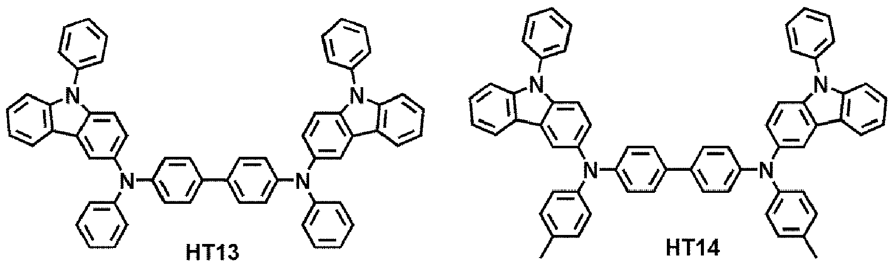

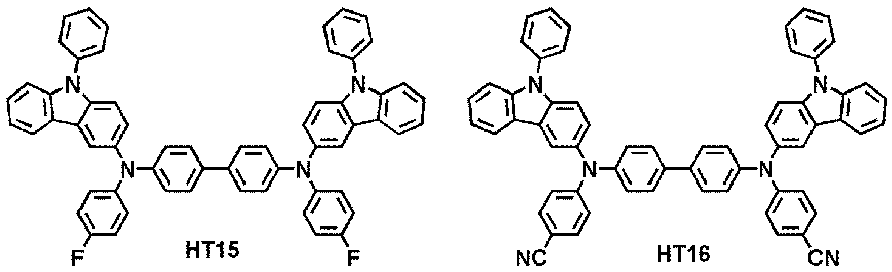

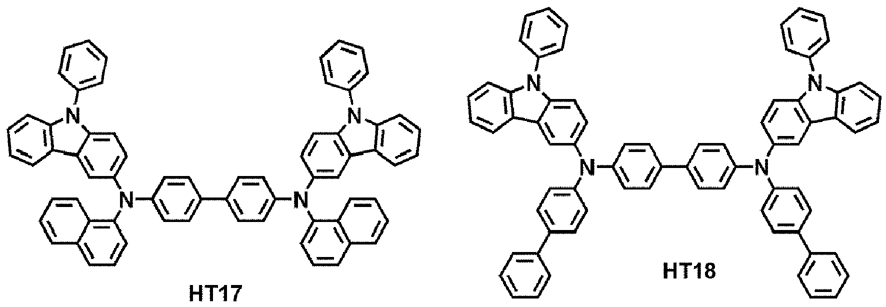

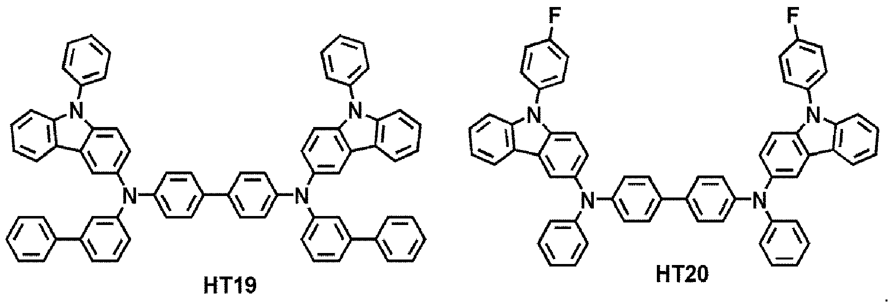

The thickness of the hole transport region may be about 100 Å to about 10000 Å, for example, about 100 Å to about 5000 Å. When the hole transport region includes a hole injection layer, a hole transport layer, an electron-blocking layer, or a combination thereof, the thickness of the hole injection layer may be about 100 Å to about 10000 Å, for example, about 100 Å to about 2000 Å, and the thickness of the hole transport layer may be about 50 Å to about 2000 Å, for example, about 100 Å to about 1500 Å. When the thickness of the hole injection layer and the hole transport layer of the hole transport region satisfies these ranges, satisfactory hole transport characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof. For example, the p-dopant may be a quinone derivative such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNNQ), or the like; a metal oxide, such as a tungsten oxide, a molybdenum oxide, or the like; a cyano group-containing compound, such as Compound HT-D1; or a combination thereof, but embodiments are not limited thereto:

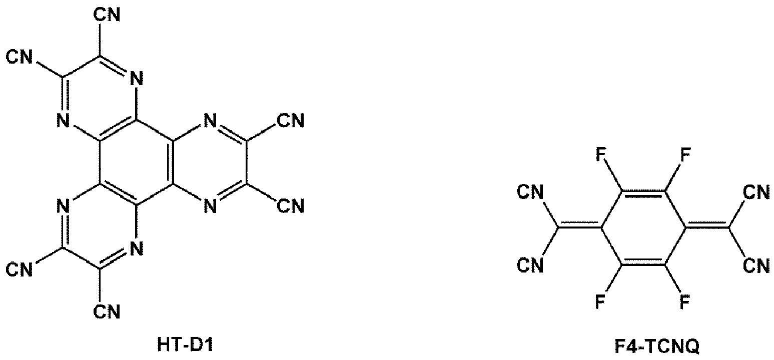

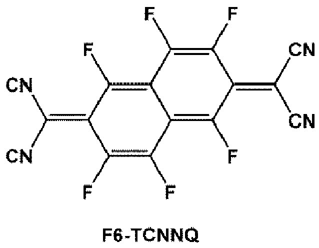

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron-blocking layer, a material for the electron-blocking layer may include a material that can be used in the hole transport region as described above, a host material, or a combination thereof. For example, when the hole transport region includes an electron-blocking layer, H-HT2 or the like may be used as a material for the electron-blocking layer.

An emission layer may be formed on the hole transport region by using a method such as a vacuum deposition method, a spin coating method, casting, an LB method, and/or inkjet printing. When the emission layer is formed by vacuum deposition or spin coating, the deposition or coating conditions may be similar to those applied in forming the hole injection layer although the deposition or coating conditions may vary according to a material that is used to form the emission layer.

The emission layer includes m1 dopants and m2 hosts as described herein, and may satisfy the specified thickness ranges.

An electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof, but embodiments are not limited thereto:

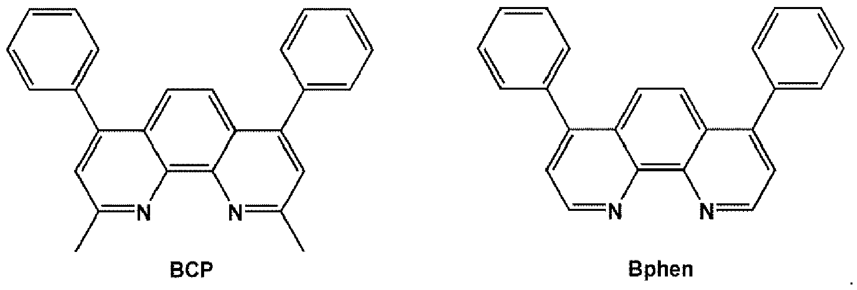

In one or more embodiments, the hole-blocking layer may include any suitable host material, a material for an electron-transporting layer, a material for an electron injection layer, or a combination thereof, which will be described later.

A thickness of the hole blocking layer may be about 20 Å to about 1,000 Å, for example, about 30 Å to about 600 Å. When the thickness of the hole blocking layer is within these ranges, excellent hole blocking characteristics may be obtained without a substantial increase in driving voltage.

The electron transport layer may include at least one of 2,9-dimethyl-4,7-diphenyl-1,10-phenanthroline (BCP), 4,7-diphenyl-1,10-phenanthroline (Bphen), 1,3,5-tri(1-phenyl-1H-benzo[d]imidazol-2-yl)benzene (TPBi), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof, but embodiments are not limited thereto:

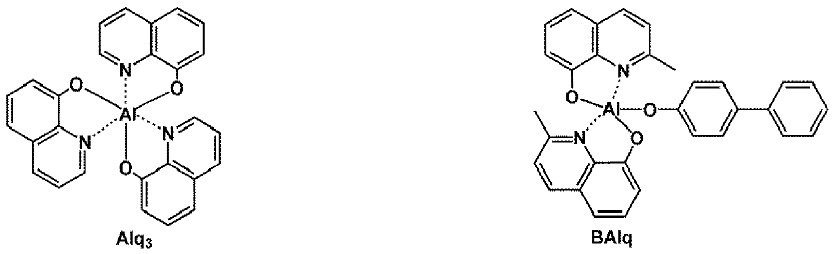

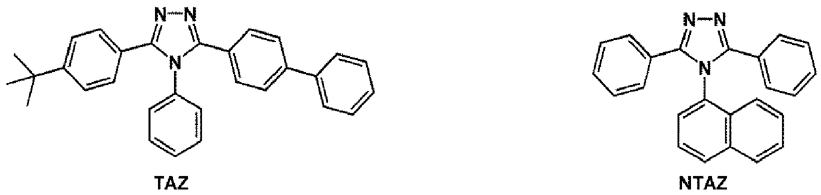

In one or more embodiments, the electron transport layer may include at least one of Compounds ET1 to ET25, or a combination thereof, but embodiments are not limited thereto:

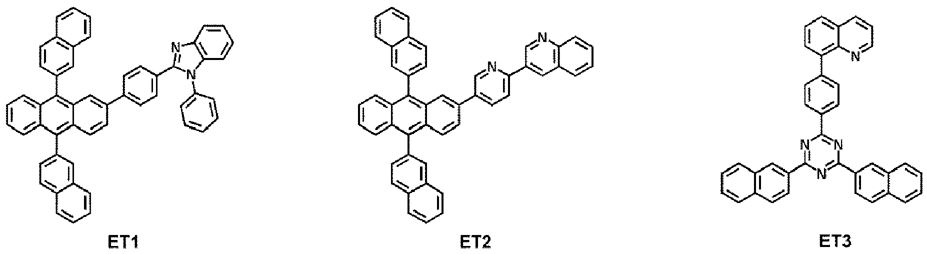

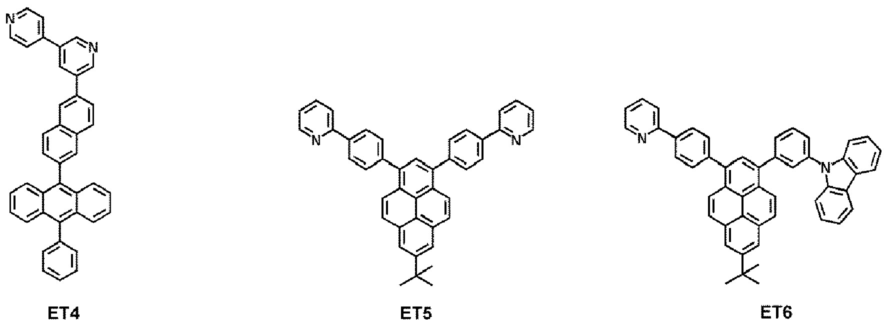

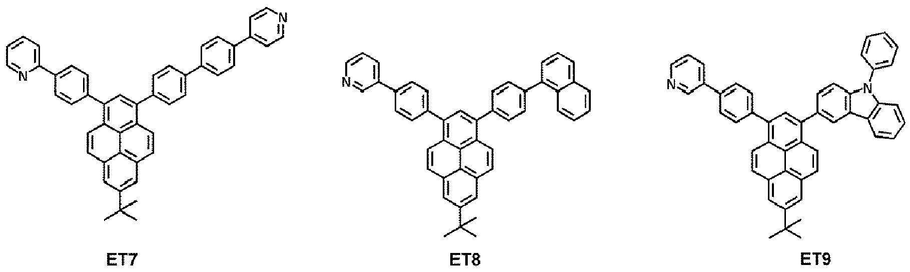

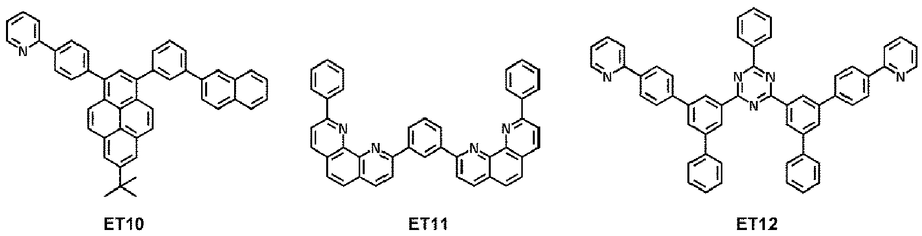

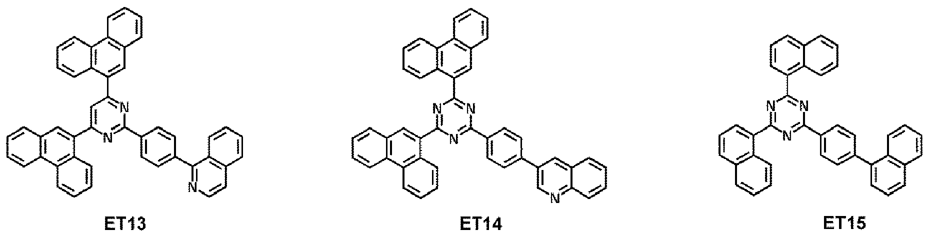

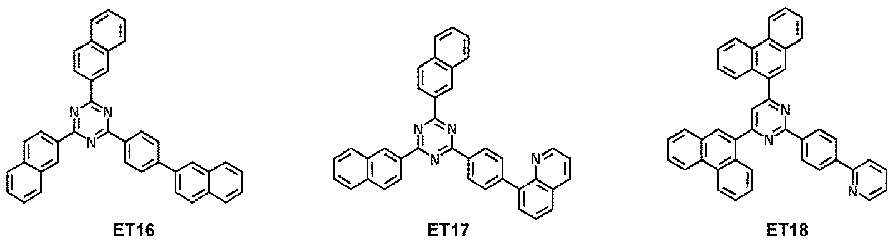

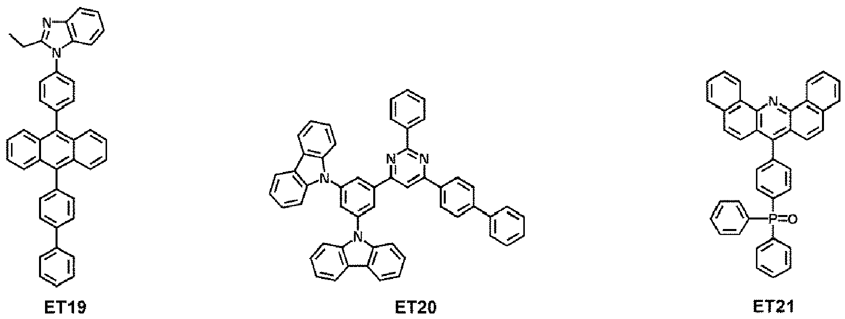

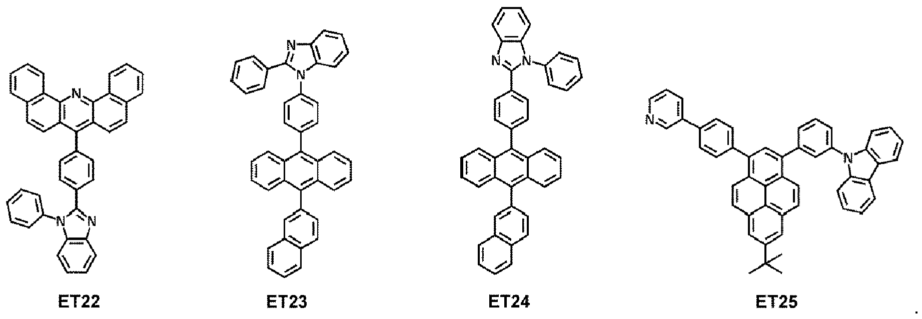

A thickness of the electron transport layer may be in the range of about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport layer may include a metal-containing material in addition to the material as described herein.

The metal-containing material may include a Li complex. The Li complex may include, for example, Compound ET-D1 or ET-D2, but embodiments are not limited thereto:

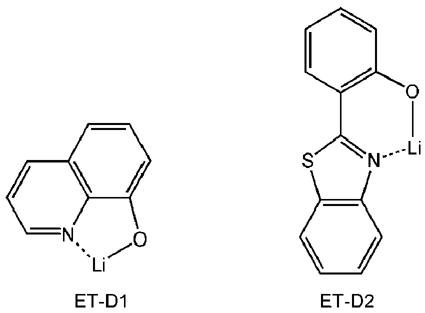

The electron transport region may include an electron injection layer that promotes the flow of electrons from the second electrode 19 thereinto.

The electron injection layer may include at least one of LiF, NaCl, CsF, Li₂O, BaO, Yb, Compound ET-D1, Compound ET-D2, or a combination thereof.

A thickness of the electron injection layer may be in a range of about 1 Å to about 100 Å, and, for example, about 3 Å to about 90 Å. When the thickness of the electron injection layer is within the ranges described above, satisfactory electron injection characteristics may be obtained without a substantial increase in driving voltage.

A second electrode 19 may be located above the electron transport region. The second electrode 19 may be a cathode. A material for forming the second electrode 19 may be metal, an alloy, an electrically conductive compound, or a combination thereof, which have a relatively low work function. For example, the material for forming the second electrode 19 may be Li, Mg, Al, Ag, Al-Li, Ca, Mg-In, Mg-Ag, or the like. In one or more embodiments, to manufacture a top-emission type light-emitting device, a transparent or semi-transparent electrode formed using ITO or IZO may be used as the second electrode 19.

### Explanation of terms

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used herein refers to a divalent group having the same structure as the C₁-C₆₀ alkyl group.

Non-limiting examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with at least one of a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and non-limiting examples thereof may include a methoxy group, an ethoxy group, a propoxy group, a butoxy group, a pentoxy group, or the like.

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof may include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof may include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the C₃-C₁₀ cycloalkylene group is a divalent group having the same structure as the C₃-C₁₀ cycloalkyl group.

Non-limiting examples of the C₃-C₁₀ cycloalkyl group may include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, or the like.

The term "C₁-C₁₀ heterocycloalkyl group" as used herein refers to a monovalent saturated cyclic group that includes at least one hetero atom selected from N, O, P, Si, S, Se, Ge, and B as a ring-forming atom and 1 to 10 carbon atoms as ring forming atom(s), and the term "C₁-C₁₀ heterocycloalkylene group" as used herein refers to a divalent group having the same structure as the C₁-C₁₀ heterocycloalkyl group.

Non-limiting examples of the C₁-C₁₀ heterocycloalkyl group may include a silolanyl group, a silinanyl group, tetrahydrofuranyl group, a tetrahydro-2H-pyranyl group, a tetrahydrothiophenyl group, or the like.

The term "C₃-C₁₀ cycloalkenyl group" as used herein refers to a monovalent cyclic group that has 3 to 10 carbon atoms and at least one carbon-carbon double bond in the ring thereof and no aromaticity, and non-limiting examples thereof may include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has at least one hetero atom selected from N, O, P, Si, S, Se, Ge, and B as a ring-forming atom, 1 to 10 carbon atoms as ring forming atom(s), and at least one double bond in its ring. Non-limiting examples of the C₁-C₁₀ heterocycloalkenyl group may include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group may include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group.

The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group that includes a cyclic aromatic system having at least one hetero atom selected from N, O, P, Si, S, Se, Ge, and B as a ring-forming atom and 1 to 60 carbon atoms as ring forming atom(s), and the term "C₁-C₆₀ heteroarylene group" as used herein refers to a divalent group that includes a cyclic aromatic system having at least one hetero atom selected from N, O, P, Si, S, Se, Ge, and B as a ring-forming atom and 1 to 60 carbon atoms as ring forming atom(s). Non-limiting examples of the C₁-C₆₀ heteroaryl group may include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group.

The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ indicates the C₆-C₆₀ aryl group), the term "C₆-C₆₀ arylthio group" as used herein indicates -SA₁₀₃ (wherein A₁₀₃ indicates the C₆-C₆₀ aryl group), and the term "C₁-C₆₀ alkylthio group" as used herein indicates -SA₁₀₄ (wherein A₁₀₄ indicates the C₁-C₆₀ alkyl group).

The term "C₁-C₆₀ heteroaryloxy group" as used herein indicates -OA₁₀₅ (wherein A₁₀₅ indicates the C₁-C₆₀ heteroaryl group), and the term "C₁-C₆₀ heteroarylthio group" as used herein indicates -SA₁₀₆ (wherein A₁₀₆ indicates the C₁-C₆₀ heteroaryl group),

The term "monovalent non-aromatic condensed polycyclic group" as used herein refers to a monovalent group (for example, having about 8 to about 60 carbon atoms) having two or more rings condensed to each other, only carbon atoms as ring-forming atoms, and no aromaticity in its entire molecular structure. Non-limiting examples of the monovalent non-aromatic condensed polycyclic group may include a fluorenyl group or the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having about 1 to about 60 carbon atoms) having two or more rings condensed to each other, at least one hetero atom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group may include a carbazolyl group or the like. The term "divalent non-aromatic condensed heteropolycyclic group" as used herein refers to a divalent group having the same structure as the monovalent non-aromatic condensed heteropolycyclic group as described herein.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group, or the like, each of which may be unsubstituted or substituted with at least one R₁₀ₐ.

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms as ring forming atom(s). The C₁-C₃₀ heterocyclic group may be a monocyclic group or a polycyclic group. Non-limiting examples of the C₁-C₃₀ heterocyclic group may include a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like, each of which may be unsubstituted or substituted with at least one R₁₀ₐ.

Non-limiting examples of the "C₅-C₃₀ carbocyclic group" and "C₁-C₃₀ heterocyclic group" as used herein are i) a first ring, ii) a second ring, iii) a condensed ring group in which two or more first rings are condensed with each other, iv) a condensed ring group in which two or more second rings are condensed with each other, or v) a condensed ring group in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include - CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," as used herein indicate the recited group in which, in each group, at least one carbon selected from ring-forming carbons is substituted with nitrogen.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇₋C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇₋C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₂-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), - Ge(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof.

In the present specification, Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted Cs-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉ and Q₃₁ to Q₃₉ as described herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

Hereinafter, a light-emitting device according to embodiments are described in detail with reference to Examples. However, embodiments are not limited to the following examples.

### EXAMPLES

### Synthesis Example 1 (Compound D6)

### Synthesis of Compound 6-1

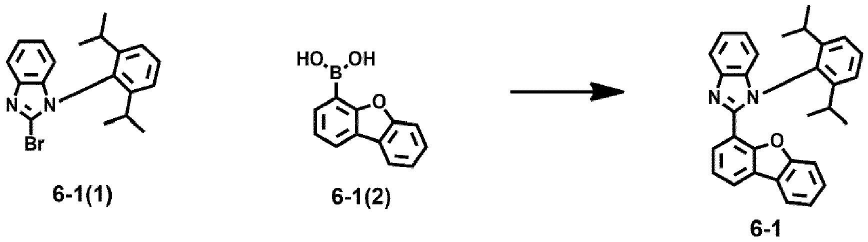

50 milliliters (mL) of tetrahydrofuran (THF) and 20 mL of deionized (DI) water were mixed with Compound 6-1(1) (5.00 grams (g), 14.00 millimoles (mmol)), Compound 6-1(2) (3.56 g, 16.80 mmol), tetrakis(triphenylphosphine)palladium(0) (Pd(PPh₃)₄ (0.81 g, 0.70 mmol), and K₂CO₃ (5.80 g, 42.0 mmol), and then, stirred and heated under reflux for 18 hours. After the temperature was allowed to lower to room temperature, an organic layer was extracted using methylene chloride, the organic layer was separate and dried with anhydrous magnesium sulfate (MgSO₄), the product was filtered. The solvent was removed under a reduced pressure and the obtained residue was purified by column chromatography (ethyl acetate (EA):hexane, 1:6 w/w/) to obtain Compound 6-1 (4.3 g, yield of 68%). The synthesis process was repeated to obtain a sufficient amount of Compound 6-1 for using in the next reaction.

### Synthesis of Compound 6-2

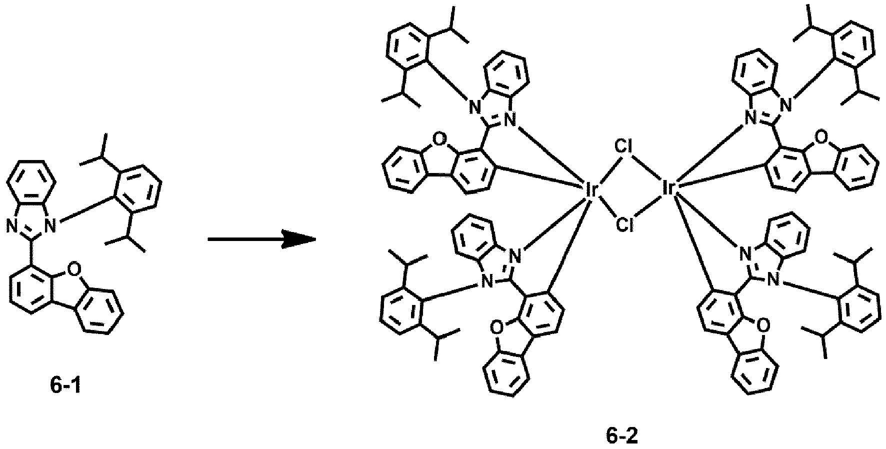

Compound 6-1 (7.0 g, 15.81 mmol) and iridium chloride trihydrate (2.68 g, 7.60 mmol) were mixed with 50 mL of 2-ethoxyethanol and 20 mL of DI water, and then, the resultant mixture was heated at reflux while stirring for 24 hours. Then, the temperature was allowed to lower to room temperature. The resulting solid was separated by filtration, washed thoroughly using DI water, methanol, and hexane, in this stated order, and the obtained solid was dried in a vacuum oven to obtain Compound 6-2 (6.35 g, yield of 75%).

### Synthesis of Compound 6-3

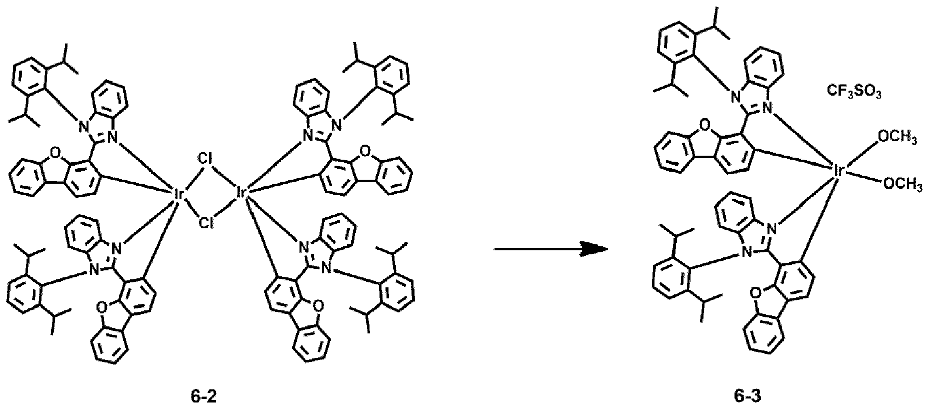

Compound 6-2 (5.8 g, 2.60 mmol) was mixed with 90 mL of methylene chloride (MC), and then silver trifluoromethanesulfonate (AgOTf) (1.4 g, 5.46 mmol) dissolved in 30 mL of methanol was added thereto. Thereafter, the reaction mixture was stirred at room temperature for 18 hours in a state where light was blocked with an aluminum foil. The resulting solid was then removed by celite filtration, and the solvent was removed from the filtrate thereof under a reduced pressure to obtain a solid (Compound 6-3). The obtained solid was used in the next reaction without an additional purification process.

### Synthesis of Compound D6

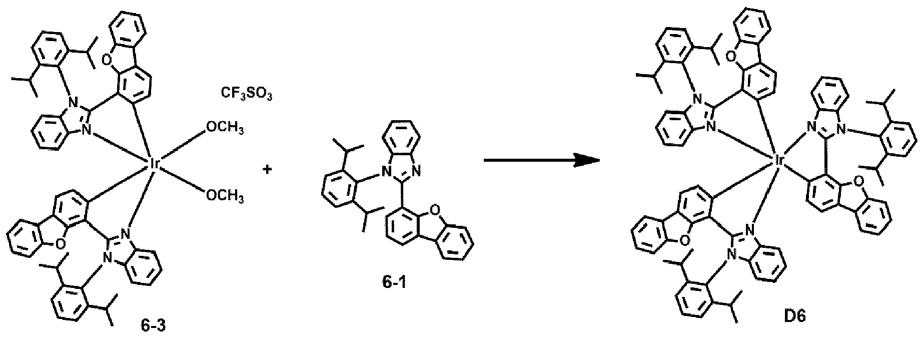

Compound 6-3 (6.45 g, 5.0 mmol) and Compound 6-1 (2.22 g, 5.0 mmol) were mixed with 80 mL of 2-ethoxyethanol and 80 mL of N,N-dimethylformamide, and then, the reaction mixture was heated at reflux at 120 °C while stirring for 24 hours. Then, the temperature was allowed to lower to room temperature. The solvent was removed under a reduced pressure, and then, the product was purified by column chromatography using EA and hexane (1:8, w/w) to obtain Compound D6 (5.3 g, yield of 70%). Compound D6 was characterized by high resolution mass spectrometry using matrix assisted laser desorption ionization (HRMS (MALDI)).

HRMS (MALDI) calculated for C₉₃H₈₁IrN₆O₃ : m/z: 1523.6033, found: 1523.4889.

### Synthesis Example 2 (Compound D7)

### Synthesis of Compound 7-1

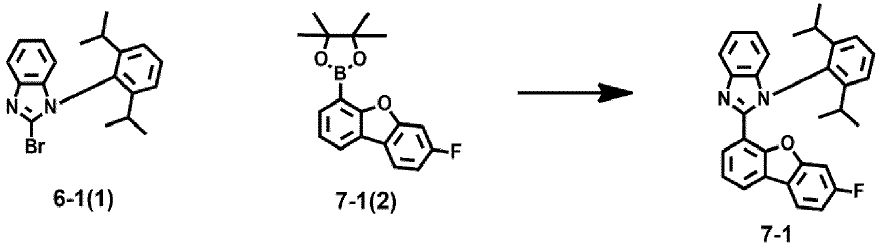

Compound 7-1 (4.05 g, yield of 62.5%) was obtained in a similar manner as used to synthesize Compound 6-1 of Synthesis Example 1, except that Compound 7-1 (2) (5.24 g, 16.80 mmol) was used instead of Compound 6-1(2).

### Synthesis of Compound D7

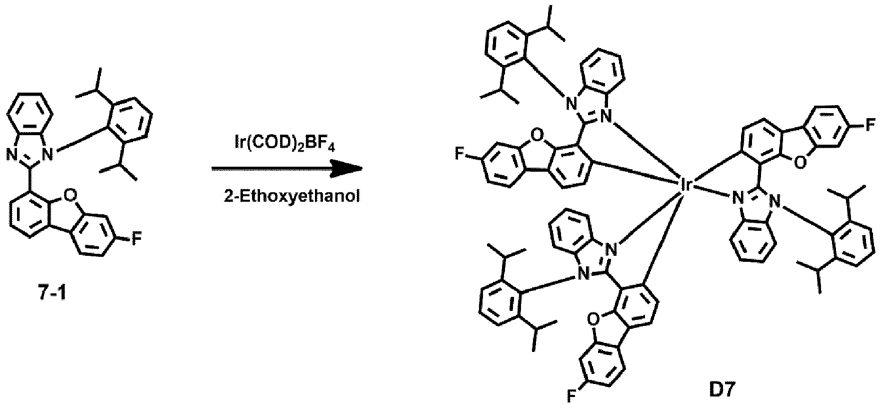

Compound 7-1 (1.96 g, 4.24 mmol) and bis(1,5-cyclooctadiene)iridium(I) tetrafluoroborate (Ir(COD)₂BF₄) (0.6 g, 1.21 mmol) were dissolved in 20 mL of 2-ethoxyethanol, and heated at 160°C while stirring for 24 hours. Then, the temperature was allowed to lower to room temperature. The solid obtained by filtration was dried, and then, the product was purified by column chromatography using EA: hexane (1:7, w/w) to obtain Compound D7 (0.85 g, yield of 45%).

HRMS (MALDI) calculated for C₉₃H₇₈F₃IrN₅O₃: m/z: 1576.5717, found: 1576.9442.

### Manufacture of OLED 1

A glass substrate with ITO/Ag/ITO (as an anode) deposited thereon to a thickness of 70/1000/70 Å was cut to a size of 50 millimeters (mm) x 50 mm x 0.5 mm, sonicated with isopropyl alcohol and DI water each for 5 minutes, and then cleaned by exposure to ultraviolet rays and ozone for 30 minutes each. Then the resultant glass substrate was loaded onto a vacuum deposition apparatus.

Compound HT3 and F6-TCNNQ were co-deposited by vacuum on the anode at a weight ratio of 98:2 to form a hole injection layer having a thickness of 100 Å, and Compound HT3 was vacuum-deposited on the hole injection layer to form a hole transport layer having a thickness of 1350 Å. Then, Compound H-HT2 was deposited on the hole transport layer to form an electron-blocking layer having a thickness of 300 Å.

Then, on the electron-blocking layer, hosts (a first host and a second host) and dopants (a first dopant or a first dopant and a second dopant) as described in Table 1 were co-deposited to form an emission layer having such a thickness as shown in Table 1. The weight ratios among the first host, the second host, the first dopant, and/or the second dopant in the emission layer were adjusted to satisfy W(H1), W(H2), W(D1), and W(D2), which are the weight fractions of the first host, the second host, the first dopant, and the second dopant listed in Table 1. In Table 1, "-" for the second dopant indicates that the emission layer does not include a second dopant, and "-" for W(D2) indicates that the weight fraction of the second dopant W(D2) is 0.

Then, Compounds ET3 and ET-D1 were co-deposited on the emission layer at a 50:50 volume ratio to form an electron transport layer having a thickness of 350 Å, and LiF was vacuum-deposited on the electron transport layer to form an electron injection layer having a thickness of 1 nm. On the electron injection layer, Mg and Ag were co-deposited at a weight ratio of 90:10 to form a cathode having a thickness of 120 Å, thereby completing the manufacture of an organic light-emitting device.

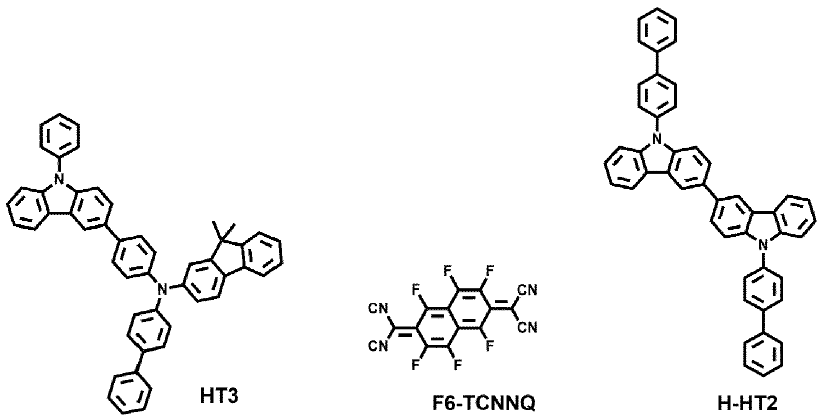

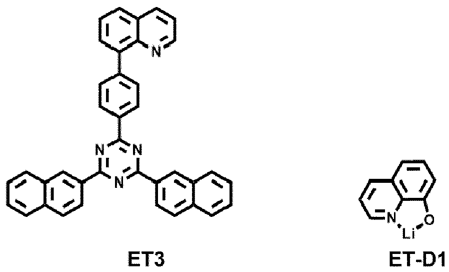

### Production of OLED 2 to OLED 38

OLED 2 to OLED 38 were manufactured in a similar manner as used to manufacture OLED 1, except that, in forming the emission layer, the first host, the second host, the first dopant, and the second dopant possibly present, the weight fractions, and the thicknesses of emission layers of OLED 2 to OLED 38 listed in Table 1 were used.

**Table 1**

| OLED No. | Host | | Dopant | | W(H1)¹ | W(H2)² | W(D1)³ | W(D2)⁴ | Thickness of emission layer (Å) |
|---|---|---|---|---|---|---|---|---|---|
| | First host | Second host | First dopant | Second dopant | | | | | |
| 1 | H-HT1 | H-ET1 | D1 | - | 0.616 | 0.264 | 0.12 | - | 330 |
| 2 | H-HT4 | H-ET4 | D3 | - | 0.651 | 0.279 | 0.07 | - | 330 |
| 3 | H-HT4 | H-ET4 | D4 | - | 0.651 | 0.279 | 0.07 | - | 330 |
| 4 | H-HT1 | H-ET1 | D2 | - | 0.558 | 0.372 | 0.07 | - | 400 |
| 5 | H-HT1 | H-ET1 | D2 | - | 0.604 | 0.326 | 0.07 | - | 400 |
| 6 | H-HT3 | H-ET2 | D2 | - | 0.511 | 0.419 | 0.07 | - | 400 |
| 7 | H-HT3 | H-ET2 | D2 | - | 0.558 | 0.372 | 0.07 | - | 400 |
| 8 | H-HT3 | H-ET2 | D2 | - | 0.604 | 0.326 | 0.07 | - | 400 |
| 9 | H-HT3 | H-ET2 | D2 | - | 0.651 | 0.279 | 0.07 | - | 400 |
| 10 | H-HT3 | H-ET5 | D2 | - | 0.503 | 0.427 | 0.07 | - | 400 |
| 11 | H-HT3 | H-ET5 | D2 | - | 0.558 | 0.372 | 0.07 | - | 400 |
| 12 | H-HT3 | H-ET5 | D2 | - | 0.604 | 0.326 | 0.07 | - | 400 |
| 13 | H-HT3 | H-ET5 | D2 | - | 0.651 | 0.279 | 0.07 | - | 400 |
| 14 | H-HT2 | H-ET3 | D5 | - | 0.675 | 0.225 | 0.10 | - | 400 |
| 15 | H-HT2 | H-ET3 | D6 | - | 0.675 | 0.225 | 0.10 | - | 400 |
| 16 | H-HT1 | H-ET1 | D5 | - | 0.630 | 0.270 | 0.10 | - | 400 |
| 17 | H-HT1 | H-ET1 | D7 | - | 0.540 | 0.360 | 0.10 | - | 400 |
| 18 | H-HT1 | H-ET1 | D7 | - | 0.528 | 0.352 | 0.12 | - | 400 |
| 19 | H-HT1 | H-ET1 | D7 | - | 0.510 | 0.340 | 0.15 | - | 400 |
| 20 | H-HT1 | H-ET1 | D7 | - | 0.585 | 0.315 | 0.10 | - | 400 |
| 21 | H-HT1 | H-ET1 | D7 | - | 0.630 | 0.270 | 0.10 | - | 400 |
| 22 | H-HT1 | H-ET1 | D8 | - | 0.651 | 0.279 | 0.07 | - | 400 |
| 23 | H-HT1 | H-ET1 | D6 | D7 | 0.546 | 0.364 | 0.05 | 0.04 | 400 |
| 24 | H-HT1 | H-ET1 | D6 | D7 | 0.546 | 0.364 | 0.04 | 0.05 | 400 |
| 25 | H-HT1 | H-ET1 | D6 | D7 | 0.552 | 0.368 | 0.03 | 0.05 | 400 |
| 26 | H-HT1 | H-ET1 | D6 | D7 | 0.558 | 0.372 | 0.02 | 0.05 | 400 |
| 27 | H-HT1 | H-ET1 | D6 | D7 | 0.623 | 0.267 | 0.09 | 0.02 | 400 |
| 28 | H-HT1 | H-ET1 | D6 | D7 | 0.637 | 0.273 | 0.04 | 0.05 | 400 |
| 29 | H-HT1 | H-ET1 | D1 | - | 0.616 | 0.264 | 0.12 | - | 200 |
| 30 | H-HT1 | H-ET1 | D1 | - | 0.616 | 0.264 | 0.12 | - | 400 |
| 31 | H-HT1 | H-ET1 | D1 | - | 0.616 | 0.264 | 0.12 | - | 500 |
| 32 | H-HT1 | H-ET1 | D2 | - | 0.651 | 0.279 | 0.07 | - | 200 |
| 33 | H-HT1 | H-ET1 | D2 | - | 0.651 | 0.279 | 0.07 | - | 300 |
| 34 | H-HT1 | H-ET1 | D2 | - | 0.651 | 0.279 | 0.07 | - | 400 |
| 35 | H-HT1 | H-ET1 | D2 | - | 0.651 | 0.279 | 0.07 | - | 500 |
| 36 | H-HT1 | H-ET1 | D6 | - | 0.630 | 0.270 | 0.10 | - | 200 |
| 37 | H-HT1 | H-ET1 | D6 | - | 0.630 | 0.270 | 0.10 | - | 300 |
| 38 | H-HT1 | H-ET1 | D6 | - | 0.630 | 0.270 | 0.10 | - | 400 |

| | | | | | | | | | |
|---|---|---|---|---|---|---|---|---|---|
| ¹ : W(H1) = Weight fraction of first host to total weight of first host, second host, first dopant and second dopant, which is calculated by "(weight of first host / total weight of first host, second host, first dopant, and second dopant)". When the emission layer does not include a second dopant, the weight of the second dopant is 0, ² : W(H2) = Weight fraction of second host to total weight of first host, second host, first dopant and second dopant, which is calculated by "(weight of second host / total weight of first host, second host, first dopant, and second dopant)". When the emission layer does not include a second dopant, the weight of the second dopant is 0, ³ : W(D1) = Weight fraction of first dopant to total weight of first host, second host, first dopant and second dopant, which is calculated by "(weight of first dopant / total weight of first host, second host, first dopant, and second dopant)". When the emission layer does not include a second dopant, the weight of the second dopant is 0, ⁴ : W(D2) = Weight fraction of second dopant to total weight of first host, second host, first dopant and second dopant, which is calculated by "(weight of second dopant / total weight of first host, second host, first dopant, and second dopant)". | | | | | | | | | |

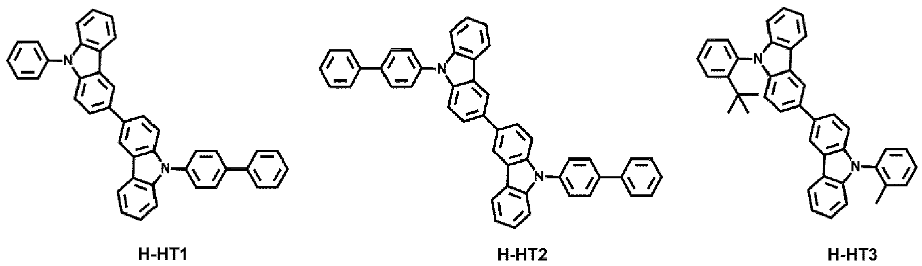

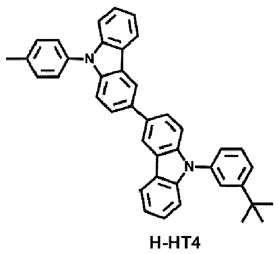

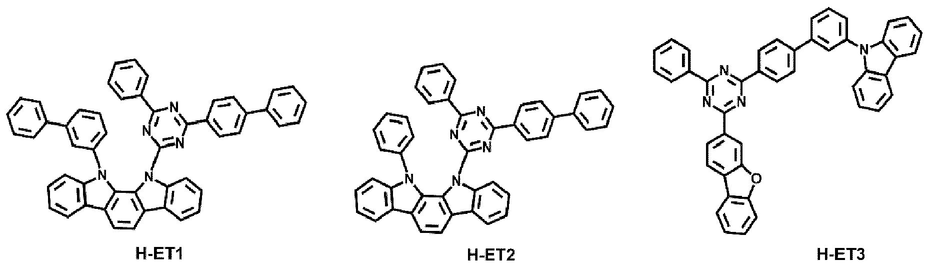

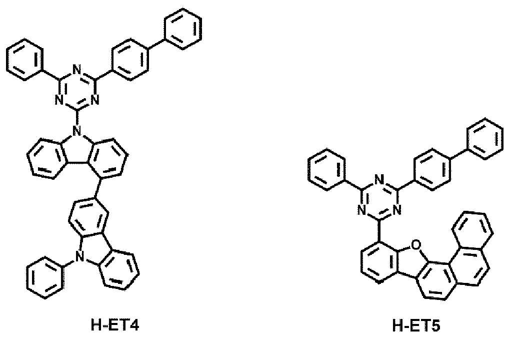

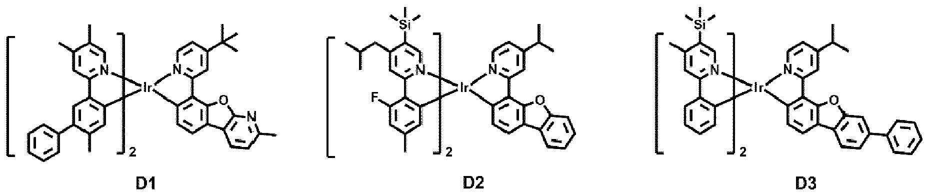

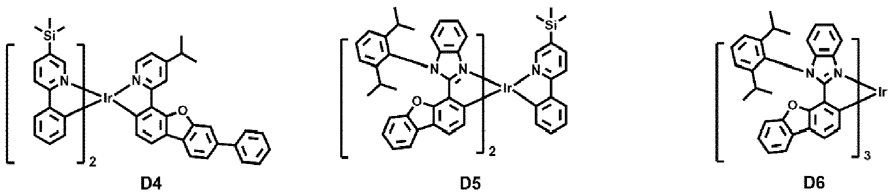

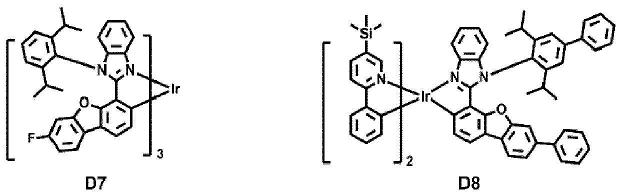

### Evaluation Example 1

According to the method described in Table 2, the dipole moment (DM) was evaluated for each of the hosts and dopants included in the emission layers of OLED 1 to 38, and the DM_{EML} value of each of OLED 1 to 38 was calculated based thereon, and results thereof are summarized in Table 3.

**Table 2**

| | |
|---|---|
| Method for calculation of dipole moment of dopant | The dopant molecular structure is optimized by using the B3LYP/LanL2DZ function for iridium in the dopant and the B3LYP/6-31G(D,P) function for an organic ligand in the dopant, and density functional theory (DFT) calculation was performed using the Gaussian 16 program. As such, the dipole moment of each dopant was calculated. |
| Method for calculation of dipole moment of host | Molecular structure was optimized using the B3LYP/6-31G(D,P) function and density functional theory (DFT) calculations using the Gaussian 16 program were performed. As such, the dipole moment of each host was calculated. |

**Table 3**

| OLED No. | W(H1) | W(H2) | W(D1) | W(D2) | DM(H1) ⁵ (debye) | DM(H2) ⁶ (debye) | DM(D1) ⁷ (debye) | DM(D2) ⁸ (debye) | Dopant DM average ⁹ (debye) | DM_{EML} ¹⁰ (debye) |
|---|---|---|---|---|---|---|---|---|---|---|
| 1 | 0.616 | 0.264 | 0.12 | - | 0.85 | 2.44 | 6.81 | - | 0.82 | 1.98 |
| 2 | 0.651 | 0.279 | 0.07 | - | 1.39 | 2.30 | 7.89 | - | 0.55 | 2.10 |
| 3 | 0.651 | 0.279 | 0.07 | - | 1.39 | 2.30 | 7.41 | - | 0.52 | 2.07 |
| 4 | 0.558 | 0.372 | 0.07 | - | 0.85 | 2.44 | 5.68 | - | 0.40 | 1.78 |
| 5 | 0.604 | 0.326 | 0.07 | - | 0.85 | 2.44 | 5.68 | - | 0.40 | 1.71 |
| 6 | 0.511 | 0.419 | 0.07 | - | 0.81 | 2.48 | 5.68 | - | 0.40 | 1.85 |
| 7 | 0.558 | 0.372 | 0.07 | - | 0.81 | 2.48 | 5.68 | - | 0.40 | 1.77 |
| 8 | 0.604 | 0.326 | 0.07 | - | 0.81 | 2.48 | 5.68 | - | 0.40 | 1.70 |
| 9 | 0.651 | 0.279 | 0.07 | - | 0.81 | 2.48 | 5.68 | - | 0.40 | 1.62 |
| 10 | 0.503 | 0.427 | 0.07 | - | 0.81 | 0.72 | 5.68 | - | 0.40 | 1.11 |
| 11 | 0.558 | 0.372 | 0.07 | - | 0.81 | 0.72 | 5.68 | - | 0.40 | 1.12 |
| 12 | 0.604 | 0.326 | 0.07 | - | 0.81 | 0.72 | 5.68 | - | 0.40 | 1.12 |
| 13 | 0.651 | 0.279 | 0.07 | - | 0.81 | 0.72 | 5.68 | - | 0.40 | 1.13 |
| 14 | 0.675 | 0.225 | 0.10 | - | 0.86 | 1.93 | 4.23 | - | 0.42 | 1.44 |
| 15 | 0.675 | 0.225 | 0.10 | - | 0.86 | 1.93 | 2.58 | - | 0.26 | 1.27 |
| 16 | 0.630 | 0.270 | 0.10 | - | 0.85 | 2.44 | 4.23 | - | 0.42 | 1.62 |
| 17 | 0.540 | 0.360 | 0.10 | - | 0.85 | 2.44 | 3.52 | - | 0.35 | 1.69 |
| 18 | 0.528 | 0.352 | 0.12 | - | 0.85 | 2.44 | 3.52 | - | 0.42 | 1.73 |
| 19 | 0.510 | 0.340 | 0.15 | - | 0.85 | 2.44 | 3.52 | - | 0.53 | 1.79 |
| 20 | 0.585 | 0.315 | 0.10 | - | 0.85 | 2.44 | 3.52 | - | 0.35 | 1.62 |
| 21 | 0.630 | 0.270 | 0.10 | - | 0.85 | 2.44 | 3.52 | - | 0.35 | 1.55 |
| 22 | 0.651 | 0.279 | 0.07 | - | 0.85 | 2.44 | 5.52 | - | 0.39 | 1.62 |
| 23 | 0.546 | 0.364 | 0.05 | 0.04 | 0.85 | 2.44 | 2.58 | 3.52 | 0.27 | 1.62 |
| 24 | 0.546 | 0.364 | 0.04 | 0.05 | 0.85 | 2.44 | 2.58 | 3.52 | 0.28 | 1.63 |
| 25 | 0.552 | 0.368 | 0.03 | 0.05 | 0.85 | 2.44 | 2.58 | 3.52 | 0.25 | 1.62 |
| 26 | 0.558 | 0.372 | 0.02 | 0.05 | 0.85 | 2.44 | 2.58 | 3.52 | 0.23 | 1.61 |
| 27 | 0.623 | 0.267 | 0.09 | 0.02 | 0.85 | 2.44 | 2.58 | 3.52 | 0.30 | 1.48 |
| 28 | 0.637 | 0.273 | 0.04 | 0.05 | 0.85 | 2.44 | 2.58 | 3.52 | 0.28 | 1.49 |
| 29 | 0.616 | 0.264 | 0.12 | - | 0.85 | 2.44 | 6.81 | - | 0.82 | 1.99 |
| 30 | 0.616 | 0.264 | 0.12 | - | 0.85 | 2.44 | 6.81 | - | 0.82 | 1.99 |
| 31 | 0.616 | 0.264 | 0.12 | - | 0.85 | 2.44 | 6.81 | - | 0.82 | 1.99 |
| 32 | 0.651 | 0.279 | 0.07 | - | 0.85 | 2.44 | 5.68 | - | 0.40 | 1.63 |
| 33 | 0.651 | 0.279 | 0.07 | - | 0.85 | 2.44 | 5.68 | - | 0.40 | 1.63 |
| 34 | 0.651 | 0.279 | 0.07 | - | 0.85 | 2.44 | 5.68 | - | 0.40 | 1.63 |
| 35 | 0.651 | 0.279 | 0.07 | - | 0.85 | 2.44 | 5.68 | - | 0.40 | 1.63 |
| 36 | 0.630 | 0.270 | 0.10 | - | 0.85 | 2.44 | 2.58 | - | 0.26 | 1.45 |
| 37 | 0.630 | 0.270 | 0.10 | - | 0.85 | 2.44 | 2.58 | - | 0.26 | 1.45 |
| 38 | 0.630 | 0.270 | 0.10 | - | 0.85 | 2.44 | 2.58 | - | 0.26 | 1.45 |

| | | | | | | | | | | |
|---|---|---|---|---|---|---|---|---|---|---|
| ⁵: DM(H1) = dipole moment of first host ⁶: DM(H2) = dipole moment of second host ⁷: DM(D1) = dipole moment of first dopant ⁸ : DM(D2) = dipole moment of second dopant ⁹: Dopant DM average: calculated by "DM(D1)·W(D1)" (in a case where the emission layer includes only a first dopant as a dopant) or "DM(D1) W(D1) + DM(D2) W(D2)" (in a case where the emission layer includes both a first dopant and a second dopant as dopants) ¹⁰ : DM_{EML}: calculated by "DM(H1)·W(H1) + DM(H2)·W(H2) + DM(D1)·W(D1)" (in a case where the emission layer includes only a first dopant as a dopant) or "DM(H1)·W(H1) + DM(H2)·W(H2) + DM(D1)·W(D1) + DM(D2)·W(D2)" (in a case where the emission layer includes both a first dopant and a second dopant as dopants) | | | | | | | | | | |

### Evaluation Example 2

After applying a voltage of -3 V to OLED 1 and maintaining the same for 10 seconds using a Keithley 2635B device, the current density was measured at 0.01 V intervals from -3 V to 5 V using said device, and the voltage (V)-current density (mA/cm²) graph of OLED 1 was obtained.

From the voltage (V)-current density (mA/cm²) graph of OLED 1, i) the driving voltage (Vₒₚ), which is the voltage when the current density is 1 mA/cm², and ii) the charge injection voltage (Vᵢₙⱼ), which is the smallest value among the voltages corresponding to the coordinates at which the change in the current density increase rate is observed, were each evaluated, and results thereof are shown in Table 4.

Then, OLED 1 was driven while applying a pulse current under the conditions of a current density of 1 mA/cm², 50 Hz, and 5% duty (that is, one pulse is 1,000 µs) using the Keithley 6221 equipment noted herein, to evaluate the luminance of OLED 1 according to time. As a result, the graph of the time (µs) - relative luminance (a.u.) of OLED 1 was obtained.

From the time (µs) - relative luminance (a.u.) graph of OLED 1, after applying the current, i) delay time, which was time required for luminance to reach 10% of a maximum luminance, and ii) turn-on time, which is time required for luminance to reach 90% of the maximum luminance, were each evaluated, and results thereof are shown in Table 4.

In a similar manner as described above, Vᵢₙⱼ (V), Vₒₚ (V), delay time (µs), and turn-on time (µs) of each of OLED 2 to OLED 38 were evaluated, and the evaluation results are summarized in Table 4.

From this, Vₒₚ-Vᵢₙⱼ and DM_{EML} x (Vₒₚ-Vᵢₙⱼ) of OLEDs 1 to 38 were calculated, and results thereof are shown in Table 4. From the electroluminescence spectra of OLED 1 to OLED 38, the maximum emission wavelength (emission peak wavelength) (λₘₐₓ, nm) of each of OLED 1 to OLED 38 was evaluated.

**Table 4**

| OLED No. | λₘₐₓ (nm) | Emission layer Thickness (Å) | DM_{EML} (debye) | Vᵢₙⱼ (V) | Vₒₚ (V) | Vₒₚ-Vᵢₙⱼ (V) | DM_{EML} x (Vₒₚ-Vᵢₙⱼ) | Delay time (µs) | Turn-on time (µs) |
|---|---|---|---|---|---|---|---|---|---|
| 1 | 524 | 330 | 1.98 | 1.33 | 3.23 | 1.90 | 3.76 | 220 | 330 |
| 2 | 529 | 330 | 2.10 | -0.10 | 2.81 | 2.91 | 6.11 | 270 | 358 |
| 3 | 527 | 330 | 2.07 | -0.02 | 2.73 | 2.75 | 5.69 | 274 | 348 |
| 4 | 518 | 400 | 1.78 | 0.51 | 2.79 | 2.29 | 4.07 | 208 | 260 |
| 5 | 518 | 400 | 1.71 | 0.64 | 2.82 | 2.18 | 3.73 | 210 | 266 |
| 6 | 518 | 400 | 1.85 | -0.20 | 2.78 | 2.98 | 5.51 | 236 | 286 |
| 7 | 518 | 400 | 1.77 | -0.04 | 2.82 | 2.86 | 5.06 | 232 | 284 |
| 8 | 518 | 400 | 1.70 | 0.11 | 2.86 | 2.75 | 4.68 | 232 | 292 |
| 9 | 518 | 400 | 1.62 | 0.34 | 2.90 | 2.56 | 4.15 | 234 | 298 |
| 10 | 518 | 400 | 1.11 | 1.41 | 2.72 | 1.31 | 1.45 | 144 | 182 |
| 11 | 518 | 400 | 1.12 | 1.36 | 2.74 | 1.38 | 1.55 | 148 | 186 |
| 12 | 518 | 400 | 1.12 | 1.36 | 2.76 | 1.40 | 1.57 | 152 | 196 |
| 13 | 518 | 400 | 1.13 | 1.43 | 2.81 | 1.38 | 1.56 | 152 | 196 |
| 14 | 526 | 400 | 1.44 | 1.32 | 3.13 | 1.81 | 2.60 | 170 | 256 |
| 15 | 525 | 400 | 1.27 | 1.84 | 3.16 | 1.32 | 1.68 | 144 | 224 |
| 16 | 526 | 400 | 1.62 | 1.00 | 3.28 | 2.28 | 3.69 | 210 | 312 |
| 17 | 525 | 400 | 1.69 | 1.16 | 2.93 | 1.77 | 2.99 | 176 | 234 |
| 18 | 525 | 400 | 1.73 | 1.18 | 2.94 | 1.76 | 3.04 | 178 | 238 |
| 19 | 525 | 400 | 1.79 | 1.05 | 2.95 | 1.90 | 3.40 | 178 | 238 |
| 20 | 525 | 400 | 1.62 | 1.36 | 3.02 | 1.66 | 2.69 | 170 | 236 |
| 21 | 525 | 400 | 1.55 | 1.43 | 3.09 | 1.66 | 2.57 | 168 | 242 |
| 22 | 530 | 400 | 1.62 | 1.00 | 3.22 | 2.22 | 3.60 | 206 | 296 |
| 23 | 525 | 400 | 1.62 | 1.43 | 2.95 | 1.52 | 2.46 | 168 | 234 |
| 24 | 525 | 400 | 1.63 | 1.44 | 2.96 | 1.52 | 2.48 | 168 | 232 |
| 25 | 525 | 400 | 1.62 | 1.40 | 2.97 | 1.57 | 2.54 | 170 | 236 |
| 26 | 525 | 400 | 1.61 | 1.34 | 3.05 | 1.71 | 2.75 | 180 | 256 |
| 27 | 525 | 400 | 1.48 | 1.55 | 3.13 | 1.58 | 2.34 | 168 | 250 |
| 28 | 525 | 400 | 1.49 | 1.53 | 3.14 | 1.61 | 2.40 | 168 | 250 |
| 29 | 524 | 200 | 1.99 | 1.87 | 2.87 | 1.00 | 1.99 | 152 | 240 |
| 30 | 524 | 400 | 1.99 | 1.53 | 3.27 | 1.74 | 3.46 | 190 | 294 |
| 31 | 524 | 500 | 1.99 | 1.24 | 3.56 | 2.32 | 4.61 | 212 | 332 |
| 32 | 518 | 200 | 1.63 | 1.82 | 2.66 | 0.84 | 1.37 | 140 | 188 |
| 33 | 518 | 300 | 1.63 | 1.50 | 2.69 | 1.19 | 1.94 | 168 | 218 |
| 34 | 518 | 400 | 1.63 | 1.14 | 2.75 | 1.61 | 2.62 | 184 | 236 |
| 35 | 518 | 500 | 1.63 | 0.82 | 2.83 | 2.01 | 3.28 | 192 | 248 |
| 36 | 525 | 200 | 1.45 | 1.94 | 2.83 | 0.89 | 1.29 | 140 | 208 |
| 37 | 525 | 300 | 1.45 | 1.71 | 2.95 | 1.24 | 1.80 | 160 | 234 |
| 38 | 525 | 400 | 1.45 | 1.58 | 3.08 | 1.50 | 2.18 | 170 | 246 |

From Table 4, it can be seen that the delay time and the turn-on time of OLEDs 10 to 15, 17 to 21, 23 to 29, and 32 to 38 with DM_{EML} x (Vₒₚ - Vᵢₙⱼ) values of 3.41 debye·V or less, were less than the delay time and the turn-on time of the remaining organic light-emitting devices, respectively. Specifically, it can be seen that OLEDs 10 to 15, 17 to 21, 23 to 29, and 32 to 38 have a delay time of 192 µs or less and a turn-on time of 260 µs or less.

Although not intended to be limited by a particular theory, in general, the turn-on time for the emission of a red light and a blue light at a current density of 1 mA/cm² was approximately about 140 µs to about 200 µs. Therefore, in the case of a full-color light-emitting device having a green emission layer as described herein, the turn-on time of the green light may be considerably close to the turn-on time of each of the red light and the blue light. Accordingly, the color drag phenomenon, for example, a purple color drag phenomenon after application of a current to a full-color light-emitting device can be substantially prevented.

### Evaluation Example 3

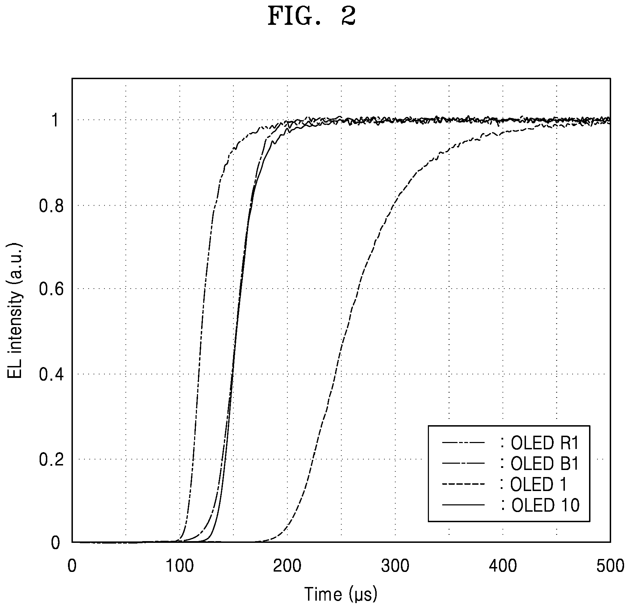

OLED R1, which was a red light-emitting device including Compound RD1 as a red phosphorescent dopant, and OLED B1, which was a blue light-emitting device including NUBD-370 available from SFC (Korea) as a blue fluorescent dopant, were manufactured. Then, in a manner similar to the method described in Evaluation Example 2, the delay time and the turn-on time of each of OLED R1 and OLED B1 were evaluated. Results thereof are shown in Table 5. For comparison, the delay time and the turn-on time of each of OLED 1 and OLED 10 are also shown in Table 5. FIG. 2 shows a time (µs)-electroluminescence intensity (a.u.) graph of each of OLEDs R1, B1, 1, and 10.

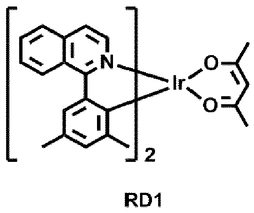

**Table 5**

| OLED No. | Delay time (µs) | Turn-on time (µs) |
|---|---|---|
| R1 | 108 | 144 |
| B1 | 136 | 178 |
| 1 | 220 | 330 |
| 10 | 144 | 182 |

From Table 5 and FIG. 2, it can be seen that in the case of OLED 10 having a DM_{EML} x (Vₒₚ - Vᵢₙⱼ) value of 3.41 debye·V or less, compared to OLED 1 having a DM_{EML} x (Vₒₚ - Vᵢₙⱼ) value exceeding 3.41 debye·V, the delay time and the turn-on time were closer to the delay time and the turn-on time of each of OLED R1 and OLED B1. Therefore, in the case of a full-color light-emitting device having a green emission layer as described herein, the turn-on time of the green light can be considerably close to the turn-on time of each of the red light and the blue light. Accordingly, the color drag phenomenon, for example, a purple color drag phenomenon after application of a current to a full-color light-emitting device can be substantially prevented.

Since the light-emitting device has an improved delay time and turn-on time, a high-quality electronic apparatus can be manufactured using the light-emitting device and also has an improved delay time and turn-on time.

It should be understood that exemplary embodiments described herein should be considered in a descriptive sense only and not for purposes of limitation. Descriptions of features or aspects within each exemplary embodiment should typically be considered as available for other similar features or aspects in other embodiments. While one or more exemplary embodiments have been described with reference to the figures, it will be understood by those of ordinary skill in the art that various changes in form and details may be made therein without departing from the scope as defined by the following claims.

## Claims

1. A light-emitting device, comprising:
a first electrode;
a second electrode opposing the first electrode; and
an interlayer arranged between the first electrode and the second electrode, wherein the interlayer comprises an emission layer,
wherein the emission layer comprises m1 dopants and m2 hosts,
m1 and m2 are each an integer of 1 or greater,
when m1 is 2 or greater, then two or more of the dopants are different from each other,
when m2 is 2 or greater, then two or more of the hosts are different from each other, and
the light-emitting device satisfies Condition 1: $0 debye ⋅ V \leq {DM}_{EML} \times \left({V}_{op}-{V}_{inj}\right) \leq 3.41 debye ⋅ V$ wherein, in Condition 1,
DM_{EML} is a sum of ${\sum }_{x = 1}^{m 1} DM \left(Dx\right) ⋅ W \left(Dx\right)$ and ${\sum }_{y = 1}^{m 2} DM \left(Hy\right) ⋅ W \left(Hy\right)$ and is in debye,
x is a variable of 1 to m1,
y is a variable 1 to m2,
DM(Dx) is a dipole moment of a x^{th} dopant,
DM(Hy) is a dipole moment of a y^{th} host,
each of DM(Dx) and DM(Hy) is calculated based on a density functional theory, W(Dx) is a weight fraction of the x^{th} dopant with respect to a total weight of the m1 dopants and the m2 hosts, and
W(Hy) is a weight fraction of the y^{th} host with respect to the total weight of the m1 dopants and the m2 hosts,
Vₒₚ is a driving voltage of the light-emitting device at a current density of 1 milliampere per square centimeter, and is in volt (V), and
Vᵢₙⱼ is a charge injection voltage of the light-emitting device, and has a smallest value among voltages of coordinates at which a change in the current density increase rate is observed in the voltage-current density graph of the light-emitting device, and is in volt (V).

2. The light-emitting device of claim 1, wherein m1 and m2 are each independently 1 or 2; and/or
wherein DM_{EML} is 1.11 debye to 1.99 debye.

3. The light-emitting device of claims 1 or 2, wherein (Vₒₚ - Vᵢₙⱼ) is 0.84 volts to 1.90 volts; and/or
wherein DM_{EML} x (Vₒₚ - Vᵢₙⱼ) is 1.29 debye·V or greater.

4. The light-emitting device of any of claims 1-3, wherein the m1 dopants each emit a green light; and/or
wherein a maximum emission wavelength of an emission spectrum of each of m1 dopants is 500 nanometers to 580 nanometers.

5. The light-emitting device of any of claims 1-4, wherein
at least one of m1 dopants comprises an iridium-containing organometallic compound,
the iridium-containing organometallic compound comprises a first ligand, a second ligand, and a third ligand, wherein each ligand is bonded to the iridium, and
each of the first ligand, the second ligand, and the third ligand is a bidentate ligand that is bonded to the iridium via N and C;
preferably wherein
the first ligand, the second ligand, and the third ligand are identical to each other, or
the first ligand and the second ligand are identical to each other, and the second ligand and the third ligand are different from each other, or
the first ligand and the second ligand are different from each other, and the second ligand and the third ligand are identical to each other, or
the first ligand, the second ligand, and the third ligand are different from each other.

6. The light-emitting device of any of claims 1-5, wherein
at least one of the m1 dopants comprises an iridium-containing organometallic compound, and
the iridium-containing organometallic compound comprises a dibenzofuran group, a dibenzothiophene group, a dibenzoselenophene group, a dibenzosilole group, a dibenzogermole group, a naphthobenzofuran group, a naphthobenzothiophene group, a naphthobenzoselenophene group, a naphthobenzosilole group, a naphthobenzogermole group, a phenanthrobenzofuran group, a phenanthrobenzothiophene group, a phenanthrobenzoselenophene group, a phenanthrobenzosilole group, a phenanthrobenzogermole group, an azadibenzofuran group, an azadibenzothiophene group, an azadibenzoselenophene group, an azadibenzosilole group, an azadibenzogermole group, an azanaphthobenzofuran group, an azanaphthobenzothiophene group, an azanaphthobenzoselenophene group, an azanaphthobenzosilole group, an azanaphthobenzogermole group, an azaphenanthrobenzofuran group, an azaphenanthrobenzothiophene group, an azaphenanthrobenzoselenophene group, an azaphenanthrobenzosilole group, an azaphenanthrobenzogermole group, or a combination thereof, each of which is bonded to the iridium via C.

7. The light-emitting device of any of claims 1-6, wherein
at least one of the m1 dopants comprises an iridium-containing organometallic compound, and
the iridium-containing organometallic compound comprises a benzimidazole group, a benzoxazole group, a benzthiazole group, a naphthoimidazole group, a naphthooxazole group, a naphthothiazole group, a phenanthroimidazole group, a phenanthrooxazole group, a phenanthrothiazole group, a pyridoimidazole group, a pyridooxazole group, a pyridothiazole group, a pyridine group, a pyrimidine group, a pyrazine group, a pyridazine group, a quinoline group, an isoquinoline group, or a combination thereof, each of which is bonded to the iridium via N.

8. The light-emitting device of any of claims 1-7, wherein the emission layer emits a green light; and/or
wherein a delay time is 192 µs or less, wherein the delay time is a time required for a luminance of the light-emitting device to reach 10% of a maximum luminance after application of a current.

9. The light-emitting device of any of claims 1-8, wherein
a turn-on time is 260 µs or less, wherein turn-on time is a time required for a luminance of the light-emitting device to reach 90% of a maximum luminance after application of a current.

10. The light-emitting device of any of claims 1-9, wherein
the interlayer comprises:
m light-emitting units that each comprise at least one emission layer; and
m-1 charge generation layers arranged between two neighboring light-emitting units of the m light-emitting units,
wherein m is an integer of 2 or greater, and
an emission layer included in at least one light-emitting unit of the m light-emitting units comprises the m1 dopants and the m2 hosts.

11. The light-emitting device of any of claims 1-10, wherein
the light-emitting device further comprises a substrate that comprises a red subpixel, a green subpixel, and a blue subpixel,
the first electrode is patterned for each of the red subpixel, the green subpixel, and the blue subpixel,
the emission layer comprises a red emission layer corresponding to the red subpixel, a green emission layer corresponding to the green subpixel, and a blue emission layer corresponding to the blue subpixel, and
the green emission layer comprises the m1 dopants and the m2 hosts.

12. The light-emitting device of claim 11, wherein
a maximum emission wavelength of an emission spectrum of light emitted from the green emission layer is 500 nanometers to 580 nanometers.

13. The light-emitting device of claims 11 or 12, wherein
at least one of |R_{delay} - G_{delay}| and |B_{delay} - G_{delay}| is 100 µs or less,
R_{delay} is a time required for the luminance of a red light emitted from the red emission layer to reach 10% of a maximum luminance of the red light after application of a current to the light-emitting device,
G_{delay} is a time required for the luminance of a green light emitted from the green emission layer to reach 10% of a maximum luminance of the green light after application of a current to the light-emitting device, and
B_{delay} is a time required for the luminance of a blue light emitted from the blue emission layer to reach 10% of a maximum luminance of the blue light after application of a current to the light-emitting device.

14. The light-emitting device of any of claims 11-13, wherein
at least one of |Rₜᵤᵣₙ₋ₒₙ - Gₜᵤᵣₙ₋ₒₙ| and |Bₜᵤᵣₙ₋ₒₙ - Gₜᵤᵣₙ₋ₒₙ| is 150 µs or less,
Rₜᵤᵣₙ₋ₒₙ is a time required for the luminance of a red light emitted from the red emission layer to reach 90% of a maximum luminance of the red light after application of a current to the light-emitting device,
Gₜᵤᵣₙ₋ₒₙ is a time required for the luminance of a green light emitted from the green emission layer to reach 90% of a maximum luminance of the green light after application of a current to the light-emitting device, and
Bₜᵤᵣₙ₋ₒₙ is a time required for the luminance of a blue light emitted from the blue emission layer to reach 90% of a maximum luminance of the blue light after application of a current to the light-emitting device.

15. An electronic apparatus, comprising the light-emitting device of any of claims 1-14.
